(19) Europäisches Patentamt / European Patent Office / Office européen des brevets

(11) EP 3 248 230 B1

(12) **EUROPÄISCHE PATENTSCHRIFT**

(45) Veröffentlichungstag und Bekanntmachung des Hinweises auf die Patenterteilung:
**06.05.2020 Patentblatt 2020/19**

(21) Anmeldenummer: **16702350.6**

(22) Anmeldetag: **20.01.2016**

(51) Int Cl.:
***H01L 51/50*** *(2006.01)* ***C09K 11/06*** *(2006.01)*
***H01L 51/00*** *(2006.01)*

(86) Internationale Anmeldenummer:
**PCT/EP2016/051169**

(87) Internationale Veröffentlichungsnummer:
**WO 2016/116527 (28.07.2016 Gazette 2016/30)**

(54) **VERWENDUNG ORGANISCHER MOLEKÜLE IN OPTOELEKTRONISCHEN BAUELEMENTEN**

USE OF ORGANIC MOLECULES IN OPTOELECTRONIC COMPONENTS

UTILISATION DES MOLECULES ORGANIQUES DANS DES COMPOSANTS OPTELECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.01.2015 EP 15151870**
**20.05.2015 EP 15168301**

(43) Veröffentlichungstag der Anmeldung:
**29.11.2017 Patentblatt 2017/48**

(73) Patentinhaber: **cynora GmbH**
**76646 Bruchsal (DE)**

(72) Erfinder:
- **AMBROSEK, David**
**10437 Berlin (DE)**
- **DANZ, Michael**
**76344 Eggenstein-Leopoldshafen (DE)**
- **FLÜGGE, Harald**
**76135 Karlsruhe (DE)**
- **FRIEDRICHS, Jana**
**76137 Karlsruhe (DE)**
- **GRAB, Tobias**
**76133 Karlsruhe (DE)**
- **JACOB, Andreas**
**30449 Hannover (DE)**
- **SEIFERMANN, Stefan**
**77815 Bühl (DE)**
- **VOLZ, Daniel**
**76137 Karlsruhe (DE)**

(74) Vertreter: **Hoppe, Georg Johannes**
**Darani Anwaltskanzlei**
**Beuckestrasse 20**
**14163 Berlin (DE)**

(56) Entgegenhaltungen:

| | |
|---|---|
| **EP-A1- 0 052 853** | **EP-A2- 0 950 657** |
| **EP-A2- 2 551 932** | **WO-A1-2008/117815** |
| **WO-A1-2008/156718** | **WO-A2-00/37022** |
| **DE-A1- 3 044 072** | **DE-A1- 3 117 984** |
| **GB-A- 2 439 030** | **JP-A- H03 251 567** |
| **JP-A- 2014 097 954** | **US-A1- 2006 135 522** |
| **US-A1- 2015 041 775** | **US-B1- 6 177 440** |

- **T. NARENDER ET AL: "Preparation of novel antiproliferative emodin derivatives and studies on their cell cycle arrest, caspase dependent apoptosis and DNA binding interaction", PHYTOMEDICINE., Bd. 20, Nr. 10, 1. Juli 2013 (2013-07-01), Seiten 890-896, XP055272003, DE ISSN: 0944-7113, DOI: 10.1016/j.phymed.2013.03.015**
- **MORTON HARFENIST ET AL: "Selective inhibitors of monoamine oxidase. 4. SAR of tricyclic N- methylcarboxamides and congeners binding at the tricyclics' hydrophilic binding site", JOURNAL OF MEDICINAL CHEMISTRY, Bd. 40, Nr. 16, 1. Januar 1997 (1997-01-01), Seiten 2466-2473, XP002639349, AMERICAN CHEMICAL SOCIETY, US ISSN: 0022-2623, DOI: 10.1021/JM9608063 [gefunden am 1997-08-01]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 248 230 B1

Printed by Jouve, 75001 PARIS (FR)

## Beschreibung

Die Erfindung betrifft die Verwendung rein organische Moleküle als lumineszierender Emitter und/oder als Hostmaterial und/oder als Elektronentransportmaterial und/oder als Lochinjektionsmaterial und/oder als Lochblockiermaterial in organischen lichtemittierenden Dioden (OLEDs) und in anderen optoelektronischen Bauelementen, sowie die Herstellung derartiger optoelektronischer Bauelemente.

## Stand der Technik

In den letzten Jahren hat sich die auf OLED (organische lichtemittierende Dioden) basierende Technik im Bereich Bildschirmtechnik etabliert, so dass nun die ersten hierauf aufbauenden kommerziellen Produkte erhältlich werden. Neben der Bildschirmtechnik eignen sich OLEDs auch für die Anwendung in flächiger Beleuchtungstechnik. Aus diesem Grund wird bezüglich der Entwicklung neuer Materialien intensive Forschung betrieben.

OLEDs sind in der Regel in Schichtenstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, in der in der Regel emittierende Moleküle in einer Matrix eingebettet sind. In dieser Schicht treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten bezüglich OLEDs (Tang et al. Appl. Phys. Lett. 1987, 51, 913) ist diese Technik besonders auf dem Gebiet der Emittermaterialien immer weiterentwickelt worden. Während die ersten Materialien, die auf rein organischen Molekülen beruhen, aufgrund von Spinstatistik maximal 25 % der Exzitonen in Licht umwandeln konnten, konnte durch die Verwendung von phosphoreszierenden Verbindungen dieses grundsätzliche Problem umgangen werden, so dass zumindest theoretisch alle Exzitonen in Licht umgewandelt werden können. Bei diesen Materialien handelt es sich in der Regel um Übergangsmetall-Komplexverbindungen, in denen das Metall aus der dritten Periode der Übergangsmetalle gewählt wird. Hierbei werden vorwiegend sehr teure Edelmetalle wie Iridium, Platin oder auch Gold eingesetzt. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Neben den Kosten ist auch die Stabilität der Materialien zum Teil nachteilig für die Verwendung.

Eine neue Generation von OLEDs basiert auf der Ausnutzung von verzögerter Fluoreszenz (TADF: thermally activated delayed fluorescence oder auch singlet harvesting). Hierbei können beispielsweise Cu(I)-Komplexe verwendet werden, die aufgrund eines geringen Energieabstandes zwischen dem untersten Triplett-Zustand $T_1$ und dem darüberliegenden Singulett-Zustand $S_1$ ($\Delta E(S_1$-$T_1$) Triplett-Exitonen thermisch in einen Singulett-Zustand rückbesetzen können. Neben der Verwendung von Übergangsmetallkomplexen können auch rein organische Moleküle (ohne Metallion) diesen Effekt ausnutzen.

Aus der GB 2 439 030 A sind organische elektrolumineszierende Vorrichtungen mit einer phosphoreszierenden lichtemittierenden Schicht bekannt. Die JP 2014097954 A beschreibt Biphenyl-Verbindungen als 3beta-Hydroxysteroiddehydrogenase Inhibitoren. Die EP 2551932 A2 offenbart Hostmaterialien für phosphoreszente OLEDs.

## Beschreibung

Die Erfindung betrifft in einem Aspekt die Verwendung der im Folgenden beschriebenen rein organischen Moleküle in optoelektronischen Bauelementen.

Derartige organische Moleküle weisen eine Struktur der Formel 1 auf oder haben eine Struktur der Formel 1:

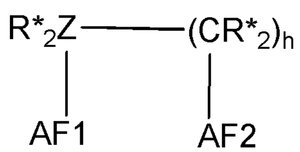

**Formel 1**

In Formel 1 bedeutet:

Z = sp3-Kohlenstoff oder sp3-Silicium;

h ist 0, 1, 2, 3 oder 4;

R* ist bei jedem Auftreten unabhängig voneinander ausgewählt aus der Gruppe bestehend aus H, Deuterium, Phenyl, Naphthyl, F, Cl, Br, I, $N(R^2)_2$, -CN, -NC, -SCN, $-CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-,-C=N-, -C(=O)O-, $-C(=O)N(R^3)-$, $-P(=O)(_R{}^7)-$, $-As(=O)(R^7)-$, $-P(=S)(R^7)-$, $-As(=S)(R^7)-$, -S(=O)-, $-S(=O)_2-$, $-NR^2-$, -O-, oder-S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R* auch miteinander ein mono- oder polycyclisches, aliphatisch benzoannelliertes, aromatisches und/oder benzoannelliertes Ringsystem bilden;

$R^2$ ist bei jedem Auftreten unabhängig voneinander ausgewählt aus der Gruppe bestehend aus H, Deuterium, Phenyl, Naphthyl, $CF_3$, $C(=O)OR^3$, $C(=O)N(R^2)_2$, $Si(R^4)_3$, $C(=O)R^3$, $P(=O)(R^7)_2$, $As(=O)(R^7)_2$ $P(=S)(R^7)_2$, $AS(=S)(R^7)_2$, $S(=O)R^3$, $S(=O)2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$,$-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$,$-As(=O)(R^7)-$, $-P(=S)(R^7)-$, $-As(=S)(R^7)-$, -S(=O)-, $-S(=O)_2-$, $-NR^2-$, -O-, oder -S-ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden;

$R^4$ ist bei jedem Auftreten unabhängig voneinander ausgewählt aus der Gruppe bestehend aus H, Deuterium, Phenyl, Naphthyl, $N(R^2)_2$, CN, $CF_3$, OH, $C(=O)OR^3$, $C(=O)N(R^3)_2$, $C(=O)R^3$, $P(=O)(R^7)_2$, $AS(=O)(R^7)_2$, $P(=S)(R^7)_2$, $As(=S)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden;

$R^5$ ist bei jedem Auftreten unabhängig voneinander ausgewählt aus der Gruppe bestehend aus Phenyl, Naphthyl, $CF_3$, $C(=O)R^3$, $P(=O)(R^7)_2$, $As(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden;

$R^6$ ist bei jedem Auftreten unabhängig voneinander ausgewählt aus der Gruppe bestehend aus Phenyl, Naphthyl, $CF_3$, $Si(R^4)_3$, $C(=O)R^3$, $P(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch-$Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden;

$R^7$ ist bei jedem Auftreten unabhängig voneinander ausgewählt aus der Gruppe bestehend aus Phenyl, Naphthyl, $N(R^2)_2$, CN, $CF_3$, $C(=O)OR^3$, $C(=O)N(R^3)_2$, $Si(R^4)_3$, $C(=O)R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$,$-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$,$-A_s(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden;

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden;

$R^9$ ist bei jedem Auftreten unabhängig voneinander ausgewählt aus der Gruppe bestehend aus H, Deuterium, Phenyl, Naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$,

$P(=O)(R^7)_2$, $P(=S)(R^7)_2$, $AS(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch $-R^3C=CR^3-$, $-C\equiv C-$, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-,-C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, oder-S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem bilden.

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind insbesondere N, O, und S. Werden in der Beschreibung der vorliegenden Erfindung andere Definitionen angegeben, beispielsweise bezüglich der Zahl der aromatischen Ringatome oder der enthaltenen Heteroatome, so gelten diese anderen Definitionen.

Dabei wird unter einer Arylgruppe bzw. Heteroarylgruppe ein einfacher aromatischer Cyclus, also Benzol, bzw. ein einfacher heteroaromatischer Cyclus, beispielsweise Pyridin, Pyrimidin oder Thiophen, oder ein heteroaromatischer Polycyclus, beispielsweise Napthalin, Phenanthren, Chinolin oder Carbazol verstanden. Ein kondensierter (annelierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen; Pyrrol, Indol, Isoindol, Carbazol, Pyridin, Chinolin, Isochinolin, Acridin, Phenanthridin, Benzo-5,6-chinolin, Isochinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benztriazol, 1,2,3-Oxadiazol, 1,2,4-Oxadiazol, 1,2,5-Oxadiazol, 1,2,3,4-Tetrazin, Purin, Pteridin, Indolizin und Benzothiadiazol.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind insbesondere ausgewählt aus der Gruppe bestehend aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (insbesondere weniger als 10% der verschiedenen Atome), wie z.B. ein sp3-hybridisiertes C-, Si-, oder N-Atom, ein sp2-hybridisiertes C-, N- oder O-Atom oder ein sp-hybridisiertes C-Atom, verbunden sein können. So sollen beispielsweise auch System wie 9,9'-Diarylfluoren, Triarylamin, Diarylether, Stilben etc als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppen oder durch eine Silylgruppe verbunden sind. Weiterhin werden auch Systeme, in denen zwei oder mehr Aryl- oder Heteroyraylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 bis 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Napthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin,

Phenanthridin, Benzo-5,6-chinolin Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyarzinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,2,3 Oxadiazol, 1,2,3-Thiadiazol, 1,2,5-Thiadiazol, 1,3,4-Thiadiazol, 1,3,5-Triazin, 1,2,4-Triazin, 1,2,3-Triazin, Tetrazol, 1,2,3,5-Tetrazin, 1,2,3,4-Tetrazin, Purin, Pteridin, Indolizin und Benzothiadiazol oder Kombinationen dieser Gruppen.

AF: Organische chemische Einheit (Rest). Es sind zwei unterschiedliche chemische Einheiten AF1 und AF2 im Molekül enthalten; AF1: eine erste chemische Einheit, aufweisend ein konjugiertes System, insbesondere mindestens sechs in Konjugation stehende $\pi$-Elektronen (z. B. in Form mindestens eines aromatischen Systems); AF2: eine zweite chemische Einheit, aufweisend ein konjugiertes System, insbesondere mindestens sechs in Konjugation stehende $\pi$-Elektronen (z. B. in Form mindestens eines aromatischen Systems); Definitionsgemäß weist AF2 im Vergleich zu AF1 immer einen niedrigeren (mathematischen) HOMO-Zahlenwert auf (und damit auch entsprechend einen niedrigeren LUMO-Zahlenwert als AF1).

In einer Ausführungsform sind die chemischen Einheiten AF1 und AF2 derart über die Einheit $R^*_2$-Z-$(CR^*_2)_h$ miteinander verknüpft, dass die elektronische Kommunikation zwischen ihnen unterbrochen wird. Diese Unterbrechung ist durch eine Lokalisierung der Grenzorbitale HOMO und LUMO auf separaten Teilen des organischen Moleküls gekennzeichnet, sodass ein Charge-Transfer Übergang ermöglicht wird Die Einheit $R^*_2$-Z-$(CR^*_2)_h$ wird daher hier auch als Separator S bezeichnet.

In einer Ausführungsform sind die chemischen Einheiten AF1 und AF2 derart über einen Separator miteinander verbunden, dass die elektronische Kommunikation zwischen ihnen unterbrochen wird, was anhand der Lokalisierung der Grenzorbitale HOMO und LUMO auf separaten Molekülteilen gekennzeichnet ist.

Die elektronische Kommunikation zwischen den zwei chemischen Einheiten AF1 und AF2 über konjugierte Bindungen mit einem Separator ist unterbrochen, wenn die Grenzorbitale HOMO und LUMO auf separaten Molekülteilen lokalisiert sind, sodass ein Charge-Transfer Übergang ermöglicht wird. Die Lokalisierung der Grenzorbitale HOMO oder LUMO wird dabei mithilfe der Dichtefunktionaltheorie (DFT) mit dem BP86-Funktional (Becke, A. D. Phys. Rev. A1988, 38, 3098-3100; Perdew, J. P. Phys. Rev. B1986, 33, 8822-8827) visualisiert: Aus der Einelektronen-Wellenfunktion wird die Einelektronendichte durch Quadrieren berechnet und über den Raum integriert, den der untersuchte Molekülteil einnimmt. Dieser Raum kann aus den Atomkoordinaten und den van-der-Waals-Radien der Atome bestimmt werden. Die resultierende Zahl entspricht dem Anteil des Orbitals auf dem Molekülteil. Eine mehrheitliche Trennung der Grenzorbitale entspricht dabei einem Überlappungsparameter O im Bereich 0,1-20%, um einen Charge-Transfer Übergang zu ermöglichen. Der Überlappungsparameter O zwischen der HOMO-Wellenfunktion $\phi_a$ und der der LUMO-Wellenfunktion $\phi_b$ ergibt sich aus dem Integral über den gesamten Raum über den jeweils kleineren Wert der quadrierten Wellenfunktion:

$$O = \int \rho \, \mathrm{d}\tau \text{ mit } \rho = \begin{cases} \varphi_a^2, & \text{wenn } |\varphi_a| < |\varphi_b| \\ \varphi_b^2, & \text{wenn } |\varphi_a| \geq |\varphi_b| \end{cases}$$

In einer Ausführungsform zeichnet sich das Molekül dadurch aus, dass

- die Differenz der Energie des HOMO der zweiten chemischen Einheit AF2 und der Energie des HOMO der ersten chemischen Einheit AF1 > 0,8 eV ist ($\Delta$ HOMO = HOMO(AF2) - HOMO(AF1) > 0,8 eV);
- die Differenz der Energie des LUMO der zweiten chemischen Einheit AF2 und der Energie des LUMO der ersten chemischen Einheit AF1 > 0,8 eV ist ($\Delta$ LUMO = LUMO(AF2) - LUMO(AF1) > 0,8 eV); und
- die Differenz der Energie des LUMO der ersten chemischen Einheit AF1 und der Energie des HOMO der zweiten chemischen Einheit AF2 > 0,9 eV ist ($\Delta$ Gap = LUMO (AF1) - HOMO(AF2)> 0,9 eV).

Dabei werden die Energiewerte HOMO(AF1), HOMO(AF2), LUMO(AF1), LUMO(AF2) mithilfe der Dichtefunktionaltheorie (DFT) berechnet, wobei die Anknüpfungspositionen der chemischen Einheiten und der Separatoren mit einem Wasserstoffatom entsprechend ihrer chemischen Valenzen abgesättigt werden. Die angegebenen Grenzen beziehen sich auf Orbitalenergien in eV, die mit dem BP86-Funktional berechnet werden (Becke, A. D. Phys. Rev. A1988, 38, 3098-3100; Perdew, J. P. Phys. Rev. B1986, 33, 8822-8827).

In einer Ausführungsform weisen die organischen Moleküle eine Struktur der Formel 2b bis 2c auf oder haben eine Struktur der Formel 2b bis 2c, wobei die bei Formel 1 angegebenen Definitionen gelten. Für Formel 2b ist G definiert als ein sp3 hybridisiertes Kohlenstoff- oder Siliziumatom. Für Formel 2c ist Z' ausgewählt aus folgenden Möglichkeiten:

Einfachbindung oder $C(R^*)_2$ oder $Si(R^*)_2$.

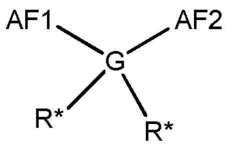

**Formel 2b**

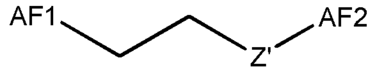

**Formel 2c**

Der Teil des organischen Moleküls gemäß Formel 1, Formel 2b bis Formel 2c, der nicht chemische Einheiten AF darstellt, entspricht dem Separator S.

In einer Ausführungsform sind die organischen Moleküle ausgewählt aus:

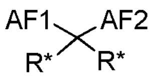
2-44

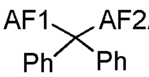
2-45

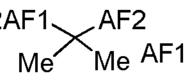
2-46

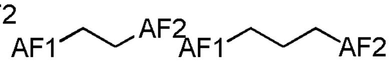
2-47

2-48

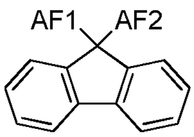
2-49

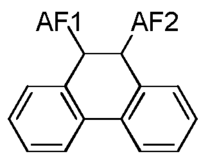
2-50

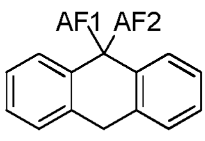
2-51

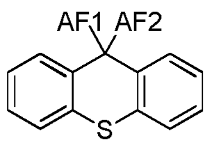
2-52

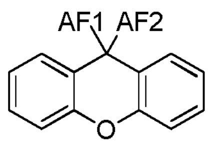
2-53

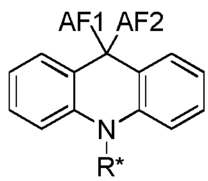
2-54

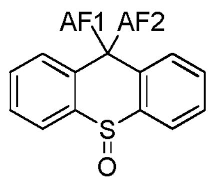
2-55

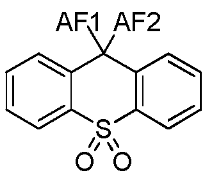
2-56

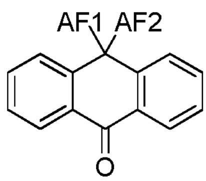
2-57

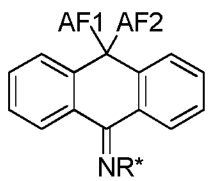
2-58

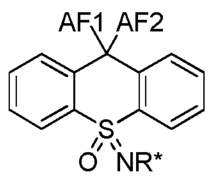
2-59

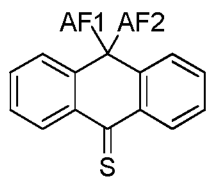
2-60

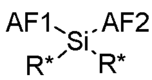
2-61

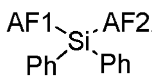
2-62

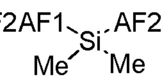
2-63

Wiederum wird der Teil des organischen Moleküls, der nicht chemische Einheiten AF darstellt, auch als Separator S bezeichnet.

**Tabelle 1:** Auflistung der erste chemischen Einheiten AF1 und der zweiten chemischen Einheiten AF2. Eine gegebene chemische Einheit kann in einem organischen Molekül eine chemische Einheit AF1 darstellen, in einem anderen Molekül eine chemische Einheit AF2 darstellen. Mögliche Anknüpfungspunkte der chemischen Einheit AF an einen Separator S sind mit Kleinbuchstaben bezeichnet.

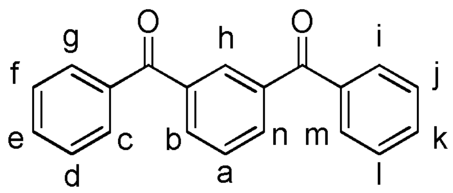

27

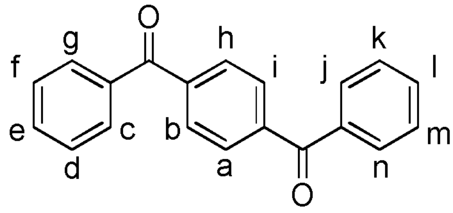

28

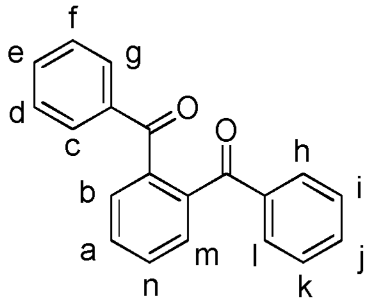

29

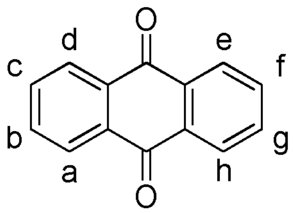

36

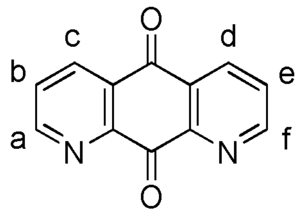

37

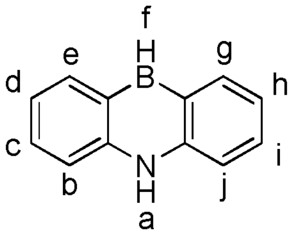

38

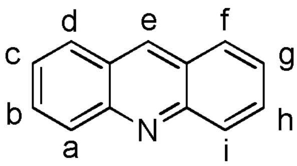

40

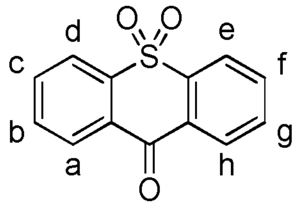

43

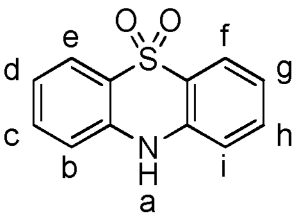

44

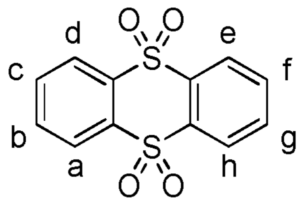

46

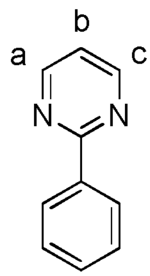

56

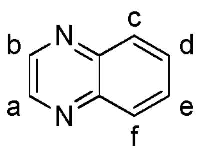

61

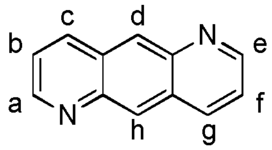

62

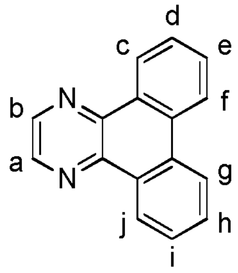

65

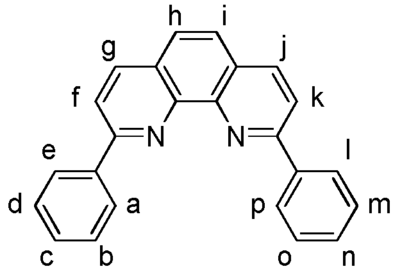

68

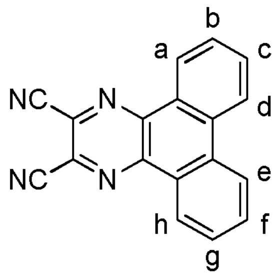

70

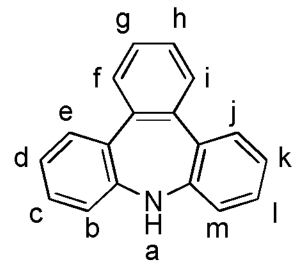

71

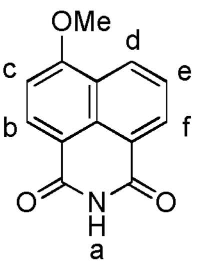

79

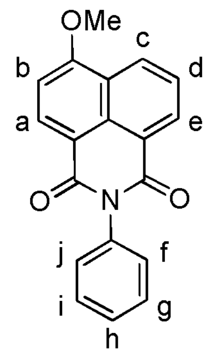

80

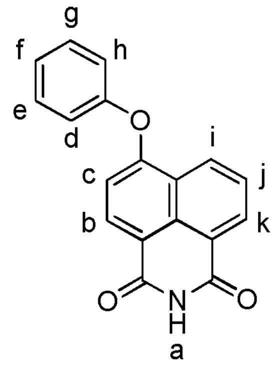

81

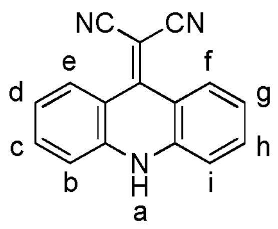

82

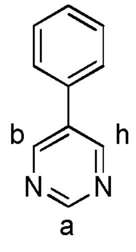

83

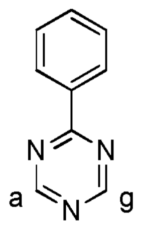

85

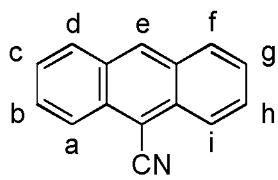

86

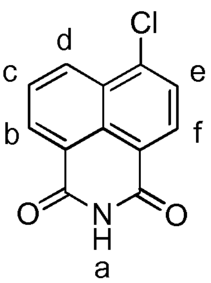

89

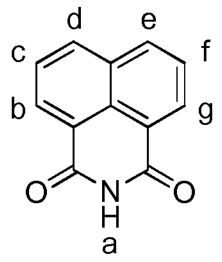

90

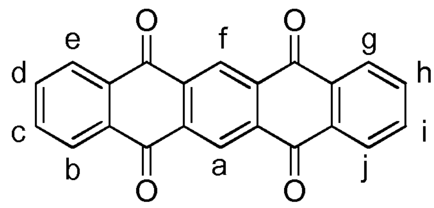

93

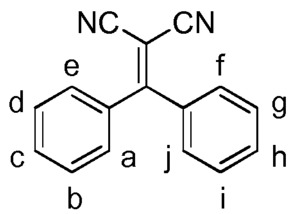

109

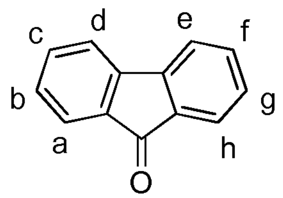

110

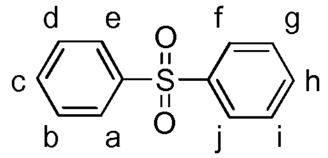

111

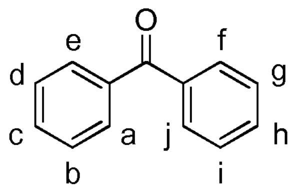

112

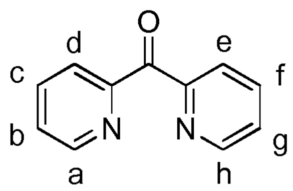

113

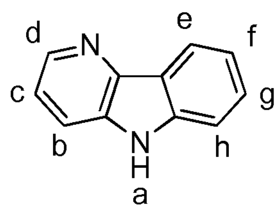

114

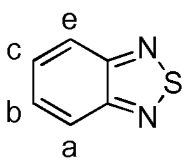

115

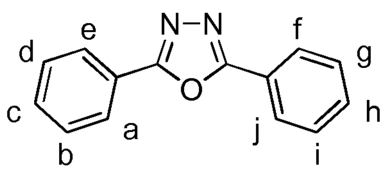

118

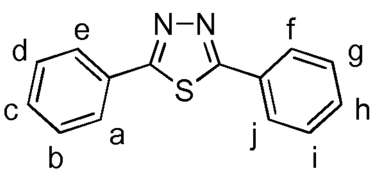

119

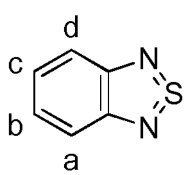

121

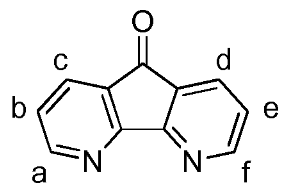

123

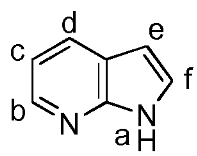

127

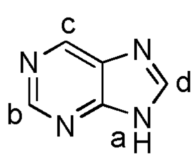

131

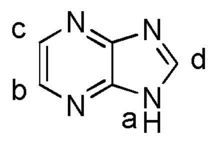

132

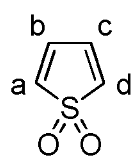

133

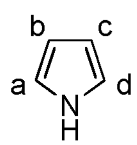

134

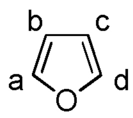

135

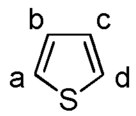

136

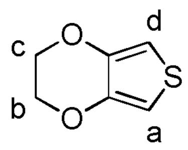

140

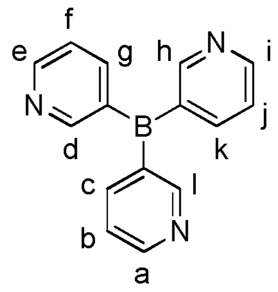

144

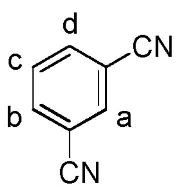

150

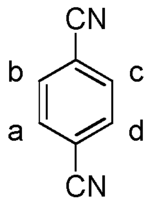

151

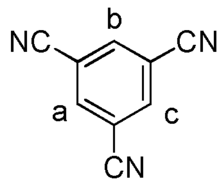

152

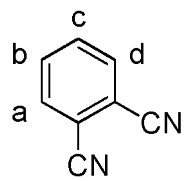

153

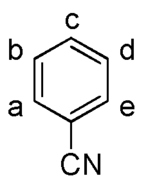

154

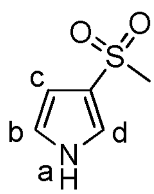

157

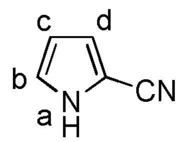

158

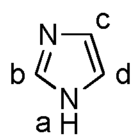

159

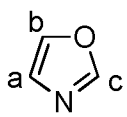

160

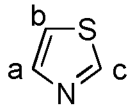

161

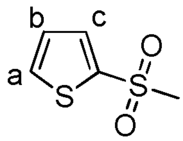

166

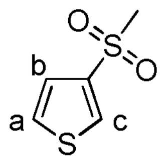

167

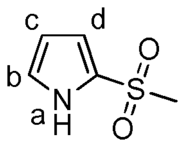

168

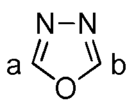

170

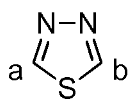

171

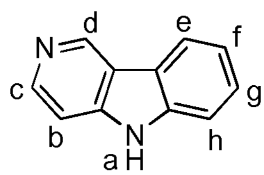

175

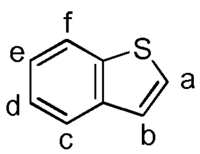

176

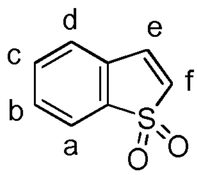

177

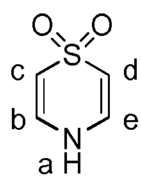

182

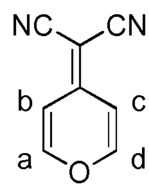

183

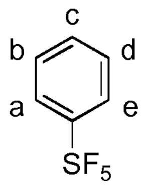

184

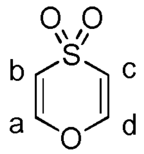

187

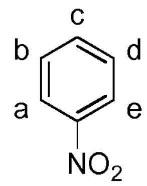

192

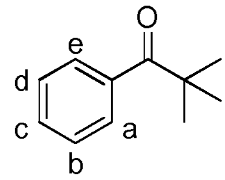

193

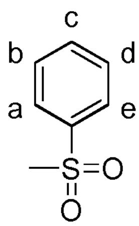

194

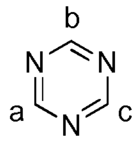

195

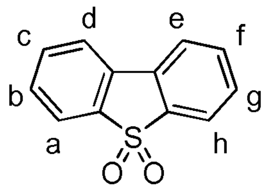

198

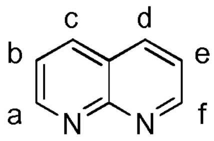

205

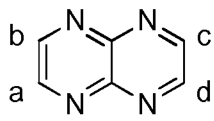

206

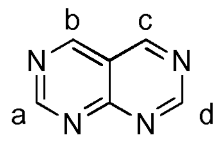

207

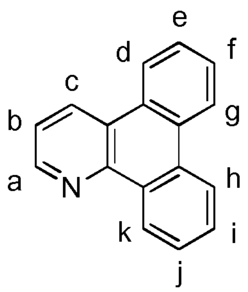

208

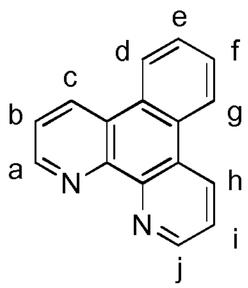

209

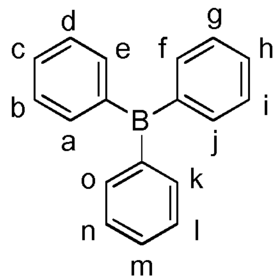

213

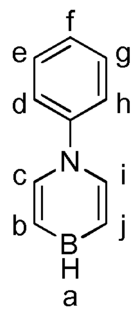

214

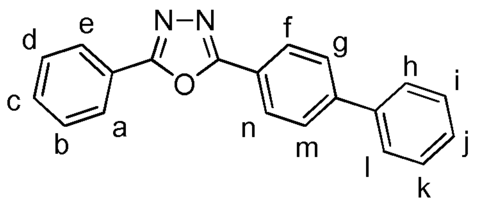

217

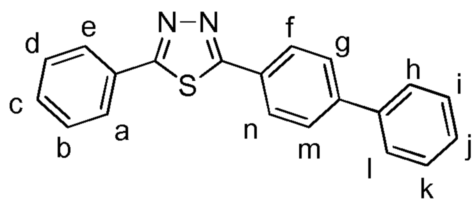

218

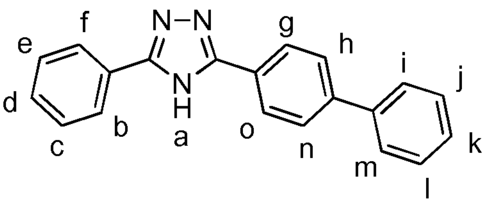

219

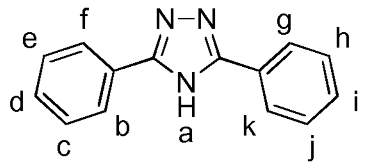

222

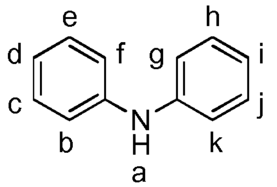

223

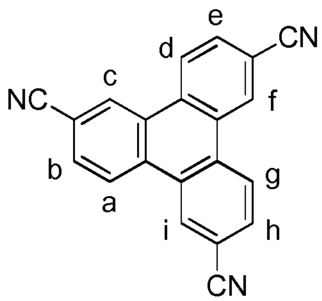

231

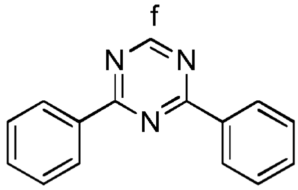

233

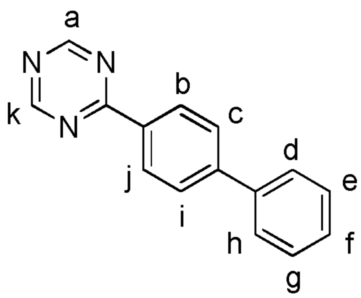

234

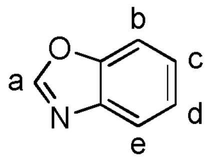

236

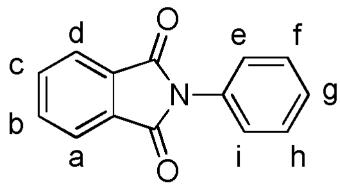

237

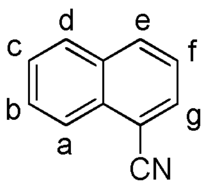

244

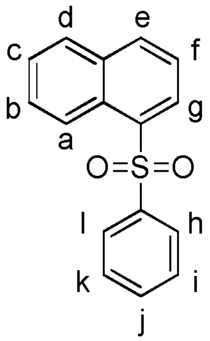

245

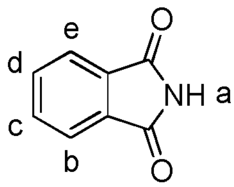

246

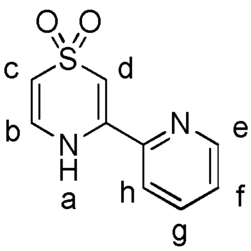

275

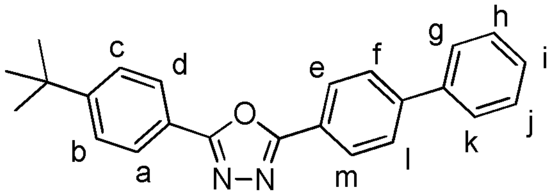

285

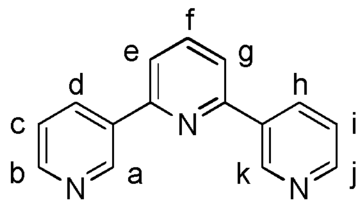

286

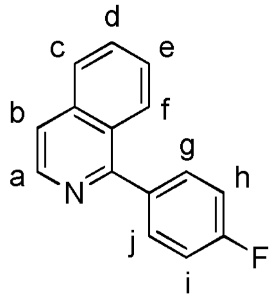

287

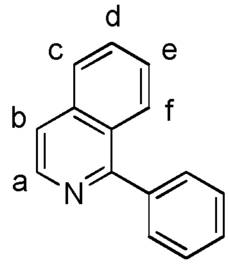

288

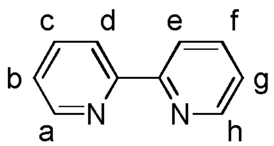

297

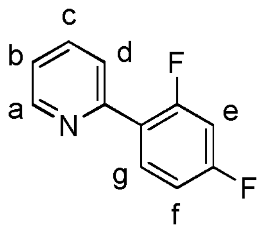

300

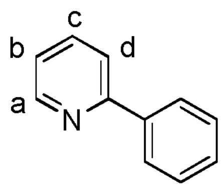

303

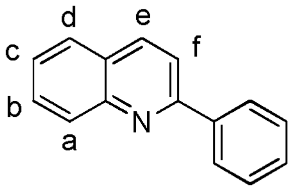

304

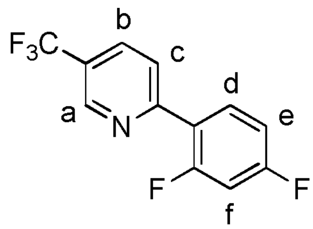

305

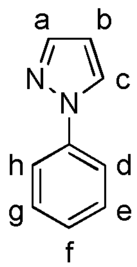

308

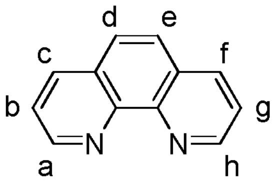

311

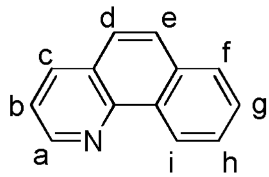

312

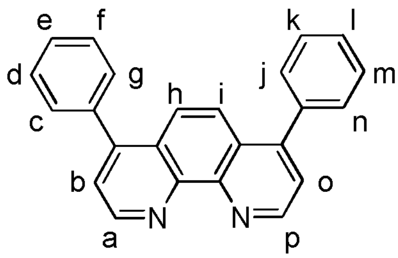

313

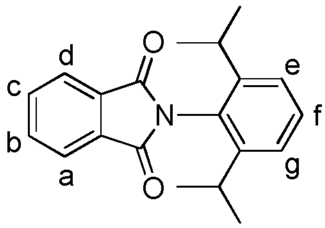

327

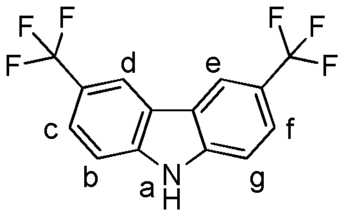

331

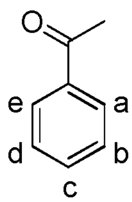

332

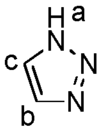

338

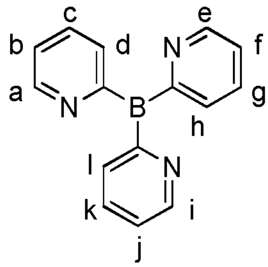

341

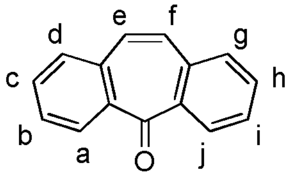

358

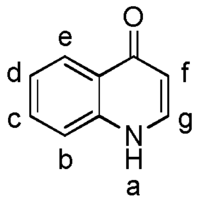

360

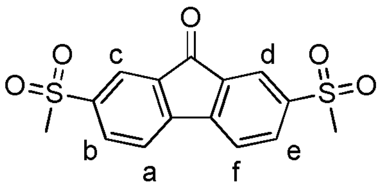

364

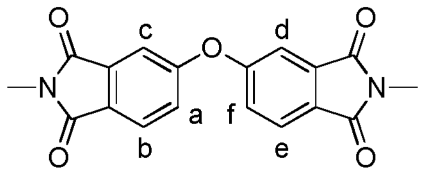

367

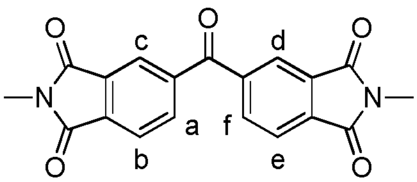

368

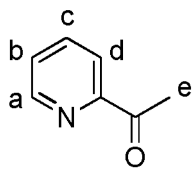

370

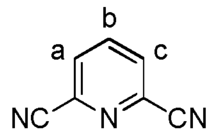

371

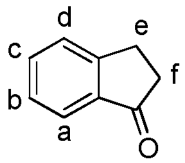

391

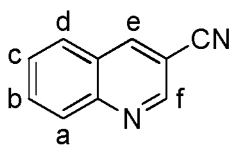

395

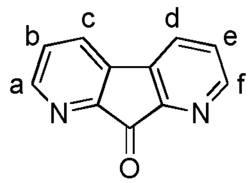

420

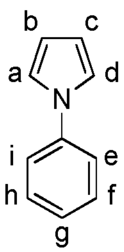

421

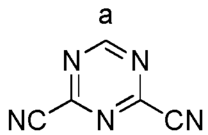

429

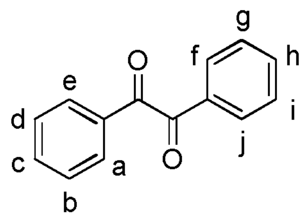

430

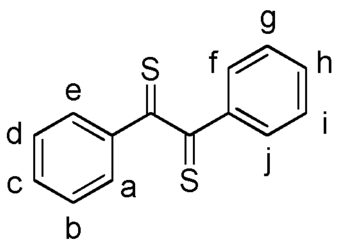

431

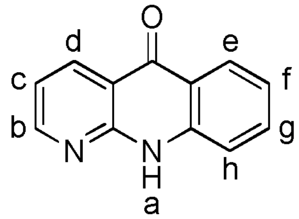

434

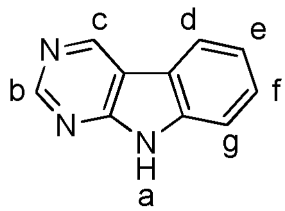

437

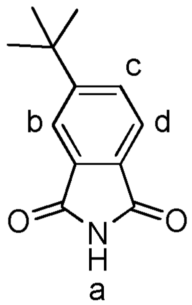

440

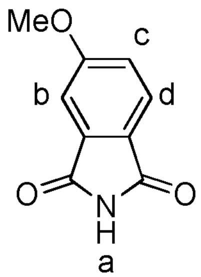

441

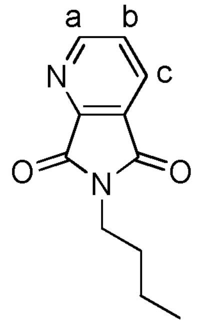

473

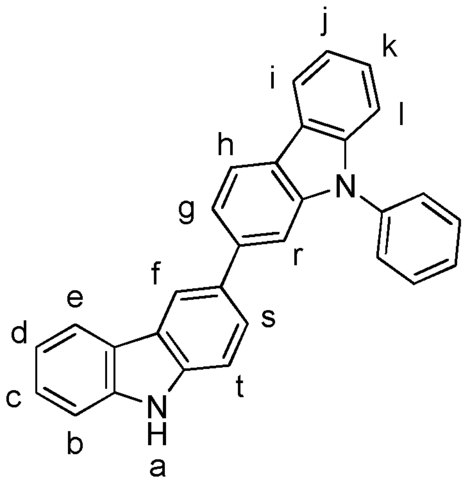

1

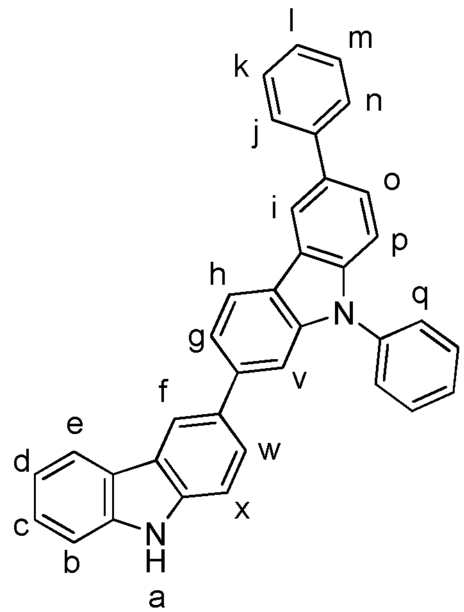

2

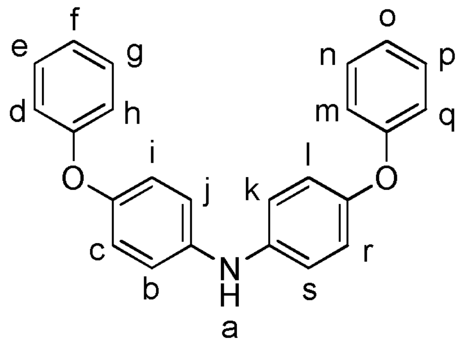

3

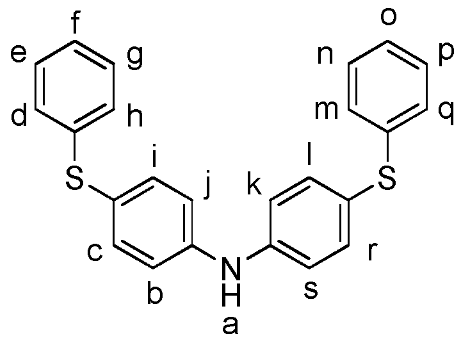

4

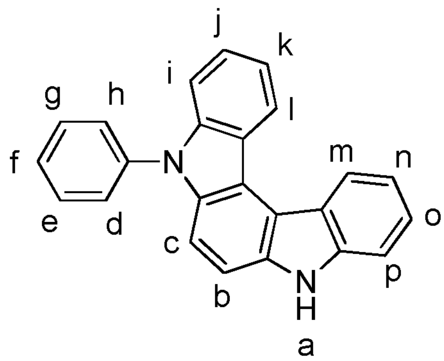

6

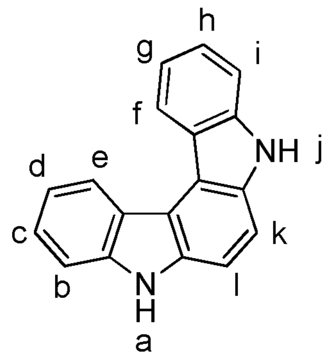

7

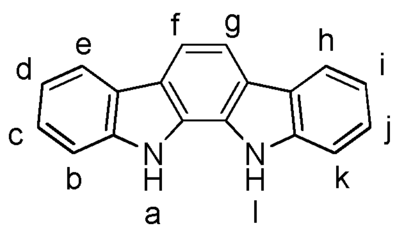

8

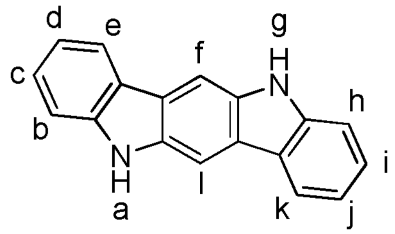

10

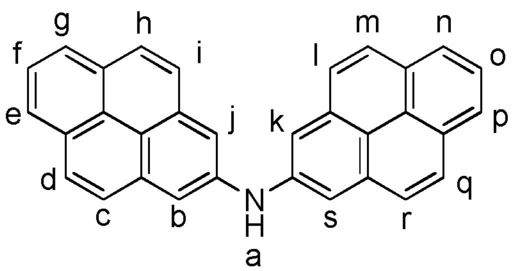

11

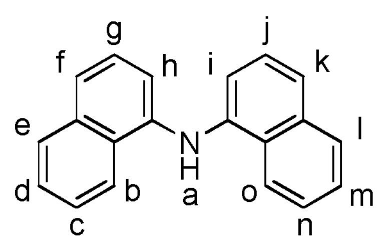

12

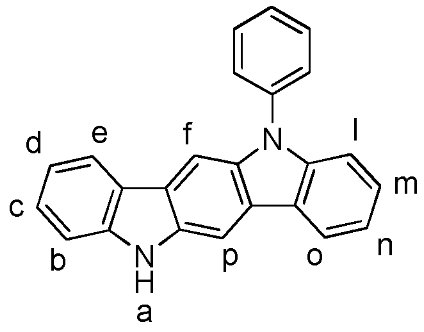

24

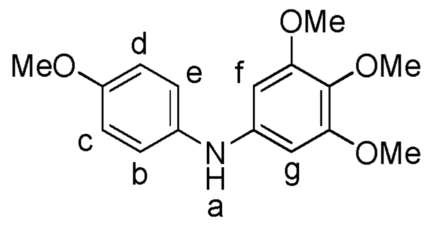

26

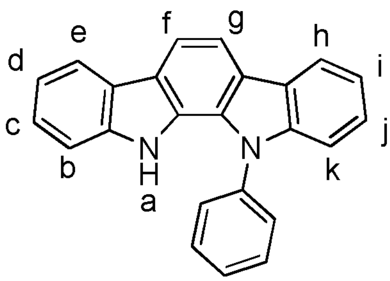

21

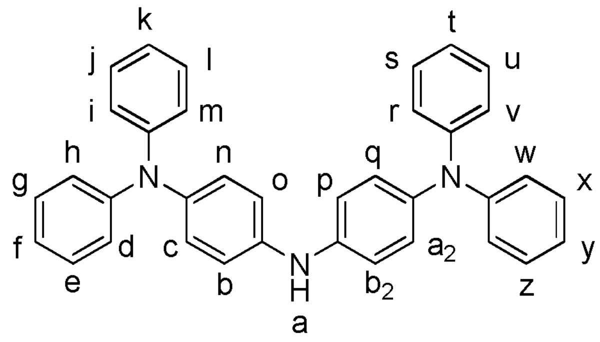

22

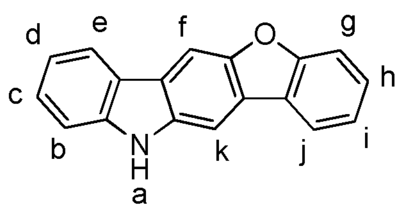

30

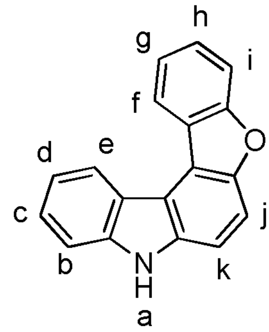

31

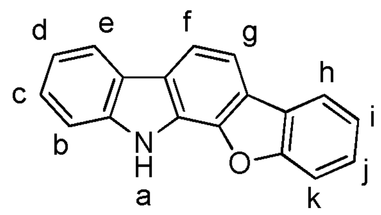

32

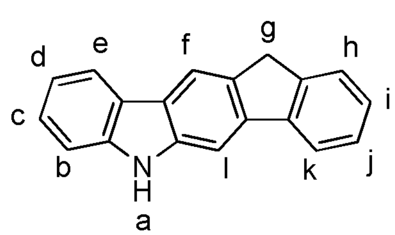

33

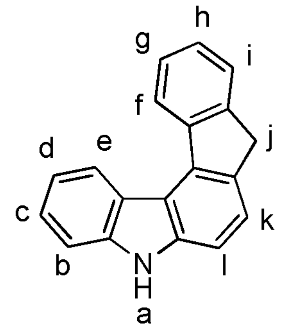

34

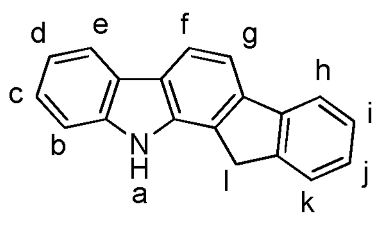

35

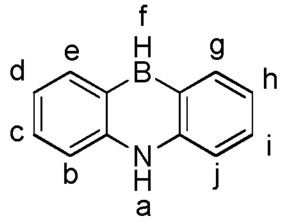

38

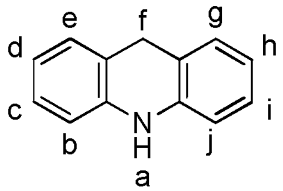

39

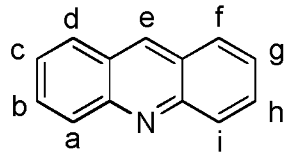

40

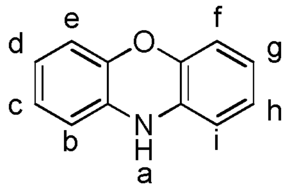

41

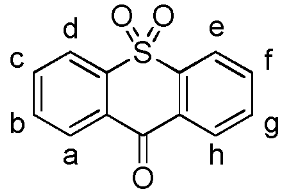

43

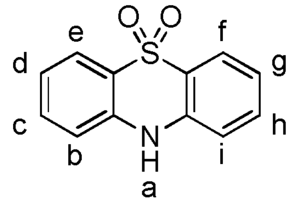

44

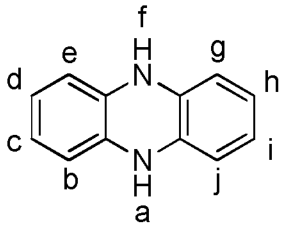

49

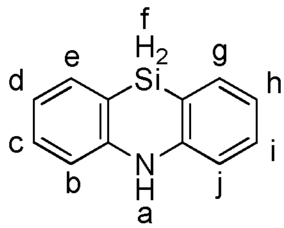

53

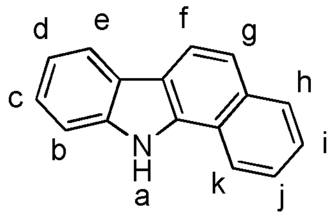

54

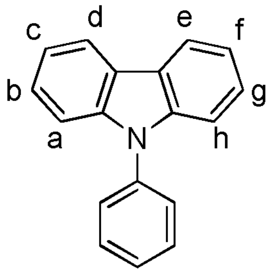

55

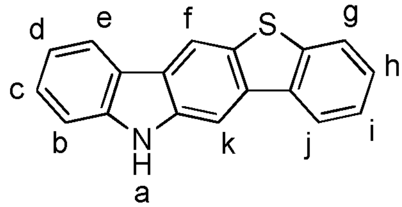

58

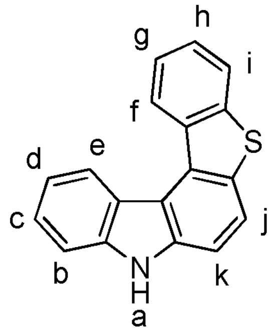

59

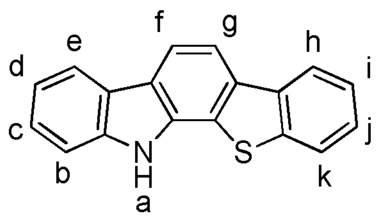

60

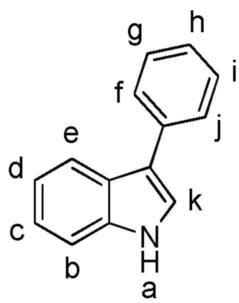

63

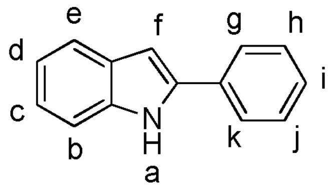

64

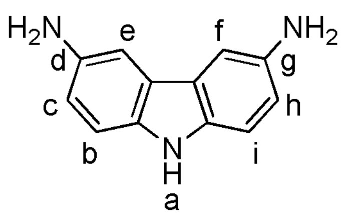

66

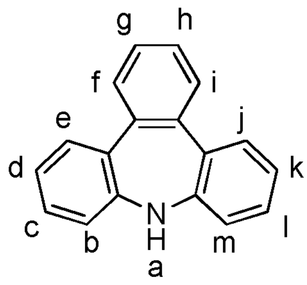

71

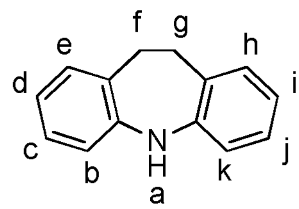

72

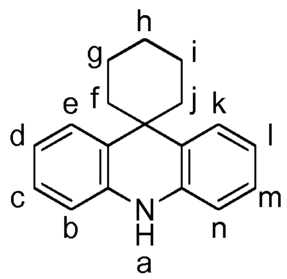

73

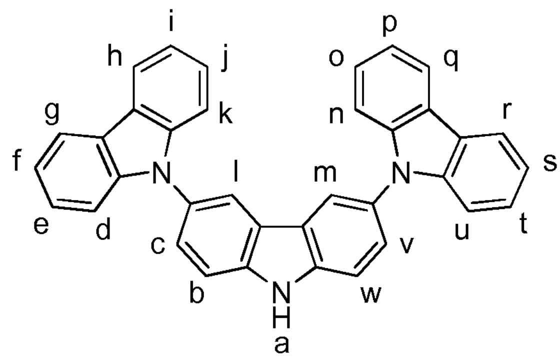

74

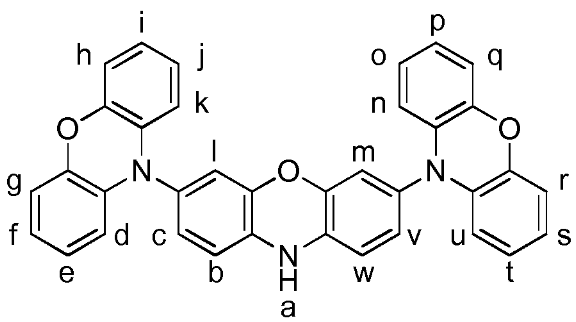

75

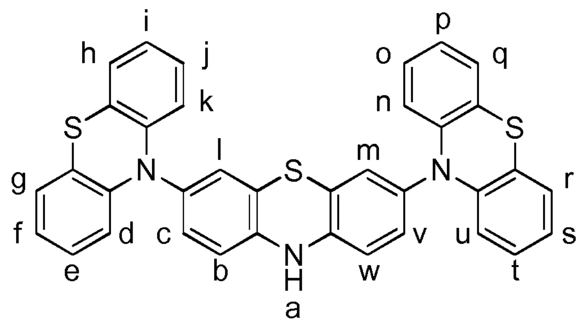

76

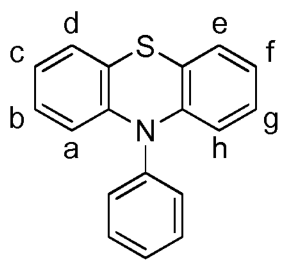

77

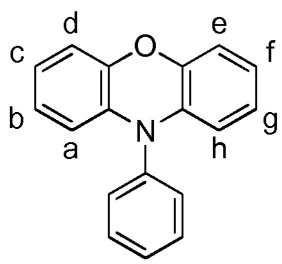

78

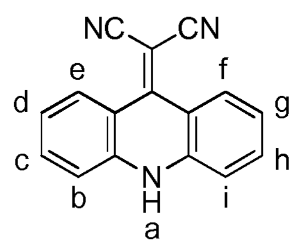

82

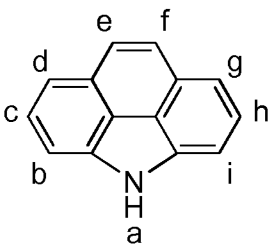

88

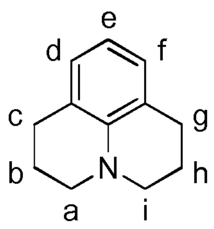

91

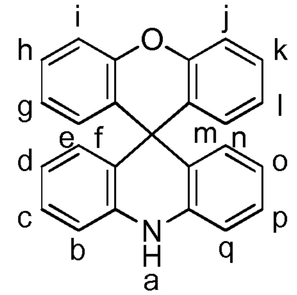

94

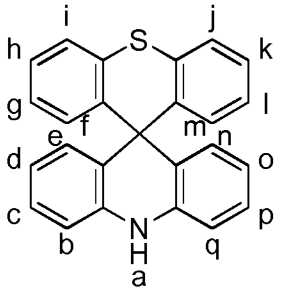

95

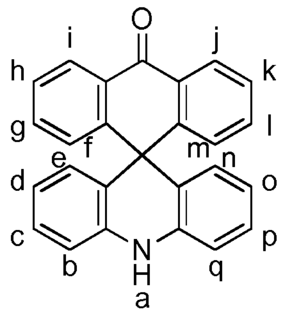

96

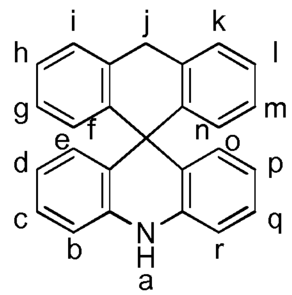

97

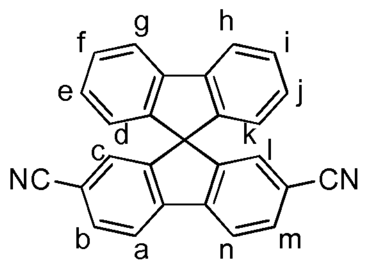

101

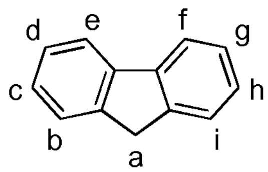

106

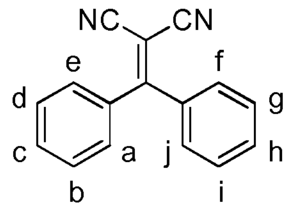

109

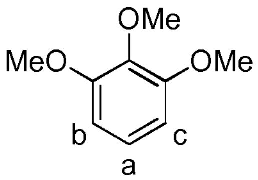

120

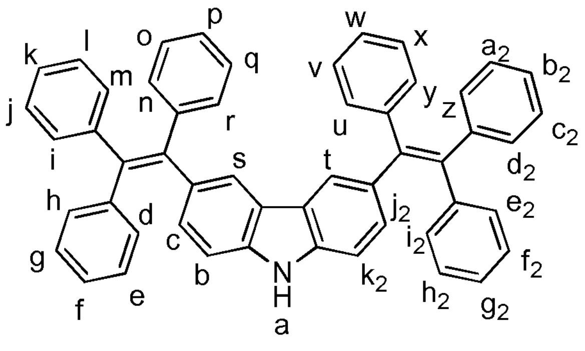

124

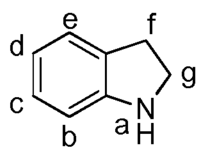

128

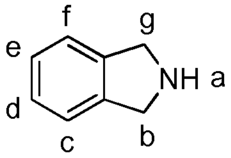

129

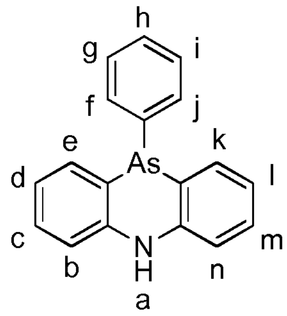

149

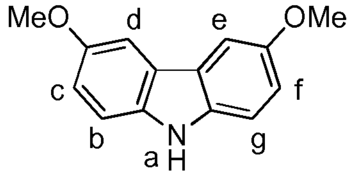

199

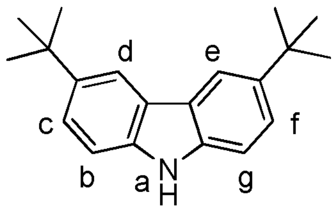

200

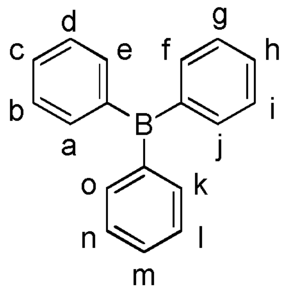

213

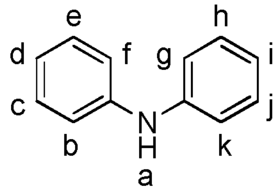

223

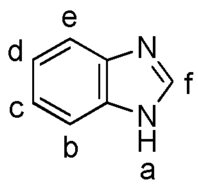

239

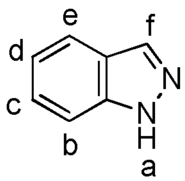

240

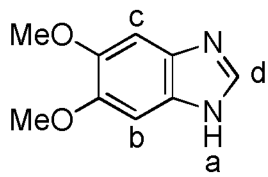

242

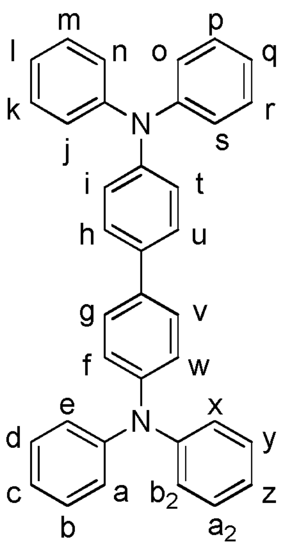

278

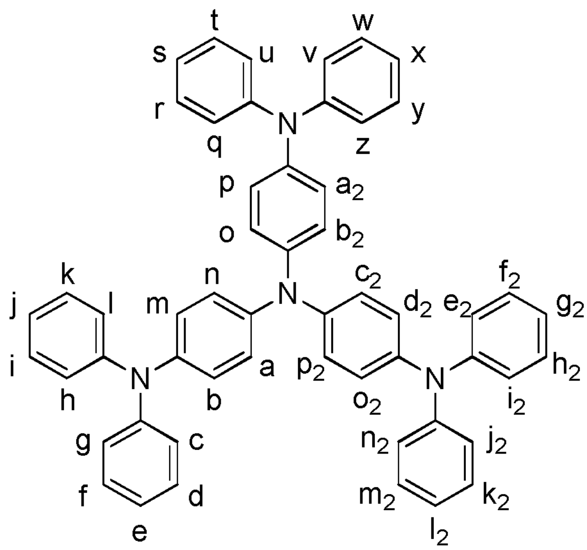

281

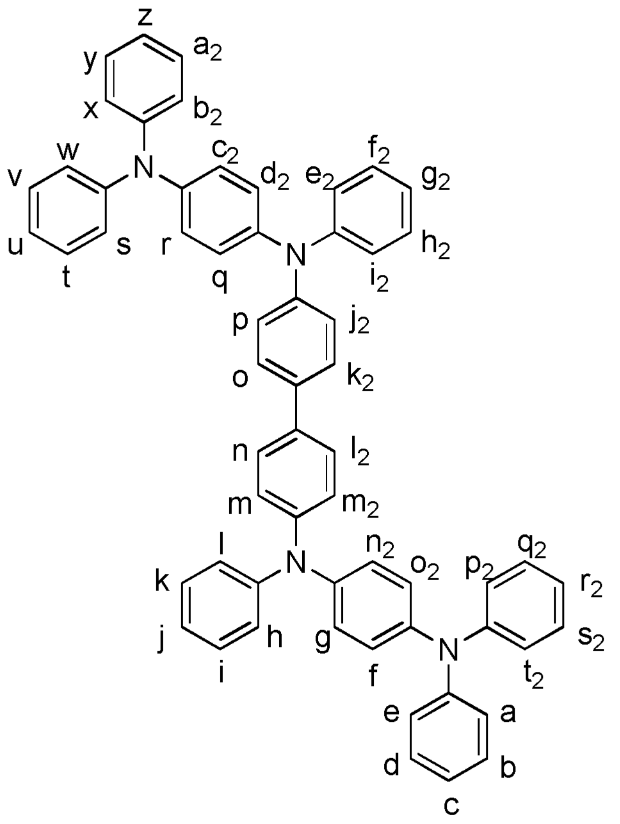

283

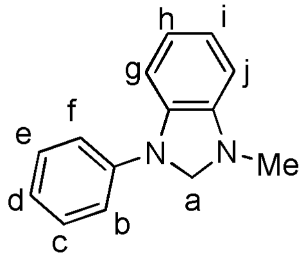

314

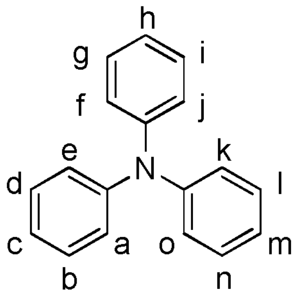

317

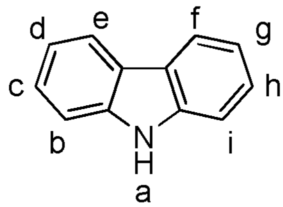

328

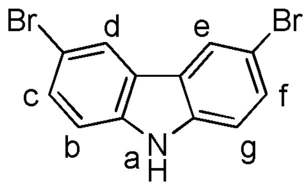

330

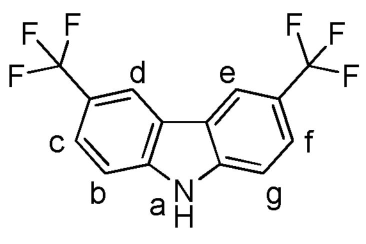

331

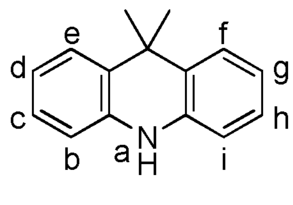

337

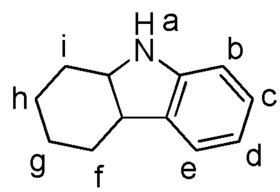

339

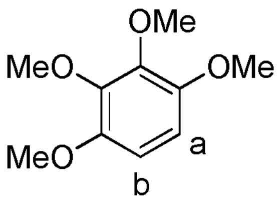

344

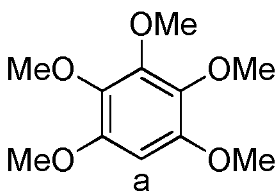

345

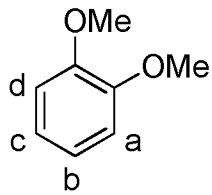

346

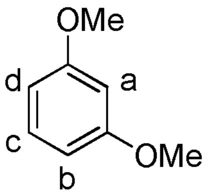

347

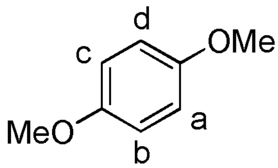

348

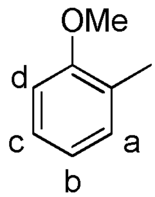

349

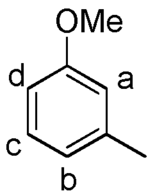

350

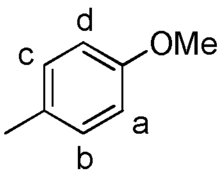

351

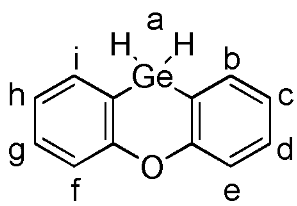

352

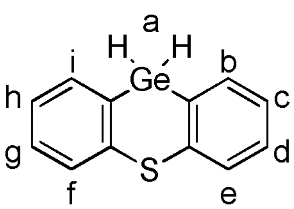

353

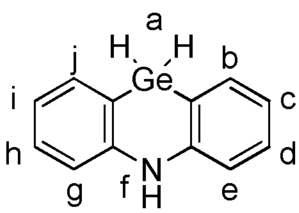

354

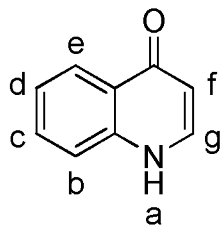

360

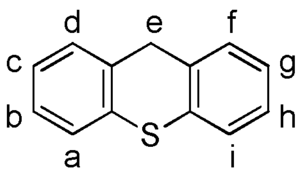

366

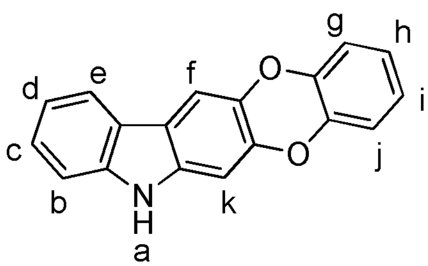

377

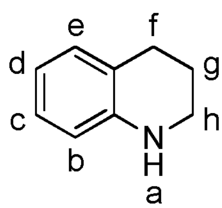

383

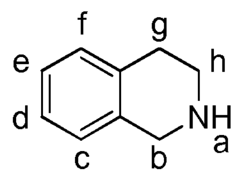

384

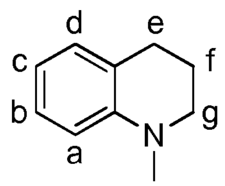

387

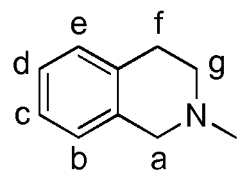

388

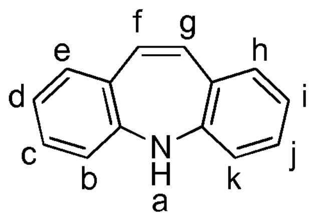

400

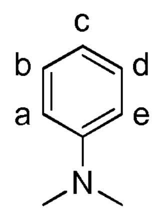

404

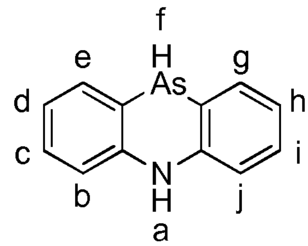

405

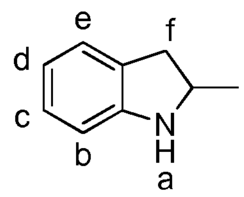

406

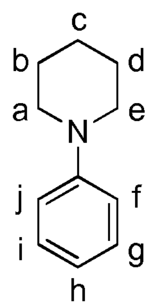

407

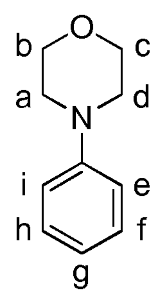

408

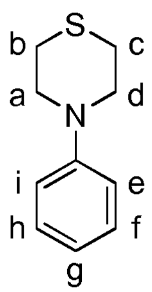

409

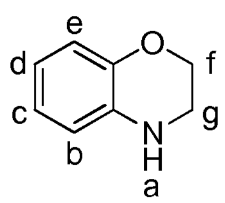

410

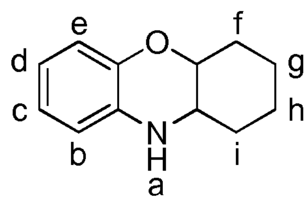

411

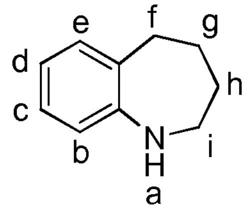

412

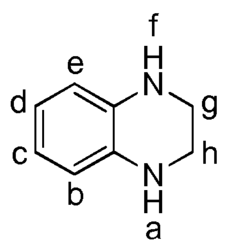

413

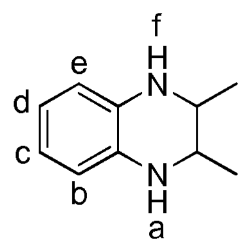

414

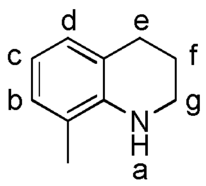

417

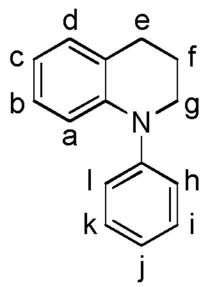

418

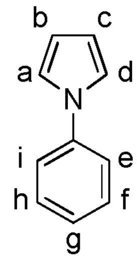

421

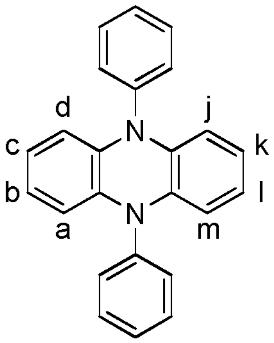

425

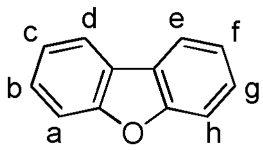

432

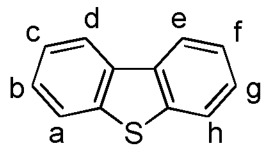

433

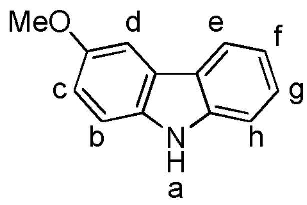

436

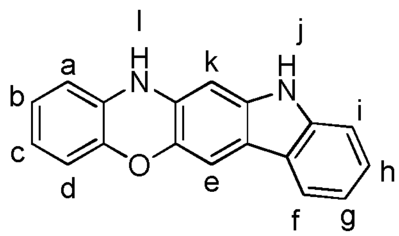

477

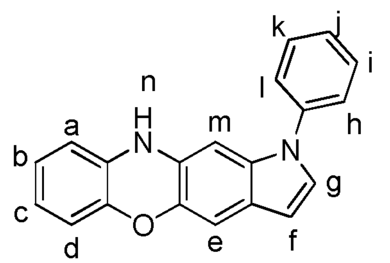

478

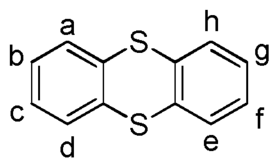

480

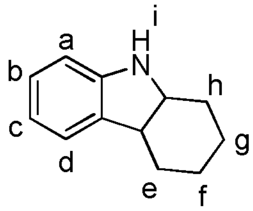

481

**Tabelle 2:** Beispiele für organische Moleküle (AF1-S-AF2). Die Benennung der Moleküle enthält links die erste chemische Gruppe AF1 aus Tabelle 1, die über einen Separator S (Moleküleinheit ohne AFs, siehe Formel 3 weiter unten) an eine zweite chemische Gruppe AF2 (aus Tabelle 1) gebunden ist, die rechts genannt ist.

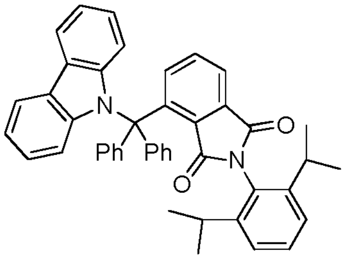

328-S3-45-327

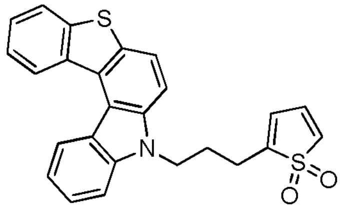

59-S3-48-133

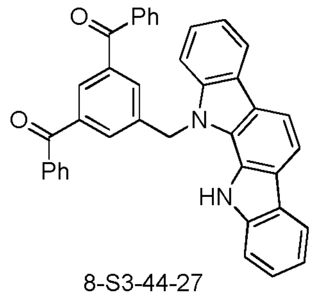

8-S3-44-27

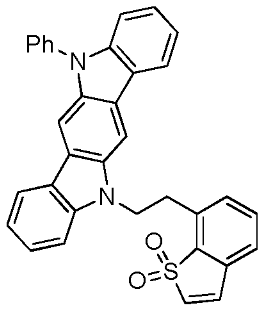

10-S3-47-177

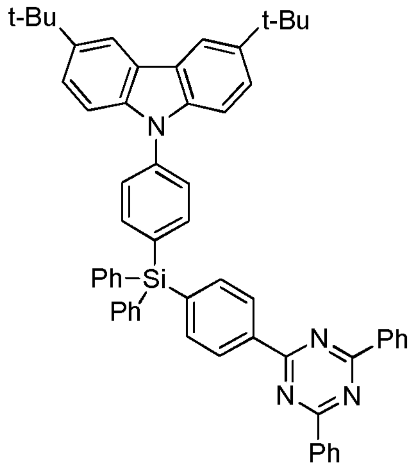

233-3-62-200

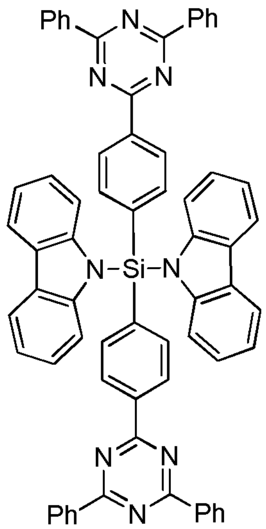

$(233)_2$-3-62-$(328)_2$

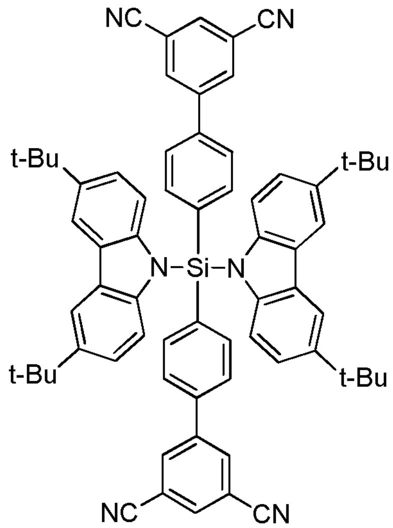

$(150)_2$-3-62-$(200)_2$

Weitere Beispiele der Moleküle

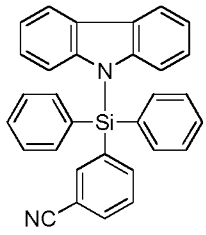
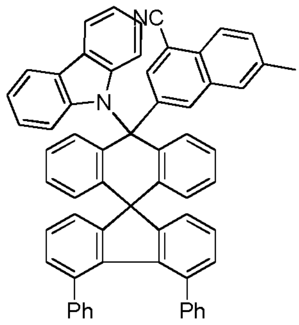
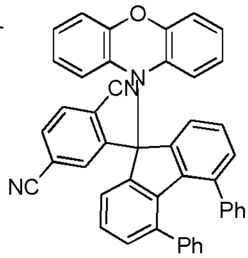
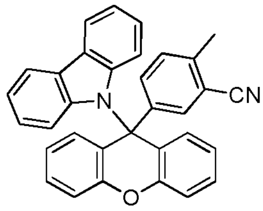

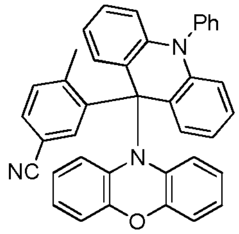
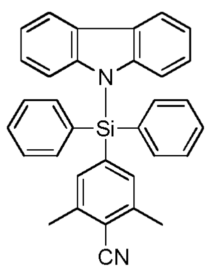
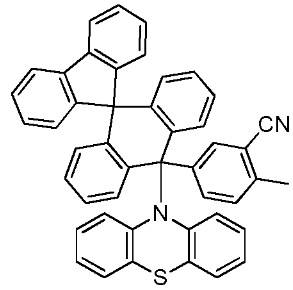
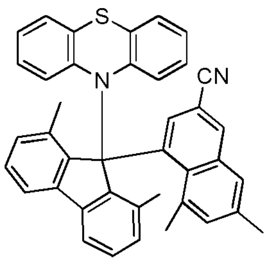

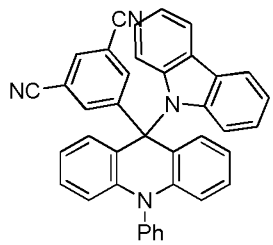
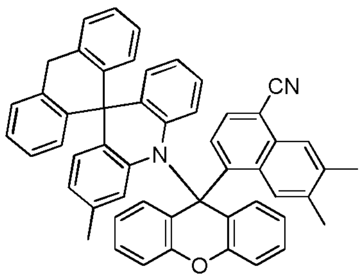
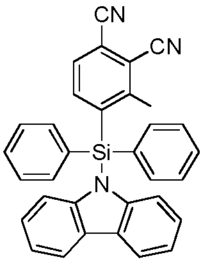
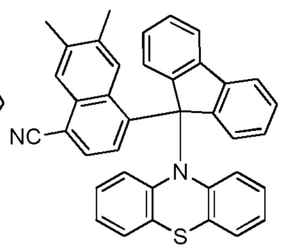

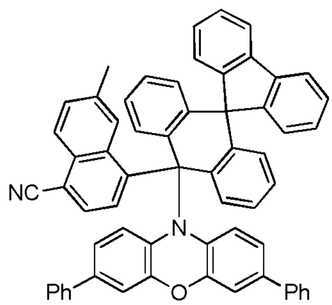
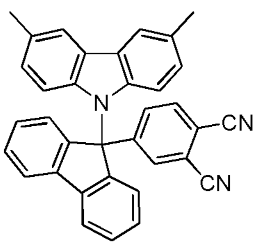
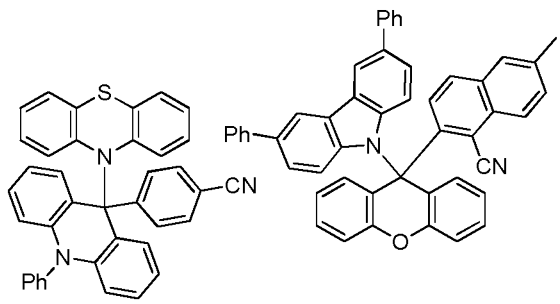

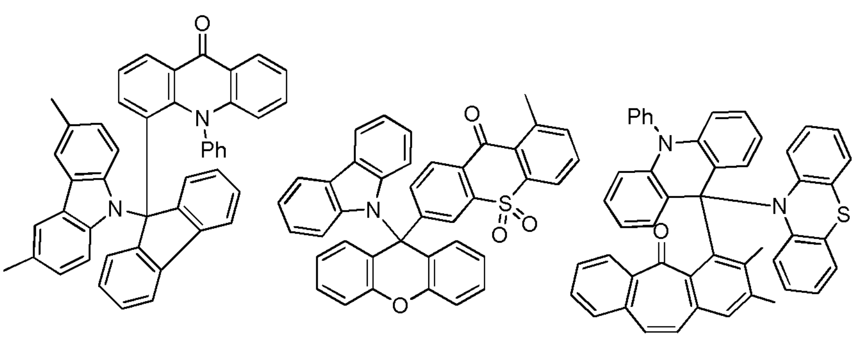
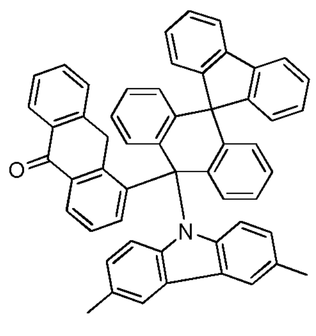

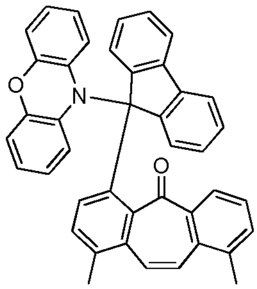
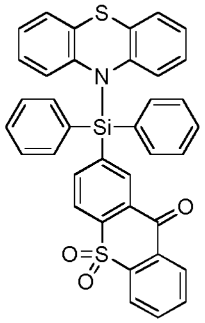
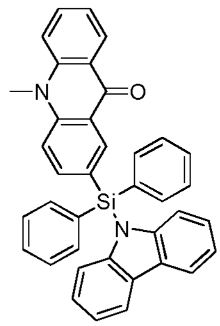
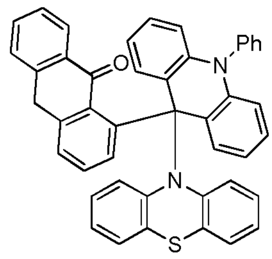
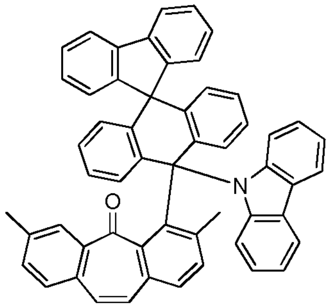
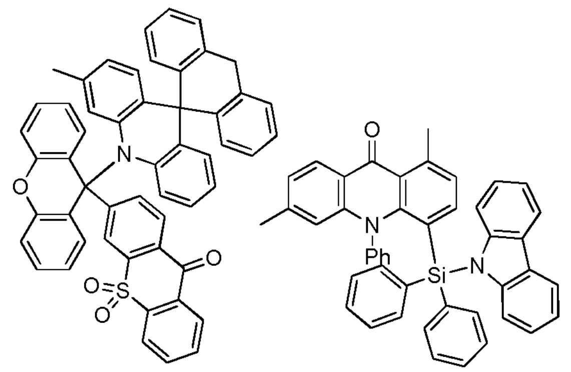
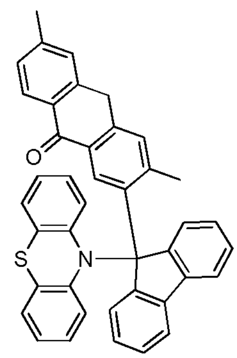
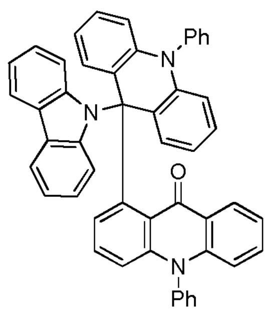
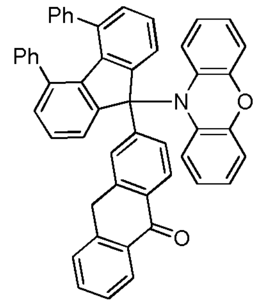
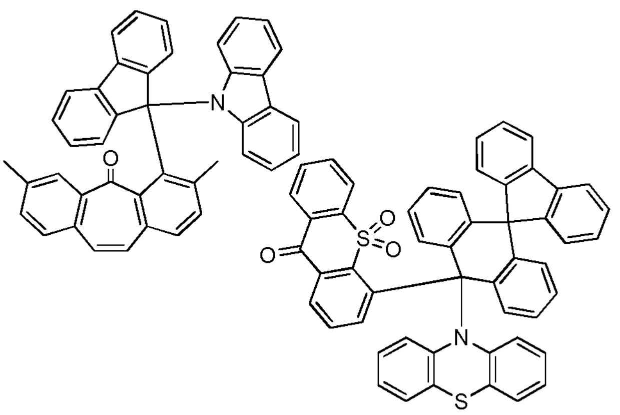
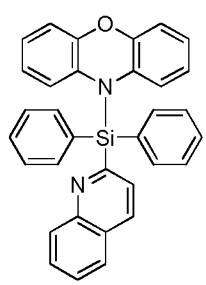
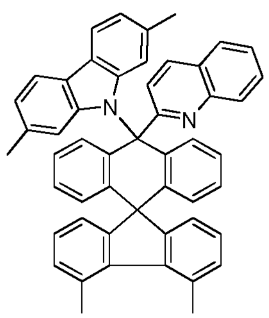
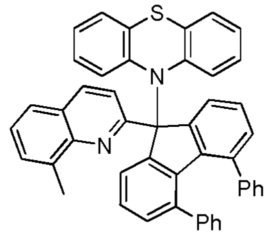
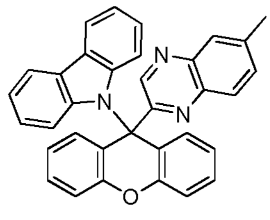

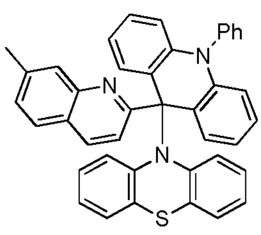
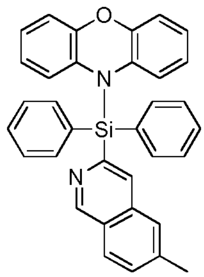
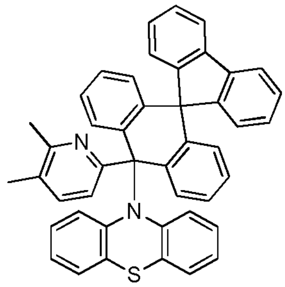
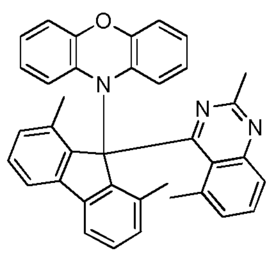

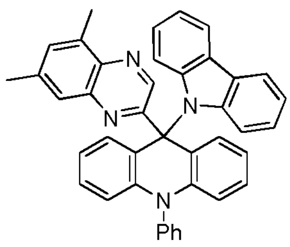
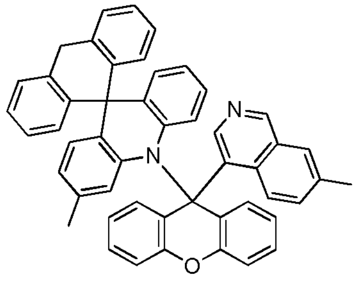
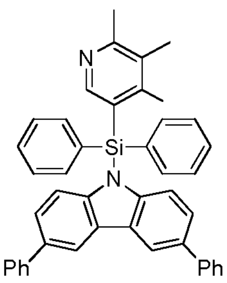
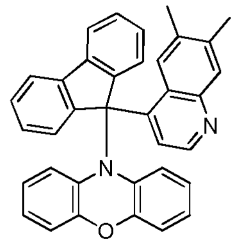

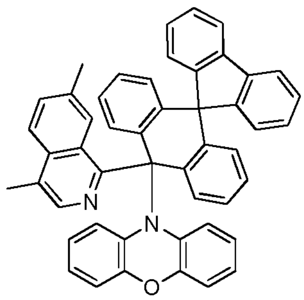
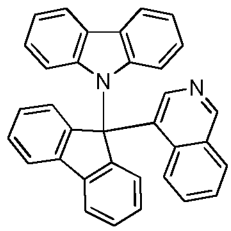
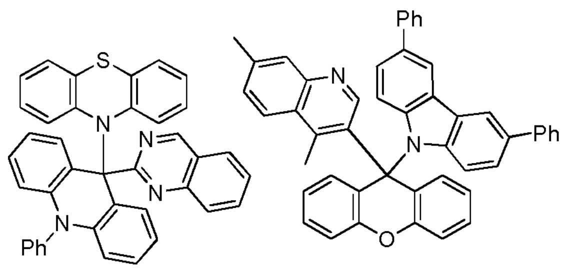

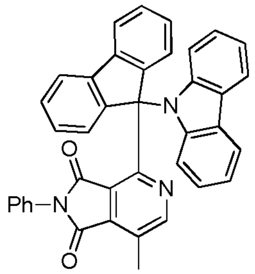
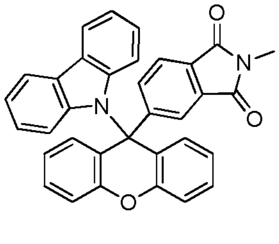
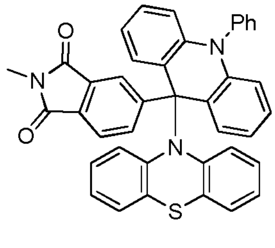
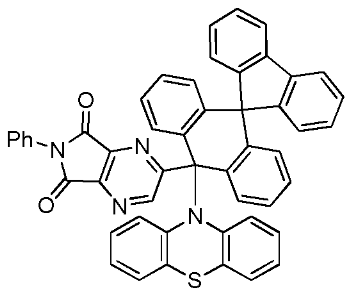

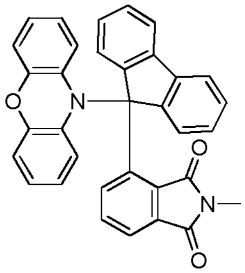
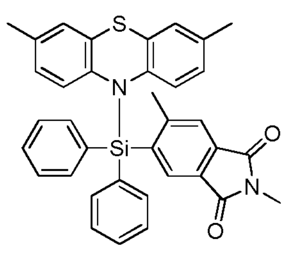
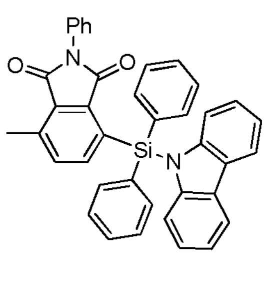
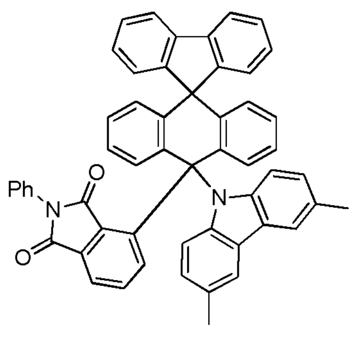

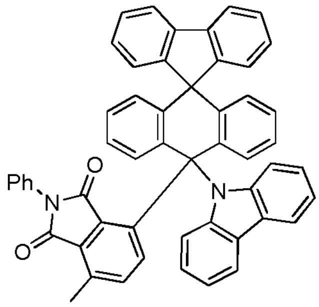
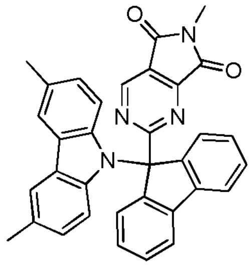
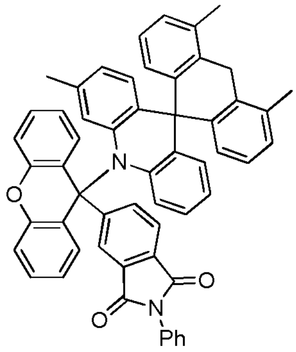
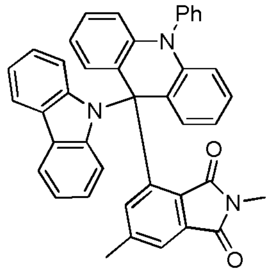

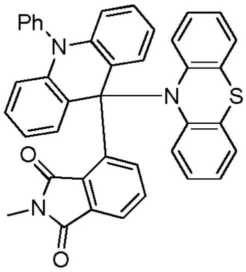
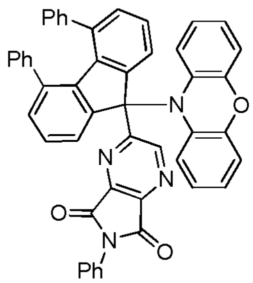
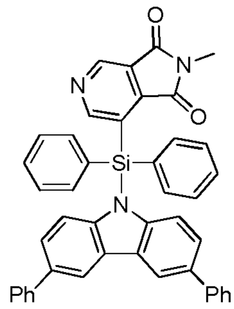
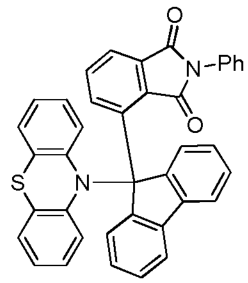

In Tabelle 1 sind mögliche Anknüpfungspositionen der chemischen Einheit AF zur Verknüpfung mit einem Separator S des Moleküls mit Kleinbuchstaben a bis z bezeichnet. Jede aromatische C-H und N-H Bindung ist optional mit einem löslichkeitsvermittelnden und/oder einem die Polymerisierbarkeit ermöglichenden Rest R substituiert.

Streicht man in Formeln 1 und 2b bis 2c und bei den Verbindungen 2-44 bis 2-63 die AF, so verbleiben die Molekülfragmente, die hier als Separator S bezeichnet werden.

In einer Ausführungsform handelt es sich bei dem Separator S um ein Molekülfragment mit einer der nachfolgenden Strukturen, wobei # die Stelle kennzeichnet, an denen die AF an den Separator gebunden werden:

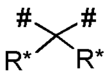
3-44

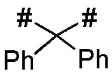
3-45

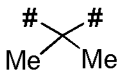
3-46

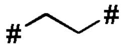
3-47

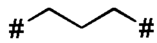
3-48

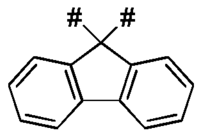
3-49

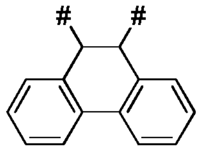
3-50

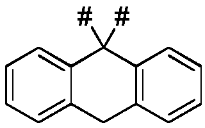
3-51

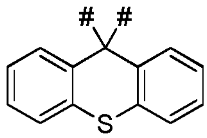
3-52

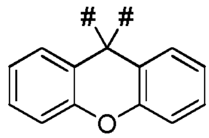
3-53

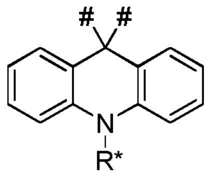
3-54

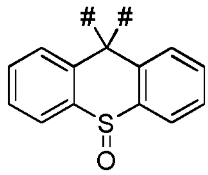
3-55

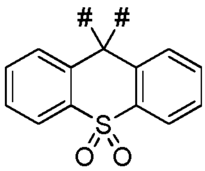
3-56

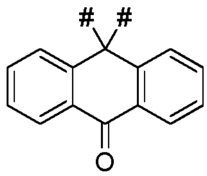
3-57

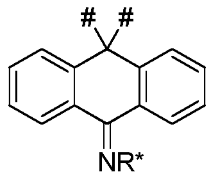
3-58

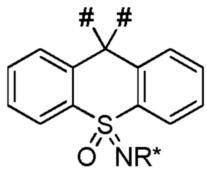
3-59

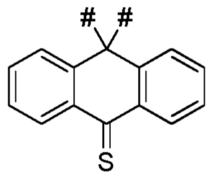
3-60

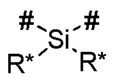
3-61

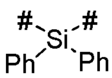
3-62

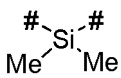
3-63

## Formel 3

Insbesondere der Separator S unterscheidet die organischen Moleküle funktionell von Molekülen gemäß dem Stand der Technik, durch die hier gezeigte Art der Trennung von chemischen Einheiten AF (oder Donoren und Akzeptoren). Bekannte organische Emitter bestehen in der Regel aus direkt verknüpften chemischen Einheiten; eine Trennung der konjugierten aromatischen Systeme fand bisher nicht statt, insbesondere in Verbindung mit der Lokalisierung von HOMO und LUMO auf separaten Molekülteilen. Separatoren dienen der Unterbrechung der elektronischen Kommunikation zwischen den chemischen Einheiten AF1 und AF2 durch eine derartige Verknüpfung der Einheiten, dass die Grenzorbitale HOMO und LUMO auf mehrheitlich separaten Molekülteilen liegen, was ohne den Separator nicht zwingend der Fall sein muss. Separatoren im Sinne dieser Erfindung verändern die Lage des HOMO bzw. LUMO der in Tabelle 1 gezeigten chemischen Einheiten AF nicht signifikant. Als nicht signifikant gilt im Rahmen dieser Erfindung eine Veränderung von nicht mehr als +/-0,4 eV. Die Berechnung derartiger Energien ist bekannt und funktioniert nach der oben beschriebenen Weise per DFT-Rechnung.

Anhand spektroskopischer Auswahlregeln (symmetrische Moleküle) oder durch Messung des Extinktionskoeffizienten (UV/VIS-Spektroskopie) oder quantenchemische Berechnung der Oszillatorstärke kann vorhergesagt werden, ob ein quantenmechanischer Übergang erlaubt ist. Je größer die Oszillatorstärke, desto eher ist ein Übergang erlaubt und desto schneller ist der damit verbundene Prozess (Abklingdauer). Wünschenswert sind Abklingdauern von < 50 $\mu$s. Bei einer langen Abklingdauer des (organischen) Emitters kommt es bei hohen Stromstärken schnell zu Sättigungseffekten, was die Bauteillebensdauer negativ beeinflusst und die Erreichung hoher Helligkeiten verhindert.
Ein Maß für die Abklingdauer ist das quantenmechanischen Überlappungsintegral, welches näherungsweise durch den oben definierten Überlappungsparameter O dargestellt wird. Je kleiner das Überlappungsintegral, desto stärker sind die Grenzorbitale HOMO und LUMO getrennt, und umso wahrscheinlicher der Charge-Transfer-Übergang. Jedoch sinkt gleichermaßen die Wahrscheinlichkeit einer TADF-Emission aufgrund abnehmender Oszillatorstärken.
Bei einem Wert von 1 für den Überlappungsparameter O liegt nicht mehr verzögerte Fluoreszenz (TADF) aufgrund eines Charge-Transfer Übergangs vor.
Um eine effiziente TADF-Emission mit kurzen Abklingdauern zu erreichen, muss das Überlappungsintegral gezielt gesteuert werden. Die gewünschte Überlappung wird durch die geeignete Wahl eines Separators S erreicht.

Die gezeigten Separatoren S erfüllen insbesondere zwei funktionelle Merkmale (s. Figur 2):

- die HOMO-Energie ist niedriger als die HOMO-Energie der als Donor fungierenden chemischen Einheit AF und
- die LUMO-Energie ist höher als die LUMO-Energie der als Akzeptor fungierenden chemischen Einheit AF.

Durch Kombination der oben definierten Paare aus chemischen Einheiten AF1 und AF2 und der Festlegung der Verknüpfung durch einen Separator S, der insbesondere von einer Struktur der Formel 3 ist, ergeben sich die beispielhaften Moleküle der Tabelle 2. Weitere organische Moleküle können durch Kombination der genannten Moleküleinheiten analog erhalten werden.

Hierdurch werden Verbindungen erhalten, die sich für den Einsatz in OLEDs eignen, beispielsweise als Emitter, Host- und/oder Matrixmaterial oder als Lochtransport-/Elektronenblockiermaterial oder als Elektronentransport- bzw. Lochblockiermaterial. Die Verwendung dieser Verbindungen führen zu guten Eigenschaften der organischen Elektrolumineszenzvorrichtung, insbesondere hinsichtlich der Lebensdauer, der Effizienz und der Betriebsspannung. Entsprechende Verbindungen, sowie organische Elektrolumineszenzvorrichtungen, welche derartige Verbindungen enthalten, sind daher der Gegenstand der Erfindung. Die überraschenden Effekte werden durch die spezielle Anordnung der Donoren und Akzeptoren über den Separator in Verbindungen der oben aufgeführten Formeln erreicht. Durch diese wohldefinierte (hochgeordnete) Parallelausrichtung der Donor- und Akzeptoreinheiten, in der eine gewisse Nahordnung der Einheiten vorliegt, zugleich eine Trennung der Grenzorbitale gewährleistet ist, kann das Überlappungsintegral gezielt gesteuert werden. Bedingt durch die geringen Abstände der Gruppen zueinander könnten zwischenmolekulare Wechselwirkungen, wie beispielsweise $\pi$-$\pi$-Wechselwirkung über den Raum für einen schnellen Charge-Transfer-Übergang mit ursächlich sein.

In einer Ausführungsform weist die Einheit AF1 eine Struktur der Unterformel 1 auf oder hat eine Struktur der Unterformel 1

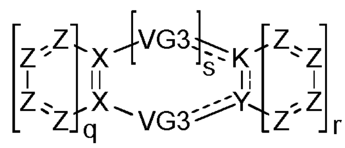

**Unterformel 1**

wobei gilt:

q ist 0 oder 1; r ist 0 oder 1; s ist 0 oder 1;

VG3 = verbrückende Gruppe ist bei jedem Auftreten unabhängig voneinander ausgewählt aus der Gruppe bestehend aus

N, O, S, CR**, C, eine Element-Element-Einfachbindung zwischen X und Y oder zwischen X und K, wobei nicht 2 Einheiten VG3 gleichzeitig eine Element-Element-Einfachbindung zwischen X und Y und zwischen X und K sind,
BR**, NR**, $GeR^{**}_2$, $AsR^{**}_2$, $SiR^{**}_2$ (wobei nicht zwei Einheiten VG3 gleichzeitig gleich BR**, NR**, $GeR^{**}_2$, $AsR^{**}_2$, $SiR^{**}_2$ sind),

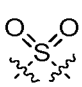 , 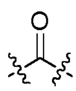 , 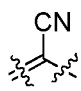 , 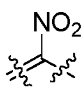 , 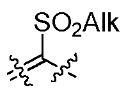 , 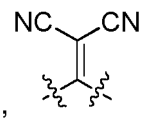 , 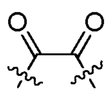 , 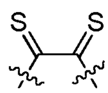 , 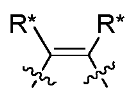 ,

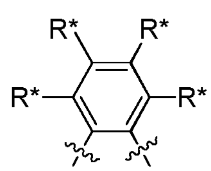 ,

wobei nicht zwei Einheiten VG3 gleichzeitig gleich

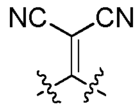, 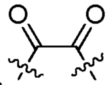

, 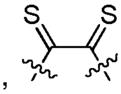, 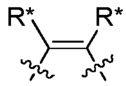, 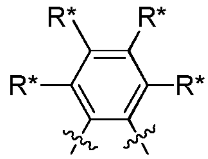

sind;

X ist bei jedem Auftreten unabhängig voneinander C; oder ist CR** oder N wenn q = 0;

Y ist C; oder ist CR**, $CR^{**}_2$, N, NR**, O oder S wenn r = 0;

K ist Y; oder ist R* wenn r = 0 und gleichzeitig s = 0;

Z ist bei jedem Auftreten unabhängig voneinander CR** oder N;

und wobei maximal 4 der Einheiten VG3, K, X, Y, Z gleichzeitig gleich N sind;

und wobei mindestens 1 der Einheiten VG3, K, X, Y, Z gleich einer von C-H verschiedenen Gruppe ist, die mindestens 1 Stickstoffatom enthält;

und wobei im Falle von r = 0 auch zwei benachbarte Gruppen Z miteinander oder eine Gruppe VG3 mit der ihr am nächsten gelegenen Gruppe Z oder X oder Y über die folgenden Einheiten verbrückt sein können:

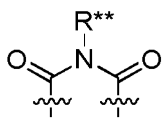, 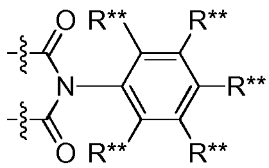;

wobei maximal drei dieser Einheiten enthalten sind;

R** ist bei jedem Auftreten unabhängig voneinander entweder ein Rest R*, oder eine chemische Bindung an einen Separator S, wobei genau ein R** eine chemische Bindung an einen Separator S ist.

R* ist wie bei Formel 1 definiert.

In einer weiteren Ausführungsform weist die Einheit AF1 eine Struktur der Unterformeln 1.1 bis 1.10 auf oder hat eine Struktur der Unterformeln 1.1 bis 1.10

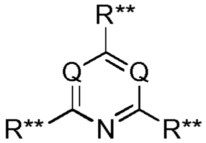

**Unterformel 1.1**

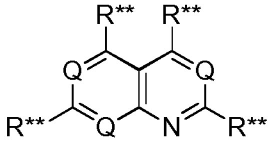

**Unterformel 1.2**

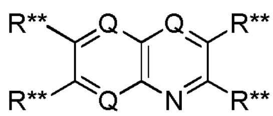

**Unterformel 1.3**

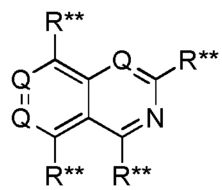

**Unterformel 1.4**

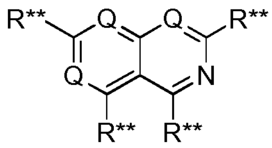

**Unterformel 1.5**

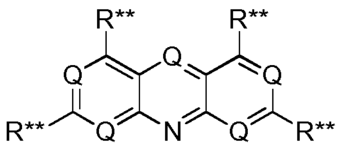

**Unterformel 1.6**

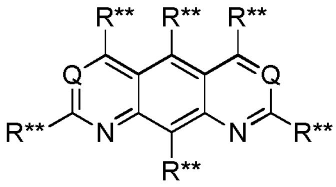

**Unterformel 1.7**

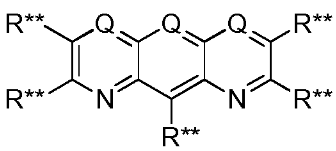

**Unterformel 1.8**

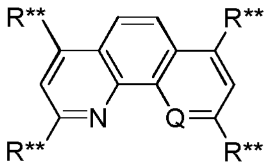

**Unterformel 1.9**

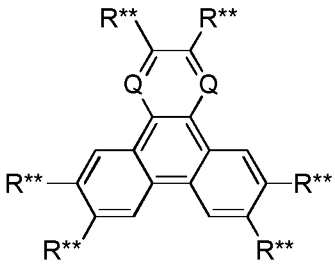

**Unterformel 1.10**

und wobei gilt:

Q ist N, CR**, wobei nicht zwei direkt benachbarte Einheiten Q gleichzeitig gleich N sind;

R** ist bei jedem Auftreten unabhängig voneinander entweder ein Rest R*, oder eine chemische Bindung an einen Separator S, wobei genau ein R** eine chemische Bindung an einen Separator S ist.

R* ist wie bei Formel 1 definiert.

In einer weiteren Ausführungsform weist die Einheit AF1 eine Struktur der Unterformeln 1.11 bis 1.13 auf oder hat eine Struktur der Unterformeln 1.11 bis 1.13

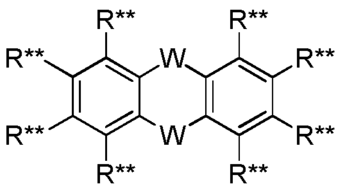

**Unterformel 1.11**

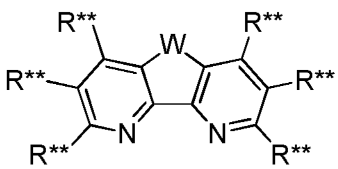

**Unterformel 1.12**

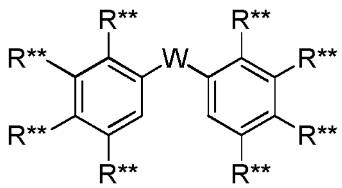

**Unterformel 1.13**

und wobei gilt:

W ist

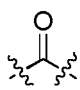 , 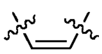 , 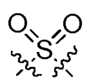 ,

oder eine Element-Element-Einfachbindung, wobei nicht zwei Einheiten W gleichzeitig eine Element-Element-Einfachbindung sind, NR**, wobei nicht zwei Einheiten W gleichzeitig gleich NR** sind;

R** ist bei jedem Auftreten unabhängig voneinander entweder ein Rest R*, oder eine chemische Bindung an einen Separator S, wobei genau ein R** eine chemische Bindung an einen Separator S ist.

R* ist wie bei Formel 1 definiert.

In einer weiteren Ausführungsform weist die Einheit AF1 eine Struktur der Unterformel 1.14 auf oder hat eine Struktur der Unterformel 1.14

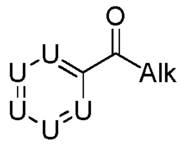

**Unterformel 1.14**

und wobei gilt:

U ist CR** oder N, wobei maximal 3 Einheiten U gleichzeitig gleich N sind und wobei keine benachbarten Einheiten U gleichzeitig gleich N sind;

Alk ist ausgewählt aus der Gruppe bestehend aus Methyl, Ethyl, Propyl *iso*-Propyl, Butyl, *tert*-Butyl, Pentyl, Hexyl, 2-Ethylhexyl, Cyclohexyl, Heptyl, Octyl, Nonyl, Decyl, Undecyl und Dodecyl;

R** ist bei jedem Auftreten unabhängig voneinander entweder ein Rest R*, oder eine chemische Bindung an einen Separator S, wobei genau ein R** eine chemische Bindung an einen Separator S ist.

R* ist wie bei Formel 1 definiert.

In einer weiteren Ausführungsform weist die Einheit AF1 eine Struktur der Unterformeln 1.15 bis 1.22 auf oder hat eine Struktur der Unterformeln 1.15 bis 1.22

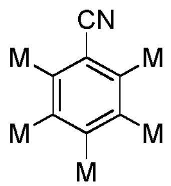

**Unterformel 1.15**

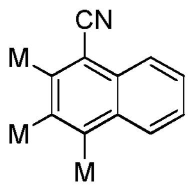

**Unterformel 1.16**

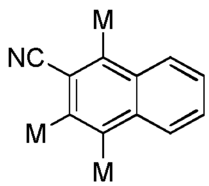

**Unterformel 1.17**

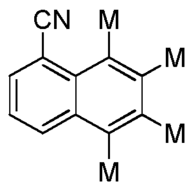

**Unterformel 1.18**

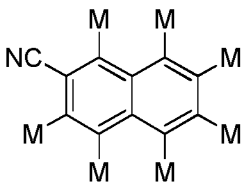

**Unterformel 1.19**

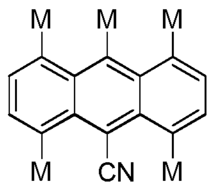

**Unterformel 1.20**

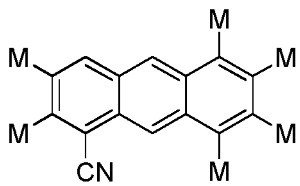

**Unterformel 1.21**

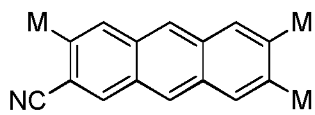

**Unterformel 1.22**

und wobei gilt:

M ist ausgewählt aus der Gruppe bestehend aus H, Deuterium, Alk, Phenyl, Pyridyl und CN, oder ist eine chemische Bindung an den Separator S, wobei genau ein M eine chemische Bindung an den Separator S ist.

wobei maximal 4 Einheiten M gleichzeitig gleich CN sind.

In einer weiteren Ausführungsform weist die Einheit AF1 eine Struktur der Unterformeln 1.23 bis 1.24 auf oder hat eine Struktur der Unterformeln 1.23 bis 1.24

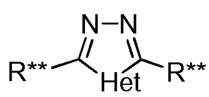

**Unterformel 1.23**

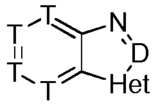

**Unterformel 1.24**

und wobei gilt: Het ist NR**, O, S oder $SO_2$;
D ist N oder CR**;
T ist N oder CR**, wobei maximal 2 Einheiten T gleich N sind; und wobei keine benachbarten Einheiten T gleichzeitig gleich N sind;
R** ist bei jedem Auftreten unabhängig voneinander entweder ein Rest R*, oder eine chemische Bindung an einen Separator S, wobei genau ein R** eine chemische Bindung an einen Separator S ist.
R* ist wie bei Formel 1 definiert.

In einer weiteren Ausführungsform weist die Einheit AF1 eine Struktur der Unterformeln 1.25 bis 1.36 auf oder hat eine Struktur der Unterformeln 1.25 bis 1.36

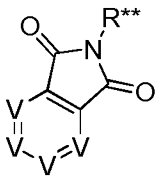

**Unterformel 1.25**

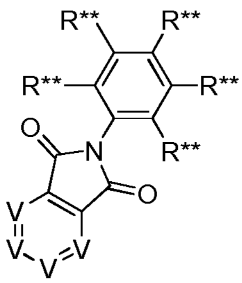

**Unterformel 1.26**

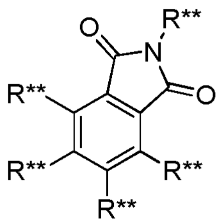

**Unterformel 1.27**

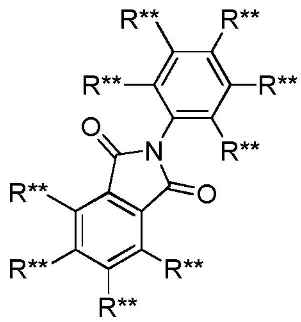

**Unterformel 1.28**

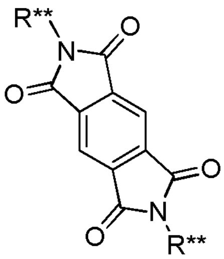

**Unterformel 1.29**

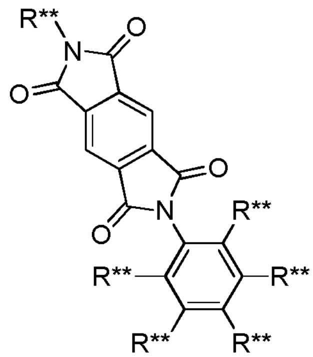

**Unterformel 1.30**

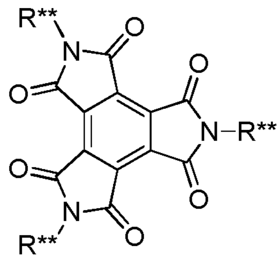

**Unterformel 1.31**

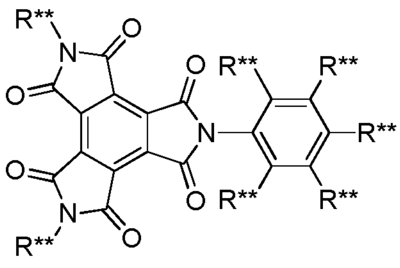

**Unterformel 1.32**

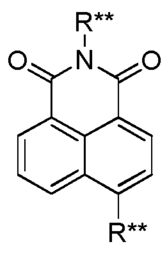

**Unterformel 1.33**

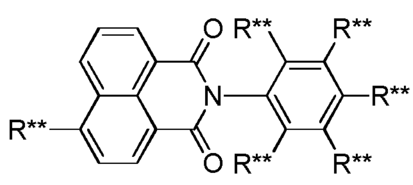

**Unterformel 1.34**

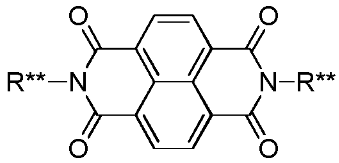 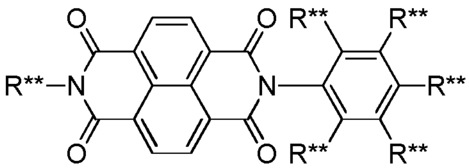

**Unterformel 1.35** **Unterformel 1.36**

und wobei gilt: V ist bei jedem Auftreten CR** oder N, wobei mindestens eine Einheit V gleich N ist; und wobei maximal zwei Einheiten V gleichzeitig gleich N sind; und wobei nicht zwei einander benachbarte Einheiten V gleichzeitig gleich N sind.

R** ist bei jedem Auftreten unabhängig voneinander entweder ein Rest R*, oder eine chemische Bindung an einen Separator S, wobei genau ein R** eine chemische Bindung an einen Separator S ist.

In einer weiteren Ausführungsform weist die Einheit AF2 eine Struktur der Formel 3 auf oder hat eine Struktur der Formel 3

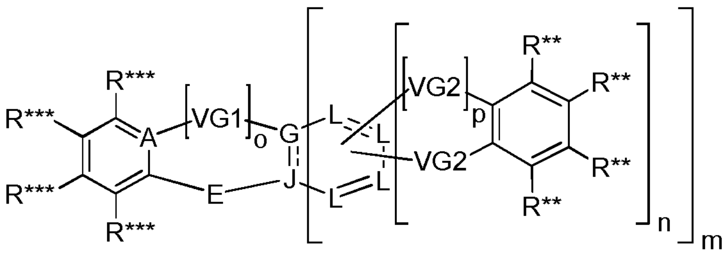

**Formel 3**

wobei gilt:

m ist 0 oder 1;

n ist 0 oder 1, wobei bei m = 0 immer auch n = 0 ist;

o ist 0 oder 1;

p ist 0 oder 1;

A ist CR*** wenn o = 0, ansonsten C;

VG1 = verbrückende Gruppe, ist ausgewählt aus der Gruppe bestehend aus

- NR**, $CR^{**}_2$, O, S und einer C-C-Einfachbindung; oder
- NR**, $CR^{**}_2$, O, S, einer C-C-Einfachbindung, BR**, AsR**, $SiR^{**}_2$, $GeR^{**}_2$,

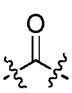, 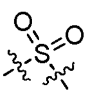, 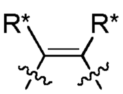, 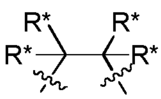, 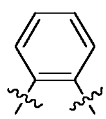, 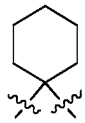, 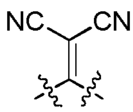, 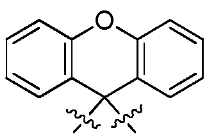,

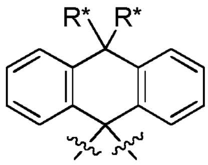, 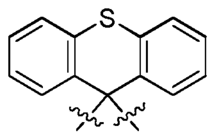, und 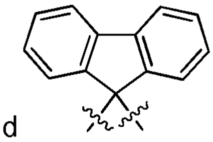,

wenn m = 1 und gleichzeitig n = 0;

VG2 = verbrückende Gruppe ist bei jedem Auftreten unabhängig voneinander ausgewählt aus der Gruppe bestehend aus $CR^{**}_2$, NR**, O, S und einer C-C-Einfachbindung, wobei nicht zwei Einheiten VG2 gleichzeitig gleich einer C-C-Einfachbindung sind;

E ist NR** oder

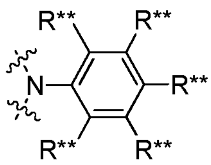;

G ist C wenn o = 1 und gleichzeitig m = 1;G ist CR** wenn o = 0 und gleichzeitig m = 1; G ist CR** oder $CR^{**}_2$, wenn o = 1 und gleichzeitig m = 0; G ist R* wenn o = 0 und gleichzeitig m = 0; G ist CR**, $CR^{**}_2$, N oder NR* wenn m = 0 und gleichzeitig VG1 eine C-C-Einfachbindung ist;

J ist C wenn m = 1; J ist CR**, $CR^{**}_2$oder NR** wenn m = 0;

L ist CR*** wenn n = 0; L ist CR**, C (bei kovalenter Bindung zu VG2) wenn n = 1;

R*** ist R** oder ist ausgewählt aus den folgenden Einheiten, wobei maximal zwei der Reste

R*** gleichzeitig gleich einer der folgenden Einheiten sind:

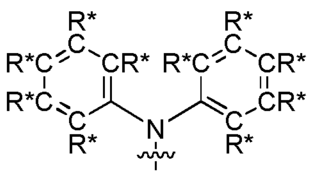, 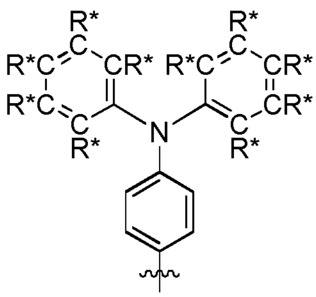, 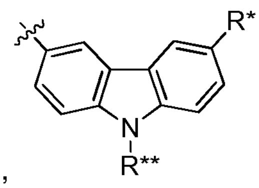, 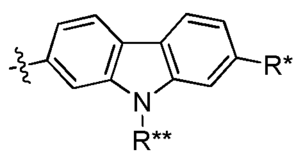

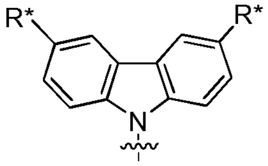, 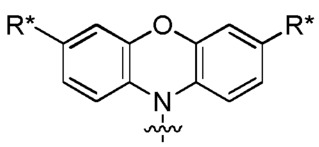, 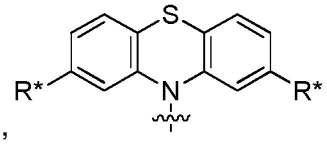,

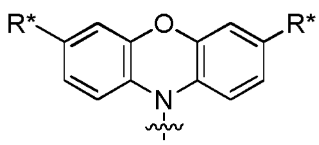, 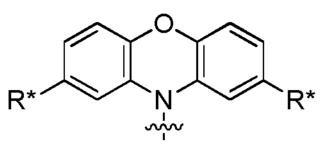;

R** ist bei jedem Auftreten unabhängig voneinander ein Rest R* oder markiert eine Anknüpfungsstelle an einen Separator S, wobei genau ein R** eine Anknüpfungsstelle an einen Separator S ist.

R* ist wie bei Formel 1 definiert.

In einer weiteren Ausführungsform weist die Einheit AF2 eine Struktur der Formel 4 auf oder hat eine Struktur der Formel 4

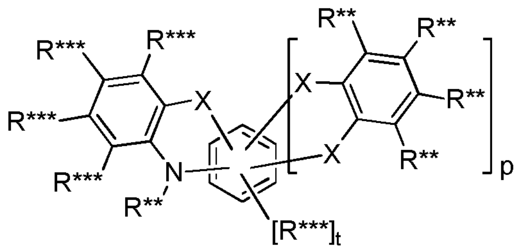

**Formel 4**

wobei in Formel 4 bedeutet:

p ist 0 oder 1;

t = 4 - 2p;

X ist $CR^{**}_2$, NR**, Sauerstoff, Schwefel oder eine direkte Bindung, wobei maximal zwei Platzhalter X gleichzeitig eine direkte Bindung sind, wobei diese nicht Bestandteil desselben Rings sind;

und im Übrigen die für Formel 3 gegebenen Definitionen gelten.

In einer weiteren Ausführungsform weist die Einheit AF2 des organischen Moleküls eine Struktur der Formel 4A1-4A7 auf oder hat eine Struktur der Formel 4A1-4A7;

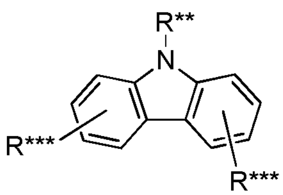

**Formel 4A1**

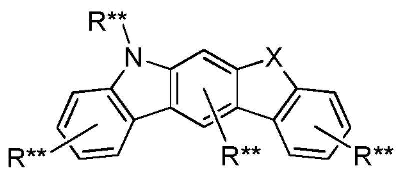

**Formel 4A2**

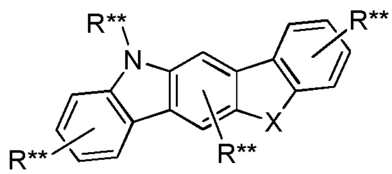

**Formel 4A3**

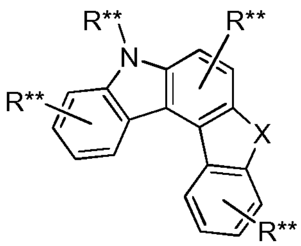

**Formel 4A4**

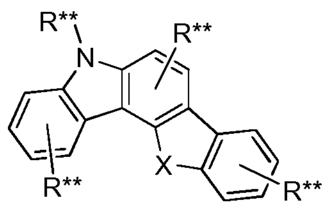

**Formel 4A5**

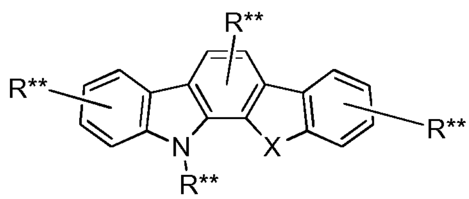

**Formel 4A6**

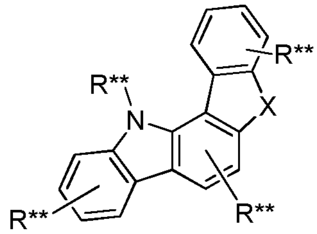

**Formel 4A7**

wobei in Formel 4A1-4A7 gilt:

X ist $C(R^{**})_2$, NR**, Sauerstoff, Schwefel;
und im Übrigen die für Formel 3 gegebenen Definitionen gelten.

In einer Ausführungsform erfolgt die Anbindung von AF1 und AF2 an den Separator nicht über an N-Heterozyklen oder N-Heteroaromaten angebundene Phenyleinheiten von AF1 und AF2.

In einer weiteren Ausführungsform weist das organische Molekül eine Struktur der Formel 5 auf oder hat eine Struktur der Formel 5;

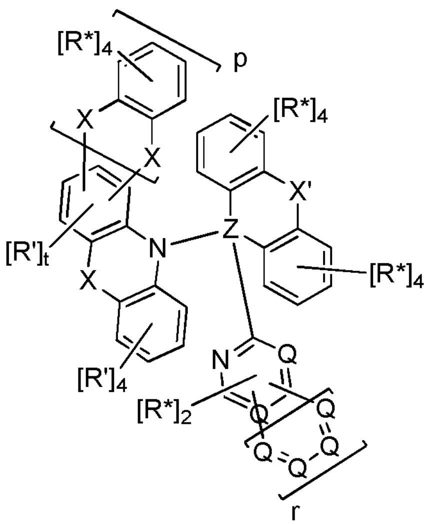

**Formel 5**

wobei in Formel 5 bedeutet:

p ist 0 oder 1;

t = 4 - 2p;

X ist $CR^*_2$, NR*, Sauerstoff, Schwefel oder eine direkte Bindung, wobei maximal zwei Platzhalter X gleichzeitig eine direkte Bindung sind, wobei diese nicht Bestandteil desselben Rings sind;

X' ist $CR^*_2$, NR*, Sauerstoff, Schwefel, keine Bindung, oder eine direkte Bindung;

Q ist N, CR*, wobei mindestens ein Q gleich N ist, und wobei nicht zwei direkt benachbarte Einheiten Q gleichzeitig gleich N sind,

Z = sp3-Kohlenstoff oder sp3-Silicium;

r = 0 oder 1,

R’ ist R* oder ist ausgewählt aus den folgenden Einheiten, wobei maximal zwei der Reste R’ gleichzeitig gleich einer der folgenden Einheiten sind:

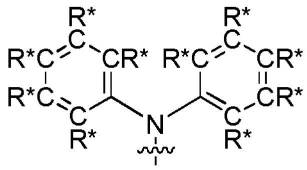
,
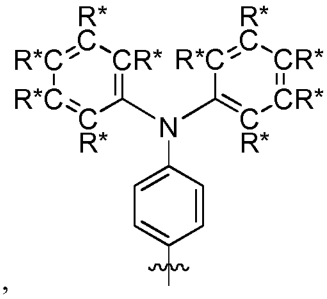
,
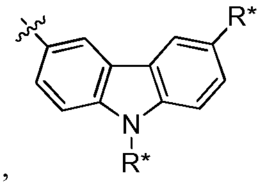
,
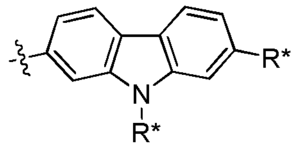
,
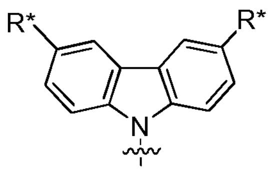
,
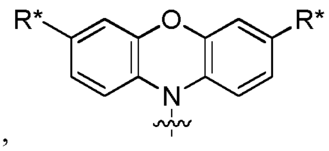
,
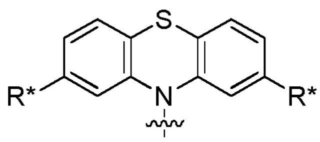
,
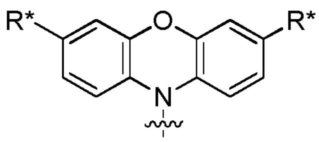
,
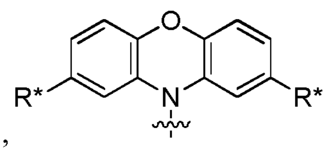
;

und im Übrigen die für Formel 3 gegebenen Definitionen gelten.

In einer weiteren Ausführungsform weist das organische Molekül eine Struktur der Formel 6 auf oder hat eine Struktur der Formel 6;

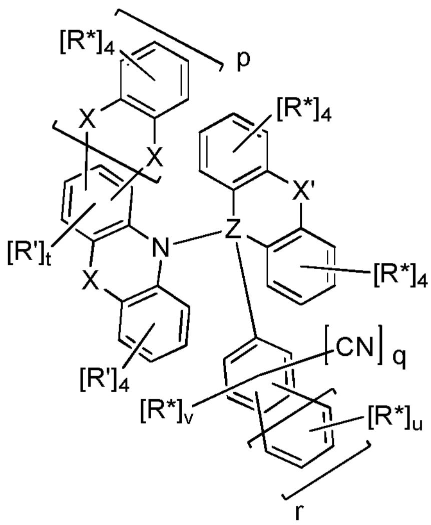

**Formel 6**

wobei in Formel 6 bedeutet:

p ist 0 oder 1;

t = 4 - 2p;

X ist $CR^*_2$, NR*, Sauerstoff, Schwefel, eine direkte Bindung, wobei maximal zwei Platzhalter X gleichzeitig eine direkte Bindung sind, wobei diese nicht Bestandteil desselben Rings sind;

X' ist $CR^*_2$, NR*, Sauerstoff, Schwefel, keine Bindung, oder eine direkte Bindung;

r = 0 oder 1,

q = 1 bis 5, für r = 1 ist q = 1 bis 3,

u ist 1, 2, 3 oder 4

v ist 1, 2 oder 3; wobei gilt: u + v = 3 + 4r-q

Z = sp3-Kohlenstoff oder sp3-Silicium;

R' ist R* oder ist ausgewählt aus den folgenden Einheiten, wobei maximal zwei der Reste R' gleichzeitig gleich einer der folgenden Einheiten sind:

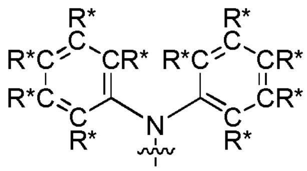 , 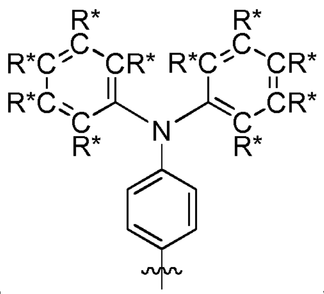 , 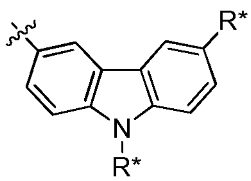 , 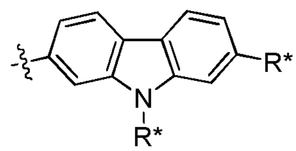 ,

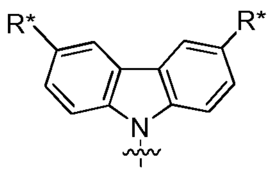 , 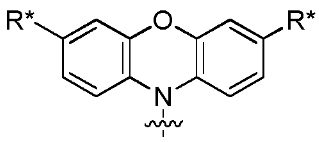 , 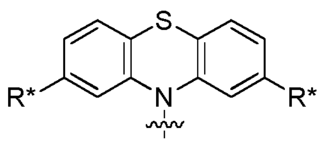 ,

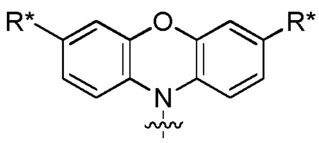 , 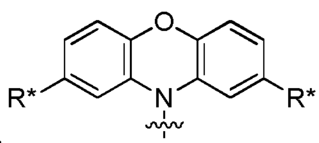 ;

und im Übrigen die für Formel 3 gegebenen Definitionen gelten.

In einer weiteren Ausführungsform weist das organische Molekül eine Struktur der Formel 7 auf oder hat eine Struktur der Formel 7:

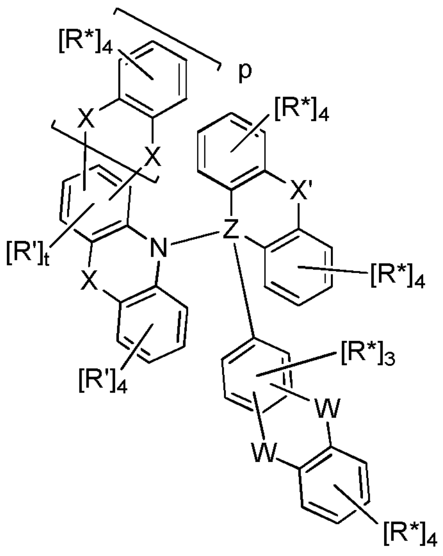

**Formel 7**

wobei in Formel 7 bedeutet:

W ist

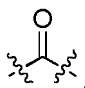, 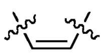, 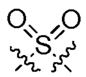,

eine Element-Element-Einfachbindung, wobei nicht zwei Einheiten W gleichzeitig eine Element-Element-Einfachbindung sind, NR*, wobei nicht zwei Einheiten W gleichzeitig gleich NR* sind;

p ist 0 oder 1;

t = 4 - 2p;

X ist $CR^*_2$, NR*, Sauerstoff, Schwefel, eine direkte Bindung, wobei maximal zwei Platzhalter X gleichzeitig eine direkte Bindung sind, wobei diese nicht Bestandteil desselben Rings sind;

X’ ist $CR^*_2$, NR*, Sauerstoff, Schwefel, keine Bindung, oder eine direkte Bindung;

Z = sp3-Kohlenstoff oder sp3-Silicium;

R’ ist R* oder ist ausgewählt aus den folgenden Einheiten, wobei maximal zwei der Reste R’ gleichzeitig gleich einer der folgenden Einheiten sind:

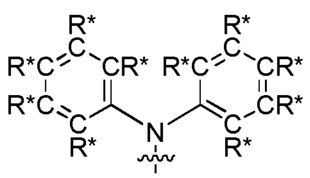, 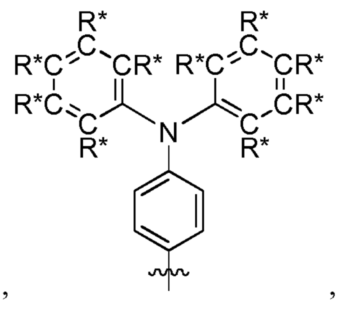, 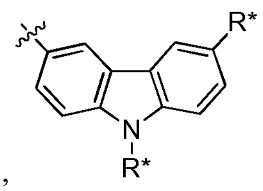, 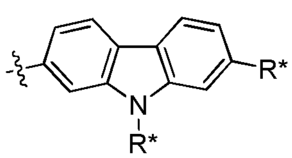,

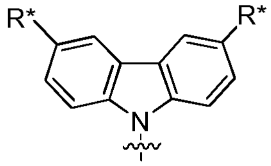 , 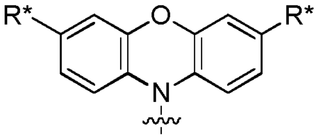 , 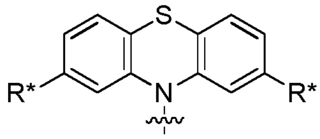 ,

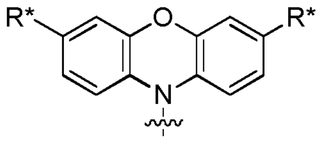 , 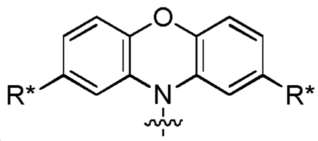 ;

und im Übrigen die für Formel 3 gegebenen Definitionen gelten.

In einer weiteren Ausführungsform weist das organische Molekül eine Struktur der Formel 8 auf oder hat eine Struktur der Formel 8;

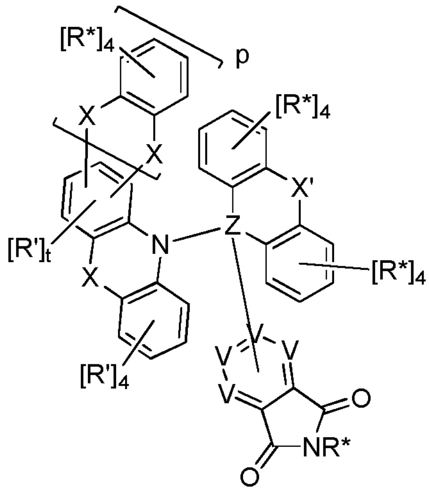

**Formel 8**

wobei in Formel 8 bedeutet:

V ist bei jedem Auftreten CR*, N, wobei maximal zwei Einheiten V gleichzeitig gleich N sind; und wobei nicht zwei einander benachbarte Einheiten V gleichzeitig gleich N sind, und wobei ein V gleich C ist, worüber die Anbindung an den Separator S erfolgt;

p ist 0 oder 1;

t = 4 - 2p;

X ist $CR^*_2$, NR*, Sauerstoff, Schwefel oder eine direkte Bindung, wobei maximal zwei Platzhalter X gleichzeitig eine direkte Bindung sind, wobei diese nicht Bestandteil desselben Rings sind;

X' ist $CR^*_2$, NR*, Sauerstoff, Schwefel, keine Bindung, oder eine direkte Bindung;

Z = sp3-Kohlenstoff oder sp3-Silicium;

R' ist R* oder ist ausgewählt aus den folgenden Einheiten, wobei maximal zwei der Reste R' gleichzeitig gleich einer der folgenden Einheiten sind:

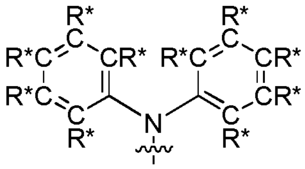 , 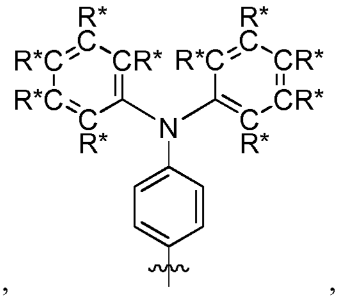 , 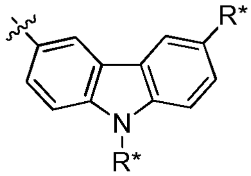 , 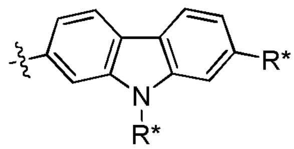 ,

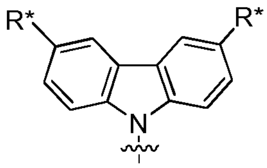 , 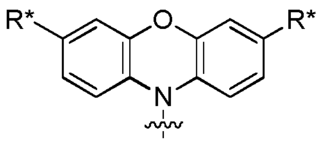 , 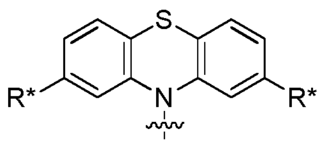 ,

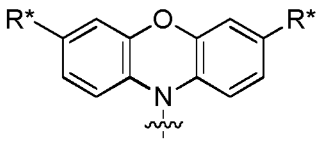 , 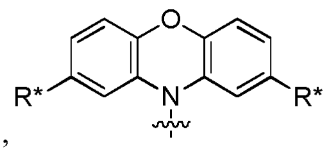 ;

und im Übrigen die für Formel 3 gegebenen Definitionen gelten.

Organische Moleküle sind in Tabelle 3 dargestellt, die sich durch Kombination der oben definierten Paare aus chemischen Einheiten AF1 und AF2, dem Separator S und der Festlegung der Verknüpfung ergeben. Weitere organische Moleküle können durch Kombination der genannten Moleküleinheiten erhalten werden. Die Benennung der Moleküle erfolgt nach dem Schema AF-S-AF, wobei hinsichtlich der Benennung der chemischen Einheit AF auf Tabelle 1 verweisen wird, da die in der Tabelle 1 verwendeten Nummern auch in Tabelle 3 verwendet werden.

**Tabelle 3:** Organische Moleküle nach dem Schema AF–S–AF. In einem Molekül sind zwei verschiedene AFs enthalten. S steht jeweils für einen Spacer S, ausgewählt aus den Formeln 3-44 bis 3-63. In Klammern sind die Werte für ΔHOMO, ΔLUMO und Gap angegeben.

| | | | |
|---|---|---|---|
| 1 — S — 20 (0.97 0.97 2.02) | 1 — S — 27 (0.89 1.14 1.85) | 1 — S — 28 (0.95 1.40 1.59) | 1 — S — 36 (1.11 1.92 1.07) |
| 1 — S — 43 (1.53 1.77 1.22) | 1 — S — 46 (2.12 1.29 1.70) | 1 — S — 61 (0.86 1.11 1.88) | 1 — S — 65 (0.87 0.91 2.08) |
| 1 — S — 70 (1.59 1.98 1.01) | 1 — S — 79 (0.86 1.28 1.71) | 1 — S — 80 (0.81 1.24 1.75) | 1 — S — 81 (0.89 1.36 1.63) |
| 1 — S — 85 (1.37 1.09 1.90) | 1 — S — 89 (1.34 1.72 1.27) | 1 — S — 90 (1.25 1.57 1.42) | 1 — S — 101 (1.01 1.42 1.57) |
| 1 — S — 107 (1.63 1.26 1.74) | 1 — S — 108 (1.19 1.65 1.34) | 1 — S — 109 (1.43 1.78 1.21) | 1 — S — 110 (0.92 1.42 1.57) |
| 1 — S — 112 (0.82 0.92 2.07) | 1 — S — 113 (1.03 1.84 1.15) | 1 — S — 115 (1.30 1.39 1.60) | 1 — S — 118 (0.91 0.82 2.17) |
| 1 — S — 119 (0.88 1.03 1.96) | 1 — S — 133 (1.63 1.55 1.44) | 1 — S — 144 (0.97 1.46 1.53) | 1 — S — 150 (2.45 1.42 1.57) |
| 1 — S — 151 (2.36 1.68 1.31) | 1 — S — 152 (3.01 1.98 1.01) | 1 — S — 153 (2.39 1.52 1.47) | 1 — S — 177 (1.47 1.20 1.79) |
| 1 — S — 183 (1.11 1.54 1.45) | 1 — S — 184 (2.20 1.01 1.98) | 1 — S — 192 (1.81 1.53 1.46) | 1 — S — 195 (1.63 0.86 2.13) |
| 1 — S — 198 (1.34 0.92 2.07) | 1 — S — 205 (0.86 0.98 2.01) | 1 — S — 206 (0.86 1.89 1.10) | 1 — S — 207 (1.38 1.84 1.15) |
| 1 — S — 213 (1.31 0.87 2.12) | 1 — S — 231 (1.85 1.64 1.35) | 1 — S — 233 (1.24 1.07 1.92) | 1 — S — 234 (1.06 1.15 1.84) |
| 1 — S — 237 (1.07 1.45 1.54) | 1 — S — 244 (1.12 1.06 1.93) | 1 — S — 245 (1.04 0.84 2.16) | 1 — S — 246 (1.38 1.40 1.59) |
| 1 — S — 248 (1.44 1.95 1.04) | 1 — S — 249 (0.92 1.79 1.20) | 1 — S — 251 (0.88 1.65 1.34) | 1 — S — 255 (1.77 1.62 1.37) |
| 1 — S — 258 (0.83 2.06 0.93) | 1 — S — 260 (0.89 2.07 0.92) | 1 — S — 265 (1.34 1.54 1.45) | 1 — S — 266 (0.98 1.12 1.87) |
| 1 — S — 268 (1.32 1.69 1.30) | 1 — S — 269 (1.28 1.62 1.37) | 1 — S — 271 (2.03 1.71 1.28) | 1 — S — 277 (0.86 0.89 2.10) |
| 1 — S — 279 (0.92 0.95 2.04) | 1 — S — 290 (0.98 1.15 1.84) | 1 — S — 291 (2.11 1.56 1.43) | 1 — S — 292 (1.45 1.22 1.77) |
| 1 — S — 293 (0.95 1.03 1.96) | 1 — S — 294 (1.41 1.06 1.93) | 1 — S — 295 (1.16 1.30 1.69) | 1 — S — 296 (1.44 1.30 1.69) |
| 1 — S — 298 (1.01 0.90 2.09) | 1 — S — 305 (1.33 0.96 2.03) | 1 — S — 306 (1.49 1.62 1.37) | 1 — S — 307 (1.22 1.75 1.24) |
| 1 — S — 316 (0.81 0.96 2.03) | 1 — S — 320 (1.71 2.04 0.95) | 1 — S — 327 (1.10 1.37 1.62) | 1 — S — 329 (1.43 1.83 1.16) |
| 1 — S — 342 (2.86 1.58 1.41) | 1 — S — 343 (3.39 2.07 0.92) | 1 — S — 367 (1.38 1.52 1.47) | 1 — S — 368 (1.49 2.06 0.93) |
| 1 — S — 371 (2.54 1.67 1.33) | 1 — S — 395 (1.57 1.37 1.62) | 1 — S — 396 (1.00 0.80 2.19) | 1 — S — 440 (1.26 1.27 1.72) |
| 1 — S — 441 (1.19 1.20 1.79) | 1 — S — 447 (1.20 1.39 1.60) | 1 — S — 449 (0.94 1.36 1.63) | 1 — S — 451 (1.28 1.97 1.02) |
| 1 — S — 452 (1.34 1.62 1.37) | 1 — S — 460 (1.07 1.70 1.29) | 1 — S — 463 (1.22 2.07 0.92) | 1 — S — 471 (1.37 0.93 2.06) |
| 1 — S — 473 (1.41 1.55 1.44) | 1 — S — 474 (1.27 1.44 1.55) | 2 — S — 20 (0.97 0.89 2.03) | 2 — S — 27 (0.88 1.06 1.86) |
| 2 — S — 28 (0.94 1.32 1.59) | 2 — S — 36 (1.10 1.84 1.08) | 2 — S — 43 (1.52 1.69 1.23) | 2 — S — 46 (2.11 1.21 1.71) |
| 2 — S — 61 (0.85 1.03 1.89) | 2 — S — 65 (0.86 0.83 2.09) | 2 — S — 70 (1.58 1.90 1.02) | 2 — S — 79 (0.85 1.20 1.72) |
| 2 — S — 80 (0.80 1.16 1.76) | 2 — S — 81 (0.88 1.28 1.64) | 2 — S — 85 (1.36 1.01 1.91) | 2 — S — 89 (1.34 1.64 1.28) |
| 2 — S — 90 (1.25 1.49 1.43) | 2 — S — 101 (1.00 1.34 1.58) | 2 — S — 107 (1.62 1.17 1.74) | 2 — S — 108 (1.18 1.57 1.35) |
| 2 — S — 109 (1.42 1.70 1.22) | 2 — S — 110 (0.91 1.34 1.58) | 2 — S — 112 (0.81 0.84 2.08) | 2 — S — 113 (1.02 1.76 1.16) |
| 2 — S — 115 (1.29 1.31 1.60) | 2 — S — 119 (0.87 0.95 1.97) | 2 — S — 133 (1.62 1.47 1.45) | 2 — S — 144 (0.96 1.38 1.54) |
| 2 — S — 150 (2.44 1.34 1.58) | 2 — S — 151 (2.35 1.60 1.32) | 2 — S — 152 (3.00 1.90 1.02) | 2 — S — 153 (2.38 1.44 1.48) |
| 2 — S — 177 (1.46 1.12 1.80) | 2 — S — 183 (1.11 1.46 1.46) | 2 — S — 184 (2.19 0.93 1.99) | 2 — S — 192 (1.80 1.45 1.47) |
| 2 — S — 198 (1.34 0.84 2.08) | 2 — S — 205 (0.86 0.90 2.02) | 2 — S — 206 (0.85 1.81 1.11) | 2 — S — 207 (1.37 1.76 1.16) |
| 2 — S — 231 (1.84 1.56 1.35) | 2 — S — 233 (1.23 0.99 1.93) | 2 — S — 234 (1.05 1.07 1.85) | 2 — S — 237 (1.06 1.37 1.55) |
| 2 — S — 244 (1.11 0.98 1.94) | 2 — S — 246 (1.37 1.32 1.60) | 2 — S — 248 (1.43 1.87 1.05) | 2 — S — 249 (0.91 1.71 1.21) |
| 2 — S — 251 (0.88 1.57 1.35) | 2 — S — 255 (1.76 1.54 1.38) | 2 — S — 258 (0.83 1.98 0.93) | 2 — S — 260 (0.89 1.99 0.93) |
| 2 — S — 265 (1.33 1.46 1.46) | 2 — S — 266 (0.97 1.04 1.88) | 2 — S — 268 (1.31 1.61 1.31) | 2 — S — 269 (1.27 1.54 1.38) |
| 2 — S — 271 (2.02 1.63 1.29) | 2 — S — 277 (0.85 0.81 2.11) | 2 — S — 279 (0.91 0.87 2.05) | 2 — S — 290 (0.97 1.07 1.85) |
| 2 — S — 291 (2.11 1.48 1.44) | 2 — S — 292 (1.44 1.14 1.78) | 2 — S — 293 (0.94 0.95 1.97) | 2 — S — 294 (1.40 0.98 1.94) |
| 2 — S — 295 (1.15 1.22 1.70) | 2 — S — 296 (1.43 1.22 1.70) | 2 — S — 298 (1.00 0.82 2.10) | 2 — S — 305 (1.32 0.88 2.03) |
| 2 — S — 306 (1.48 1.54 1.38) | 2 — S — 307 (1.21 1.67 1.25) | 2 — S — 316 (0.80 0.88 2.04) | 2 — S — 320 (1.70 1.96 0.96) |
| 2 — S — 327 (1.09 1.29 1.63) | 2 — S — 329 (1.42 1.75 1.17) | 2 — S — 342 (2.85 1.50 1.42) | 2 — S — 343 (3.38 1.99 0.93) |
| 2 — S — 367 (1.37 1.44 1.48) | 2 — S — 368 (1.49 1.98 0.94) | 2 — S — 371 (2.54 1.59 1.33) | 2 — S — 395 (1.57 1.29 1.63) |
| 2 — S — 440 (1.25 1.19 1.72) | 2 — S — 441 (1.18 1.12 1.80) | 2 — S — 447 (1.19 1.31 1.61) | 2 — S — 449 (0.93 1.28 1.64) |
| 2 — S — 451 (1.28 1.89 1.03) | 2 — S — 452 (1.33 1.54 1.38) | 2 — S — 460 (1.06 1.62 1.30) | 2 — S — 463 (1.21 1.99 0.93) |
| 2 — S — 471 (1.36 0.85 2.07) | 2 — S — 473 (1.40 1.47 1.45) | 2 — S — 474 (1.26 1.36 1.56) | 3 — S — 20 (1.22 1.34 1.77) |
| 3 — S — 27 (1.14 1.51 1.61) | 3 — S — 28 (1.20 1.78 1.34) | 3 — S — 29 (0.96 1.50 1.61) | 3 — S — 43 (1.77 2.15 0.97) |
| 3 — S — 46 (2.37 1.67 1.45) | 3 — S — 56 (1.13 0.97 2.14) | 3 — S — 61 (1.11 1.49 1.63) | 3 — S — 62 (0.99 1.68 1.43) |
| 3 — S — 65 (1.12 1.28 1.83) | 3 — S — 68 (0.83 1.24 1.87) | 3 — S — 79 (1.11 1.66 1.46) | 3 — S — 80 (1.06 1.61 1.50) |
| 3 — S — 81 (1.13 1.74 1.38) | 3 — S — 82 (0.87 1.92 1.19) | 3 — S — 83 (1.17 0.91 2.20) | 3 — S — 85 (1.62 1.47 1.65) |
| 3 — S — 86 (0.84 1.84 1.28) | 3 — S — 89 (1.59 2.09 1.02) | 3 — S — 90 (1.50 1.94 1.17) | 3 — S — 101 (1.26 1.80 1.32) |
| 3 — S — 102 (0.88 0.80 2.31) | 3 — S — 105 (1.42 0.89 2.22) | 3 — S — 107 (1.88 1.63 1.49) | 3 — S — 108 (1.44 2.02 1.09) |

| | | | |
|---|---|---|---|
| 3 — S — 109 (1.68 2.16 0.96) | 3 — S — 110 (1.17 1.80 1.32) | 3 — S — 111 (1.87 0.92 2.20) | 3 — S — 112 (1.07 1.29 1.82) |
| 3 — S — 113 (1.28 2.21 0.91) | 3 — S — 115 (1.55 1.77 1.35) | 3 — S — 118 (1.16 1.19 1.92) | 3 — S — 119 (1.13 1.41 1.71) |
| 3 — S — 131 (1.18 0.87 2.25) | 3 — S — 132 (1.09 1.11 2.00) | 3 — S — 133 (1.88 1.92 1.19) | 3 — S — 144 (1.22 1.83 1.28) |
| 3 — S — 150 (2.70 1.79 1.32) | 3 — S — 151 (2.61 2.05 1.06) | 3 — S — 153 (2.64 1.89 1.22) | 3 — S — 154 (2.17 1.02 2.09) |
| 3 — S — 166 (1.89 0.85 2.27) | 3 — S — 171 (1.66 0.85 2.27) | 3 — S — 177 (1.72 1.57 1.54) | 3 — S — 183 (1.36 1.91 1.21) |
| 3 — S — 184 (2.45 1.39 1.73) | 3 — S — 192 (2.06 1.91 1.21) | 3 — S — 193 (0.98 1.07 2.05) | 3 — S — 195 (1.88 1.23 1.88) |
| 3 — S — 198 (1.59 1.29 1.82) | 3 — S — 205 (1.11 1.35 1.76) | 3 — S — 207 (1.63 2.21 0.90) | 3 — S — 208 (1.08 0.82 2.29) |
| 3 — S — 209 (0.82 0.90 2.21) | 3 — S — 213 (1.56 1.25 1.87) | 3 — S — 217 (0.98 1.28 1.84) | 3 — S — 218 (0.95 1.46 1.66) |
| 3 — S — 222 (0.87 0.86 2.25) | 3 — S — 231 (2.10 2.02 1.10) | 3 — S — 233 (1.49 1.44 1.67) | 3 — S — 234 (1.31 1.53 1.59) |
| 3 — S — 237 (1.32 1.82 1.29) | 3 — S — 244 (1.37 1.44 1.68) | 3 — S — 245 (1.29 1.21 1.91) | 3 — S — 246 (1.63 1.78 1.34) |
| 3 — S — 249 (1.17 2.17 0.95) | 3 — S — 251 (1.13 2.02 1.09) | 3 — S — 254 (1.13 1.13 1.98) | 3 — S — 255 (2.02 1.99 1.12) |
| 3 — S — 265 (1.59 1.92 1.20) | 3 — S — 266 (1.23 1.49 1.62) | 3 — S — 267 (1.03 1.19 1.92) | 3 — S — 268 (1.57 2.07 1.05) |
| 3 — S — 269 (1.53 1.99 1.12) | 3 — S — 271 (2.28 2.09 1.03) | 3 — S — 274 (0.89 1.00 2.12) | 3 — S — 277 (1.11 1.26 1.85) |
| 3 — S — 279 (1.17 1.33 1.79) | 3 — S — 280 (0.85 1.00 2.11) | 3 — S — 282 (0.96 0.83 2.28) | 3 — S — 285 (0.89 1.21 1.91) |
| 3 — S — 286 (1.14 1.11 2.00) | 3 — S — 287 (0.95 1.12 1.99) | 3 — S — 288 (0.94 1.06 2.05) | 3 — S — 289 (1.20 0.90 2.22) |
| 3 — S — 290 (1.23 1.53 1.59) | 3 — S — 291 (2.36 1.93 1.18) | 3 — S — 292 (1.70 1.59 1.52) | 3 — S — 293 (1.20 1.40 1.71) |
| 3 — S — 294 (1.65 1.43 1.68) | 3 — S — 295 (1.41 1.68 1.44) | 3 — S — 296 (1.69 1.67 1.44) | 3 — S — 297 (1.00 0.80 2.31) |
| 3 — S — 298 (1.26 1.28 1.84) | 3 — S — 304 (1.06 1.12 1.99) | 3 — S — 305 (1.58 1.34 1.78) | 3 — S — 306 (1.74 1.99 1.12) |
| 3 — S — 307 (1.47 2.12 0.99) | 3 — S — 311 (0.90 1.01 2.10) | 3 — S — 312 (1.00 0.88 2.23) | 3 — S — 316 (1.06 1.34 1.78) |
| 3 — S — 327 (1.35 1.74 1.37) | 3 — S — 329 (1.68 2.20 0.92) | 3 — S — 331 (1.21 0.92 2.20) | 3 — S — 332 (1.06 1.09 2.02) |
| 3 — S — 336 (1.16 0.98 2.13) | 3 — S — 342 (3.11 1.95 1.16) | 3 — S — 358 (1.01 1.26 1.86) | 3 — S — 367 (1.63 1.89 1.22) |
| 3 — S — 370 (0.98 1.32 1.79) | 3 — S — 371 (2.79 2.04 1.08) | 3 — S — 372 (1.20 1.03 2.09) | 3 — S — 374 (0.81 1.52 1.60) |
| 3 — S — 379 (0.89 1.02 2.09) | 3 — S — 382 (0.96 1.20 1.91) | 3 — S — 391 (0.90 1.01 2.11) | 3 — S — 395 (1.82 1.74 1.38) |
| 3 — S — 396 (1.25 1.18 1.94) | 3 — S — 397 (1.05 1.02 2.09) | 3 — S — 415 (0.94 0.90 2.21) | 3 — S — 430 (0.84 1.84 1.28) |
| 3 — S — 434 (0.90 1.31 1.80) | 3 — S — 435 (0.99 1.48 1.63) | 3 — S — 437 (1.17 0.86 2.26) | 3 — S — 440 (1.51 1.65 1.47) |
| 3 — S — 441 (1.44 1.58 1.54) | 3 — S — 443 (0.91 2.19 0.92) | 3 — S — 447 (1.45 1.76 1.35) | 3 — S — 449 (1.19 1.73 1.38) |
| 3 — S — 450 (0.81 1.40 1.72) | 3 — S — 452 (1.59 2.00 1.12) | 3 — S — 454 (0.91 0.87 2.25) | 3 — S — 455 (0.89 1.14 1.98) |
| 3 — S — 457 (1.04 1.64 1.47) | 3 — S — 459 (0.82 1.88 1.24) | 3 — S — 460 (1.32 2.07 1.04) | 3 — S — 461 (1.03 1.83 1.28) |
| 3 — S — 468 (0.92 1.55 1.57) | 3 — S — 469 (1.01 1.98 1.14) | 3 — S — 471 (1.62 1.31 1.81) | 3 — S — 473 (1.66 1.92 1.19) |
| 3 — S — 474 (1.52 1.81 1.31) | 4 — S — 20 (0.85 0.81 2.15) | 4 — S — 28 (0.82 1.24 1.71) | 4 — S — 36 (0.98 1.76 1.20) |
| 4 — S — 37 (0.98 2.06 0.90) | 4 — S — 43 (1.40 1.61 1.35) | 4 — S — 46 (1.99 1.13 1.83) | 4 — S — 70 (1.46 1.82 1.14) |
| 4 — S — 85 (1.24 0.93 2.02) | 4 — S — 89 (1.22 1.56 1.40) | 4 — S — 90 (1.13 1.41 1.55) | 4 — S — 101 (0.88 1.26 1.70) |
| 4 — S — 107 (1.50 1.09 1.86) | 4 — S — 108 (1.06 1.49 1.47) | 4 — S — 109 (1.30 1.62 1.34) | 4 — S — 113 (0.90 1.68 1.28) |
| 4 — S — 115 (1.17 1.23 1.72) | 4 — S — 133 (1.51 1.39 1.57) | 4 — S — 144 (0.84 1.30 1.66) | 4 — S — 145 (0.82 1.95 1.01) |
| 4 — S — 150 (2.33 1.26 1.70) | 4 — S — 151 (2.23 1.52 1.44) | 4 — S — 152 (2.88 1.82 1.14) | 4 — S — 153 (2.26 1.36 1.60) |
| 4 — S — 177 (1.34 1.04 1.92) | 4 — S — 183 (0.99 1.37 1.58) | 4 — S — 184 (2.08 0.85 2.11) | 4 — S — 192 (1.68 1.37 1.59) |
| 4 — S — 207 (1.25 1.68 1.28) | 4 — S — 215 (1.48 1.94 1.02) | 4 — S — 231 (1.73 1.48 1.47) | 4 — S — 233 (1.11 0.91 2.05) |
| 4 — S — 234 (0.93 0.99 1.97) | 4 — S — 237 (0.94 1.29 1.67) | 4 — S — 244 (1.00 0.90 2.06) | 4 — S — 246 (1.25 1.24 1.72) |
| 4 — S — 248 (1.32 1.79 1.17) | 4 — S — 255 (1.64 1.46 1.50) | 4 — S — 265 (1.21 1.38 1.58) | 4 — S — 266 (0.85 0.96 2.00) |
| 4 — S — 268 (1.19 1.53 1.43) | 4 — S — 269 (1.16 1.46 1.50) | 4 — S — 271 (1.90 1.55 1.41) | 4 — S — 290 (0.85 0.99 1.97) |
| 4 — S — 291 (1.99 1.40 1.56) | 4 — S — 292 (1.32 1.06 1.90) | 4 — S — 293 (0.82 0.87 2.09) | 4 — S — 294 (1.28 0.90 2.06) |
| 4 — S — 295 (1.03 1.14 1.82) | 4 — S — 296 (1.31 1.14 1.82) | 4 — S — 305 (1.20 0.80 2.15) | 4 — S — 306 (1.36 1.46 1.50) |
| 4 — S — 307 (1.09 1.59 1.37) | 4 — S — 320 (1.58 1.88 1.08) | 4 — S — 327 (0.97 1.21 1.75) | 4 — S — 329 (1.30 1.67 1.29) |
| 4 — S — 342 (2.73 1.42 1.54) | 4 — S — 343 (3.26 1.91 1.05) | 4 — S — 364 (1.44 2.04 0.92) | 4 — S — 367 (1.26 1.36 1.60) |
| 4 — S — 368 (1.37 1.90 1.06) | 4 — S — 371 (2.42 1.50 1.45) | 4 — S — 395 (1.45 1.21 1.75) | 4 — S — 440 (1.13 1.11 1.84) |
| 4 — S — 441 (1.06 1.04 1.92) | 4 — S — 447 (1.07 1.23 1.73) | 4 — S — 449 (0.82 1.20 1.76) | 4 — S — 451 (1.16 1.81 1.15) |
| 4 — S — 452 (1.21 1.46 1.49) | 4 — S — 460 (0.94 1.54 1.42) | 4 — S — 463 (1.09 1.91 1.05) | 4 — S — 473 (1.29 1.39 1.57) |
| 4 — S — 474 (1.14 1.27 1.68) | 5 — S — 28 (0.96 1.02 1.58) | 5 — S — 36 (1.12 1.53 1.07) | 5 — S — 43 (1.53 1.38 1.21) |
| 5 — S — 46 (2.13 0.91 1.69) | 5 — S — 70 (1.60 1.59 1.00) | 5 — S — 79 (0.87 0.90 1.70) | 5 — S — 80 (0.82 0.85 1.74) |
| 5 — S — 81 (0.89 0.98 1.62) | 5 — S — 89 (1.35 1.33 1.26) | 5 — S — 90 (1.26 1.18 1.41) | 5 — S — 101 (1.02 1.03 1.56) |
| 5 — S — 107 (1.64 0.87 1.73) | 5 — S — 108 (1.20 1.26 1.33) | 5 — S — 109 (1.44 1.40 1.20) | 5 — S — 110 (0.93 1.03 1.56) |
| 5 — S — 113 (1.04 1.45 1.15) | 5 — S — 115 (1.31 1.01 1.59) | 5 — S — 133 (1.64 1.16 1.44) | 5 — S — 144 (0.98 1.07 1.53) |
| 5 — S — 150 (2.46 1.03 1.56) | 5 — S — 151 (2.37 1.29 1.30) | 5 — S — 152 (3.01 1.59 1.01) | 5 — S — 153 (2.39 1.13 1.46) |
| 5 — S — 177 (1.48 0.81 1.78) | 5 — S — 183 (1.12 1.15 1.45) | 5 — S — 192 (1.82 1.15 1.45) | 5 — S — 206 (0.87 1.50 1.09) |
| 5 — S — 207 (1.39 1.45 1.15) | 5 — S — 231 (1.86 1.26 1.34) | 5 — S — 237 (1.08 1.06 1.54) | 5 — S — 246 (1.39 1.01 1.58) |
| 5 — S — 248 (1.45 1.56 1.03) | 5 — S — 249 (0.92 1.40 1.19) | 5 — S — 251 (0.89 1.26 1.33) | 5 — S — 255 (1.78 1.23 1.36) |
| 5 — S — 258 (0.84 1.68 0.92) | 5 — S — 260 (0.90 1.68 0.91) | 5 — S — 265 (1.35 1.16 1.44) | 5 — S — 268 (1.33 1.30 1.29) |
| 5 — S — 269 (1.29 1.23 1.36) | 5 — S — 271 (2.04 1.33 1.27) | 5 — S — 291 (2.12 1.17 1.42) | 5 — S — 292 (1.46 0.83 1.77) |

| | | | |
|---|---|---|---|
| 5 — S — 295 (1.17 0.92 1.68) | 5 — S — 296 (1.45 0.91 1.68) | 5 — S — 306 (1.50 1.23 1.36) | 5 — S — 307 (1.23 1.36 1.23) |
| 5 — S — 320 (1.72 1.65 0.94) | 5 — S — 327 (1.11 0.98 1.62) | 5 — S — 329 (1.44 1.44 1.16) | 5 — S — 342 (2.86 1.19 1.41) |
| 5 — S — 343 (3.39 1.68 0.91) | 5 — S — 367 (1.39 1.13 1.46) | 5 — S — 368 (1.50 1.68 0.92) | 5 — S — 371 (2.55 1.28 1.32) |
| 5 — S — 395 (1.58 0.98 1.62) | 5 — S — 440 (1.27 0.89 1.71) | 5 — S — 441 (1.20 0.81 1.78) | 5 — S — 447 (1.21 1.00 1.59) |
| 5 — S — 449 (0.95 0.97 1.62) | 5 — S — 451 (1.29 1.58 1.01) | 5 — S — 452 (1.35 1.24 1.36) | 5 — S — 460 (1.07 1.31 1.28) |
| 5 — S — 463 (1.23 1.68 0.91) | 5 — S — 473 (1.42 1.16 1.44) | 5 — S — 474 (1.27 1.05 1.55) | 6 — S — 20 (1.22 0.88 1.78) |
| 6 — S — 27 (1.13 1.04 1.61) | 6 — S — 28 (1.19 1.31 1.34) | 6 — S — 29 (0.96 1.03 1.62) | 6 — S — 43 (1.77 1.68 0.98) |
| 6 — S — 46 (2.36 1.20 1.45) | 6 — S — 61 (1.10 1.02 1.64) | 6 — S — 62 (0.98 1.22 1.44) | 6 — S — 65 (1.12 0.81 1.84) |
| 6 — S — 79 (1.10 1.19 1.46) | 6 — S — 80 (1.05 1.15 1.51) | 6 — S — 81 (1.13 1.27 1.38) | 6 — S — 82 (0.86 1.46 1.20) |
| 6 — S — 85 (1.61 1.00 1.65) | 6 — S — 86 (0.83 1.37 1.28) | 6 — S — 89 (1.59 1.63 1.03) | 6 — S — 90 (1.50 1.48 1.18) |
| 6 — S — 101 (1.25 1.33 1.33) | 6 — S — 107 (1.87 1.16 1.49) | 6 — S — 108 (1.43 1.55 1.10) | 6 — S — 109 (1.67 1.69 0.97) |
| 6 — S — 110 (1.17 1.33 1.33) | 6 — S — 112 (1.06 0.82 1.83) | 6 — S — 113 (1.27 1.74 0.91) | 6 — S — 115 (1.54 1.30 1.35) |
| 6 — S — 119 (1.12 0.94 1.72) | 6 — S — 133 (1.88 1.45 1.20) | 6 — S — 144 (1.21 1.36 1.29) | 6 — S — 150 (2.70 1.33 1.33) |
| 6 — S — 151 (2.61 1.58 1.07) | 6 — S — 153 (2.63 1.43 1.23) | 6 — S — 177 (1.71 1.11 1.55) | 6 — S — 183 (1.36 1.44 1.21) |
| 6 — S — 184 (2.45 0.92 1.74) | 6 — S — 192 (2.05 1.44 1.22) | 6 — S — 198 (1.59 0.82 1.83) | 6 — S — 205 (1.11 0.88 1.77) |
| 6 — S — 207 (1.62 1.74 0.91) | 6 — S — 217 (0.98 0.81 1.84) | 6 — S — 218 (0.95 0.99 1.67) | 6 — S — 231 (2.10 1.55 1.10) |
| 6 — S — 233 (1.48 0.98 1.68) | 6 — S — 234 (1.30 1.06 1.60) | 6 — S — 237 (1.31 1.35 1.30) | 6 — S — 244 (1.37 0.97 1.69) |
| 6 — S — 246 (1.62 1.31 1.35) | 6 — S — 249 (1.16 1.70 0.96) | 6 — S — 251 (1.13 1.56 1.10) | 6 — S — 255 (2.01 1.53 1.13) |
| 6 — S — 265 (1.58 1.45 1.21) | 6 — S — 266 (1.22 1.03 1.63) | 6 — S — 268 (1.56 1.60 1.06) | 6 — S — 269 (1.53 1.53 1.13) |
| 6 — S — 271 (2.28 1.62 1.04) | 6 — S — 279 (1.16 0.86 1.80) | 6 — S — 290 (1.22 1.06 1.60) | 6 — S — 291 (2.36 1.46 1.19) |
| 6 — S — 292 (1.69 1.12 1.53) | 6 — S — 293 (1.19 0.93 1.72) | 6 — S — 294 (1.65 0.97 1.69) | 6 — S — 295 (1.40 1.21 1.45) |
| 6 — S — 296 (1.68 1.20 1.45) | 6 — S — 298 (1.25 0.81 1.84) | 6 — S — 305 (1.57 0.87 1.78) | 6 — S — 306 (1.73 1.53 1.13) |
| 6 — S — 307 (1.46 1.66 1.00) | 6 — S — 316 (1.05 0.87 1.78) | 6 — S — 327 (1.34 1.27 1.38) | 6 — S — 329 (1.67 1.73 0.92) |
| 6 — S — 342 (3.10 1.48 1.17) | 6 — S — 367 (1.63 1.43 1.23) | 6 — S — 370 (0.97 0.86 1.80) | 6 — S — 371 (2.79 1.57 1.08) |
| 6 — S — 374 (0.81 1.05 1.60) | 6 — S — 395 (1.82 1.27 1.38) | 6 — S — 420 (1.00 1.75 0.90) | 6 — S — 430 (0.83 1.37 1.28) |
| 6 — S — 434 (0.89 0.85 1.81) | 6 — S — 435 (0.98 1.01 1.64) | 6 — S — 440 (1.50 1.18 1.47) | 6 — S — 441 (1.43 1.11 1.55) |
| 6 — S — 443 (0.91 1.72 0.93) | 6 — S — 447 (1.44 1.29 1.36) | 6 — S — 449 (1.19 1.26 1.39) | 6 — S — 450 (0.81 0.93 1.72) |
| 6 — S — 452 (1.58 1.53 1.12) | 6 — S — 457 (1.03 1.18 1.48) | 6 — S — 459 (0.82 1.41 1.25) | 6 — S — 460 (1.31 1.61 1.05) |
| 6 — S — 461 (1.02 1.37 1.29) | 6 — S — 468 (0.91 1.08 1.57) | 6 — S — 469 (1.00 1.51 1.15) | 6 — S — 471 (1.61 0.84 1.81) |
| 6 — S — 473 (1.66 1.45 1.20) | 6 — S — 474 (1.51 1.34 1.31) | 7 — S — 20 (1.21 0.89 1.79) | 7 — S — 27 (1.12 1.06 1.62) |
| 7 — S — 28 (1.19 1.32 1.35) | 7 — S — 29 (0.95 1.05 1.63) | 7 — S — 43 (1.76 1.69 0.98) | 7 — S — 46 (2.36 1.21 1.46) |
| 7 — S — 61 (1.10 1.03 1.64) | 7 — S — 62 (0.98 1.23 1.44) | 7 — S — 65 (1.11 0.83 1.85) | 7 — S — 79 (1.09 1.20 1.47) |
| 7 — S — 80 (1.04 1.16 1.51) | 7 — S — 81 (1.12 1.28 1.39) | 7 — S — 82 (0.85 1.47 1.20) | 7 — S — 85 (1.61 1.01 1.66) |
| 7 — S — 86 (0.82 1.38 1.29) | 7 — S — 89 (1.58 1.64 1.03) | 7 — S — 90 (1.49 1.49 1.19) | 7 — S — 101 (1.24 1.34 1.33) |
| 7 — S — 107 (1.87 1.17 1.50) | 7 — S — 108 (1.43 1.57 1.11) | 7 — S — 109 (1.66 1.70 0.97) | 7 — S — 110 (1.16 1.34 1.33) |
| 7 — S — 112 (1.05 0.84 1.84) | 7 — S — 113 (1.26 1.76 0.92) | 7 — S — 115 (1.53 1.31 1.36) | 7 — S — 119 (1.12 0.95 1.72) |
| 7 — S — 133 (1.87 1.47 1.21) | 7 — S — 144 (1.20 1.38 1.30) | 7 — S — 150 (2.69 1.34 1.34) | 7 — S — 151 (2.60 1.60 1.08) |
| 7 — S — 153 (2.62 1.44 1.23) | 7 — S — 177 (1.70 1.12 1.56) | 7 — S — 183 (1.35 1.46 1.22) | 7 — S — 184 (2.44 0.93 1.74) |
| 7 — S — 192 (2.05 1.45 1.22) | 7 — S — 198 (1.58 0.84 1.84) | 7 — S — 205 (1.10 0.90 1.78) | 7 — S — 207 (1.61 1.76 0.92) |
| 7 — S — 217 (0.97 0.82 1.85) | 7 — S — 218 (0.94 1.00 1.67) | 7 — S — 231 (2.09 1.56 1.11) | 7 — S — 233 (1.47 0.99 1.69) |
| 7 — S — 234 (1.29 1.07 1.60) | 7 — S — 237 (1.30 1.37 1.31) | 7 — S — 244 (1.36 0.98 1.69) | 7 — S — 246 (1.61 1.32 1.35) |
| 7 — S — 249 (1.15 1.71 0.96) | 7 — S — 251 (1.12 1.57 1.11) | 7 — S — 255 (2.00 1.54 1.14) | 7 — S — 265 (1.57 1.46 1.21) |
| 7 — S — 266 (1.21 1.04 1.64) | 7 — S — 268 (1.55 1.61 1.06) | 7 — S — 269 (1.52 1.54 1.13) | 7 — S — 271 (2.27 1.63 1.04) |
| 7 — S — 277 (1.10 0.81 1.87) | 7 — S — 279 (1.15 0.87 1.80) | 7 — S — 290 (1.21 1.07 1.60) | 7 — S — 291 (2.35 1.48 1.20) |
| 7 — S — 292 (1.68 1.14 1.54) | 7 — S — 293 (1.19 0.95 1.73) | 7 — S — 294 (1.64 0.98 1.70) | 7 — S — 295 (1.40 1.22 1.45) |
| 7 — S — 296 (1.67 1.22 1.46) | 7 — S — 298 (1.24 0.82 1.85) | 7 — S — 305 (1.56 0.88 1.79) | 7 — S — 306 (1.72 1.54 1.14) |
| 7 — S — 307 (1.45 1.67 1.01) | 7 — S — 316 (1.05 0.88 1.79) | 7 — S — 327 (1.34 1.29 1.39) | 7 — S — 329 (1.66 1.75 0.93) |
| 7 — S — 342 (3.09 1.50 1.18) | 7 — S — 358 (0.99 0.80 1.87) | 7 — S — 367 (1.62 1.44 1.23) | 7 — S — 370 (0.96 0.87 1.80) |
| 7 — S — 371 (2.78 1.58 1.09) | 7 — S — 374 (0.80 1.06 1.61) | 7 — S — 395 (1.81 1.29 1.39) | 7 — S — 420 (0.99 1.76 0.91) |
| 7 — S — 430 (0.82 1.39 1.29) | 7 — S — 434 (0.89 0.86 1.82) | 7 — S — 435 (0.97 1.03 1.65) | 7 — S — 440 (1.50 1.19 1.48) |
| 7 — S — 441 (1.43 1.12 1.55) | 7 — S — 443 (0.90 1.74 0.94) | 7 — S — 447 (1.44 1.31 1.37) | 7 — S — 449 (1.18 1.28 1.40) |
| 7 — S — 450 (0.80 0.94 1.73) | 7 — S — 452 (1.58 1.54 1.13) | 7 — S — 457 (1.02 1.19 1.49) | 7 — S — 459 (0.81 1.42 1.25) |
| 7 — S — 460 (1.30 1.62 1.06) | 7 — S — 461 (1.02 1.38 1.29) | 7 — S — 468 (0.90 1.09 1.58) | 7 — S — 469 (0.99 1.52 1.15) |
| 7 — S — 471 (1.60 0.85 1.82) | 7 — S — 473 (1.65 1.47 1.21) | 7 — S — 474 (1.50 1.35 1.32) | 8 — S — 20 (1.07 1.01 1.93) |
| 8 — S — 27 (0.98 1.18 1.76) | 8 — S — 28 (1.05 1.45 1.49) | 8 — S — 29 (0.81 1.17 1.77) | 8 — S — 36 (1.21 1.96 0.98) |
| 8 — S — 43 (1.62 1.82 1.12) | 8 — S — 46 (2.22 1.34 1.60) | 8 — S — 61 (0.96 1.16 1.78) | 8 — S — 62 (0.83 1.35 1.59) |
| 8 — S — 65 (0.97 0.95 1.99) | 8 — S — 70 (1.68 2.03 0.91) | 8 — S — 79 (0.95 1.33 1.61) | 8 — S — 80 (0.90 1.28 1.66) |
| 8 — S — 81 (0.98 1.41 1.53) | 8 — S — 85 (1.47 1.14 1.80) | 8 — S — 89 (1.44 1.76 1.18) | 8 — S — 90 (1.35 1.61 1.33) |

| | | | |
|---|---|---|---|
| 8 — S — 101 (1.10 1.47 1.47) | 8 — S — 107 (1.73 1.30 1.64) | 8 — S — 108 (1.29 1.69 1.25) | 8 — S — 109 (1.52 1.83 1.11) |
| 8 — S — 110 (1.02 1.47 1.47) | 8 — S — 112 (0.91 0.96 1.98) | 8 — S — 113 (1.12 1.88 1.06) | 8 — S — 115 (1.39 1.44 1.50) |
| 8 — S — 118 (1.00 0.86 2.08) | 8 — S — 119 (0.97 1.08 1.86) | 8 — S — 133 (1.73 1.59 1.35) | 8 — S — 144 (1.06 1.50 1.44) |
| 8 — S — 150 (2.55 1.46 1.48) | 8 — S — 151 (2.46 1.72 1.22) | 8 — S — 152 (3.10 2.02 0.92) | 8 — S — 153 (2.48 1.56 1.38) |
| 8 — S — 177 (1.56 1.24 1.70) | 8 — S — 183 (1.21 1.58 1.36) | 8 — S — 184 (2.30 1.06 1.88) | 8 — S — 192 (1.90 1.58 1.36) |
| 8 — S — 195 (1.73 0.90 2.04) | 8 — S — 198 (1.44 0.96 1.98) | 8 — S — 205 (0.96 1.02 1.92) | 8 — S — 206 (0.95 1.93 1.01) |
| 8 — S — 207 (1.47 1.88 1.06) | 8 — S — 213 (1.41 0.92 2.02) | 8 — S — 217 (0.83 0.95 1.99) | 8 — S — 231 (1.95 1.69 1.25) |
| 8 — S — 233 (1.33 1.11 1.83) | 8 — S — 234 (1.15 1.20 1.75) | 8 — S — 237 (1.16 1.49 1.45) | 8 — S — 244 (1.22 1.11 1.83) |
| 8 — S — 245 (1.14 0.88 2.06) | 8 — S — 246 (1.47 1.45 1.49) | 8 — S — 248 (1.54 1.99 0.95) | 8 — S — 249 (1.01 1.84 1.11) |
| 8 — S — 251 (0.98 1.69 1.25) | 8 — S — 254 (0.97 0.80 2.14) | 8 — S — 255 (1.86 1.66 1.28) | 8 — S — 265 (1.43 1.59 1.35) |
| 8 — S — 266 (1.07 1.16 1.78) | 8 — S — 267 (0.87 0.86 2.08) | 8 — S — 268 (1.41 1.74 1.20) | 8 — S — 269 (1.38 1.67 1.28) |
| 8 — S — 271 (2.13 1.76 1.18) | 8 — S — 277 (0.96 0.93 2.01) | 8 — S — 279 (1.01 1.00 1.95) | 8 — S — 290 (1.07 1.20 1.74) |
| 8 — S — 291 (2.21 1.60 1.34) | 8 — S — 292 (1.54 1.26 1.68) | 8 — S — 293 (1.05 1.07 1.87) | 8 — S — 294 (1.50 1.10 1.84) |
| 8 — S — 295 (1.25 1.35 1.59) | 8 — S — 296 (1.53 1.34 1.60) | 8 — S — 298 (1.10 0.95 1.99) | 8 — S — 305 (1.42 1.01 1.93) |
| 8 — S — 306 (1.58 1.66 1.28) | 8 — S — 307 (1.31 1.79 1.15) | 8 — S — 316 (0.91 1.01 1.93) | 8 — S — 327 (1.20 1.41 1.53) |
| 8 — S — 329 (1.52 1.87 1.07) | 8 — S — 342 (2.95 1.62 1.32) | 8 — S — 358 (0.85 0.93 2.01) | 8 — S — 367 (1.48 1.56 1.38) |
| 8 — S — 370 (0.82 0.99 1.95) | 8 — S — 371 (2.64 1.71 1.23) | 8 — S — 382 (0.80 0.87 2.07) | 8 — S — 395 (1.67 1.41 1.53) |
| 8 — S — 396 (1.10 0.85 2.09) | 8 — S — 420 (0.85 1.89 1.05) | 8 — S — 435 (0.83 1.15 1.79) | 8 — S — 440 (1.36 1.32 1.62) |
| 8 — S — 441 (1.29 1.25 1.69) | 8 — S — 447 (1.30 1.43 1.51) | 8 — S — 449 (1.04 1.40 1.54) | 8 — S — 451 (1.38 2.01 0.93) |
| 8 — S — 452 (1.44 1.67 1.27) | 8 — S — 457 (0.88 1.31 1.63) | 8 — S — 460 (1.16 1.74 1.20) | 8 — S — 461 (0.88 1.50 1.44) |
| 8 — S — 469 (0.85 1.65 1.29) | 8 — S — 471 (1.46 0.98 1.96) | 8 — S — 473 (1.51 1.59 1.35) | 8 — S — 474 (1.36 1.48 1.46) |
| 9 — S — 46 (1.25 0.87 2.57) | 9 — S — 57 (0.92 1.89 1.55) | 9 — S — 125 (1.16 2.34 1.10) | 9 — S — 150 (1.58 1.00 2.44) |
| 9 — S — 151 (1.49 1.25 2.18) | 9 — S — 152 (2.14 1.55 1.88) | 9 — S — 153 (1.52 1.10 2.34) | 9 — S — 192 (0.94 1.11 2.33) |
| 9 — S — 231 (0.98 1.22 2.22) | 9 — S — 250 (0.93 2.46 0.98) | 9 — S — 255 (0.90 1.20 2.24) | 9 — S — 271 (1.16 1.29 2.15) |
| 9 — S — 291 (1.24 1.13 2.30) | 9 — S — 320 (0.84 1.61 1.82) | 9 — S — 324 (0.81 2.11 1.33) | 9 — S — 342 (1.99 1.15 2.28) |
| 9 — S — 343 (2.52 1.65 1.79) | 9 — S — 371 (1.67 1.24 2.20) | 9 — S — 429 (2.08 2.34 1.09) | 9 — S — 472 (1.07 1.92 1.52) |
| 10 — S — 20 (1.24 0.82 1.75) | 10 — S — 27 (1.16 0.99 1.59) | 10 — S — 28 (1.22 1.25 1.32) | 10 — S — 29 (0.98 0.98 1.60) |
| 10 — S — 40 (0.80 0.98 1.60) | 10 — S — 43 (1.79 1.62 0.95) | 10 — S — 46 (2.39 1.14 1.43) | 10 — S — 61 (1.13 0.96 1.61) |
| 10 — S — 62 (1.01 1.16 1.41) | 10 — S — 79 (1.12 1.13 1.44) | 10 — S — 80 (1.08 1.09 1.48) | 10 — S — 81 (1.15 1.21 1.36) |
| 10 — S — 82 (0.89 1.40 1.17) | 10 — S — 85 (1.64 0.94 1.63) | 10 — S — 86 (0.86 1.31 1.26) | 10 — S — 89 (1.61 1.57 1.00) |
| 10 — S — 90 (1.52 1.42 1.15) | 10 — S — 101 (1.28 1.27 1.30) | 10 — S — 107 (1.90 1.11 1.47) | 10 — S — 108 (1.46 1.50 1.08) |
| 10 — S — 109 (1.69 1.63 0.94) | 10 — S — 110 (1.19 1.27 1.30) | 10 — S — 115 (1.56 1.25 1.33) | 10 — S — 119 (1.15 0.88 1.69) |
| 10 — S — 133 (1.90 1.40 1.18) | 10 — S — 144 (1.24 1.31 1.27) | 10 — S — 150 (2.72 1.27 1.30) | 10 — S — 151 (2.63 1.53 1.05) |
| 10 — S — 153 (2.65 1.37 1.20) | 10 — S — 177 (1.73 1.05 1.52) | 10 — S — 183 (1.38 1.39 1.19) | 10 — S — 184 (2.47 0.86 1.71) |
| 10 — S — 192 (2.08 1.38 1.19) | 10 — S — 205 (1.13 0.83 1.75) | 10 — S — 218 (0.97 0.93 1.64) | 10 — S — 231 (2.12 1.49 1.08) |
| 10 — S — 233 (1.51 0.92 1.65) | 10 — S — 234 (1.33 1.00 1.57) | 10 — S — 237 (1.34 1.30 1.28) | 10 — S — 244 (1.39 0.91 1.66) |
| 10 — S — 246 (1.64 1.25 1.32) | 10 — S — 249 (1.18 1.64 0.93) | 10 — S — 251 (1.15 1.50 1.08) | 10 — S — 255 (2.04 1.47 1.10) |
| 10 — S — 265 (1.61 1.39 1.18) | 10 — S — 266 (1.24 0.97 1.60) | 10 — S — 268 (1.59 1.54 1.03) | 10 — S — 269 (1.55 1.47 1.10) |
| 10 — S — 271 (2.30 1.56 1.01) | 10 — S — 279 (1.18 0.80 1.77) | 10 — S — 290 (1.24 1.00 1.57) | 10 — S — 291 (2.38 1.41 1.17) |
| 10 — S — 292 (1.71 1.07 1.51) | 10 — S — 293 (1.22 0.88 1.70) | 10 — S — 294 (1.67 0.91 1.67) | 10 — S — 295 (1.43 1.15 1.42) |
| 10 — S — 296 (1.70 1.15 1.43) | 10 — S — 305 (1.59 0.82 1.76) | 10 — S — 306 (1.76 1.47 1.10) | 10 — S — 307 (1.48 1.60 0.98) |
| 10 — S — 316 (1.08 0.81 1.76) | 10 — S — 327 (1.37 1.22 1.36) | 10 — S — 342 (3.12 1.43 1.15) | 10 — S — 367 (1.65 1.37 1.20) |
| 10 — S — 370 (0.99 0.80 1.77) | 10 — S — 371 (2.81 1.52 1.06) | 10 — S — 374 (0.83 0.99 1.58) | 10 — S — 395 (1.84 1.22 1.36) |
| 10 — S — 430 (0.85 1.32 1.26) | 10 — S — 435 (1.00 0.96 1.62) | 10 — S — 440 (1.53 1.12 1.45) | 10 — S — 441 (1.46 1.05 1.52) |
| 10 — S — 443 (0.93 1.67 0.91) | 10 — S — 447 (1.47 1.24 1.34) | 10 — S — 449 (1.21 1.21 1.37) | 10 — S — 450 (0.83 0.87 1.70) |
| 10 — S — 452 (1.61 1.47 1.10) | 10 — S — 457 (1.06 1.12 1.45) | 10 — S — 459 (0.84 1.35 1.22) | 10 — S — 460 (1.33 1.55 1.02) |
| 10 — S — 461 (1.05 1.31 1.26) | 10 — S — 468 (0.94 1.02 1.55) | 10 — S — 469 (1.03 1.45 1.12) | 10 — S — 473 (1.68 1.40 1.18) |
| 10 — S — 474 (1.53 1.29 1.29) | 11 — S — 36 (1.13 1.25 1.05) | 11 — S — 43 (1.55 1.11 1.20) | 11 — S — 70 (1.61 1.32 0.99) |
| 11 — S — 89 (1.37 1.05 1.25) | 11 — S — 90 (1.28 0.90 1.40) | 11 — S — 108 (1.21 0.98 1.32) | 11 — S — 109 (1.45 1.12 1.19) |
| 11 — S — 113 (1.05 1.17 1.13) | 11 — S — 133 (1.66 0.88 1.42) | 11 — S — 151 (2.38 1.01 1.29) | 11 — S — 152 (3.03 1.31 0.99) |
| 11 — S — 153 (2.41 0.85 1.45) | 11 — S — 183 (1.14 0.87 1.43) | 11 — S — 192 (1.83 0.87 1.44) | 11 — S — 206 (0.88 1.22 1.08) |
| 11 — S — 207 (1.40 1.17 1.13) | 11 — S — 231 (1.88 0.98 1.32) | 11 — S — 248 (1.47 1.28 1.02) | 11 — S — 249 (0.94 1.13 1.18) |
| 11 — S — 251 (0.91 0.98 1.32) | 11 — S — 255 (1.79 0.95 1.35) | 11 — S — 258 (0.86 1.40 0.90) | 11 — S — 265 (1.36 0.88 1.43) |
| 11 — S — 268 (1.34 1.03 1.28) | 11 — S — 269 (1.31 0.95 1.35) | 11 — S — 271 (2.05 1.05 1.26) | 11 — S — 291 (2.14 0.89 1.41) |
| 11 — S — 306 (1.51 0.95 1.35) | 11 — S — 307 (1.24 1.08 1.22) | 11 — S — 320 (1.73 1.37 0.93) | 11 — S — 329 (1.45 1.16 1.14) |
| 11 — S — 342 (2.88 0.91 1.39) | 11 — S — 367 (1.41 0.85 1.45) | 11 — S — 368 (1.52 1.40 0.91) | 11 — S — 371 (2.57 1.00 1.30) |
| 11 — S — 451 (1.31 1.30 1.00) | 11 — S — 452 (1.36 0.96 1.34) | 11 — S — 460 (1.09 1.03 1.27) | 11 — S — 473 (1.44 0.88 1.42) |
| 12 — S — 28 (1.22 1.01 1.32) | 12 — S — 43 (1.79 1.38 0.95) | 12 — S — 46 (2.39 0.90 1.43) | 12 — S — 62 (1.01 0.92 1.41) |

12 — S — 79 (1.12 0.89 1.44) 12 — S — 80 (1.08 0.85 1.48) 12 — S — 81 (1.15 0.97 1.36) 12 — S — 82 (0.89 1.15 1.17)
12 — S — 86 (0.86 1.07 1.26) 12 — S — 89 (1.61 1.32 1.00) 12 — S — 90 (1.52 1.17 1.15) 12 — S — 101 (1.28 1.03 1.30)
12 — S — 107 (1.90 0.86 1.47) 12 — S — 108 (1.46 1.25 1.08) 12 — S — 109 (1.70 1.39 0.94) 12 — S — 110 (1.19 1.03 1.30)
12 — S — 115 (1.56 1.00 1.33) 12 — S — 133 (1.90 1.15 1.18) 12 — S — 144 (1.24 1.06 1.27) 12 — S — 150 (2.72 1.02 1.30)
12 — S — 151 (2.63 1.28 1.05) 12 — S — 153 (2.65 1.12 1.20) 12 — S — 177 (1.73 0.80 1.52) 12 — S — 183 (1.38 1.14 1.19)
12 — S — 192 (2.08 1.14 1.19) 12 — S — 231 (2.12 1.25 1.08) 12 — S — 237 (1.34 1.05 1.28) 12 — S — 246 (1.64 1.01 1.32)
12 — S — 249 (1.18 1.40 0.93) 12 — S — 251 (1.15 1.25 1.07) 12 — S — 255 (2.04 1.22 1.10) 12 — S — 265 (1.61 1.15 1.18)
12 — S — 268 (1.59 1.30 1.03) 12 — S — 269 (1.55 1.23 1.10) 12 — S — 271 (2.30 1.32 1.01) 12 — S — 291 (2.38 1.16 1.17)
12 — S — 292 (1.72 0.82 1.51) 12 — S — 295 (1.43 0.91 1.42) 12 — S — 296 (1.70 0.90 1.43) 12 — S — 306 (1.76 1.22 1.10)
12 — S — 307 (1.48 1.35 0.97) 12 — S — 327 (1.37 0.97 1.36) 12 — S — 342 (3.12 1.18 1.15) 12 — S — 367 (1.65 1.13 1.20)
12 — S — 371 (2.81 1.27 1.06) 12 — S — 395 (1.84 0.97 1.36) 12 — S — 430 (0.85 1.07 1.26) 12 — S — 440 (1.53 0.88 1.45)
12 — S — 441 (1.46 0.81 1.52) 12 — S — 443 (0.93 1.42 0.91) 12 — S — 447 (1.47 0.99 1.34) 12 — S — 449 (1.21 0.96 1.37)
12 — S — 452 (1.61 1.23 1.10) 12 — S — 457 (1.06 0.87 1.45) 12 — S — 459 (0.84 1.11 1.22) 12 — S — 460 (1.33 1.30 1.02)
12 — S — 461 (1.05 1.07 1.26) 12 — S — 469 (1.03 1.21 1.12) 12 — S — 473 (1.68 1.15 1.18) 12 — S — 474 (1.53 1.04 1.29)
13 — S — 20 (1.28 1.27 1.71) 13 — S — 27 (1.20 1.44 1.54) 13 — S — 28 (1.26 1.70 1.28) 13 — S — 29 (1.02 1.43 1.55)
13 — S — 40 (0.84 1.43 1.55) 13 — S — 43 (1.84 2.07 0.91) 13 — S — 46 (2.43 1.59 1.39) 13 — S — 56 (1.19 0.90 2.08)
13 — S — 61 (1.17 1.41 1.57) 13 — S — 62 (1.05 1.61 1.37) 13 — S — 65 (1.18 1.21 1.77) 13 — S — 68 (0.89 1.17 1.81)
13 — S — 79 (1.17 1.58 1.40) 13 — S — 80 (1.12 1.54 1.44) 13 — S — 81 (1.19 1.66 1.32) 13 — S — 82 (0.93 1.85 1.13)
13 — S — 83 (1.23 0.84 2.14) 13 — S — 85 (1.68 1.39 1.59) 13 — S — 86 (0.90 1.76 1.22) 13 — S — 89 (1.65 2.02 0.96)
13 — S — 90 (1.56 1.87 1.11) 13 — S — 101 (1.32 1.72 1.26) 13 — S — 105 (1.48 0.82 2.16) 13 — S — 107 (1.94 1.55 1.43)
13 — S — 108 (1.50 1.95 1.03) 13 — S — 110 (1.23 1.72 1.26) 13 — S — 111 (1.94 0.84 2.14) 13 — S — 112 (1.13 1.22 1.76)
13 — S — 115 (1.61 1.69 1.29) 13 — S — 118 (1.22 1.12 1.86) 13 — S — 119 (1.19 1.33 1.65) 13 — S — 123 (0.83 1.46 1.52)
13 — S — 132 (1.15 1.04 1.94) 13 — S — 133 (1.94 1.85 1.13) 13 — S — 144 (1.28 1.76 1.22) 13 — S — 150 (2.76 1.72 1.26)
13 — S — 151 (2.67 1.98 1.00) 13 — S — 153 (2.70 1.82 1.16) 13 — S — 154 (2.23 0.95 2.03) 13 — S — 177 (1.78 1.50 1.48)
13 — S — 183 (1.42 1.84 1.15) 13 — S — 184 (2.51 1.31 1.67) 13 — S — 192 (2.12 1.83 1.15) 13 — S — 193 (1.04 0.99 1.99)
13 — S — 195 (1.94 1.16 1.82) 13 — S — 198 (1.65 1.22 1.76) 13 — S — 205 (1.17 1.28 1.70) 13 — S — 209 (0.89 0.83 2.15)
13 — S — 213 (1.62 1.17 1.81) 13 — S — 217 (1.05 1.20 1.78) 13 — S — 218 (1.01 1.38 1.60) 13 — S — 219 (0.82 0.94 2.04)
13 — S — 231 (2.16 1.94 1.04) 13 — S — 233 (1.55 1.37 1.61) 13 — S — 234 (1.37 1.45 1.53) 13 — S — 237 (1.38 1.75 1.23)
13 — S — 244 (1.43 1.36 1.62) 13 — S — 245 (1.35 1.13 1.85) 13 — S — 246 (1.69 1.70 1.28) 13 — S — 251 (1.19 1.95 1.03)
13 — S — 254 (1.19 1.06 1.92) 13 — S — 255 (2.08 1.92 1.06) 13 — S — 265 (1.65 1.84 1.14) 13 — S — 266 (1.29 1.42 1.56)
13 — S — 267 (1.09 1.12 1.86) 13 — S — 268 (1.63 1.99 0.99) 13 — S — 269 (1.59 1.92 1.06) 13 — S — 271 (2.34 2.01 0.97)
13 — S — 274 (0.95 0.92 2.06) 13 — S — 277 (1.17 1.19 1.79) 13 — S — 279 (1.23 1.25 1.73) 13 — S — 280 (0.91 0.93 2.05)
13 — S — 285 (0.95 1.13 1.85) 13 — S — 286 (1.20 1.04 1.94) 13 — S — 287 (1.01 1.05 1.93) 13 — S — 288 (1.00 0.99 1.99)
13 — S — 289 (1.26 0.82 2.16) 13 — S — 290 (1.29 1.45 1.53) 13 — S — 291 (2.42 1.86 1.12) 13 — S — 292 (1.76 1.52 1.46)
13 — S — 293 (1.26 1.33 1.65) 13 — S — 294 (1.72 1.36 1.62) 13 — S — 295 (1.47 1.60 1.38) 13 — S — 296 (1.75 1.60 1.38)
13 — S — 298 (1.32 1.20 1.78) 13 — S — 304 (1.12 1.05 1.93) 13 — S — 305 (1.64 1.26 1.72) 13 — S — 306 (1.80 1.92 1.06)
13 — S — 307 (1.53 2.05 0.93) 13 — S — 311 (0.96 0.94 2.04) 13 — S — 312 (1.06 0.81 2.17) 13 — S — 313 (0.83 0.98 2.00)
13 — S — 316 (1.12 1.26 1.72) 13 — S — 327 (1.41 1.67 1.31) 13 — S — 331 (1.27 0.84 2.14) 13 — S — 332 (1.12 1.02 1.96)
13 — S — 336 (1.22 0.91 2.07) 13 — S — 342 (3.17 1.88 1.10) 13 — S — 358 (1.07 1.18 1.80) 13 — S — 367 (1.69 1.82 1.16)
13 — S — 370 (1.04 1.25 1.73) 13 — S — 371 (2.85 1.96 1.02) 13 — S — 372 (1.26 0.95 2.03) 13 — S — 374 (0.87 1.44 1.54)
13 — S — 379 (0.95 0.95 2.03) 13 — S — 382 (1.02 1.13 1.85) 13 — S — 391 (0.96 0.93 2.05) 13 — S — 395 (1.88 1.67 1.32)
13 — S — 396 (1.31 1.10 1.88) 13 — S — 397 (1.11 0.95 2.03) 13 — S — 415 (1.00 0.83 2.15) 13 — S — 430 (0.90 1.77 1.21)
13 — S — 434 (0.96 1.24 1.74) 13 — S — 435 (1.05 1.41 1.57) 13 — S — 440 (1.57 1.57 1.41) 13 — S — 441 (1.50 1.50 1.48)
13 — S — 447 (1.51 1.69 1.29) 13 — S — 449 (1.25 1.66 1.32) 13 — S — 450 (0.88 1.32 1.66) 13 — S — 452 (1.65 1.92 1.06)
13 — S — 455 (0.95 1.06 1.92) 13 — S — 457 (1.10 1.57 1.41) 13 — S — 459 (0.88 1.80 1.18) 13 — S — 460 (1.38 2.00 0.98)
13 — S — 461 (1.09 1.76 1.22) 13 — S — 468 (0.98 1.47 1.51) 13 — S — 469 (1.07 1.90 1.08) 13 — S — 471 (1.68 1.23 1.75)
13 — S — 473 (1.72 1.85 1.13) 13 — S — 474 (1.58 1.73 1.25) 14 — S — 36 (0.82 1.85 1.36) 14 — S — 37 (0.82 2.15 1.06)
14 — S — 43 (1.24 1.71 1.51) 14 — S — 46 (1.84 1.23 1.98) 14 — S — 57 (1.51 2.25 0.97) 14 — S — 70 (1.30 1.92 1.30)
14 — S — 85 (1.08 1.03 2.18) 14 — S — 89 (1.06 1.66 1.56) 14 — S — 90 (0.97 1.51 1.71) 14 — S — 107 (1.35 1.19 2.02)
14 — S — 108 (0.91 1.58 1.63) 14 — S — 109 (1.14 1.72 1.49) 14 — S — 115 (1.01 1.33 1.88) 14 — S — 133 (1.35 1.48 1.73)
14 — S — 150 (2.17 1.36 1.86) 14 — S — 151 (2.08 1.61 1.60) 14 — S — 152 (2.72 1.91 1.30) 14 — S — 153 (2.10 1.46 1.76)
14 — S — 177 (1.18 1.14 2.08) 14 — S — 183 (0.83 1.47 1.74) 14 — S — 184 (1.92 0.95 2.27) 14 — S — 192 (1.52 1.47 1.74)
14 — S — 198 (1.06 0.85 2.36) 14 — S — 207 (1.09 1.77 1.44) 14 — S — 213 (1.03 0.81 2.40) 14 — S — 215 (1.33 2.04 1.17)
14 — S — 231 (1.57 1.58 1.63) 14 — S — 233 (0.95 1.01 2.21) 14 — S — 244 (0.84 1.00 2.21) 14 — S — 246 (1.09 1.34 1.87)
14 — S — 248 (1.16 1.89 1.33) 14 — S — 255 (1.48 1.56 1.66) 14 — S — 265 (1.05 1.48 1.73) 14 — S — 268 (1.03 1.63 1.58)
14 — S — 269 (1.00 1.56 1.66) 14 — S — 270 (1.14 2.24 0.98) 14 — S — 271 (1.75 1.65 1.56) 14 — S — 291 (1.83 1.49 1.72)
14 — S — 292 (1.16 1.15 2.06) 14 — S — 294 (1.12 1.00 2.22) 14 — S — 295 (0.87 1.24 1.97) 14 — S — 296 (1.15 1.23 1.98)
14 — S — 305 (1.04 0.90 2.31) 14 — S — 306 (1.20 1.56 1.66) 14 — S — 307 (0.93 1.69 1.53) 14 — S — 320 (1.42 1.97 1.24)

| | | | |
|---|---|---|---|
| 14 — S — 327 (0.81 1.30 1.91) | 14 — S — 329 (1.14 1.76 1.45) | 14 — S — 342 (2.57 1.51 1.70) | 14 — S — 343 (3.10 2.01 1.21) |
| 14 — S — 364 (1.28 2.13 1.08) | 14 — S — 367 (1.10 1.46 1.76) | 14 — S — 368 (1.21 2.00 1.21) | 14 — S — 371 (2.26 1.60 1.61) |
| 14 — S — 395 (1.29 1.30 1.91) | 14 — S — 440 (0.97 1.21 2.00) | 14 — S — 441 (0.90 1.14 2.08) | 14 — S — 447 (0.92 1.33 1.89) |
| 14 — S — 451 (1.00 1.90 1.31) | 14 — S — 452 (1.05 1.56 1.65) | 14 — S — 463 (0.93 2.01 1.21) | 14 — S — 471 (1.08 0.87 2.34) |
| 14 — S — 472 (1.66 2.28 0.93) | 14 — S — 473 (1.13 1.48 1.73) | 14 — S — 474 (0.98 1.37 1.84) | 15 — S — 45 (1.26 0.86 0.96) |
| 15 — S — 118 (2.16 0.91 0.92) | 15 — S — 132 (2.10 0.83 1.00) | 15 — S — 245 (2.30 0.93 0.90) | 15 — S — 254 (2.13 0.85 0.98) |
| 15 — S — 267 (2.03 0.91 0.92) | 15 — S — 285 (1.89 0.92 0.90) | 15 — S — 286 (2.15 0.83 1.00) | 15 — S — 287 (1.96 0.84 0.99) |
| 15 — S — 304 (2.07 0.84 0.99) | 15 — S — 319 (1.27 0.91 0.91) | 15 — S — 325 (1.11 0.85 0.98) | 15 — S — 332 (2.07 0.81 1.02) |
| 15 — S — 381 (1.46 0.91 0.92) | 15 — S — 382 (1.96 0.92 0.91) | 15 — S — 396 (2.25 0.89 0.93) | 15 — S — 455 (1.89 0.85 0.97) |
| 16 — S — 20 (1.21 0.88 1.79) | 16 — S — 27 (1.12 1.04 1.62) | 16 — S — 28 (1.19 1.31 1.35) | 16 — S — 29 (0.95 1.04 1.63) |
| 16 — S — 43 (1.76 1.68 0.98) | 16 — S — 46 (2.36 1.20 1.46) | 16 — S — 61 (1.10 1.02 1.64) | 16 — S — 62 (0.98 1.22 1.45) |
| 16 — S — 65 (1.11 0.81 1.85) | 16 — S — 79 (1.09 1.19 1.47) | 16 — S — 80 (1.04 1.15 1.52) | 16 — S — 81 (1.12 1.27 1.39) |
| 16 — S — 82 (0.85 1.46 1.21) | 16 — S — 85 (1.61 1.00 1.66) | 16 — S — 86 (0.82 1.37 1.29) | 16 — S — 89 (1.58 1.63 1.04) |
| 16 — S — 90 (1.49 1.48 1.19) | 16 — S — 101 (1.24 1.33 1.33) | 16 — S — 107 (1.87 1.16 1.50) | 16 — S — 108 (1.43 1.55 1.11) |
| 16 — S — 109 (1.66 1.69 0.97) | 16 — S — 110 (1.16 1.33 1.33) | 16 — S — 112 (1.05 0.83 1.84) | 16 — S — 113 (1.26 1.74 0.92) |
| 16 — S — 115 (1.53 1.30 1.36) | 16 — S — 119 (1.12 0.94 1.72) | 16 — S — 133 (1.87 1.45 1.21) | 16 — S — 144 (1.20 1.36 1.30) |
| 16 — S — 150 (2.69 1.33 1.34) | 16 — S — 151 (2.60 1.58 1.08) | 16 — S — 153 (2.62 1.43 1.24) | 16 — S — 177 (1.70 1.11 1.56) |
| 16 — S — 183 (1.35 1.44 1.22) | 16 — S — 184 (2.44 0.92 1.74) | 16 — S — 192 (2.04 1.44 1.22) | 16 — S — 198 (1.58 0.82 1.84) |
| 16 — S — 205 (1.10 0.88 1.78) | 16 — S — 207 (1.61 1.74 0.92) | 16 — S — 217 (0.97 0.81 1.85) | 16 — S — 218 (0.94 0.99 1.67) |
| 16 — S — 231 (2.09 1.55 1.11) | 16 — S — 233 (1.47 0.98 1.69) | 16 — S — 234 (1.29 1.06 1.60) | 16 — S — 237 (1.30 1.35 1.31) |
| 16 — S — 244 (1.36 0.97 1.69) | 16 — S — 246 (1.61 1.31 1.35) | 16 — S — 249 (1.15 1.70 0.96) | 16 — S — 251 (1.12 1.56 1.11) |
| 16 — S — 255 (2.00 1.53 1.14) | 16 — S — 265 (1.57 1.45 1.21) | 16 — S — 266 (1.21 1.03 1.64) | 16 — S — 268 (1.55 1.60 1.06) |
| 16 — S — 269 (1.52 1.53 1.13) | 16 — S — 271 (2.27 1.62 1.04) | 16 — S — 279 (1.15 0.86 1.80) | 16 — S — 290 (1.21 1.06 1.60) |
| 16 — S — 291 (2.35 1.46 1.20) | 16 — S — 292 (1.68 1.12 1.54) | 16 — S — 293 (1.19 0.93 1.73) | 16 — S — 294 (1.64 0.97 1.70) |
| 16 — S — 295 (1.39 1.21 1.45) | 16 — S — 296 (1.67 1.21 1.46) | 16 — S — 298 (1.24 0.81 1.85) | 16 — S — 305 (1.56 0.87 1.79) |
| 16 — S — 306 (1.72 1.53 1.14) | 16 — S — 307 (1.45 1.66 1.01) | 16 — S — 316 (1.05 0.87 1.79) | 16 — S — 327 (1.34 1.27 1.39) |
| 16 — S — 329 (1.66 1.73 0.93) | 16 — S — 342 (3.09 1.48 1.18) | 16 — S — 367 (1.62 1.43 1.24) | 16 — S — 370 (0.96 0.86 1.81) |
| 16 — S — 371 (2.78 1.57 1.09) | 16 — S — 395 (1.81 1.27 1.39) | 16 — S — 420 (0.99 1.75 0.91) | 16 — S — 430 (0.82 1.37 1.29) |
| 16 — S — 434 (0.89 0.85 1.82) | 16 — S — 435 (0.97 1.01 1.65) | 16 — S — 440 (1.50 1.18 1.48) | 16 — S — 441 (1.43 1.11 1.55) |
| 16 — S — 443 (0.90 1.72 0.94) | 16 — S — 447 (1.44 1.30 1.37) | 16 — S — 449 (1.18 1.26 1.40) | 16 — S — 450 (0.80 0.93 1.73) |
| 16 — S — 452 (1.58 1.53 1.13) | 16 — S — 457 (1.02 1.18 1.49) | 16 — S — 459 (0.81 1.41 1.25) | 16 — S — 460 (1.30 1.61 1.06) |
| 16 — S — 461 (1.02 1.37 1.29) | 16 — S — 468 (0.90 1.08 1.58) | 16 — S — 469 (0.99 1.51 1.15) | 16 — S — 471 (1.60 0.84 1.82) |
| 16 — S — 473 (1.65 1.45 1.21) | 16 — S — 474 (1.50 1.34 1.32) | 17 — S — 20 (1.53 0.99 1.47) | 17 — S — 27 (1.44 1.15 1.30) |
| 17 — S — 28 (1.51 1.42 1.03) | 17 — S — 29 (1.27 1.15 1.31) | 17 — S — 40 (1.09 1.15 1.31) | 17 — S — 46 (2.68 1.31 1.14) |
| 17 — S — 61 (1.42 1.13 1.32) | 17 — S — 62 (1.30 1.33 1.12) | 17 — S — 65 (1.43 0.93 1.53) | 17 — S — 68 (1.14 0.89 1.57) |
| 17 — S — 79 (1.41 1.30 1.15) | 17 — S — 80 (1.37 1.26 1.19) | 17 — S — 81 (1.44 1.38 1.07) | 17 — S — 85 (1.93 1.11 1.34) |
| 17 — S — 86 (1.14 1.48 0.97) | 17 — S — 101 (1.56 1.44 1.01) | 17 — S — 107 (2.19 1.27 1.18) | 17 — S — 110 (1.48 1.44 1.01) |
| 17 — S — 112 (1.37 0.94 1.52) | 17 — S — 115 (1.85 1.41 1.04) | 17 — S — 118 (1.46 0.84 1.62) | 17 — S — 119 (1.44 1.05 1.40) |
| 17 — S — 123 (1.08 1.18 1.27) | 17 — S — 144 (1.52 1.48 0.98) | 17 — S — 147 (0.93 1.05 1.40) | 17 — S — 150 (3.01 1.44 1.02) |
| 17 — S — 153 (2.94 1.54 0.91) | 17 — S — 177 (2.02 1.22 1.24) | 17 — S — 184 (2.76 1.03 1.42) | 17 — S — 192 (2.37 1.55 0.90) |
| 17 — S — 195 (2.19 0.88 1.58) | 17 — S — 198 (1.90 0.94 1.52) | 17 — S — 205 (1.42 1.00 1.46) | 17 — S — 213 (1.87 0.89 1.56) |
| 17 — S — 217 (1.29 0.92 1.53) | 17 — S — 218 (1.26 1.10 1.35) | 17 — S — 233 (1.79 1.09 1.37) | 17 — S — 234 (1.61 1.17 1.28) |
| 17 — S — 237 (1.63 1.47 0.99) | 17 — S — 238 (0.92 1.32 1.13) | 17 — S — 244 (1.68 1.08 1.37) | 17 — S — 245 (1.60 0.85 1.60) |
| 17 — S — 246 (1.93 1.42 1.03) | 17 — S — 266 (1.53 1.14 1.31) | 17 — S — 267 (1.33 0.84 1.61) | 17 — S — 275 (1.01 1.06 1.39) |
| 17 — S — 277 (1.42 0.91 1.55) | 17 — S — 279 (1.47 0.97 1.48) | 17 — S — 285 (1.20 0.85 1.60) | 17 — S — 290 (1.53 1.17 1.28) |
| 17 — S — 292 (2.00 1.24 1.22) | 17 — S — 293 (1.51 1.05 1.41) | 17 — S — 294 (1.96 1.08 1.38) | 17 — S — 295 (1.72 1.32 1.13) |
| 17 — S — 296 (1.99 1.32 1.14) | 17 — S — 298 (1.56 0.92 1.53) | 17 — S — 299 (0.82 1.26 1.19) | 17 — S — 305 (1.88 0.98 1.47) |
| 17 — S — 316 (1.37 0.98 1.47) | 17 — S — 327 (1.66 1.39 1.07) | 17 — S — 341 (0.97 1.26 1.20) | 17 — S — 358 (1.31 0.90 1.55) |
| 17 — S — 367 (1.94 1.54 0.91) | 17 — S — 370 (1.28 0.97 1.48) | 17 — S — 374 (1.12 1.16 1.29) | 17 — S — 382 (1.26 0.85 1.61) |
| 17 — S — 395 (2.13 1.38 1.07) | 17 — S — 396 (1.56 0.82 1.63) | 17 — S — 430 (1.14 1.49 0.97) | 17 — S — 434 (1.21 0.96 1.50) |
| 17 — S — 435 (1.29 1.13 1.33) | 17 — S — 440 (1.82 1.29 1.16) | 17 — S — 441 (1.75 1.22 1.23) | 17 — S — 447 (1.76 1.41 1.05) |
| 17 — S — 449 (1.50 1.38 1.08) | 17 — S — 450 (1.12 1.04 1.41) | 17 — S — 457 (1.34 1.29 1.17) | 17 — S — 458 (0.89 1.08 1.37) |
| 17 — S — 459 (1.13 1.52 0.93) | 17 — S — 461 (1.34 1.48 0.97) | 17 — S — 462 (1.03 1.49 0.96) | 17 — S — 467 (1.03 0.89 1.56) |
| 17 — S — 468 (1.22 1.19 1.26) | 17 — S — 471 (1.92 0.95 1.50) | 17 — S — 474 (1.82 1.45 1.00) | 18 — S — 27 (1.40 0.88 1.35) |
| 18 — S — 28 (1.46 1.15 1.08) | 18 — S — 29 (1.22 0.87 1.35) | 18 — S — 40 (1.04 0.87 1.35) | 18 — S — 46 (2.63 1.04 1.19) |
| 18 — S — 61 (1.37 0.86 1.37) | 18 — S — 62 (1.25 1.05 1.17) | 18 — S — 79 (1.37 1.03 1.20) | 18 — S — 80 (1.32 0.98 1.24) |
| 18 — S — 81 (1.39 1.11 1.12) | 18 — S — 82 (1.13 1.29 0.93) | 18 — S — 85 (1.88 0.84 1.39) | 18 — S — 86 (1.10 1.21 1.02) |
| 18 — S — 90 (1.76 1.31 0.91) | 18 — S — 101 (1.52 1.17 1.06) | 18 — S — 107 (2.14 1.00 1.23) | 18 — S — 110 (1.43 1.17 1.06) |

| | | | |
|---|---|---|---|
| 18 — S — 115 (1.81 1.14 1.09) | 18 — S — 123 (1.03 0.91 1.32) | 18 — S — 133 (2.14 1.29 0.94) | 18 — S — 144 (1.48 1.20 1.02) |
| 18 — S — 150 (2.96 1.16 1.06) | 18 — S — 153 (2.90 1.26 0.96) | 18 — S — 177 (1.98 0.94 1.28) | 18 — S — 183 (1.62 1.28 0.95) |
| 18 — S — 192 (2.32 1.28 0.95) | 18 — S — 218 (1.21 0.83 1.40) | 18 — S — 233 (1.75 0.81 1.41) | 18 — S — 234 (1.57 0.90 1.33) |
| 18 — S — 237 (1.58 1.19 1.03) | 18 — S — 238 (0.88 1.05 1.18) | 18 — S — 244 (1.63 0.81 1.42) | 18 — S — 246 (1.89 1.15 1.08) |
| 18 — S — 265 (1.85 1.29 0.94) | 18 — S — 266 (1.49 0.86 1.36) | 18 — S — 290 (1.49 0.90 1.33) | 18 — S — 291 (2.62 1.30 0.92) |
| 18 — S — 292 (1.96 0.96 1.26) | 18 — S — 294 (1.91 0.80 1.42) | 18 — S — 295 (1.67 1.05 1.18) | 18 — S — 296 (1.95 1.04 1.18) |
| 18 — S — 327 (1.61 1.11 1.11) | 18 — S — 341 (0.92 0.98 1.24) | 18 — S — 342 (3.37 1.32 0.90) | 18 — S — 367 (1.89 1.26 0.96) |
| 18 — S — 374 (1.07 0.89 1.34) | 18 — S — 395 (2.08 1.11 1.12) | 18 — S — 430 (1.10 1.21 1.02) | 18 — S — 435 (1.25 0.85 1.37) |
| 18 — S — 440 (1.77 1.02 1.21) | 18 — S — 441 (1.70 0.95 1.28) | 18 — S — 447 (1.71 1.13 1.09) | 18 — S — 449 (1.45 1.10 1.12) |
| 18 — S — 457 (1.30 1.01 1.21) | 18 — S — 458 (0.84 0.81 1.42) | 18 — S — 459 (1.08 1.25 0.98) | 18 — S — 461 (1.29 1.20 1.02) |
| 18 — S — 462 (0.98 1.22 1.01) | 18 — S — 468 (1.18 0.92 1.31) | 18 — S — 473 (1.92 1.29 0.93) | 18 — S — 474 (1.78 1.18 1.05) |
| 19 — S — 43 (1.08 1.45 1.66) | 19 — S — 46 (1.68 0.97 2.14) | 19 — S — 57 (1.35 1.99 1.12) | 19 — S — 70 (1.15 1.66 1.45) |
| 19 — S — 89 (0.90 1.40 1.71) | 19 — S — 90 (0.81 1.25 1.86) | 19 — S — 93 (0.88 2.14 0.97) | 19 — S — 107 (1.19 0.93 2.18) |
| 19 — S — 109 (0.99 1.46 1.65) | 19 — S — 115 (0.86 1.07 2.04) | 19 — S — 133 (1.19 1.23 1.89) | 19 — S — 150 (2.01 1.10 2.01) |
| 19 — S — 151 (1.92 1.36 1.75) | 19 — S — 152 (2.57 1.66 1.45) | 19 — S — 153 (1.95 1.20 1.91) | 19 — S — 165 (0.85 2.07 1.04) |
| 19 — S — 177 (1.03 0.88 2.23) | 19 — S — 192 (1.37 1.21 1.90) | 19 — S — 207 (0.94 1.52 1.59) | 19 — S — 215 (1.17 1.78 1.33) |
| 19 — S — 231 (1.41 1.32 1.79) | 19 — S — 246 (0.94 1.08 2.03) | 19 — S — 248 (1.00 1.63 1.48) | 19 — S — 255 (1.33 1.30 1.81) |
| 19 — S — 259 (1.18 2.12 0.99) | 19 — S — 265 (0.90 1.22 1.89) | 19 — S — 268 (0.88 1.37 1.74) | 19 — S — 269 (0.84 1.30 1.81) |
| 19 — S — 270 (0.98 1.98 1.13) | 19 — S — 271 (1.59 1.39 1.72) | 19 — S — 291 (1.67 1.24 1.87) | 19 — S — 292 (1.01 0.90 2.21) |
| 19 — S — 296 (1.00 0.98 2.13) | 19 — S — 306 (1.05 1.30 1.81) | 19 — S — 320 (1.27 1.72 1.39) | 19 — S — 324 (1.24 2.21 0.90) |
| 19 — S — 329 (0.99 1.51 1.61) | 19 — S — 342 (2.42 1.26 1.85) | 19 — S — 343 (2.94 1.75 1.36) | 19 — S — 364 (1.12 1.88 1.23) |
| 19 — S — 367 (0.94 1.20 1.91) | 19 — S — 368 (1.05 1.74 1.37) | 19 — S — 371 (2.10 1.34 1.77) | 19 — S — 395 (1.13 1.05 2.07) |
| 19 — S — 440 (0.82 0.95 2.16) | 19 — S — 451 (0.84 1.65 1.46) | 19 — S — 452 (0.90 1.30 1.81) | 19 — S — 472 (1.50 2.02 1.09) |
| 19 — S — 473 (0.97 1.23 1.88) | 19 — S — 474 (0.83 1.12 2.00) | 20 — S — 57 (0.82 1.34 1.65) | 20 — S — 125 (1.06 1.79 1.21) |
| 20 — S — 152 (2.03 1.01 1.99) | 20 — S — 250 (0.83 1.92 1.08) | 20 — S — 343 (2.41 1.10 1.90) | 20 — S — 429 (1.97 1.80 1.20) |
| 20 — S — 472 (0.97 1.38 1.62) | 21 — S — 20 (1.09 0.91 1.90) | 21 — S — 27 (1.01 1.08 1.74) | 21 — S — 28 (1.07 1.35 1.47) |
| 21 — S — 29 (0.83 1.07 1.74) | 21 — S — 36 (1.23 1.86 0.95) | 21 — S — 43 (1.65 1.71 1.10) | 21 — S — 46 (2.24 1.23 1.58) |
| 21 — S — 61 (0.98 1.05 1.76) | 21 — S — 62 (0.86 1.25 1.56) | 21 — S — 65 (0.99 0.85 1.96) | 21 — S — 79 (0.98 1.22 1.59) |
| 21 — S — 80 (0.93 1.18 1.63) | 21 — S — 81 (1.00 1.30 1.51) | 21 — S — 85 (1.49 1.03 1.78) | 21 — S — 89 (1.46 1.66 1.15) |
| 21 — S — 90 (1.37 1.51 1.30) | 21 — S — 101 (1.13 1.36 1.45) | 21 — S — 107 (1.75 1.20 1.62) | 21 — S — 108 (1.31 1.59 1.22) |
| 21 — S — 109 (1.55 1.72 1.09) | 21 — S — 110 (1.04 1.36 1.45) | 21 — S — 112 (0.94 0.86 1.95) | 21 — S — 113 (1.15 1.78 1.04) |
| 21 — S — 115 (1.42 1.34 1.48) | 21 — S — 119 (1.00 0.97 1.84) | 21 — S — 133 (1.75 1.49 1.32) | 21 — S — 144 (1.09 1.40 1.41) |
| 21 — S — 150 (2.57 1.36 1.45) | 21 — S — 151 (2.48 1.62 1.19) | 21 — S — 153 (2.51 1.46 1.35) | 21 — S — 177 (1.59 1.14 1.67) |
| 21 — S — 183 (1.23 1.48 1.34) | 21 — S — 184 (2.32 0.95 1.86) | 21 — S — 192 (1.93 1.47 1.34) | 21 — S — 198 (1.46 0.86 1.95) |
| 21 — S — 205 (0.98 0.92 1.89) | 21 — S — 206 (0.98 1.83 0.98) | 21 — S — 207 (1.50 1.78 1.03) | 21 — S — 213 (1.43 0.81 2.00) |
| 21 — S — 217 (0.85 0.85 1.97) | 21 — S — 218 (0.82 1.02 1.79) | 21 — S — 231 (1.97 1.59 1.23) | 21 — S — 233 (1.36 1.01 1.80) |
| 21 — S — 234 (1.18 1.09 1.72) | 21 — S — 237 (1.19 1.39 1.42) | 21 — S — 244 (1.24 1.00 1.81) | 21 — S — 246 (1.50 1.34 1.47) |
| 21 — S — 248 (1.56 1.89 0.92) | 21 — S — 249 (1.04 1.73 1.08) | 21 — S — 251 (1.00 1.59 1.22) | 21 — S — 255 (1.89 1.56 1.25) |
| 21 — S — 265 (1.46 1.48 1.33) | 21 — S — 266 (1.10 1.06 1.75) | 21 — S — 268 (1.44 1.63 1.18) | 21 — S — 269 (1.40 1.56 1.25) |
| 21 — S — 271 (2.15 1.65 1.16) | 21 — S — 277 (0.98 0.83 1.98) | 21 — S — 279 (1.04 0.89 1.92) | 21 — S — 290 (1.10 1.09 1.72) |
| 21 — S — 291 (2.23 1.50 1.31) | 21 — S — 292 (1.57 1.16 1.65) | 21 — S — 293 (1.07 0.97 1.84) | 21 — S — 294 (1.52 1.00 1.81) |
| 21 — S — 295 (1.28 1.24 1.57) | 21 — S — 296 (1.56 1.24 1.57) | 21 — S — 298 (1.13 0.84 1.97) | 21 — S — 305 (1.45 0.91 1.91) |
| 21 — S — 306 (1.61 1.56 1.25) | 21 — S — 307 (1.34 1.69 1.12) | 21 — S — 316 (0.93 0.90 1.91) | 21 — S — 327 (1.22 1.31 1.50) |
| 21 — S — 329 (1.55 1.77 1.05) | 21 — S — 342 (2.98 1.52 1.29) | 21 — S — 358 (0.88 0.82 1.99) | 21 — S — 367 (1.50 1.46 1.35) |
| 21 — S — 370 (0.85 0.89 1.92) | 21 — S — 371 (2.66 1.61 1.21) | 21 — S — 395 (1.69 1.31 1.51) | 21 — S — 420 (0.87 1.79 1.03) |
| 21 — S — 435 (0.86 1.05 1.76) | 21 — S — 440 (1.38 1.22 1.60) | 21 — S — 441 (1.31 1.14 1.67) | 21 — S — 447 (1.32 1.33 1.48) |
| 21 — S — 449 (1.06 1.30 1.51) | 21 — S — 451 (1.40 1.91 0.90) | 21 — S — 452 (1.46 1.56 1.25) | 21 — S — 457 (0.91 1.21 1.60) |
| 21 — S — 460 (1.19 1.64 1.17) | 21 — S — 461 (0.90 1.40 1.41) | 21 — S — 469 (0.88 1.54 1.27) | 21 — S — 471 (1.49 0.87 1.94) |
| 21 — S — 473 (1.53 1.49 1.32) | 21 — S — 474 (1.39 1.38 1.44) | 22 — S — 20 (1.62 1.25 1.38) | 22 — S — 27 (1.53 1.42 1.21) |
| 22 — S — 28 (1.60 1.68 0.94) | 22 — S — 29 (1.36 1.41 1.22) | 22 — S — 38 (0.98 0.84 1.78) | 22 — S — 40 (1.18 1.41 1.22) |
| 22 — S — 46 (2.77 1.57 1.05) | 22 — S — 56 (1.52 0.88 1.75) | 22 — S — 61 (1.51 1.39 1.23) | 22 — S — 62 (1.39 1.59 1.04) |
| 22 — S — 65 (1.52 1.19 1.44) | 22 — S — 68 (1.23 1.15 1.48) | 22 — S — 79 (1.50 1.56 1.06) | 22 — S — 80 (1.45 1.52 1.11) |
| 22 — S — 81 (1.53 1.64 0.98) | 22 — S — 83 (1.56 0.82 1.81) | 22 — S — 85 (2.02 1.37 1.25) | 22 — S — 101 (1.65 1.70 0.92) |
| 22 — S — 107 (2.28 1.53 1.09) | 22 — S — 110 (1.57 1.70 0.92) | 22 — S — 111 (2.27 0.82 1.80) | 22 — S — 112 (1.46 1.20 1.43) |
| 22 — S — 115 (1.94 1.67 0.95) | 22 — S — 118 (1.55 1.10 1.53) | 22 — S — 119 (1.53 1.31 1.31) | 22 — S — 123 (1.16 1.44 1.18) |
| 22 — S — 132 (1.49 1.02 1.61) | 22 — S — 147 (1.02 1.31 1.31) | 22 — S — 150 (3.10 1.70 0.93) | 22 — S — 154 (2.56 0.93 1.70) |
| 22 — S — 177 (2.11 1.48 1.15) | 22 — S — 184 (2.85 1.29 1.33) | 22 — S — 193 (1.37 0.97 1.65) | 22 — S — 195 (2.28 1.14 1.49) |
| 22 — S — 198 (1.99 1.20 1.43) | 22 — S — 205 (1.51 1.26 1.37) | 22 — S — 209 (1.22 0.81 1.82) | 22 — S — 213 (1.96 1.15 1.47) |

22 — S — 217 (1.38 1.18 1.44) 22 — S — 218 (1.35 1.36 1.26) 22 — S — 219 (1.15 0.92 1.71) 22 — S — 228 (0.89 0.92 1.71)
22 — S — 233 (1.88 1.35 1.28) 22 — S — 234 (1.70 1.43 1.19) 22 — S — 238 (1.01 1.58 1.04) 22 — S — 244 (1.77 1.34 1.28)
22 — S — 245 (1.69 1.11 1.51) 22 — S — 246 (2.02 1.68 0.94) 22 — S — 254 (1.52 1.04 1.59) 22 — S — 266 (1.62 1.40 1.23)
22 — S — 267 (1.42 1.10 1.53) 22 — S — 274 (1.29 0.90 1.72) 22 — S — 275 (1.10 1.32 1.30) 22 — S — 277 (1.51 1.17 1.46)
22 — S — 279 (1.56 1.23 1.39) 22 — S — 280 (1.24 0.91 1.72) 22 — S — 285 (1.29 1.11 1.51) 22 — S — 286 (1.54 1.02 1.61)
22 — S — 287 (1.35 1.03 1.60) 22 — S — 288 (1.33 0.97 1.66) 22 — S — 289 (1.59 0.80 1.82) 22 — S — 290 (1.62 1.43 1.19)
22 — S — 292 (2.09 1.50 1.13) 22 — S — 293 (1.60 1.31 1.32) 22 — S — 294 (2.05 1.34 1.29) 22 — S — 295 (1.80 1.58 1.04)
22 — S — 296 (2.08 1.58 1.05) 22 — S — 298 (1.65 1.18 1.44) 22 — S — 299 (0.91 1.52 1.10) 22 — S — 304 (1.46 1.03 1.60)
22 — S — 305 (1.97 1.24 1.38) 22 — S — 311 (1.29 0.92 1.71) 22 — S — 313 (1.17 0.96 1.67) 22 — S — 316 (1.46 1.24 1.38)
22 — S — 327 (1.75 1.65 0.98) 22 — S — 331 (1.61 0.82 1.80) 22 — S — 332 (1.46 1.00 1.63) 22 — S — 336 (1.56 0.89 1.74)
22 — S — 341 (1.06 1.52 1.11) 22 — S — 358 (1.40 1.16 1.46) 22 — S — 370 (1.37 1.23 1.40) 22 — S — 372 (1.60 0.93 1.69)
22 — S — 373 (0.99 0.94 1.69) 22 — S — 374 (1.21 1.42 1.20) 22 — S — 379 (1.28 0.93 1.70) 22 — S — 381 (0.85 1.10 1.53)
22 — S — 382 (1.35 1.11 1.52) 22 — S — 391 (1.29 0.91 1.71) 22 — S — 395 (2.22 1.65 0.98) 22 — S — 396 (1.65 1.08 1.54)
22 — S — 397 (1.45 0.93 1.70) 22 — S — 415 (1.34 0.81 1.82) 22 — S — 434 (1.30 1.22 1.41) 22 — S — 435 (1.38 1.39 1.24)
22 — S — 440 (1.91 1.55 1.07) 22 — S — 441 (1.84 1.48 1.14) 22 — S — 447 (1.85 1.67 0.96) 22 — S — 449 (1.59 1.64 0.99)
22 — S — 450 (1.21 1.30 1.32) 22 — S — 455 (1.29 1.04 1.58) 22 — S — 457 (1.43 1.55 1.08) 22 — S — 458 (0.98 1.34 1.28)
22 — S — 467 (1.12 1.15 1.48) 22 — S — 468 (1.31 1.45 1.17) 22 — S — 471 (2.01 1.21 1.41) 22 — S — 474 (1.91 1.72 0.91)
22 — S — 475 (0.85 0.84 1.79) 23 — S — 9 (1.41 0.85 2.03) 23 — S — 20 (1.51 1.40 1.49) 23 — S — 27 (1.42 1.57 1.32)
23 — S — 28 (1.49 1.83 1.05) 23 — S — 29 (1.25 1.56 1.33) 23 — S — 38 (0.87 0.99 1.89) 23 — S — 40 (1.07 1.56 1.33)
23 — S — 46 (2.66 1.72 1.16) 23 — S — 56 (1.41 1.03 1.86) 23 — S — 61 (1.40 1.54 1.34) 23 — S — 62 (1.28 1.74 1.14)
23 — S — 65 (1.41 1.34 1.55) 23 — S — 68 (1.12 1.30 1.59) 23 — S — 79 (1.39 1.71 1.17) 23 — S — 80 (1.34 1.67 1.21)
23 — S — 81 (1.42 1.79 1.09) 23 — S — 82 (1.15 1.98 0.91) 23 — S — 83 (1.45 0.97 1.92) 23 — S — 85 (1.91 1.52 1.36)
23 — S — 86 (1.12 1.89 0.99) 23 — S — 101 (1.54 1.85 1.03) 23 — S — 102 (1.17 0.86 2.03) 23 — S — 105 (1.70 0.95 1.94)
23 — S — 107 (2.17 1.69 1.20) 23 — S — 110 (1.46 1.85 1.03) 23 — S — 111 (2.16 0.97 1.91) 23 — S — 112 (1.35 1.35 1.54)
23 — S — 115 (1.83 1.83 1.06) 23 — S — 118 (1.44 1.25 1.64) 23 — S — 119 (1.42 1.46 1.42) 23 — S — 123 (1.06 1.59 1.29)
23 — S — 131 (1.47 0.92 1.96) 23 — S — 132 (1.38 1.17 1.72) 23 — S — 133 (2.17 1.98 0.91) 23 — S — 144 (1.50 1.89 1.00)
23 — S — 147 (0.91 1.46 1.42) 23 — S — 150 (2.99 1.85 1.04) 23 — S — 153 (2.92 1.95 0.93) 23 — S — 154 (2.45 1.08 1.81)
23 — S — 166 (2.18 0.91 1.98) 23 — S — 171 (1.95 0.90 1.98) 23 — S — 177 (2.00 1.63 1.26) 23 — S — 183 (1.65 1.97 0.92)
23 — S — 184 (2.74 1.44 1.44) 23 — S — 187 (1.88 0.81 2.07) 23 — S — 188 (2.32 0.85 2.03) 23 — S — 192 (2.35 1.96 0.92)
23 — S — 193 (1.26 1.12 1.76) 23 — S — 195 (2.17 1.29 1.60) 23 — S — 198 (1.88 1.35 1.54) 23 — S — 205 (1.40 1.41 1.48)
23 — S — 208 (1.36 0.88 2.01) 23 — S — 209 (1.11 0.96 1.93) 23 — S — 213 (1.85 1.30 1.58) 23 — S — 217 (1.27 1.34 1.55)
23 — S — 218 (1.24 1.51 1.37) 23 — S — 219 (1.04 1.07 1.82) 23 — S — 222 (1.15 0.92 1.97) 23 — S — 233 (1.77 1.50 1.39)
23 — S — 234 (1.59 1.58 1.30) 23 — S — 237 (1.60 1.88 1.01) 23 — S — 238 (0.90 1.74 1.15) 23 — S — 244 (1.66 1.49 1.39)
23 — S — 245 (1.58 1.27 1.62) 23 — S — 246 (1.91 1.83 1.05) 23 — S — 254 (1.41 1.19 1.70) 23 — S — 265 (1.87 1.97 0.91)
23 — S — 266 (1.51 1.55 1.34) 23 — S — 267 (1.31 1.25 1.64) 23 — S — 274 (1.18 1.05 1.83) 23 — S — 275 (0.99 1.47 1.41)
23 — S — 277 (1.40 1.32 1.57) 23 — S — 279 (1.45 1.38 1.50) 23 — S — 280 (1.13 1.06 1.83) 23 — S — 282 (1.25 0.89 2.00)
23 — S — 284 (1.03 0.89 1.99) 23 — S — 285 (1.18 1.26 1.62) 23 — S — 286 (1.43 1.17 1.72) 23 — S — 287 (1.24 1.18 1.71)
23 — S — 288 (1.22 1.12 1.77) 23 — S — 289 (1.48 0.96 1.93) 23 — S — 290 (1.51 1.58 1.30) 23 — S — 292 (1.98 1.65 1.24)
23 — S — 293 (1.49 1.46 1.43) 23 — S — 294 (1.94 1.49 1.40) 23 — S — 295 (1.70 1.73 1.15) 23 — S — 296 (1.97 1.73 1.16)
23 — S — 297 (1.28 0.86 2.03) 23 — S — 298 (1.54 1.33 1.55) 23 — S — 299 (0.80 1.67 1.21) 23 — S — 304 (1.35 1.18 1.71)
23 — S — 305 (1.86 1.40 1.49) 23 — S — 311 (1.18 1.07 1.82) 23 — S — 312 (1.28 0.94 1.95) 23 — S — 313 (1.06 1.11 1.78)
23 — S — 316 (1.35 1.39 1.49) 23 — S — 327 (1.64 1.80 1.09) 23 — S — 330 (0.97 0.80 2.08) 23 — S — 331 (1.50 0.97 1.91)
23 — S — 332 (1.35 1.15 1.74) 23 — S — 336 (1.45 1.04 1.85) 23 — S — 341 (0.95 1.67 1.22) 23 — S — 356 (1.11 0.86 2.03)
23 — S — 358 (1.29 1.31 1.57) 23 — S — 367 (1.92 1.95 0.93) 23 — S — 370 (1.26 1.38 1.50) 23 — S — 372 (1.49 1.08 1.80)
23 — S — 373 (0.88 1.09 1.80) 23 — S — 374 (1.10 1.57 1.31) 23 — S — 379 (1.17 1.08 1.81) 23 — S — 382 (1.24 1.26 1.63)
23 — S — 391 (1.18 1.06 1.82) 23 — S — 395 (2.11 1.80 1.09) 23 — S — 396 (1.54 1.23 1.65) 23 — S — 397 (1.34 1.08 1.81)
23 — S — 415 (1.23 0.96 1.92) 23 — S — 430 (1.12 1.90 0.99) 23 — S — 434 (1.19 1.37 1.52) 23 — S — 435 (1.27 1.54 1.35)
23 — S — 437 (1.45 0.91 1.97) 23 — S — 440 (1.80 1.70 1.18) 23 — S — 441 (1.73 1.63 1.25) 23 — S — 447 (1.74 1.82 1.07)
23 — S — 449 (1.48 1.79 1.10) 23 — S — 450 (1.10 1.45 1.43) 23 — S — 454 (1.19 0.92 1.96) 23 — S — 455 (1.18 1.19 1.69)
23 — S — 456 (0.87 0.91 1.98) 23 — S — 457 (1.32 1.70 1.19) 23 — S — 458 (0.87 1.49 1.39) 23 — S — 459 (1.11 1.93 0.95)
23 — S — 461 (1.32 1.89 0.99) 23 — S — 462 (1.01 1.90 0.98) 23 — S — 467 (1.01 1.30 1.59) 23 — S — 468 (1.20 1.60 1.28)
23 — S — 471 (1.90 1.36 1.52) 23 — S — 473 (1.95 1.98 0.91) 23 — S — 474 (1.80 1.87 1.02) 24 — S — 20 (1.25 0.80 1.75)
24 — S — 27 (1.16 0.97 1.58) 24 — S — 28 (1.23 1.24 1.31) 24 — S — 29 (0.99 0.96 1.59) 24 — S — 40 (0.81 0.96 1.59)
24 — S — 43 (1.80 1.60 0.94) 24 — S — 46 (2.40 1.13 1.42) 24 — S — 61 (1.14 0.94 1.60) 24 — S — 62 (1.01 1.14 1.41)
24 — S — 79 (1.13 1.12 1.43) 24 — S — 80 (1.08 1.07 1.48) 24 — S — 81 (1.16 1.20 1.35) 24 — S — 82 (0.89 1.38 1.17)
24 — S — 85 (1.65 0.93 1.62) 24 — S — 86 (0.86 1.30 1.25) 24 — S — 89 (1.62 1.55 1.00) 24 — S — 90 (1.53 1.40 1.15)
24 — S — 101 (1.28 1.25 1.29) 24 — S — 107 (1.91 1.09 1.46) 24 — S — 108 (1.47 1.48 1.07) 24 — S — 109 (1.70 1.62 0.93)
24 — S — 110 (1.20 1.25 1.29) 24 — S — 115 (1.57 1.23 1.32) 24 — S — 119 (1.15 0.86 1.68) 24 — S — 133 (1.91 1.38 1.17)

| | | | |
|---|---|---|---|
| 24 — S — 144 (1.24 1.29 1.26) | 24 — S — 150 (2.73 1.25 1.30) | 24 — S — 151 (2.64 1.51 1.04) | 24 — S — 153 (2.66 1.35 1.20) |
| 24 — S — 177 (1.74 1.03 1.52) | 24 — S — 183 (1.39 1.37 1.18) | 24 — S — 184 (2.48 0.84 1.70) | 24 — S — 192 (2.08 1.36 1.18) |
| 24 — S — 205 (1.14 0.81 1.74) | 24 — S — 218 (0.98 0.91 1.63) | 24 — S — 231 (2.13 1.48 1.07) | 24 — S — 233 (1.51 0.90 1.65) |
| 24 — S — 234 (1.33 0.98 1.57) | 24 — S — 237 (1.34 1.28 1.27) | 24 — S — 244 (1.40 0.89 1.65) | 24 — S — 246 (1.65 1.23 1.31) |
| 24 — S — 249 (1.19 1.62 0.93) | 24 — S — 251 (1.16 1.48 1.07) | 24 — S — 255 (2.04 1.45 1.10) | 24 — S — 265 (1.61 1.38 1.17) |
| 24 — S — 266 (1.25 0.95 1.60) | 24 — S — 268 (1.59 1.52 1.02) | 24 — S — 269 (1.56 1.45 1.10) | 24 — S — 271 (2.31 1.55 1.00) |
| 24 — S — 290 (1.25 0.98 1.56) | 24 — S — 291 (2.39 1.39 1.16) | 24 — S — 292 (1.72 1.05 1.50) | 24 — S — 293 (1.23 0.86 1.69) |
| 24 — S — 294 (1.68 0.89 1.66) | 24 — S — 295 (1.43 1.13 1.41) | 24 — S — 296 (1.71 1.13 1.42) | 24 — S — 306 (1.76 1.45 1.10) |
| 24 — S — 307 (1.49 1.58 0.97) | 24 — S — 327 (1.38 1.20 1.35) | 24 — S — 342 (3.13 1.41 1.14) | 24 — S — 367 (1.66 1.35 1.20) |
| 24 — S — 371 (2.82 1.50 1.05) | 24 — S — 374 (0.84 0.98 1.57) | 24 — S — 395 (1.85 1.20 1.35) | 24 — S — 430 (0.86 1.30 1.25) |
| 24 — S — 435 (1.01 0.94 1.61) | 24 — S — 440 (1.54 1.11 1.44) | 24 — S — 441 (1.47 1.03 1.51) | 24 — S — 447 (1.48 1.22 1.33) |
| 24 — S — 449 (1.22 1.19 1.36) | 24 — S — 450 (0.84 0.86 1.69) | 24 — S — 452 (1.62 1.46 1.09) | 24 — S — 457 (1.06 1.10 1.45) |
| 24 — S — 459 (0.85 1.33 1.21) | 24 — S — 460 (1.34 1.53 1.02) | 24 — S — 461 (1.06 1.29 1.26) | 24 — S — 468 (0.94 1.01 1.54) |
| 24 — S — 469 (1.03 1.44 1.11) | 24 — S — 473 (1.69 1.38 1.17) | 24 — S — 474 (1.54 1.27 1.28) | 26 — S — 9 (1.51 1.16 1.93) |
| 26 — S — 14 (0.92 0.80 2.29) | 26 — S — 19 (1.08 1.06 2.03) | 26 — S — 20 (1.61 1.71 1.38) | 26 — S — 27 (1.53 1.88 1.22) |
| 26 — S — 28 (1.59 2.14 0.95) | 26 — S — 29 (1.35 1.87 1.23) | 26 — S — 32 (0.87 0.89 2.20) | 26 — S — 33 (0.81 0.92 2.17) |
| 26 — S — 35 (0.82 0.87 2.22) | 26 — S — 38 (0.97 1.30 1.79) | 26 — S — 40 (1.17 1.87 1.23) | 26 — S — 44 (1.24 1.02 2.07) |
| 26 — S — 46 (2.76 2.03 1.06) | 26 — S — 56 (1.51 1.34 1.76) | 26 — S — 60 (0.80 0.95 2.14) | 26 — S — 61 (1.50 1.85 1.24) |
| 26 — S — 62 (1.38 2.05 1.04) | 26 — S — 65 (1.51 1.65 1.45) | 26 — S — 68 (1.22 1.61 1.48) | 26 — S — 79 (1.49 2.02 1.07) |
| 26 — S — 80 (1.45 1.98 1.11) | 26 — S — 81 (1.52 2.10 0.99) | 26 — S — 83 (1.55 1.28 1.82) | 26 — S — 85 (2.01 1.83 1.26) |
| 26 — S — 101 (1.65 2.16 0.93) | 26 — S — 102 (1.27 1.17 1.92) | 26 — S — 105 (1.81 1.26 1.83) | 26 — S — 107 (2.27 1.99 1.10) |
| 26 — S — 110 (1.56 2.16 0.93) | 26 — S — 111 (2.26 1.28 1.81) | 26 — S — 112 (1.46 1.66 1.43) | 26 — S — 114 (1.10 0.93 2.16) |
| 26 — S — 115 (1.93 2.13 0.96) | 26 — S — 118 (1.55 1.56 1.54) | 26 — S — 119 (1.52 1.77 1.32) | 26 — S — 123 (1.16 1.90 1.19) |
| 26 — S — 131 (1.57 1.23 1.86) | 26 — S — 132 (1.48 1.48 1.61) | 26 — S — 138 (0.80 1.21 1.88) | 26 — S — 147 (1.01 1.77 1.32) |
| 26 — S — 148 (1.26 1.06 2.03) | 26 — S — 150 (3.09 2.16 0.93) | 26 — S — 154 (2.56 1.39 1.70) | 26 — S — 166 (2.28 1.21 1.88) |
| 26 — S — 167 (2.14 0.90 2.19) | 26 — S — 171 (2.05 1.21 1.88) | 26 — S — 175 (1.28 0.85 2.24) | 26 — S — 177 (2.10 1.94 1.15) |
| 26 — S — 184 (2.84 1.75 1.34) | 26 — S — 187 (1.99 1.12 1.97) | 26 — S — 188 (2.42 1.16 1.93) | 26 — S — 193 (1.36 1.43 1.66) |
| 26 — S — 194 (2.22 0.88 2.22) | 26 — S — 195 (2.27 1.60 1.50) | 26 — S — 198 (1.98 1.66 1.44) | 26 — S — 205 (1.50 1.72 1.38) |
| 26 — S — 208 (1.47 1.19 1.90) | 26 — S — 209 (1.21 1.27 1.83) | 26 — S — 213 (1.95 1.61 1.48) | 26 — S — 214 (1.51 0.85 2.25) |
| 26 — S — 217 (1.37 1.64 1.45) | 26 — S — 218 (1.34 1.82 1.27) | 26 — S — 219 (1.14 1.38 1.71) | 26 — S — 222 (1.26 1.23 1.87) |
| 26 — S — 224 (0.89 0.90 2.20) | 26 — S — 228 (0.88 1.38 1.71) | 26 — S — 230 (1.19 1.05 2.04) | 26 — S — 233 (1.88 1.81 1.28) |
| 26 — S — 234 (1.70 1.89 1.20) | 26 — S — 237 (1.71 2.19 0.91) | 26 — S — 238 (1.00 2.04 1.05) | 26 — S — 243 (2.45 1.02 2.08) |
| 26 — S — 244 (1.76 1.80 1.29) | 26 — S — 245 (1.68 1.57 1.52) | 26 — S — 246 (2.02 2.14 0.95) | 26 — S — 254 (1.52 1.50 1.59) |
| 26 — S — 266 (1.61 1.86 1.23) | 26 — S — 267 (1.41 1.56 1.53) | 26 — S — 272 (1.80 0.91 2.19) | 26 — S — 274 (1.28 1.36 1.73) |
| 26 — S — 275 (1.09 1.78 1.31) | 26 — S — 277 (1.50 1.63 1.46) | 26 — S — 279 (1.55 1.69 1.40) | 26 — S — 280 (1.23 1.37 1.72) |
| 26 — S — 282 (1.35 1.20 1.90) | 26 — S — 284 (1.13 1.20 1.89) | 26 — S — 285 (1.28 1.57 1.52) | 26 — S — 286 (1.53 1.48 1.62) |
| 26 — S — 287 (1.34 1.49 1.61) | 26 — S — 288 (1.32 1.43 1.67) | 26 — S — 289 (1.58 1.26 1.83) | 26 — S — 290 (1.61 1.89 1.20) |
| 26 — S — 292 (2.09 1.96 1.14) | 26 — S — 293 (1.59 1.77 1.33) | 26 — S — 294 (2.04 1.80 1.29) | 26 — S — 295 (1.80 2.04 1.05) |
| 26 — S — 296 (2.08 2.04 1.06) | 26 — S — 297 (1.39 1.17 1.92) | 26 — S — 298 (1.64 1.64 1.45) | 26 — S — 299 (0.90 1.98 1.11) |
| 26 — S — 300 (1.65 1.04 2.05) | 26 — S — 303 (1.41 1.01 2.08) | 26 — S — 304 (1.45 1.49 1.60) | 26 — S — 305 (1.97 1.70 1.39) |
| 26 — S — 310 (1.56 1.10 1.99) | 26 — S — 311 (1.29 1.38 1.72) | 26 — S — 312 (1.39 1.25 1.84) | 26 — S — 313 (1.16 1.42 1.68) |
| 26 — S — 316 (1.45 1.70 1.39) | 26 — S — 327 (1.74 2.11 0.99) | 26 — S — 330 (1.07 1.11 1.98) | 26 — S — 331 (1.60 1.28 1.81) |
| 26 — S — 332 (1.45 1.46 1.63) | 26 — S — 336 (1.55 1.35 1.74) | 26 — S — 341 (1.05 1.98 1.12) | 26 — S — 356 (1.22 1.16 1.93) |
| 26 — S — 357 (1.91 0.91 2.18) | 26 — S — 358 (1.39 1.62 1.47) | 26 — S — 360 (0.84 1.02 2.07) | 26 — S — 370 (1.36 1.69 1.40) |
| 26 — S — 372 (1.59 1.39 1.70) | 26 — S — 373 (0.98 1.40 1.70) | 26 — S — 374 (1.20 1.88 1.21) | 26 — S — 379 (1.28 1.39 1.71) |
| 26 — S — 380 (1.12 0.80 2.29) | 26 — S — 381 (0.85 1.56 1.54) | 26 — S — 382 (1.35 1.57 1.52) | 26 — S — 391 (1.28 1.37 1.72) |
| 26 — S — 395 (2.21 2.11 0.99) | 26 — S — 396 (1.64 1.54 1.55) | 26 — S — 397 (1.44 1.39 1.71) | 26 — S — 415 (1.33 1.27 1.82) |
| 26 — S — 432 (1.46 0.88 2.21) | 26 — S — 433 (1.18 0.89 2.20) | 26 — S — 434 (1.29 1.68 1.41) | 26 — S — 435 (1.37 1.85 1.25) |
| 26 — S — 437 (1.55 1.22 1.87) | 26 — S — 440 (1.90 2.01 1.08) | 26 — S — 441 (1.83 1.94 1.15) | 26 — S — 447 (1.84 2.13 0.96) |
| 26 — S — 449 (1.58 2.10 1.00) | 26 — S — 450 (1.20 1.76 1.33) | 26 — S — 453 (1.47 1.07 2.02) | 26 — S — 454 (1.29 1.23 1.86) |
| 26 — S — 455 (1.28 1.50 1.59) | 26 — S — 456 (0.97 1.21 1.88) | 26 — S — 457 (1.43 2.01 1.08) | 26 — S — 458 (0.97 1.80 1.29) |
| 26 — S — 467 (1.11 1.61 1.48) | 26 — S — 468 (1.31 1.91 1.18) | 26 — S — 471 (2.00 1.67 1.42) | 26 — S — 474 (1.90 2.18 0.92) |
| 26 — S — 475 (0.84 1.30 1.80) | 27 — S — 57 (0.91 1.17 1.57) | 27 — S — 125 (1.15 1.62 1.12) | 27 — S — 152 (2.12 0.84 1.90) |
| 27 — S — 250 (0.91 1.75 0.99) | 27 — S — 320 (0.82 0.90 1.84) | 27 — S — 343 (2.50 0.93 1.81) | 27 — S — 429 (2.06 1.63 1.11) |
| 27 — S — 472 (1.05 1.21 1.53) | 28 — S — 57 (0.84 0.91 1.63) | 28 — S — 125 (1.08 1.35 1.18) | 28 — S — 250 (0.85 1.48 1.06) |
| 28 — S — 429 (1.99 1.36 1.18) | 28 — S — 472 (0.99 0.94 1.60) | 29 — S — 57 (1.08 1.18 1.39) | 29 — S — 70 (0.88 0.85 1.72) |
| 29 — S — 125 (1.32 1.63 0.94) | 29 — S — 152 (2.29 0.85 1.73) | 29 — S — 215 (0.90 0.97 1.60) | 29 — S — 259 (0.91 1.31 1.27) |
| 29 — S — 320 (1.00 0.91 1.67) | 29 — S — 324 (0.97 1.40 1.17) | 29 — S — 343 (2.67 0.94 1.63) | 29 — S — 364 (0.85 1.07 1.51) |

29 — S — 429 (2.23 1.64 0.94) 29 — S — 472 (1.23 1.22 1.36) 30 — S — 28 (0.83 1.06 1.71) 30 — S — 36 (0.99 1.57 1.20) 30 — S — 43 (1.40 1.43 1.34) 30 — S — 46 (2.00 0.95 1.82) 30 — S — 70 (1.47 1.64 1.13) 30 — S — 89 (1.22 1.37 1.39) 30 — S — 90 (1.13 1.22 1.54) 30 — S — 101 (0.89 1.08 1.69) 30 — S — 107 (1.51 0.91 1.86) 30 — S — 108 (1.07 1.30 1.47) 30 — S — 109 (1.30 1.44 1.33) 30 — S — 113 (0.90 1.49 1.28) 30 — S — 115 (1.17 1.05 1.72) 30 — S — 133 (1.51 1.20 1.57) 30 — S — 144 (0.84 1.11 1.66) 30 — S — 145 (0.82 1.76 1.01) 30 — S — 150 (2.33 1.07 1.69) 30 — S — 151 (2.24 1.33 1.44) 30 — S — 152 (2.88 1.63 1.14) 30 — S — 153 (2.26 1.18 1.59) 30 — S — 177 (1.34 0.85 1.91) 30 — S — 183 (0.99 1.19 1.58) 30 — S — 192 (1.69 1.19 1.58) 30 — S — 207 (1.26 1.49 1.28) 30 — S — 215 (1.49 1.76 1.01) 30 — S — 231 (1.73 1.30 1.47) 30 — S — 234 (0.94 0.81 1.96) 30 — S — 237 (0.95 1.10 1.67) 30 — S — 246 (1.25 1.06 1.71) 30 — S — 248 (1.32 1.60 1.16) 30 — S — 255 (1.65 1.27 1.49) 30 — S — 265 (1.22 1.20 1.57) 30 — S — 268 (1.19 1.35 1.42) 30 — S — 269 (1.16 1.28 1.49) 30 — S — 271 (1.91 1.37 1.40) 30 — S — 290 (0.85 0.81 1.96) 30 — S — 291 (1.99 1.21 1.56) 30 — S — 292 (1.32 0.87 1.90) 30 — S — 295 (1.04 0.96 1.81) 30 — S — 296 (1.31 0.95 1.82) 30 — S — 306 (1.36 1.27 1.50) 30 — S — 307 (1.09 1.40 1.37) 30 — S — 320 (1.58 1.69 1.08) 30 — S — 327 (0.98 1.02 1.75) 30 — S — 329 (1.31 1.48 1.29) 30 — S — 342 (2.73 1.23 1.54) 30 — S — 343 (3.26 1.72 1.05) 30 — S — 364 (1.44 1.85 0.92) 30 — S — 367 (1.26 1.18 1.59) 30 — S — 368 (1.37 1.72 1.05) 30 — S — 371 (2.42 1.32 1.45) 30 — S — 395 (1.45 1.02 1.75) 30 — S — 440 (1.14 0.93 1.84) 30 — S — 441 (1.07 0.86 1.91) 30 — S — 447 (1.08 1.04 1.73) 30 — S — 449 (0.82 1.01 1.76) 30 — S — 451 (1.16 1.62 1.15) 30 — S — 452 (1.22 1.28 1.49) 30 — S — 460 (0.94 1.35 1.41) 30 — S — 463 (1.09 1.73 1.04) 30 — S — 473 (1.29 1.20 1.57) 30 — S — 474 (1.14 1.09 1.68) 31 — S — 28 (0.81 1.11 1.73) 31 — S — 36 (0.97 1.62 1.21) 31 — S — 37 (0.97 1.92 0.91) 31 — S — 43 (1.39 1.47 1.36) 31 — S — 46 (1.98 0.99 1.84) 31 — S — 70 (1.45 1.68 1.15) 31 — S — 89 (1.20 1.42 1.41) 31 — S — 90 (1.11 1.27 1.56) 31 — S — 101 (0.87 1.12 1.71) 31 — S — 107 (1.49 0.96 1.87) 31 — S — 108 (1.05 1.35 1.48) 31 — S — 109 (1.29 1.48 1.35) 31 — S — 113 (0.89 1.54 1.29) 31 — S — 115 (1.16 1.10 1.73) 31 — S — 133 (1.49 1.25 1.58) 31 — S — 144 (0.83 1.16 1.67) 31 — S — 145 (0.81 1.81 1.02) 31 — S — 150 (2.31 1.12 1.71) 31 — S — 151 (2.22 1.38 1.45) 31 — S — 152 (2.87 1.68 1.15) 31 — S — 153 (2.25 1.22 1.61) 31 — S — 177 (1.33 0.90 1.93) 31 — S — 183 (0.98 1.24 1.59) 31 — S — 192 (1.67 1.23 1.60) 31 — S — 207 (1.24 1.54 1.29) 31 — S — 215 (1.47 1.80 1.03) 31 — S — 231 (1.71 1.35 1.49) 31 — S — 234 (0.92 0.85 1.98) 31 — S — 237 (0.93 1.15 1.68) 31 — S — 246 (1.24 1.10 1.73) 31 — S — 248 (1.30 1.65 1.18) 31 — S — 255 (1.63 1.32 1.51) 31 — S — 265 (1.20 1.24 1.59) 31 — S — 266 (0.84 0.82 2.01) 31 — S — 268 (1.18 1.39 1.44) 31 — S — 269 (1.14 1.32 1.51) 31 — S — 271 (1.89 1.41 1.42) 31 — S — 290 (0.84 0.85 1.98) 31 — S — 291 (1.97 1.26 1.57) 31 — S — 292 (1.31 0.92 1.91) 31 — S — 295 (1.02 1.00 1.83) 31 — S — 296 (1.30 1.00 1.83) 31 — S — 306 (1.35 1.32 1.51) 31 — S — 307 (1.08 1.45 1.38) 31 — S — 320 (1.57 1.74 1.09) 31 — S — 327 (0.96 1.07 1.76) 31 — S — 329 (1.29 1.53 1.30) 31 — S — 342 (2.72 1.28 1.55) 31 — S — 343 (3.25 1.77 1.06) 31 — S — 364 (1.43 1.90 0.93) 31 — S — 367 (1.24 1.22 1.61) 31 — S — 368 (1.36 1.76 1.07) 31 — S — 371 (2.40 1.37 1.46) 31 — S — 395 (1.44 1.07 1.76) 31 — S — 440 (1.12 0.98 1.86) 31 — S — 441 (1.05 0.90 1.93) 31 — S — 447 (1.06 1.09 1.74) 31 — S — 449 (0.80 1.06 1.77) 31 — S — 451 (1.15 1.67 1.16) 31 — S — 452 (1.20 1.32 1.51) 31 — S — 460 (0.93 1.40 1.43) 31 — S — 463 (1.08 1.77 1.06) 31 — S — 473 (1.27 1.25 1.58) 31 — S — 474 (1.13 1.14 1.69) 32 — S — 36 (0.88 1.77 1.30) 32 — S — 37 (0.88 2.07 1.00) 32 — S — 43 (1.30 1.62 1.45) 32 — S — 46 (1.89 1.14 1.93) 32 — S — 57 (1.57 2.16 0.91) 32 — S — 70 (1.36 1.83 1.24) 32 — S — 85 (1.14 0.94 2.13) 32 — S — 89 (1.12 1.57 1.50) 32 — S — 90 (1.03 1.42 1.65) 32 — S — 107 (1.40 1.11 1.96) 32 — S — 108 (0.96 1.50 1.57) 32 — S — 109 (1.20 1.63 1.44) 32 — S — 115 (1.07 1.25 1.82) 32 — S — 133 (1.41 1.40 1.67) 32 — S — 150 (2.23 1.27 1.80) 32 — S — 151 (2.13 1.53 1.54) 32 — S — 152 (2.78 1.83 1.24) 32 — S — 153 (2.16 1.37 1.70) 32 — S — 177 (1.24 1.05 2.02) 32 — S — 183 (0.89 1.39 1.68) 32 — S — 184 (1.97 0.86 2.21) 32 — S — 192 (1.58 1.38 1.69) 32 — S — 207 (1.15 1.69 1.38) 32 — S — 215 (1.38 1.95 1.12) 32 — S — 231 (1.62 1.50 1.57) 32 — S — 233 (1.01 0.92 2.15) 32 — S — 234 (0.83 1.00 2.07) 32 — S — 237 (0.84 1.30 1.77) 32 — S — 244 (0.90 0.91 2.16) 32 — S — 246 (1.15 1.25 1.82) 32 — S — 248 (1.22 1.80 1.27) 32 — S — 255 (1.54 1.47 1.60) 32 — S — 265 (1.11 1.39 1.68) 32 — S — 268 (1.09 1.54 1.53) 32 — S — 269 (1.05 1.47 1.60) 32 — S — 270 (1.19 2.15 0.92) 32 — S — 271 (1.80 1.56 1.51) 32 — S — 291 (1.89 1.41 1.66) 32 — S — 292 (1.22 1.07 2.00) 32 — S — 294 (1.18 0.91 2.16) 32 — S — 295 (0.93 1.15 1.92) 32 — S — 296 (1.21 1.15 1.92) 32 — S — 305 (1.10 0.82 2.25) 32 — S — 306 (1.26 1.47 1.60) 32 — S — 307 (0.99 1.60 1.47) 32 — S — 320 (1.48 1.89 1.18) 32 — S — 327 (0.87 1.22 1.85) 32 — S — 329 (1.20 1.68 1.39) 32 — S — 342 (2.63 1.43 1.64) 32 — S — 343 (3.16 1.92 1.15) 32 — S — 364 (1.34 2.05 1.02) 32 — S — 367 (1.15 1.37 1.70) 32 — S — 368 (1.27 1.91 1.16) 32 — S — 371 (2.32 1.52 1.55) 32 — S — 395 (1.35 1.22 1.85) 32 — S — 440 (1.03 1.13 1.94) 32 — S — 441 (0.96 1.05 2.02) 32 — S — 447 (0.97 1.24 1.83) 32 — S — 451 (1.06 1.82 1.25) 32 — S — 452 (1.11 1.47 1.60) 32 — S — 460 (0.84 1.55 1.52) 32 — S — 463 (0.99 1.92 1.15) 32 — S — 473 (1.18 1.40 1.67) 32 — S — 474 (1.04 1.29 1.78) 33 — S — 36 (0.94 1.73 1.25) 33 — S — 37 (0.93 2.03 0.95) 33 — S — 43 (1.35 1.59 1.39) 33 — S — 46 (1.95 1.11 1.87) 33 — S — 70 (1.42 1.80 1.18) 33 — S — 85 (1.20 0.91 2.07) 33 — S — 89 (1.17 1.54 1.44) 33 — S — 90 (1.08 1.39 1.59) 33 — S — 101 (0.84 1.24 1.74) 33 — S — 107 (1.46 1.07 1.91) 33 — S — 108 (1.02 1.46 1.52) 33 — S — 109 (1.25 1.60 1.38) 33 — S — 113 (0.85 1.65 1.33) 33 — S — 115 (1.12 1.21 1.77) 33 — S — 133 (1.46 1.36 1.62) 33 — S — 150 (2.28 1.24 1.74) 33 — S — 151 (2.19 1.49 1.49) 33 — S — 152 (2.83 1.79 1.19) 33 — S — 153 (2.21 1.34 1.64) 33 — S — 177 (1.29 1.02 1.96) 33 — S — 183 (0.94 1.35 1.63) 33 — S — 184 (2.03 0.83 2.15) 33 — S — 192 (1.64 1.35 1.63) 33 — S — 207 (1.21 1.65 1.33) 33 — S — 215 (1.44 1.92 1.06) 33 — S — 231 (1.68 1.46 1.52) 33 — S — 233 (1.07 0.89 2.09) 33 — S — 234 (0.89 0.97 2.01) 33 — S — 237 (0.90 1.26 1.72) 33 — S — 244 (0.95 0.88 2.10) 33 — S — 246 (1.20 1.22 1.76) 33 — S — 248 (1.27 1.77 1.21) 33 — S — 255 (1.60 1.44 1.54) 33 — S — 265 (1.17 1.36 1.62) 33 — S — 266 (0.80 0.94 2.04) 33 — S — 268 (1.15 1.51 1.47) 33 — S — 269 (1.11 1.44 1.54) 33 — S — 271 (1.86 1.53 1.45) 33 — S — 290 (0.80 0.97 2.01) 33 — S — 291 (1.94 1.37 1.61)

33 — S — 292 (1.27 1.03 1.95) 33 — S — 294 (1.23 0.87 2.11) 33 — S — 295 (0.99 1.12 1.86) 33 — S — 296 (1.26 1.11 1.87)
33 — S — 306 (1.32 1.44 1.54) 33 — S — 307 (1.04 1.56 1.42) 33 — S — 320 (1.54 1.85 1.13) 33 — S — 327 (0.93 1.18 1.80)
33 — S — 329 (1.26 1.64 1.34) 33 — S — 342 (2.68 1.39 1.59) 33 — S — 343 (3.21 1.88 1.10) 33 — S — 364 (1.39 2.01 0.97)
33 — S — 367 (1.21 1.34 1.64) 33 — S — 368 (1.32 1.88 1.10) 33 — S — 371 (2.37 1.48 1.50) 33 — S — 395 (1.40 1.18 1.80)
33 — S — 440 (1.09 1.09 1.89) 33 — S — 441 (1.02 1.02 1.96) 33 — S — 447 (1.03 1.20 1.78) 33 — S — 451 (1.11 1.78 1.20)
33 — S — 452 (1.17 1.44 1.54) 33 — S — 460 (0.89 1.52 1.46) 33 — S — 463 (1.04 1.89 1.09) 33 — S — 473 (1.24 1.36 1.62)
33 — S — 474 (1.09 1.25 1.73) 34 — S — 27 (0.84 0.96 1.91) 34 — S — 28 (0.90 1.23 1.64) 34 — S — 36 (1.06 1.74 1.12)
34 — S — 43 (1.48 1.60 1.27) 34 — S — 46 (2.07 1.12 1.75) 34 — S — 61 (0.81 0.94 1.93) 34 — S — 70 (1.54 1.81 1.06)
34 — S — 79 (0.81 1.11 1.76) 34 — S — 81 (0.83 1.19 1.68) 34 — S — 85 (1.32 0.92 1.95) 34 — S — 89 (1.29 1.54 1.32)
34 — S — 90 (1.20 1.39 1.47) 34 — S — 101 (0.96 1.25 1.62) 34 — S — 107 (1.58 1.08 1.79) 34 — S — 108 (1.14 1.47 1.39)
34 — S — 109 (1.38 1.61 1.26) 34 — S — 110 (0.87 1.25 1.62) 34 — S — 113 (0.98 1.66 1.20) 34 — S — 115 (1.25 1.22 1.65)
34 — S — 119 (0.83 0.86 2.01) 34 — S — 133 (1.58 1.37 1.49) 34 — S — 144 (0.92 1.28 1.58) 34 — S — 145 (0.90 1.93 0.93)
34 — S — 150 (2.40 1.24 1.62) 34 — S — 151 (2.31 1.50 1.36) 34 — S — 152 (2.96 1.80 1.06) 34 — S — 153 (2.34 1.34 1.52)
34 — S — 177 (1.42 1.02 1.84) 34 — S — 183 (1.06 1.36 1.51) 34 — S — 184 (2.15 0.84 2.03) 34 — S — 192 (1.76 1.36 1.51)
34 — S — 205 (0.81 0.80 2.06) 34 — S — 206 (0.81 1.71 1.15) 34 — S — 207 (1.33 1.66 1.20) 34 — S — 215 (1.56 1.93 0.94)
34 — S — 231 (1.80 1.47 1.40) 34 — S — 233 (1.19 0.89 1.97) 34 — S — 234 (1.01 0.98 1.89) 34 — S — 237 (1.02 1.27 1.59)
34 — S — 244 (1.07 0.89 1.98) 34 — S — 246 (1.33 1.23 1.64) 34 — S — 248 (1.39 1.77 1.09) 34 — S — 249 (0.87 1.62 1.25)
34 — S — 251 (0.83 1.47 1.39) 34 — S — 255 (1.72 1.44 1.42) 34 — S — 260 (0.84 1.89 0.97) 34 — S — 265 (1.29 1.37 1.50)
34 — S — 266 (0.93 0.94 1.92) 34 — S — 268 (1.27 1.52 1.35) 34 — S — 269 (1.23 1.44 1.42) 34 — S — 271 (1.98 1.54 1.33)
34 — S — 290 (0.93 0.98 1.89) 34 — S — 291 (2.06 1.38 1.48) 34 — S — 292 (1.40 1.04 1.82) 34 — S — 293 (0.90 0.85 2.01)
34 — S — 294 (1.36 0.88 1.98) 34 — S — 295 (1.11 1.13 1.74) 34 — S — 296 (1.39 1.12 1.74) 34 — S — 306 (1.44 1.44 1.42)
34 — S — 307 (1.17 1.57 1.29) 34 — S — 320 (1.66 1.86 1.00) 34 — S — 327 (1.05 1.19 1.67) 34 — S — 329 (1.38 1.65 1.22)
34 — S — 342 (2.81 1.40 1.46) 34 — S — 343 (3.34 1.89 0.97) 34 — S — 367 (1.33 1.34 1.52) 34 — S — 368 (1.44 1.89 0.98)
34 — S — 371 (2.49 1.49 1.38) 34 — S — 395 (1.52 1.19 1.68) 34 — S — 440 (1.21 1.10 1.77) 34 — S — 441 (1.14 1.03 1.84)
34 — S — 447 (1.15 1.21 1.65) 34 — S — 449 (0.89 1.18 1.68) 34 — S — 451 (1.23 1.79 1.07) 34 — S — 452 (1.29 1.45 1.42)
34 — S — 460 (1.02 1.52 1.34) 34 — S — 463 (1.17 1.89 0.97) 34 — S — 473 (1.36 1.37 1.49) 34 — S — 474 (1.22 1.26 1.61)
35 — S — 36 (0.92 1.79 1.26) 35 — S — 37 (0.92 2.09 0.96) 35 — S — 43 (1.34 1.64 1.41) 35 — S — 46 (1.93 1.16 1.89)
35 — S — 70 (1.40 1.85 1.20) 35 — S — 85 (1.18 0.97 2.08) 35 — S — 89 (1.16 1.59 1.46) 35 — S — 90 (1.07 1.44 1.61)
35 — S — 101 (0.82 1.29 1.76) 35 — S — 107 (1.44 1.13 1.92) 35 — S — 108 (1.00 1.52 1.53) 35 — S — 109 (1.24 1.65 1.40)
35 — S — 113 (0.84 1.71 1.34) 35 — S — 115 (1.11 1.27 1.78) 35 — S — 133 (1.45 1.42 1.63) 35 — S — 150 (2.27 1.29 1.76)
35 — S — 151 (2.17 1.55 1.50) 35 — S — 152 (2.82 1.85 1.20) 35 — S — 153 (2.20 1.39 1.66) 35 — S — 177 (1.28 1.07 1.98)
35 — S — 183 (0.93 1.41 1.64) 35 — S — 184 (2.02 0.88 2.17) 35 — S — 192 (1.62 1.40 1.65) 35 — S — 207 (1.19 1.71 1.34)
35 — S — 215 (1.42 1.97 1.08) 35 — S — 231 (1.67 1.52 1.53) 35 — S — 233 (1.05 0.94 2.11) 35 — S — 234 (0.87 1.02 2.03)
35 — S — 237 (0.88 1.32 1.73) 35 — S — 244 (0.94 0.93 2.12) 35 — S — 246 (1.19 1.27 1.78) 35 — S — 248 (1.26 1.82 1.23)
35 — S — 255 (1.58 1.49 1.56) 35 — S — 265 (1.15 1.41 1.64) 35 — S — 268 (1.13 1.56 1.49) 35 — S — 269 (1.10 1.49 1.56)
35 — S — 271 (1.84 1.58 1.47) 35 — S — 291 (1.93 1.43 1.62) 35 — S — 292 (1.26 1.09 1.96) 35 — S — 294 (1.22 0.93 2.12)
35 — S — 295 (0.97 1.17 1.88) 35 — S — 296 (1.25 1.17 1.88) 35 — S — 305 (1.14 0.84 2.21) 35 — S — 306 (1.30 1.49 1.56)
35 — S — 307 (1.03 1.62 1.43) 35 — S — 320 (1.52 1.91 1.14) 35 — S — 327 (0.91 1.24 1.81) 35 — S — 329 (1.24 1.70 1.35)
35 — S — 342 (2.67 1.45 1.60) 35 — S — 343 (3.20 1.94 1.11) 35 — S — 364 (1.38 2.07 0.98) 35 — S — 367 (1.20 1.39 1.66)
35 — S — 368 (1.31 1.93 1.11) 35 — S — 371 (2.36 1.54 1.51) 35 — S — 395 (1.39 1.24 1.81) 35 — S — 440 (1.07 1.15 1.90)
35 — S — 441 (1.00 1.07 1.98) 35 — S — 447 (1.01 1.26 1.79) 35 — S — 451 (1.10 1.84 1.21) 35 — S — 452 (1.15 1.50 1.55)
35 — S — 460 (0.88 1.57 1.48) 35 — S — 463 (1.03 1.94 1.11) 35 — S — 471 (1.18 0.80 2.24) 35 — S — 473 (1.23 1.42 1.63)
35 — S — 474 (1.08 1.31 1.74) 36 — S — 125 (0.92 0.84 1.34) 36 — S — 429 (1.84 0.85 1.33) 38 — S — 43 (1.20 1.21 1.55)
38 — S — 57 (1.46 1.75 1.01) 38 — S — 70 (1.26 1.42 1.34) 38 — S — 89 (1.01 1.16 1.60) 38 — S — 90 (0.92 1.01 1.75)
38 — S — 108 (0.86 1.08 1.67) 38 — S — 109 (1.10 1.22 1.54) 38 — S — 115 (0.97 0.83 1.93) 38 — S — 133 (1.30 0.98 1.77)
38 — S — 150 (2.12 0.86 1.90) 38 — S — 151 (2.03 1.12 1.64) 38 — S — 152 (2.68 1.41 1.34) 38 — S — 153 (2.06 0.96 1.80)
38 — S — 165 (0.97 1.83 0.93) 38 — S — 192 (1.48 0.97 1.79) 38 — S — 207 (1.05 1.27 1.48) 38 — S — 215 (1.28 1.54 1.22)
38 — S — 231 (1.52 1.08 1.68) 38 — S — 246 (1.05 0.84 1.92) 38 — S — 248 (1.11 1.39 1.37) 38 — S — 255 (1.44 1.06 1.70)
38 — S — 265 (1.01 0.98 1.78) 38 — S — 268 (0.99 1.13 1.63) 38 — S — 269 (0.95 1.06 1.70) 38 — S — 270 (1.09 1.74 1.02)
38 — S — 271 (1.70 1.15 1.61) 38 — S — 291 (1.78 0.99 1.76) 38 — S — 306 (1.16 1.06 1.70) 38 — S — 307 (0.89 1.19 1.57)
38 — S — 320 (1.38 1.48 1.28) 38 — S — 329 (1.10 1.26 1.49) 38 — S — 342 (2.53 1.01 1.74) 38 — S — 343 (3.06 1.51 1.25)
38 — S — 364 (1.24 1.64 1.12) 38 — S — 367 (1.05 0.96 1.80) 38 — S — 368 (1.16 1.50 1.26) 38 — S — 371 (2.21 1.10 1.66)
38 — S — 395 (1.25 0.80 1.95) 38 — S — 447 (0.87 0.83 1.93) 38 — S — 451 (0.95 1.40 1.35) 38 — S — 452 (1.01 1.06 1.70)
38 — S — 463 (0.89 1.51 1.25) 38 — S — 472 (1.61 1.78 0.98) 38 — S — 473 (1.08 0.98 1.77) 38 — S — 474 (0.94 0.87 1.88)
39 — S — 9 (1.12 1.04 2.32) 39 — S — 20 (1.22 1.58 1.78) 39 — S — 27 (1.13 1.75 1.61) 39 — S — 28 (1.20 2.02 1.34)
39 — S — 29 (0.96 1.74 1.62) 39 — S — 43 (1.77 2.38 0.97) 39 — S — 44 (0.85 0.90 2.46) 39 — S — 46 (2.37 1.90 1.45)
39 — S — 56 (1.12 1.21 2.15) 39 — S — 61 (1.11 1.72 1.63) 39 — S — 62 (0.99 1.92 1.43) 39 — S — 65 (1.12 1.52 1.84)
39 — S — 68 (0.83 1.48 1.88) 39 — S — 79 (1.10 1.89 1.46) 39 — S — 80 (1.06 1.85 1.50) 39 — S — 81 (1.13 1.98 1.38)

| | | | |
|---|---|---|---|
| 39 — S — 82 (0.86 2.16 1.19) | 39 — S — 83 (1.16 1.15 2.21) | 39 — S — 85 (1.62 1.71 1.65) | 39 — S — 86 (0.83 2.08 1.28) |
| 39 — S — 89 (1.59 2.33 1.02) | 39 — S — 90 (1.50 2.18 1.17) | 39 — S — 101 (1.26 2.03 1.32) | 39 — S — 102 (0.88 1.04 2.31) |
| 39 — S — 105 (1.42 1.13 2.23) | 39 — S — 107 (1.88 1.87 1.49) | 39 — S — 108 (1.44 2.26 1.10) | 39 — S — 109 (1.67 2.39 0.96) |
| 39 — S — 110 (1.17 2.03 1.32) | 39 — S — 111 (1.87 1.15 2.20) | 39 — S — 112 (1.06 1.53 1.83) | 39 — S — 113 (1.27 2.45 0.91) |
| 39 — S — 115 (1.54 2.01 1.35) | 39 — S — 118 (1.15 1.43 1.93) | 39 — S — 119 (1.13 1.64 1.71) | 39 — S — 131 (1.18 1.11 2.25) |
| 39 — S — 132 (1.09 1.35 2.01) | 39 — S — 133 (1.88 2.16 1.20) | 39 — S — 144 (1.21 2.07 1.29) | 39 — S — 148 (0.87 0.94 2.42) |
| 39 — S — 150 (2.70 2.03 1.32) | 39 — S — 151 (2.61 2.29 1.07) | 39 — S — 153 (2.63 2.13 1.22) | 39 — S — 154 (2.17 1.26 2.10) |
| 39 — S — 166 (1.89 1.09 2.27) | 39 — S — 171 (1.66 1.08 2.27) | 39 — S — 177 (1.71 1.81 1.54) | 39 — S — 183 (1.36 2.15 1.21) |
| 39 — S — 184 (2.45 1.62 1.73) | 39 — S — 187 (1.59 1.00 2.36) | 39 — S — 188 (2.03 1.04 2.32) | 39 — S — 192 (2.06 2.14 1.21) |
| 39 — S — 193 (0.97 1.31 2.05) | 39 — S — 195 (1.88 1.47 1.89) | 39 — S — 198 (1.59 1.53 1.83) | 39 — S — 205 (1.11 1.59 1.77) |
| 39 — S — 207 (1.63 2.45 0.91) | 39 — S — 208 (1.07 1.06 2.30) | 39 — S — 209 (0.82 1.14 2.22) | 39 — S — 213 (1.56 1.48 1.87) |
| 39 — S — 217 (0.98 1.52 1.84) | 39 — S — 218 (0.95 1.69 1.66) | 39 — S — 222 (0.86 1.10 2.26) | 39 — S — 231 (2.10 2.26 1.10) |
| 39 — S — 233 (1.48 1.68 1.68) | 39 — S — 234 (1.30 1.76 1.59) | 39 — S — 237 (1.32 2.06 1.30) | 39 — S — 243 (2.05 0.89 2.47) |
| 39 — S — 244 (1.37 1.67 1.68) | 39 — S — 245 (1.29 1.45 1.91) | 39 — S — 246 (1.62 2.01 1.34) | 39 — S — 249 (1.16 2.40 0.95) |
| 39 — S — 251 (1.13 2.26 1.10) | 39 — S — 254 (1.12 1.37 1.99) | 39 — S — 255 (2.02 2.23 1.12) | 39 — S — 265 (1.59 2.15 1.20) |
| 39 — S — 266 (1.22 1.73 1.62) | 39 — S — 267 (1.02 1.43 1.92) | 39 — S — 268 (1.56 2.30 1.05) | 39 — S — 269 (1.53 2.23 1.12) |
| 39 — S — 271 (2.28 2.32 1.03) | 39 — S — 274 (0.89 1.23 2.12) | 39 — S — 277 (1.11 1.50 1.86) | 39 — S — 279 (1.16 1.56 1.79) |
| 39 — S — 280 (0.84 1.24 2.11) | 39 — S — 282 (0.96 1.07 2.29) | 39 — S — 285 (0.89 1.44 1.91) | 39 — S — 286 (1.14 1.35 2.01) |
| 39 — S — 287 (0.95 1.36 2.00) | 39 — S — 288 (0.93 1.30 2.06) | 39 — S — 289 (1.19 1.14 2.22) | 39 — S — 290 (1.22 1.76 1.59) |
| 39 — S — 291 (2.36 2.17 1.19) | 39 — S — 292 (1.69 1.83 1.53) | 39 — S — 293 (1.20 1.64 1.72) | 39 — S — 294 (1.65 1.67 1.69) |
| 39 — S — 295 (1.41 1.91 1.44) | 39 — S — 296 (1.68 1.91 1.45) | 39 — S — 297 (1.00 1.04 2.32) | 39 — S — 298 (1.25 1.51 1.84) |
| 39 — S — 300 (1.26 0.91 2.44) | 39 — S — 303 (1.02 0.89 2.47) | 39 — S — 304 (1.06 1.36 2.00) | 39 — S — 305 (1.57 1.58 1.78) |
| 39 — S — 306 (1.73 2.23 1.13) | 39 — S — 307 (1.46 2.36 1.00) | 39 — S — 310 (1.17 0.97 2.38) | 39 — S — 311 (0.90 1.25 2.11) |
| 39 — S — 312 (0.99 1.12 2.24) | 39 — S — 316 (1.06 1.58 1.78) | 39 — S — 327 (1.35 1.98 1.38) | 39 — S — 329 (1.68 2.44 0.92) |
| 39 — S — 331 (1.21 1.16 2.20) | 39 — S — 332 (1.06 1.33 2.03) | 39 — S — 336 (1.16 1.22 2.14) | 39 — S — 342 (3.10 2.19 1.17) |
| 39 — S — 356 (0.83 1.04 2.32) | 39 — S — 358 (1.00 1.50 1.86) | 39 — S — 367 (1.63 2.13 1.22) | 39 — S — 370 (0.97 1.56 1.79) |
| 39 — S — 371 (2.79 2.28 1.08) | 39 — S — 372 (1.20 1.26 2.09) | 39 — S — 374 (0.81 1.76 1.60) | 39 — S — 379 (0.88 1.26 2.10) |
| 39 — S — 382 (0.95 1.44 1.92) | 39 — S — 391 (0.89 1.25 2.11) | 39 — S — 395 (1.82 1.98 1.38) | 39 — S — 396 (1.25 1.42 1.94) |
| 39 — S — 397 (1.05 1.26 2.10) | 39 — S — 415 (0.94 1.14 2.21) | 39 — S — 430 (0.83 2.08 1.28) | 39 — S — 434 (0.90 1.55 1.81) |
| 39 — S — 435 (0.98 1.72 1.64) | 39 — S — 437 (1.16 1.10 2.26) | 39 — S — 440 (1.51 1.89 1.47) | 39 — S — 441 (1.44 1.81 1.54) |
| 39 — S — 443 (0.91 2.43 0.93) | 39 — S — 447 (1.45 2.00 1.36) | 39 — S — 449 (1.19 1.97 1.39) | 39 — S — 450 (0.81 1.64 1.72) |
| 39 — S — 452 (1.59 2.24 1.12) | 39 — S — 453 (1.08 0.94 2.42) | 39 — S — 454 (0.90 1.11 2.25) | 39 — S — 455 (0.89 1.38 1.98) |
| 39 — S — 457 (1.03 1.88 1.48) | 39 — S — 459 (0.82 2.11 1.24) | 39 — S — 460 (1.31 2.31 1.04) | 39 — S — 461 (1.03 2.07 1.28) |
| 39 — S — 468 (0.91 1.79 1.57) | 39 — S — 469 (1.01 2.21 1.14) | 39 — S — 471 (1.61 1.54 1.81) | 39 — S — 473 (1.66 2.16 1.20) |
| 39 — S — 474 (1.51 2.05 1.31) | 40 — S — 57 (1.26 1.18 1.21) | 40 — S — 70 (1.06 0.85 1.54) | 40 — S — 152 (2.47 0.85 1.55) |
| 40 — S — 215 (1.08 0.97 1.42) | 40 — S — 247 (0.98 1.48 0.92) | 40 — S — 248 (0.91 0.82 1.58) | 40 — S — 259 (1.09 1.31 1.09) |
| 40 — S — 270 (0.89 1.17 1.23) | 40 — S — 320 (1.17 0.91 1.49) | 40 — S — 324 (1.15 1.40 0.99) | 40 — S — 343 (2.85 0.94 1.46) |
| 40 — S — 364 (1.03 1.07 1.33) | 40 — S — 368 (0.96 0.94 1.46) | 40 — S — 472 (1.41 1.22 1.18) | 41 — S — 9 (1.43 0.88 2.01) |
| 41 — S — 20 (1.53 1.43 1.46) | 41 — S — 27 (1.45 1.60 1.30) | 41 — S — 28 (1.51 1.87 1.03) | 41 — S — 29 (1.27 1.59 1.30) |
| 41 — S — 38 (0.89 1.02 1.87) | 41 — S — 40 (1.09 1.59 1.30) | 41 — S — 46 (2.68 1.75 1.14) | 41 — S — 56 (1.44 1.06 1.83) |
| 41 — S — 61 (1.42 1.57 1.32) | 41 — S — 62 (1.30 1.77 1.12) | 41 — S — 65 (1.43 1.37 1.53) | 41 — S — 68 (1.14 1.33 1.56) |
| 41 — S — 79 (1.42 1.74 1.15) | 41 — S — 80 (1.37 1.70 1.19) | 41 — S — 81 (1.44 1.82 1.07) | 41 — S — 83 (1.48 1.00 1.89) |
| 41 — S — 85 (1.93 1.55 1.34) | 41 — S — 86 (1.15 1.92 0.97) | 41 — S — 101 (1.57 1.88 1.01) | 41 — S — 102 (1.19 0.89 2.00) |
| 41 — S — 105 (1.73 0.98 1.91) | 41 — S — 107 (2.19 1.72 1.18) | 41 — S — 110 (1.48 1.88 1.01) | 41 — S — 111 (2.18 1.00 1.89) |
| 41 — S — 112 (1.38 1.38 1.51) | 41 — S — 115 (1.86 1.86 1.04) | 41 — S — 118 (1.47 1.28 1.61) | 41 — S — 119 (1.44 1.49 1.40) |
| 41 — S — 123 (1.08 1.62 1.27) | 41 — S — 131 (1.49 0.95 1.94) | 41 — S — 132 (1.40 1.20 1.69) | 41 — S — 144 (1.53 1.92 0.97) |
| 41 — S — 147 (0.93 1.49 1.40) | 41 — S — 150 (3.01 1.88 1.01) | 41 — S — 153 (2.95 1.98 0.91) | 41 — S — 154 (2.48 1.11 1.78) |
| 41 — S — 166 (2.20 0.94 1.96) | 41 — S — 171 (1.97 0.93 1.96) | 41 — S — 177 (2.03 1.66 1.23) | 41 — S — 184 (2.76 1.47 1.42) |
| 41 — S — 187 (1.91 0.84 2.05) | 41 — S — 188 (2.34 0.88 2.01) | 41 — S — 193 (1.29 1.16 1.74) | 41 — S — 195 (2.19 1.32 1.57) |
| 41 — S — 198 (1.90 1.38 1.51) | 41 — S — 205 (1.42 1.44 1.45) | 41 — S — 208 (1.39 0.91 1.98) | 41 — S — 209 (1.13 0.99 1.91) |
| 41 — S — 213 (1.87 1.33 1.56) | 41 — S — 217 (1.29 1.37 1.53) | 41 — S — 218 (1.26 1.54 1.35) | 41 — S — 219 (1.07 1.10 1.79) |
| 41 — S — 222 (1.18 0.95 1.94) | 41 — S — 228 (0.81 1.10 1.79) | 41 — S — 233 (1.80 1.53 1.36) | 41 — S — 234 (1.62 1.61 1.28) |
| 41 — S — 237 (1.63 1.91 0.98) | 41 — S — 238 (0.93 1.77 1.13) | 41 — S — 244 (1.68 1.52 1.37) | 41 — S — 245 (1.60 1.30 1.60) |
| 41 — S — 246 (1.94 1.86 1.03) | 41 — S — 254 (1.44 1.22 1.67) | 41 — S — 266 (1.54 1.58 1.31) | 41 — S — 267 (1.34 1.28 1.61) |
| 41 — S — 274 (1.20 1.08 1.81) | 41 — S — 275 (1.01 1.50 1.39) | 41 — S — 277 (1.42 1.35 1.54) | 41 — S — 279 (1.48 1.41 1.48) |
| 41 — S — 280 (1.16 1.09 1.80) | 41 — S — 282 (1.27 0.92 1.97) | 41 — S — 284 (1.05 0.92 1.97) | 41 — S — 285 (1.20 1.29 1.60) |
| 41 — S — 286 (1.45 1.20 1.69) | 41 — S — 287 (1.26 1.21 1.68) | 41 — S — 288 (1.25 1.15 1.74) | 41 — S — 289 (1.50 0.99 1.91) |
| 41 — S — 290 (1.54 1.61 1.28) | 41 — S — 292 (2.01 1.68 1.21) | 41 — S — 293 (1.51 1.49 1.40) | 41 — S — 294 (1.96 1.52 1.37) |

| | | | |
|---|---|---|---|
| 41 — S — 295 (1.72 1.76 1.13) | 41 — S — 296 (2.00 1.76 1.13) | 41 — S — 297 (1.31 0.89 2.00) | 41 — S — 298 (1.57 1.36 1.53) |
| 41 — S — 299 (0.82 1.70 1.19) | 41 — S — 304 (1.37 1.21 1.68) | 41 — S — 305 (1.89 1.43 1.47) | 41 — S — 310 (1.49 0.82 2.07) |
| 41 — S — 311 (1.21 1.10 1.79) | 41 — S — 312 (1.31 0.97 1.92) | 41 — S — 313 (1.08 1.14 1.75) | 41 — S — 316 (1.37 1.42 1.47) |
| 41 — S — 327 (1.66 1.83 1.06) | 41 — S — 330 (0.99 0.83 2.06) | 41 — S — 331 (1.52 1.01 1.89) | 41 — S — 332 (1.37 1.18 1.71) |
| 41 — S — 336 (1.47 1.07 1.82) | 41 — S — 341 (0.97 1.70 1.19) | 41 — S — 356 (1.14 0.89 2.01) | 41 — S — 358 (1.32 1.34 1.55) |
| 41 — S — 367 (1.94 1.98 0.91) | 41 — S — 370 (1.29 1.41 1.48) | 41 — S — 372 (1.51 1.11 1.78) | 41 — S — 373 (0.90 1.12 1.78) |
| 41 — S — 374 (1.12 1.60 1.29) | 41 — S — 379 (1.20 1.11 1.78) | 41 — S — 382 (1.27 1.29 1.60) | 41 — S — 391 (1.21 1.09 1.80) |
| 41 — S — 395 (2.13 1.83 1.07) | 41 — S — 396 (1.56 1.26 1.63) | 41 — S — 397 (1.36 1.11 1.78) | 41 — S — 415 (1.25 0.99 1.90) |
| 41 — S — 430 (1.15 1.93 0.97) | 41 — S — 434 (1.21 1.40 1.49) | 41 — S — 435 (1.30 1.57 1.32) | 41 — S — 437 (1.48 0.94 1.95) |
| 41 — S — 440 (1.82 1.74 1.16) | 41 — S — 441 (1.75 1.66 1.23) | 41 — S — 447 (1.76 1.85 1.04) | 41 — S — 449 (1.50 1.82 1.07) |
| 41 — S — 450 (1.12 1.48 1.41) | 41 — S — 454 (1.22 0.95 1.94) | 41 — S — 455 (1.20 1.22 1.67) | 41 — S — 456 (0.89 0.94 1.96) |
| 41 — S — 457 (1.35 1.73 1.16) | 41 — S — 458 (0.89 1.52 1.37) | 41 — S — 459 (1.13 1.96 0.93) | 41 — S — 461 (1.34 1.92 0.97) |
| 41 — S — 462 (1.03 1.94 0.96) | 41 — S — 467 (1.03 1.33 1.56) | 41 — S — 468 (1.23 1.64 1.26) | 41 — S — 471 (1.93 1.39 1.50) |
| 41 — S — 474 (1.83 1.90 1.00) | 43 — S — 429 (1.42 1.00 1.75) | 44 — S — 43 (0.92 1.49 1.82) | 44 — S — 46 (1.52 1.01 2.30) |
| 44 — S — 57 (1.19 2.02 1.28) | 44 — S — 70 (0.99 1.70 1.61) | 44 — S — 107 (1.03 0.97 2.34) | 44 — S — 109 (0.82 1.50 1.81) |
| 44 — S — 133 (1.03 1.26 2.05) | 44 — S — 150 (1.85 1.13 2.17) | 44 — S — 151 (1.76 1.39 1.92) | 44 — S — 152 (2.40 1.69 1.62) |
| 44 — S — 153 (1.78 1.23 2.07) | 44 — S — 177 (0.86 0.91 2.39) | 44 — S — 192 (1.21 1.25 2.06) | 44 — S — 215 (1.01 1.82 1.49) |
| 44 — S — 231 (1.25 1.36 1.95) | 44 — S — 247 (0.91 2.32 0.99) | 44 — S — 248 (0.84 1.66 1.64) | 44 — S — 255 (1.17 1.33 1.97) |
| 44 — S — 259 (1.02 2.15 1.16) | 44 — S — 270 (0.82 2.01 1.29) | 44 — S — 271 (1.43 1.43 1.88) | 44 — S — 291 (1.51 1.27 2.04) |
| 44 — S — 292 (0.84 0.93 2.38) | 44 — S — 296 (0.83 1.01 2.30) | 44 — S — 306 (0.89 1.33 1.97) | 44 — S — 320 (1.11 1.75 1.56) |
| 44 — S — 324 (1.08 2.25 1.06) | 44 — S — 329 (0.83 1.54 1.77) | 44 — S — 342 (2.25 1.29 2.02) | 44 — S — 343 (2.78 1.78 1.53) |
| 44 — S — 364 (0.96 1.91 1.40) | 44 — S — 368 (0.89 1.78 1.53) | 44 — S — 371 (1.94 1.38 1.93) | 44 — S — 395 (0.97 1.08 2.23) |
| 44 — S — 472 (1.34 2.06 1.25) | 44 — S — 473 (0.81 1.26 2.05) | 45 — S — 36 (1.11 1.14 1.08) | 45 — S — 43 (1.52 1.00 1.22) |
| 45 — S — 70 (1.59 1.21 1.01) | 45 — S — 89 (1.34 0.95 1.27) | 45 — S — 108 (1.19 0.87 1.34) | 45 — S — 109 (1.43 1.01 1.21) |
| 45 — S — 113 (1.03 1.06 1.16) | 45 — S — 151 (2.36 0.90 1.31) | 45 — S — 152 (3.00 1.20 1.02) | 45 — S — 206 (0.86 1.11 1.10) |
| 45 — S — 207 (1.38 1.06 1.16) | 45 — S — 231 (1.85 0.87 1.35) | 45 — S — 248 (1.44 1.18 1.04) | 45 — S — 249 (0.91 1.02 1.20) |
| 45 — S — 251 (0.88 0.87 1.34) | 45 — S — 255 (1.77 0.85 1.37) | 45 — S — 258 (0.83 1.29 0.93) | 45 — S — 260 (0.89 1.30 0.92) |
| 45 — S — 268 (1.32 0.92 1.30) | 45 — S — 269 (1.28 0.85 1.37) | 45 — S — 271 (2.03 0.94 1.28) | 45 — S — 306 (1.49 0.84 1.37) |
| 45 — S — 307 (1.22 0.97 1.24) | 45 — S — 320 (1.71 1.26 0.95) | 45 — S — 329 (1.43 1.05 1.17) | 45 — S — 342 (2.86 0.80 1.42) |
| 45 — S — 343 (3.38 1.29 0.92) | 45 — S — 368 (1.49 1.29 0.93) | 45 — S — 371 (2.54 0.89 1.33) | 45 — S — 451 (1.28 1.19 1.02) |
| 45 — S — 452 (1.34 0.85 1.37) | 45 — S — 460 (1.06 0.93 1.29) | 45 — S — 463 (1.22 1.30 0.92) | 46 — S — 429 (0.82 1.47 2.34) |
| 47 — S — 28 (1.09 0.80 1.45) | 47 — S — 36 (1.25 1.32 0.93) | 47 — S — 43 (1.67 1.17 1.08) | 47 — S — 89 (1.48 1.12 1.13) |
| 47 — S — 90 (1.39 0.97 1.28) | 47 — S — 101 (1.15 0.82 1.43) | 47 — S — 108 (1.33 1.05 1.20) | 47 — S — 109 (1.57 1.18 1.07) |
| 47 — S — 110 (1.06 0.82 1.43) | 47 — S — 113 (1.17 1.24 1.01) | 47 — S — 133 (1.77 0.95 1.30) | 47 — S — 144 (1.11 0.86 1.39) |
| 47 — S — 150 (2.59 0.82 1.43) | 47 — S — 151 (2.50 1.08 1.17) | 47 — S — 153 (2.53 0.92 1.33) | 47 — S — 183 (1.26 0.94 1.31) |
| 47 — S — 192 (1.95 0.93 1.32) | 47 — S — 206 (1.00 1.29 0.96) | 47 — S — 207 (1.52 1.24 1.01) | 47 — S — 231 (1.99 1.04 1.21) |
| 47 — S — 237 (1.21 0.85 1.40) | 47 — S — 246 (1.52 0.80 1.45) | 47 — S — 248 (1.58 1.35 0.90) | 47 — S — 249 (1.06 1.19 1.06) |
| 47 — S — 251 (1.02 1.05 1.20) | 47 — S — 255 (1.91 1.02 1.23) | 47 — S — 265 (1.48 0.94 1.31) | 47 — S — 268 (1.46 1.09 1.16) |
| 47 — S — 269 (1.42 1.02 1.23) | 47 — S — 271 (2.17 1.11 1.14) | 47 — S — 291 (2.25 0.96 1.29) | 47 — S — 306 (1.63 1.02 1.23) |
| 47 — S — 307 (1.36 1.15 1.10) | 47 — S — 329 (1.57 1.23 1.02) | 47 — S — 342 (3.00 0.98 1.27) | 47 — S — 367 (1.52 0.92 1.33) |
| 47 — S — 371 (2.68 1.06 1.19) | 47 — S — 420 (0.90 1.24 1.01) | 47 — S — 443 (0.80 1.22 1.03) | 47 — S — 452 (1.48 1.02 1.23) |
| 47 — S — 460 (1.21 1.10 1.15) | 47 — S — 461 (0.92 0.86 1.39) | 47 — S — 469 (0.90 1.00 1.25) | 47 — S — 473 (1.55 0.95 1.30) |
| 47 — S — 474 (1.41 0.83 1.41) | 48 — S — 36 (1.18 1.29 1.00) | 48 — S — 43 (1.60 1.14 1.15) | 48 — S — 70 (1.66 1.35 0.94) |
| 48 — S — 89 (1.41 1.09 1.20) | 48 — S — 90 (1.32 0.94 1.35) | 48 — S — 108 (1.26 1.02 1.27) | 48 — S — 109 (1.50 1.15 1.14) |
| 48 — S — 113 (1.10 1.21 1.08) | 48 — S — 133 (1.70 0.92 1.37) | 48 — S — 144 (1.04 0.83 1.46) | 48 — S — 151 (2.43 1.05 1.24) |
| 48 — S — 152 (3.08 1.35 0.94) | 48 — S — 153 (2.46 0.89 1.40) | 48 — S — 183 (1.19 0.91 1.38) | 48 — S — 192 (1.88 0.90 1.39) |
| 48 — S — 206 (0.93 1.26 1.03) | 48 — S — 207 (1.45 1.21 1.08) | 48 — S — 231 (1.92 1.01 1.28) | 48 — S — 237 (1.14 0.82 1.47) |
| 48 — S — 248 (1.51 1.32 0.97) | 48 — S — 249 (0.99 1.16 1.13) | 48 — S — 251 (0.95 1.02 1.27) | 48 — S — 255 (1.84 0.99 1.30) |
| 48 — S — 265 (1.41 0.91 1.38) | 48 — S — 268 (1.39 1.06 1.23) | 48 — S — 269 (1.35 0.99 1.30) | 48 — S — 271 (2.10 1.08 1.21) |
| 48 — S — 291 (2.18 0.93 1.36) | 48 — S — 306 (1.56 0.99 1.30) | 48 — S — 307 (1.29 1.12 1.17) | 48 — S — 329 (1.50 1.20 1.09) |
| 48 — S — 342 (2.93 0.95 1.34) | 48 — S — 367 (1.45 0.89 1.40) | 48 — S — 371 (2.61 1.03 1.25) | 48 — S — 420 (0.83 1.21 1.08) |
| 48 — S — 451 (1.36 1.34 0.95) | 48 — S — 452 (1.41 0.99 1.30) | 48 — S — 460 (1.14 1.07 1.22) | 48 — S — 461 (0.85 0.83 1.46) |
| 48 — S — 469 (0.83 0.97 1.32) | 48 — S — 473 (1.48 0.92 1.37) | 48 — S — 474 (1.34 0.81 1.48) | 49 — S — 5 (1.03 1.01 1.57) |
| 49 — S — 9 (1.91 1.04 1.53) | 49 — S — 11 (1.02 1.28 1.29) | 49 — S — 19 (1.48 0.94 1.63) | 49 — S — 20 (2.01 1.59 0.98) |
| 49 — S — 30 (1.16 0.96 1.61) | 49 — S — 31 (1.18 0.92 1.65) | 49 — S — 33 (1.21 0.80 1.77) | 49 — S — 38 (1.37 1.18 1.39) |
| 49 — S — 44 (1.64 0.90 1.67) | 49 — S — 45 (1.04 1.39 1.18) | 49 — S — 47 (0.90 1.22 1.35) | 49 — S — 48 (0.97 1.25 1.32) |
| 49 — S — 56 (1.92 1.22 1.36) | 49 — S — 58 (1.06 0.98 1.60) | 49 — S — 59 (1.10 0.95 1.62) | 49 — S — 60 (1.20 0.83 1.74) |
| 49 — S — 65 (1.91 1.53 1.05) | 49 — S — 68 (1.62 1.49 1.08) | 49 — S — 74 (1.07 1.06 1.51) | 49 — S — 83 (1.95 1.16 1.41) |

49 — S — 88 (1.12 0.83 1.74) 49 — S — 96 (0.99 1.52 1.06) 49 — S — 98 (1.12 0.89 1.68) 49 — S — 102 (1.67 1.05 1.52) 49 — S — 105 (2.21 1.14 1.43) 49 — S — 111 (2.66 1.16 1.41) 49 — S — 112 (1.86 1.54 1.03) 49 — S — 114 (1.50 0.81 1.76) 49 — S — 118 (1.95 1.44 1.14) 49 — S — 119 (1.92 1.65 0.92) 49 — S — 124 (0.81 1.04 1.53) 49 — S — 131 (1.97 1.11 1.46) 49 — S — 132 (1.88 1.36 1.21) 49 — S — 138 (1.20 1.09 1.48) 49 — S — 147 (1.41 1.65 0.92) 49 — S — 148 (1.66 0.94 1.63) 49 — S — 154 (2.96 1.27 1.30) 49 — S — 166 (2.68 1.09 1.48) 49 — S — 171 (2.45 1.09 1.48) 49 — S — 184 (3.24 1.63 0.94) 49 — S — 187 (2.39 1.00 1.57) 49 — S — 188 (2.82 1.04 1.53) 49 — S — 193 (1.77 1.31 1.26) 49 — S — 195 (2.67 1.48 1.10) 49 — S — 198 (2.38 1.54 1.04) 49 — S — 205 (1.90 1.60 0.98) 49 — S — 208 (1.87 1.07 1.50) 49 — S — 209 (1.61 1.15 1.43) 49 — S — 211 (0.96 1.31 1.26) 49 — S — 213 (2.35 1.49 1.08) 49 — S — 217 (1.77 1.52 1.05) 49 — S — 219 (1.54 1.26 1.31) 49 — S — 222 (1.66 1.11 1.47) 49 — S — 225 (1.15 1.11 1.46) 49 — S — 227 (0.95 1.63 0.94) 49 — S — 228 (1.28 1.26 1.31) 49 — S — 230 (1.59 0.93 1.64) 49 — S — 243 (2.85 0.90 1.68) 49 — S — 245 (2.08 1.45 1.12) 49 — S — 254 (1.92 1.38 1.19) 49 — S — 267 (1.81 1.44 1.13) 49 — S — 274 (1.68 1.24 1.33) 49 — S — 275 (1.49 1.66 0.91) 49 — S — 277 (1.90 1.51 1.06) 49 — S — 279 (1.96 1.57 1.00) 49 — S — 280 (1.63 1.25 1.32) 49 — S — 282 (1.75 1.08 1.50) 49 — S — 284 (1.53 1.08 1.49) 49 — S — 285 (1.68 1.45 1.12) 49 — S — 286 (1.93 1.36 1.22) 49 — S — 287 (1.74 1.37 1.20) 49 — S — 288 (1.72 1.31 1.27) 49 — S — 289 (1.98 1.14 1.43) 49 — S — 293 (1.99 1.65 0.93) 49 — S — 297 (1.79 1.05 1.52) 49 — S — 298 (2.04 1.52 1.05) 49 — S — 300 (2.05 0.92 1.65) 49 — S — 303 (1.81 0.89 1.68) 49 — S — 304 (1.85 1.37 1.20) 49 — S — 305 (2.37 1.58 0.99) 49 — S — 310 (1.96 0.98 1.59) 49 — S — 311 (1.69 1.26 1.32) 49 — S — 312 (1.79 1.13 1.44) 49 — S — 313 (1.56 1.30 1.28) 49 — S — 316 (1.85 1.58 0.99) 49 — S — 319 (1.05 1.44 1.13) 49 — S — 325 (0.90 1.38 1.19) 49 — S — 330 (1.47 0.99 1.58) 49 — S — 331 (2.00 1.16 1.41) 49 — S — 332 (1.85 1.34 1.23) 49 — S — 336 (1.95 1.23 1.34) 49 — S — 356 (1.62 1.04 1.53) 49 — S — 358 (1.80 1.50 1.07) 49 — S — 360 (1.24 0.90 1.67) 49 — S — 370 (1.76 1.57 1.00) 49 — S — 372 (1.99 1.27 1.30) 49 — S — 373 (1.38 1.28 1.30) 49 — S — 378 (1.12 1.11 1.46) 49 — S — 379 (1.68 1.27 1.31) 49 — S — 381 (1.25 1.44 1.14) 49 — S — 382 (1.75 1.45 1.12) 49 — S — 391 (1.68 1.25 1.32) 49 — S — 396 (2.04 1.42 1.15) 49 — S — 397 (1.84 1.27 1.30) 49 — S — 415 (1.73 1.15 1.42) 49 — S — 419 (1.13 1.25 1.33) 49 — S — 422 (1.03 0.84 1.73) 49 — S — 434 (1.69 1.56 1.01) 49 — S — 437 (1.96 1.10 1.47) 49 — S — 450 (1.60 1.64 0.93) 49 — S — 453 (1.87 0.95 1.62) 49 — S — 454 (1.69 1.11 1.46) 49 — S — 455 (1.68 1.38 1.19) 49 — S — 456 (1.37 1.09 1.48) 49 — S — 466 (1.20 0.97 1.61) 49 — S — 467 (1.51 1.49 1.08) 49 — S — 471 (2.40 1.55 1.02) 49 — S — 475 (1.24 1.18 1.40) 49 — S — 476 (0.92 1.21 1.37) 53 — S — 20 (0.99 1.15 2.01) 53 — S — 27 (0.90 1.31 1.84) 53 — S — 28 (0.96 1.58 1.57) 53 — S — 36 (1.12 2.09 1.06) 53 — S — 43 (1.54 1.95 1.21) 53 — S — 46 (2.13 1.47 1.69) 53 — S — 61 (0.87 1.29 1.87) 53 — S — 65 (0.88 1.08 2.07) 53 — S — 70 (1.60 2.16 1.00) 53 — S — 79 (0.87 1.46 1.70) 53 — S — 80 (0.82 1.42 1.74) 53 — S — 81 (0.90 1.54 1.61) 53 — S — 85 (1.38 1.27 1.89) 53 — S — 89 (1.36 1.90 1.26) 53 — S — 90 (1.27 1.75 1.41) 53 — S — 101 (1.02 1.60 1.56) 53 — S — 107 (1.64 1.43 1.72) 53 — S — 108 (1.20 1.82 1.33) 53 — S — 109 (1.44 1.96 1.20) 53 — S — 110 (0.93 1.60 1.56) 53 — S — 112 (0.83 1.10 2.06) 53 — S — 113 (1.04 2.01 1.14) 53 — S — 115 (1.31 1.57 1.58) 53 — S — 118 (0.92 0.99 2.16) 53 — S — 119 (0.89 1.21 1.95) 53 — S — 132 (0.86 0.92 2.24) 53 — S — 133 (1.65 1.72 1.43) 53 — S — 144 (0.98 1.63 1.52) 53 — S — 150 (2.47 1.60 1.56) 53 — S — 151 (2.37 1.85 1.30) 53 — S — 152 (3.02 2.15 1.00) 53 — S — 153 (2.40 1.70 1.46) 53 — S — 154 (1.93 0.83 2.33) 53 — S — 177 (1.48 1.38 1.78) 53 — S — 183 (1.13 1.71 1.44) 53 — S — 184 (2.21 1.19 1.97) 53 — S — 192 (1.82 1.71 1.45) 53 — S — 195 (1.65 1.03 2.12) 53 — S — 198 (1.36 1.09 2.06) 53 — S — 205 (0.88 1.15 2.00) 53 — S — 206 (0.87 2.07 1.09) 53 — S — 207 (1.39 2.01 1.14) 53 — S — 213 (1.32 1.05 2.11) 53 — S — 231 (1.86 1.82 1.33) 53 — S — 233 (1.25 1.25 1.91) 53 — S — 234 (1.07 1.33 1.83) 53 — S — 237 (1.08 1.62 1.53) 53 — S — 244 (1.14 1.24 1.92) 53 — S — 245 (1.05 1.01 2.14) 53 — S — 246 (1.39 1.58 1.58) 53 — S — 248 (1.46 2.13 1.03) 53 — S — 249 (0.93 1.97 1.19) 53 — S — 251 (0.90 1.83 1.33) 53 — S — 254 (0.89 0.94 2.22) 53 — S — 255 (1.78 1.80 1.36) 53 — S — 258 (0.85 2.24 0.91) 53 — S — 260 (0.91 2.25 0.91) 53 — S — 265 (1.35 1.72 1.44) 53 — S — 266 (0.99 1.30 1.86) 53 — S — 268 (1.33 1.87 1.29) 53 — S — 269 (1.29 1.80 1.36) 53 — S — 271 (2.04 1.89 1.27) 53 — S — 277 (0.88 1.07 2.09) 53 — S — 279 (0.93 1.13 2.03) 53 — S — 286 (0.91 0.91 2.24) 53 — S — 290 (0.99 1.33 1.83) 53 — S — 291 (2.13 1.73 1.42) 53 — S — 292 (1.46 1.39 1.76) 53 — S — 293 (0.96 1.20 1.95) 53 — S — 294 (1.42 1.24 1.92) 53 — S — 295 (1.17 1.48 1.68) 53 — S — 296 (1.45 1.47 1.68) 53 — S — 298 (1.02 1.08 2.08) 53 — S — 304 (0.82 0.93 2.23) 53 — S — 305 (1.34 1.14 2.01) 53 — S — 306 (1.50 1.80 1.36) 53 — S — 307 (1.23 1.93 1.23) 53 — S — 316 (0.82 1.14 2.02) 53 — S — 320 (1.72 2.21 0.94) 53 — S — 327 (1.11 1.54 1.61) 53 — S — 329 (1.44 2.00 1.15) 53 — S — 332 (0.83 0.90 2.26) 53 — S — 342 (2.87 1.75 1.40) 53 — S — 343 (3.40 2.25 0.91) 53 — S — 367 (1.39 1.70 1.46) 53 — S — 368 (1.51 2.24 0.92) 53 — S — 371 (2.56 1.84 1.31) 53 — S — 372 (0.97 0.83 2.33) 53 — S — 395 (1.59 1.54 1.61) 53 — S — 396 (1.01 0.98 2.18) 53 — S — 397 (0.82 0.82 2.33) 53 — S — 440 (1.27 1.45 1.70) 53 — S — 441 (1.20 1.38 1.78) 53 — S — 447 (1.21 1.57 1.59) 53 — S — 449 (0.96 1.53 1.62) 53 — S — 451 (1.30 2.14 1.01) 53 — S — 452 (1.35 1.80 1.36) 53 — S — 460 (1.08 1.88 1.28) 53 — S — 463 (1.23 2.25 0.91) 53 — S — 471 (1.38 1.11 2.05) 53 — S — 473 (1.42 1.72 1.43) 53 — S — 474 (1.28 1.61 1.54) 54 — S — 20 (0.89 0.89 2.10) 54 — S — 27 (0.81 1.06 1.94) 54 — S — 28 (0.87 1.32 1.67) 54 — S — 36 (1.03 1.84 1.16) 54 — S — 43 (1.44 1.69 1.30) 54 — S — 46 (2.04 1.21 1.78) 54 — S — 70 (1.51 1.90 1.09) 54 — S — 81 (0.80 1.28 1.71) 54 — S — 85 (1.29 1.01 1.98) 54 — S — 89 (1.26 1.64 1.35) 54 — S — 90 (1.17 1.49 1.50) 54 — S — 101 (0.93 1.34 1.65) 54 — S — 107 (1.55 1.18 1.82) 54 — S — 108 (1.11 1.57 1.42) 54 — S — 109 (1.35 1.70 1.29) 54 — S — 110 (0.84 1.34 1.65) 54 — S — 113 (0.95 1.76 1.24) 54 — S — 115 (1.22 1.32 1.68) 54 — S — 133 (1.55 1.47 1.53) 54 — S — 144 (0.89 1.38 1.61) 54 — S — 145 (0.87 2.03 0.96) 54 — S — 150 (2.37 1.34 1.65) 54 — S — 151 (2.28 1.60 1.39) 54 — S — 152 (2.92 1.90 1.10) 54 — S — 153 (2.30 1.44 1.55) 54 — S — 177 (1.39 1.12 1.87) 54 — S — 183 (1.03 1.46 1.54) 54 — S — 184 (2.12 0.93 2.06) 54 — S — 192 (1.73 1.45 1.54) 54 — S — 198 (1.26 0.84 2.16) 54 — S — 207 (1.30 1.76 1.24)

| | | | |
|---|---|---|---|
| 54 — S — 215 (1.53 2.02 0.97) | 54 — S — 231 (1.77 1.56 1.43) | 54 — S — 233 (1.16 0.99 2.00) | 54 — S — 234 (0.98 1.07 1.92) |
| 54 — S — 237 (0.99 1.37 1.63) | 54 — S — 244 (1.04 0.98 2.01) | 54 — S — 246 (1.30 1.32 1.67) | 54 — S — 248 (1.36 1.87 1.12) |
| 54 — S — 249 (0.83 1.71 1.28) | 54 — S — 251 (0.80 1.57 1.42) | 54 — S — 255 (1.69 1.54 1.45) | 54 — S — 260 (0.81 1.99 1.00) |
| 54 — S — 265 (1.26 1.46 1.53) | 54 — S — 266 (0.90 1.04 1.95) | 54 — S — 268 (1.24 1.61 1.38) | 54 — S — 269 (1.20 1.54 1.45) |
| 54 — S — 271 (1.95 1.63 1.36) | 54 — S — 279 (0.84 0.87 2.12) | 54 — S — 290 (0.89 1.07 1.92) | 54 — S — 291 (2.03 1.48 1.51) |
| 54 — S — 292 (1.37 1.14 1.86) | 54 — S — 293 (0.87 0.95 2.05) | 54 — S — 294 (1.32 0.98 2.01) | 54 — S — 295 (1.08 1.22 1.77) |
| 54 — S — 296 (1.36 1.22 1.77) | 54 — S — 298 (0.92 0.82 2.17) | 54 — S — 305 (1.25 0.89 2.11) | 54 — S — 306 (1.41 1.54 1.45) |
| 54 — S — 307 (1.14 1.67 1.32) | 54 — S — 320 (1.63 1.96 1.03) | 54 — S — 327 (1.02 1.29 1.71) | 54 — S — 329 (1.35 1.75 1.25) |
| 54 — S — 342 (2.77 1.50 1.50) | 54 — S — 343 (3.30 1.99 1.00) | 54 — S — 367 (1.30 1.44 1.55) | 54 — S — 368 (1.41 1.98 1.01) |
| 54 — S — 371 (2.46 1.59 1.41) | 54 — S — 395 (1.49 1.29 1.71) | 54 — S — 440 (1.18 1.19 1.80) | 54 — S — 441 (1.11 1.12 1.87) |
| 54 — S — 447 (1.12 1.31 1.68) | 54 — S — 449 (0.86 1.28 1.71) | 54 — S — 451 (1.20 1.89 1.10) | 54 — S — 452 (1.26 1.54 1.45) |
| 54 — S — 460 (0.98 1.62 1.37) | 54 — S — 463 (1.14 1.99 1.00) | 54 — S — 471 (1.28 0.85 2.14) | 54 — S — 473 (1.33 1.47 1.53) |
| 54 — S — 474 (1.18 1.36 1.64) | 55 — S — 20 (0.81 1.08 2.18) | 55 — S — 36 (0.95 2.03 1.23) | 55 — S — 37 (0.95 2.33 0.93) |
| 55 — S — 43 (1.37 1.89 1.38) | 55 — S — 46 (1.96 1.41 1.86) | 55 — S — 70 (1.43 2.10 1.17) | 55 — S — 85 (1.21 1.21 2.06) |
| 55 — S — 89 (1.19 1.83 1.43) | 55 — S — 90 (1.09 1.68 1.58) | 55 — S — 101 (0.85 1.54 1.73) | 55 — S — 107 (1.47 1.37 1.89) |
| 55 — S — 108 (1.03 1.76 1.50) | 55 — S — 109 (1.27 1.90 1.37) | 55 — S — 113 (0.87 1.95 1.31) | 55 — S — 115 (1.14 1.51 1.75) |
| 55 — S — 133 (1.47 1.66 1.60) | 55 — S — 144 (0.81 1.57 1.69) | 55 — S — 150 (2.29 1.53 1.73) | 55 — S — 151 (2.20 1.79 1.47) |
| 55 — S — 152 (2.85 2.09 1.17) | 55 — S — 153 (2.23 1.63 1.63) | 55 — S — 177 (1.31 1.31 1.95) | 55 — S — 183 (0.96 1.65 1.61) |
| 55 — S — 184 (2.04 1.13 2.14) | 55 — S — 192 (1.65 1.65 1.62) | 55 — S — 195 (1.47 0.97 2.29) | 55 — S — 198 (1.19 1.03 2.23) |
| 55 — S — 207 (1.22 1.95 1.31) | 55 — S — 213 (1.15 0.99 2.28) | 55 — S — 215 (1.45 2.22 1.05) | 55 — S — 231 (1.69 1.76 1.51) |
| 55 — S — 233 (1.08 1.18 2.08) | 55 — S — 234 (0.90 1.26 2.00) | 55 — S — 237 (0.91 1.56 1.70) | 55 — S — 244 (0.96 1.18 2.09) |
| 55 — S — 245 (0.88 0.95 2.31) | 55 — S — 246 (1.22 1.52 1.75) | 55 — S — 248 (1.28 2.06 1.20) | 55 — S — 255 (1.61 1.73 1.53) |
| 55 — S — 265 (1.18 1.66 1.61) | 55 — S — 266 (0.82 1.23 2.03) | 55 — S — 268 (1.16 1.81 1.46) | 55 — S — 269 (1.12 1.73 1.53) |
| 55 — S — 271 (1.87 1.83 1.44) | 55 — S — 290 (0.82 1.27 2.00) | 55 — S — 291 (1.95 1.67 1.59) | 55 — S — 292 (1.29 1.33 1.93) |
| 55 — S — 294 (1.25 1.17 2.09) | 55 — S — 295 (1.00 1.42 1.85) | 55 — S — 296 (1.28 1.41 1.85) | 55 — S — 298 (0.85 1.02 2.25) |
| 55 — S — 305 (1.17 1.08 2.18) | 55 — S — 306 (1.33 1.73 1.53) | 55 — S — 307 (1.06 1.86 1.40) | 55 — S — 320 (1.55 2.15 1.11) |
| 55 — S — 327 (0.94 1.48 1.78) | 55 — S — 329 (1.27 1.94 1.32) | 55 — S — 342 (2.70 1.69 1.57) | 55 — S — 343 (3.23 2.18 1.08) |
| 55 — S — 364 (1.41 2.31 0.95) | 55 — S — 367 (1.22 1.63 1.63) | 55 — S — 368 (1.34 2.18 1.09) | 55 — S — 371 (2.39 1.78 1.48) |
| 55 — S — 395 (1.42 1.48 1.78) | 55 — S — 396 (0.84 0.92 2.35) | 55 — S — 440 (1.10 1.39 1.88) | 55 — S — 441 (1.03 1.31 1.95) |
| 55 — S — 447 (1.04 1.50 1.76) | 55 — S — 451 (1.13 2.08 1.18) | 55 — S — 452 (1.18 1.74 1.53) | 55 — S — 460 (0.91 1.81 1.45) |
| 55 — S — 463 (1.06 2.18 1.08) | 55 — S — 471 (1.21 1.05 2.22) | 55 — S — 473 (1.25 1.66 1.60) | 55 — S — 474 (1.11 1.55 1.71) |
| 56 — S — 57 (0.92 1.71 1.56) | 56 — S — 125 (1.16 2.16 1.11) | 56 — S — 150 (1.58 0.82 2.45) | 56 — S — 151 (1.49 1.08 2.19) |
| 56 — S — 152 (2.13 1.38 1.89) | 56 — S — 153 (1.51 0.92 2.35) | 56 — S — 192 (0.93 0.93 2.34) | 56 — S — 231 (0.98 1.05 2.22) |
| 56 — S — 250 (0.92 2.29 0.98) | 56 — S — 255 (0.89 1.02 2.25) | 56 — S — 271 (1.16 1.11 2.16) | 56 — S — 291 (1.24 0.96 2.31) |
| 56 — S — 320 (0.83 1.44 1.83) | 56 — S — 324 (0.81 1.93 1.34) | 56 — S — 342 (1.98 0.98 2.29) | 56 — S — 343 (2.51 1.47 1.80) |
| 56 — S — 371 (1.67 1.07 2.20) | 56 — S — 429 (2.07 2.17 1.10) | 56 — S — 472 (1.06 1.75 1.52) | 58 — S — 28 (0.93 1.05 1.61) |
| 58 — S — 36 (1.09 1.56 1.09) | 58 — S — 43 (1.51 1.41 1.24) | 58 — S — 46 (2.10 0.94 1.72) | 58 — S — 70 (1.57 1.62 1.03) |
| 58 — S — 79 (0.84 0.93 1.73) | 58 — S — 81 (0.87 1.01 1.65) | 58 — S — 89 (1.33 1.36 1.29) | 58 — S — 90 (1.23 1.21 1.44) |
| 58 — S — 101 (0.99 1.06 1.59) | 58 — S — 107 (1.61 0.90 1.75) | 58 — S — 108 (1.17 1.29 1.36) | 58 — S — 109 (1.41 1.43 1.23) |
| 58 — S — 110 (0.90 1.06 1.59) | 58 — S — 113 (1.01 1.48 1.17) | 58 — S — 115 (1.28 1.04 1.61) | 58 — S — 133 (1.61 1.19 1.46) |
| 58 — S — 144 (0.95 1.10 1.55) | 58 — S — 145 (0.93 1.75 0.90) | 58 — S — 150 (2.43 1.06 1.59) | 58 — S — 151 (2.34 1.32 1.33) |
| 58 — S — 152 (2.99 1.62 1.03) | 58 — S — 153 (2.37 1.16 1.49) | 58 — S — 177 (1.45 0.84 1.81) | 58 — S — 183 (1.10 1.18 1.47) |
| 58 — S — 192 (1.79 1.17 1.48) | 58 — S — 206 (0.84 1.53 1.12) | 58 — S — 207 (1.36 1.48 1.17) | 58 — S — 215 (1.59 1.74 0.91) |
| 58 — S — 231 (1.83 1.29 1.36) | 58 — S — 237 (1.05 1.09 1.56) | 58 — S — 246 (1.36 1.04 1.61) | 58 — S — 248 (1.42 1.59 1.06) |
| 58 — S — 249 (0.90 1.43 1.22) | 58 — S — 251 (0.86 1.29 1.36) | 58 — S — 255 (1.75 1.26 1.39) | 58 — S — 258 (0.82 1.71 0.94) |
| 58 — S — 260 (0.87 1.71 0.94) | 58 — S — 265 (1.32 1.19 1.47) | 58 — S — 268 (1.30 1.33 1.32) | 58 — S — 269 (1.26 1.26 1.39) |
| 58 — S — 271 (2.01 1.36 1.30) | 58 — S — 291 (2.09 1.20 1.45) | 58 — S — 292 (1.43 0.86 1.79) | 58 — S — 295 (1.14 0.94 1.71) |
| 58 — S — 296 (1.42 0.94 1.71) | 58 — S — 306 (1.47 1.26 1.39) | 58 — S — 307 (1.20 1.39 1.26) | 58 — S — 320 (1.69 1.68 0.97) |
| 58 — S — 327 (1.08 1.01 1.64) | 58 — S — 329 (1.41 1.47 1.18) | 58 — S — 342 (2.84 1.22 1.43) | 58 — S — 343 (3.37 1.71 0.94) |
| 58 — S — 367 (1.36 1.16 1.49) | 58 — S — 368 (1.48 1.71 0.95) | 58 — S — 371 (2.53 1.31 1.34) | 58 — S — 395 (1.56 1.01 1.64) |
| 58 — S — 440 (1.24 0.92 1.74) | 58 — S — 441 (1.17 0.84 1.81) | 58 — S — 447 (1.18 1.03 1.62) | 58 — S — 449 (0.92 1.00 1.65) |
| 58 — S — 451 (1.27 1.61 1.04) | 58 — S — 452 (1.32 1.27 1.39) | 58 — S — 460 (1.05 1.34 1.31) | 58 — S — 463 (1.20 1.71 0.94) |
| 58 — S — 473 (1.39 1.19 1.46) | 58 — S — 474 (1.25 1.08 1.57) | 59 — S — 27 (0.83 0.81 1.91) | 59 — S — 28 (0.89 1.08 1.65) |
| 59 — S — 36 (1.05 1.59 1.13) | 59 — S — 43 (1.47 1.44 1.28) | 59 — S — 46 (2.06 0.96 1.76) | 59 — S — 70 (1.53 1.65 1.07) |
| 59 — S — 81 (0.83 1.04 1.69) | 59 — S — 89 (1.28 1.39 1.33) | 59 — S — 90 (1.19 1.24 1.48) | 59 — S — 101 (0.95 1.09 1.63) |
| 59 — S — 107 (1.57 0.93 1.80) | 59 — S — 108 (1.13 1.32 1.40) | 59 — S — 109 (1.37 1.45 1.27) | 59 — S — 110 (0.86 1.09 1.63) |
| 59 — S — 113 (0.97 1.51 1.21) | 59 — S — 115 (1.24 1.07 1.66) | 59 — S — 133 (1.57 1.22 1.50) | 59 — S — 144 (0.91 1.13 1.59) |
| 59 — S — 145 (0.89 1.78 0.94) | 59 — S — 150 (2.39 1.09 1.63) | 59 — S — 151 (2.30 1.35 1.37) | 59 — S — 152 (2.95 1.65 1.07) |

59 — S — 153 (2.33 1.19 1.53) 59 — S — 177 (1.41 0.87 1.85) 59 — S — 183 (1.05 1.21 1.51) 59 — S — 192 (1.75 1.20 1.52)
59 — S — 207 (1.32 1.51 1.21) 59 — S — 215 (1.55 1.77 0.95) 59 — S — 231 (1.79 1.32 1.41) 59 — S — 234 (1.00 0.82 1.90)
59 — S — 237 (1.01 1.12 1.60) 59 — S — 246 (1.32 1.07 1.65) 59 — S — 248 (1.38 1.62 1.10) 59 — S — 249 (0.86 1.46 1.26)
59 — S — 251 (0.82 1.32 1.40) 59 — S — 255 (1.71 1.29 1.43) 59 — S — 260 (0.83 1.74 0.98) 59 — S — 265 (1.28 1.21 1.51)
59 — S — 268 (1.26 1.36 1.36) 59 — S — 269 (1.22 1.29 1.43) 59 — S — 271 (1.97 1.38 1.34) 59 — S — 290 (0.92 0.82 1.90)
59 — S — 291 (2.05 1.23 1.49) 59 — S — 292 (1.39 0.89 1.83) 59 — S — 295 (1.10 0.97 1.75) 59 — S — 296 (1.38 0.97 1.75)
59 — S — 306 (1.43 1.29 1.43) 59 — S — 307 (1.16 1.42 1.30) 59 — S — 320 (1.65 1.71 1.01) 59 — S — 327 (1.04 1.04 1.68)
59 — S — 329 (1.37 1.50 1.22) 59 — S — 342 (2.80 1.25 1.47) 59 — S — 343 (3.33 1.74 0.98) 59 — S — 367 (1.32 1.19 1.53)
59 — S — 368 (1.43 1.73 0.99) 59 — S — 371 (2.48 1.34 1.39) 59 — S — 395 (1.51 1.04 1.68) 59 — S — 440 (1.20 0.95 1.78)
59 — S — 441 (1.13 0.87 1.85) 59 — S — 447 (1.14 1.06 1.66) 59 — S — 449 (0.88 1.03 1.69) 59 — S — 451 (1.22 1.64 1.08)
59 — S — 452 (1.28 1.30 1.43) 59 — S — 460 (1.01 1.37 1.35) 59 — S — 463 (1.16 1.74 0.98) 59 — S — 473 (1.35 1.22 1.50)
59 — S — 474 (1.21 1.11 1.62) 60 — S — 36 (0.94 1.70 1.24) 60 — S — 37 (0.94 2.00 0.94) 60 — S — 43 (1.36 1.56 1.39)
60 — S — 46 (1.96 1.08 1.86) 60 — S — 70 (1.42 1.77 1.18) 60 — S — 85 (1.20 0.88 2.06) 60 — S — 89 (1.18 1.51 1.44)
60 — S — 90 (1.09 1.36 1.59) 60 — S — 101 (0.84 1.21 1.74) 60 — S — 107 (1.47 1.04 1.90) 60 — S — 108 (1.03 1.43 1.51)
60 — S — 109 (1.26 1.57 1.37) 60 — S — 113 (0.86 1.62 1.32) 60 — S — 115 (1.13 1.18 1.76) 60 — S — 133 (1.47 1.33 1.61)
60 — S — 144 (0.80 1.24 1.70) 60 — S — 150 (2.29 1.21 1.74) 60 — S — 151 (2.20 1.46 1.48) 60 — S — 152 (2.84 1.76 1.18)
60 — S — 153 (2.22 1.31 1.64) 60 — S — 177 (1.30 0.99 1.96) 60 — S — 183 (0.95 1.32 1.62) 60 — S — 192 (1.64 1.32 1.62)
60 — S — 207 (1.21 1.62 1.32) 60 — S — 215 (1.45 1.89 1.05) 60 — S — 231 (1.69 1.43 1.51) 60 — S — 233 (1.07 0.86 2.09)
60 — S — 234 (0.89 0.94 2.01) 60 — S — 237 (0.90 1.23 1.71) 60 — S — 244 (0.96 0.85 2.09) 60 — S — 246 (1.21 1.19 1.76)
60 — S — 248 (1.28 1.74 1.21) 60 — S — 255 (1.60 1.41 1.54) 60 — S — 265 (1.17 1.33 1.61) 60 — S — 266 (0.81 0.91 2.04)
60 — S — 268 (1.15 1.48 1.46) 60 — S — 269 (1.12 1.41 1.54) 60 — S — 271 (1.87 1.50 1.44) 60 — S — 290 (0.81 0.94 2.01)
60 — S — 291 (1.95 1.34 1.60) 60 — S — 292 (1.28 1.00 1.94) 60 — S — 294 (1.24 0.85 2.10) 60 — S — 295 (0.99 1.09 1.85)
60 — S — 296 (1.27 1.08 1.86) 60 — S — 306 (1.32 1.41 1.54) 60 — S — 307 (1.05 1.54 1.41) 60 — S — 320 (1.54 1.82 1.12)
60 — S — 327 (0.93 1.15 1.79) 60 — S — 329 (1.26 1.61 1.33) 60 — S — 342 (2.69 1.36 1.58) 60 — S — 343 (3.22 1.86 1.09)
60 — S — 364 (1.40 1.98 0.96) 60 — S — 367 (1.22 1.31 1.64) 60 — S — 368 (1.33 1.85 1.09) 60 — S — 371 (2.38 1.45 1.49)
60 — S — 395 (1.41 1.15 1.79) 60 — S — 440 (1.09 1.06 1.88) 60 — S — 441 (1.02 0.99 1.96) 60 — S — 447 (1.04 1.18 1.77)
60 — S — 451 (1.12 1.75 1.19) 60 — S — 452 (1.17 1.41 1.53) 60 — S — 460 (0.90 1.49 1.46) 60 — S — 463 (1.05 1.86 1.09)
60 — S — 473 (1.25 1.33 1.61) 60 — S — 474 (1.10 1.22 1.72) 61 — S — 57 (0.93 1.20 1.54) 61 — S — 125 (1.17 1.65 1.09)
61 — S — 152 (2.14 0.87 1.88) 61 — S — 250 (0.94 1.77 0.97) 61 — S — 320 (0.85 0.93 1.81) 61 — S — 324 (0.82 1.42 1.32)
61 — S — 343 (2.52 0.96 1.78) 61 — S — 429 (2.08 1.66 1.08) 61 — S — 472 (1.08 1.23 1.51) 62 — S — 57 (1.05 1.00 1.42)
62 — S — 125 (1.29 1.45 0.97) 62 — S — 259 (0.88 1.13 1.29) 62 — S — 324 (0.94 1.22 1.20) 62 — S — 364 (0.83 0.89 1.53)
62 — S — 429 (2.21 1.46 0.96) 62 — S — 472 (1.20 1.03 1.39) 63 — S — 20 (0.95 1.34 2.04) 63 — S — 27 (0.87 1.50 1.88)
63 — S — 28 (0.93 1.77 1.61) 63 — S — 36 (1.09 2.29 1.10) 63 — S — 43 (1.50 2.14 1.24) 63 — S — 46 (2.10 1.66 1.72)
63 — S — 56 (0.85 0.97 2.42) 63 — S — 61 (0.84 1.48 1.90) 63 — S — 65 (0.85 1.28 2.11) 63 — S — 70 (1.57 2.35 1.03)
63 — S — 79 (0.83 1.65 1.73) 63 — S — 81 (0.86 1.73 1.65) 63 — S — 83 (0.89 0.91 2.48) 63 — S — 85 (1.35 1.46 1.92)
63 — S — 89 (1.32 2.09 1.29) 63 — S — 90 (1.23 1.94 1.44) 63 — S — 101 (0.99 1.79 1.59) 63 — S — 105 (1.15 0.89 2.50)
63 — S — 107 (1.61 1.62 1.76) 63 — S — 108 (1.17 2.02 1.37) 63 — S — 109 (1.41 2.15 1.23) 63 — S — 110 (0.90 1.79 1.59)
63 — S — 111 (1.60 0.91 2.47) 63 — S — 113 (1.00 2.21 1.18) 63 — S — 115 (1.27 1.76 1.62) 63 — S — 118 (0.88 1.19 2.20)
63 — S — 119 (0.86 1.40 1.98) 63 — S — 131 (0.91 0.86 2.52) 63 — S — 132 (0.82 1.11 2.27) 63 — S — 133 (1.61 1.92 1.47)
63 — S — 144 (0.95 1.83 1.56) 63 — S — 145 (0.92 2.48 0.91) 63 — S — 150 (2.43 1.79 1.59) 63 — S — 151 (2.34 2.05 1.34)
63 — S — 152 (2.98 2.35 1.04) 63 — S — 153 (2.36 1.89 1.49) 63 — S — 154 (1.90 1.02 2.36) 63 — S — 166 (1.62 0.84 2.54)
63 — S — 171 (1.39 0.84 2.54) 63 — S — 177 (1.44 1.57 1.81) 63 — S — 183 (1.09 1.90 1.48) 63 — S — 184 (2.18 1.38 2.00)
63 — S — 192 (1.79 1.90 1.48) 63 — S — 195 (1.61 1.23 2.16) 63 — S — 198 (1.32 1.29 2.10) 63 — S — 205 (0.84 1.35 2.04)
63 — S — 206 (0.84 2.26 1.12) 63 — S — 207 (1.36 2.21 1.18) 63 — S — 208 (0.81 0.82 2.56) 63 — S — 213 (1.29 1.24 2.14)
63 — S — 215 (1.59 2.47 0.91) 63 — S — 231 (1.83 2.01 1.37) 63 — S — 233 (1.22 1.44 1.94) 63 — S — 234 (1.04 1.52 1.86)
63 — S — 237 (1.05 1.82 1.57) 63 — S — 244 (1.10 1.43 1.95) 63 — S — 245 (1.02 1.20 2.18) 63 — S — 246 (1.36 1.77 1.61)
63 — S — 248 (1.42 2.32 1.06) 63 — S — 249 (0.89 2.16 1.22) 63 — S — 251 (0.86 2.02 1.36) 63 — S — 254 (0.86 1.13 2.25)
63 — S — 255 (1.75 1.99 1.39) 63 — S — 258 (0.81 2.43 0.95) 63 — S — 260 (0.87 2.44 0.94) 63 — S — 265 (1.32 1.91 1.47)
63 — S — 266 (0.95 1.49 1.89) 63 — S — 268 (1.30 2.06 1.32) 63 — S — 269 (1.26 1.99 1.39) 63 — S — 271 (2.01 2.08 1.30)
63 — S — 277 (0.84 1.26 2.12) 63 — S — 279 (0.89 1.32 2.06) 63 — S — 286 (0.87 1.11 2.28) 63 — S — 289 (0.92 0.89 2.49)
63 — S — 290 (0.95 1.52 1.86) 63 — S — 291 (2.09 1.93 1.46) 63 — S — 292 (1.43 1.59 1.80) 63 — S — 293 (0.93 1.40 1.99)
63 — S — 294 (1.38 1.43 1.96) 63 — S — 295 (1.14 1.67 1.71) 63 — S — 296 (1.41 1.67 1.72) 63 — S — 298 (0.98 1.27 2.11)
63 — S — 305 (1.31 1.33 2.05) 63 — S — 306 (1.47 1.99 1.39) 63 — S — 307 (1.19 2.12 1.26) 63 — S — 320 (1.69 2.41 0.98)
63 — S — 327 (1.08 1.74 1.65) 63 — S — 329 (1.41 2.19 1.19) 63 — S — 331 (0.94 0.91 2.47) 63 — S — 336 (0.89 0.98 2.40)
63 — S — 342 (2.83 1.95 1.44) 63 — S — 343 (3.36 2.44 0.94) 63 — S — 367 (1.36 1.89 1.49) 63 — S — 368 (1.47 2.43 0.95)
63 — S — 371 (2.52 2.03 1.35) 63 — S — 372 (0.93 1.02 2.36) 63 — S — 395 (1.55 1.73 1.65) 63 — S — 396 (0.98 1.17 2.21)
63 — S — 437 (0.89 0.85 2.53) 63 — S — 440 (1.24 1.64 1.74) 63 — S — 441 (1.17 1.57 1.81) 63 — S — 447 (1.18 1.76 1.63)
63 — S — 449 (0.92 1.73 1.66) 63 — S — 451 (1.26 2.34 1.05) 63 — S — 452 (1.32 1.99 1.39) 63 — S — 460 (1.04 2.07 1.31)

63 — S — 463 (1.19 2.44 0.94) 63 — S — 471 (1.34 1.30 2.08) 63 — S — 473 (1.39 1.92 1.47) 63 — S — 474 (1.24 1.80 1.58)
64 — S — 20 (0.88 0.85 2.11) 64 — S — 28 (0.86 1.29 1.68) 64 — S — 36 (1.02 1.80 1.16) 64 — S — 43 (1.44 1.65 1.31)
64 — S — 46 (2.03 1.17 1.79) 64 — S — 70 (1.50 1.86 1.10) 64 — S — 85 (1.28 0.98 1.99) 64 — S — 89 (1.25 1.60 1.36)
64 — S — 90 (1.16 1.45 1.51) 64 — S — 101 (0.92 1.30 1.66) 64 — S — 107 (1.54 1.14 1.83) 64 — S — 108 (1.10 1.53 1.43)
64 — S — 109 (1.34 1.66 1.30) 64 — S — 110 (0.83 1.30 1.66) 64 — S — 113 (0.94 1.72 1.24) 64 — S — 115 (1.21 1.28 1.69)
64 — S — 133 (1.54 1.43 1.53) 64 — S — 144 (0.88 1.34 1.62) 64 — S — 145 (0.86 1.99 0.97) 64 — S — 150 (2.36 1.30 1.66)
64 — S — 151 (2.27 1.56 1.40) 64 — S — 152 (2.92 1.86 1.10) 64 — S — 153 (2.30 1.40 1.56) 64 — S — 177 (1.38 1.08 1.88)
64 — S — 183 (1.02 1.42 1.54) 64 — S — 184 (2.11 0.89 2.07) 64 — S — 192 (1.72 1.41 1.55) 64 — S — 207 (1.29 1.72 1.24)
64 — S — 215 (1.52 1.98 0.98) 64 — S — 231 (1.76 1.53 1.44) 64 — S — 233 (1.15 0.95 2.01) 64 — S — 234 (0.97 1.03 1.93)
64 — S — 237 (0.98 1.33 1.63) 64 — S — 244 (1.03 0.94 2.02) 64 — S — 246 (1.29 1.28 1.68) 64 — S — 248 (1.35 1.83 1.13)
64 — S — 249 (0.83 1.67 1.29) 64 — S — 255 (1.68 1.50 1.46) 64 — S — 260 (0.80 1.95 1.01) 64 — S — 265 (1.25 1.42 1.54)
64 — S — 266 (0.89 1.00 1.96) 64 — S — 268 (1.23 1.57 1.39) 64 — S — 269 (1.19 1.50 1.46) 64 — S — 271 (1.94 1.59 1.37)
64 — S — 279 (0.83 0.83 2.13) 64 — S — 290 (0.89 1.03 1.93) 64 — S — 291 (2.02 1.44 1.52) 64 — S — 292 (1.36 1.10 1.86)
64 — S — 293 (0.86 0.91 2.05) 64 — S — 294 (1.32 0.94 2.02) 64 — S — 295 (1.07 1.18 1.78) 64 — S — 296 (1.35 1.18 1.78)
64 — S — 305 (1.24 0.85 2.12) 64 — S — 306 (1.40 1.50 1.46) 64 — S — 307 (1.13 1.63 1.33) 64 — S — 320 (1.62 1.92 1.04)
64 — S — 327 (1.01 1.25 1.71) 64 — S — 329 (1.34 1.71 1.25) 64 — S — 342 (2.77 1.46 1.50) 64 — S — 343 (3.30 1.95 1.01)
64 — S — 367 (1.29 1.40 1.56) 64 — S — 368 (1.40 1.95 1.02) 64 — S — 371 (2.45 1.55 1.42) 64 — S — 395 (1.48 1.25 1.71)
64 — S — 440 (1.17 1.16 1.81) 64 — S — 441 (1.10 1.08 1.88) 64 — S — 447 (1.11 1.27 1.69) 64 — S — 449 (0.85 1.24 1.72)
64 — S — 451 (1.19 1.85 1.11) 64 — S — 452 (1.25 1.51 1.46) 64 — S — 460 (0.98 1.58 1.38) 64 — S — 463 (1.13 1.95 1.01)
64 — S — 471 (1.28 0.82 2.15) 64 — S — 473 (1.32 1.43 1.53) 64 — S — 474 (1.18 1.32 1.64) 65 — S — 57 (0.92 1.40 1.55)
65 — S — 125 (1.16 1.85 1.10) 65 — S — 152 (2.13 1.07 1.89) 65 — S — 250 (0.93 1.98 0.98) 65 — S — 271 (1.16 0.81 2.15)
65 — S — 320 (0.84 1.13 1.82) 65 — S — 324 (0.81 1.62 1.33) 65 — S — 343 (2.51 1.16 1.79) 65 — S — 429 (2.07 1.86 1.10)
65 — S — 472 (1.07 1.44 1.52) 66 — S — 5 (0.91 0.82 1.69) 66 — S — 9 (1.79 0.86 1.65) 66 — S — 11 (0.90 1.10 1.41)
66 — S — 20 (1.89 1.40 1.10) 66 — S — 27 (1.81 1.57 0.94) 66 — S — 29 (1.63 1.56 0.95) 66 — S — 38 (1.25 1.00 1.51)
66 — S — 40 (1.45 1.56 0.95) 66 — S — 45 (0.92 1.21 1.30) 66 — S — 48 (0.85 1.07 1.44) 66 — S — 56 (1.79 1.03 1.48)
66 — S — 61 (1.78 1.55 0.96) 66 — S — 65 (1.79 1.34 1.17) 66 — S — 68 (1.50 1.30 1.20) 66 — S — 74 (0.95 0.87 1.63)
66 — S — 83 (1.83 0.97 1.54) 66 — S — 85 (2.29 1.53 0.98) 66 — S — 96 (0.87 1.33 1.18) 66 — S — 102 (1.55 0.87 1.64)
66 — S — 105 (2.09 0.95 1.55) 66 — S — 111 (2.54 0.98 1.53) 66 — S — 112 (1.74 1.35 1.15) 66 — S — 118 (1.83 1.25 1.26)
66 — S — 119 (1.80 1.47 1.04) 66 — S — 123 (1.44 1.60 0.91) 66 — S — 131 (1.85 0.93 1.58) 66 — S — 132 (1.76 1.17 1.33)
66 — S — 138 (1.08 0.91 1.60) 66 — S — 147 (1.29 1.47 1.04) 66 — S — 154 (2.84 1.08 1.42) 66 — S — 166 (2.56 0.91 1.60)
66 — S — 171 (2.33 0.91 1.60) 66 — S — 184 (3.12 1.45 1.06) 66 — S — 187 (2.27 0.82 1.69) 66 — S — 188 (2.70 0.86 1.65)
66 — S — 193 (1.64 1.13 1.38) 66 — S — 195 (2.55 1.29 1.22) 66 — S — 198 (2.26 1.35 1.16) 66 — S — 205 (1.78 1.41 1.10)
66 — S — 208 (1.75 0.88 1.62) 66 — S — 209 (1.49 0.96 1.55) 66 — S — 211 (0.84 1.13 1.38) 66 — S — 213 (2.23 1.31 1.20)
66 — S — 217 (1.65 1.34 1.17) 66 — S — 218 (1.62 1.52 0.99) 66 — S — 219 (1.42 1.07 1.44) 66 — S — 222 (1.54 0.92 1.59)
66 — S — 225 (1.03 0.93 1.58) 66 — S — 227 (0.83 1.45 1.06) 66 — S — 228 (1.16 1.07 1.43) 66 — S — 233 (2.16 1.50 1.00)
66 — S — 234 (1.98 1.59 0.92) 66 — S — 244 (2.04 1.50 1.01) 66 — S — 245 (1.96 1.27 1.24) 66 — S — 254 (1.80 1.19 1.31)
66 — S — 266 (1.89 1.56 0.95) 66 — S — 267 (1.69 1.26 1.25) 66 — S — 274 (1.56 1.06 1.45) 66 — S — 275 (1.37 1.48 1.03)
66 — S — 277 (1.78 1.32 1.18) 66 — S — 279 (1.83 1.39 1.12) 66 — S — 280 (1.51 1.07 1.44) 66 — S — 282 (1.63 0.89 1.62)
66 — S — 284 (1.41 0.90 1.61) 66 — S — 285 (1.56 1.27 1.24) 66 — S — 286 (1.81 1.17 1.34) 66 — S — 287 (1.62 1.18 1.33)
66 — S — 288 (1.60 1.12 1.39) 66 — S — 289 (1.86 0.96 1.55) 66 — S — 290 (1.89 1.59 0.92) 66 — S — 293 (1.87 1.46 1.05)
66 — S — 294 (2.32 1.49 1.01) 66 — S — 297 (1.67 0.86 1.64) 66 — S — 298 (1.92 1.34 1.17) 66 — S — 304 (1.73 1.18 1.32)
66 — S — 305 (2.25 1.40 1.11) 66 — S — 311 (1.57 1.07 1.44) 66 — S — 312 (1.67 0.94 1.56) 66 — S — 313 (1.44 1.11 1.40)
66 — S — 316 (1.73 1.40 1.11) 66 — S — 319 (0.93 1.26 1.25) 66 — S — 330 (1.35 0.81 1.70) 66 — S — 331 (1.88 0.98 1.53)
66 — S — 332 (1.73 1.15 1.35) 66 — S — 336 (1.83 1.04 1.46) 66 — S — 356 (1.50 0.86 1.65) 66 — S — 358 (1.67 1.32 1.19)
66 — S — 370 (1.64 1.39 1.12) 66 — S — 372 (1.87 1.09 1.42) 66 — S — 373 (1.26 1.09 1.42) 66 — S — 374 (1.48 1.58 0.93)
66 — S — 378 (1.00 0.93 1.58) 66 — S — 379 (1.56 1.08 1.43) 66 — S — 381 (1.13 1.25 1.26) 66 — S — 382 (1.63 1.26 1.24)
66 — S — 391 (1.56 1.07 1.44) 66 — S — 396 (1.92 1.24 1.27) 66 — S — 397 (1.72 1.08 1.43) 66 — S — 415 (1.61 0.97 1.54)
66 — S — 419 (1.00 1.06 1.45) 66 — S — 434 (1.57 1.37 1.13) 66 — S — 435 (1.65 1.54 0.97) 66 — S — 437 (1.83 0.92 1.59)
66 — S — 450 (1.48 1.46 1.05) 66 — S — 454 (1.57 0.93 1.58) 66 — S — 455 (1.56 1.20 1.31) 66 — S — 456 (1.25 0.91 1.60)
66 — S — 458 (1.25 1.50 1.01) 66 — S — 467 (1.39 1.31 1.20) 66 — S — 471 (2.28 1.37 1.14) 66 — S — 475 (1.12 0.99 1.52)
66 — S — 476 (0.80 1.02 1.49) 68 — S — 43 (0.94 0.90 1.80) 68 — S — 57 (1.21 1.44 1.26) 68 — S — 70 (1.01 1.11 1.59)
68 — S — 109 (0.84 0.91 1.79) 68 — S — 151 (1.78 0.81 1.90) 68 — S — 152 (2.42 1.11 1.60) 68 — S — 215 (1.03 1.23 1.47)
68 — S — 247 (0.93 1.74 0.97) 68 — S — 248 (0.86 1.08 1.62) 68 — S — 259 (1.04 1.57 1.14) 68 — S — 270 (0.84 1.43 1.27)
68 — S — 271 (1.45 0.84 1.86) 68 — S — 320 (1.13 1.17 1.54) 68 — S — 324 (1.10 1.66 1.04) 68 — S — 329 (0.85 0.96 1.75)
68 — S — 343 (2.80 1.20 1.51) 68 — S — 364 (0.98 1.33 1.38) 68 — S — 368 (0.91 1.19 1.51) 68 — S — 472 (1.36 1.48 1.23)
71 — S — 20 (0.96 0.86 2.04) 71 — S — 27 (0.87 1.03 1.87) 71 — S — 28 (0.94 1.30 1.60) 71 — S — 36 (1.10 1.81 1.09)
71 — S — 43 (1.51 1.67 1.23) 71 — S — 46 (2.11 1.19 1.71) 71 — S — 61 (0.85 1.01 1.90) 71 — S — 65 (0.86 0.80 2.10)
71 — S — 70 (1.57 1.88 1.02) 71 — S — 79 (0.84 1.18 1.72) 71 — S — 81 (0.87 1.26 1.64) 71 — S — 85 (1.36 0.99 1.91)

71 — S — 89 (1.33 1.62 1.29) 71 — S — 90 (1.24 1.47 1.44) 71 — S — 101 (0.99 1.32 1.58) 71 — S — 107 (1.62 1.15 1.75)
71 — S — 108 (1.18 1.54 1.36) 71 — S — 109 (1.41 1.68 1.22) 71 — S — 110 (0.91 1.32 1.59) 71 — S — 112 (0.80 0.81 2.09)
71 — S — 113 (1.01 1.73 1.17) 71 — S — 115 (1.28 1.29 1.61) 71 — S — 119 (0.86 0.93 1.97) 71 — S — 133 (1.62 1.44 1.46)
71 — S — 144 (0.95 1.35 1.55) 71 — S — 150 (2.44 1.31 1.59) 71 — S — 151 (2.35 1.57 1.33) 71 — S — 152 (2.99 1.87 1.03)
71 — S — 153 (2.37 1.42 1.49) 71 — S — 177 (1.45 1.09 1.81) 71 — S — 183 (1.10 1.43 1.47) 71 — S — 184 (2.19 0.91 1.99)
71 — S — 192 (1.79 1.43 1.47) 71 — S — 198 (1.33 0.81 2.09) 71 — S — 205 (0.85 0.87 2.03) 71 — S — 206 (0.84 1.78 1.12)
71 — S — 207 (1.36 1.73 1.17) 71 — S — 215 (1.60 2.00 0.90) 71 — S — 231 (1.84 1.54 1.36) 71 — S — 233 (1.22 0.96 1.94)
71 — S — 234 (1.04 1.05 1.86) 71 — S — 237 (1.05 1.34 1.56) 71 — S — 244 (1.11 0.96 1.94) 71 — S — 246 (1.36 1.30 1.60)
71 — S — 248 (1.43 1.84 1.06) 71 — S — 249 (0.90 1.69 1.22) 71 — S — 251 (0.87 1.54 1.36) 71 — S — 255 (1.75 1.52 1.39)
71 — S — 258 (0.82 1.96 0.94) 71 — S — 260 (0.88 1.97 0.94) 71 — S — 265 (1.32 1.44 1.46) 71 — S — 266 (0.96 1.02 1.89)
71 — S — 268 (1.30 1.59 1.31) 71 — S — 269 (1.27 1.52 1.39) 71 — S — 271 (2.02 1.61 1.29) 71 — S — 279 (0.90 0.85 2.06)
71 — S — 290 (0.96 1.05 1.85) 71 — S — 291 (2.10 1.45 1.45) 71 — S — 292 (1.43 1.11 1.79) 71 — S — 293 (0.94 0.92 1.98)
71 — S — 294 (1.39 0.95 1.95) 71 — S — 295 (1.14 1.20 1.70) 71 — S — 296 (1.42 1.19 1.71) 71 — S — 305 (1.31 0.86 2.04)
71 — S — 306 (1.47 1.51 1.39) 71 — S — 307 (1.20 1.64 1.26) 71 — S — 320 (1.69 1.93 0.97) 71 — S — 327 (1.09 1.26 1.64)
71 — S — 329 (1.41 1.72 1.18) 71 — S — 342 (2.84 1.47 1.43) 71 — S — 343 (3.37 1.96 0.94) 71 — S — 367 (1.37 1.42 1.49)
71 — S — 368 (1.48 1.96 0.94) 71 — S — 371 (2.53 1.56 1.34) 71 — S — 395 (1.56 1.26 1.64) 71 — S — 440 (1.24 1.17 1.73)
71 — S — 441 (1.18 1.10 1.81) 71 — S — 447 (1.19 1.28 1.62) 71 — S — 449 (0.93 1.25 1.65) 71 — S — 451 (1.27 1.86 1.04)
71 — S — 452 (1.32 1.52 1.38) 71 — S — 460 (1.05 1.60 1.31) 71 — S — 463 (1.20 1.97 0.94) 71 — S — 471 (1.35 0.83 2.07)
71 — S — 473 (1.40 1.44 1.46) 71 — S — 474 (1.25 1.33 1.57) 72 — S — 9 (1.12 1.07 2.32) 72 — S — 20 (1.23 1.62 1.77)
72 — S — 27 (1.14 1.78 1.60) 72 — S — 28 (1.20 2.05 1.34) 72 — S — 29 (0.96 1.78 1.61) 72 — S — 43 (1.78 2.42 0.97)
72 — S — 44 (0.85 0.93 2.45) 72 — S — 46 (2.37 1.94 1.45) 72 — S — 56 (1.13 1.24 2.14) 72 — S — 61 (1.11 1.76 1.63)
72 — S — 62 (0.99 1.96 1.43) 72 — S — 65 (1.12 1.55 1.83) 72 — S — 68 (0.83 1.52 1.87) 72 — S — 79 (1.11 1.93 1.46)
72 — S — 80 (1.06 1.89 1.50) 72 — S — 81 (1.14 2.01 1.38) 72 — S — 82 (0.87 2.20 1.19) 72 — S — 83 (1.17 1.19 2.20)
72 — S — 85 (1.62 1.74 1.65) 72 — S — 86 (0.84 2.11 1.28) 72 — S — 89 (1.60 2.37 1.02) 72 — S — 90 (1.50 2.22 1.17)
72 — S — 101 (1.26 2.07 1.32) 72 — S — 102 (0.88 1.08 2.31) 72 — S — 105 (1.42 1.17 2.22) 72 — S — 107 (1.88 1.90 1.48)
72 — S — 108 (1.44 2.29 1.09) 72 — S — 109 (1.68 2.43 0.96) 72 — S — 110 (1.17 2.07 1.32) 72 — S — 111 (1.88 1.19 2.20)
72 — S — 112 (1.07 1.57 1.82) 72 — S — 113 (1.28 2.48 0.90) 72 — S — 115 (1.55 2.04 1.34) 72 — S — 118 (1.16 1.46 1.92)
72 — S — 119 (1.13 1.68 1.71) 72 — S — 131 (1.18 1.14 2.25) 72 — S — 132 (1.10 1.39 2.00) 72 — S — 133 (1.88 2.19 1.19)
72 — S — 144 (1.22 2.10 1.28) 72 — S — 148 (0.88 0.97 2.41) 72 — S — 150 (2.70 2.07 1.32) 72 — S — 151 (2.61 2.32 1.06)
72 — S — 153 (2.64 2.17 1.22) 72 — S — 154 (2.17 1.30 2.09) 72 — S — 166 (1.89 1.12 2.26) 72 — S — 167 (1.75 0.81 2.58)
72 — S — 171 (1.66 1.12 2.27) 72 — S — 177 (1.72 1.85 1.54) 72 — S — 183 (1.37 2.18 1.20) 72 — S — 184 (2.45 1.66 1.73)
72 — S — 187 (1.60 1.03 2.36) 72 — S — 188 (2.03 1.07 2.32) 72 — S — 192 (2.06 2.18 1.21) 72 — S — 193 (0.98 1.34 2.05)
72 — S — 195 (1.88 1.50 1.88) 72 — S — 198 (1.60 1.56 1.82) 72 — S — 205 (1.12 1.62 1.76) 72 — S — 207 (1.63 2.48 0.90)
72 — S — 208 (1.08 1.10 2.29) 72 — S — 209 (0.83 1.17 2.21) 72 — S — 213 (1.56 1.52 1.87) 72 — S — 217 (0.99 1.55 1.83)
72 — S — 218 (0.96 1.73 1.66) 72 — S — 222 (0.87 1.13 2.25) 72 — S — 231 (2.10 2.29 1.09) 72 — S — 233 (1.49 1.72 1.67)
72 — S — 234 (1.31 1.80 1.59) 72 — S — 237 (1.32 2.09 1.29) 72 — S — 243 (2.06 0.92 2.46) 72 — S — 244 (1.37 1.71 1.68)
72 — S — 245 (1.29 1.48 1.90) 72 — S — 246 (1.63 2.05 1.34) 72 — S — 249 (1.17 2.44 0.95) 72 — S — 251 (1.14 2.30 1.09)
72 — S — 254 (1.13 1.41 1.98) 72 — S — 255 (2.02 2.27 1.12) 72 — S — 265 (1.59 2.19 1.20) 72 — S — 266 (1.23 1.77 1.62)
72 — S — 267 (1.03 1.47 1.92) 72 — S — 268 (1.57 2.34 1.05) 72 — S — 269 (1.53 2.27 1.12) 72 — S — 271 (2.28 2.36 1.03)
72 — S — 272 (1.41 0.81 2.57) 72 — S — 274 (0.90 1.27 2.12) 72 — S — 277 (1.11 1.54 1.85) 72 — S — 279 (1.17 1.60 1.79)
72 — S — 280 (0.85 1.28 2.11) 72 — S — 282 (0.97 1.10 2.28) 72 — S — 285 (0.89 1.48 1.91) 72 — S — 286 (1.14 1.38 2.00)
72 — S — 287 (0.95 1.39 1.99) 72 — S — 288 (0.94 1.33 2.05) 72 — S — 289 (1.20 1.17 2.21) 72 — S — 290 (1.23 1.80 1.59)
72 — S — 291 (2.37 2.20 1.18) 72 — S — 292 (1.70 1.86 1.52) 72 — S — 293 (1.20 1.67 1.71) 72 — S — 294 (1.66 1.71 1.68)
72 — S — 295 (1.41 1.95 1.44) 72 — S — 296 (1.69 1.95 1.44) 72 — S — 297 (1.00 1.08 2.31) 72 — S — 298 (1.26 1.55 1.84)
72 — S — 300 (1.26 0.95 2.44) 72 — S — 303 (1.02 0.92 2.46) 72 — S — 304 (1.06 1.40 1.99) 72 — S — 305 (1.58 1.61 1.77)
72 — S — 306 (1.74 2.27 1.12) 72 — S — 307 (1.47 2.40 0.99) 72 — S — 310 (1.18 1.01 2.38) 72 — S — 311 (0.90 1.28 2.10)
72 — S — 312 (1.00 1.16 2.23) 72 — S — 316 (1.06 1.61 1.78) 72 — S — 327 (1.35 2.01 1.37) 72 — S — 329 (1.68 2.47 0.91)
72 — S — 331 (1.21 1.19 2.20) 72 — S — 332 (1.07 1.37 2.02) 72 — S — 336 (1.17 1.26 2.13) 72 — S — 342 (3.11 2.22 1.16)
72 — S — 356 (0.83 1.07 2.31) 72 — S — 357 (1.53 0.82 2.57) 72 — S — 358 (1.01 1.53 1.86) 72 — S — 367 (1.63 2.17 1.22)
72 — S — 370 (0.98 1.60 1.79) 72 — S — 371 (2.80 2.31 1.07) 72 — S — 372 (1.21 1.30 2.09) 72 — S — 374 (0.82 1.79 1.60)
72 — S — 379 (0.89 1.29 2.09) 72 — S — 382 (0.96 1.48 1.91) 72 — S — 391 (0.90 1.28 2.11) 72 — S — 395 (1.83 2.01 1.37)
72 — S — 396 (1.25 1.45 1.94) 72 — S — 397 (1.05 1.29 2.09) 72 — S — 415 (0.95 1.18 2.21) 72 — S — 430 (0.84 2.11 1.27)
72 — S — 434 (0.90 1.59 1.80) 72 — S — 435 (0.99 1.75 1.63) 72 — S — 437 (1.17 1.13 2.26) 72 — S — 440 (1.51 1.92 1.47)
72 — S — 441 (1.44 1.85 1.54) 72 — S — 443 (0.92 2.46 0.92) 72 — S — 447 (1.45 2.04 1.35) 72 — S — 449 (1.19 2.00 1.38)
72 — S — 450 (0.82 1.67 1.72) 72 — S — 452 (1.59 2.27 1.12) 72 — S — 453 (1.08 0.98 2.41) 72 — S — 454 (0.91 1.14 2.25)
72 — S — 455 (0.89 1.41 1.98) 72 — S — 457 (1.04 1.92 1.47) 72 — S — 459 (0.83 2.15 1.24) 72 — S — 460 (1.32 2.35 1.04)
72 — S — 461 (1.03 2.11 1.28) 72 — S — 468 (0.92 1.82 1.56) 72 — S — 469 (1.01 2.25 1.14) 72 — S — 471 (1.62 1.58 1.81)
72 — S — 473 (1.66 2.19 1.19) 72 — S — 474 (1.52 2.08 1.30) 73 — S — 9 (1.02 1.10 2.42) 73 — S — 20 (1.12 1.65 1.87)

73 — S — 27 (1.04 1.81 1.71) 73 — S — 28 (1.10 2.08 1.44) 73 — S — 29 (0.86 1.81 1.71) 73 — S — 36 (1.26 2.60 0.93)
73 — S — 43 (1.67 2.45 1.07) 73 — S — 46 (2.27 1.97 1.55) 73 — S — 56 (1.02 1.28 2.25) 73 — S — 61 (1.01 1.79 1.73)
73 — S — 62 (0.89 1.99 1.53) 73 — S — 65 (1.02 1.59 1.94) 73 — S — 79 (1.00 1.96 1.56) 73 — S — 80 (0.96 1.92 1.60)
73 — S — 81 (1.03 2.04 1.48) 73 — S — 83 (1.06 1.22 2.30) 73 — S — 85 (1.52 1.77 1.75) 73 — S — 89 (1.49 2.40 1.12)
73 — S — 90 (1.40 2.25 1.27) 73 — S — 101 (1.16 2.10 1.42) 73 — S — 105 (1.32 1.20 2.32) 73 — S — 107 (1.78 1.93 1.59)
73 — S — 108 (1.34 2.33 1.20) 73 — S — 109 (1.58 2.46 1.06) 73 — S — 110 (1.07 2.10 1.42) 73 — S — 111 (1.77 1.22 2.30)
73 — S — 112 (0.97 1.60 1.92) 73 — S — 113 (1.18 2.52 1.01) 73 — S — 115 (1.45 2.07 1.45) 73 — S — 118 (1.06 1.50 2.03)
73 — S — 119 (1.03 1.71 1.81) 73 — S — 131 (1.08 1.17 2.35) 73 — S — 132 (0.99 1.42 2.10) 73 — S — 133 (1.78 2.23 1.30)
73 — S — 144 (1.12 2.14 1.39) 73 — S — 150 (2.60 2.10 1.42) 73 — S — 151 (2.51 2.36 1.17) 73 — S — 153 (2.53 2.20 1.32)
73 — S — 154 (2.07 1.33 2.19) 73 — S — 166 (1.79 1.15 2.37) 73 — S — 167 (1.65 0.84 2.68) 73 — S — 171 (1.56 1.15 2.37)
73 — S — 177 (1.61 1.88 1.64) 73 — S — 183 (1.26 2.21 1.31) 73 — S — 184 (2.35 1.69 1.83) 73 — S — 187 (1.50 1.06 2.46)
73 — S — 188 (1.93 1.10 2.42) 73 — S — 192 (1.96 2.21 1.31) 73 — S — 193 (0.87 1.37 2.15) 73 — S — 194 (1.73 0.82 2.71)
73 — S — 195 (1.78 1.54 1.99) 73 — S — 198 (1.49 1.60 1.93) 73 — S — 205 (1.01 1.66 1.87) 73 — S — 206 (1.01 2.57 0.95)
73 — S — 207 (1.53 2.52 1.01) 73 — S — 208 (0.98 1.13 2.39) 73 — S — 213 (1.46 1.55 1.97) 73 — S — 217 (0.88 1.58 1.94)
73 — S — 218 (0.85 1.76 1.76) 73 — S — 231 (2.00 2.32 1.20) 73 — S — 233 (1.39 1.75 1.77) 73 — S — 234 (1.21 1.83 1.69)
73 — S — 237 (1.22 2.13 1.40) 73 — S — 243 (1.96 0.96 2.57) 73 — S — 244 (1.27 1.74 1.78) 73 — S — 245 (1.19 1.51 2.01)
73 — S — 246 (1.53 2.08 1.44) 73 — S — 249 (1.06 2.47 1.05) 73 — S — 251 (1.03 2.33 1.19) 73 — S — 254 (1.03 1.44 2.08)
73 — S — 255 (1.92 2.30 1.22) 73 — S — 265 (1.49 2.22 1.30) 73 — S — 266 (1.12 1.80 1.72) 73 — S — 267 (0.92 1.50 2.02)
73 — S — 268 (1.47 2.37 1.15) 73 — S — 269 (1.43 2.30 1.22) 73 — S — 271 (2.18 2.39 1.13) 73 — S — 272 (1.31 0.84 2.68)
73 — S — 277 (1.01 1.57 1.95) 73 — S — 279 (1.06 1.63 1.89) 73 — S — 282 (0.86 1.14 2.39) 73 — S — 286 (1.04 1.42 2.11)
73 — S — 287 (0.85 1.43 2.10) 73 — S — 288 (0.83 1.37 2.16) 73 — S — 289 (1.09 1.20 2.32) 73 — S — 290 (1.12 1.83 1.69)
73 — S — 291 (2.26 2.24 1.29) 73 — S — 292 (1.60 1.90 1.63) 73 — S — 293 (1.10 1.71 1.82) 73 — S — 294 (1.55 1.74 1.78)
73 — S — 295 (1.31 1.98 1.54) 73 — S — 296 (1.59 1.98 1.54) 73 — S — 297 (0.90 1.11 2.41) 73 — S — 298 (1.15 1.58 1.94)
73 — S — 300 (1.16 0.98 2.54) 73 — S — 303 (0.92 0.95 2.57) 73 — S — 304 (0.96 1.43 2.09) 73 — S — 305 (1.48 1.64 1.88)
73 — S — 306 (1.64 2.30 1.22) 73 — S — 307 (1.37 2.43 1.09) 73 — S — 310 (1.07 1.04 2.48) 73 — S — 312 (0.90 1.19 2.33)
73 — S — 316 (0.96 1.64 1.88) 73 — S — 327 (1.25 2.05 1.48) 73 — S — 329 (1.58 2.51 1.02) 73 — S — 331 (1.11 1.22 2.30)
73 — S — 332 (0.96 1.40 2.12) 73 — S — 336 (1.06 1.29 2.23) 73 — S — 342 (3.00 2.26 1.27) 73 — S — 357 (1.42 0.85 2.67)
73 — S — 358 (0.91 1.56 1.96) 73 — S — 367 (1.53 2.20 1.32) 73 — S — 370 (0.87 1.63 1.89) 73 — S — 371 (2.69 2.34 1.18)
73 — S — 372 (1.10 1.33 2.19) 73 — S — 382 (0.86 1.51 2.01) 73 — S — 395 (1.72 2.04 1.48) 73 — S — 396 (1.15 1.48 2.04)
73 — S — 397 (0.95 1.33 2.20) 73 — S — 415 (0.84 1.21 2.31) 73 — S — 420 (0.90 2.52 1.00) 73 — S — 432 (0.97 0.82 2.70)
73 — S — 435 (0.88 1.79 1.74) 73 — S — 437 (1.06 1.16 2.36) 73 — S — 440 (1.41 1.95 1.57) 73 — S — 441 (1.34 1.88 1.64)
73 — S — 443 (0.81 2.50 1.03) 73 — S — 447 (1.35 2.07 1.45) 73 — S — 449 (1.09 2.04 1.49) 73 — S — 452 (1.49 2.30 1.22)
73 — S — 453 (0.98 1.01 2.51) 73 — S — 454 (0.80 1.17 2.35) 73 — S — 457 (0.94 1.95 1.57) 73 — S — 460 (1.21 2.38 1.14)
73 — S — 461 (0.93 2.14 1.38) 73 — S — 468 (0.82 1.85 1.67) 73 — S — 469 (0.91 2.28 1.24) 73 — S — 471 (1.51 1.61 1.91)
73 — S — 473 (1.56 2.23 1.30) 73 — S — 474 (1.41 2.11 1.41) 74 — S — 28 (0.92 0.96 1.61) 74 — S — 36 (1.08 1.48 1.10)
74 — S — 43 (1.50 1.33 1.25) 74 — S — 46 (2.09 0.85 1.73) 74 — S — 70 (1.56 1.54 1.04) 74 — S — 79 (0.83 0.84 1.74)
74 — S — 81 (0.86 0.92 1.65) 74 — S — 89 (1.32 1.28 1.30) 74 — S — 90 (1.23 1.13 1.45) 74 — S — 101 (0.98 0.98 1.60)
74 — S — 107 (1.60 0.82 1.76) 74 — S — 108 (1.16 1.21 1.37) 74 — S — 109 (1.40 1.34 1.24) 74 — S — 110 (0.90 0.98 1.60)
74 — S — 113 (1.00 1.40 1.18) 74 — S — 115 (1.27 0.96 1.62) 74 — S — 133 (1.61 1.11 1.47) 74 — S — 144 (0.94 1.02 1.56)
74 — S — 145 (0.92 1.67 0.91) 74 — S — 150 (2.43 0.98 1.60) 74 — S — 151 (2.33 1.24 1.34) 74 — S — 152 (2.98 1.54 1.04)
74 — S — 153 (2.36 1.08 1.50) 74 — S — 183 (1.09 1.10 1.48) 74 — S — 192 (1.78 1.09 1.49) 74 — S — 206 (0.83 1.45 1.13)
74 — S — 207 (1.35 1.40 1.18) 74 — S — 215 (1.58 1.66 0.92) 74 — S — 231 (1.83 1.21 1.37) 74 — S — 237 (1.04 1.01 1.57)
74 — S — 246 (1.35 0.96 1.62) 74 — S — 248 (1.42 1.51 1.07) 74 — S — 249 (0.89 1.35 1.23) 74 — S — 251 (0.86 1.21 1.37)
74 — S — 255 (1.74 1.18 1.40) 74 — S — 258 (0.81 1.62 0.95) 74 — S — 260 (0.87 1.63 0.95) 74 — S — 265 (1.31 1.10 1.48)
74 — S — 268 (1.29 1.25 1.33) 74 — S — 269 (1.25 1.18 1.40) 74 — S — 271 (2.00 1.27 1.31) 74 — S — 291 (2.09 1.12 1.46)
74 — S — 295 (1.13 0.86 1.72) 74 — S — 296 (1.41 0.86 1.72) 74 — S — 306 (1.46 1.18 1.40) 74 — S — 307 (1.19 1.31 1.27)
74 — S — 320 (1.68 1.60 0.98) 74 — S — 327 (1.07 0.93 1.65) 74 — S — 329 (1.40 1.39 1.19) 74 — S — 342 (2.83 1.14 1.44)
74 — S — 343 (3.36 1.63 0.95) 74 — S — 367 (1.36 1.08 1.50) 74 — S — 368 (1.47 1.62 0.96) 74 — S — 371 (2.52 1.23 1.35)
74 — S — 395 (1.55 0.93 1.65) 74 — S — 440 (1.23 0.83 1.74) 74 — S — 447 (1.17 0.95 1.63) 74 — S — 449 (0.92 0.92 1.66)
74 — S — 451 (1.26 1.53 1.05) 74 — S — 452 (1.31 1.18 1.39) 74 — S — 460 (1.04 1.26 1.32) 74 — S — 463 (1.19 1.63 0.95)
74 — S — 473 (1.39 1.11 1.47) 74 — S — 474 (1.24 1.00 1.58) 75 — S — 27 (1.48 0.90 1.26) 75 — S — 28 (1.55 1.17 0.99)
75 — S — 29 (1.31 0.89 1.27) 75 — S — 40 (1.13 0.89 1.27) 75 — S — 46 (2.72 1.06 1.10) 75 — S — 61 (1.46 0.88 1.28)
75 — S — 62 (1.34 1.08 1.08) 75 — S — 79 (1.45 1.05 1.11) 75 — S — 80 (1.40 1.01 1.15) 75 — S — 81 (1.48 1.13 1.03)
75 — S — 85 (1.97 0.86 1.30) 75 — S — 86 (1.18 1.23 0.93) 75 — S — 101 (1.60 1.19 0.97) 75 — S — 107 (2.23 1.02 1.14)
75 — S — 110 (1.52 1.19 0.97) 75 — S — 115 (1.89 1.16 1.00) 75 — S — 123 (1.12 0.93 1.23) 75 — S — 144 (1.56 1.22 0.94)
75 — S — 150 (3.05 1.19 0.98) 75 — S — 177 (2.06 0.97 1.20) 75 — S — 218 (1.30 0.85 1.31) 75 — S — 233 (1.83 0.84 1.33)
75 — S — 234 (1.65 0.92 1.24) 75 — S — 237 (1.66 1.21 0.95) 75 — S — 238 (0.96 1.07 1.09) 75 — S — 244 (1.72 0.83 1.33)
75 — S — 246 (1.97 1.17 0.99) 75 — S — 266 (1.57 0.89 1.28) 75 — S — 275 (1.05 0.81 1.35) 75 — S — 290 (1.57 0.92 1.24)

| | | | |
|---|---|---|---|
| 75 — S — 292 (2.04 0.98 1.18) | 75 — S — 294 (2.00 0.82 1.34) | 75 — S — 295 (1.76 1.07 1.09) | 75 — S — 296 (2.03 1.06 1.10) |
| 75 — S — 299 (0.86 1.01 1.15) | 75 — S — 327 (1.70 1.13 1.03) | 75 — S — 341 (1.01 1.00 1.16) | 75 — S — 374 (1.16 0.91 1.25) |
| 75 — S — 395 (2.17 1.13 1.03) | 75 — S — 430 (1.18 1.23 0.93) | 75 — S — 435 (1.33 0.87 1.29) | 75 — S — 440 (1.86 1.04 1.12) |
| 75 — S — 441 (1.79 0.97 1.19) | 75 — S — 447 (1.80 1.15 1.01) | 75 — S — 449 (1.54 1.12 1.04) | 75 — S — 457 (1.38 1.03 1.13) |
| 75 — S — 458 (0.93 0.83 1.33) | 75 — S — 461 (1.38 1.23 0.93) | 75 — S — 462 (1.07 1.24 0.92) | 75 — S — 468 (1.26 0.94 1.22) |
| 75 — S — 474 (1.86 1.20 0.96) | 76 — S — 11 (0.90 0.88 1.40) | 76 — S — 20 (1.90 1.19 1.09) | 76 — S — 27 (1.81 1.35 0.93) |
| 76 — S — 29 (1.64 1.35 0.94) | 76 — S — 40 (1.46 1.35 0.94) | 76 — S — 45 (0.93 0.99 1.29) | 76 — S — 48 (0.86 0.85 1.43) |
| 76 — S — 56 (1.80 0.82 1.47) | 76 — S — 61 (1.79 1.33 0.95) | 76 — S — 65 (1.80 1.12 1.16) | 76 — S — 68 (1.51 1.09 1.19) |
| 76 — S — 85 (2.30 1.31 0.97) | 76 — S — 96 (0.88 1.12 1.17) | 76 — S — 112 (1.74 1.14 1.15) | 76 — S — 118 (1.83 1.04 1.25) |
| 76 — S — 119 (1.81 1.25 1.03) | 76 — S — 123 (1.45 1.38 0.90) | 76 — S — 132 (1.77 0.96 1.32) | 76 — S — 147 (1.30 1.25 1.03) |
| 76 — S — 154 (2.85 0.87 1.42) | 76 — S — 184 (3.13 1.23 1.05) | 76 — S — 193 (1.65 0.91 1.37) | 76 — S — 195 (2.56 1.07 1.21) |
| 76 — S — 198 (2.27 1.13 1.15) | 76 — S — 205 (1.79 1.19 1.09) | 76 — S — 211 (0.85 0.91 1.37) | 76 — S — 213 (2.24 1.09 1.19) |
| 76 — S — 217 (1.66 1.12 1.16) | 76 — S — 218 (1.63 1.30 0.98) | 76 — S — 219 (1.43 0.86 1.43) | 76 — S — 227 (0.83 1.23 1.05) |
| 76 — S — 228 (1.17 0.86 1.43) | 76 — S — 233 (2.17 1.29 0.99) | 76 — S — 234 (1.99 1.37 0.91) | 76 — S — 244 (2.05 1.28 1.00) |
| 76 — S — 245 (1.97 1.05 1.23) | 76 — S — 254 (1.80 0.98 1.31) | 76 — S — 266 (1.90 1.34 0.94) | 76 — S — 267 (1.70 1.04 1.24) |
| 76 — S — 274 (1.57 0.84 1.44) | 76 — S — 275 (1.38 1.26 1.02) | 76 — S — 277 (1.79 1.11 1.18) | 76 — S — 279 (1.84 1.17 1.11) |
| 76 — S — 280 (1.52 0.85 1.43) | 76 — S — 285 (1.57 1.05 1.23) | 76 — S — 286 (1.82 0.95 1.33) | 76 — S — 287 (1.63 0.97 1.32) |
| 76 — S — 288 (1.61 0.91 1.38) | 76 — S — 290 (1.90 1.37 0.91) | 76 — S — 293 (1.88 1.24 1.04) | 76 — S — 294 (2.33 1.28 1.01) |
| 76 — S — 298 (1.93 1.12 1.16) | 76 — S — 304 (1.74 0.97 1.32) | 76 — S — 305 (2.25 1.18 1.10) | 76 — S — 311 (1.58 0.85 1.43) |
| 76 — S — 313 (1.45 0.89 1.39) | 76 — S — 316 (1.74 1.18 1.10) | 76 — S — 319 (0.94 1.04 1.24) | 76 — S — 332 (1.74 0.94 1.35) |
| 76 — S — 336 (1.84 0.83 1.46) | 76 — S — 358 (1.68 1.10 1.18) | 76 — S — 370 (1.65 1.17 1.11) | 76 — S — 372 (1.88 0.87 1.41) |
| 76 — S — 373 (1.27 0.87 1.41) | 76 — S — 374 (1.49 1.36 0.92) | 76 — S — 379 (1.57 0.87 1.42) | 76 — S — 381 (1.14 1.03 1.25) |
| 76 — S — 382 (1.63 1.05 1.24) | 76 — S — 391 (1.57 0.85 1.43) | 76 — S — 396 (1.93 1.02 1.26) | 76 — S — 397 (1.73 0.87 1.42) |
| 76 — S — 419 (1.01 0.85 1.44) | 76 — S — 434 (1.58 1.16 1.13) | 76 — S — 435 (1.66 1.33 0.96) | 76 — S — 450 (1.49 1.24 1.04) |
| 76 — S — 455 (1.57 0.98 1.30) | 76 — S — 458 (1.26 1.28 1.00) | 76 — S — 467 (1.40 1.09 1.19) | 76 — S — 471 (2.29 1.15 1.13) |
| 76 — S — 476 (0.81 0.80 1.48) | 77 — S — 20 (1.42 1.07 1.58) | 77 — S — 27 (1.33 1.24 1.41) | 77 — S — 28 (1.39 1.51 1.15) |
| 77 — S — 29 (1.15 1.23 1.42) | 77 — S — 40 (0.98 1.23 1.42) | 77 — S — 46 (2.56 1.40 1.26) | 77 — S — 61 (1.30 1.22 1.44) |
| 77 — S — 62 (1.18 1.42 1.24) | 77 — S — 65 (1.31 1.01 1.64) | 77 — S — 68 (1.02 0.97 1.68) | 77 — S — 79 (1.30 1.39 1.27) |
| 77 — S — 80 (1.25 1.35 1.31) | 77 — S — 81 (1.33 1.47 1.19) | 77 — S — 82 (1.06 1.66 1.00) | 77 — S — 85 (1.81 1.20 1.46) |
| 77 — S — 86 (1.03 1.57 1.09) | 77 — S — 90 (1.69 1.67 0.98) | 77 — S — 101 (1.45 1.53 1.13) | 77 — S — 107 (2.07 1.36 1.29) |
| 77 — S — 108 (1.63 1.75 0.90) | 77 — S — 110 (1.36 1.53 1.13) | 77 — S — 112 (1.26 1.02 1.63) | 77 — S — 115 (1.74 1.50 1.15) |
| 77 — S — 118 (1.35 0.92 1.73) | 77 — S — 119 (1.32 1.14 1.52) | 77 — S — 123 (0.96 1.27 1.39) | 77 — S — 132 (1.29 0.84 1.81) |
| 77 — S — 133 (2.07 1.65 1.00) | 77 — S — 144 (1.41 1.56 1.09) | 77 — S — 147 (0.81 1.14 1.52) | 77 — S — 150 (2.89 1.52 1.13) |
| 77 — S — 153 (2.83 1.63 1.03) | 77 — S — 177 (1.91 1.30 1.35) | 77 — S — 183 (1.56 1.64 1.01) | 77 — S — 184 (2.64 1.12 1.54) |
| 77 — S — 192 (2.25 1.64 1.02) | 77 — S — 195 (2.07 0.96 1.69) | 77 — S — 198 (1.79 1.02 1.63) | 77 — S — 205 (1.31 1.08 1.57) |
| 77 — S — 213 (1.75 0.98 1.68) | 77 — S — 217 (1.18 1.01 1.64) | 77 — S — 218 (1.15 1.19 1.47) | 77 — S — 231 (2.29 1.75 0.90) |
| 77 — S — 233 (1.68 1.17 1.48) | 77 — S — 234 (1.50 1.26 1.40) | 77 — S — 237 (1.51 1.55 1.10) | 77 — S — 238 (0.81 1.41 1.24) |
| 77 — S — 244 (1.56 1.17 1.49) | 77 — S — 245 (1.48 0.94 1.71) | 77 — S — 246 (1.82 1.51 1.15) | 77 — S — 251 (1.33 1.75 0.90) |
| 77 — S — 254 (1.32 0.86 1.79) | 77 — S — 255 (2.21 1.73 0.93) | 77 — S — 265 (1.78 1.65 1.01) | 77 — S — 266 (1.42 1.22 1.43) |
| 77 — S — 267 (1.22 0.92 1.73) | 77 — S — 269 (1.72 1.73 0.93) | 77 — S — 275 (0.89 1.15 1.51) | 77 — S — 277 (1.30 0.99 1.66) |
| 77 — S — 279 (1.36 1.06 1.60) | 77 — S — 285 (1.08 0.94 1.72) | 77 — S — 286 (1.33 0.84 1.81) | 77 — S — 287 (1.14 0.85 1.80) |
| 77 — S — 290 (1.42 1.26 1.40) | 77 — S — 291 (2.56 1.66 0.99) | 77 — S — 292 (1.89 1.32 1.33) | 77 — S — 293 (1.39 1.13 1.52) |
| 77 — S — 294 (1.85 1.16 1.49) | 77 — S — 295 (1.60 1.41 1.25) | 77 — S — 296 (1.88 1.40 1.25) | 77 — S — 298 (1.45 1.01 1.65) |
| 77 — S — 304 (1.25 0.85 1.80) | 77 — S — 305 (1.77 1.07 1.58) | 77 — S — 306 (1.93 1.72 0.93) | 77 — S — 316 (1.25 1.07 1.59) |
| 77 — S — 327 (1.54 1.47 1.18) | 77 — S — 332 (1.26 0.82 1.83) | 77 — S — 341 (0.85 1.34 1.31) | 77 — S — 342 (3.30 1.68 0.97) |
| 77 — S — 358 (1.20 0.99 1.67) | 77 — S — 367 (1.82 1.63 1.03) | 77 — S — 370 (1.17 1.06 1.60) | 77 — S — 374 (1.01 1.25 1.41) |
| 77 — S — 382 (1.15 0.93 1.72) | 77 — S — 395 (2.02 1.47 1.18) | 77 — S — 396 (1.44 0.91 1.75) | 77 — S — 430 (1.03 1.57 1.08) |
| 77 — S — 434 (1.09 1.04 1.61) | 77 — S — 435 (1.18 1.21 1.44) | 77 — S — 440 (1.70 1.38 1.28) | 77 — S — 441 (1.63 1.31 1.35) |
| 77 — S — 447 (1.64 1.49 1.16) | 77 — S — 449 (1.38 1.46 1.19) | 77 — S — 450 (1.01 1.13 1.53) | 77 — S — 452 (1.78 1.73 0.93) |
| 77 — S — 455 (1.08 0.87 1.79) | 77 — S — 457 (1.23 1.37 1.28) | 77 — S — 459 (1.02 1.61 1.05) | 77 — S — 461 (1.22 1.57 1.09) |
| 77 — S — 462 (0.91 1.58 1.07) | 77 — S — 467 (0.91 0.98 1.68) | 77 — S — 468 (1.11 1.28 1.37) | 77 — S — 469 (1.20 1.71 0.95) |
| 77 — S — 471 (1.81 1.04 1.62) | 77 — S — 473 (1.85 1.65 1.00) | 77 — S — 474 (1.71 1.54 1.11) | 78 — S — 20 (1.59 1.13 1.40) |
| 78 — S — 27 (1.51 1.29 1.24) | 78 — S — 28 (1.57 1.56 0.97) | 78 — S — 29 (1.33 1.29 1.25) | 78 — S — 40 (1.15 1.28 1.25) |
| 78 — S — 46 (2.74 1.45 1.08) | 78 — S — 61 (1.48 1.27 1.26) | 78 — S — 62 (1.36 1.47 1.06) | 78 — S — 65 (1.49 1.06 1.47) |
| 78 — S — 68 (1.20 1.03 1.50) | 78 — S — 79 (1.47 1.44 1.09) | 78 — S — 80 (1.43 1.40 1.13) | 78 — S — 81 (1.50 1.52 1.01) |
| 78 — S — 85 (1.99 1.25 1.28) | 78 — S — 86 (1.21 1.62 0.91) | 78 — S — 101 (1.63 1.58 0.95) | 78 — S — 107 (2.25 1.41 1.12) |
| 78 — S — 110 (1.54 1.58 0.95) | 78 — S — 112 (1.44 1.08 1.45) | 78 — S — 115 (1.91 1.55 0.98) | 78 — S — 118 (1.53 0.97 1.56) |
| 78 — S — 119 (1.50 1.19 1.34) | 78 — S — 123 (1.14 1.32 1.21) | 78 — S — 132 (1.46 0.90 1.63) | 78 — S — 144 (1.59 1.61 0.92) |

78 — S — 147 (0.99 1.19 1.34) 78 — S — 150 (3.07 1.58 0.95) 78 — S — 154 (2.54 0.81 1.72) 78 — S — 177 (2.08 1.36 1.17)
78 — S — 184 (2.82 1.17 1.36) 78 — S — 193 (1.34 0.85 1.68) 78 — S — 195 (2.25 1.01 1.52) 78 — S — 198 (1.96 1.07 1.46)
78 — S — 205 (1.48 1.13 1.40) 78 — S — 213 (1.93 1.03 1.50) 78 — S — 217 (1.35 1.06 1.47) 78 — S — 218 (1.32 1.24 1.29)
78 — S — 233 (1.86 1.23 1.30) 78 — S — 234 (1.68 1.31 1.22) 78 — S — 237 (1.69 1.60 0.93) 78 — S — 238 (0.98 1.46 1.07)
78 — S — 244 (1.74 1.22 1.31) 78 — S — 245 (1.66 0.99 1.54) 78 — S — 246 (2.00 1.56 0.97) 78 — S — 254 (1.50 0.92 1.61)
78 — S — 266 (1.59 1.28 1.25) 78 — S — 267 (1.39 0.98 1.55) 78 — S — 275 (1.07 1.20 1.33) 78 — S — 277 (1.48 1.05 1.48)
78 — S — 279 (1.53 1.11 1.42) 78 — S — 285 (1.26 0.99 1.54) 78 — S — 286 (1.51 0.89 1.64) 78 — S — 287 (1.32 0.90 1.63)
78 — S — 288 (1.30 0.84 1.69) 78 — S — 290 (1.59 1.31 1.22) 78 — S — 292 (2.07 1.37 1.16) 78 — S — 293 (1.57 1.18 1.35)
78 — S — 294 (2.02 1.22 1.31) 78 — S — 295 (1.78 1.46 1.07) 78 — S — 296 (2.05 1.46 1.08) 78 — S — 298 (1.62 1.06 1.47)
78 — S — 299 (0.88 1.40 1.13) 78 — S — 304 (1.43 0.91 1.62) 78 — S — 305 (1.95 1.12 1.41) 78 — S — 313 (1.14 0.83 1.70)
78 — S — 316 (1.43 1.12 1.41) 78 — S — 327 (1.72 1.52 1.01) 78 — S — 332 (1.43 0.88 1.65) 78 — S — 341 (1.03 1.39 1.14)
78 — S — 358 (1.37 1.04 1.49) 78 — S — 370 (1.34 1.11 1.42) 78 — S — 372 (1.57 0.81 1.72) 78 — S — 373 (0.96 0.81 1.72)
78 — S — 374 (1.18 1.30 1.23) 78 — S — 379 (1.26 0.80 1.73) 78 — S — 381 (0.83 0.97 1.56) 78 — S — 382 (1.33 0.99 1.54)
78 — S — 395 (2.19 1.52 1.01) 78 — S — 396 (1.62 0.96 1.57) 78 — S — 397 (1.42 0.80 1.73) 78 — S — 430 (1.20 1.62 0.91)
78 — S — 434 (1.27 1.10 1.43) 78 — S — 435 (1.35 1.26 1.27) 78 — S — 440 (1.88 1.43 1.10) 78 — S — 441 (1.81 1.36 1.17)
78 — S — 447 (1.82 1.55 0.98) 78 — S — 449 (1.56 1.51 1.02) 78 — S — 450 (1.18 1.18 1.35) 78 — S — 455 (1.26 0.92 1.61)
78 — S — 457 (1.41 1.43 1.10) 78 — S — 458 (0.95 1.22 1.31) 78 — S — 461 (1.40 1.62 0.91) 78 — S — 467 (1.09 1.03 1.50)
78 — S — 468 (1.29 1.33 1.20) 78 — S — 471 (1.98 1.09 1.44) 78 — S — 474 (1.88 1.59 0.94) 79 — S — 57 (0.94 1.03 1.54)
79 — S — 125 (1.18 1.48 1.09) 79 — S — 250 (0.94 1.60 0.96) 79 — S — 324 (0.83 1.25 1.32) 79 — S — 429 (2.09 1.48 1.08)
79 — S — 472 (1.09 1.06 1.50) 80 — S — 57 (0.98 1.07 1.49) 80 — S — 125 (1.22 1.52 1.04) 80 — S — 215 (0.80 0.86 1.70)
80 — S — 250 (0.99 1.65 0.91) 80 — S — 259 (0.81 1.20 1.36) 80 — S — 324 (0.87 1.29 1.27) 80 — S — 343 (2.58 0.83 1.73)
80 — S — 429 (2.14 1.53 1.03) 80 — S — 472 (1.13 1.10 1.46) 81 — S — 57 (0.91 0.95 1.57) 81 — S — 125 (1.15 1.39 1.12)
81 — S — 250 (0.92 1.52 0.99) 81 — S — 429 (2.06 1.40 1.11) 81 — S — 472 (1.06 0.98 1.53) 82 — S — 247 (0.89 1.06 1.00)
82 — S — 259 (1.01 0.89 1.17) 82 — S — 324 (1.06 0.98 1.08) 83 — S — 57 (0.88 1.77 1.60) 83 — S — 125 (1.12 2.22 1.15)
83 — S — 150 (1.54 0.88 2.49) 83 — S — 151 (1.45 1.14 2.23) 83 — S — 152 (2.09 1.44 1.93) 83 — S — 153 (1.47 0.98 2.39)
83 — S — 192 (0.89 0.99 2.37) 83 — S — 231 (0.94 1.11 2.26) 83 — S — 250 (0.88 2.35 1.02) 83 — S — 255 (0.85 1.08 2.29)
83 — S — 271 (1.12 1.17 2.19) 83 — S — 291 (1.20 1.02 2.35) 83 — S — 342 (1.94 1.04 2.33) 83 — S — 343 (2.47 1.53 1.84)
83 — S — 371 (1.63 1.13 2.24) 83 — S — 429 (2.03 2.23 1.14) 83 — S — 472 (1.03 1.81 1.56) 85 — S — 152 (1.64 0.88 2.38)
85 — S — 343 (2.02 0.97 2.29) 85 — S — 429 (1.58 1.67 1.59) 86 — S — 57 (1.21 0.85 1.27) 86 — S — 247 (0.92 1.14 0.97)
86 — S — 259 (1.04 0.97 1.14) 86 — S — 270 (0.83 0.84 1.28) 86 — S — 324 (1.09 1.07 1.05) 86 — S — 472 (1.35 0.88 1.23)
88 — S — 27 (0.80 0.92 1.94) 88 — S — 28 (0.87 1.19 1.67) 88 — S — 36 (1.02 1.70 1.16) 88 — S — 43 (1.44 1.56 1.31)
88 — S — 46 (2.04 1.08 1.78) 88 — S — 70 (1.50 1.77 1.10) 88 — S — 85 (1.28 0.88 1.98) 88 — S — 89 (1.26 1.51 1.36)
88 — S — 90 (1.17 1.36 1.51) 88 — S — 101 (0.92 1.21 1.66) 88 — S — 107 (1.55 1.04 1.82) 88 — S — 108 (1.11 1.43 1.43)
88 — S — 109 (1.34 1.57 1.29) 88 — S — 110 (0.84 1.21 1.66) 88 — S — 113 (0.94 1.62 1.24) 88 — S — 115 (1.21 1.18 1.68)
88 — S — 133 (1.55 1.33 1.53) 88 — S — 144 (0.88 1.24 1.62) 88 — S — 145 (0.86 1.90 0.97) 88 — S — 150 (2.37 1.21 1.66)
88 — S — 151 (2.28 1.47 1.40) 88 — S — 152 (2.92 1.76 1.10) 88 — S — 153 (2.30 1.31 1.56) 88 — S — 177 (1.38 0.99 1.88)
88 — S — 183 (1.03 1.32 1.54) 88 — S — 192 (1.72 1.32 1.54) 88 — S — 207 (1.29 1.62 1.24) 88 — S — 215 (1.53 1.89 0.97)
88 — S — 231 (1.77 1.43 1.43) 88 — S — 233 (1.15 0.86 2.01) 88 — S — 234 (0.97 0.94 1.93) 88 — S — 237 (0.98 1.23 1.63)
88 — S — 244 (1.04 0.85 2.01) 88 — S — 246 (1.29 1.19 1.68) 88 — S — 248 (1.36 1.74 1.13) 88 — S — 249 (0.83 1.58 1.29)
88 — S — 255 (1.68 1.41 1.46) 88 — S — 260 (0.81 1.86 1.01) 88 — S — 265 (1.25 1.33 1.53) 88 — S — 266 (0.89 0.91 1.96)
88 — S — 268 (1.23 1.48 1.38) 88 — S — 269 (1.20 1.41 1.46) 88 — S — 271 (1.95 1.50 1.36) 88 — S — 290 (0.89 0.94 1.93)
88 — S — 291 (2.03 1.34 1.52) 88 — S — 292 (1.36 1.00 1.86) 88 — S — 293 (0.87 0.81 2.05) 88 — S — 294 (1.32 0.85 2.02)
88 — S — 295 (1.07 1.09 1.77) 88 — S — 296 (1.35 1.09 1.78) 88 — S — 306 (1.40 1.41 1.46) 88 — S — 307 (1.13 1.54 1.33)
88 — S — 320 (1.62 1.83 1.04) 88 — S — 327 (1.01 1.15 1.71) 88 — S — 329 (1.34 1.61 1.25) 88 — S — 342 (2.77 1.36 1.50)
88 — S — 343 (3.30 1.86 1.01) 88 — S — 367 (1.30 1.31 1.56) 88 — S — 368 (1.41 1.85 1.01) 88 — S — 371 (2.46 1.45 1.41)
88 — S — 395 (1.49 1.15 1.71) 88 — S — 440 (1.17 1.06 1.80) 88 — S — 441 (1.10 0.99 1.88) 88 — S — 447 (1.12 1.18 1.69)
88 — S — 449 (0.86 1.14 1.72) 88 — S — 451 (1.20 1.75 1.11) 88 — S — 452 (1.25 1.41 1.45) 88 — S — 460 (0.98 1.49 1.38)
88 — S — 463 (1.13 1.86 1.01) 88 — S — 473 (1.33 1.33 1.53) 88 — S — 474 (1.18 1.22 1.64) 89 — S — 429 (1.60 1.05 1.57)
90 — S — 429 (1.69 1.20 1.48) 91 — S — 9 (1.54 1.59 1.90) 91 — S — 14 (0.95 1.23 2.26) 91 — S — 19 (1.11 1.49 2.00)
91 — S — 20 (1.64 2.13 1.35) 91 — S — 27 (1.56 2.30 1.19) 91 — S — 28 (1.62 2.57 0.92) 91 — S — 29 (1.38 2.29 1.20)
91 — S — 31 (0.81 1.46 2.02) 91 — S — 32 (0.90 1.31 2.17) 91 — S — 33 (0.84 1.35 2.14) 91 — S — 35 (0.85 1.29 2.20)
91 — S — 38 (1.00 1.73 1.76) 91 — S — 40 (1.20 2.29 1.20) 91 — S — 44 (1.27 1.45 2.04) 91 — S — 46 (2.79 2.46 1.03)
91 — S — 55 (0.83 1.05 2.44) 91 — S — 56 (1.54 1.76 1.73) 91 — S — 60 (0.83 1.38 2.11) 91 — S — 61 (1.53 2.28 1.21)
91 — S — 62 (1.41 2.48 1.01) 91 — S — 65 (1.54 2.07 1.42) 91 — S — 68 (1.25 2.03 1.45) 91 — S — 79 (1.52 2.45 1.04)
91 — S — 80 (1.48 2.41 1.08) 91 — S — 81 (1.55 2.53 0.96) 91 — S — 83 (1.58 1.70 1.79) 91 — S — 85 (2.04 2.26 1.23)
91 — S — 101 (1.68 2.59 0.90) 91 — S — 102 (1.30 1.60 1.89) 91 — S — 104 (0.95 1.17 2.32) 91 — S — 105 (1.84 1.68 1.81)
91 — S — 106 (1.25 1.12 2.37) 91 — S — 107 (2.30 2.42 1.07) 91 — S — 110 (1.59 2.59 0.90) 91 — S — 111 (2.29 1.71 1.78)
91 — S — 112 (1.49 2.08 1.41) 91 — S — 114 (1.13 1.36 2.13) 91 — S — 115 (1.96 2.56 0.93) 91 — S — 118 (1.57 1.98 1.51)

| | | | |
|---|---|---|---|
| 91 — S — 119 (1.55 2.20 1.29) | 91 — S — 123 (1.19 2.33 1.16) | 91 — S — 127 (1.20 1.00 2.49) | 91 — S — 131 (1.60 1.66 1.83) |
| 91 — S — 132 (1.51 1.90 1.58) | 91 — S — 138 (0.83 1.64 1.85) | 91 — S — 147 (1.04 2.20 1.29) | 91 — S — 148 (1.29 1.49 2.00) |
| 91 — S — 150 (3.12 2.58 0.90) | 91 — S — 154 (2.59 1.81 1.68) | 91 — S — 158 (1.66 1.03 2.46) | 91 — S — 161 (2.10 1.12 2.37) |
| 91 — S — 166 (2.31 1.64 1.85) | 91 — S — 167 (2.17 1.33 2.16) | 91 — S — 170 (2.38 1.05 2.44) | 91 — S — 171 (2.08 1.64 1.85) |
| 91 — S — 175 (1.31 1.28 2.21) | 91 — S — 176 (1.25 1.03 2.46) | 91 — S — 177 (2.13 2.36 1.12) | 91 — S — 182 (1.27 1.21 2.28) |
| 91 — S — 184 (2.87 2.18 1.31) | 91 — S — 187 (2.01 1.55 1.94) | 91 — S — 188 (2.45 1.59 1.90) | 91 — S — 189 (2.19 1.18 2.31) |
| 91 — S — 193 (1.39 1.86 1.63) | 91 — S — 194 (2.25 1.30 2.19) | 91 — S — 195 (2.30 2.02 1.47) | 91 — S — 197 (2.44 1.09 2.40) |
| 91 — S — 198 (2.01 2.08 1.41) | 91 — S — 205 (1.53 2.14 1.35) | 91 — S — 208 (1.50 1.61 1.88) | 91 — S — 209 (1.24 1.69 1.80) |
| 91 — S — 210 (1.14 1.09 2.39) | 91 — S — 213 (1.98 2.04 1.45) | 91 — S — 214 (1.54 1.27 2.22) | 91 — S — 217 (1.40 2.07 1.42) |
| 91 — S — 218 (1.37 2.25 1.24) | 91 — S — 219 (1.17 1.80 1.69) | 91 — S — 222 (1.29 1.65 1.84) | 91 — S — 224 (0.92 1.32 2.17) |
| 91 — S — 228 (0.91 1.80 1.68) | 91 — S — 230 (1.21 1.48 2.01) | 91 — S — 233 (1.91 2.23 1.25) | 91 — S — 234 (1.73 2.32 1.17) |
| 91 — S — 236 (1.95 1.20 2.29) | 91 — S — 238 (1.03 2.47 1.02) | 91 — S — 240 (1.34 1.10 2.39) | 91 — S — 243 (2.47 1.44 2.05) |
| 91 — S — 244 (1.79 2.23 1.26) | 91 — S — 245 (1.71 2.00 1.49) | 91 — S — 246 (2.04 2.57 0.92) | 91 — S — 254 (1.55 1.92 1.56) |
| 91 — S — 261 (1.17 1.01 2.48) | 91 — S — 266 (1.64 2.28 1.20) | 91 — S — 267 (1.44 1.98 1.50) | 91 — S — 272 (1.83 1.33 2.16) |
| 91 — S — 274 (1.31 1.79 1.70) | 91 — S — 275 (1.12 2.21 1.28) | 91 — S — 276 (1.23 1.19 2.30) | 91 — S — 277 (1.53 2.05 1.43) |
| 91 — S — 279 (1.58 2.12 1.37) | 91 — S — 280 (1.26 1.79 1.69) | 91 — S — 282 (1.38 1.62 1.87) | 91 — S — 284 (1.16 1.63 1.86) |
| 91 — S — 285 (1.31 2.00 1.49) | 91 — S — 286 (1.56 1.90 1.59) | 91 — S — 287 (1.37 1.91 1.58) | 91 — S — 288 (1.35 1.85 1.64) |
| 91 — S — 289 (1.61 1.69 1.80) | 91 — S — 290 (1.64 2.32 1.17) | 91 — S — 292 (2.11 2.38 1.11) | 91 — S — 293 (1.62 2.19 1.30) |
| 91 — S — 294 (2.07 2.22 1.27) | 91 — S — 295 (1.83 2.47 1.02) | 91 — S — 296 (2.10 2.46 1.03) | 91 — S — 297 (1.42 1.59 1.90) |
| 91 — S — 298 (1.67 2.07 1.42) | 91 — S — 299 (0.93 2.41 1.08) | 91 — S — 300 (1.68 1.47 2.02) | 91 — S — 301 (1.73 1.18 2.31) |
| 91 — S — 302 (1.85 1.03 2.46) | 91 — S — 303 (1.44 1.44 2.05) | 91 — S — 304 (1.48 1.91 1.57) | 91 — S — 305 (1.99 2.13 1.36) |
| 91 — S — 308 (1.47 1.08 2.41) | 91 — S — 310 (1.59 1.52 1.96) | 91 — S — 311 (1.32 1.80 1.69) | 91 — S — 312 (1.42 1.67 1.81) |
| 91 — S — 313 (1.19 1.84 1.65) | 91 — S — 316 (1.48 2.13 1.36) | 91 — S — 318 (1.77 1.17 2.32) | 91 — S — 327 (1.77 2.53 0.96) |
| 91 — S — 328 (0.89 1.03 2.45) | 91 — S — 330 (1.10 1.54 1.95) | 91 — S — 331 (1.63 1.71 1.78) | 91 — S — 332 (1.48 1.88 1.60) |
| 91 — S — 336 (1.58 1.77 1.72) | 91 — S — 341 (1.08 2.40 1.09) | 91 — S — 352 (1.19 1.01 2.48) | 91 — S — 353 (1.12 1.05 2.44) |
| 91 — S — 356 (1.25 1.59 1.90) | 91 — S — 357 (1.94 1.34 2.15) | 91 — S — 358 (1.42 2.05 1.44) | 91 — S — 359 (0.83 1.15 2.34) |
| 91 — S — 360 (0.87 1.44 2.04) | 91 — S — 370 (1.39 2.12 1.37) | 91 — S — 372 (1.62 1.82 1.67) | 91 — S — 373 (1.01 1.82 1.67) |
| 91 — S — 374 (1.23 2.31 1.18) | 91 — S — 379 (1.31 1.81 1.68) | 91 — S — 380 (1.15 1.23 2.26) | 91 — S — 381 (0.88 1.98 1.51) |
| 91 — S — 382 (1.37 1.99 1.50) | 91 — S — 391 (1.31 1.80 1.69) | 91 — S — 394 (1.21 1.10 2.39) | 91 — S — 395 (2.24 2.53 0.96) |
| 91 — S — 396 (1.67 1.97 1.52) | 91 — S — 397 (1.47 1.81 1.68) | 91 — S — 398 (1.38 0.94 2.55) | 91 — S — 401 (1.31 0.85 2.64) |
| 91 — S — 403 (1.26 1.06 2.43) | 91 — S — 415 (1.36 1.70 1.79) | 91 — S — 421 (1.01 0.83 2.66) | 91 — S — 432 (1.49 1.31 2.18) |
| 91 — S — 433 (1.20 1.32 2.17) | 91 — S — 434 (1.32 2.10 1.39) | 91 — S — 435 (1.40 2.27 1.22) | 91 — S — 437 (1.58 1.65 1.84) |
| 91 — S — 440 (1.93 2.44 1.05) | 91 — S — 441 (1.86 2.37 1.12) | 91 — S — 444 (1.39 0.96 2.53) | 91 — S — 445 (1.07 0.92 2.57) |
| 91 — S — 446 (1.07 0.92 2.57) | 91 — S — 447 (1.87 2.55 0.94) | 91 — S — 448 (0.81 1.31 2.18) | 91 — S — 449 (1.61 2.52 0.97) |
| 91 — S — 450 (1.23 2.19 1.30) | 91 — S — 453 (1.50 1.49 2.00) | 91 — S — 454 (1.32 1.66 1.83) | 91 — S — 455 (1.31 1.93 1.56) |
| 91 — S — 456 (1.00 1.64 1.85) | 91 — S — 457 (1.46 2.43 1.06) | 91 — S — 458 (1.00 2.23 1.26) | 91 — S — 466 (0.83 1.51 1.98) |
| 91 — S — 467 (1.14 2.04 1.45) | 91 — S — 468 (1.34 2.34 1.15) | 91 — S — 471 (2.03 2.10 1.39) | 91 — S — 475 (0.87 1.72 1.77) |
| 91 — S — 480 (0.95 1.07 2.42) | 94 — S — 20 (1.15 1.18 1.85) | 94 — S — 27 (1.06 1.35 1.68) | 94 — S — 28 (1.13 1.62 1.41) |
| 94 — S — 29 (0.89 1.34 1.69) | 94 — S — 43 (1.70 1.98 1.04) | 94 — S — 46 (2.30 1.50 1.52) | 94 — S — 56 (1.05 0.81 2.22) |
| 94 — S — 61 (1.04 1.32 1.70) | 94 — S — 62 (0.92 1.52 1.51) | 94 — S — 65 (1.05 1.12 1.91) | 94 — S — 79 (1.03 1.50 1.53) |
| 94 — S — 80 (0.98 1.45 1.58) | 94 — S — 81 (1.06 1.58 1.45) | 94 — S — 85 (1.55 1.31 1.72) | 94 — S — 89 (1.52 1.93 1.10) |
| 94 — S — 90 (1.43 1.78 1.25) | 94 — S — 101 (1.18 1.63 1.39) | 94 — S — 107 (1.81 1.47 1.56) | 94 — S — 108 (1.37 1.86 1.17) |
| 94 — S — 109 (1.60 1.99 1.03) | 94 — S — 110 (1.10 1.63 1.39) | 94 — S — 112 (0.99 1.13 1.90) | 94 — S — 113 (1.20 2.05 0.98) |
| 94 — S — 115 (1.47 1.61 1.42) | 94 — S — 118 (1.08 1.03 2.00) | 94 — S — 119 (1.05 1.24 1.78) | 94 — S — 132 (1.02 0.95 2.08) |
| 94 — S — 133 (1.81 1.76 1.27) | 94 — S — 144 (1.14 1.67 1.36) | 94 — S — 150 (2.63 1.63 1.40) | 94 — S — 151 (2.54 1.89 1.14) |
| 94 — S — 153 (2.56 1.73 1.30) | 94 — S — 154 (2.09 0.86 2.17) | 94 — S — 177 (1.64 1.41 1.62) | 94 — S — 183 (1.29 1.75 1.28) |
| 94 — S — 184 (2.38 1.22 1.80) | 94 — S — 192 (1.98 1.74 1.28) | 94 — S — 193 (0.90 0.91 2.12) | 94 — S — 195 (1.81 1.07 1.96) |
| 94 — S — 198 (1.52 1.13 1.90) | 94 — S — 205 (1.04 1.19 1.84) | 94 — S — 206 (1.03 2.10 0.93) | 94 — S — 207 (1.55 2.05 0.98) |
| 94 — S — 213 (1.49 1.08 1.94) | 94 — S — 217 (0.91 1.12 1.91) | 94 — S — 218 (0.88 1.29 1.73) | 94 — S — 231 (2.03 1.86 1.17) |
| 94 — S — 233 (1.41 1.28 1.75) | 94 — S — 234 (1.23 1.36 1.66) | 94 — S — 237 (1.24 1.66 1.37) | 94 — S — 244 (1.30 1.27 1.75) |
| 94 — S — 245 (1.22 1.05 1.98) | 94 — S — 246 (1.55 1.61 1.41) | 94 — S — 249 (1.09 2.00 1.02) | 94 — S — 251 (1.06 1.86 1.17) |
| 94 — S — 254 (1.05 0.97 2.06) | 94 — S — 255 (1.94 1.83 1.20) | 94 — S — 265 (1.51 1.75 1.27) | 94 — S — 266 (1.15 1.33 1.70) |
| 94 — S — 267 (0.95 1.03 2.00) | 94 — S — 268 (1.49 1.90 1.12) | 94 — S — 269 (1.46 1.83 1.19) | 94 — S — 271 (2.21 1.92 1.10) |
| 94 — S — 274 (0.82 0.83 2.19) | 94 — S — 277 (1.04 1.10 1.93) | 94 — S — 279 (1.09 1.16 1.86) | 94 — S — 285 (0.82 1.04 1.98) |
| 94 — S — 286 (1.07 0.95 2.08) | 94 — S — 287 (0.88 0.96 2.07) | 94 — S — 288 (0.86 0.90 2.13) | 94 — S — 290 (1.15 1.36 1.66) |
| 94 — S — 291 (2.29 1.77 1.26) | 94 — S — 292 (1.62 1.43 1.60) | 94 — S — 293 (1.13 1.24 1.79) | 94 — S — 294 (1.58 1.27 1.76) |
| 94 — S — 295 (1.33 1.51 1.51) | 94 — S — 296 (1.61 1.51 1.52) | 94 — S — 298 (1.18 1.12 1.91) | 94 — S — 304 (0.99 0.96 2.07) |
| 94 — S — 305 (1.50 1.18 1.85) | 94 — S — 306 (1.66 1.83 1.20) | 94 — S — 307 (1.39 1.96 1.07) | 94 — S — 311 (0.82 0.85 2.18) |

94 — S — 316 (0.99 1.18 1.85) 94 — S — 327 (1.28 1.58 1.45) 94 — S — 329 (1.60 2.04 0.99) 94 — S — 332 (0.99 0.93 2.10)
94 — S — 336 (1.09 0.82 2.21) 94 — S — 342 (3.03 1.79 1.24) 94 — S — 358 (0.93 1.10 1.93) 94 — S — 367 (1.56 1.73 1.30)
94 — S — 370 (0.90 1.16 1.87) 94 — S — 371 (2.72 1.88 1.15) 94 — S — 372 (1.13 0.86 2.16) 94 — S — 379 (0.81 0.86 2.17)
94 — S — 382 (0.88 1.04 1.99) 94 — S — 391 (0.82 0.85 2.18) 94 — S — 395 (1.75 1.58 1.45) 94 — S — 396 (1.18 1.02 2.01)
94 — S — 397 (0.98 0.86 2.17) 94 — S — 420 (0.93 2.06 0.97) 94 — S — 434 (0.83 1.15 1.88) 94 — S — 435 (0.91 1.32 1.71)
94 — S — 440 (1.44 1.49 1.54) 94 — S — 441 (1.37 1.41 1.61) 94 — S — 443 (0.84 2.03 1.00) 94 — S — 447 (1.38 1.60 1.43)
94 — S — 449 (1.12 1.57 1.46) 94 — S — 452 (1.52 1.84 1.19) 94 — S — 455 (0.82 0.98 2.05) 94 — S — 457 (0.96 1.48 1.55)
94 — S — 460 (1.24 1.91 1.12) 94 — S — 461 (0.96 1.67 1.36) 94 — S — 468 (0.84 1.39 1.64) 94 — S — 469 (0.93 1.81 1.21)
94 — S — 471 (1.54 1.15 1.88) 94 — S — 473 (1.59 1.76 1.27) 94 — S — 474 (1.44 1.65 1.38) 95 — S — 20 (1.14 1.07 1.85)
95 — S — 27 (1.06 1.23 1.68) 95 — S — 28 (1.12 1.50 1.42) 95 — S — 29 (0.88 1.23 1.69) 95 — S — 36 (1.28 2.01 0.90)
95 — S — 43 (1.70 1.87 1.05) 95 — S — 46 (2.29 1.39 1.53) 95 — S — 61 (1.03 1.21 1.71) 95 — S — 62 (0.91 1.41 1.51)
95 — S — 65 (1.04 1.00 1.91) 95 — S — 79 (1.03 1.38 1.54) 95 — S — 80 (0.98 1.34 1.58) 95 — S — 81 (1.06 1.46 1.46)
95 — S — 85 (1.54 1.19 1.73) 95 — S — 89 (1.52 1.82 1.10) 95 — S — 90 (1.42 1.67 1.25) 95 — S — 101 (1.18 1.52 1.40)
95 — S — 107 (1.80 1.35 1.56) 95 — S — 108 (1.36 1.74 1.17) 95 — S — 109 (1.60 1.88 1.04) 95 — S — 110 (1.09 1.52 1.40)
95 — S — 112 (0.99 1.02 1.90) 95 — S — 113 (1.20 1.93 0.98) 95 — S — 115 (1.47 1.49 1.42) 95 — S — 118 (1.08 0.91 2.00)
95 — S — 119 (1.05 1.13 1.79) 95 — S — 132 (1.02 0.84 2.08) 95 — S — 133 (1.80 1.64 1.27) 95 — S — 144 (1.14 1.55 1.36)
95 — S — 150 (2.62 1.52 1.40) 95 — S — 151 (2.53 1.78 1.14) 95 — S — 153 (2.56 1.62 1.30) 95 — S — 177 (1.64 1.30 1.62)
95 — S — 183 (1.29 1.63 1.28) 95 — S — 184 (2.37 1.11 1.81) 95 — S — 192 (1.98 1.63 1.29) 95 — S — 195 (1.80 0.95 1.96)
95 — S — 198 (1.52 1.01 1.90) 95 — S — 205 (1.04 1.07 1.84) 95 — S — 206 (1.03 1.99 0.93) 95 — S — 207 (1.55 1.93 0.98)
95 — S — 213 (1.48 0.97 1.95) 95 — S — 217 (0.91 1.00 1.91) 95 — S — 218 (0.88 1.18 1.74) 95 — S — 231 (2.02 1.74 1.17)
95 — S — 233 (1.41 1.17 1.75) 95 — S — 234 (1.23 1.25 1.67) 95 — S — 237 (1.24 1.54 1.37) 95 — S — 244 (1.29 1.16 1.76)
95 — S — 245 (1.21 0.93 1.98) 95 — S — 246 (1.55 1.50 1.42) 95 — S — 249 (1.09 1.89 1.03) 95 — S — 251 (1.05 1.75 1.17)
95 — S — 254 (1.05 0.86 2.06) 95 — S — 255 (1.94 1.72 1.20) 95 — S — 265 (1.51 1.64 1.28) 95 — S — 266 (1.15 1.22 1.70)
95 — S — 267 (0.95 0.92 2.00) 95 — S — 268 (1.49 1.79 1.13) 95 — S — 269 (1.45 1.72 1.20) 95 — S — 271 (2.20 1.81 1.11)
95 — S — 277 (1.03 0.99 1.93) 95 — S — 279 (1.09 1.05 1.87) 95 — S — 285 (0.81 0.93 1.99) 95 — S — 286 (1.06 0.83 2.08)
95 — S — 287 (0.87 0.85 2.07) 95 — S — 290 (1.15 1.25 1.67) 95 — S — 291 (2.28 1.65 1.26) 95 — S — 292 (1.62 1.31 1.60)
95 — S — 293 (1.12 1.12 1.79) 95 — S — 294 (1.58 1.16 1.76) 95 — S — 295 (1.33 1.40 1.52) 95 — S — 296 (1.61 1.40 1.52)
95 — S — 298 (1.18 1.00 1.92) 95 — S — 304 (0.98 0.85 2.07) 95 — S — 305 (1.50 1.06 1.85) 95 — S — 306 (1.66 1.72 1.20)
95 — S — 307 (1.39 1.85 1.07) 95 — S — 316 (0.98 1.06 1.86) 95 — S — 327 (1.27 1.46 1.45) 95 — S — 329 (1.60 1.92 0.99)
95 — S — 332 (0.99 0.82 2.10) 95 — S — 342 (3.03 1.67 1.24) 95 — S — 358 (0.93 0.98 1.94) 95 — S — 367 (1.55 1.62 1.30)
95 — S — 370 (0.90 1.05 1.87) 95 — S — 371 (2.72 1.76 1.15) 95 — S — 382 (0.88 0.93 1.99) 95 — S — 395 (1.75 1.46 1.45)
95 — S — 396 (1.17 0.90 2.02) 95 — S — 420 (0.93 1.94 0.97) 95 — S — 434 (0.82 1.04 1.88) 95 — S — 435 (0.91 1.20 1.71)
95 — S — 440 (1.43 1.37 1.55) 95 — S — 441 (1.36 1.30 1.62) 95 — S — 443 (0.84 1.91 1.00) 95 — S — 447 (1.37 1.49 1.43)
95 — S — 449 (1.11 1.45 1.46) 95 — S — 452 (1.51 1.72 1.20) 95 — S — 455 (0.81 0.86 2.06) 95 — S — 457 (0.96 1.37 1.55)
95 — S — 460 (1.24 1.80 1.12) 95 — S — 461 (0.95 1.56 1.36) 95 — S — 468 (0.84 1.27 1.64) 95 — S — 469 (0.93 1.70 1.22)
95 — S — 471 (1.54 1.03 1.89) 95 — S — 473 (1.58 1.64 1.27) 95 — S — 474 (1.44 1.53 1.38) 96 — S — 36 (1.16 1.02 1.03)
96 — S — 43 (1.57 0.87 1.17) 96 — S — 70 (1.64 1.08 0.96) 96 — S — 89 (1.39 0.82 1.22) 96 — S — 109 (1.47 0.89 1.16)
96 — S — 113 (1.07 0.94 1.11) 96 — S — 152 (3.05 1.08 0.97) 96 — S — 206 (0.91 0.99 1.06) 96 — S — 207 (1.43 0.94 1.11)
96 — S — 248 (1.49 1.05 0.99) 96 — S — 249 (0.96 0.89 1.15) 96 — S — 271 (2.08 0.82 1.23) 96 — S — 307 (1.26 0.85 1.20)
96 — S — 320 (1.76 1.14 0.91) 96 — S — 329 (1.48 0.93 1.12) 96 — S — 420 (0.80 0.95 1.10) 96 — S — 451 (1.33 1.07 0.98)
96 — S — 460 (1.11 0.80 1.24) 97 — S — 20 (1.24 1.31 1.76) 97 — S — 27 (1.15 1.47 1.59) 97 — S — 28 (1.22 1.74 1.32)
97 — S — 29 (0.98 1.46 1.60) 97 — S — 43 (1.79 2.11 0.95) 97 — S — 46 (2.39 1.63 1.43) 97 — S — 56 (1.14 0.93 2.13)
97 — S — 61 (1.13 1.45 1.61) 97 — S — 62 (1.00 1.65 1.42) 97 — S — 65 (1.14 1.24 1.82) 97 — S — 68 (0.85 1.21 1.86)
97 — S — 79 (1.12 1.62 1.44) 97 — S — 80 (1.07 1.58 1.49) 97 — S — 81 (1.15 1.70 1.36) 97 — S — 82 (0.88 1.89 1.18)
97 — S — 83 (1.18 0.87 2.19) 97 — S — 85 (1.64 1.43 1.63) 97 — S — 86 (0.85 1.80 1.26) 97 — S — 89 (1.61 2.06 1.01)
97 — S — 90 (1.52 1.91 1.16) 97 — S — 101 (1.27 1.76 1.30) 97 — S — 105 (1.43 0.85 2.21) 97 — S — 107 (1.90 1.59 1.47)
97 — S — 108 (1.46 1.98 1.08) 97 — S — 109 (1.69 2.12 0.94) 97 — S — 110 (1.19 1.76 1.30) 97 — S — 111 (1.89 0.88 2.19)
97 — S — 112 (1.08 1.26 1.81) 97 — S — 115 (1.56 1.73 1.33) 97 — S — 118 (1.17 1.15 1.91) 97 — S — 119 (1.14 1.37 1.69)
97 — S — 131 (1.20 0.83 2.23) 97 — S — 132 (1.11 1.08 1.99) 97 — S — 133 (1.90 1.88 1.18) 97 — S — 144 (1.23 1.79 1.27)
97 — S — 150 (2.72 1.76 1.31) 97 — S — 151 (2.63 2.01 1.05) 97 — S — 153 (2.65 1.86 1.21) 97 — S — 154 (2.18 0.99 2.08)
97 — S — 166 (1.90 0.81 2.25) 97 — S — 171 (1.67 0.81 2.25) 97 — S — 177 (1.73 1.54 1.53) 97 — S — 183 (1.38 1.87 1.19)
97 — S — 184 (2.47 1.35 1.71) 97 — S — 192 (2.07 1.87 1.19) 97 — S — 193 (0.99 1.03 2.03) 97 — S — 195 (1.90 1.19 1.87)
97 — S — 198 (1.61 1.25 1.81) 97 — S — 205 (1.13 1.31 1.75) 97 — S — 209 (0.84 0.86 2.20) 97 — S — 213 (1.58 1.21 1.85)
97 — S — 217 (1.00 1.24 1.82) 97 — S — 218 (0.97 1.42 1.64) 97 — S — 222 (0.88 0.82 2.24) 97 — S — 231 (2.12 1.98 1.08)
97 — S — 233 (1.50 1.41 1.66) 97 — S — 234 (1.32 1.49 1.58) 97 — S — 237 (1.33 1.78 1.28) 97 — S — 244 (1.39 1.40 1.66)
97 — S — 245 (1.31 1.17 1.89) 97 — S — 246 (1.64 1.74 1.32) 97 — S — 249 (1.18 2.13 0.94) 97 — S — 251 (1.15 1.99 1.08)
97 — S — 254 (1.14 1.10 1.97) 97 — S — 255 (2.03 1.96 1.11) 97 — S — 265 (1.60 1.88 1.18) 97 — S — 266 (1.24 1.46 1.61)
97 — S — 267 (1.04 1.16 1.91) 97 — S — 268 (1.58 2.03 1.03) 97 — S — 269 (1.55 1.96 1.11) 97 — S — 271 (2.30 2.05 1.01)

97 — S — 274 (0.91 0.96 2.10) 97 — S — 277 (1.13 1.23 1.84) 97 — S — 279 (1.18 1.29 1.78) 97 — S — 280 (0.86 0.97 2.10)
97 — S — 285 (0.90 1.17 1.89) 97 — S — 286 (1.16 1.07 1.99) 97 — S — 287 (0.97 1.08 1.98) 97 — S — 288 (0.95 1.02 2.04)
97 — S — 289 (1.21 0.86 2.20) 97 — S — 290 (1.24 1.49 1.57) 97 — S — 291 (2.38 1.89 1.17) 97 — S — 292 (1.71 1.55 1.51)
97 — S — 293 (1.22 1.36 1.70) 97 — S — 294 (1.67 1.40 1.67) 97 — S — 295 (1.42 1.64 1.42) 97 — S — 296 (1.70 1.63 1.43)
97 — S — 298 (1.27 1.24 1.82) 97 — S — 304 (1.08 1.09 1.98) 97 — S — 305 (1.59 1.30 1.76) 97 — S — 306 (1.75 1.96 1.11)
97 — S — 307 (1.48 2.09 0.98) 97 — S — 311 (0.91 0.97 2.09) 97 — S — 312 (1.01 0.85 2.22) 97 — S — 316 (1.08 1.30 1.76)
97 — S — 327 (1.37 1.70 1.36) 97 — S — 331 (1.23 0.88 2.18) 97 — S — 332 (1.08 1.06 2.01) 97 — S — 336 (1.18 0.95 2.12)
97 — S — 342 (3.12 1.91 1.15) 97 — S — 358 (1.02 1.22 1.84) 97 — S — 367 (1.65 1.86 1.21) 97 — S — 370 (0.99 1.29 1.78)
97 — S — 371 (2.81 2.00 1.06) 97 — S — 372 (1.22 0.99 2.08) 97 — S — 374 (0.83 1.48 1.58) 97 — S — 379 (0.90 0.98 2.08)
97 — S — 382 (0.97 1.17 1.90) 97 — S — 391 (0.91 0.97 2.09) 97 — S — 395 (1.84 1.70 1.36) 97 — S — 396 (1.26 1.14 1.92)
97 — S — 397 (1.07 0.98 2.08) 97 — S — 415 (0.96 0.87 2.20) 97 — S — 430 (0.85 1.80 1.26) 97 — S — 434 (0.92 1.28 1.79)
97 — S — 435 (1.00 1.44 1.62) 97 — S — 437 (1.18 0.82 2.24) 97 — S — 440 (1.53 1.61 1.45) 97 — S — 441 (1.46 1.54 1.52)
97 — S — 443 (0.93 2.15 0.91) 97 — S — 447 (1.47 1.73 1.34) 97 — S — 449 (1.21 1.69 1.37) 97 — S — 450 (0.83 1.36 1.70)
97 — S — 452 (1.61 1.96 1.10) 97 — S — 454 (0.92 0.83 2.23) 97 — S — 455 (0.90 1.10 1.96) 97 — S — 457 (1.05 1.61 1.46)
97 — S — 459 (0.84 1.84 1.23) 97 — S — 460 (1.33 2.04 1.03) 97 — S — 461 (1.05 1.80 1.27) 97 — S — 468 (0.93 1.51 1.55)
97 — S — 469 (1.02 1.94 1.12) 97 — S — 471 (1.63 1.27 1.79) 97 — S — 473 (1.68 1.88 1.18) 97 — S — 474 (1.53 1.77 1.29)
98 — S — 27 (0.80 0.87 1.94) 98 — S — 28 (0.87 1.13 1.67) 98 — S — 36 (1.03 1.65 1.16) 98 — S — 43 (1.44 1.50 1.30)
98 — S — 46 (2.04 1.02 1.78) 98 — S — 70 (1.50 1.71 1.09) 98 — S — 81 (0.80 1.09 1.71) 98 — S — 85 (1.29 0.82 1.98)
98 — S — 89 (1.26 1.45 1.35) 98 — S — 90 (1.17 1.30 1.51) 98 — S — 101 (0.92 1.15 1.65) 98 — S — 107 (1.55 0.98 1.82)
98 — S — 108 (1.11 1.38 1.43) 98 — S — 109 (1.34 1.51 1.29) 98 — S — 110 (0.84 1.15 1.65) 98 — S — 113 (0.94 1.57 1.24)
98 — S — 115 (1.21 1.12 1.68) 98 — S — 133 (1.55 1.28 1.53) 98 — S — 144 (0.88 1.19 1.62) 98 — S — 145 (0.86 1.84 0.97)
98 — S — 150 (2.37 1.15 1.66) 98 — S — 151 (2.28 1.41 1.40) 98 — S — 152 (2.92 1.71 1.10) 98 — S — 153 (2.30 1.25 1.55)
98 — S — 177 (1.38 0.93 1.88) 98 — S — 183 (1.03 1.27 1.54) 98 — S — 192 (1.73 1.26 1.54) 98 — S — 207 (1.30 1.57 1.24)
98 — S — 215 (1.53 1.83 0.97) 98 — S — 231 (1.77 1.37 1.43) 98 — S — 234 (0.97 0.88 1.92) 98 — S — 237 (0.98 1.18 1.63)
98 — S — 246 (1.29 1.13 1.67) 98 — S — 248 (1.36 1.68 1.13) 98 — S — 249 (0.83 1.52 1.28) 98 — S — 255 (1.68 1.35 1.46)
98 — S — 260 (0.81 1.80 1.00) 98 — S — 265 (1.25 1.27 1.53) 98 — S — 266 (0.89 0.85 1.96) 98 — S — 268 (1.23 1.42 1.38)
98 — S — 269 (1.20 1.35 1.45) 98 — S — 271 (1.95 1.44 1.36) 98 — S — 290 (0.89 0.88 1.92) 98 — S — 291 (2.03 1.29 1.52)
98 — S — 292 (1.36 0.95 1.86) 98 — S — 295 (1.08 1.03 1.77) 98 — S — 296 (1.35 1.03 1.78) 98 — S — 306 (1.40 1.35 1.46)
98 — S — 307 (1.13 1.48 1.33) 98 — S — 320 (1.62 1.77 1.04) 98 — S — 327 (1.02 1.10 1.71) 98 — S — 329 (1.34 1.56 1.25)
98 — S — 342 (2.77 1.31 1.50) 98 — S — 343 (3.30 1.80 1.01) 98 — S — 367 (1.30 1.25 1.55) 98 — S — 368 (1.41 1.79 1.01)
98 — S — 371 (2.46 1.39 1.41) 98 — S — 395 (1.49 1.10 1.71) 98 — S — 440 (1.18 1.00 1.80) 98 — S — 441 (1.11 0.93 1.87)
98 — S — 447 (1.12 1.12 1.69) 98 — S — 449 (0.86 1.09 1.72) 98 — S — 451 (1.20 1.70 1.11) 98 — S — 452 (1.26 1.35 1.45)
98 — S — 460 (0.98 1.43 1.38) 98 — S — 463 (1.13 1.80 1.00) 98 — S — 473 (1.33 1.28 1.53) 98 — S — 474 (1.18 1.16 1.64)
101 — S — 125 (1.02 1.34 1.24) 101 — S — 429 (1.94 1.35 1.23) 101 — S — 472 (0.93 0.92 1.65) 102 — S — 43 (0.89 1.34 1.85)
102 — S — 46 (1.49 0.86 2.33) 102 — S — 57 (1.16 1.88 1.31) 102 — S — 70 (0.96 1.55 1.64) 102 — S — 107 (1.00 0.83 2.37)
102 — S — 133 (1.00 1.12 2.08) 102 — S — 150 (1.82 0.99 2.20) 102 — S — 151 (1.73 1.25 1.95) 102 — S — 152 (2.37 1.55 1.65)
102 — S — 153 (1.75 1.09 2.10) 102 — S — 192 (1.18 1.10 2.09) 102 — S — 215 (0.98 1.67 1.52) 102 — S — 231 (1.22 1.21 1.98)
102 — S — 247 (0.88 2.18 1.02) 102 — S — 248 (0.81 1.52 1.67) 102 — S — 255 (1.14 1.19 2.00) 102 — S — 259 (0.99 2.01 1.19)
102 — S — 271 (1.40 1.28 1.91) 102 — S — 291 (1.48 1.13 2.07) 102 — S — 296 (0.80 0.87 2.33) 102 — S — 306 (0.86 1.19 2.00)
102 — S — 320 (1.08 1.61 1.59) 102 — S — 324 (1.05 2.10 1.09) 102 — S — 342 (2.22 1.15 2.05) 102 — S — 343 (2.75 1.64 1.55)
102 — S — 364 (0.93 1.77 1.43) 102 — S — 368 (0.86 1.63 1.56) 102 — S — 371 (1.91 1.24 1.96) 102 — S — 395 (0.94 0.94 2.26)
102 — S — 472 (1.31 1.91 1.28) 103 — S — 11 (0.80 0.86 1.50) 103 — S — 20 (1.80 1.16 1.20) 103 — S — 27 (1.71 1.33 1.03)
103 — S — 29 (1.54 1.32 1.04) 103 — S — 40 (1.36 1.32 1.04) 103 — S — 45 (0.83 0.97 1.39) 103 — S — 61 (1.69 1.31 1.05)
103 — S — 65 (1.70 1.10 1.26) 103 — S — 68 (1.41 1.06 1.30) 103 — S — 80 (1.63 1.43 0.93) 103 — S — 85 (2.20 1.29 1.07)
103 — S — 107 (2.46 1.45 0.91) 103 — S — 112 (1.64 1.11 1.25) 103 — S — 118 (1.73 1.01 1.35) 103 — S — 119 (1.70 1.23 1.13)
103 — S — 123 (1.34 1.35 1.01) 103 — S — 132 (1.67 0.93 1.43) 103 — S — 147 (1.20 1.23 1.13) 103 — S — 154 (2.74 0.84 1.52)
103 — S — 177 (2.29 1.39 0.97) 103 — S — 184 (3.03 1.21 1.15) 103 — S — 193 (1.55 0.89 1.47) 103 — S — 195 (2.46 1.05 1.31)
103 — S — 198 (2.17 1.11 1.25) 103 — S — 205 (1.69 1.17 1.19) 103 — S — 213 (2.14 1.07 1.29) 103 — S — 217 (1.56 1.10 1.26)
103 — S — 218 (1.53 1.28 1.08) 103 — S — 219 (1.33 0.83 1.53) 103 — S — 228 (1.07 0.83 1.53) 103 — S — 233 (2.06 1.26 1.10)
103 — S — 234 (1.88 1.35 1.02) 103 — S — 244 (1.95 1.26 1.10) 103 — S — 245 (1.87 1.03 1.33) 103 — S — 254 (1.70 0.95 1.41)
103 — S — 266 (1.80 1.31 1.05) 103 — S — 267 (1.60 1.01 1.35) 103 — S — 274 (1.47 0.82 1.54) 103 — S — 275 (1.28 1.24 1.12)
103 — S — 277 (1.69 1.08 1.28) 103 — S — 279 (1.74 1.15 1.22) 103 — S — 280 (1.42 0.82 1.54) 103 — S — 285 (1.46 1.03 1.33)
103 — S — 286 (1.72 0.93 1.43) 103 — S — 287 (1.53 0.94 1.42) 103 — S — 288 (1.51 0.88 1.48) 103 — S — 290 (1.80 1.35 1.01)
103 — S — 292 (2.27 1.41 0.95) 103 — S — 293 (1.78 1.22 1.14) 103 — S — 294 (2.23 1.25 1.11) 103 — S — 298 (1.83 1.10 1.26)
103 — S — 299 (1.09 1.44 0.92) 103 — S — 304 (1.64 0.94 1.42) 103 — S — 305 (2.15 1.16 1.20) 103 — S — 311 (1.47 0.83 1.53)
103 — S — 313 (1.35 0.87 1.49) 103 — S — 316 (1.64 1.16 1.20) 103 — S — 319 (0.84 1.02 1.34) 103 — S — 332 (1.64 0.91 1.45)
103 — S — 336 (1.74 0.80 1.56) 103 — S — 341 (1.24 1.43 0.93) 103 — S — 358 (1.58 1.08 1.28) 103 — S — 370 (1.55 1.14 1.22)
103 — S — 372 (1.78 0.85 1.52) 103 — S — 373 (1.17 0.85 1.51) 103 — S — 374 (1.39 1.34 1.02) 103 — S — 379 (1.46 0.84 1.52)

103 — S — 381 (1.03 1.01 1.35) 103 — S — 382 (1.53 1.02 1.34) 103 — S — 391 (1.47 0.83 1.53) 103 — S — 396 (1.83 1.00 1.36)
103 — S — 397 (1.63 0.84 1.52) 103 — S — 419 (0.91 0.82 1.54) 103 — S — 434 (1.48 1.13 1.23) 103 — S — 435 (1.56 1.30 1.06)
103 — S — 441 (2.02 1.40 0.96) 103 — S — 450 (1.39 1.22 1.14) 103 — S — 455 (1.46 0.96 1.40) 103 — S — 458 (1.16 1.26 1.10)
103 — S — 467 (1.29 1.06 1.30) 103 — S — 468 (1.49 1.37 0.99) 103 — S — 471 (2.19 1.13 1.23) 104 — S — 36 (0.82 1.92 1.36)
104 — S — 37 (0.82 2.21 1.06) 104 — S — 43 (1.24 1.77 1.51) 104 — S — 46 (1.83 1.29 1.99) 104 — S — 57 (1.51 2.31 0.97)
104 — S — 70 (1.30 1.98 1.30) 104 — S — 85 (1.08 1.09 2.18) 104 — S — 89 (1.06 1.72 1.56) 104 — S — 90 (0.97 1.57 1.71)
104 — S — 107 (1.34 1.25 2.02) 104 — S — 108 (0.90 1.65 1.63) 104 — S — 109 (1.14 1.78 1.50) 104 — S — 115 (1.01 1.39 1.88)
104 — S — 133 (1.35 1.54 1.73) 104 — S — 150 (2.17 1.42 1.86) 104 — S — 151 (2.07 1.68 1.60) 104 — S — 152 (2.72 1.98 1.30)
104 — S — 153 (2.10 1.52 1.76) 104 — S — 177 (1.18 1.20 2.08) 104 — S — 183 (0.83 1.53 1.74) 104 — S — 184 (1.92 1.01 2.27)
104 — S — 192 (1.52 1.53 1.75) 104 — S — 195 (1.35 0.85 2.42) 104 — S — 198 (1.06 0.91 2.36) 104 — S — 207 (1.09 1.84 1.44)
104 — S — 213 (1.02 0.87 2.41) 104 — S — 215 (1.32 2.10 1.18) 104 — S — 231 (1.57 1.64 1.63) 104 — S — 233 (0.95 1.07 2.21)
104 — S — 244 (0.84 1.06 2.22) 104 — S — 246 (1.09 1.40 1.88) 104 — S — 248 (1.16 1.95 1.33) 104 — S — 255 (1.48 1.62 1.66)
104 — S — 265 (1.05 1.54 1.74) 104 — S — 268 (1.03 1.69 1.59) 104 — S — 269 (1.00 1.62 1.66) 104 — S — 270 (1.14 2.30 0.98)
104 — S — 271 (1.74 1.71 1.57) 104 — S — 291 (1.83 1.56 1.72) 104 — S — 292 (1.16 1.21 2.06) 104 — S — 294 (1.12 1.06 2.22)
104 — S — 295 (0.87 1.30 1.98) 104 — S — 296 (1.15 1.30 1.98) 104 — S — 305 (1.04 0.96 2.31) 104 — S — 306 (1.20 1.62 1.66)
104 — S — 307 (0.93 1.75 1.53) 104 — S — 320 (1.42 2.04 1.24) 104 — S — 327 (0.81 1.37 1.91) 104 — S — 329 (1.14 1.82 1.45)
104 — S — 342 (2.57 1.57 1.70) 104 — S — 343 (3.10 2.07 1.21) 104 — S — 364 (1.28 2.20 1.08) 104 — S — 367 (1.10 1.52 1.76)
104 — S — 368 (1.21 2.06 1.22) 104 — S — 371 (2.26 1.66 1.61) 104 — S — 395 (1.29 1.36 1.91) 104 — S — 440 (0.97 1.27 2.00)
104 — S — 441 (0.90 1.20 2.08) 104 — S — 447 (0.91 1.39 1.89) 104 — S — 451 (1.00 1.97 1.31) 104 — S — 452 (1.05 1.62 1.65)
104 — S — 463 (0.93 2.07 1.21) 104 — S — 471 (1.08 0.93 2.35) 104 — S — 472 (1.65 2.34 0.93) 104 — S — 473 (1.13 1.55 1.73)
104 — S — 474 (0.98 1.43 1.84) 105 — S — 125 (0.86 2.24 1.40) 105 — S — 150 (1.28 0.90 2.74) 105 — S — 151 (1.19 1.16 2.48)
105 — S — 152 (1.84 1.46 2.18) 105 — S — 153 (1.22 1.00 2.64) 105 — S — 271 (0.86 1.19 2.45) 105 — S — 291 (0.94 1.04 2.60)
105 — S — 342 (1.69 1.06 2.58) 105 — S — 343 (2.22 1.55 2.09) 105 — S — 371 (1.37 1.15 2.49) 105 — S — 429 (1.78 2.25 1.39)
106 — S — 43 (0.94 1.82 1.80) 106 — S — 46 (1.54 1.34 2.28) 106 — S — 57 (1.21 2.36 1.26) 106 — S — 70 (1.01 2.03 1.59)
106 — S — 107 (1.05 1.30 2.32) 106 — S — 109 (0.85 1.83 1.79) 106 — S — 133 (1.05 1.59 2.03) 106 — S — 150 (1.87 1.46 2.15)
106 — S — 151 (1.78 1.72 1.90) 106 — S — 152 (2.42 2.02 1.60) 106 — S — 153 (1.80 1.57 2.05) 106 — S — 177 (0.88 1.24 2.37)
106 — S — 184 (1.62 1.06 2.56) 106 — S — 192 (1.23 1.58 2.04) 106 — S — 195 (1.05 0.90 2.72) 106 — S — 215 (1.03 2.15 1.47)
106 — S — 231 (1.27 1.69 1.93) 106 — S — 247 (0.93 2.65 0.97) 106 — S — 248 (0.86 1.99 1.62) 106 — S — 255 (1.19 1.67 1.95)
106 — S — 259 (1.04 2.48 1.13) 106 — S — 270 (0.84 2.34 1.27) 106 — S — 271 (1.45 1.76 1.86) 106 — S — 291 (1.53 1.60 2.02)
106 — S — 292 (0.87 1.26 2.36) 106 — S — 294 (0.82 1.10 2.51) 106 — S — 296 (0.86 1.34 2.28) 106 — S — 306 (0.91 1.66 1.95)
106 — S — 320 (1.13 2.08 1.54) 106 — S — 324 (1.10 2.58 1.04) 106 — S — 329 (0.85 1.87 1.75) 106 — S — 342 (2.27 1.62 2.00)
106 — S — 343 (2.80 2.11 1.50) 106 — S — 364 (0.98 2.24 1.38) 106 — S — 367 (0.80 1.57 2.05) 106 — S — 368 (0.91 2.11 1.51)
106 — S — 371 (1.96 1.71 1.91) 106 — S — 395 (0.99 1.41 2.21) 106 — S — 472 (1.36 2.39 1.23) 106 — S — 473 (0.83 1.59 2.03)
107 — S — 343 (1.75 0.81 2.55) 107 — S — 429 (1.31 1.51 1.86) 108 — S — 125 (0.84 1.11 1.42) 108 — S — 429 (1.75 1.12 1.42)
109 — S — 429 (1.52 0.98 1.65) 110 — S — 57 (0.87 0.89 1.60) 110 — S — 125 (1.11 1.34 1.15) 110 — S — 250 (0.88 1.46 1.03)
110 — S — 429 (2.02 1.35 1.15) 110 — S — 472 (1.02 0.92 1.57) 111 — S — 150 (0.83 0.88 3.20) 111 — S — 152 (1.38 1.44 2.64)
111 — S — 342 (1.23 1.04 3.04) 111 — S — 343 (1.76 1.53 2.55) 111 — S — 371 (0.92 1.12 2.95) 111 — S — 429 (1.32 2.23 1.85)
112 — S — 57 (0.98 1.39 1.50) 112 — S — 125 (1.22 1.84 1.05) 112 — S — 152 (2.19 1.06 1.83) 112 — S — 250 (0.98 1.97 0.92)
112 — S — 259 (0.81 1.52 1.37) 112 — S — 320 (0.89 1.12 1.77) 112 — S — 324 (0.86 1.61 1.28) 112 — S — 343 (2.57 1.15 1.74)
112 — S — 429 (2.13 1.85 1.04) 112 — S — 472 (1.12 1.43 1.46) 113 — S — 125 (1.01 0.92 1.26) 113 — S — 429 (1.92 0.93 1.25)
114 — S — 43 (1.06 1.58 1.68) 114 — S — 46 (1.66 1.10 2.16) 114 — S — 57 (1.33 2.12 1.15) 114 — S — 70 (1.12 1.79 1.47)
114 — S — 85 (0.91 0.90 2.36) 114 — S — 89 (0.88 1.53 1.74) 114 — S — 93 (0.85 2.27 0.99) 114 — S — 107 (1.17 1.06 2.20)
114 — S — 109 (0.96 1.59 1.67) 114 — S — 115 (0.83 1.20 2.06) 114 — S — 133 (1.17 1.35 1.91) 114 — S — 150 (1.99 1.23 2.04)
114 — S — 151 (1.90 1.48 1.78) 114 — S — 152 (2.54 1.78 1.48) 114 — S — 153 (1.92 1.33 1.94) 114 — S — 165 (0.83 2.20 1.06)
114 — S — 177 (1.00 1.01 2.26) 114 — S — 184 (1.74 0.82 2.44) 114 — S — 192 (1.34 1.34 1.92) 114 — S — 207 (0.91 1.64 1.62)
114 — S — 215 (1.15 1.91 1.35) 114 — S — 231 (1.39 1.45 1.81) 114 — S — 246 (0.91 1.21 2.05) 114 — S — 248 (0.98 1.76 1.51)
114 — S — 255 (1.30 1.43 1.84) 114 — S — 259 (1.16 2.24 1.02) 114 — S — 265 (0.87 1.35 1.91) 114 — S — 268 (0.85 1.50 1.76)
114 — S — 269 (0.82 1.43 1.84) 114 — S — 270 (0.96 2.10 1.16) 114 — S — 271 (1.57 1.52 1.74) 114 — S — 291 (1.65 1.36 1.90)
114 — S — 292 (0.98 1.02 2.24) 114 — S — 294 (0.94 0.86 2.40) 114 — S — 296 (0.97 1.10 2.16) 114 — S — 306 (1.02 1.43 1.84)
114 — S — 320 (1.24 1.84 1.42) 114 — S — 324 (1.22 2.34 0.93) 114 — S — 329 (0.96 1.63 1.63) 114 — S — 342 (2.39 1.38 1.88)
114 — S — 343 (2.92 1.87 1.39) 114 — S — 364 (1.10 2.00 1.26) 114 — S — 367 (0.92 1.33 1.94) 114 — S — 368 (1.03 1.87 1.39)
114 — S — 371 (2.08 1.47 1.79) 114 — S — 395 (1.11 1.17 2.09) 114 — S — 451 (0.82 1.77 1.49) 114 — S — 452 (0.87 1.43 1.83)
114 — S — 472 (1.48 2.15 1.11) 114 — S — 473 (0.95 1.35 1.91) 114 — S — 474 (0.80 1.24 2.02) 115 — S — 429 (1.65 1.37 1.52)
117 — S — 20 (0.98 1.23 2.02) 117 — S — 27 (0.89 1.39 1.85) 117 — S — 28 (0.96 1.66 1.58) 117 — S — 36 (1.11 2.18 1.07)
117 — S — 43 (1.53 2.03 1.22) 117 — S — 46 (2.12 1.55 1.69) 117 — S — 56 (0.88 0.86 2.39) 117 — S — 61 (0.86 1.37 1.88)
117 — S — 65 (0.88 1.16 2.08) 117 — S — 70 (1.59 2.24 1.01) 117 — S — 79 (0.86 1.54 1.70) 117 — S — 80 (0.81 1.50 1.75)
117 — S — 81 (0.89 1.62 1.62) 117 — S — 85 (1.37 1.35 1.89) 117 — S — 89 (1.35 1.98 1.27) 117 — S — 90 (1.26 1.83 1.42)
117 — S — 101 (1.01 1.68 1.57) 117 — S — 107 (1.64 1.51 1.73) 117 — S — 108 (1.20 1.91 1.34) 117 — S — 109 (1.43 2.04 1.20)

117 — S — 110 (0.93 1.68 1.57) 117 — S — 112 (0.82 1.18 2.07) 117 — S — 113 (1.03 2.09 1.15) 117 — S — 115 (1.30 1.65 1.59) 117 — S — 118 (0.91 1.08 2.17) 117 — S — 119 (0.88 1.29 1.96) 117 — S — 132 (0.85 1.00 2.25) 117 — S — 133 (1.64 1.80 1.44) 117 — S — 144 (0.97 1.72 1.53) 117 — S — 150 (2.46 1.68 1.57) 117 — S — 151 (2.37 1.94 1.31) 117 — S — 152 (3.01 2.24 1.01) 117 — S — 153 (2.39 1.78 1.47) 117 — S — 154 (1.92 0.91 2.34) 117 — S — 177 (1.47 1.46 1.79) 117 — S — 183 (1.12 1.79 1.45) 117 — S — 184 (2.21 1.27 1.98) 117 — S — 192 (1.81 1.79 1.46) 117 — S — 195 (1.64 1.12 2.13) 117 — S — 198 (1.35 1.18 2.07) 117 — S — 205 (0.87 1.23 2.01) 117 — S — 206 (0.86 2.15 1.10) 117 — S — 207 (1.38 2.10 1.15) 117 — S — 213 (1.32 1.13 2.12) 117 — S — 231 (1.86 1.90 1.34) 117 — S — 233 (1.24 1.33 1.92) 117 — S — 234 (1.06 1.41 1.84) 117 — S — 237 (1.07 1.71 1.54) 117 — S — 244 (1.13 1.32 1.93) 117 — S — 245 (1.04 1.09 2.15) 117 — S — 246 (1.38 1.66 1.59) 117 — S — 248 (1.45 2.21 1.04) 117 — S — 249 (0.92 2.05 1.20) 117 — S — 251 (0.89 1.91 1.34) 117 — S — 254 (0.88 1.02 2.23) 117 — S — 255 (1.77 1.88 1.37) 117 — S — 258 (0.84 2.32 0.92) 117 — S — 260 (0.90 2.33 0.92) 117 — S — 265 (1.34 1.80 1.44) 117 — S — 266 (0.98 1.38 1.87) 117 — S — 268 (1.32 1.95 1.30) 117 — S — 269 (1.29 1.88 1.37) 117 — S — 271 (2.04 1.97 1.27) 117 — S — 277 (0.87 1.15 2.10) 117 — S — 279 (0.92 1.21 2.04) 117 — S — 286 (0.90 1.00 2.25) 117 — S — 290 (0.98 1.41 1.84) 117 — S — 291 (2.12 1.82 1.43) 117 — S — 292 (1.45 1.47 1.77) 117 — S — 293 (0.96 1.29 1.96) 117 — S — 294 (1.41 1.32 1.93) 117 — S — 295 (1.16 1.56 1.69) 117 — S — 296 (1.44 1.56 1.69) 117 — S — 298 (1.01 1.16 2.08) 117 — S — 304 (0.82 1.01 2.24) 117 — S — 305 (1.33 1.22 2.02) 117 — S — 306 (1.49 1.88 1.37) 117 — S — 307 (1.22 2.01 1.24) 117 — S — 316 (0.81 1.22 2.02) 117 — S — 320 (1.71 2.30 0.95) 117 — S — 327 (1.10 1.63 1.62) 117 — S — 329 (1.43 2.08 1.16) 117 — S — 331 (0.96 0.80 2.44) 117 — S — 332 (0.82 0.98 2.27) 117 — S — 336 (0.92 0.87 2.38) 117 — S — 342 (2.86 1.84 1.41) 117 — S — 343 (3.39 2.33 0.92) 117 — S — 367 (1.39 1.78 1.47) 117 — S — 368 (1.50 2.32 0.92) 117 — S — 371 (2.55 1.92 1.32) 117 — S — 372 (0.96 0.91 2.34) 117 — S — 395 (1.58 1.62 1.62) 117 — S — 396 (1.00 1.06 2.18) 117 — S — 397 (0.81 0.91 2.34) 117 — S — 440 (1.26 1.53 1.71) 117 — S — 441 (1.19 1.46 1.79) 117 — S — 447 (1.20 1.65 1.60) 117 — S — 449 (0.95 1.62 1.63) 117 — S — 451 (1.29 2.23 1.02) 117 — S — 452 (1.34 1.88 1.36) 117 — S — 460 (1.07 1.96 1.29) 117 — S — 463 (1.22 2.33 0.92) 117 — S — 471 (1.37 1.19 2.05) 117 — S — 473 (1.42 1.81 1.44) 117 — S — 474 (1.27 1.69 1.55) 118 — S — 57 (0.89 1.49 1.59) 118 — S — 125 (1.13 1.94 1.14) 118 — S — 151 (1.45 0.86 2.22) 118 — S — 152 (2.10 1.16 1.92) 118 — S — 231 (0.95 0.83 2.25) 118 — S — 250 (0.89 2.07 1.01) 118 — S — 255 (0.86 0.80 2.28) 118 — S — 271 (1.12 0.90 2.19) 118 — S — 320 (0.80 1.22 1.86) 118 — S — 343 (2.48 1.25 1.83) 118 — S — 371 (1.64 0.85 2.23) 118 — S — 429 (2.04 1.95 1.13) 118 — S — 472 (1.03 1.53 1.55) 119 — S — 57 (0.91 1.28 1.56) 119 — S — 125 (1.15 1.73 1.11) 119 — S — 152 (2.13 0.95 1.89) 119 — S — 250 (0.92 1.85 0.98) 119 — S — 320 (0.83 1.01 1.83) 119 — S — 324 (0.80 1.50 1.34) 119 — S — 343 (2.51 1.04 1.80) 119 — S — 429 (2.07 1.74 1.10) 119 — S — 472 (1.06 1.31 1.53) 120 — S — 20 (0.81 2.04 2.19) 120 — S — 36 (0.94 2.99 1.24) 120 — S — 37 (0.94 3.29 0.94) 120 — S — 43 (1.36 2.84 1.38) 120 — S — 46 (1.96 2.36 1.86) 120 — S — 70 (1.42 3.05 1.17) 120 — S — 85 (1.21 2.16 2.06) 120 — S — 89 (1.18 2.79 1.44) 120 — S — 90 (1.09 2.64 1.59) 120 — S — 101 (0.84 2.49 1.73) 120 — S — 105 (1.00 1.59 2.64) 120 — S — 107 (1.47 2.33 1.90) 120 — S — 108 (1.03 2.72 1.51) 120 — S — 109 (1.26 2.85 1.37) 120 — S — 111 (1.46 1.61 2.62) 120 — S — 113 (0.86 2.91 1.32) 120 — S — 115 (1.13 2.47 1.76) 120 — S — 133 (1.47 2.62 1.61) 120 — S — 144 (0.80 2.53 1.70) 120 — S — 150 (2.29 2.49 1.74) 120 — S — 151 (2.20 2.75 1.48) 120 — S — 152 (2.84 3.05 1.18) 120 — S — 153 (2.22 2.59 1.64) 120 — S — 154 (1.75 1.72 2.51) 120 — S — 158 (0.83 0.93 3.30) 120 — S — 161 (1.26 1.02 3.21) 120 — S — 166 (1.47 1.55 2.68) 120 — S — 167 (1.34 1.23 3.00) 120 — S — 170 (1.54 0.96 3.27) 120 — S — 171 (1.24 1.54 2.68) 120 — S — 177 (1.30 2.27 1.96) 120 — S — 183 (0.95 2.61 1.62) 120 — S — 184 (2.04 2.08 2.14) 120 — S — 187 (1.18 1.45 2.77) 120 — S — 188 (1.61 1.49 2.73) 120 — S — 189 (1.36 1.08 3.15) 120 — S — 192 (1.64 2.60 1.62) 120 — S — 194 (1.41 1.21 3.02) 120 — S — 195 (1.47 1.93 2.30) 120 — S — 197 (1.61 0.99 3.24) 120 — S — 198 (1.18 1.99 2.24) 120 — S — 207 (1.21 2.91 1.32) 120 — S — 213 (1.15 1.94 2.28) 120 — S — 215 (1.45 3.17 1.05) 120 — S — 231 (1.69 2.71 1.51) 120 — S — 233 (1.07 2.14 2.09) 120 — S — 234 (0.89 2.22 2.01) 120 — S — 236 (1.11 1.11 3.12) 120 — S — 237 (0.90 2.52 1.71) 120 — S — 243 (1.64 1.35 2.88) 120 — S — 244 (0.96 2.13 2.09) 120 — S — 245 (0.88 1.91 2.32) 120 — S — 246 (1.21 2.47 1.75) 120 — S — 248 (1.28 3.02 1.21) 120 — S — 255 (1.60 2.69 1.54) 120 — S — 265 (1.17 2.61 1.61) 120 — S — 266 (0.81 2.19 2.04) 120 — S — 268 (1.15 2.76 1.46) 120 — S — 269 (1.12 2.69 1.54) 120 — S — 271 (1.87 2.78 1.44) 120 — S — 272 (0.99 1.24 2.99) 120 — S — 290 (0.81 2.22 2.00) 120 — S — 291 (1.95 2.63 1.60) 120 — S — 292 (1.28 2.29 1.94) 120 — S — 294 (1.24 2.13 2.10) 120 — S — 295 (0.99 2.37 1.85) 120 — S — 296 (1.27 2.37 1.86) 120 — S — 298 (0.84 1.97 2.25) 120 — S — 300 (0.85 1.37 2.85) 120 — S — 301 (0.90 1.08 3.14) 120 — S — 302 (1.02 0.93 3.30) 120 — S — 305 (1.16 2.04 2.19) 120 — S — 306 (1.32 2.69 1.54) 120 — S — 307 (1.05 2.82 1.41) 120 — S — 318 (0.94 1.08 3.15) 120 — S — 320 (1.54 3.11 1.12) 120 — S — 327 (0.93 2.44 1.79) 120 — S — 329 (1.26 2.90 1.33) 120 — S — 342 (2.69 2.65 1.58) 120 — S — 343 (3.22 3.14 1.09) 120 — S — 357 (1.11 1.24 2.98) 120 — S — 364 (1.40 3.27 0.96) 120 — S — 367 (1.22 2.59 1.64) 120 — S — 368 (1.33 3.13 1.09) 120 — S — 371 (2.38 2.74 1.49) 120 — S — 395 (1.41 2.44 1.79) 120 — S — 396 (0.83 1.87 2.35) 120 — S — 440 (1.09 2.34 1.88) 120 — S — 441 (1.03 2.27 1.96) 120 — S — 447 (1.04 2.46 1.77) 120 — S — 451 (1.12 3.04 1.19) 120 — S — 452 (1.17 2.69 1.53) 120 — S — 460 (0.90 2.77 1.46) 120 — S — 463 (1.05 3.14 1.09) 120 — S — 471 (1.20 2.00 2.22) 120 — S — 473 (1.25 2.62 1.61) 120 — S — 474 (1.10 2.51 1.72) 123 — S — 57 (1.27 1.15 1.20) 123 — S — 70 (1.07 0.82 1.53) 123 — S — 152 (2.49 0.82 1.53) 123 — S — 215 (1.09 0.94 1.41) 123 — S — 247 (0.99 1.45 0.90) 123 — S — 259 (1.10 1.28 1.07) 123 — S — 270 (0.90 1.14 1.21) 123 — S — 320 (1.19 0.88 1.47) 123 — S — 324 (1.16 1.37 0.98) 123 — S — 343 (2.87 0.91 1.44) 123 — S — 364 (1.05 1.04 1.31) 123 — S — 368 (0.98 0.90 1.45) 123 — S — 472 (1.42 1.18 1.17) 124 — S — 28 (1.18 0.98 1.36) 124 — S — 43 (1.76 1.35 0.99) 124 — S — 46 (2.35 0.87 1.47) 124 — S — 62 (0.97 0.89 1.45) 124 — S — 79 (1.09 0.86 1.48) 124 — S — 80 (1.04 0.82 1.52) 124 — S — 81 (1.12 0.94 1.40) 124 — S — 82 (0.85 1.13 1.21) 124 — S — 86 (0.82 1.04 1.30) 124 — S — 89 (1.57 1.30 1.04) 124 — S — 90 (1.48 1.15 1.19) 124 — S — 101 (1.24 1.00 1.34) 124 — S — 107 (1.86 0.83 1.50) 124 — S — 108 (1.42 1.22 1.11) 124 — S — 109 (1.66 1.36 0.98)

124 — S — 110 (1.15 1.00 1.34) 124 — S — 113 (1.26 1.41 0.92) 124 — S — 115 (1.53 0.97 1.37) 124 — S — 133 (1.86 1.12 1.21) 124 — S — 144 (1.20 1.03 1.30) 124 — S — 150 (2.68 1.00 1.34) 124 — S — 151 (2.59 1.25 1.08) 124 — S — 153 (2.62 1.10 1.24) 124 — S — 183 (1.35 1.11 1.22) 124 — S — 192 (2.04 1.11 1.23) 124 — S — 207 (1.61 1.41 0.92) 124 — S — 231 (2.08 1.22 1.12) 124 — S — 237 (1.30 1.02 1.31) 124 — S — 246 (1.61 0.98 1.36) 124 — S — 249 (1.15 1.37 0.97) 124 — S — 251 (1.11 1.22 1.11) 124 — S — 255 (2.00 1.20 1.14) 124 — S — 265 (1.57 1.12 1.22) 124 — S — 268 (1.55 1.27 1.07) 124 — S — 269 (1.51 1.20 1.14) 124 — S — 271 (2.26 1.29 1.05) 124 — S — 291 (2.34 1.13 1.20) 124 — S — 295 (1.39 0.88 1.46) 124 — S — 296 (1.67 0.87 1.46) 124 — S — 306 (1.72 1.20 1.14) 124 — S — 307 (1.45 1.32 1.01) 124 — S — 327 (1.33 0.94 1.39) 124 — S — 329 (1.66 1.40 0.93) 124 — S — 342 (3.09 1.15 1.18) 124 — S — 367 (1.61 1.10 1.24) 124 — S — 371 (2.77 1.24 1.09) 124 — S — 395 (1.81 0.94 1.39) 124 — S — 420 (0.99 1.42 0.92) 124 — S — 430 (0.82 1.04 1.29) 124 — S — 440 (1.49 0.85 1.49) 124 — S — 443 (0.89 1.39 0.94) 124 — S — 447 (1.43 0.96 1.37) 124 — S — 449 (1.17 0.93 1.40) 124 — S — 452 (1.57 1.20 1.14) 124 — S — 457 (1.02 0.84 1.49) 124 — S — 459 (0.81 1.08 1.26) 124 — S — 460 (1.30 1.28 1.06) 124 — S — 461 (1.01 1.04 1.30) 124 — S — 469 (0.99 1.18 1.16) 124 — S — 473 (1.64 1.12 1.21) 124 — S — 474 (1.50 1.01 1.32) 127 — S — 43 (0.99 1.93 1.75) 127 — S — 46 (1.59 1.45 2.23) 127 — S — 57 (1.26 2.47 1.22) 127 — S — 70 (1.05 2.14 1.54) 127 — S — 85 (0.84 1.26 2.43) 127 — S — 89 (0.81 1.88 1.81) 127 — S — 107 (1.10 1.42 2.27) 127 — S — 109 (0.89 1.94 1.74) 127 — S — 133 (1.10 1.71 1.98) 127 — S — 150 (1.92 1.58 2.11) 127 — S — 151 (1.83 1.84 1.85) 127 — S — 152 (2.47 2.14 1.55) 127 — S — 153 (1.85 1.68 2.01) 127 — S — 154 (1.38 0.81 2.88) 127 — S — 177 (0.93 1.36 2.33) 127 — S — 184 (1.67 1.17 2.51) 127 — S — 192 (1.27 1.69 1.99) 127 — S — 195 (1.10 1.02 2.67) 127 — S — 198 (0.81 1.08 2.61) 127 — S — 207 (0.84 2.00 1.69) 127 — S — 215 (1.08 2.26 1.42) 127 — S — 231 (1.32 1.81 1.88) 127 — S — 246 (0.84 1.56 2.12) 127 — S — 247 (0.98 2.77 0.92) 127 — S — 248 (0.91 2.11 1.58) 127 — S — 255 (1.23 1.78 1.91) 127 — S — 259 (1.09 2.60 1.09) 127 — S — 265 (0.80 1.70 1.98) 127 — S — 270 (0.89 2.46 1.23) 127 — S — 271 (1.50 1.87 1.81) 127 — S — 291 (1.58 1.72 1.97) 127 — S — 292 (0.91 1.38 2.31) 127 — S — 294 (0.87 1.22 2.47) 127 — S — 296 (0.90 1.46 2.23) 127 — S — 306 (0.95 1.78 1.91) 127 — S — 320 (1.17 2.20 1.49) 127 — S — 324 (1.15 2.69 1.00) 127 — S — 329 (0.89 1.99 1.70) 127 — S — 342 (2.32 1.74 1.95) 127 — S — 343 (2.85 2.23 1.46) 127 — S — 364 (1.03 2.36 1.33) 127 — S — 367 (0.85 1.68 2.01) 127 — S — 368 (0.96 2.22 1.46) 127 — S — 371 (2.01 1.83 1.86) 127 — S — 395 (1.04 1.53 2.16) 127 — S — 452 (0.80 1.79 1.90) 127 — S — 471 (0.83 1.09 2.59) 127 — S — 472 (1.41 2.51 1.18) 127 — S — 473 (0.88 1.71 1.98) 128 — S — 9 (1.18 1.40 2.25) 128 — S — 20 (1.29 1.95 1.71) 128 — S — 27 (1.20 2.11 1.54) 128 — S — 28 (1.26 2.38 1.27) 128 — S — 29 (1.03 2.11 1.55) 128 — S — 40 (0.85 2.11 1.55) 128 — S — 43 (1.84 2.75 0.91) 128 — S — 44 (0.92 1.26 2.39) 128 — S — 46 (2.43 2.27 1.39) 128 — S — 56 (1.19 1.58 2.08) 128 — S — 61 (1.17 2.09 1.57) 128 — S — 62 (1.05 2.29 1.37) 128 — S — 65 (1.18 1.88 1.77) 128 — S — 68 (0.90 1.85 1.81) 128 — S — 79 (1.17 2.26 1.39) 128 — S — 80 (1.12 2.22 1.44) 128 — S — 81 (1.20 2.34 1.31) 128 — S — 82 (0.93 2.53 1.13) 128 — S — 83 (1.23 1.52 2.14) 128 — S — 85 (1.68 2.07 1.58) 128 — S — 86 (0.90 2.44 1.21) 128 — S — 89 (1.66 2.70 0.96) 128 — S — 90 (1.57 2.55 1.11) 128 — S — 101 (1.32 2.40 1.26) 128 — S — 102 (0.95 1.41 2.25) 128 — S — 105 (1.48 1.50 2.16) 128 — S — 106 (0.90 0.93 2.72) 128 — S — 107 (1.94 2.23 1.42) 128 — S — 108 (1.50 2.63 1.03) 128 — S — 110 (1.24 2.40 1.26) 128 — S — 111 (1.94 1.52 2.14) 128 — S — 112 (1.13 1.90 1.76) 128 — S — 115 (1.61 2.37 1.28) 128 — S — 118 (1.22 1.80 1.86) 128 — S — 119 (1.19 2.01 1.65) 128 — S — 123 (0.83 2.14 1.52) 128 — S — 127 (0.85 0.82 2.84) 128 — S — 131 (1.25 1.47 2.18) 128 — S — 132 (1.16 1.72 1.94) 128 — S — 133 (1.95 2.52 1.13) 128 — S — 144 (1.28 2.44 1.22) 128 — S — 148 (0.94 1.30 2.35) 128 — S — 150 (2.77 2.40 1.26) 128 — S — 151 (2.67 2.66 1.00) 128 — S — 153 (2.70 2.50 1.16) 128 — S — 154 (2.23 1.63 2.03) 128 — S — 158 (1.30 0.84 2.82) 128 — S — 161 (1.74 0.93 2.73) 128 — S — 166 (1.95 1.45 2.20) 128 — S — 167 (1.82 1.14 2.52) 128 — S — 170 (2.02 0.86 2.79) 128 — S — 171 (1.72 1.45 2.21) 128 — S — 175 (0.95 1.09 2.57) 128 — S — 176 (0.90 0.84 2.81) 128 — S — 177 (1.78 2.18 1.48) 128 — S — 182 (0.92 1.02 2.64) 128 — S — 183 (1.43 2.51 1.14) 128 — S — 184 (2.52 1.99 1.67) 128 — S — 187 (1.66 1.36 2.29) 128 — S — 188 (2.09 1.40 2.25) 128 — S — 189 (1.84 0.99 2.67) 128 — S — 192 (2.12 2.51 1.15) 128 — S — 193 (1.04 1.67 1.98) 128 — S — 194 (1.89 1.11 2.54) 128 — S — 195 (1.95 1.83 1.82) 128 — S — 197 (2.09 0.90 2.76) 128 — S — 198 (1.66 1.89 1.76) 128 — S — 205 (1.18 1.95 1.70) 128 — S — 208 (1.14 1.43 2.23) 128 — S — 209 (0.89 1.50 2.15) 128 — S — 213 (1.62 1.85 1.81) 128 — S — 214 (1.19 1.08 2.57) 128 — S — 217 (1.05 1.88 1.77) 128 — S — 218 (1.02 2.06 1.60) 128 — S — 219 (0.82 1.62 2.04) 128 — S — 222 (0.93 1.46 2.19) 128 — S — 230 (0.86 1.29 2.36) 128 — S — 231 (2.17 2.62 1.03) 128 — S — 233 (1.55 2.05 1.61) 128 — S — 234 (1.37 2.13 1.53) 128 — S — 236 (1.59 1.02 2.64) 128 — S — 237 (1.38 2.43 1.23) 128 — S — 240 (0.98 0.91 2.74) 128 — S — 243 (2.12 1.26 2.40) 128 — S — 244 (1.44 2.04 1.62) 128 — S — 245 (1.35 1.81 1.84) 128 — S — 246 (1.69 2.38 1.28) 128 — S — 251 (1.20 2.63 1.03) 128 — S — 254 (1.19 1.74 1.92) 128 — S — 255 (2.08 2.60 1.06) 128 — S — 261 (0.82 0.82 2.83) 128 — S — 265 (1.65 2.52 1.14) 128 — S — 266 (1.29 2.10 1.56) 128 — S — 267 (1.09 1.80 1.86) 128 — S — 268 (1.63 2.67 0.99) 128 — S — 269 (1.60 2.60 1.06) 128 — S — 271 (2.34 2.69 0.97) 128 — S — 272 (1.47 1.14 2.51) 128 — S — 274 (0.96 1.60 2.06) 128 — S — 276 (0.88 1.01 2.65) 128 — S — 277 (1.18 1.87 1.79) 128 — S — 279 (1.23 1.93 1.73) 128 — S — 280 (0.91 1.61 2.05) 128 — S — 282 (1.03 1.43 2.22) 128 — S — 284 (0.81 1.44 2.21) 128 — S — 285 (0.95 1.81 1.85) 128 — S — 286 (1.21 1.72 1.94) 128 — S — 287 (1.01 1.73 1.93) 128 — S — 288 (1.00 1.67 1.99) 128 — S — 289 (1.26 1.50 2.15) 128 — S — 290 (1.29 2.13 1.53) 128 — S — 291 (2.43 2.54 1.12) 128 — S — 292 (1.76 2.19 1.46) 128 — S — 293 (1.26 2.00 1.65) 128 — S — 294 (1.72 2.04 1.62) 128 — S — 295 (1.47 2.28 1.38) 128 — S — 296 (1.75 2.28 1.38) 128 — S — 297 (1.06 1.41 2.25) 128 — S — 298 (1.32 1.88 1.78) 128 — S — 300 (1.33 1.28 2.38) 128 — S — 301 (1.38 0.99 2.66) 128 — S — 302 (1.50 0.84 2.82) 128 — S — 303 (1.08 1.25 2.40) 128 — S — 304 (1.13 1.73 1.93) 128 — S — 305 (1.64 1.94 1.71) 128 — S — 306 (1.80 2.60 1.06) 128 — S — 307 (1.53 2.73 0.93) 128 — S — 308 (1.12 0.89 2.77) 128 — S — 310 (1.24 1.34 2.32) 128 — S — 311 (0.96 1.62 2.04) 128 — S — 312 (1.06 1.49 2.17) 128 — S — 313 (0.84 1.65 2.00) 128 — S — 316 (1.12 1.94 1.71) 128 — S — 318 (1.42 0.98 2.67) 128 — S — 327 (1.41 2.35 1.31) 128 — S — 331 (1.27 1.52 2.13) 128 — S — 332 (1.13 1.70 1.96)

128 — S — 336 (1.23 1.59 2.07) 128 — S — 342 (3.17 2.55 1.10) 128 — S — 352 (0.84 0.82 2.83) 128 — S — 356 (0.89 1.40 2.25)
128 — S — 357 (1.59 1.15 2.51) 128 — S — 358 (1.07 1.86 1.79) 128 — S — 367 (1.70 2.50 1.16) 128 — S — 370 (1.04 1.93 1.73)
128 — S — 371 (2.86 2.64 1.01) 128 — S — 372 (1.27 1.63 2.03) 128 — S — 374 (0.88 2.12 1.53) 128 — S — 379 (0.95 1.63 2.03)
128 — S — 382 (1.02 1.81 1.85) 128 — S — 391 (0.96 1.61 2.04) 128 — S — 394 (0.86 0.91 2.75) 128 — S — 395 (1.89 2.34 1.31)
128 — S — 396 (1.31 1.78 1.87) 128 — S — 397 (1.12 1.63 2.03) 128 — S — 403 (0.91 0.88 2.78) 128 — S — 415 (1.01 1.51 2.15)
128 — S — 430 (0.90 2.44 1.21) 128 — S — 432 (1.14 1.12 2.54) 128 — S — 433 (0.85 1.13 2.53) 128 — S — 434 (0.96 1.92 1.74)
128 — S — 435 (1.05 2.09 1.57) 128 — S — 437 (1.23 1.46 2.19) 128 — S — 440 (1.57 2.25 1.40) 128 — S — 441 (1.50 2.18 1.48)
128 — S — 447 (1.51 2.37 1.29) 128 — S — 449 (1.26 2.34 1.32) 128 — S — 450 (0.88 2.00 1.65) 128 — S — 452 (1.65 2.60 1.05)
128 — S — 453 (1.15 1.31 2.35) 128 — S — 454 (0.97 1.47 2.18) 128 — S — 455 (0.95 1.74 1.91) 128 — S — 457 (1.10 2.25 1.41)
128 — S — 459 (0.89 2.48 1.18) 128 — S — 460 (1.38 2.68 0.98) 128 — S — 461 (1.09 2.44 1.22) 128 — S — 468 (0.98 2.15 1.50)
128 — S — 469 (1.07 2.58 1.08) 128 — S — 471 (1.68 1.91 1.75) 128 — S — 473 (1.73 2.53 1.13) 128 — S — 474 (1.58 2.41 1.24)
129 — S — 36 (0.80 2.60 1.38) 129 — S — 37 (0.80 2.90 1.08) 129 — S — 43 (1.22 2.45 1.53) 129 — S — 46 (1.81 1.97 2.00)
129 — S — 57 (1.49 2.99 0.99) 129 — S — 70 (1.28 2.66 1.32) 129 — S — 85 (1.06 1.78 2.20) 129 — S — 89 (1.04 2.40 1.58)
129 — S — 90 (0.95 2.25 1.73) 129 — S — 105 (0.86 1.20 2.78) 129 — S — 107 (1.33 1.94 2.04) 129 — S — 108 (0.88 2.33 1.65)
129 — S — 109 (1.12 2.46 1.52) 129 — S — 111 (1.32 1.22 2.76) 129 — S — 115 (0.99 2.08 1.90) 129 — S — 133 (1.33 2.23 1.75)
129 — S — 150 (2.15 2.10 1.88) 129 — S — 151 (2.06 2.36 1.62) 129 — S — 152 (2.70 2.66 1.32) 129 — S — 153 (2.08 2.20 1.78)
129 — S — 154 (1.61 1.33 2.65) 129 — S — 165 (0.99 3.07 0.90) 129 — S — 166 (1.33 1.16 2.82) 129 — S — 167 (1.20 0.84 3.14)
129 — S — 171 (1.10 1.15 2.83) 129 — S — 177 (1.16 1.88 2.10) 129 — S — 183 (0.81 2.22 1.76) 129 — S — 184 (1.90 1.69 2.29)
129 — S — 187 (1.04 1.07 2.91) 129 — S — 188 (1.47 1.11 2.87) 129 — S — 192 (1.50 2.21 1.77) 129 — S — 194 (1.27 0.82 3.16)
129 — S — 195 (1.33 1.54 2.44) 129 — S — 198 (1.04 1.60 2.38) 129 — S — 207 (1.07 2.52 1.46) 129 — S — 213 (1.01 1.55 2.43)
129 — S — 215 (1.31 2.78 1.20) 129 — S — 231 (1.55 2.33 1.65) 129 — S — 233 (0.93 1.75 2.23) 129 — S — 243 (1.50 0.96 3.02)
129 — S — 244 (0.82 1.74 2.24) 129 — S — 246 (1.07 2.08 1.90) 129 — S — 248 (1.14 2.63 1.35) 129 — S — 255 (1.46 2.30 1.68)
129 — S — 265 (1.03 2.22 1.76) 129 — S — 268 (1.01 2.37 1.61) 129 — S — 269 (0.98 2.30 1.68) 129 — S — 270 (1.12 2.98 1.00)
129 — S — 271 (1.73 2.39 1.59) 129 — S — 272 (0.85 0.85 3.13) 129 — S — 291 (1.81 2.24 1.74) 129 — S — 292 (1.14 1.90 2.08)
129 — S — 294 (1.10 1.74 2.24) 129 — S — 295 (0.85 1.98 2.00) 129 — S — 296 (1.13 1.98 2.00) 129 — S — 305 (1.02 1.65 2.33)
129 — S — 306 (1.18 2.30 1.68) 129 — S — 307 (0.91 2.43 1.55) 129 — S — 320 (1.40 2.72 1.26) 129 — S — 329 (1.12 2.51 1.47)
129 — S — 342 (2.55 2.26 1.72) 129 — S — 343 (3.08 2.75 1.23) 129 — S — 357 (0.97 0.85 3.12) 129 — S — 364 (1.26 2.88 1.10)
129 — S — 367 (1.08 2.20 1.78) 129 — S — 368 (1.19 2.74 1.23) 129 — S — 371 (2.24 2.35 1.63) 129 — S — 395 (1.27 2.05 1.93)
129 — S — 440 (0.95 1.96 2.02) 129 — S — 441 (0.88 1.88 2.10) 129 — S — 447 (0.89 2.07 1.91) 129 — S — 451 (0.98 2.65 1.33)
129 — S — 452 (1.03 2.31 1.67) 129 — S — 463 (0.91 2.75 1.23) 129 — S — 471 (1.06 1.61 2.36) 129 — S — 472 (1.64 3.03 0.95)
129 — S — 473 (1.11 2.23 1.75) 129 — S — 474 (0.96 2.12 1.86) 130 — S — 9 (1.25 0.81 2.18) 130 — S — 20 (1.36 1.35 1.64)
130 — S — 27 (1.27 1.52 1.47) 130 — S — 28 (1.34 1.79 1.20) 130 — S — 29 (1.10 1.51 1.48) 130 — S — 40 (0.92 1.51 1.48)
130 — S — 46 (2.51 1.67 1.31) 130 — S — 56 (1.26 0.98 2.01) 130 — S — 61 (1.25 1.49 1.50) 130 — S — 62 (1.12 1.69 1.30)
130 — S — 65 (1.26 1.29 1.70) 130 — S — 68 (0.97 1.25 1.74) 130 — S — 79 (1.24 1.67 1.32) 130 — S — 80 (1.19 1.62 1.37)
130 — S — 81 (1.27 1.75 1.24) 130 — S — 82 (1.00 1.93 1.06) 130 — S — 83 (1.30 0.92 2.07) 130 — S — 85 (1.75 1.48 1.51)
130 — S — 86 (0.97 1.85 1.14) 130 — S — 90 (1.64 1.95 1.04) 130 — S — 101 (1.39 1.80 1.19) 130 — S — 102 (1.02 0.81 2.18)
130 — S — 105 (1.55 0.90 2.09) 130 — S — 107 (2.02 1.64 1.35) 130 — S — 108 (1.58 2.03 0.96) 130 — S — 110 (1.31 1.80 1.19)
130 — S — 111 (2.01 0.92 2.07) 130 — S — 112 (1.20 1.30 1.69) 130 — S — 115 (1.68 1.78 1.21) 130 — S — 118 (1.29 1.20 1.79)
130 — S — 119 (1.26 1.41 1.58) 130 — S — 123 (0.90 1.54 1.45) 130 — S — 131 (1.32 0.88 2.11) 130 — S — 132 (1.23 1.12 1.87)
130 — S — 133 (2.02 1.93 1.06) 130 — S — 144 (1.35 1.84 1.15) 130 — S — 150 (2.84 1.80 1.19) 130 — S — 151 (2.75 2.06 0.93)
130 — S — 153 (2.77 1.90 1.09) 130 — S — 154 (2.30 1.03 1.96) 130 — S — 166 (2.02 0.86 2.13) 130 — S — 171 (1.79 0.85 2.13)
130 — S — 177 (1.85 1.58 1.41) 130 — S — 183 (1.50 1.92 1.07) 130 — S — 184 (2.59 1.39 1.60) 130 — S — 188 (2.16 0.81 2.18)
130 — S — 192 (2.19 1.91 1.07) 130 — S — 193 (1.11 1.08 1.91) 130 — S — 195 (2.02 1.24 1.75) 130 — S — 198 (1.73 1.30 1.69)
130 — S — 205 (1.25 1.36 1.63) 130 — S — 208 (1.21 0.83 2.16) 130 — S — 209 (0.96 0.91 2.08) 130 — S — 213 (1.70 1.25 1.74)
130 — S — 217 (1.12 1.29 1.70) 130 — S — 218 (1.09 1.46 1.52) 130 — S — 219 (0.89 1.02 1.97) 130 — S — 222 (1.00 0.87 2.12)
130 — S — 231 (2.24 2.03 0.96) 130 — S — 233 (1.62 1.45 1.54) 130 — S — 234 (1.44 1.53 1.46) 130 — S — 237 (1.45 1.83 1.16)
130 — S — 244 (1.51 1.44 1.54) 130 — S — 245 (1.43 1.22 1.77) 130 — S — 246 (1.76 1.78 1.21) 130 — S — 251 (1.27 2.03 0.96)
130 — S — 254 (1.26 1.14 1.85) 130 — S — 255 (2.15 2.00 0.99) 130 — S — 265 (1.72 1.92 1.06) 130 — S — 266 (1.36 1.50 1.49)
130 — S — 267 (1.16 1.20 1.79) 130 — S — 268 (1.70 2.07 0.91) 130 — S — 269 (1.67 2.00 0.99) 130 — S — 274 (1.03 1.00 1.99)
130 — S — 275 (0.83 1.42 1.57) 130 — S — 277 (1.25 1.27 1.72) 130 — S — 279 (1.30 1.33 1.66) 130 — S — 280 (0.98 1.01 1.98)
130 — S — 282 (1.10 0.84 2.15) 130 — S — 284 (0.88 0.85 2.14) 130 — S — 285 (1.02 1.21 1.77) 130 — S — 286 (1.28 1.12 1.87)
130 — S — 287 (1.08 1.13 1.86) 130 — S — 288 (1.07 1.07 1.92) 130 — S — 289 (1.33 0.91 2.08) 130 — S — 290 (1.36 1.53 1.46)
130 — S — 291 (2.50 1.94 1.05) 130 — S — 292 (1.83 1.60 1.39) 130 — S — 293 (1.34 1.41 1.58) 130 — S — 294 (1.79 1.44 1.55)
130 — S — 295 (1.54 1.68 1.30) 130 — S — 296 (1.82 1.68 1.31) 130 — S — 297 (1.13 0.81 2.18) 130 — S — 298 (1.39 1.29 1.70)
130 — S — 304 (1.20 1.13 1.86) 130 — S — 305 (1.71 1.35 1.64) 130 — S — 306 (1.87 2.00 0.99) 130 — S — 311 (1.03 1.02 1.97)
130 — S — 312 (1.13 0.89 2.10) 130 — S — 313 (0.91 1.06 1.93) 130 — S — 316 (1.20 1.35 1.64) 130 — S — 327 (1.48 1.75 1.24)
130 — S — 331 (1.34 0.93 2.06) 130 — S — 332 (1.20 1.10 1.89) 130 — S — 336 (1.30 0.99 2.00) 130 — S — 342 (3.24 1.96 1.03)
130 — S — 356 (0.96 0.81 2.18) 130 — S — 358 (1.14 1.27 1.72) 130 — S — 367 (1.77 1.90 1.09) 130 — S — 370 (1.11 1.33 1.66)

130 — S — 371 (2.93 2.05 0.94) 130 — S — 372 (1.34 1.03 1.96) 130 — S — 374 (0.95 1.53 1.46) 130 — S — 379 (1.02 1.03 1.96)
130 — S — 382 (1.09 1.21 1.78) 130 — S — 391 (1.03 1.02 1.97) 130 — S — 395 (1.96 1.75 1.24) 130 — S — 396 (1.38 1.19 1.80)
130 — S — 397 (1.19 1.03 1.96) 130 — S — 415 (1.08 0.91 2.08) 130 — S — 430 (0.97 1.85 1.14) 130 — S — 434 (1.03 1.32 1.67)
130 — S — 435 (1.12 1.49 1.50) 130 — S — 437 (1.30 0.87 2.12) 130 — S — 440 (1.64 1.66 1.33) 130 — S — 441 (1.57 1.58 1.41)
130 — S — 447 (1.59 1.77 1.22) 130 — S — 449 (1.33 1.74 1.25) 130 — S — 450 (0.95 1.41 1.58) 130 — S — 452 (1.72 2.01 0.98)
130 — S — 454 (1.04 0.88 2.11) 130 — S — 455 (1.02 1.15 1.84) 130 — S — 457 (1.17 1.65 1.34) 130 — S — 459 (0.96 1.88 1.11)
130 — S — 460 (1.45 2.08 0.91) 130 — S — 461 (1.16 1.84 1.15) 130 — S — 462 (0.86 1.86 1.13) 130 — S — 467 (0.85 1.25 1.74)
130 — S — 468 (1.05 1.56 1.43) 130 — S — 469 (1.14 1.98 1.00) 130 — S — 471 (1.75 1.32 1.67) 130 — S — 473 (1.80 1.93 1.06)
130 — S — 474 (1.65 1.82 1.17) 131 — S — 57 (0.86 1.82 1.61) 131 — S — 125 (1.10 2.27 1.16) 131 — S — 150 (1.52 0.93 2.50)
131 — S — 151 (1.43 1.18 2.25) 131 — S — 152 (2.07 1.48 1.95) 131 — S — 153 (1.45 1.03 2.40) 131 — S — 192 (0.88 1.04 2.39)
131 — S — 231 (0.92 1.15 2.28) 131 — S — 250 (0.87 2.39 1.04) 131 — S — 255 (0.84 1.13 2.30) 131 — S — 271 (1.10 1.22 2.21)
131 — S — 291 (1.18 1.06 2.37) 131 — S — 342 (1.92 1.08 2.35) 131 — S — 343 (2.45 1.57 1.86) 131 — S — 371 (1.61 1.17 2.26)
131 — S — 429 (2.01 2.27 1.16) 131 — S — 472 (1.01 1.85 1.58) 132 — S — 57 (0.95 1.57 1.52) 132 — S — 125 (1.19 2.02 1.08)
132 — S — 151 (1.52 0.94 2.16) 132 — S — 152 (2.16 1.24 1.86) 132 — S — 231 (1.01 0.91 2.19) 132 — S — 250 (0.96 2.15 0.95)
132 — S — 255 (0.92 0.88 2.21) 132 — S — 271 (1.19 0.97 2.12) 132 — S — 291 (1.27 0.82 2.28) 132 — S — 320 (0.86 1.30 1.80)
132 — S — 324 (0.84 1.79 1.30) 132 — S — 342 (2.01 0.84 2.26) 132 — S — 343 (2.54 1.33 1.77) 132 — S — 371 (1.70 0.93 2.17)
132 — S — 429 (2.10 2.03 1.07) 132 — S — 472 (1.10 1.61 1.49) 133 — S — 429 (1.31 1.22 1.86) 134 — S — 20 (0.83 2.99 2.17)
134 — S — 28 (0.81 3.42 1.73) 134 — S — 36 (0.97 3.93 1.22) 134 — S — 37 (0.96 4.23 0.92) 134 — S — 43 (1.38 3.79 1.36)
134 — S — 46 (1.98 3.31 1.84) 134 — S — 70 (1.44 4.00 1.15) 134 — S — 85 (1.23 3.11 2.04) 134 — S — 89 (1.20 3.74 1.42)
134 — S — 90 (1.11 3.59 1.57) 134 — S — 101 (0.86 3.44 1.71) 134 — S — 105 (1.02 2.53 2.62) 134 — S — 107 (1.49 3.27 1.88)
134 — S — 108 (1.05 3.66 1.49) 134 — S — 109 (1.28 3.80 1.35) 134 — S — 111 (1.48 2.56 2.60) 134 — S — 113 (0.88 3.85 1.30)
134 — S — 115 (1.15 3.41 1.74) 134 — S — 133 (1.49 3.56 1.59) 134 — S — 136 (0.80 1.45 3.70) 134 — S — 141 (1.27 1.28 3.87)
134 — S — 144 (0.82 3.47 1.68) 134 — S — 145 (0.80 4.12 1.03) 134 — S — 150 (2.31 3.44 1.72) 134 — S — 151 (2.22 3.69 1.46)
134 — S — 152 (2.86 3.99 1.16) 134 — S — 153 (2.24 3.54 1.62) 134 — S — 154 (1.77 2.66 2.49) 134 — S — 158 (0.85 1.88 3.28)
134 — S — 160 (1.27 1.38 3.78) 134 — S — 161 (1.28 1.97 3.19) 134 — S — 166 (1.49 2.49 2.66) 134 — S — 167 (1.36 2.18 2.98)
134 — S — 168 (0.92 1.46 3.69) 134 — S — 170 (1.56 1.90 3.25) 134 — S — 171 (1.26 2.49 2.66) 134 — S — 177 (1.32 3.22 1.94)
134 — S — 183 (0.97 3.55 1.60) 134 — S — 184 (2.06 3.03 2.12) 134 — S — 187 (1.20 2.40 2.75) 134 — S — 188 (1.63 2.44 2.71)
134 — S — 189 (1.38 2.03 3.12) 134 — S — 192 (1.66 3.55 1.60) 134 — S — 194 (1.43 2.15 3.00) 134 — S — 195 (1.49 2.87 2.28)
134 — S — 197 (1.63 1.94 3.22) 134 — S — 198 (1.20 2.93 2.22) 134 — S — 207 (1.23 3.85 1.30) 134 — S — 213 (1.17 2.89 2.26)
134 — S — 215 (1.47 4.12 1.03) 134 — S — 231 (1.71 3.66 1.49) 134 — S — 233 (1.09 3.09 2.07) 134 — S — 234 (0.91 3.17 1.99)
134 — S — 236 (1.13 2.05 3.10) 134 — S — 237 (0.92 3.46 1.69) 134 — S — 243 (1.66 2.29 2.86) 134 — S — 244 (0.98 3.08 2.07)
134 — S — 245 (0.90 2.85 2.30) 134 — S — 246 (1.23 3.42 1.73) 134 — S — 248 (1.30 3.97 1.19) 134 — S — 255 (1.62 3.64 1.52)
134 — S — 264 (1.01 1.50 3.65) 134 — S — 265 (1.19 3.56 1.59) 134 — S — 266 (0.83 3.14 2.02) 134 — S — 268 (1.17 3.71 1.44)
134 — S — 269 (1.14 3.64 1.52) 134 — S — 271 (1.89 3.73 1.42) 134 — S — 272 (1.01 2.18 2.97) 134 — S — 289 (0.80 2.54 2.61)
134 — S — 290 (0.83 3.17 1.98) 134 — S — 291 (1.97 3.57 1.58) 134 — S — 292 (1.30 3.23 1.92) 134 — S — 293 (0.81 3.04 2.11)
134 — S — 294 (1.26 3.07 2.08) 134 — S — 295 (1.01 3.32 1.83) 134 — S — 296 (1.29 3.31 1.84) 134 — S — 298 (0.86 2.92 2.23)
134 — S — 300 (0.87 2.32 2.83) 134 — S — 301 (0.92 2.03 3.12) 134 — S — 302 (1.04 1.88 3.27) 134 — S — 305 (1.18 2.98 2.17)
134 — S — 306 (1.34 3.64 1.52) 134 — S — 307 (1.07 3.77 1.39) 134 — S — 318 (0.96 2.02 3.13) 134 — S — 320 (1.56 4.05 1.10)
134 — S — 327 (0.96 3.38 1.77) 134 — S — 329 (1.28 3.84 1.31) 134 — S — 331 (0.82 2.56 2.59) 134 — S — 338 (1.07 1.39 3.76)
134 — S — 342 (2.71 3.59 1.56) 134 — S — 343 (3.24 4.08 1.07) 134 — S — 357 (1.13 2.19 2.96) 134 — S — 364 (1.42 4.21 0.94)
134 — S — 367 (1.24 3.54 1.62) 134 — S — 368 (1.35 4.08 1.07) 134 — S — 371 (2.40 3.68 1.47) 134 — S — 372 (0.81 2.67 2.49)
134 — S — 395 (1.43 3.38 1.77) 134 — S — 396 (0.85 2.82 2.33) 134 — S — 440 (1.11 3.29 1.86) 134 — S — 441 (1.05 3.22 1.94)
134 — S — 447 (1.06 3.40 1.75) 134 — S — 451 (1.14 3.98 1.17) 134 — S — 452 (1.19 3.64 1.51) 134 — S — 460 (0.92 3.72 1.44)
134 — S — 463 (1.07 4.09 1.07) 134 — S — 471 (1.22 2.95 2.20) 134 — S — 473 (1.27 3.56 1.59) 134 — S — 474 (1.12 3.45 1.70)
135 — S — 46 (1.38 2.46 2.44) 135 — S — 57 (1.05 3.48 1.42) 135 — S — 70 (0.85 3.15 1.75) 135 — S — 107 (0.89 2.43 2.48)
135 — S — 111 (0.88 1.71 3.19) 135 — S — 125 (1.29 3.93 0.97) 135 — S — 133 (0.89 2.72 2.19) 135 — S — 150 (1.71 2.59 2.31)
135 — S — 151 (1.62 2.85 2.06) 135 — S — 152 (2.26 3.15 1.76) 135 — S — 153 (1.64 2.69 2.21) 135 — S — 154 (1.18 1.82 3.09)
135 — S — 166 (0.90 1.65 3.26) 135 — S — 170 (0.97 1.06 3.85) 135 — S — 184 (1.46 2.18 2.72) 135 — S — 188 (1.04 1.60 3.31)
135 — S — 192 (1.07 2.70 2.20) 135 — S — 194 (0.84 1.31 3.60) 135 — S — 195 (0.89 2.03 2.88) 135 — S — 197 (1.03 1.09 3.81)
135 — S — 215 (0.87 3.27 1.63) 135 — S — 231 (1.11 2.82 2.09) 135 — S — 243 (1.06 1.45 3.46) 135 — S — 255 (1.03 2.79 2.11)
135 — S — 259 (0.88 3.61 1.30) 135 — S — 271 (1.29 2.88 2.02) 135 — S — 291 (1.37 2.73 2.18) 135 — S — 320 (0.97 3.21 1.70)
135 — S — 324 (0.94 3.70 1.20) 135 — S — 342 (2.11 2.75 2.16) 135 — S — 343 (2.64 3.24 1.67) 135 — S — 364 (0.82 3.37 1.54)
135 — S — 371 (1.80 2.84 2.07) 135 — S — 395 (0.83 2.54 2.37) 135 — S — 429 (2.20 3.94 0.97) 135 — S — 472 (1.20 3.52 1.39)
136 — S — 46 (1.17 1.86 2.65) 136 — S — 57 (0.84 2.88 1.63) 136 — S — 125 (1.08 3.33 1.18) 136 — S — 150 (1.50 1.99 2.52)
136 — S — 151 (1.41 2.25 2.26) 136 — S — 152 (2.06 2.54 1.96) 136 — S — 153 (1.44 2.09 2.42) 136 — S — 154 (0.97 1.22 3.29)
136 — S — 184 (1.25 1.58 2.93) 136 — S — 188 (0.83 0.99 3.52) 136 — S — 192 (0.86 2.10 2.41) 136 — S — 231 (0.90 2.21 2.30)
136 — S — 243 (0.86 0.84 3.66) 136 — S — 250 (0.85 3.45 1.05) 136 — S — 255 (0.82 2.19 2.32) 136 — S — 271 (1.08 2.28 2.23)
136 — S — 291 (1.16 2.12 2.38) 136 — S — 342 (1.91 2.14 2.36) 136 — S — 343 (2.44 2.64 1.87) 136 — S — 371 (1.59 2.23 2.28)

136 — S — 429 (2.00 3.33 1.17) 136 — S — 472 (0.99 2.91 1.60) 137 — S — 20 (1.49 1.11 1.51) 137 — S — 27 (1.40 1.28 1.34)
137 — S — 28 (1.47 1.55 1.07) 137 — S — 29 (1.23 1.27 1.35) 137 — S — 40 (1.05 1.27 1.35) 137 — S — 46 (2.64 1.44 1.18)
137 — S — 61 (1.38 1.26 1.36) 137 — S — 62 (1.26 1.45 1.17) 137 — S — 65 (1.39 1.05 1.57) 137 — S — 68 (1.10 1.01 1.61)
137 — S — 79 (1.37 1.43 1.19) 137 — S — 80 (1.32 1.38 1.24) 137 — S — 81 (1.40 1.51 1.11) 137 — S — 82 (1.13 1.69 0.93)
137 — S — 85 (1.89 1.24 1.38) 137 — S — 86 (1.10 1.61 1.01) 137 — S — 90 (1.77 1.71 0.91) 137 — S — 101 (1.52 1.57 1.05)
137 — S — 107 (2.15 1.40 1.22) 137 — S — 110 (1.44 1.57 1.05) 137 — S — 112 (1.33 1.06 1.56) 137 — S — 115 (1.81 1.54 1.08)
137 — S — 118 (1.42 0.96 1.66) 137 — S — 119 (1.39 1.18 1.44) 137 — S — 123 (1.03 1.30 1.32) 137 — S — 132 (1.36 0.88 1.74)
137 — S — 133 (2.15 1.69 0.93) 137 — S — 144 (1.48 1.60 1.02) 137 — S — 147 (0.89 1.18 1.44) 137 — S — 150 (2.97 1.56 1.06)
137 — S — 153 (2.90 1.66 0.96) 137 — S — 177 (1.98 1.34 1.28) 137 — S — 183 (1.63 1.68 0.94) 137 — S — 184 (2.72 1.16 1.46)
137 — S — 192 (2.32 1.68 0.94) 137 — S — 193 (1.24 0.84 1.78) 137 — S — 195 (2.15 1.00 1.62) 137 — S — 198 (1.86 1.06 1.56)
137 — S — 205 (1.38 1.12 1.50) 137 — S — 213 (1.83 1.02 1.60) 137 — S — 217 (1.25 1.05 1.57) 137 — S — 218 (1.22 1.23 1.39)
137 — S — 233 (1.75 1.21 1.41) 137 — S — 234 (1.57 1.30 1.32) 137 — S — 237 (1.58 1.59 1.03) 137 — S — 238 (0.88 1.45 1.17)
137 — S — 244 (1.64 1.21 1.41) 137 — S — 245 (1.56 0.98 1.64) 137 — S — 246 (1.89 1.55 1.07) 137 — S — 254 (1.39 0.90 1.72)
137 — S — 265 (1.85 1.69 0.93) 137 — S — 266 (1.49 1.26 1.36) 137 — S — 267 (1.29 0.96 1.66) 137 — S — 275 (0.97 1.19 1.43)
137 — S — 277 (1.38 1.03 1.59) 137 — S — 279 (1.43 1.09 1.52) 137 — S — 285 (1.16 0.98 1.64) 137 — S — 286 (1.41 0.88 1.74)
137 — S — 287 (1.22 0.89 1.73) 137 — S — 288 (1.20 0.83 1.79) 137 — S — 290 (1.49 1.30 1.32) 137 — S — 291 (2.63 1.70 0.92)
137 — S — 292 (1.96 1.36 1.26) 137 — S — 293 (1.47 1.17 1.45) 137 — S — 294 (1.92 1.20 1.42) 137 — S — 295 (1.67 1.45 1.17)
137 — S — 296 (1.95 1.44 1.18) 137 — S — 298 (1.52 1.05 1.57) 137 — S — 304 (1.33 0.89 1.73) 137 — S — 305 (1.84 1.11 1.51)
137 — S — 313 (1.04 0.82 1.80) 137 — S — 316 (1.33 1.11 1.51) 137 — S — 327 (1.62 1.51 1.11) 137 — S — 332 (1.33 0.86 1.76)
137 — S — 341 (0.93 1.38 1.24) 137 — S — 358 (1.27 1.03 1.59) 137 — S — 367 (1.90 1.66 0.96) 137 — S — 370 (1.24 1.09 1.53)
137 — S — 373 (0.86 0.80 1.82) 137 — S — 374 (1.08 1.29 1.33) 137 — S — 382 (1.22 0.97 1.65) 137 — S — 395 (2.09 1.51 1.11)
137 — S — 396 (1.52 0.95 1.67) 137 — S — 430 (1.10 1.61 1.01) 137 — S — 434 (1.17 1.08 1.54) 137 — S — 435 (1.25 1.25 1.37)
137 — S — 440 (1.78 1.42 1.20) 137 — S — 441 (1.71 1.35 1.27) 137 — S — 447 (1.72 1.53 1.09) 137 — S — 449 (1.46 1.50 1.12)
137 — S — 450 (1.08 1.17 1.45) 137 — S — 455 (1.16 0.91 1.71) 137 — S — 457 (1.30 1.41 1.21) 137 — S — 458 (0.85 1.21 1.41)
137 — S — 459 (1.09 1.65 0.97) 137 — S — 461 (1.30 1.60 1.02) 137 — S — 462 (0.99 1.62 1.00) 137 — S — 467 (0.99 1.01 1.61)
137 — S — 468 (1.18 1.32 1.30) 137 — S — 471 (1.88 1.08 1.54) 137 — S — 473 (1.93 1.69 0.93) 137 — S — 474 (1.78 1.58 1.04)
138 — S — 36 (0.95 1.45 1.24) 138 — S — 37 (0.94 1.74 0.94) 138 — S — 43 (1.36 1.30 1.38) 138 — S — 46 (1.96 0.82 1.86)
138 — S — 70 (1.42 1.51 1.17) 138 — S — 89 (1.18 1.25 1.44) 138 — S — 90 (1.09 1.10 1.59) 138 — S — 101 (0.84 0.95 1.73)
138 — S — 108 (1.03 1.18 1.51) 138 — S — 109 (1.26 1.31 1.37) 138 — S — 113 (0.86 1.36 1.32) 138 — S — 115 (1.13 0.92 1.76)
138 — S — 133 (1.47 1.07 1.61) 138 — S — 144 (0.80 0.99 1.70) 138 — S — 150 (2.29 0.95 1.74) 138 — S — 151 (2.20 1.21 1.48)
138 — S — 152 (2.84 1.51 1.18) 138 — S — 153 (2.22 1.05 1.64) 138 — S — 183 (0.95 1.06 1.62) 138 — S — 192 (1.64 1.06 1.62)
138 — S — 207 (1.21 1.37 1.32) 138 — S — 215 (1.45 1.63 1.05) 138 — S — 231 (1.69 1.17 1.51) 138 — S — 237 (0.90 0.98 1.71)
138 — S — 246 (1.21 0.93 1.75) 138 — S — 248 (1.28 1.48 1.21) 138 — S — 255 (1.60 1.15 1.54) 138 — S — 265 (1.17 1.07 1.61)
138 — S — 268 (1.15 1.22 1.46) 138 — S — 269 (1.12 1.15 1.53) 138 — S — 271 (1.87 1.24 1.44) 138 — S — 291 (1.95 1.09 1.60)
138 — S — 295 (0.99 0.83 1.85) 138 — S — 296 (1.27 0.83 1.86) 138 — S — 306 (1.32 1.15 1.54) 138 — S — 307 (1.05 1.28 1.41)
138 — S — 320 (1.54 1.57 1.12) 138 — S — 327 (0.94 0.90 1.79) 138 — S — 329 (1.26 1.35 1.33) 138 — S — 342 (2.69 1.11 1.58)
138 — S — 343 (3.22 1.60 1.09) 138 — S — 364 (1.40 1.73 0.96) 138 — S — 367 (1.22 1.05 1.63) 138 — S — 368 (1.33 1.59 1.09)
138 — S — 371 (2.38 1.19 1.49) 138 — S — 395 (1.41 0.89 1.79) 138 — S — 440 (1.10 0.80 1.88) 138 — S — 447 (1.04 0.92 1.77)
138 — S — 451 (1.12 1.50 1.19) 138 — S — 452 (1.18 1.15 1.53) 138 — S — 460 (0.90 1.23 1.46) 138 — S — 463 (1.05 1.60 1.09)
138 — S — 473 (1.25 1.08 1.61) 138 — S — 474 (1.10 0.96 1.72) 140 — S — 36 (0.84 2.73 1.34) 140 — S — 37 (0.84 3.03 1.04)
140 — S — 43 (1.26 2.59 1.49) 140 — S — 46 (1.85 2.11 1.96) 140 — S — 57 (1.53 3.12 0.95) 140 — S — 70 (1.32 2.80 1.28)
140 — S — 85 (1.10 1.91 2.16) 140 — S — 89 (1.08 2.53 1.54) 140 — S — 90 (0.99 2.38 1.69) 140 — S — 105 (0.90 1.33 2.74)
140 — S — 107 (1.37 2.07 2.00) 140 — S — 108 (0.92 2.46 1.61) 140 — S — 109 (1.16 2.60 1.48) 140 — S — 111 (1.36 1.35 2.72)
140 — S — 115 (1.03 2.21 1.86) 140 — S — 133 (1.37 2.36 1.71) 140 — S — 150 (2.19 2.23 1.84) 140 — S — 151 (2.10 2.49 1.58)
140 — S — 152 (2.74 2.79 1.28) 140 — S — 153 (2.12 2.33 1.74) 140 — S — 154 (1.65 1.46 2.61) 140 — S — 166 (1.37 1.29 2.78)
140 — S — 167 (1.24 0.97 3.10) 140 — S — 171 (1.14 1.29 2.79) 140 — S — 177 (1.20 2.01 2.06) 140 — S — 183 (0.85 2.35 1.72)
140 — S — 184 (1.94 1.83 2.25) 140 — S — 187 (1.08 1.20 2.87) 140 — S — 188 (1.51 1.24 2.83) 140 — S — 189 (1.26 0.82 3.25)
140 — S — 192 (1.54 2.35 1.73) 140 — S — 194 (1.31 0.95 3.12) 140 — S — 195 (1.37 1.67 2.40) 140 — S — 198 (1.08 1.73 2.34)
140 — S — 207 (1.11 2.65 1.42) 140 — S — 213 (1.05 1.69 2.39) 140 — S — 215 (1.35 2.92 1.16) 140 — S — 231 (1.59 2.46 1.61)
140 — S — 233 (0.97 1.88 2.19) 140 — S — 236 (1.01 0.85 3.22) 140 — S — 237 (0.80 2.26 1.81) 140 — S — 243 (1.54 1.09 2.98)
140 — S — 244 (0.86 1.88 2.20) 140 — S — 246 (1.11 2.22 1.86) 140 — S — 248 (1.18 2.76 1.31) 140 — S — 255 (1.50 2.43 1.64)
140 — S — 265 (1.07 2.36 1.71) 140 — S — 268 (1.05 2.51 1.57) 140 — S — 269 (1.02 2.43 1.64) 140 — S — 270 (1.16 3.11 0.96)
140 — S — 271 (1.77 2.53 1.55) 140 — S — 272 (0.89 0.98 3.09) 140 — S — 291 (1.85 2.37 1.70) 140 — S — 292 (1.18 2.03 2.04)
140 — S — 294 (1.14 1.87 2.20) 140 — S — 295 (0.89 2.12 1.96) 140 — S — 296 (1.17 2.11 1.96) 140 — S — 305 (1.06 1.78 2.29)
140 — S — 306 (1.22 2.43 1.64) 140 — S — 307 (0.95 2.56 1.51) 140 — S — 318 (0.84 0.82 3.25) 140 — S — 320 (1.44 2.85 1.22)
140 — S — 327 (0.83 2.18 1.89) 140 — S — 329 (1.16 2.64 1.43) 140 — S — 342 (2.59 2.39 1.68) 140 — S — 343 (3.12 2.88 1.19)
140 — S — 357 (1.01 0.99 3.08) 140 — S — 364 (1.30 3.01 1.06) 140 — S — 367 (1.12 2.33 1.74) 140 — S — 368 (1.23 2.88 1.19)
140 — S — 371 (2.28 2.48 1.59) 140 — S — 395 (1.31 2.18 1.89) 140 — S — 440 (0.99 2.09 1.98) 140 — S — 441 (0.92 2.01 2.06)

140 — S — 447 (0.93 2.20 1.87) 140 — S — 451 (1.02 2.78 1.29) 140 — S — 452 (1.07 2.44 1.63) 140 — S — 463 (0.95 2.88 1.19)
140 — S — 471 (1.10 1.75 2.32) 140 — S — 472 (1.68 3.16 0.91) 140 — S — 473 (1.15 2.36 1.71) 140 — S — 474 (1.00 2.25 1.82)
141 — S — 150 (1.04 2.15 2.99) 141 — S — 151 (0.94 2.41 2.73) 141 — S — 152 (1.59 2.71 2.43) 141 — S — 153 (0.97 2.25 2.89)
141 — S — 342 (1.44 2.31 2.83) 141 — S — 343 (1.97 2.80 2.34) 141 — S — 371 (1.13 2.40 2.74) 141 — S — 429 (1.53 3.50 1.64)
144 — S — 57 (0.83 0.85 1.65) 144 — S — 125 (1.06 1.30 1.20) 144 — S — 250 (0.83 1.43 1.07) 144 — S — 429 (1.98 1.31 1.19)
144 — S — 472 (0.97 0.89 1.61) 147 — S — 57 (1.42 1.28 1.05) 147 — S — 70 (1.22 0.95 1.38) 147 — S — 152 (2.63 0.94 1.39)
147 — S — 165 (0.92 1.36 0.97) 147 — S — 207 (1.01 0.80 1.53) 147 — S — 215 (1.24 1.07 1.26) 147 — S — 248 (1.07 0.92 1.41)
147 — S — 259 (1.25 1.41 0.93) 147 — S — 270 (1.05 1.27 1.07) 147 — S — 320 (1.34 1.01 1.33) 147 — S — 343 (3.01 1.04 1.30)
147 — S — 364 (1.19 1.17 1.17) 147 — S — 368 (1.12 1.03 1.30) 147 — S — 451 (0.91 0.94 1.40) 147 — S — 463 (0.84 1.04 1.29)
147 — S — 472 (1.57 1.31 1.02) 148 — S — 43 (0.90 1.45 1.85) 148 — S — 46 (1.49 0.97 2.32) 148 — S — 57 (1.17 1.98 1.31)
148 — S — 70 (0.96 1.66 1.64) 148 — S — 107 (1.01 0.93 2.36) 148 — S — 109 (0.80 1.46 1.83) 148 — S — 133 (1.01 1.22 2.07)
148 — S — 150 (1.83 1.09 2.20) 148 — S — 151 (1.74 1.35 1.94) 148 — S — 152 (2.38 1.65 1.64) 148 — S — 153 (1.76 1.19 2.10)
148 — S — 177 (0.84 0.87 2.42) 148 — S — 192 (1.18 1.21 2.09) 148 — S — 215 (0.99 1.78 1.52) 148 — S — 231 (1.23 1.32 1.97)
148 — S — 247 (0.89 2.28 1.01) 148 — S — 248 (0.82 1.62 1.67) 148 — S — 255 (1.14 1.29 2.00) 148 — S — 259 (1.00 2.11 1.18)
148 — S — 271 (1.41 1.39 1.90) 148 — S — 291 (1.49 1.23 2.06) 148 — S — 292 (0.82 0.89 2.40) 148 — S — 296 (0.81 0.97 2.32)
148 — S — 306 (0.86 1.29 2.00) 148 — S — 320 (1.08 1.71 1.58) 148 — S — 324 (1.06 2.21 1.09) 148 — S — 329 (0.80 1.50 1.79)
148 — S — 342 (2.23 1.25 2.04) 148 — S — 343 (2.76 1.74 1.55) 148 — S — 364 (0.94 1.87 1.42) 148 — S — 368 (0.87 1.74 1.55)
148 — S — 371 (1.92 1.34 1.95) 148 — S — 395 (0.95 1.04 2.25) 148 — S — 472 (1.32 2.02 1.27) 149 — S — 20 (0.98 1.31 2.02)
149 — S — 27 (0.89 1.47 1.85) 149 — S — 28 (0.95 1.74 1.58) 149 — S — 36 (1.11 2.25 1.07) 149 — S — 43 (1.53 2.11 1.22)
149 — S — 46 (2.12 1.63 1.70) 149 — S — 56 (0.88 0.93 2.39) 149 — S — 61 (0.86 1.45 1.88) 149 — S — 65 (0.87 1.24 2.08)
149 — S — 70 (1.59 2.32 1.01) 149 — S — 79 (0.86 1.62 1.71) 149 — S — 80 (0.81 1.58 1.75) 149 — S — 81 (0.89 1.70 1.62)
149 — S — 83 (0.92 0.87 2.45) 149 — S — 85 (1.37 1.43 1.90) 149 — S — 89 (1.35 2.06 1.27) 149 — S — 90 (1.26 1.91 1.42)
149 — S — 101 (1.01 1.76 1.57) 149 — S — 105 (1.17 0.85 2.47) 149 — S — 107 (1.63 1.59 1.73) 149 — S — 108 (1.19 1.98 1.34)
149 — S — 109 (1.43 2.12 1.21) 149 — S — 110 (0.92 1.76 1.57) 149 — S — 111 (1.63 0.88 2.45) 149 — S — 112 (0.82 1.25 2.07)
149 — S — 113 (1.03 2.17 1.15) 149 — S — 115 (1.30 1.73 1.59) 149 — S — 118 (0.91 1.15 2.17) 149 — S — 119 (0.88 1.37 1.96)
149 — S — 131 (0.93 0.83 2.50) 149 — S — 132 (0.85 1.08 2.25) 149 — S — 133 (1.64 1.88 1.44) 149 — S — 144 (0.97 1.79 1.53)
149 — S — 150 (2.46 1.76 1.57) 149 — S — 151 (2.36 2.01 1.31) 149 — S — 152 (3.01 2.31 1.01) 149 — S — 153 (2.39 1.86 1.47)
149 — S — 154 (1.92 0.98 2.34) 149 — S — 166 (1.64 0.81 2.51) 149 — S — 171 (1.41 0.81 2.52) 149 — S — 177 (1.47 1.54 1.79)
149 — S — 183 (1.12 1.87 1.45) 149 — S — 184 (2.20 1.35 1.98) 149 — S — 192 (1.81 1.87 1.46) 149 — S — 195 (1.64 1.19 2.13)
149 — S — 198 (1.35 1.25 2.07) 149 — S — 205 (0.87 1.31 2.01) 149 — S — 206 (0.86 2.23 1.10) 149 — S — 207 (1.38 2.17 1.15)
149 — S — 213 (1.31 1.21 2.12) 149 — S — 231 (1.85 1.98 1.34) 149 — S — 233 (1.24 1.41 1.92) 149 — S — 234 (1.06 1.49 1.84)
149 — S — 237 (1.07 1.78 1.54) 149 — S — 244 (1.13 1.40 1.93) 149 — S — 245 (1.04 1.17 2.15) 149 — S — 246 (1.38 1.74 1.59)
149 — S — 248 (1.45 2.29 1.04) 149 — S — 249 (0.92 2.13 1.20) 149 — S — 251 (0.89 1.99 1.34) 149 — S — 254 (0.88 1.10 2.23)
149 — S — 255 (1.77 1.96 1.37) 149 — S — 258 (0.84 2.40 0.92) 149 — S — 260 (0.90 2.41 0.92) 149 — S — 265 (1.34 1.88 1.45)
149 — S — 266 (0.98 1.46 1.87) 149 — S — 268 (1.32 2.03 1.30) 149 — S — 269 (1.28 1.96 1.37) 149 — S — 271 (2.03 2.05 1.28)
149 — S — 277 (0.87 1.23 2.10) 149 — S — 279 (0.92 1.29 2.04) 149 — S — 286 (0.90 1.07 2.25) 149 — S — 289 (0.95 0.86 2.46)
149 — S — 290 (0.98 1.49 1.84) 149 — S — 291 (2.12 1.89 1.43) 149 — S — 292 (1.45 1.55 1.77) 149 — S — 293 (0.95 1.36 1.96)
149 — S — 294 (1.41 1.39 1.93) 149 — S — 295 (1.16 1.64 1.69) 149 — S — 296 (1.44 1.63 1.69) 149 — S — 298 (1.01 1.24 2.09)
149 — S — 304 (0.81 1.09 2.24) 149 — S — 305 (1.33 1.30 2.02) 149 — S — 306 (1.49 1.96 1.37) 149 — S — 307 (1.22 2.09 1.24)
149 — S — 316 (0.81 1.30 2.03) 149 — S — 320 (1.71 2.37 0.95) 149 — S — 327 (1.10 1.70 1.62) 149 — S — 329 (1.43 2.16 1.16)
149 — S — 331 (0.96 0.88 2.44) 149 — S — 332 (0.82 1.06 2.27) 149 — S — 336 (0.92 0.94 2.38) 149 — S — 342 (2.86 1.91 1.41)
149 — S — 343 (3.39 2.40 0.92) 149 — S — 367 (1.38 1.86 1.47) 149 — S — 368 (1.50 2.40 0.93) 149 — S — 371 (2.55 2.00 1.32)
149 — S — 372 (0.96 0.99 2.34) 149 — S — 395 (1.58 1.70 1.62) 149 — S — 396 (1.00 1.14 2.19) 149 — S — 397 (0.81 0.98 2.34)
149 — S — 437 (0.92 0.82 2.51) 149 — S — 440 (1.26 1.61 1.71) 149 — S — 441 (1.19 1.54 1.79) 149 — S — 447 (1.20 1.72 1.60)
149 — S — 449 (0.95 1.69 1.63) 149 — S — 451 (1.29 2.30 1.02) 149 — S — 452 (1.34 1.96 1.37) 149 — S — 460 (1.07 2.04 1.29)
149 — S — 463 (1.22 2.41 0.92) 149 — S — 471 (1.37 1.27 2.06) 149 — S — 473 (1.41 1.88 1.44) 149 — S — 474 (1.27 1.77 1.55)
154 — S — 152 (1.09 1.33 2.93) 154 — S — 342 (0.94 0.93 3.33) 154 — S — 343 (1.47 1.42 2.84) 154 — S — 429 (1.03 2.12 2.14)
155 — S — 46 (1.22 2.12 2.60) 155 — S — 57 (0.89 3.14 1.58) 155 — S — 125 (1.13 3.58 1.14) 155 — S — 150 (1.55 2.24 2.47)
155 — S — 151 (1.46 2.50 2.22) 155 — S — 152 (2.10 2.80 1.92) 155 — S — 153 (1.48 2.35 2.37) 155 — S — 154 (1.02 1.47 3.25)
155 — S — 184 (1.30 1.84 2.88) 155 — S — 188 (0.88 1.25 3.47) 155 — S — 192 (0.91 2.36 2.36) 155 — S — 231 (0.95 2.47 2.25)
155 — S — 243 (0.90 1.10 3.62) 155 — S — 250 (0.90 3.71 1.01) 155 — S — 255 (0.87 2.45 2.27) 155 — S — 271 (1.13 2.54 2.18)
155 — S — 291 (1.21 2.38 2.34) 155 — S — 320 (0.81 2.86 1.86) 155 — S — 342 (1.95 2.40 2.32) 155 — S — 343 (2.48 2.89 1.83)
155 — S — 371 (1.64 2.49 2.23) 155 — S — 429 (2.04 3.59 1.13) 155 — S — 472 (1.04 3.17 1.55) 156 — S — 36 (0.94 3.39 1.25)
156 — S — 37 (0.93 3.69 0.95) 156 — S — 43 (1.35 3.24 1.39) 156 — S — 46 (1.95 2.76 1.87) 156 — S — 70 (1.42 3.45 1.18)
156 — S — 85 (1.20 2.56 2.07) 156 — S — 89 (1.17 3.19 1.44) 156 — S — 90 (1.08 3.04 1.59) 156 — S — 101 (0.83 2.89 1.74)
156 — S — 105 (1.00 1.99 2.65) 156 — S — 107 (1.46 2.73 1.91) 156 — S — 108 (1.02 3.12 1.52) 156 — S — 109 (1.25 3.25 1.38)
156 — S — 111 (1.45 2.01 2.62) 156 — S — 113 (0.85 3.31 1.33) 156 — S — 115 (1.12 2.87 1.77) 156 — S — 133 (1.46 3.02 1.62)
156 — S — 150 (2.28 2.89 1.75) 156 — S — 151 (2.19 3.15 1.49) 156 — S — 152 (2.83 3.45 1.19) 156 — S — 153 (2.21 2.99 1.64)

156 — S — 154 (1.75 2.12 2.52) 156 — S — 158 (0.82 1.33 3.30) 156 — S — 160 (1.24 0.83 3.80) 156 — S — 161 (1.26 1.42 3.21)
156 — S — 166 (1.47 1.95 2.69) 156 — S — 167 (1.33 1.63 3.00) 156 — S — 168 (0.89 0.92 3.72) 156 — S — 170 (1.54 1.36 3.28)
156 — S — 171 (1.24 1.94 2.69) 156 — S — 177 (1.29 2.67 1.97) 156 — S — 183 (0.94 3.01 1.63) 156 — S — 184 (2.03 2.48 2.15)
156 — S — 187 (1.17 1.85 2.78) 156 — S — 188 (1.61 1.89 2.74) 156 — S — 189 (1.35 1.48 3.15) 156 — S — 192 (1.64 3.00 1.63)
156 — S — 194 (1.41 1.61 3.03) 156 — S — 195 (1.46 2.33 2.31) 156 — S — 197 (1.60 1.39 3.24) 156 — S — 198 (1.17 2.39 2.25)
156 — S — 207 (1.21 3.31 1.33) 156 — S — 213 (1.14 2.34 2.29) 156 — S — 215 (1.44 3.57 1.06) 156 — S — 231 (1.68 3.12 1.52)
156 — S — 233 (1.06 2.54 2.10) 156 — S — 234 (0.88 2.62 2.01) 156 — S — 236 (1.11 1.51 3.13) 156 — S — 237 (0.90 2.92 1.72)
156 — S — 243 (1.63 1.75 2.89) 156 — S — 244 (0.95 2.53 2.10) 156 — S — 245 (0.87 2.31 2.33) 156 — S — 246 (1.20 2.87 1.76)
156 — S — 248 (1.27 3.42 1.22) 156 — S — 255 (1.59 3.09 1.54) 156 — S — 264 (0.98 0.95 3.68) 156 — S — 265 (1.16 3.01 1.62)
156 — S — 266 (0.80 2.59 2.04) 156 — S — 268 (1.14 3.16 1.47) 156 — S — 269 (1.11 3.09 1.54) 156 — S — 271 (1.86 3.18 1.45)
156 — S — 272 (0.98 1.64 3.00) 156 — S — 290 (0.80 2.62 2.01) 156 — S — 291 (1.94 3.03 1.61) 156 — S — 292 (1.27 2.69 1.95)
156 — S — 294 (1.23 2.53 2.11) 156 — S — 295 (0.99 2.77 1.86) 156 — S — 296 (1.26 2.77 1.87) 156 — S — 298 (0.83 2.37 2.26)
156 — S — 300 (0.84 1.77 2.86) 156 — S — 301 (0.89 1.48 3.15) 156 — S — 302 (1.01 1.33 3.30) 156 — S — 305 (1.15 2.44 2.20)
156 — S — 306 (1.31 3.09 1.55) 156 — S — 307 (1.04 3.22 1.42) 156 — S — 318 (0.93 1.48 3.16) 156 — S — 320 (1.53 3.51 1.13)
156 — S — 327 (0.93 2.84 1.80) 156 — S — 329 (1.25 3.30 1.34) 156 — S — 338 (1.04 0.85 3.79) 156 — S — 342 (2.68 3.05 1.59)
156 — S — 343 (3.21 3.54 1.10) 156 — S — 357 (1.10 1.64 2.99) 156 — S — 364 (1.39 3.67 0.97) 156 — S — 367 (1.21 2.99 1.64)
156 — S — 368 (1.32 3.53 1.10) 156 — S — 371 (2.37 3.14 1.50) 156 — S — 395 (1.40 2.84 1.80) 156 — S — 396 (0.83 2.27 2.36)
156 — S — 440 (1.09 2.74 1.89) 156 — S — 441 (1.02 2.67 1.96) 156 — S — 447 (1.03 2.86 1.78) 156 — S — 451 (1.11 3.44 1.20)
156 — S — 452 (1.17 3.09 1.54) 156 — S — 460 (0.89 3.17 1.46) 156 — S — 463 (1.04 3.54 1.09) 156 — S — 471 (1.19 2.40 2.23)
156 — S — 473 (1.24 3.02 1.62) 156 — S — 474 (1.09 2.91 1.73) 157 — S — 46 (1.19 2.36 2.63) 157 — S — 57 (0.86 3.37 1.61)
157 — S — 125 (1.10 3.82 1.16) 157 — S — 150 (1.52 2.48 2.50) 157 — S — 151 (1.43 2.74 2.24) 157 — S — 152 (2.08 3.04 1.94)
157 — S — 153 (1.46 2.58 2.40) 157 — S — 154 (0.99 1.71 3.27) 157 — S — 184 (1.27 2.08 2.91) 157 — S — 188 (0.85 1.49 3.50)
157 — S — 192 (0.88 2.60 2.39) 157 — S — 197 (0.85 0.99 4.00) 157 — S — 231 (0.92 2.71 2.27) 157 — S — 243 (0.88 1.34 3.64)
157 — S — 250 (0.87 3.95 1.03) 157 — S — 255 (0.84 2.68 2.30) 157 — S — 271 (1.10 2.78 2.21) 157 — S — 291 (1.18 2.62 2.36)
157 — S — 342 (1.93 2.64 2.34) 157 — S — 343 (2.46 3.13 1.85) 157 — S — 371 (1.62 2.73 2.25) 157 — S — 429 (2.02 3.83 1.15)
157 — S — 472 (1.01 3.41 1.57) 158 — S — 46 (1.13 1.43 2.69) 158 — S — 57 (0.80 2.45 1.67) 158 — S — 125 (1.04 2.90 1.22)
158 — S — 150 (1.46 1.56 2.56) 158 — S — 151 (1.37 1.82 2.30) 158 — S — 152 (2.01 2.12 2.01) 158 — S — 153 (1.39 1.66 2.46)
158 — S — 184 (1.21 1.15 2.97) 158 — S — 192 (0.82 1.67 2.45) 158 — S — 231 (0.86 1.78 2.34) 158 — S — 250 (0.81 3.02 1.10)
158 — S — 271 (1.04 1.85 2.27) 158 — S — 291 (1.12 1.70 2.42) 158 — S — 342 (1.87 1.72 2.41) 158 — S — 343 (2.39 2.21 1.91)
158 — S — 371 (1.55 1.80 2.32) 158 — S — 429 (1.95 2.91 1.21) 158 — S — 472 (0.95 2.48 1.64) 159 — S — 43 (0.80 3.33 1.94)
159 — S — 46 (1.40 2.85 2.42) 159 — S — 57 (1.07 3.87 1.40) 159 — S — 70 (0.87 3.54 1.73) 159 — S — 107 (0.91 2.81 2.46)
159 — S — 111 (0.90 2.10 3.17) 159 — S — 125 (1.31 4.32 0.95) 159 — S — 133 (0.91 3.10 2.17) 159 — S — 150 (1.73 2.98 2.29)
159 — S — 151 (1.64 3.23 2.03) 159 — S — 152 (2.28 3.53 1.74) 159 — S — 153 (1.66 3.08 2.19) 159 — S — 154 (1.20 2.20 3.06)
159 — S — 166 (0.92 2.03 3.24) 159 — S — 170 (0.99 1.44 3.83) 159 — S — 184 (1.48 2.57 2.70) 159 — S — 188 (1.06 1.98 3.29)
159 — S — 189 (0.80 1.57 3.70) 159 — S — 192 (1.09 3.09 2.18) 159 — S — 194 (0.86 1.69 3.58) 159 — S — 195 (0.91 2.41 2.86)
159 — S — 197 (1.06 1.48 3.79) 159 — S — 215 (0.89 3.66 1.61) 159 — S — 231 (1.13 3.20 2.07) 159 — S — 243 (1.09 1.83 3.43)
159 — S — 255 (1.05 3.18 2.09) 159 — S — 259 (0.90 3.99 1.27) 159 — S — 271 (1.31 3.27 2.00) 159 — S — 291 (1.39 3.11 2.15)
159 — S — 320 (0.99 3.59 1.67) 159 — S — 324 (0.96 4.09 1.18) 159 — S — 342 (2.13 3.13 2.14) 159 — S — 343 (2.66 3.62 1.64)
159 — S — 364 (0.84 3.75 1.51) 159 — S — 371 (1.82 3.22 2.05) 159 — S — 395 (0.85 2.92 2.35) 159 — S — 429 (2.22 4.32 0.94)
159 — S — 472 (1.22 3.90 1.37) 160 — S — 150 (1.04 2.06 2.99) 160 — S — 151 (0.95 2.32 2.73) 160 — S — 152 (1.59 2.62 2.43)
160 — S — 153 (0.97 2.16 2.89) 160 — S — 342 (1.44 2.22 2.83) 160 — S — 343 (1.97 2.71 2.34) 160 — S — 371 (1.13 2.30 2.74)
160 — S — 429 (1.53 3.41 1.64) 161 — S — 150 (1.02 1.47 3.00) 161 — S — 151 (0.93 1.73 2.74) 161 — S — 152 (1.58 2.03 2.44)
161 — S — 153 (0.96 1.57 2.90) 161 — S — 342 (1.43 1.63 2.84) 161 — S — 343 (1.96 2.12 2.35) 161 — S — 371 (1.11 1.72 2.75)
161 — S — 429 (1.52 2.82 1.65) 166 — S — 150 (0.81 0.94 3.21) 166 — S — 152 (1.37 1.50 2.65) 166 — S — 342 (1.22 1.10 3.05)
166 — S — 343 (1.75 1.59 2.56) 166 — S — 371 (0.90 1.19 2.97) 166 — S — 429 (1.31 2.29 1.86) 167 — S — 150 (0.95 1.26 3.07)
167 — S — 151 (0.86 1.52 2.82) 167 — S — 152 (1.50 1.82 2.52) 167 — S — 153 (0.88 1.36 2.97) 167 — S — 342 (1.35 1.42 2.92)
167 — S — 343 (1.88 1.91 2.42) 167 — S — 371 (1.04 1.50 2.83) 167 — S — 429 (1.44 2.61 1.73) 168 — S — 46 (1.06 1.85 2.76)
168 — S — 125 (0.97 3.31 1.30) 168 — S — 150 (1.39 1.97 2.64) 168 — S — 151 (1.30 2.23 2.38) 168 — S — 152 (1.94 2.53 2.08)
168 — S — 153 (1.32 2.07 2.54) 168 — S — 154 (0.85 1.20 3.41) 168 — S — 184 (1.14 1.57 3.04) 168 — S — 271 (0.97 2.27 2.34)
168 — S — 291 (1.05 2.11 2.50) 168 — S — 342 (1.79 2.13 2.48) 168 — S — 343 (2.32 2.62 1.99) 168 — S — 371 (1.48 2.22 2.39)
168 — S — 429 (1.88 3.32 1.29) 168 — S — 472 (0.88 2.90 1.71) 170 — S — 152 (1.30 2.09 2.72) 170 — S — 342 (1.15 1.69 3.12)
170 — S — 343 (1.68 2.18 2.63) 170 — S — 371 (0.83 1.78 3.04) 170 — S — 429 (1.24 2.88 1.93) 171 — S — 150 (1.04 0.95 2.98)
171 — S — 151 (0.95 1.21 2.72) 171 — S — 152 (1.60 1.51 2.42) 171 — S — 153 (0.98 1.05 2.88) 171 — S — 342 (1.45 1.10 2.82)
171 — S — 343 (1.98 1.60 2.33) 171 — S — 371 (1.13 1.19 2.74) 171 — S — 429 (1.54 2.30 1.63) 175 — S — 43 (0.88 1.66 1.86)
175 — S — 46 (1.48 1.18 2.34) 175 — S — 57 (1.15 2.20 1.32) 175 — S — 70 (0.95 1.87 1.65) 175 — S — 107 (0.99 1.14 2.38)
175 — S — 133 (0.99 1.43 2.09) 175 — S — 150 (1.81 1.31 2.21) 175 — S — 151 (1.72 1.57 1.95) 175 — S — 152 (2.36 1.87 1.66)
175 — S — 153 (1.74 1.41 2.11) 175 — S — 177 (0.83 1.09 2.43) 175 — S — 184 (1.56 0.90 2.62) 175 — S — 192 (1.17 1.42 2.10)
175 — S — 215 (0.97 1.99 1.53) 175 — S — 231 (1.21 1.53 1.99) 175 — S — 247 (0.87 2.50 1.02) 175 — S — 248 (0.80 1.84 1.68)

175 — S — 255 (1.13 1.51 2.01) 175 — S — 259 (0.98 2.33 1.19) 175 — S — 271 (1.39 1.60 1.92) 175 — S — 291 (1.47 1.45 2.07)
175 — S — 292 (0.81 1.11 2.42) 175 — S — 306 (0.85 1.51 2.01) 175 — S — 320 (1.07 1.93 1.59) 175 — S — 324 (1.04 2.42 1.10)
175 — S — 342 (2.22 1.47 2.06) 175 — S — 343 (2.74 1.96 1.56) 175 — S — 364 (0.92 2.09 1.43) 175 — S — 368 (0.85 1.95 1.57)
175 — S — 371 (1.90 1.55 1.97) 175 — S — 395 (0.93 1.25 2.27) 175 — S — 472 (1.30 2.23 1.29) 176 — S — 43 (0.94 1.91 1.81)
176 — S — 46 (1.54 1.43 2.28) 176 — S — 57 (1.21 2.45 1.27) 176 — S — 70 (1.00 2.12 1.60) 176 — S — 107 (1.05 1.39 2.32)
176 — S — 109 (0.84 1.92 1.79) 176 — S — 133 (1.05 1.68 2.03) 176 — S — 150 (1.87 1.55 2.16) 176 — S — 151 (1.78 1.81 1.90)
176 — S — 152 (2.42 2.11 1.60) 176 — S — 153 (1.80 1.66 2.06) 176 — S — 177 (0.88 1.33 2.38) 176 — S — 184 (1.62 1.15 2.57)
176 — S — 192 (1.22 1.67 2.04) 176 — S — 195 (1.05 0.99 2.72) 176 — S — 215 (1.03 2.24 1.47) 176 — S — 231 (1.27 1.78 1.93)
176 — S — 247 (0.93 2.74 0.97) 176 — S — 248 (0.86 2.08 1.63) 176 — S — 255 (1.18 1.76 1.96) 176 — S — 259 (1.04 2.57 1.14)
176 — S — 270 (0.84 2.43 1.28) 176 — S — 271 (1.45 1.85 1.86) 176 — S — 291 (1.53 1.69 2.02) 176 — S — 292 (0.86 1.35 2.36)
176 — S — 294 (0.82 1.19 2.52) 176 — S — 296 (0.85 1.43 2.28) 176 — S — 306 (0.90 1.75 1.96) 176 — S — 320 (1.12 2.17 1.54)
176 — S — 324 (1.10 2.67 1.05) 176 — S — 329 (0.84 1.96 1.75) 176 — S — 342 (2.27 1.71 2.00) 176 — S — 343 (2.80 2.20 1.51)
176 — S — 364 (0.98 2.33 1.38) 176 — S — 368 (0.91 2.20 1.51) 176 — S — 371 (1.96 1.80 1.91) 176 — S — 395 (0.99 1.50 2.21)
176 — S — 472 (1.36 2.48 1.23) 176 — S — 473 (0.83 1.68 2.03) 177 — S — 343 (1.92 0.87 2.39) 177 — S — 429 (1.48 1.57 1.69)
182 — S — 43 (0.92 1.73 1.83) 182 — S — 46 (1.51 1.25 2.31) 182 — S — 57 (1.19 2.27 1.29) 182 — S — 70 (0.98 1.94 1.62)
182 — S — 107 (1.02 1.22 2.34) 182 — S — 109 (0.82 1.74 1.82) 182 — S — 133 (1.03 1.51 2.05) 182 — S — 150 (1.85 1.38 2.18)
182 — S — 151 (1.75 1.64 1.92) 182 — S — 152 (2.40 1.94 1.62) 182 — S — 153 (1.78 1.48 2.08) 182 — S — 177 (0.86 1.16 2.40)
182 — S — 184 (1.60 0.97 2.59) 182 — S — 192 (1.20 1.49 2.07) 182 — S — 195 (1.03 0.82 2.74) 182 — S — 215 (1.00 2.06 1.50)
182 — S — 231 (1.25 1.60 1.95) 182 — S — 247 (0.90 2.57 0.99) 182 — S — 248 (0.84 1.91 1.65) 182 — S — 255 (1.16 1.58 1.98)
182 — S — 259 (1.02 2.40 1.16) 182 — S — 270 (0.82 2.26 1.30) 182 — S — 271 (1.42 1.67 1.89) 182 — S — 291 (1.51 1.52 2.04)
182 — S — 292 (0.84 1.18 2.38) 182 — S — 296 (0.83 1.26 2.30) 182 — S — 306 (0.88 1.58 1.98) 182 — S — 320 (1.10 2.00 1.56)
182 — S — 324 (1.08 2.49 1.07) 182 — S — 329 (0.82 1.79 1.77) 182 — S — 342 (2.25 1.54 2.02) 182 — S — 343 (2.78 2.03 1.53)
182 — S — 364 (0.96 2.16 1.40) 182 — S — 368 (0.89 2.02 1.53) 182 — S — 371 (1.94 1.63 1.93) 182 — S — 395 (0.97 1.33 2.23)
182 — S — 472 (1.33 2.30 1.25) 182 — S — 473 (0.81 1.51 2.05) 183 — S — 125 (0.92 1.22 1.35) 183 — S — 429 (1.83 1.23 1.34)
183 — S — 472 (0.83 0.81 1.76) 184 — S — 152 (0.80 0.97 3.22) 184 — S — 343 (1.18 1.06 3.13) 187 — S — 150 (1.11 1.04 2.92)
187 — S — 151 (1.01 1.29 2.66) 187 — S — 152 (1.66 1.59 2.36) 187 — S — 153 (1.04 1.14 2.82) 187 — S — 342 (1.51 1.19 2.76)
187 — S — 343 (2.04 1.68 2.27) 187 — S — 371 (1.20 1.28 2.67) 187 — S — 429 (1.60 2.38 1.57) 188 — S — 152 (1.23 1.55 2.79)
188 — S — 342 (1.08 1.15 3.19) 188 — S — 343 (1.61 1.64 2.70) 188 — S — 429 (1.17 2.34 2.00) 189 — S — 150 (0.93 1.41 3.10)
189 — S — 151 (0.84 1.67 2.84) 189 — S — 152 (1.48 1.97 2.54) 189 — S — 153 (0.86 1.51 3.00) 189 — S — 342 (1.33 1.57 2.94)
189 — S — 343 (1.86 2.06 2.45) 189 — S — 371 (1.02 1.65 2.85) 189 — S — 429 (1.42 2.76 1.75) 192 — S — 429 (1.14 1.24 2.03)
193 — S — 57 (1.07 1.62 1.41) 193 — S — 70 (0.86 1.29 1.74) 193 — S — 125 (1.31 2.06 0.96) 193 — S — 133 (0.91 0.85 2.17)
193 — S — 151 (1.64 0.98 2.04) 193 — S — 152 (2.28 1.28 1.74) 193 — S — 153 (1.66 0.83 2.20) 193 — S — 192 (1.08 0.84 2.19)
193 — S — 215 (0.89 1.41 1.62) 193 — S — 231 (1.13 0.95 2.07) 193 — S — 255 (1.04 0.93 2.10) 193 — S — 259 (0.90 1.74 1.28)
193 — S — 271 (1.31 1.02 2.01) 193 — S — 291 (1.39 0.86 2.16) 193 — S — 320 (0.98 1.34 1.68) 193 — S — 324 (0.96 1.84 1.19)
193 — S — 342 (2.13 0.88 2.14) 193 — S — 343 (2.66 1.37 1.65) 193 — S — 364 (0.84 1.50 1.52) 193 — S — 371 (1.82 0.97 2.05)
193 — S — 429 (2.22 2.07 0.95) 193 — S — 472 (1.21 1.65 1.37) 194 — S — 150 (0.87 1.28 3.15) 194 — S — 152 (1.43 1.84 2.59)
194 — S — 153 (0.81 1.38 3.05) 194 — S — 342 (1.28 1.44 2.99) 194 — S — 343 (1.81 1.93 2.50) 194 — S — 371 (0.96 1.53 2.90)
194 — S — 429 (1.37 2.63 1.80) 195 — S — 152 (1.37 1.12 2.65) 195 — S — 343 (1.75 1.21 2.56) 195 — S — 371 (0.91 0.81 2.96)
195 — S — 429 (1.31 1.91 1.86) 196 — S — 43 (0.85 2.53 1.90) 196 — S — 46 (1.44 2.05 2.38) 196 — S — 57 (1.12 3.07 1.36)
196 — S — 70 (0.91 2.74 1.69) 196 — S — 107 (0.95 2.01 2.41) 196 — S — 111 (0.95 1.30 3.13) 196 — S — 125 (1.36 3.52 0.91)
196 — S — 133 (0.96 2.31 2.12) 196 — S — 150 (1.78 2.18 2.25) 196 — S — 151 (1.68 2.44 1.99) 196 — S — 152 (2.33 2.74 1.69)
196 — S — 153 (1.71 2.28 2.15) 196 — S — 154 (1.24 1.41 3.02) 196 — S — 166 (0.96 1.23 3.19) 196 — S — 167 (0.82 0.92 3.51)
196 — S — 184 (1.53 1.77 2.66) 196 — S — 188 (1.10 1.18 3.24) 196 — S — 192 (1.13 2.29 2.14) 196 — S — 194 (0.90 0.90 3.53)
196 — S — 195 (0.96 1.62 2.81) 196 — S — 215 (0.93 2.86 1.57) 196 — S — 231 (1.18 2.40 2.02) 196 — S — 243 (1.13 1.04 3.39)
196 — S — 247 (0.83 3.37 1.06) 196 — S — 255 (1.09 2.38 2.05) 196 — S — 259 (0.95 3.20 1.23) 196 — S — 271 (1.35 2.47 1.96)
196 — S — 291 (1.44 2.32 2.11) 196 — S — 306 (0.81 2.38 2.05) 196 — S — 320 (1.03 2.80 1.63) 196 — S — 324 (1.00 3.29 1.14)
196 — S — 342 (2.18 2.34 2.09) 196 — S — 343 (2.71 2.83 1.60) 196 — S — 364 (0.89 2.96 1.47) 196 — S — 368 (0.82 2.82 1.61)
196 — S — 371 (1.87 2.42 2.00) 196 — S — 395 (0.90 2.12 2.30) 196 — S — 429 (2.27 3.53 0.90) 196 — S — 472 (1.26 3.10 1.32)
197 — S — 152 (1.23 2.06 2.79) 197 — S — 342 (1.08 1.66 3.19) 197 — S — 343 (1.61 2.15 2.70) 197 — S — 429 (1.17 2.85 2.00)
198 — S — 152 (1.66 1.06 2.36) 198 — S — 343 (2.04 1.15 2.27) 198 — S — 429 (1.60 1.85 1.57) 199 — S — 20 (1.40 1.17 1.60)
199 — S — 27 (1.31 1.34 1.43) 199 — S — 28 (1.38 1.61 1.16) 199 — S — 29 (1.14 1.33 1.44) 199 — S — 40 (0.96 1.33 1.44)
199 — S — 46 (2.55 1.49 1.27) 199 — S — 61 (1.29 1.31 1.45) 199 — S — 62 (1.17 1.51 1.25) 199 — S — 65 (1.30 1.11 1.66)
199 — S — 68 (1.01 1.07 1.70) 199 — S — 79 (1.28 1.48 1.28) 199 — S — 80 (1.24 1.44 1.32) 199 — S — 81 (1.31 1.56 1.20)
199 — S — 82 (1.04 1.75 1.01) 199 — S — 85 (1.80 1.29 1.47) 199 — S — 86 (1.01 1.66 1.10) 199 — S — 90 (1.68 1.77 0.99)
199 — S — 101 (1.43 1.62 1.14) 199 — S — 107 (2.06 1.46 1.31) 199 — S — 108 (1.62 1.85 0.92) 199 — S — 110 (1.35 1.62 1.14)
199 — S — 112 (1.24 1.12 1.65) 199 — S — 115 (1.72 1.60 1.17) 199 — S — 118 (1.33 1.02 1.75) 199 — S — 119 (1.31 1.23 1.53)
199 — S — 123 (0.95 1.36 1.40) 199 — S — 132 (1.27 0.94 1.83) 199 — S — 133 (2.06 1.75 1.02) 199 — S — 144 (1.39 1.66 1.11)
199 — S — 150 (2.88 1.62 1.15) 199 — S — 153 (2.81 1.72 1.04) 199 — S — 154 (2.35 0.85 1.92) 199 — S — 177 (1.89 1.40 1.37)

199 — S — 183 (1.54 1.74 1.03) 199 — S — 184 (2.63 1.21 1.55) 199 — S — 192 (2.24 1.73 1.03) 199 — S — 193 (1.15 0.90 1.87)
199 — S — 195 (2.06 1.06 1.71) 199 — S — 198 (1.77 1.12 1.65) 199 — S — 205 (1.29 1.18 1.59) 199 — S — 213 (1.74 1.07 1.69)
199 — S — 217 (1.16 1.11 1.66) 199 — S — 218 (1.13 1.28 1.48) 199 — S — 219 (0.93 0.84 1.93) 199 — S — 231 (2.28 1.85 0.92)
199 — S — 233 (1.66 1.27 1.50) 199 — S — 234 (1.48 1.35 1.41) 199 — S — 237 (1.50 1.65 1.12) 199 — S — 244 (1.55 1.26 1.50)
199 — S — 245 (1.47 1.04 1.73) 199 — S — 246 (1.80 1.60 1.16) 199 — S — 251 (1.31 1.85 0.92) 199 — S — 254 (1.30 0.96 1.81)
199 — S — 255 (2.19 1.82 0.94) 199 — S — 265 (1.76 1.74 1.02) 199 — S — 266 (1.40 1.32 1.44) 199 — S — 267 (1.20 1.02 1.74)
199 — S — 269 (1.71 1.82 0.94) 199 — S — 274 (1.07 0.82 1.94) 199 — S — 275 (0.88 1.24 1.52) 199 — S — 277 (1.29 1.09 1.68)
199 — S — 279 (1.34 1.15 1.61) 199 — S — 280 (1.02 0.83 1.94) 199 — S — 285 (1.07 1.03 1.73) 199 — S — 286 (1.32 0.94 1.83)
199 — S — 287 (1.13 0.95 1.82) 199 — S — 288 (1.11 0.89 1.88) 199 — S — 290 (1.40 1.35 1.41) 199 — S — 291 (2.54 1.76 1.01)
199 — S — 292 (1.87 1.42 1.35) 199 — S — 293 (1.38 1.23 1.54) 199 — S — 294 (1.83 1.26 1.51) 199 — S — 295 (1.59 1.50 1.26)
199 — S — 296 (1.86 1.50 1.27) 199 — S — 298 (1.43 1.10 1.66) 199 — S — 304 (1.24 0.95 1.82) 199 — S — 305 (1.75 1.17 1.60)
199 — S — 306 (1.91 1.82 0.95) 199 — S — 311 (1.08 0.84 1.93) 199 — S — 313 (0.95 0.88 1.89) 199 — S — 316 (1.24 1.16 1.60)
199 — S — 327 (1.53 1.57 1.20) 199 — S — 332 (1.24 0.92 1.85) 199 — S — 336 (1.34 0.81 1.96) 199 — S — 341 (0.84 1.44 1.33)
199 — S — 342 (3.28 1.78 0.99) 199 — S — 358 (1.18 1.08 1.68) 199 — S — 367 (1.81 1.72 1.04) 199 — S — 370 (1.15 1.15 1.61)
199 — S — 372 (1.38 0.85 1.91) 199 — S — 374 (0.99 1.34 1.42) 199 — S — 379 (1.06 0.85 1.92) 199 — S — 382 (1.13 1.03 1.74)
199 — S — 391 (1.07 0.83 1.93) 199 — S — 395 (2.00 1.57 1.20) 199 — S — 396 (1.43 1.00 1.76) 199 — S — 397 (1.23 0.85 1.92)
199 — S — 430 (1.01 1.67 1.10) 199 — S — 434 (1.08 1.14 1.63) 199 — S — 435 (1.16 1.31 1.46) 199 — S — 440 (1.69 1.47 1.29)
199 — S — 441 (1.62 1.40 1.36) 199 — S — 447 (1.63 1.59 1.18) 199 — S — 449 (1.37 1.56 1.21) 199 — S — 450 (0.99 1.22 1.54)
199 — S — 452 (1.77 1.82 0.94) 199 — S — 455 (1.07 0.96 1.80) 199 — S — 457 (1.21 1.47 1.30) 199 — S — 459 (1.00 1.70 1.06)
199 — S — 461 (1.21 1.66 1.10) 199 — S — 462 (0.90 1.68 1.09) 199 — S — 467 (0.90 1.07 1.69) 199 — S — 468 (1.09 1.38 1.39)
199 — S — 469 (1.19 1.80 0.96) 199 — S — 471 (1.79 1.13 1.63) 199 — S — 473 (1.84 1.75 1.02) 199 — S — 474 (1.69 1.64 1.13)
200 — S — 20 (0.94 1.21 2.06) 200 — S — 27 (0.85 1.38 1.89) 200 — S — 28 (0.92 1.65 1.62) 200 — S — 36 (1.07 2.16 1.11)
200 — S — 43 (1.49 2.01 1.26) 200 — S — 46 (2.08 1.53 1.73) 200 — S — 56 (0.84 0.84 2.43) 200 — S — 61 (0.82 1.35 1.92)
200 — S — 65 (0.84 1.15 2.12) 200 — S — 70 (1.55 2.22 1.05) 200 — S — 79 (0.82 1.52 1.74) 200 — S — 81 (0.85 1.61 1.66)
200 — S — 85 (1.33 1.34 1.93) 200 — S — 89 (1.31 1.96 1.31) 200 — S — 90 (1.22 1.81 1.46) 200 — S — 101 (0.97 1.66 1.61)
200 — S — 107 (1.60 1.50 1.77) 200 — S — 108 (1.16 1.89 1.38) 200 — S — 109 (1.39 2.02 1.24) 200 — S — 110 (0.89 1.66 1.61)
200 — S — 113 (0.99 2.08 1.19) 200 — S — 115 (1.26 1.64 1.63) 200 — S — 118 (0.87 1.06 2.21) 200 — S — 119 (0.84 1.27 2.00)
200 — S — 132 (0.81 0.98 2.29) 200 — S — 133 (1.60 1.79 1.48) 200 — S — 144 (0.93 1.70 1.57) 200 — S — 145 (0.91 2.35 0.92)
200 — S — 150 (2.42 1.66 1.61) 200 — S — 151 (2.33 1.92 1.35) 200 — S — 152 (2.97 2.22 1.05) 200 — S — 153 (2.35 1.76 1.51)
200 — S — 154 (1.88 0.89 2.38) 200 — S — 177 (1.43 1.44 1.83) 200 — S — 183 (1.08 1.78 1.49) 200 — S — 184 (2.17 1.25 2.02)
200 — S — 192 (1.77 1.77 1.50) 200 — S — 195 (1.60 1.10 2.17) 200 — S — 198 (1.31 1.16 2.11) 200 — S — 205 (0.83 1.22 2.05)
200 — S — 206 (0.82 2.13 1.14) 200 — S — 207 (1.34 2.08 1.19) 200 — S — 213 (1.28 1.11 2.16) 200 — S — 215 (1.58 2.34 0.93)
200 — S — 231 (1.82 1.89 1.38) 200 — S — 233 (1.20 1.31 1.96) 200 — S — 234 (1.02 1.39 1.88) 200 — S — 237 (1.03 1.69 1.58)
200 — S — 244 (1.09 1.30 1.96) 200 — S — 245 (1.01 1.08 2.19) 200 — S — 246 (1.34 1.64 1.63) 200 — S — 248 (1.41 2.19 1.08)
200 — S — 249 (0.88 2.03 1.24) 200 — S — 251 (0.85 1.89 1.38) 200 — S — 254 (0.84 1.00 2.27) 200 — S — 255 (1.73 1.86 1.41)
200 — S — 260 (0.86 2.31 0.96) 200 — S — 265 (1.30 1.78 1.48) 200 — S — 266 (0.94 1.36 1.91) 200 — S — 268 (1.28 1.93 1.34)
200 — S — 269 (1.25 1.86 1.41) 200 — S — 271 (2.00 1.95 1.31) 200 — S — 277 (0.83 1.13 2.14) 200 — S — 279 (0.88 1.19 2.08)
200 — S — 286 (0.86 0.98 2.29) 200 — S — 290 (0.94 1.39 1.88) 200 — S — 291 (2.08 1.80 1.47) 200 — S — 292 (1.41 1.46 1.81)
200 — S — 293 (0.92 1.27 2.00) 200 — S — 294 (1.37 1.30 1.97) 200 — S — 295 (1.12 1.54 1.73) 200 — S — 296 (1.40 1.54 1.73)
200 — S — 298 (0.97 1.14 2.12) 200 — S — 305 (1.29 1.21 2.06) 200 — S — 306 (1.45 1.86 1.41) 200 — S — 307 (1.18 1.99 1.28)
200 — S — 320 (1.67 2.28 0.99) 200 — S — 327 (1.06 1.61 1.66) 200 — S — 329 (1.39 2.07 1.20) 200 — S — 336 (0.88 0.85 2.42)
200 — S — 342 (2.82 1.82 1.45) 200 — S — 343 (3.35 2.31 0.96) 200 — S — 367 (1.35 1.76 1.51) 200 — S — 368 (1.46 2.30 0.96)
200 — S — 371 (2.51 1.91 1.36) 200 — S — 372 (0.92 0.89 2.38) 200 — S — 395 (1.54 1.61 1.66) 200 — S — 396 (0.96 1.04 2.22)
200 — S — 440 (1.22 1.52 1.75) 200 — S — 441 (1.15 1.44 1.83) 200 — S — 447 (1.16 1.63 1.64) 200 — S — 449 (0.91 1.60 1.67)
200 — S — 451 (1.25 2.21 1.06) 200 — S — 452 (1.30 1.87 1.40) 200 — S — 460 (1.03 1.94 1.33) 200 — S — 463 (1.18 2.31 0.96)
200 — S — 471 (1.33 1.17 2.09) 200 — S — 473 (1.38 1.79 1.48) 200 — S — 474 (1.23 1.68 1.59) 205 — S — 57 (0.93 1.33 1.55)
205 — S — 125 (1.17 1.78 1.10) 205 — S — 152 (2.14 1.00 1.88) 205 — S — 250 (0.94 1.91 0.97) 205 — S — 320 (0.84 1.06 1.82)
205 — S — 324 (0.82 1.55 1.32) 205 — S — 343 (2.52 1.09 1.79) 205 — S — 429 (2.08 1.79 1.09) 205 — S — 472 (1.08 1.37 1.51)
206 — S — 125 (1.17 0.87 1.09) 206 — S — 250 (0.94 1.00 0.96) 206 — S — 429 (2.09 0.88 1.08) 207 — S — 429 (1.57 0.93 1.60)
208 — S — 46 (1.29 0.84 2.53) 208 — S — 57 (0.97 1.86 1.51) 208 — S — 107 (0.80 0.81 2.56) 208 — S — 125 (1.21 2.31 1.06)
208 — S — 133 (0.80 1.10 2.27) 208 — S — 150 (1.63 0.97 2.40) 208 — S — 151 (1.53 1.23 2.14) 208 — S — 152 (2.18 1.53 1.84)
208 — S — 153 (1.56 1.07 2.30) 208 — S — 192 (0.98 1.08 2.29) 208 — S — 231 (1.02 1.20 2.17) 208 — S — 250 (0.97 2.44 0.93)
208 — S — 255 (0.94 1.17 2.20) 208 — S — 271 (1.20 1.26 2.11) 208 — S — 291 (1.29 1.11 2.26) 208 — S — 320 (0.88 1.59 1.78)
208 — S — 324 (0.85 2.08 1.29) 208 — S — 342 (2.03 1.13 2.24) 208 — S — 343 (2.56 1.62 1.75) 208 — S — 371 (1.72 1.22 2.15)
208 — S — 429 (2.12 2.32 1.05) 208 — S — 472 (1.11 1.90 1.47) 209 — S — 43 (0.95 1.25 1.79) 209 — S — 57 (1.22 1.78 1.26)
209 — S — 70 (1.01 1.46 1.58) 209 — S — 109 (0.85 1.26 1.78) 209 — S — 133 (1.06 1.02 2.02) 209 — S — 150 (1.88 0.89 2.15)
209 — S — 151 (1.79 1.15 1.89) 209 — S — 152 (2.43 1.45 1.59) 209 — S — 153 (1.81 0.99 2.05) 209 — S — 192 (1.23 1.01 2.03)
209 — S — 207 (0.80 1.31 1.73) 209 — S — 215 (1.04 1.58 1.46) 209 — S — 231 (1.28 1.12 1.92) 209 — S — 246 (0.80 0.88 2.16)

209 — S — 247 (0.94 2.08 0.96) 209 — S — 248 (0.87 1.42 1.62) 209 — S — 255 (1.19 1.09 1.95) 209 — S — 259 (1.05 1.91 1.13)
209 — S — 270 (0.85 1.77 1.27) 209 — S — 271 (1.46 1.19 1.85) 209 — S — 291 (1.54 1.03 2.01) 209 — S — 306 (0.91 1.09 1.95)
209 — S — 320 (1.13 1.51 1.53) 209 — S — 324 (1.11 2.00 1.04) 209 — S — 329 (0.85 1.30 1.74) 209 — S — 342 (2.28 1.05 1.99)
209 — S — 343 (2.81 1.54 1.50) 209 — S — 364 (0.99 1.67 1.37) 209 — S — 367 (0.81 0.99 2.05) 209 — S — 368 (0.92 1.54 1.50)
209 — S — 371 (1.97 1.14 1.90) 209 — S — 395 (1.00 0.84 2.20) 209 — S — 472 (1.37 1.82 1.22) 209 — S — 473 (0.84 1.02 2.02)
210 — S — 43 (1.05 1.84 1.69) 210 — S — 46 (1.65 1.36 2.17) 210 — S — 57 (1.32 2.38 1.15) 210 — S — 70 (1.12 2.05 1.48)
210 — S — 85 (0.90 1.16 2.37) 210 — S — 89 (0.87 1.79 1.74) 210 — S — 93 (0.85 2.54 1.00) 210 — S — 107 (1.16 1.33 2.21)
210 — S — 109 (0.96 1.85 1.68) 210 — S — 115 (0.83 1.47 2.07) 210 — S — 133 (1.16 1.62 1.92) 210 — S — 150 (1.98 1.49 2.04)
210 — S — 151 (1.89 1.75 1.78) 210 — S — 152 (2.53 2.05 1.48) 210 — S — 153 (1.92 1.59 1.94) 210 — S — 165 (0.82 2.46 1.07)
210 — S — 177 (1.00 1.27 2.26) 210 — S — 184 (1.73 1.08 2.45) 210 — S — 192 (1.34 1.60 1.93) 210 — S — 195 (1.16 0.93 2.61)
210 — S — 198 (0.87 0.99 2.55) 210 — S — 207 (0.91 1.91 1.62) 210 — S — 213 (0.84 0.94 2.59) 210 — S — 215 (1.14 2.17 1.36)
210 — S — 231 (1.38 1.72 1.82) 210 — S — 246 (0.91 1.47 2.06) 210 — S — 248 (0.97 2.02 1.51) 210 — S — 255 (1.30 1.69 1.84)
210 — S — 259 (1.15 2.51 1.02) 210 — S — 265 (0.87 1.61 1.92) 210 — S — 268 (0.85 1.76 1.77) 210 — S — 269 (0.81 1.69 1.84)
210 — S — 270 (0.95 2.37 1.16) 210 — S — 271 (1.56 1.78 1.75) 210 — S — 291 (1.64 1.63 1.90) 210 — S — 292 (0.98 1.29 2.25)
210 — S — 294 (0.93 1.13 2.40) 210 — S — 296 (0.97 1.37 2.16) 210 — S — 305 (0.86 1.04 2.50) 210 — S — 306 (1.02 1.69 1.84)
210 — S — 320 (1.24 2.11 1.42) 210 — S — 324 (1.21 2.60 0.93) 210 — S — 329 (0.96 1.90 1.64) 210 — S — 342 (2.39 1.65 1.89)
210 — S — 343 (2.91 2.14 1.39) 210 — S — 364 (1.09 2.27 1.26) 210 — S — 367 (0.91 1.59 1.94) 210 — S — 368 (1.02 2.13 1.40)
210 — S — 371 (2.07 1.74 1.80) 210 — S — 395 (1.10 1.44 2.10) 210 — S — 451 (0.81 2.04 1.49) 210 — S — 452 (0.87 1.69 1.84)
210 — S — 471 (0.90 1.00 2.53) 210 — S — 472 (1.47 2.42 1.12) 210 — S — 473 (0.94 1.62 1.91) 211 — S — 36 (1.19 1.22 1.00)
211 — S — 43 (1.60 1.08 1.14) 211 — S — 70 (1.67 1.29 0.93) 211 — S — 89 (1.42 1.03 1.19) 211 — S — 90 (1.33 0.88 1.34)
211 — S — 108 (1.27 0.95 1.27) 211 — S — 109 (1.50 1.09 1.13) 211 — S — 113 (1.10 1.14 1.08) 211 — S — 133 (1.71 0.85 1.37)
211 — S — 151 (2.44 0.98 1.24) 211 — S — 152 (3.08 1.28 0.94) 211 — S — 153 (2.46 0.83 1.39) 211 — S — 183 (1.19 0.84 1.38)
211 — S — 192 (1.89 0.84 1.38) 211 — S — 206 (0.94 1.19 1.03) 211 — S — 207 (1.46 1.14 1.08) 211 — S — 231 (1.93 0.95 1.27)
211 — S — 248 (1.52 1.26 0.97) 211 — S — 249 (0.99 1.10 1.12) 211 — S — 251 (0.96 0.95 1.27) 211 — S — 255 (1.84 0.93 1.29)
211 — S — 265 (1.42 0.85 1.37) 211 — S — 268 (1.39 1.00 1.22) 211 — S — 269 (1.36 0.93 1.29) 211 — S — 271 (2.11 1.02 1.20)
211 — S — 291 (2.19 0.86 1.36) 211 — S — 306 (1.56 0.92 1.30) 211 — S — 307 (1.29 1.05 1.17) 211 — S — 329 (1.51 1.13 1.09)
211 — S — 342 (2.93 0.88 1.34) 211 — S — 367 (1.46 0.83 1.39) 211 — S — 371 (2.62 0.97 1.25) 211 — S — 420 (0.83 1.15 1.07)
211 — S — 451 (1.36 1.27 0.95) 211 — S — 452 (1.42 0.93 1.29) 211 — S — 460 (1.14 1.01 1.21) 211 — S — 469 (0.84 0.91 1.31)
211 — S — 473 (1.49 0.85 1.37) 212 — S — 27 (1.15 0.93 1.59) 212 — S — 28 (1.22 1.20 1.32) 212 — S — 29 (0.98 0.92 1.60)
212 — S — 43 (1.79 1.57 0.95) 212 — S — 46 (2.39 1.09 1.43) 212 — S — 61 (1.13 0.91 1.62) 212 — S — 62 (1.00 1.11 1.42)
212 — S — 79 (1.12 1.08 1.44) 212 — S — 80 (1.07 1.04 1.49) 212 — S — 81 (1.15 1.16 1.36) 212 — S — 82 (0.88 1.35 1.18)
212 — S — 85 (1.64 0.89 1.63) 212 — S — 86 (0.85 1.26 1.26) 212 — S — 89 (1.61 1.52 1.01) 212 — S — 90 (1.52 1.37 1.16)
212 — S — 101 (1.27 1.22 1.30) 212 — S — 107 (1.90 1.05 1.47) 212 — S — 108 (1.46 1.44 1.08) 212 — S — 109 (1.69 1.58 0.94)
212 — S — 110 (1.19 1.22 1.31) 212 — S — 115 (1.56 1.19 1.33) 212 — S — 119 (1.14 0.83 1.69) 212 — S — 133 (1.90 1.34 1.18)
212 — S — 144 (1.23 1.25 1.27) 212 — S — 150 (2.72 1.21 1.31) 212 — S — 151 (2.63 1.47 1.05) 212 — S — 153 (2.65 1.32 1.21)
212 — S — 177 (1.73 0.99 1.53) 212 — S — 183 (1.38 1.33 1.19) 212 — S — 184 (2.47 0.81 1.71) 212 — S — 192 (2.07 1.33 1.19)
212 — S — 218 (0.97 0.88 1.64) 212 — S — 231 (2.12 1.44 1.08) 212 — S — 233 (1.50 0.86 1.66) 212 — S — 234 (1.32 0.95 1.58)
212 — S — 237 (1.33 1.24 1.28) 212 — S — 244 (1.39 0.86 1.66) 212 — S — 246 (1.64 1.20 1.32) 212 — S — 249 (1.18 1.59 0.94)
212 — S — 251 (1.15 1.44 1.08) 212 — S — 255 (2.03 1.42 1.11) 212 — S — 265 (1.60 1.34 1.18) 212 — S — 266 (1.24 0.92 1.61)
212 — S — 268 (1.58 1.49 1.03) 212 — S — 269 (1.55 1.42 1.11) 212 — S — 271 (2.30 1.51 1.01) 212 — S — 290 (1.24 0.95 1.58)
212 — S — 291 (2.38 1.35 1.17) 212 — S — 292 (1.71 1.01 1.51) 212 — S — 293 (1.22 0.82 1.70) 212 — S — 294 (1.67 0.85 1.67)
212 — S — 295 (1.42 1.10 1.42) 212 — S — 296 (1.70 1.09 1.43) 212 — S — 306 (1.75 1.41 1.11) 212 — S — 307 (1.48 1.54 0.98)
212 — S — 327 (1.36 1.16 1.36) 212 — S — 329 (1.69 1.62 0.90) 212 — S — 342 (3.12 1.37 1.15) 212 — S — 367 (1.65 1.32 1.21)
212 — S — 371 (2.81 1.46 1.06) 212 — S — 374 (0.83 0.94 1.58) 212 — S — 395 (1.84 1.16 1.36) 212 — S — 430 (0.85 1.26 1.26)
212 — S — 435 (1.00 0.90 1.62) 212 — S — 440 (1.52 1.07 1.45) 212 — S — 441 (1.46 1.00 1.53) 212 — S — 443 (0.93 1.61 0.91)
212 — S — 447 (1.47 1.18 1.34) 212 — S — 449 (1.21 1.15 1.37) 212 — S — 450 (0.83 0.82 1.70) 212 — S — 452 (1.60 1.42 1.10)
212 — S — 457 (1.05 1.06 1.46) 212 — S — 459 (0.84 1.30 1.23) 212 — S — 460 (1.33 1.50 1.03) 212 — S — 461 (1.04 1.26 1.27)
212 — S — 468 (0.93 0.97 1.55) 212 — S — 469 (1.02 1.40 1.12) 212 — S — 473 (1.68 1.34 1.18) 212 — S — 474 (1.53 1.23 1.29)
213 — S — 151 (1.05 0.81 2.63) 213 — S — 152 (1.69 1.11 2.33) 213 — S — 343 (2.07 1.20 2.23) 213 — S — 429 (1.63 1.90 1.54)
214 — S — 46 (1.25 1.19 2.57) 214 — S — 57 (0.92 2.20 1.55) 214 — S — 125 (1.16 2.65 1.10) 214 — S — 150 (1.58 1.31 2.44)
214 — S — 151 (1.49 1.57 2.19) 214 — S — 152 (2.13 1.87 1.89) 214 — S — 153 (1.51 1.41 2.34) 214 — S — 184 (1.33 0.91 2.85)
214 — S — 192 (0.94 1.43 2.33) 214 — S — 231 (0.98 1.54 2.22) 214 — S — 250 (0.93 2.78 0.98) 214 — S — 255 (0.90 1.51 2.24)
214 — S — 271 (1.16 1.61 2.15) 214 — S — 291 (1.24 1.45 2.31) 214 — S — 320 (0.84 1.93 1.83) 214 — S — 324 (0.81 2.42 1.33)
214 — S — 342 (1.98 1.47 2.29) 214 — S — 343 (2.51 1.96 1.79) 214 — S — 371 (1.67 1.56 2.20) 214 — S — 429 (2.07 2.66 1.10)
214 — S — 472 (1.07 2.24 1.52) 217 — S — 57 (1.06 1.41 1.42) 217 — S — 70 (0.85 1.08 1.74) 217 — S — 125 (1.30 1.85 0.97)
217 — S — 152 (2.27 1.07 1.75) 217 — S — 215 (0.88 1.20 1.62) 217 — S — 259 (0.89 1.53 1.29) 217 — S — 271 (1.30 0.81 2.01)
217 — S — 320 (0.97 1.13 1.69) 217 — S — 324 (0.95 1.63 1.20) 217 — S — 343 (2.65 1.16 1.66) 217 — S — 364 (0.83 1.29 1.53)
217 — S — 429 (2.21 1.86 0.96) 217 — S — 472 (1.21 1.44 1.38) 218 — S — 57 (1.09 1.23 1.39) 218 — S — 70 (0.88 0.90 1.71)

218 — S — 125 (1.33 1.68 0.94) 218 — S — 152 (2.30 0.89 1.72) 218 — S — 215 (0.91 1.02 1.59) 218 — S — 247 (0.81 1.53 1.09)
218 — S — 259 (0.92 1.36 1.26) 218 — S — 320 (1.00 0.96 1.66) 218 — S — 324 (0.98 1.45 1.17) 218 — S — 343 (2.68 0.99 1.63)
218 — S — 364 (0.86 1.12 1.50) 218 — S — 429 (2.24 1.69 0.93) 218 — S — 472 (1.24 1.26 1.35) 219 — S — 43 (1.02 1.13 1.73)
219 — S — 57 (1.29 1.67 1.19) 219 — S — 70 (1.08 1.34 1.52) 219 — S — 89 (0.84 1.08 1.78) 219 — S — 93 (0.81 1.83 1.03)
219 — S — 109 (0.92 1.14 1.71) 219 — S — 133 (1.13 0.91 1.95) 219 — S — 151 (1.86 1.04 1.82) 219 — S — 152 (2.50 1.34 1.52)
219 — S — 153 (1.88 0.88 1.98) 219 — S — 192 (1.30 0.89 1.96) 219 — S — 207 (0.87 1.20 1.66) 219 — S — 215 (1.11 1.46 1.39)
219 — S — 231 (1.35 1.01 1.85) 219 — S — 248 (0.94 1.31 1.55) 219 — S — 255 (1.26 0.98 1.88) 219 — S — 259 (1.12 1.80 1.06)
219 — S — 265 (0.83 0.90 1.95) 219 — S — 268 (0.81 1.05 1.80) 219 — S — 270 (0.92 1.66 1.20) 219 — S — 271 (1.53 1.07 1.78)
219 — S — 291 (1.61 0.92 1.94) 219 — S — 306 (0.98 0.98 1.88) 219 — S — 320 (1.20 1.40 1.46) 219 — S — 324 (1.18 1.89 0.97)
219 — S — 329 (0.92 1.19 1.67) 219 — S — 342 (2.35 0.94 1.92) 219 — S — 343 (2.88 1.43 1.43) 219 — S — 364 (1.06 1.56 1.30)
219 — S — 367 (0.88 0.88 1.98) 219 — S — 368 (0.99 1.42 1.43) 219 — S — 371 (2.04 1.03 1.83) 219 — S — 452 (0.83 0.99 1.87)
219 — S — 472 (1.44 1.71 1.15) 219 — S — 473 (0.91 0.91 1.95) 222 — S — 43 (0.91 1.28 1.84) 222 — S — 46 (1.50 0.81 2.32)
222 — S — 57 (1.17 1.82 1.30) 222 — S — 70 (0.97 1.49 1.63) 222 — S — 109 (0.81 1.30 1.83) 222 — S — 133 (1.01 1.06 2.06)
222 — S — 150 (1.83 0.93 2.19) 222 — S — 151 (1.74 1.19 1.93) 222 — S — 152 (2.39 1.49 1.63) 222 — S — 153 (1.77 1.03 2.09)
222 — S — 192 (1.19 1.05 2.08) 222 — S — 215 (0.99 1.62 1.51) 222 — S — 231 (1.23 1.16 1.96) 222 — S — 247 (0.89 2.12 1.00)
222 — S — 248 (0.82 1.46 1.66) 222 — S — 255 (1.15 1.13 1.99) 222 — S — 259 (1.01 1.95 1.17) 222 — S — 270 (0.80 1.81 1.31)
222 — S — 271 (1.41 1.23 1.90) 222 — S — 291 (1.50 1.07 2.05) 222 — S — 296 (0.82 0.81 2.31) 222 — S — 306 (0.87 1.13 1.99)
222 — S — 320 (1.09 1.55 1.57) 222 — S — 324 (1.06 2.04 1.08) 222 — S — 329 (0.81 1.34 1.78) 222 — S — 342 (2.24 1.09 2.03)
222 — S — 343 (2.77 1.58 1.54) 222 — S — 364 (0.95 1.71 1.41) 222 — S — 368 (0.88 1.58 1.55) 222 — S — 371 (1.93 1.18 1.94)
222 — S — 395 (0.96 0.88 2.24) 222 — S — 472 (1.32 1.86 1.26) 223 — S — 9 (1.00 0.99 2.43) 223 — S — 20 (1.11 1.54 1.89)
223 — S — 27 (1.02 1.71 1.72) 223 — S — 28 (1.09 1.97 1.45) 223 — S — 29 (0.85 1.70 1.73) 223 — S — 36 (1.24 2.49 0.94)
223 — S — 43 (1.66 2.34 1.09) 223 — S — 46 (2.26 1.86 1.56) 223 — S — 56 (1.01 1.17 2.26) 223 — S — 61 (1.00 1.68 1.75)
223 — S — 62 (0.87 1.88 1.55) 223 — S — 65 (1.01 1.48 1.95) 223 — S — 79 (0.99 1.85 1.57) 223 — S — 80 (0.94 1.81 1.62)
223 — S — 81 (1.02 1.93 1.49) 223 — S — 83 (1.05 1.11 2.32) 223 — S — 85 (1.50 1.66 1.76) 223 — S — 89 (1.48 2.29 1.14)
223 — S — 90 (1.39 2.14 1.29) 223 — S — 101 (1.14 1.99 1.43) 223 — S — 105 (1.30 1.09 2.34) 223 — S — 107 (1.77 1.83 1.60)
223 — S — 108 (1.33 2.22 1.21) 223 — S — 109 (1.56 2.35 1.07) 223 — S — 110 (1.06 1.99 1.44) 223 — S — 111 (1.76 1.11 2.32)
223 — S — 112 (0.95 1.49 1.94) 223 — S — 113 (1.16 2.41 1.02) 223 — S — 115 (1.43 1.96 1.46) 223 — S — 118 (1.04 1.39 2.04)
223 — S — 119 (1.01 1.60 1.83) 223 — S — 131 (1.07 1.06 2.36) 223 — S — 132 (0.98 1.31 2.12) 223 — S — 133 (1.77 2.12 1.31)
223 — S — 144 (1.10 2.03 1.40) 223 — S — 150 (2.59 1.99 1.44) 223 — S — 151 (2.50 2.25 1.18) 223 — S — 153 (2.52 2.09 1.34)
223 — S — 154 (2.05 1.22 2.21) 223 — S — 166 (1.77 1.05 2.38) 223 — S — 171 (1.54 1.04 2.38) 223 — S — 177 (1.60 1.77 1.66)
223 — S — 183 (1.25 2.11 1.32) 223 — S — 184 (2.34 1.58 1.85) 223 — S — 187 (1.48 0.95 2.47) 223 — S — 188 (1.91 0.99 2.43)
223 — S — 192 (1.94 2.10 1.32) 223 — S — 193 (0.86 1.26 2.16) 223 — S — 195 (1.77 1.43 2.00) 223 — S — 198 (1.48 1.49 1.94)
223 — S — 205 (1.00 1.55 1.88) 223 — S — 206 (0.99 2.46 0.97) 223 — S — 207 (1.51 2.41 1.02) 223 — S — 208 (0.96 1.02 2.41)
223 — S — 213 (1.45 1.44 1.98) 223 — S — 217 (0.87 1.47 1.95) 223 — S — 218 (0.84 1.65 1.77) 223 — S — 231 (1.99 2.21 1.21)
223 — S — 233 (1.37 1.64 1.79) 223 — S — 234 (1.19 1.72 1.71) 223 — S — 237 (1.20 2.02 1.41) 223 — S — 243 (1.94 0.85 2.58)
223 — S — 244 (1.26 1.63 1.79) 223 — S — 245 (1.18 1.41 2.02) 223 — S — 246 (1.51 1.97 1.45) 223 — S — 248 (1.58 2.52 0.91)
223 — S — 249 (1.05 2.36 1.07) 223 — S — 251 (1.02 2.22 1.21) 223 — S — 254 (1.01 1.33 2.10) 223 — S — 255 (1.90 2.19 1.24)
223 — S — 265 (1.47 2.11 1.31) 223 — S — 266 (1.11 1.69 1.74) 223 — S — 267 (0.91 1.39 2.04) 223 — S — 268 (1.45 2.26 1.16)
223 — S — 269 (1.42 2.19 1.24) 223 — S — 271 (2.17 2.28 1.14) 223 — S — 277 (1.00 1.46 1.97) 223 — S — 279 (1.05 1.52 1.91)
223 — S — 282 (0.85 1.03 2.40) 223 — S — 286 (1.03 1.31 2.12) 223 — S — 287 (0.83 1.32 2.11) 223 — S — 288 (0.82 1.26 2.17)
223 — S — 289 (1.08 1.10 2.33) 223 — S — 290 (1.11 1.72 1.71) 223 — S — 291 (2.25 2.13 1.30) 223 — S — 292 (1.58 1.79 1.64)
223 — S — 293 (1.09 1.60 1.83) 223 — S — 294 (1.54 1.63 1.80) 223 — S — 295 (1.29 1.87 1.55) 223 — S — 296 (1.57 1.87 1.56)
223 — S — 297 (0.88 1.00 2.43) 223 — S — 298 (1.14 1.47 1.95) 223 — S — 300 (1.15 0.87 2.55) 223 — S — 303 (0.91 0.85 2.58)
223 — S — 304 (0.95 1.32 2.11) 223 — S — 305 (1.46 1.54 1.89) 223 — S — 306 (1.62 2.19 1.24) 223 — S — 307 (1.35 2.32 1.11)
223 — S — 310 (1.06 0.93 2.50) 223 — S — 312 (0.88 1.08 2.35) 223 — S — 316 (0.95 1.53 1.89) 223 — S — 327 (1.23 1.94 1.49)
223 — S — 329 (1.56 2.40 1.03) 223 — S — 331 (1.09 1.11 2.31) 223 — S — 332 (0.95 1.29 2.14) 223 — S — 336 (1.05 1.18 2.25)
223 — S — 342 (2.99 2.15 1.28) 223 — S — 358 (0.89 1.45 1.97) 223 — S — 367 (1.52 2.09 1.34) 223 — S — 370 (0.86 1.52 1.91)
223 — S — 371 (2.68 2.24 1.19) 223 — S — 372 (1.09 1.22 2.21) 223 — S — 382 (0.84 1.40 2.03) 223 — S — 395 (1.71 1.94 1.49)
223 — S — 396 (1.13 1.37 2.05) 223 — S — 397 (0.94 1.22 2.21) 223 — S — 415 (0.83 1.10 2.33) 223 — S — 420 (0.89 2.41 1.01)
223 — S — 435 (0.87 1.68 1.75) 223 — S — 437 (1.05 1.05 2.37) 223 — S — 440 (1.39 1.84 1.58) 223 — S — 441 (1.32 1.77 1.66)
223 — S — 447 (1.34 1.96 1.47) 223 — S — 449 (1.08 1.93 1.50) 223 — S — 452 (1.47 2.19 1.23) 223 — S — 453 (0.97 0.90 2.53)
223 — S — 457 (0.92 1.84 1.59) 223 — S — 460 (1.20 2.27 1.16) 223 — S — 461 (0.91 2.03 1.40) 223 — S — 468 (0.80 1.74 1.68)
223 — S — 469 (0.89 2.17 1.25) 223 — S — 471 (1.50 1.50 1.92) 223 — S — 473 (1.55 2.12 1.31) 223 — S — 474 (1.40 2.01 1.42)
224 — S — 36 (0.86 1.76 1.33) 224 — S — 37 (0.85 2.06 1.03) 224 — S — 43 (1.27 1.62 1.47) 224 — S — 46 (1.87 1.14 1.95)
224 — S — 57 (1.54 2.15 0.93) 224 — S — 70 (1.34 1.83 1.26) 224 — S — 85 (1.12 0.94 2.15) 224 — S — 89 (1.09 1.56 1.52)
224 — S — 90 (1.00 1.41 1.67) 224 — S — 107 (1.38 1.10 1.99) 224 — S — 108 (0.94 1.49 1.60) 224 — S — 109 (1.17 1.63 1.46)
224 — S — 115 (1.04 1.24 1.85) 224 — S — 133 (1.38 1.39 1.70) 224 — S — 150 (2.20 1.26 1.82) 224 — S — 151 (2.11 1.52 1.57)
224 — S — 152 (2.75 1.82 1.27) 224 — S — 153 (2.13 1.36 1.72) 224 — S — 177 (1.21 1.04 2.04) 224 — S — 183 (0.86 1.38 1.71)

224 — S — 184 (1.95 0.86 2.23) 224 — S — 192 (1.56 1.38 1.71) 224 — S — 207 (1.13 1.68 1.41) 224 — S — 215 (1.36 1.95 1.14)
224 — S — 231 (1.60 1.49 1.60) 224 — S — 233 (0.99 0.91 2.17) 224 — S — 234 (0.81 0.99 2.09) 224 — S — 237 (0.82 1.29 1.80)
224 — S — 244 (0.87 0.91 2.18) 224 — S — 246 (1.12 1.25 1.84) 224 — S — 248 (1.19 1.79 1.29) 224 — S — 255 (1.52 1.46 1.62)
224 — S — 265 (1.09 1.39 1.70) 224 — S — 268 (1.07 1.54 1.55) 224 — S — 269 (1.03 1.46 1.62) 224 — S — 270 (1.17 2.14 0.94)
224 — S — 271 (1.78 1.56 1.53) 224 — S — 291 (1.86 1.40 1.69) 224 — S — 292 (1.19 1.06 2.03) 224 — S — 294 (1.15 0.90 2.19)
224 — S — 295 (0.91 1.15 1.94) 224 — S — 296 (1.18 1.14 1.95) 224 — S — 305 (1.07 0.81 2.28) 224 — S — 306 (1.24 1.46 1.62)
224 — S — 307 (0.96 1.59 1.49) 224 — S — 320 (1.46 1.88 1.21) 224 — S — 327 (0.85 1.21 1.88) 224 — S — 329 (1.18 1.67 1.42)
224 — S — 342 (2.60 1.42 1.67) 224 — S — 343 (3.13 1.91 1.18) 224 — S — 364 (1.31 2.04 1.05) 224 — S — 367 (1.13 1.36 1.72)
224 — S — 368 (1.24 1.91 1.18) 224 — S — 371 (2.29 1.51 1.58) 224 — S — 395 (1.32 1.21 1.88) 224 — S — 440 (1.01 1.12 1.97)
224 — S — 441 (0.94 1.05 2.04) 224 — S — 447 (0.95 1.23 1.86) 224 — S — 451 (1.03 1.81 1.28) 224 — S — 452 (1.09 1.47 1.62)
224 — S — 460 (0.81 1.54 1.54) 224 — S — 463 (0.96 1.91 1.17) 224 — S — 473 (1.16 1.39 1.70) 224 — S — 474 (1.01 1.28 1.81)
225 — S — 28 (0.84 0.91 1.70) 225 — S — 36 (1.00 1.43 1.19) 225 — S — 43 (1.41 1.28 1.33) 225 — S — 46 (2.01 0.80 1.81)
225 — S — 70 (1.48 1.49 1.12) 225 — S — 89 (1.23 1.23 1.38) 225 — S — 90 (1.14 1.08 1.53) 225 — S — 101 (0.90 0.93 1.68)
225 — S — 108 (1.08 1.16 1.46) 225 — S — 109 (1.32 1.29 1.32) 225 — S — 110 (0.81 0.93 1.68) 225 — S — 113 (0.92 1.35 1.27)
225 — S — 115 (1.19 0.90 1.71) 225 — S — 133 (1.52 1.06 1.56) 225 — S — 144 (0.86 0.97 1.65) 225 — S — 145 (0.84 1.62 0.99)
225 — S — 150 (2.34 0.93 1.68) 225 — S — 151 (2.25 1.19 1.42) 225 — S — 152 (2.89 1.49 1.13) 225 — S — 153 (2.27 1.03 1.58)
225 — S — 183 (1.00 1.05 1.57) 225 — S — 192 (1.70 1.04 1.57) 225 — S — 207 (1.27 1.35 1.27) 225 — S — 215 (1.50 1.61 1.00)
225 — S — 231 (1.74 1.15 1.46) 225 — S — 237 (0.96 0.96 1.66) 225 — S — 246 (1.27 0.91 1.70) 225 — S — 248 (1.33 1.46 1.15)
225 — S — 249 (0.80 1.30 1.31) 225 — S — 255 (1.66 1.13 1.48) 225 — S — 265 (1.23 1.05 1.56) 225 — S — 268 (1.21 1.20 1.41)
225 — S — 269 (1.17 1.13 1.48) 225 — S — 271 (1.92 1.22 1.39) 225 — S — 291 (2.00 1.07 1.55) 225 — S — 295 (1.05 0.81 1.80)
225 — S — 296 (1.33 0.81 1.80) 225 — S — 306 (1.38 1.13 1.48) 225 — S — 307 (1.11 1.26 1.35) 225 — S — 320 (1.60 1.55 1.06)
225 — S — 327 (0.99 0.88 1.74) 225 — S — 329 (1.32 1.34 1.28) 225 — S — 342 (2.74 1.09 1.53) 225 — S — 343 (3.27 1.58 1.03)
225 — S — 364 (1.45 1.71 0.90) 225 — S — 367 (1.27 1.03 1.58) 225 — S — 368 (1.38 1.57 1.04) 225 — S — 371 (2.43 1.17 1.44)
225 — S — 395 (1.46 0.88 1.74) 225 — S — 447 (1.09 0.90 1.71) 225 — S — 449 (0.83 0.87 1.75) 225 — S — 451 (1.17 1.48 1.14)
225 — S — 452 (1.23 1.13 1.48) 225 — S — 460 (0.95 1.21 1.40) 225 — S — 463 (1.11 1.58 1.03) 225 — S — 473 (1.30 1.06 1.56)
225 — S — 474 (1.15 0.95 1.67) 227 — S — 36 (1.20 0.90 0.98) 227 — S — 70 (1.68 0.97 0.92) 227 — S — 113 (1.12 0.82 1.06)
227 — S — 152 (3.10 0.96 0.92) 227 — S — 206 (0.95 0.88 1.01) 227 — S — 207 (1.47 0.82 1.06) 227 — S — 248 (1.54 0.94 0.95)
227 — S — 329 (1.52 0.81 1.07) 227 — S — 420 (0.85 0.83 1.05) 227 — S — 451 (1.38 0.95 0.93) 228 — S — 36 (0.86 1.28 1.32)
228 — S — 37 (0.86 1.58 1.02) 228 — S — 43 (1.28 1.13 1.47) 228 — S — 57 (1.55 1.67 0.93) 228 — S — 70 (1.34 1.34 1.26)
228 — S — 89 (1.10 1.08 1.52) 228 — S — 90 (1.01 0.93 1.67) 228 — S — 108 (0.95 1.01 1.59) 228 — S — 109 (1.18 1.14 1.45)
228 — S — 133 (1.39 0.91 1.69) 228 — S — 151 (2.12 1.04 1.56) 228 — S — 152 (2.76 1.34 1.26) 228 — S — 153 (2.14 0.88 1.72)
228 — S — 183 (0.87 0.90 1.70) 228 — S — 192 (1.56 0.89 1.70) 228 — S — 207 (1.13 1.20 1.40) 228 — S — 215 (1.37 1.46 1.13)
228 — S — 231 (1.61 1.01 1.59) 228 — S — 237 (0.82 0.81 1.79) 228 — S — 248 (1.20 1.31 1.29) 228 — S — 255 (1.52 0.98 1.62)
228 — S — 265 (1.09 0.90 1.69) 228 — S — 268 (1.07 1.05 1.55) 228 — S — 269 (1.04 0.98 1.62) 228 — S — 270 (1.18 1.66 0.94)
228 — S — 271 (1.79 1.07 1.52) 228 — S — 291 (1.87 0.92 1.68) 228 — S — 306 (1.24 0.98 1.62) 228 — S — 307 (0.97 1.11 1.49)
228 — S — 320 (1.46 1.40 1.20) 228 — S — 329 (1.18 1.19 1.41) 228 — S — 342 (2.61 0.94 1.66) 228 — S — 343 (3.14 1.43 1.17)
228 — S — 364 (1.32 1.56 1.04) 228 — S — 367 (1.14 0.88 1.72) 228 — S — 368 (1.25 1.42 1.17) 228 — S — 371 (2.30 1.03 1.57)
228 — S — 451 (1.04 1.33 1.27) 228 — S — 452 (1.09 0.98 1.61) 228 — S — 460 (0.82 1.06 1.54) 228 — S — 463 (0.97 1.43 1.17)
228 — S — 473 (1.17 0.91 1.69) 230 — S — 43 (0.98 1.46 1.77) 230 — S — 46 (1.57 0.98 2.25) 230 — S — 57 (1.25 2.00 1.23)
230 — S — 70 (1.04 1.67 1.56) 230 — S — 107 (1.08 0.94 2.28) 230 — S — 109 (0.88 1.47 1.76) 230 — S — 133 (1.09 1.23 1.99)
230 — S — 150 (1.91 1.11 2.12) 230 — S — 151 (1.81 1.36 1.86) 230 — S — 152 (2.46 1.66 1.56) 230 — S — 153 (1.84 1.21 2.02)
230 — S — 177 (0.92 0.89 2.34) 230 — S — 192 (1.26 1.22 2.01) 230 — S — 207 (0.83 1.52 1.70) 230 — S — 215 (1.06 1.79 1.44)
230 — S — 231 (1.31 1.33 1.89) 230 — S — 246 (0.83 1.09 2.14) 230 — S — 247 (0.96 2.29 0.93) 230 — S — 248 (0.90 1.64 1.59)
230 — S — 255 (1.22 1.31 1.92) 230 — S — 259 (1.08 2.12 1.10) 230 — S — 270 (0.88 1.99 1.24) 230 — S — 271 (1.48 1.40 1.83)
230 — S — 291 (1.57 1.24 1.98) 230 — S — 292 (0.90 0.90 2.32) 230 — S — 296 (0.89 0.98 2.24) 230 — S — 306 (0.94 1.31 1.92)
230 — S — 320 (1.16 1.72 1.50) 230 — S — 324 (1.14 2.22 1.01) 230 — S — 329 (0.88 1.51 1.71) 230 — S — 342 (2.31 1.26 1.96)
230 — S — 343 (2.84 1.76 1.47) 230 — S — 364 (1.02 1.88 1.34) 230 — S — 367 (0.84 1.21 2.02) 230 — S — 368 (0.95 1.75 1.48)
230 — S — 371 (2.00 1.35 1.87) 230 — S — 395 (1.03 1.05 2.17) 230 — S — 472 (1.39 2.03 1.19) 230 — S — 473 (0.87 1.23 1.99)
231 — S — 429 (1.09 1.12 2.08) 232 — S — 27 (1.34 0.87 1.41) 232 — S — 28 (1.40 1.14 1.14) 232 — S — 29 (1.16 0.87 1.42)
232 — S — 40 (0.98 0.86 1.42) 232 — S — 46 (2.57 1.03 1.25) 232 — S — 61 (1.31 0.85 1.43) 232 — S — 62 (1.19 1.05 1.23)
232 — S — 79 (1.30 1.02 1.26) 232 — S — 80 (1.26 0.98 1.30) 232 — S — 81 (1.33 1.10 1.18) 232 — S — 82 (1.07 1.29 0.99)
232 — S — 85 (1.82 0.83 1.45) 232 — S — 86 (1.04 1.20 1.08) 232 — S — 90 (1.70 1.31 0.97) 232 — S — 101 (1.46 1.16 1.12)
232 — S — 107 (2.08 0.99 1.29) 232 — S — 110 (1.37 1.16 1.12) 232 — S — 115 (1.74 1.13 1.15) 232 — S — 123 (0.97 0.90 1.38)
232 — S — 133 (2.08 1.28 1.00) 232 — S — 144 (1.42 1.19 1.09) 232 — S — 150 (2.90 1.16 1.12) 232 — S — 153 (2.83 1.26 1.02)
232 — S — 177 (1.91 0.94 1.34) 232 — S — 183 (1.56 1.27 1.01) 232 — S — 192 (2.26 1.27 1.01) 232 — S — 218 (1.15 0.82 1.46)
232 — S — 233 (1.69 0.81 1.47) 232 — S — 234 (1.51 0.89 1.39) 232 — S — 237 (1.52 1.18 1.10) 232 — S — 238 (0.81 1.04 1.24)
232 — S — 246 (1.82 1.14 1.14) 232 — S — 255 (2.22 1.36 0.92) 232 — S — 265 (1.79 1.28 1.00) 232 — S — 266 (1.42 0.86 1.42)
232 — S — 269 (1.73 1.36 0.92) 232 — S — 290 (1.42 0.89 1.39) 232 — S — 291 (2.56 1.30 0.99) 232 — S — 292 (1.89 0.95 1.33)

232 — S — 295 (1.61 1.04 1.24) 232 — S — 296 (1.88 1.04 1.25) 232 — S — 306 (1.94 1.36 0.92) 232 — S — 327 (1.55 1.10 1.18)
232 — S — 341 (0.86 0.97 1.31) 232 — S — 342 (3.30 1.31 0.97) 232 — S — 367 (1.83 1.26 1.02) 232 — S — 374 (1.01 0.88 1.40)
232 — S — 395 (2.02 1.10 1.18) 232 — S — 430 (1.03 1.20 1.08) 232 — S — 435 (1.18 0.85 1.44) 232 — S — 440 (1.71 1.01 1.27)
232 — S — 441 (1.64 0.94 1.34) 232 — S — 447 (1.65 1.13 1.16) 232 — S — 449 (1.39 1.10 1.19) 232 — S — 452 (1.79 1.36 0.92)
232 — S — 457 (1.23 1.01 1.28) 232 — S — 459 (1.02 1.24 1.04) 232 — S — 461 (1.23 1.20 1.08) 232 — S — 462 (0.92 1.21 1.07)
232 — S — 468 (1.12 0.91 1.37) 232 — S — 469 (1.21 1.34 0.94) 232 — S — 473 (1.86 1.28 1.00) 232 — S — 474 (1.71 1.17 1.11)
233 — S — 152 (1.77 0.91 2.25) 233 — S — 343 (2.15 1.00 2.16) 233 — S — 429 (1.71 1.70 1.46) 234 — S — 125 (0.97 1.61 1.29)
234 — S — 152 (1.95 0.83 2.07) 234 — S — 343 (2.33 0.92 1.98) 234 — S — 429 (1.89 1.62 1.28) 234 — S — 472 (0.88 1.19 1.70)
235 — S — 9 (0.90 2.21 2.54) 235 — S — 20 (1.00 2.75 1.99) 235 — S — 27 (0.92 2.92 1.82) 235 — S — 28 (0.98 3.19 1.56)
235 — S — 36 (1.14 3.70 1.04) 235 — S — 43 (1.56 3.55 1.19) 235 — S — 46 (2.15 3.08 1.67) 235 — S — 56 (0.91 2.38 2.36)
235 — S — 61 (0.89 2.89 1.85) 235 — S — 65 (0.90 2.69 2.05) 235 — S — 70 (1.62 3.76 0.98) 235 — S — 79 (0.89 3.07 1.68)
235 — S — 80 (0.84 3.02 1.72) 235 — S — 81 (0.92 3.15 1.60) 235 — S — 83 (0.95 2.32 2.42) 235 — S — 85 (1.40 2.88 1.87)
235 — S — 89 (1.37 3.50 1.24) 235 — S — 90 (1.28 3.35 1.39) 235 — S — 101 (1.04 3.20 1.54) 235 — S — 105 (1.20 2.30 2.44)
235 — S — 107 (1.66 3.04 1.71) 235 — S — 108 (1.22 3.43 1.31) 235 — S — 109 (1.46 3.57 1.18) 235 — S — 110 (0.95 3.20 1.54)
235 — S — 111 (1.66 2.32 2.42) 235 — S — 112 (0.85 2.70 2.04) 235 — S — 113 (1.06 3.62 1.12) 235 — S — 115 (1.33 3.18 1.57)
235 — S — 118 (0.94 2.60 2.14) 235 — S — 119 (0.91 2.81 1.93) 235 — S — 131 (0.96 2.28 2.47) 235 — S — 132 (0.87 2.52 2.22)
235 — S — 133 (1.66 3.33 1.41) 235 — S — 136 (0.98 1.22 3.53) 235 — S — 141 (1.45 1.05 3.69) 235 — S — 144 (1.00 3.24 1.50)
235 — S — 150 (2.48 3.20 1.54) 235 — S — 151 (2.39 3.46 1.28) 235 — S — 152 (3.04 3.76 0.98) 235 — S — 153 (2.42 3.30 1.44)
235 — S — 154 (1.95 2.43 2.31) 235 — S — 155 (0.93 0.96 3.79) 235 — S — 158 (1.02 1.64 3.10) 235 — S — 160 (1.45 1.14 3.60)
235 — S — 161 (1.46 1.73 3.01) 235 — S — 166 (1.67 2.26 2.49) 235 — S — 167 (1.53 1.94 2.80) 235 — S — 168 (1.10 1.23 3.52)
235 — S — 170 (1.74 1.67 3.08) 235 — S — 171 (1.44 2.25 2.49) 235 — S — 177 (1.50 2.98 1.76) 235 — S — 183 (1.15 3.32 1.42)
235 — S — 184 (2.23 2.79 1.95) 235 — S — 187 (1.38 2.17 2.58) 235 — S — 188 (1.81 2.21 2.54) 235 — S — 189 (1.56 1.79 2.95)
235 — S — 192 (1.84 3.32 1.43) 235 — S — 194 (1.61 1.92 2.82) 235 — S — 195 (1.66 2.64 2.10) 235 — S — 197 (1.81 1.70 3.04)
235 — S — 198 (1.38 2.70 2.04) 235 — S — 205 (0.89 2.76 1.98) 235 — S — 206 (0.89 3.67 1.07) 235 — S — 207 (1.41 3.62 1.12)
235 — S — 208 (0.86 2.23 2.51) 235 — S — 213 (1.34 2.65 2.09) 235 — S — 214 (0.90 1.89 2.85) 235 — S — 231 (1.88 3.43 1.32)
235 — S — 233 (1.27 2.85 1.89) 235 — S — 234 (1.09 2.93 1.81) 235 — S — 236 (1.31 1.82 2.92) 235 — S — 237 (1.10 3.23 1.51)
235 — S — 239 (0.80 1.39 3.36) 235 — S — 243 (1.84 2.06 2.68) 235 — S — 244 (1.15 2.85 1.90) 235 — S — 245 (1.07 2.62 2.13)
235 — S — 246 (1.41 3.18 1.56) 235 — S — 248 (1.47 3.73 1.01) 235 — S — 249 (0.95 3.57 1.17) 235 — S — 251 (0.91 3.43 1.31)
235 — S — 254 (0.91 2.54 2.20) 235 — S — 255 (1.80 3.40 1.34) 235 — S — 264 (1.19 1.27 3.48) 235 — S — 265 (1.37 3.33 1.42)
235 — S — 266 (1.01 2.90 1.84) 235 — S — 267 (0.81 2.60 2.14) 235 — S — 268 (1.35 3.47 1.27) 235 — S — 269 (1.31 3.40 1.34)
235 — S — 271 (2.06 3.50 1.25) 235 — S — 272 (1.19 1.95 2.79) 235 — S — 277 (0.89 2.67 2.07) 235 — S — 279 (0.95 2.73 2.01)
235 — S — 286 (0.92 2.52 2.22) 235 — S — 289 (0.98 2.31 2.44) 235 — S — 290 (1.01 2.93 1.81) 235 — S — 291 (2.14 3.34 1.40)
235 — S — 292 (1.48 3.00 1.74) 235 — S — 293 (0.98 2.81 1.93) 235 — S — 294 (1.44 2.84 1.90) 235 — S — 295 (1.19 3.08 1.66)
235 — S — 296 (1.47 3.08 1.66) 235 — S — 298 (1.04 2.69 2.06) 235 — S — 300 (1.04 2.08 2.66) 235 — S — 301 (1.09 1.80 2.95)
235 — S — 302 (1.22 1.64 3.10) 235 — S — 303 (0.80 2.06 2.69) 235 — S — 304 (0.84 2.53 2.21) 235 — S — 305 (1.36 2.75 2.00)
235 — S — 306 (1.52 3.40 1.34) 235 — S — 307 (1.25 3.53 1.21) 235 — S — 308 (0.84 1.69 3.05) 235 — S — 310 (0.96 2.14 2.60)
235 — S — 316 (0.84 2.75 2.00) 235 — S — 318 (1.14 1.79 2.95) 235 — S — 320 (1.74 3.82 0.92) 235 — S — 327 (1.13 3.15 1.59)
235 — S — 329 (1.46 3.61 1.13) 235 — S — 331 (0.99 2.33 2.42) 235 — S — 332 (0.84 2.50 2.24) 235 — S — 336 (0.95 2.39 2.35)
235 — S — 338 (1.25 1.16 3.58) 235 — S — 342 (2.89 3.36 1.38) 235 — S — 357 (1.30 1.96 2.79) 235 — S — 367 (1.41 3.30 1.44)
235 — S — 371 (2.57 3.45 1.30) 235 — S — 372 (0.98 2.43 2.31) 235 — S — 395 (1.61 3.15 1.59) 235 — S — 396 (1.03 2.59 2.16)
235 — S — 397 (0.83 2.43 2.31) 235 — S — 432 (0.85 1.92 2.82) 235 — S — 437 (0.95 2.27 2.48) 235 — S — 440 (1.29 3.06 1.69)
235 — S — 441 (1.22 2.98 1.76) 235 — S — 447 (1.23 3.17 1.57) 235 — S — 449 (0.97 3.14 1.60) 235 — S — 451 (1.31 3.75 0.99)
235 — S — 452 (1.37 3.41 1.34) 235 — S — 453 (0.86 2.11 2.63) 235 — S — 457 (0.82 3.05 1.69) 235 — S — 460 (1.10 3.48 1.26)
235 — S — 461 (0.81 3.24 1.50) 235 — S — 471 (1.40 2.72 2.03) 235 — S — 473 (1.44 3.33 1.41) 235 — S — 474 (1.30 3.22 1.52)
236 — S — 46 (0.84 1.26 2.98) 236 — S — 150 (1.17 1.38 2.85) 236 — S — 151 (1.08 1.64 2.59) 236 — S — 152 (1.73 1.94 2.29)
236 — S — 153 (1.11 1.48 2.75) 236 — S — 184 (0.92 0.97 3.26) 236 — S — 291 (0.83 1.52 2.71) 236 — S — 342 (1.58 1.54 2.69)
236 — S — 343 (2.11 2.03 2.20) 236 — S — 371 (1.26 1.63 2.61) 236 — S — 429 (1.67 2.73 1.50) 237 — S — 125 (0.96 1.31 1.30)
237 — S — 429 (1.88 1.32 1.29) 237 — S — 472 (0.87 0.90 1.72) 238 — S — 57 (1.43 1.00 1.05) 238 — S — 165 (0.93 1.09 0.96)
238 — S — 259 (1.26 1.13 0.92) 238 — S — 270 (1.06 0.99 1.06) 238 — S — 364 (1.20 0.89 1.16) 238 — S — 472 (1.58 1.04 1.01)
239 — S — 46 (1.35 1.69 2.47) 239 — S — 57 (1.02 2.71 1.46) 239 — S — 70 (0.81 2.38 1.78) 239 — S — 107 (0.86 1.65 2.51)
239 — S — 111 (0.85 0.94 3.22) 239 — S — 125 (1.26 3.15 1.01) 239 — S — 133 (0.86 1.94 2.22) 239 — S — 150 (1.68 1.81 2.35)
239 — S — 151 (1.59 2.07 2.09) 239 — S — 152 (2.23 2.37 1.79) 239 — S — 153 (1.61 1.92 2.24) 239 — S — 154 (1.14 1.04 3.12)
239 — S — 166 (0.87 0.87 3.29) 239 — S — 184 (1.43 1.41 2.75) 239 — S — 188 (1.01 0.82 3.34) 239 — S — 192 (1.04 1.93 2.23)
239 — S — 195 (0.86 1.25 2.91) 239 — S — 215 (0.84 2.50 1.66) 239 — S — 231 (1.08 2.04 2.12) 239 — S — 255 (0.99 2.02 2.15)
239 — S — 259 (0.85 2.83 1.33) 239 — S — 271 (1.26 2.11 2.05) 239 — S — 291 (1.34 1.95 2.21) 239 — S — 320 (0.93 2.43 1.73)
239 — S — 324 (0.91 2.93 1.23) 239 — S — 342 (2.08 1.97 2.19) 239 — S — 343 (2.61 2.46 1.70) 239 — S — 371 (1.77 2.06 2.10)
239 — S — 395 (0.80 1.76 2.40) 239 — S — 429 (2.17 3.16 1.00) 239 — S — 472 (1.17 2.74 1.42) 240 — S — 43 (0.86 1.84 1.89)
240 — S — 46 (1.45 1.36 2.37) 240 — S — 57 (1.12 2.38 1.35) 240 — S — 70 (0.92 2.05 1.68) 240 — S — 107 (0.96 1.32 2.41)

240 — S — 125 (1.36 2.83 0.90) 240 — S — 133 (0.96 1.61 2.11) 240 — S — 150 (1.78 1.49 2.24) 240 — S — 151 (1.69 1.74 1.98)
240 — S — 152 (2.34 2.04 1.68) 240 — S — 153 (1.72 1.59 2.14) 240 — S — 184 (1.53 1.08 2.65) 240 — S — 192 (1.14 1.60 2.13)
240 — S — 195 (0.96 0.92 2.80) 240 — S — 215 (0.94 2.17 1.56) 240 — S — 231 (1.18 1.71 2.02) 240 — S — 247 (0.84 2.67 1.05)
240 — S — 255 (1.10 1.69 2.04) 240 — S — 259 (0.95 2.50 1.22) 240 — S — 271 (1.36 1.78 1.95) 240 — S — 291 (1.44 1.62 2.10)
240 — S — 306 (0.82 1.69 2.04) 240 — S — 320 (1.04 2.10 1.62) 240 — S — 324 (1.01 2.60 1.13) 240 — S — 342 (2.19 1.64 2.08)
240 — S — 343 (2.72 2.13 1.59) 240 — S — 364 (0.90 2.26 1.46) 240 — S — 368 (0.82 2.13 1.60) 240 — S — 371 (1.87 1.73 2.00)
240 — S — 395 (0.90 1.43 2.29) 240 — S — 472 (1.27 2.41 1.32) 242 — S — 9 (0.82 1.02 2.62) 242 — S — 20 (0.92 1.56 2.07)
242 — S — 27 (0.84 1.73 1.91) 242 — S — 28 (0.90 2.00 1.64) 242 — S — 36 (1.06 2.51 1.13) 242 — S — 43 (1.47 2.37 1.27)
242 — S — 46 (2.07 1.89 1.75) 242 — S — 56 (0.82 1.19 2.45) 242 — S — 61 (0.81 1.71 1.93) 242 — S — 65 (0.82 1.50 2.14)
242 — S — 70 (1.54 2.58 1.06) 242 — S — 79 (0.80 1.88 1.76) 242 — S — 81 (0.83 1.96 1.68) 242 — S — 83 (0.86 1.13 2.50)
242 — S — 85 (1.32 1.69 1.95) 242 — S — 89 (1.29 2.32 1.32) 242 — S — 90 (1.20 2.17 1.47) 242 — S — 101 (0.96 2.02 1.62)
242 — S — 105 (1.12 1.11 2.52) 242 — S — 107 (1.58 1.85 1.79) 242 — S — 108 (1.14 2.24 1.40) 242 — S — 109 (1.38 2.38 1.26)
242 — S — 110 (0.87 2.02 1.62) 242 — S — 111 (1.57 1.14 2.50) 242 — S — 113 (0.98 2.43 1.21) 242 — S — 115 (1.25 1.99 1.65)
242 — S — 118 (0.86 1.41 2.23) 242 — S — 119 (0.83 1.63 2.01) 242 — S — 131 (0.88 1.09 2.55) 242 — S — 133 (1.58 2.14 1.50)
242 — S — 144 (0.92 2.05 1.59) 242 — S — 145 (0.90 2.70 0.94) 242 — S — 150 (2.40 2.01 1.62) 242 — S — 151 (2.31 2.27 1.37)
242 — S — 152 (2.95 2.57 1.07) 242 — S — 153 (2.33 2.12 1.52) 242 — S — 154 (1.87 1.24 2.39) 242 — S — 166 (1.59 1.07 2.57)
242 — S — 171 (1.36 1.07 2.57) 242 — S — 177 (1.41 1.79 1.84) 242 — S — 183 (1.06 2.13 1.51) 242 — S — 184 (2.15 1.61 2.03)
242 — S — 187 (1.30 0.98 2.66) 242 — S — 188 (1.73 1.02 2.62) 242 — S — 192 (1.76 2.13 1.51) 242 — S — 195 (1.58 1.45 2.19)
242 — S — 198 (1.29 1.51 2.13) 242 — S — 205 (0.81 1.57 2.07) 242 — S — 206 (0.81 2.48 1.15) 242 — S — 207 (1.33 2.43 1.21)
242 — S — 213 (1.26 1.47 2.17) 242 — S — 215 (1.56 2.70 0.94) 242 — S — 231 (1.80 2.24 1.40) 242 — S — 233 (1.19 1.66 1.97)
242 — S — 234 (1.01 1.75 1.89) 242 — S — 237 (1.02 2.04 1.60) 242 — S — 243 (1.76 0.87 2.77) 242 — S — 244 (1.07 1.66 1.98)
242 — S — 245 (0.99 1.43 2.21) 242 — S — 246 (1.33 2.00 1.64) 242 — S — 248 (1.39 2.54 1.09) 242 — S — 249 (0.86 2.39 1.25)
242 — S — 251 (0.83 2.24 1.39) 242 — S — 254 (0.83 1.35 2.28) 242 — S — 255 (1.72 2.22 1.42) 242 — S — 260 (0.84 2.67 0.97)
242 — S — 265 (1.29 2.14 1.50) 242 — S — 266 (0.92 1.72 1.92) 242 — S — 268 (1.27 2.29 1.35) 242 — S — 269 (1.23 2.22 1.42)
242 — S — 271 (1.98 2.31 1.33) 242 — S — 277 (0.81 1.48 2.15) 242 — S — 279 (0.86 1.55 2.09) 242 — S — 286 (0.84 1.33 2.31)
242 — S — 289 (0.89 1.12 2.52) 242 — S — 290 (0.92 1.75 1.89) 242 — S — 291 (2.06 2.15 1.49) 242 — S — 292 (1.40 1.81 1.83)
242 — S — 293 (0.90 1.62 2.02) 242 — S — 294 (1.35 1.65 1.98) 242 — S — 295 (1.11 1.90 1.74) 242 — S — 296 (1.39 1.89 1.74)
242 — S — 298 (0.95 1.50 2.14) 242 — S — 300 (0.96 0.90 2.74) 242 — S — 305 (1.28 1.56 2.08) 242 — S — 306 (1.44 2.21 1.42)
242 — S — 307 (1.17 2.34 1.29) 242 — S — 310 (0.87 0.96 2.68) 242 — S — 320 (1.66 2.63 1.00) 242 — S — 327 (1.05 1.96 1.68)
242 — S — 329 (1.38 2.42 1.22) 242 — S — 331 (0.91 1.14 2.50) 242 — S — 336 (0.86 1.20 2.43) 242 — S — 342 (2.80 2.17 1.47)
242 — S — 343 (3.33 2.66 0.97) 242 — S — 367 (1.33 2.12 1.52) 242 — S — 368 (1.44 2.66 0.98) 242 — S — 371 (2.49 2.26 1.38)
242 — S — 372 (0.90 1.25 2.39) 242 — S — 395 (1.52 1.96 1.68) 242 — S — 396 (0.95 1.40 2.24) 242 — S — 437 (0.86 1.08 2.56)
242 — S — 440 (1.21 1.87 1.77) 242 — S — 441 (1.14 1.80 1.84) 242 — S — 447 (1.15 1.98 1.65) 242 — S — 449 (0.89 1.95 1.69)
242 — S — 451 (1.23 2.56 1.08) 242 — S — 452 (1.29 2.22 1.42) 242 — S — 460 (1.01 2.30 1.34) 242 — S — 463 (1.17 2.67 0.97)
242 — S — 471 (1.31 1.53 2.11) 242 — S — 473 (1.36 2.14 1.50) 242 — S — 474 (1.21 2.03 1.61) 243 — S — 152 (1.20 1.70 2.82)
243 — S — 342 (1.05 1.30 3.22) 243 — S — 343 (1.58 1.79 2.73) 243 — S — 429 (1.14 2.49 2.03) 244 — S — 125 (0.91 1.70 1.36)
244 — S — 152 (1.88 0.91 2.14) 244 — S — 343 (2.26 1.01 2.05) 244 — S — 429 (1.82 1.71 1.35) 244 — S — 472 (0.82 1.28 1.77)
245 — S — 125 (0.99 1.92 1.27) 245 — S — 151 (1.32 0.84 2.35) 245 — S — 152 (1.96 1.14 2.06) 245 — S — 231 (0.81 0.81 2.39)
245 — S — 271 (0.99 0.88 2.32) 245 — S — 343 (2.34 1.23 1.96) 245 — S — 371 (1.50 0.83 2.37) 245 — S — 429 (1.90 1.93 1.26)
245 — S — 472 (0.90 1.51 1.69) 246 — S — 429 (1.57 1.37 1.60) 248 — S — 429 (1.50 0.82 1.67) 249 — S — 125 (1.12 0.97 1.15)
249 — S — 250 (0.88 1.09 1.02) 249 — S — 429 (2.03 0.98 1.14) 251 — S — 125 (1.15 1.11 1.12) 251 — S — 250 (0.92 1.24 0.99)
251 — S — 429 (2.06 1.12 1.11) 254 — S — 57 (0.92 1.55 1.56) 254 — S — 125 (1.16 2.00 1.11) 254 — S — 151 (1.48 0.92 2.19)
254 — S — 152 (2.13 1.22 1.89) 254 — S — 231 (0.97 0.89 2.22) 254 — S — 250 (0.92 2.13 0.98) 254 — S — 255 (0.89 0.86 2.25)
254 — S — 271 (1.15 0.95 2.16) 254 — S — 320 (0.83 1.28 1.83) 254 — S — 324 (0.80 1.77 1.34) 254 — S — 342 (1.98 0.82 2.29)
254 — S — 343 (2.51 1.31 1.80) 254 — S — 371 (1.67 0.91 2.20) 254 — S — 429 (2.07 2.01 1.10) 254 — S — 472 (1.06 1.59 1.52)
255 — S — 429 (1.18 1.15 1.99) 256 — S — 9 (1.25 0.97 2.19) 256 — S — 19 (0.82 0.87 2.29) 256 — S — 20 (1.35 1.52 1.64)
256 — S — 27 (1.27 1.68 1.48) 256 — S — 28 (1.33 1.95 1.21) 256 — S — 29 (1.09 1.68 1.48) 256 — S — 40 (0.91 1.68 1.49)
256 — S — 44 (0.98 0.83 2.33) 256 — S — 46 (2.50 1.84 1.32) 256 — S — 56 (1.26 1.15 2.01) 256 — S — 61 (1.24 1.66 1.50)
256 — S — 62 (1.12 1.86 1.30) 256 — S — 65 (1.25 1.45 1.71) 256 — S — 68 (0.96 1.42 1.74) 256 — S — 79 (1.24 1.83 1.33)
256 — S — 80 (1.19 1.79 1.37) 256 — S — 81 (1.26 1.91 1.25) 256 — S — 82 (1.00 2.10 1.06) 256 — S — 83 (1.29 1.09 2.07)
256 — S — 85 (1.75 1.64 1.52) 256 — S — 86 (0.97 2.01 1.15) 256 — S — 90 (1.63 2.12 1.04) 256 — S — 101 (1.39 1.97 1.19)
256 — S — 102 (1.01 0.98 2.18) 256 — S — 105 (1.55 1.07 2.09) 256 — S — 107 (2.01 1.80 1.36) 256 — S — 108 (1.57 2.20 0.96)
256 — S — 110 (1.30 1.97 1.19) 256 — S — 111 (2.00 1.09 2.07) 256 — S — 112 (1.20 1.47 1.69) 256 — S — 115 (1.68 1.94 1.22)
256 — S — 118 (1.29 1.37 1.80) 256 — S — 119 (1.26 1.58 1.58) 256 — S — 123 (0.90 1.71 1.45) 256 — S — 131 (1.31 1.04 2.12)
256 — S — 132 (1.22 1.29 1.87) 256 — S — 133 (2.01 2.09 1.07) 256 — S — 144 (1.35 2.01 1.16) 256 — S — 148 (1.01 0.87 2.29)
256 — S — 150 (2.83 1.97 1.19) 256 — S — 151 (2.74 2.23 0.93) 256 — S — 153 (2.76 2.07 1.09) 256 — S — 154 (2.30 1.20 1.96)
256 — S — 166 (2.02 1.02 2.14) 256 — S — 171 (1.79 1.02 2.14) 256 — S — 177 (1.85 1.75 1.41) 256 — S — 183 (1.49 2.08 1.08)
256 — S — 184 (2.58 1.56 1.60) 256 — S — 187 (1.73 0.93 2.23) 256 — S — 188 (2.16 0.97 2.19) 256 — S — 192 (2.19 2.08 1.08)

256 — S — 193 (1.11 1.24 1.92) 256 — S — 195 (2.01 1.41 1.76) 256 — S — 198 (1.72 1.47 1.70) 256 — S — 205 (1.24 1.53 1.64)
256 — S — 208 (1.21 1.00 2.16) 256 — S — 209 (0.95 1.07 2.09) 256 — S — 213 (1.69 1.42 1.74) 256 — S — 217 (1.11 1.45 1.71)
256 — S — 218 (1.08 1.63 1.53) 256 — S — 219 (0.88 1.19 1.97) 256 — S — 222 (1.00 1.04 2.13) 256 — S — 230 (0.93 0.86 2.30)
256 — S — 231 (2.23 2.19 0.97) 256 — S — 233 (1.62 1.62 1.54) 256 — S — 234 (1.44 1.70 1.46) 256 — S — 237 (1.45 2.00 1.17)
256 — S — 243 (2.19 0.83 2.33) 256 — S — 244 (1.50 1.61 1.55) 256 — S — 245 (1.42 1.38 1.78) 256 — S — 246 (1.76 1.95 1.21)
256 — S — 251 (1.26 2.20 0.96) 256 — S — 254 (1.26 1.31 1.85) 256 — S — 255 (2.15 2.17 0.99) 256 — S — 265 (1.72 2.09 1.07)
256 — S — 266 (1.36 1.67 1.49) 256 — S — 267 (1.16 1.37 1.79) 256 — S — 268 (1.70 2.24 0.92) 256 — S — 269 (1.66 2.17 0.99)
256 — S — 274 (1.02 1.17 1.99) 256 — S — 275 (0.83 1.59 1.57) 256 — S — 277 (1.24 1.44 1.72) 256 — S — 279 (1.30 1.50 1.66)
256 — S — 280 (0.97 1.18 1.98) 256 — S — 282 (1.09 1.01 2.16) 256 — S — 284 (0.87 1.01 2.15) 256 — S — 285 (1.02 1.38 1.78)
256 — S — 286 (1.27 1.29 1.88) 256 — S — 287 (1.08 1.30 1.86) 256 — S — 288 (1.07 1.24 1.93) 256 — S — 289 (1.32 1.07 2.09)
256 — S — 290 (1.35 1.70 1.46) 256 — S — 291 (2.49 2.11 1.05) 256 — S — 292 (1.83 1.77 1.40) 256 — S — 293 (1.33 1.58 1.59)
256 — S — 294 (1.78 1.61 1.55) 256 — S — 295 (1.54 1.85 1.31) 256 — S — 296 (1.82 1.85 1.31) 256 — S — 297 (1.13 0.98 2.18)
256 — S — 298 (1.38 1.45 1.71) 256 — S — 300 (1.39 0.85 2.31) 256 — S — 303 (1.15 0.82 2.34) 256 — S — 304 (1.19 1.30 1.86)
256 — S — 305 (1.71 1.51 1.65) 256 — S — 306 (1.87 2.17 0.99) 256 — S — 310 (1.30 0.91 2.25) 256 — S — 311 (1.03 1.19 1.98)
256 — S — 312 (1.13 1.06 2.10) 256 — S — 313 (0.90 1.23 1.94) 256 — S — 316 (1.19 1.51 1.65) 256 — S — 327 (1.48 1.92 1.25)
256 — S — 330 (0.81 0.92 2.24) 256 — S — 331 (1.34 1.09 2.07) 256 — S — 332 (1.19 1.27 1.89) 256 — S — 336 (1.29 1.16 2.00)
256 — S — 342 (3.23 2.13 1.04) 256 — S — 356 (0.96 0.97 2.19) 256 — S — 358 (1.14 1.43 1.73) 256 — S — 367 (1.76 2.07 1.09)
256 — S — 370 (1.10 1.50 1.66) 256 — S — 371 (2.92 2.21 0.95) 256 — S — 372 (1.33 1.20 1.96) 256 — S — 374 (0.94 1.69 1.47)
256 — S — 379 (1.02 1.20 1.96) 256 — S — 382 (1.09 1.38 1.78) 256 — S — 391 (1.03 1.18 1.98) 256 — S — 395 (1.95 1.91 1.25)
256 — S — 396 (1.38 1.35 1.81) 256 — S — 397 (1.18 1.20 1.96) 256 — S — 415 (1.07 1.08 2.08) 256 — S — 430 (0.96 2.01 1.15)
256 — S — 434 (1.03 1.49 1.67) 256 — S — 435 (1.11 1.66 1.50) 256 — S — 437 (1.30 1.03 2.13) 256 — S — 440 (1.64 1.82 1.34)
256 — S — 441 (1.57 1.75 1.41) 256 — S — 447 (1.58 1.94 1.22) 256 — S — 449 (1.32 1.91 1.25) 256 — S — 450 (0.94 1.57 1.59)
256 — S — 452 (1.72 2.17 0.99) 256 — S — 453 (1.21 0.88 2.28) 256 — S — 454 (1.04 1.04 2.12) 256 — S — 455 (1.02 1.31 1.85)
256 — S — 457 (1.17 1.82 1.34) 256 — S — 459 (0.95 2.05 1.11) 256 — S — 460 (1.44 2.25 0.91) 256 — S — 461 (1.16 2.01 1.15)
256 — S — 462 (0.85 2.02 1.14) 256 — S — 467 (0.85 1.42 1.74) 256 — S — 468 (1.05 1.72 1.44) 256 — S — 469 (1.14 2.15 1.01)
256 — S — 471 (1.74 1.48 1.68) 256 — S — 473 (1.79 2.10 1.07) 256 — S — 474 (1.64 1.98 1.18) 258 — S — 250 (0.97 0.82 0.94)
260 — S — 250 (0.91 0.82 1.00) 261 — S — 43 (1.02 1.93 1.72) 261 — S — 46 (1.62 1.45 2.20) 261 — S — 57 (1.29 2.47 1.18)
261 — S — 70 (1.09 2.14 1.51) 261 — S — 85 (0.87 1.25 2.40) 261 — S — 89 (0.84 1.88 1.77) 261 — S — 93 (0.81 2.62 1.03)
261 — S — 107 (1.13 1.41 2.24) 261 — S — 109 (0.92 1.94 1.71) 261 — S — 133 (1.13 1.70 1.95) 261 — S — 150 (1.95 1.58 2.07)
261 — S — 151 (1.86 1.83 1.82) 261 — S — 152 (2.50 2.13 1.52) 261 — S — 153 (1.88 1.68 1.97) 261 — S — 154 (1.42 0.81 2.85)
261 — S — 177 (0.96 1.36 2.29) 261 — S — 184 (1.70 1.17 2.48) 261 — S — 192 (1.31 1.69 1.96) 261 — S — 195 (1.13 1.01 2.64)
261 — S — 198 (0.84 1.07 2.58) 261 — S — 207 (0.88 1.99 1.66) 261 — S — 213 (0.81 1.03 2.62) 261 — S — 215 (1.11 2.26 1.39)
261 — S — 231 (1.35 1.80 1.85) 261 — S — 246 (0.87 1.56 2.09) 261 — S — 248 (0.94 2.11 1.55) 261 — S — 255 (1.26 1.78 1.87)
261 — S — 259 (1.12 2.59 1.06) 261 — S — 265 (0.84 1.70 1.95) 261 — S — 268 (0.81 1.85 1.80) 261 — S — 270 (0.92 2.46 1.20)
261 — S — 271 (1.53 1.87 1.78) 261 — S — 291 (1.61 1.71 1.94) 261 — S — 292 (0.94 1.37 2.28) 261 — S — 294 (0.90 1.22 2.44)
261 — S — 296 (0.93 1.45 2.20) 261 — S — 305 (0.82 1.12 2.53) 261 — S — 306 (0.98 1.78 1.88) 261 — S — 320 (1.20 2.19 1.46)
261 — S — 324 (1.18 2.69 0.96) 261 — S — 329 (0.93 1.98 1.67) 261 — S — 342 (2.35 1.73 1.92) 261 — S — 343 (2.88 2.23 1.43)
261 — S — 364 (1.06 2.35 1.30) 261 — S — 367 (0.88 1.68 1.97) 261 — S — 368 (0.99 2.22 1.43) 261 — S — 371 (2.04 1.82 1.83)
261 — S — 395 (1.07 1.52 2.13) 261 — S — 452 (0.84 1.78 1.87) 261 — S — 471 (0.86 1.09 2.56) 261 — S — 472 (1.44 2.50 1.15)
261 — S — 473 (0.91 1.70 1.95) 262 — S — 43 (0.92 2.25 1.83) 262 — S — 46 (1.52 1.77 2.30) 262 — S — 57 (1.19 2.79 1.29)
262 — S — 70 (0.98 2.46 1.62) 262 — S — 107 (1.03 1.73 2.34) 262 — S — 109 (0.82 2.26 1.81) 262 — S — 111 (1.02 1.02 3.06)
262 — S — 133 (1.03 2.02 2.05) 262 — S — 150 (1.85 1.90 2.18) 262 — S — 151 (1.76 2.16 1.92) 262 — S — 152 (2.40 2.45 1.62)
262 — S — 153 (1.78 2.00 2.08) 262 — S — 154 (1.31 1.13 2.95) 262 — S — 166 (1.03 0.95 3.12) 262 — S — 171 (0.80 0.95 3.12)
262 — S — 177 (0.86 1.68 2.40) 262 — S — 184 (1.60 1.49 2.59) 262 — S — 188 (1.17 0.90 3.17) 262 — S — 192 (1.20 2.01 2.06)
262 — S — 195 (1.03 1.33 2.74) 262 — S — 215 (1.01 2.58 1.49) 262 — S — 231 (1.25 2.12 1.95) 262 — S — 247 (0.91 3.09 0.99)
262 — S — 248 (0.84 2.43 1.65) 262 — S — 255 (1.16 2.10 1.98) 262 — S — 259 (1.02 2.92 1.16) 262 — S — 270 (0.82 2.78 1.30)
262 — S — 271 (1.43 2.19 1.88) 262 — S — 291 (1.51 2.03 2.04) 262 — S — 292 (0.84 1.69 2.38) 262 — S — 296 (0.83 1.78 2.30)
262 — S — 306 (0.88 2.10 1.98) 262 — S — 320 (1.10 2.52 1.56) 262 — S — 324 (1.08 3.01 1.07) 262 — S — 329 (0.82 2.30 1.77)
262 — S — 342 (2.25 2.05 2.02) 262 — S — 343 (2.78 2.55 1.53) 262 — S — 364 (0.96 2.68 1.40) 262 — S — 368 (0.89 2.54 1.53)
262 — S — 371 (1.94 2.14 1.93) 262 — S — 395 (0.97 1.84 2.23) 262 — S — 472 (1.34 2.82 1.25) 262 — S — 473 (0.81 2.02 2.05)
263 — S — 43 (1.10 2.84 1.65) 263 — S — 46 (1.69 2.36 2.13) 263 — S — 57 (1.36 3.38 1.11) 263 — S — 70 (1.16 3.05 1.44)
263 — S — 85 (0.94 2.16 2.33) 263 — S — 89 (0.92 2.79 1.70) 263 — S — 90 (0.82 2.64 1.85) 263 — S — 93 (0.89 3.53 0.95)
263 — S — 107 (1.20 2.33 2.16) 263 — S — 109 (1.00 2.85 1.64) 263 — S — 111 (1.20 1.61 2.88) 263 — S — 115 (0.87 2.46 2.02)
263 — S — 133 (1.20 2.62 1.87) 263 — S — 150 (2.02 2.49 2.00) 263 — S — 151 (1.93 2.75 1.74) 263 — S — 152 (2.58 3.05 1.44)
263 — S — 153 (1.96 2.59 1.90) 263 — S — 154 (1.49 1.72 2.77) 263 — S — 161 (1.00 1.02 3.47) 263 — S — 165 (0.87 3.46 1.03)
263 — S — 166 (1.21 1.55 2.94) 263 — S — 167 (1.07 1.23 3.26) 263 — S — 170 (1.28 0.96 3.53) 263 — S — 171 (0.98 1.54 2.95)
263 — S — 177 (1.04 2.27 2.22) 263 — S — 184 (1.77 2.08 2.41) 263 — S — 187 (0.92 1.45 3.04) 263 — S — 188 (1.35 1.49 3.00)
263 — S — 189 (1.10 1.08 3.41) 263 — S — 192 (1.38 2.60 1.89) 263 — S — 194 (1.15 1.21 3.28) 263 — S — 195 (1.20 1.93 2.56)

263 — S — 197 (1.35 0.99 3.50) 263 — S — 198 (0.92 1.99 2.50) 263 — S — 207 (0.95 2.91 1.58) 263 — S — 213 (0.88 1.94 2.55) 263 — S — 215 (1.18 3.17 1.32) 263 — S — 231 (1.42 2.71 1.77) 263 — S — 233 (0.81 2.14 2.35) 263 — S — 236 (0.85 1.11 3.38) 263 — S — 243 (1.38 1.35 3.14) 263 — S — 246 (0.95 2.47 2.02) 263 — S — 248 (1.01 3.02 1.47) 263 — S — 255 (1.34 2.69 1.80) 263 — S — 259 (1.20 3.51 0.98) 263 — S — 265 (0.91 2.61 1.88) 263 — S — 268 (0.89 2.76 1.73) 263 — S — 269 (0.85 2.69 1.80) 263 — S — 270 (0.99 3.37 1.12) 263 — S — 271 (1.60 2.78 1.71) 263 — S — 291 (1.69 2.63 1.86) 263 — S — 292 (1.02 2.29 2.20) 263 — S — 294 (0.98 2.13 2.36) 263 — S — 296 (1.01 2.37 2.12) 263 — S — 305 (0.90 2.04 2.45) 263 — S — 306 (1.06 2.69 1.80) 263 — S — 320 (1.28 3.11 1.38) 263 — S — 329 (1.00 2.90 1.59) 263 — S — 342 (2.43 2.65 1.84) 263 — S — 343 (2.96 3.14 1.35) 263 — S — 357 (0.85 1.24 3.25) 263 — S — 364 (1.14 3.27 1.22) 263 — S — 367 (0.95 2.59 1.90) 263 — S — 368 (1.07 3.13 1.36) 263 — S — 371 (2.12 2.74 1.75) 263 — S — 395 (1.15 2.44 2.05) 263 — S — 440 (0.83 2.34 2.15) 263 — S — 451 (0.86 3.04 1.45) 263 — S — 452 (0.91 2.69 1.80) 263 — S — 471 (0.94 2.00 2.49) 263 — S — 472 (1.51 3.41 1.07) 263 — S — 473 (0.98 2.62 1.87) 263 — S — 474 (0.84 2.51 1.98) 264 — S — 46 (0.96 1.81 2.86) 264 — S — 125 (0.87 3.27 1.39) 264 — S — 150 (1.29 1.94 2.73) 264 — S — 151 (1.20 2.19 2.47) 264 — S — 152 (1.85 2.49 2.17) 264 — S — 153 (1.23 2.04 2.63) 264 — S — 184 (1.04 1.53 3.14) 264 — S — 271 (0.87 2.23 2.44) 264 — S — 291 (0.95 2.07 2.59) 264 — S — 342 (1.70 2.09 2.57) 264 — S — 343 (2.23 2.58 2.08) 264 — S — 371 (1.38 2.18 2.48) 264 — S — 429 (1.79 3.28 1.38) 265 — S — 429 (1.61 1.22 1.56) 266 — S — 57 (0.82 1.19 1.66) 266 — S — 125 (1.06 1.64 1.21) 266 — S — 152 (2.03 0.86 1.99) 266 — S — 250 (0.82 1.77 1.08) 266 — S — 343 (2.41 0.95 1.90) 266 — S — 429 (1.97 1.65 1.20) 266 — S — 472 (0.97 1.22 1.62) 267 — S — 57 (1.02 1.49 1.46) 267 — S — 70 (0.81 1.16 1.79) 267 — S — 125 (1.26 1.94 1.01) 267 — S — 151 (1.59 0.86 2.09) 267 — S — 152 (2.23 1.16 1.79) 267 — S — 215 (0.84 1.28 1.67) 267 — S — 231 (1.08 0.82 2.12) 267 — S — 255 (0.99 0.80 2.15) 267 — S — 259 (0.85 1.62 1.33) 267 — S — 271 (1.26 0.89 2.05) 267 — S — 320 (0.93 1.22 1.73) 267 — S — 324 (0.91 1.71 1.24) 267 — S — 343 (2.61 1.25 1.70) 267 — S — 371 (1.77 0.85 2.10) 267 — S — 429 (2.17 1.95 1.00) 267 — S — 472 (1.17 1.52 1.42) 268 — S — 429 (1.63 1.08 1.54) 269 — S — 429 (1.66 1.15 1.51) 271 — S — 429 (0.91 1.05 2.26) 272 — S — 46 (0.96 1.13 2.86) 272 — S — 125 (0.87 2.59 1.39) 272 — S — 150 (1.29 1.25 2.73) 272 — S — 151 (1.20 1.51 2.47) 272 — S — 152 (1.85 1.81 2.17) 272 — S — 153 (1.23 1.35 2.63) 272 — S — 184 (1.04 0.85 3.14) 272 — S — 271 (0.87 1.55 2.44) 272 — S — 291 (0.95 1.39 2.59) 272 — S — 342 (1.70 1.41 2.57) 272 — S — 343 (2.23 1.90 2.08) 272 — S — 371 (1.39 1.50 2.48) 272 — S — 429 (1.79 2.60 1.38) 274 — S — 43 (0.88 1.15 1.86) 274 — S — 57 (1.15 1.69 1.33) 274 — S — 70 (0.95 1.36 1.65) 274 — S — 133 (0.99 0.93 2.09) 274 — S — 151 (1.72 1.06 1.96) 274 — S — 152 (2.36 1.36 1.66) 274 — S — 153 (1.74 0.90 2.11) 274 — S — 192 (1.17 0.91 2.10) 274 — S — 215 (0.97 1.48 1.53) 274 — S — 231 (1.21 1.02 1.99) 274 — S — 247 (0.87 1.99 1.03) 274 — S — 255 (1.12 1.00 2.01) 274 — S — 259 (0.98 1.82 1.20) 274 — S — 271 (1.39 1.09 1.92) 274 — S — 291 (1.47 0.94 2.08) 274 — S — 306 (0.84 1.00 2.02) 274 — S — 320 (1.06 1.42 1.60) 274 — S — 324 (1.04 1.91 1.10) 274 — S — 342 (2.21 0.96 2.06) 274 — S — 343 (2.74 1.45 1.57) 274 — S — 364 (0.92 1.58 1.44) 274 — S — 368 (0.85 1.44 1.57) 274 — S — 371 (1.90 1.04 1.97) 274 — S — 472 (1.30 1.72 1.29) 275 — S — 57 (1.34 1.27 1.13) 275 — S — 70 (1.14 0.94 1.46) 275 — S — 93 (0.87 1.42 0.98) 275 — S — 152 (2.56 0.94 1.46) 275 — S — 165 (0.84 1.35 1.05) 275 — S — 215 (1.16 1.06 1.34) 275 — S — 248 (0.99 0.91 1.49) 275 — S — 259 (1.17 1.40 1.00) 275 — S — 270 (0.97 1.26 1.14) 275 — S — 320 (1.26 1.00 1.40) 275 — S — 324 (1.23 1.49 0.91) 275 — S — 343 (2.94 1.03 1.37) 275 — S — 364 (1.12 1.16 1.24) 275 — S — 368 (1.04 1.02 1.38) 275 — S — 451 (0.83 0.93 1.47) 275 — S — 472 (1.49 1.30 1.10) 276 — S — 43 (0.96 1.74 1.78) 276 — S — 46 (1.56 1.26 2.26) 276 — S — 57 (1.23 2.28 1.25) 276 — S — 70 (1.02 1.95 1.57) 276 — S — 85 (0.81 1.07 2.46) 276 — S — 107 (1.07 1.23 2.30) 276 — S — 109 (0.86 1.75 1.77) 276 — S — 133 (1.07 1.52 2.01) 276 — S — 150 (1.89 1.39 2.14) 276 — S — 151 (1.80 1.65 1.88) 276 — S — 152 (2.44 1.95 1.58) 276 — S — 153 (1.82 1.49 2.03) 276 — S — 177 (0.90 1.17 2.36) 276 — S — 184 (1.64 0.98 2.54) 276 — S — 192 (1.25 1.50 2.02) 276 — S — 195 (1.07 0.83 2.70) 276 — S — 207 (0.81 1.81 1.72) 276 — S — 215 (1.05 2.07 1.45) 276 — S — 231 (1.29 1.62 1.91) 276 — S — 246 (0.81 1.37 2.15) 276 — S — 247 (0.95 2.58 0.95) 276 — S — 248 (0.88 1.92 1.61) 276 — S — 255 (1.20 1.59 1.94) 276 — S — 259 (1.06 2.41 1.12) 276 — S — 270 (0.86 2.27 1.26) 276 — S — 271 (1.47 1.68 1.84) 276 — S — 291 (1.55 1.53 2.00) 276 — S — 292 (0.88 1.19 2.34) 276 — S — 294 (0.84 1.03 2.50) 276 — S — 296 (0.87 1.27 2.26) 276 — S — 306 (0.92 1.59 1.94) 276 — S — 320 (1.14 2.01 1.52) 276 — S — 324 (1.12 2.50 1.02) 276 — S — 329 (0.86 1.80 1.73) 276 — S — 342 (2.29 1.55 1.98) 276 — S — 343 (2.82 2.04 1.49) 276 — S — 364 (1.00 2.17 1.36) 276 — S — 367 (0.82 1.49 2.03) 276 — S — 368 (0.93 2.04 1.49) 276 — S — 371 (1.98 1.64 1.89) 276 — S — 395 (1.01 1.34 2.19) 276 — S — 471 (0.80 0.91 2.62) 276 — S — 472 (1.38 2.32 1.21) 276 — S — 473 (0.85 1.52 2.01) 277 — S — 57 (0.93 1.42 1.54) 277 — S — 125 (1.17 1.87 1.10) 277 — S — 152 (2.14 1.09 1.88) 277 — S — 250 (0.94 2.00 0.97) 277 — S — 271 (1.17 0.82 2.14) 277 — S — 320 (0.85 1.15 1.82) 277 — S — 324 (0.82 1.64 1.32) 277 — S — 343 (2.52 1.18 1.79) 277 — S — 429 (2.08 1.88 1.09) 277 — S — 472 (1.08 1.46 1.51) 278 — S — 20 (1.41 0.91 1.59) 278 — S — 27 (1.32 1.08 1.42) 278 — S — 28 (1.38 1.35 1.15) 278 — S — 29 (1.14 1.07 1.43) 278 — S — 40 (0.97 1.07 1.43) 278 — S — 46 (2.55 1.24 1.27) 278 — S — 61 (1.29 1.05 1.45) 278 — S — 62 (1.17 1.25 1.25) 278 — S — 65 (1.30 0.85 1.65) 278 — S — 68 (1.02 0.81 1.69) 278 — S — 79 (1.29 1.23 1.28) 278 — S — 80 (1.24 1.18 1.32) 278 — S — 81 (1.32 1.31 1.19) 278 — S — 82 (1.05 1.49 1.01) 278 — S — 85 (1.80 1.04 1.46) 278 — S — 86 (1.02 1.41 1.09) 278 — S — 90 (1.69 1.51 0.99) 278 — S — 101 (1.44 1.36 1.14) 278 — S — 107 (2.06 1.20 1.30) 278 — S — 108 (1.62 1.59 0.91) 278 — S — 110 (1.36 1.36 1.14) 278 — S — 112 (1.25 0.86 1.64) 278 — S — 115 (1.73 1.34 1.16) 278 — S — 119 (1.31 0.97 1.53) 278 — S — 123 (0.95 1.10 1.40) 278 — S — 133 (2.07 1.49 1.01) 278 — S — 144 (1.40 1.40 1.10) 278 — S — 147 (0.81 0.97 1.53) 278 — S — 150 (2.89 1.36 1.14) 278 — S — 153 (2.82 1.46 1.04) 278 — S — 177 (1.90 1.14 1.36) 278 — S — 183 (1.55 1.48 1.02) 278 — S — 184 (2.64 0.95 1.55) 278 — S — 192 (2.24 1.47 1.03) 278 — S — 198 (1.78 0.86 1.64) 278 — S — 205 (1.30 0.92 1.58) 278 — S — 213 (1.74 0.81 1.69) 278 — S — 217 (1.17 0.85 1.65) 278 — S — 218 (1.14 1.02 1.48) 278 — S — 231 (2.29 1.59 0.91) 278 — S — 233 (1.67 1.01 1.49) 278 — S — 234 (1.49 1.09 1.41) 278 — S — 237 (1.50 1.39 1.11) 278 — S — 244 (1.56 1.00 1.50)

278 — S — 246 (1.81 1.34 1.16) 278 — S — 251 (1.32 1.59 0.91) 278 — S — 255 (2.20 1.56 0.94) 278 — S — 265 (1.77 1.49 1.02)
278 — S — 266 (1.41 1.06 1.44) 278 — S — 269 (1.72 1.56 0.94) 278 — S — 275 (0.88 0.98 1.52) 278 — S — 277 (1.30 0.83 1.67)
278 — S — 279 (1.35 0.89 1.61) 278 — S — 290 (1.41 1.09 1.41) 278 — S — 291 (2.55 1.50 1.00) 278 — S — 292 (1.88 1.16 1.34)
278 — S — 293 (1.38 0.97 1.53) 278 — S — 294 (1.84 1.00 1.50) 278 — S — 295 (1.59 1.24 1.26) 278 — S — 296 (1.87 1.24 1.26)
278 — S — 298 (1.44 0.85 1.66) 278 — S — 305 (1.76 0.91 1.59) 278 — S — 306 (1.92 1.56 0.94) 278 — S — 316 (1.24 0.91 1.59)
278 — S — 327 (1.53 1.31 1.19) 278 — S — 341 (0.84 1.18 1.32) 278 — S — 342 (3.29 1.52 0.98) 278 — S — 358 (1.19 0.83 1.67)
278 — S — 367 (1.82 1.46 1.04) 278 — S — 370 (1.16 0.89 1.61) 278 — S — 374 (1.00 1.09 1.42) 278 — S — 395 (2.01 1.31 1.19)
278 — S — 430 (1.02 1.41 1.09) 278 — S — 434 (1.08 0.88 1.62) 278 — S — 435 (1.17 1.05 1.45) 278 — S — 440 (1.69 1.22 1.28)
278 — S — 441 (1.62 1.14 1.36) 278 — S — 447 (1.63 1.33 1.17) 278 — S — 449 (1.38 1.30 1.20) 278 — S — 450 (1.00 0.97 1.53)
278 — S — 452 (1.77 1.57 0.93) 278 — S — 457 (1.22 1.21 1.29) 278 — S — 459 (1.01 1.44 1.06) 278 — S — 461 (1.21 1.40 1.10)
278 — S — 462 (0.91 1.42 1.08) 278 — S — 467 (0.90 0.81 1.69) 278 — S — 468 (1.10 1.12 1.38) 278 — S — 469 (1.19 1.55 0.96)
278 — S — 471 (1.80 0.88 1.63) 278 — S — 473 (1.85 1.49 1.01) 278 — S — 474 (1.70 1.38 1.12) 279 — S — 57 (0.88 1.36 1.60)
279 — S — 125 (1.12 1.81 1.15) 279 — S — 152 (2.09 1.03 1.93) 279 — S — 250 (0.88 1.93 1.02) 279 — S — 343 (2.47 1.12 1.84)
279 — S — 429 (2.03 1.82 1.14) 279 — S — 472 (1.02 1.39 1.56) 280 — S — 43 (0.93 1.14 1.82) 280 — S — 57 (1.20 1.68 1.28)
280 — S — 70 (0.99 1.35 1.61) 280 — S — 109 (0.83 1.15 1.80) 280 — S — 133 (1.04 0.92 2.04) 280 — S — 151 (1.77 1.05 1.91)
280 — S — 152 (2.41 1.35 1.61) 280 — S — 153 (1.79 0.89 2.07) 280 — S — 192 (1.21 0.90 2.05) 280 — S — 215 (1.02 1.47 1.49)
280 — S — 231 (1.26 1.01 1.94) 280 — S — 247 (0.92 1.98 0.98) 280 — S — 248 (0.85 1.32 1.64) 280 — S — 255 (1.17 0.99 1.97)
280 — S — 259 (1.03 1.81 1.15) 280 — S — 270 (0.83 1.67 1.29) 280 — S — 271 (1.44 1.08 1.87) 280 — S — 291 (1.52 0.93 2.03)
280 — S — 306 (0.89 0.99 1.97) 280 — S — 320 (1.11 1.41 1.55) 280 — S — 324 (1.09 1.90 1.06) 280 — S — 329 (0.83 1.20 1.76)
280 — S — 342 (2.26 0.95 2.01) 280 — S — 343 (2.79 1.44 1.52) 280 — S — 364 (0.97 1.57 1.39) 280 — S — 368 (0.90 1.43 1.52)
280 — S — 371 (1.95 1.04 1.92) 280 — S — 472 (1.35 1.72 1.24) 280 — S — 473 (0.82 0.92 2.04) 281 — S — 20 (1.73 1.14 1.27)
281 — S — 27 (1.64 1.31 1.10) 281 — S — 29 (1.47 1.30 1.11) 281 — S — 40 (1.29 1.30 1.11) 281 — S — 46 (2.88 1.46 0.94)
281 — S — 61 (1.62 1.28 1.13) 281 — S — 62 (1.49 1.48 0.93) 281 — S — 65 (1.63 1.08 1.33) 281 — S — 68 (1.34 1.04 1.37)
281 — S — 79 (1.61 1.45 0.95) 281 — S — 80 (1.56 1.41 1.00) 281 — S — 85 (2.12 1.26 1.14) 281 — S — 107 (2.39 1.43 0.98)
281 — S — 112 (1.57 1.09 1.32) 281 — S — 118 (1.66 0.99 1.42) 281 — S — 119 (1.63 1.20 1.21) 281 — S — 123 (1.27 1.33 1.08)
281 — S — 132 (1.60 0.91 1.50) 281 — S — 147 (1.13 1.20 1.20) 281 — S — 154 (2.67 0.82 1.59) 281 — S — 177 (2.22 1.37 1.04)
281 — S — 184 (2.96 1.18 1.23) 281 — S — 193 (1.48 0.86 1.54) 281 — S — 195 (2.39 1.03 1.38) 281 — S — 198 (2.10 1.09 1.32)
281 — S — 205 (1.62 1.15 1.26) 281 — S — 213 (2.07 1.04 1.36) 281 — S — 217 (1.49 1.07 1.33) 281 — S — 218 (1.46 1.25 1.15)
281 — S — 219 (1.26 0.81 1.60) 281 — S — 228 (1.00 0.81 1.60) 281 — S — 233 (1.99 1.24 1.17) 281 — S — 234 (1.81 1.32 1.09)
281 — S — 238 (1.12 1.48 0.93) 281 — S — 244 (1.88 1.23 1.17) 281 — S — 245 (1.80 1.01 1.40) 281 — S — 254 (1.63 0.93 1.48)
281 — S — 266 (1.73 1.29 1.12) 281 — S — 267 (1.53 0.99 1.42) 281 — S — 275 (1.20 1.21 1.20) 281 — S — 277 (1.62 1.06 1.35)
281 — S — 279 (1.67 1.12 1.29) 281 — S — 285 (1.39 1.00 1.40) 281 — S — 286 (1.65 0.91 1.50) 281 — S — 287 (1.45 0.92 1.49)
281 — S — 288 (1.44 0.86 1.55) 281 — S — 290 (1.73 1.32 1.09) 281 — S — 292 (2.20 1.39 1.02) 281 — S — 293 (1.71 1.20 1.21)
281 — S — 294 (2.16 1.23 1.18) 281 — S — 295 (1.91 1.47 0.93) 281 — S — 296 (2.19 1.47 0.94) 281 — S — 298 (1.76 1.07 1.33)
281 — S — 299 (1.02 1.41 0.99) 281 — S — 304 (1.57 0.92 1.49) 281 — S — 305 (2.08 1.13 1.27) 281 — S — 311 (1.40 0.81 1.60)
281 — S — 313 (1.28 0.85 1.56) 281 — S — 316 (1.57 1.13 1.27) 281 — S — 332 (1.57 0.89 1.52) 281 — S — 341 (1.17 1.41 1.00)
281 — S — 358 (1.51 1.05 1.35) 281 — S — 370 (1.48 1.12 1.29) 281 — S — 372 (1.71 0.82 1.59) 281 — S — 373 (1.10 0.83 1.58)
281 — S — 374 (1.32 1.31 1.09) 281 — S — 379 (1.39 0.82 1.59) 281 — S — 381 (0.96 0.99 1.42) 281 — S — 382 (1.46 1.00 1.41)
281 — S — 391 (1.40 0.80 1.60) 281 — S — 396 (1.75 0.97 1.43) 281 — S — 397 (1.56 0.82 1.59) 281 — S — 434 (1.40 1.11 1.30)
281 — S — 435 (1.49 1.28 1.13) 281 — S — 440 (2.01 1.44 0.96) 281 — S — 441 (1.94 1.37 1.04) 281 — S — 450 (1.32 1.19 1.21)
281 — S — 455 (1.39 0.93 1.47) 281 — S — 457 (1.54 1.44 0.97) 281 — S — 458 (1.09 1.23 1.17) 281 — S — 467 (1.22 1.04 1.37)
281 — S — 468 (1.42 1.34 1.06) 281 — S — 471 (2.12 1.10 1.30) 282 — S — 43 (0.81 1.32 1.93) 282 — S — 46 (1.41 0.84 2.41)
282 — S — 57 (1.08 1.85 1.40) 282 — S — 70 (0.87 1.53 1.72) 282 — S — 125 (1.32 2.30 0.95) 282 — S — 133 (0.92 1.09 2.16)
282 — S — 150 (1.74 0.96 2.29) 282 — S — 151 (1.65 1.22 2.03) 282 — S — 152 (2.29 1.52 1.73) 282 — S — 153 (1.67 1.06 2.18)
282 — S — 192 (1.10 1.08 2.17) 282 — S — 215 (0.90 1.65 1.60) 282 — S — 231 (1.14 1.19 2.06) 282 — S — 255 (1.05 1.16 2.09)
282 — S — 259 (0.91 1.98 1.27) 282 — S — 271 (1.32 1.26 1.99) 282 — S — 291 (1.40 1.10 2.15) 282 — S — 320 (0.99 1.58 1.67)
282 — S — 324 (0.97 2.07 1.17) 282 — S — 342 (2.14 1.12 2.13) 282 — S — 343 (2.67 1.61 1.64) 282 — S — 364 (0.85 1.74 1.51)
282 — S — 371 (1.83 1.21 2.04) 282 — S — 395 (0.86 0.91 2.34) 282 — S — 429 (2.23 2.31 0.94) 282 — S — 472 (1.23 1.89 1.36)
283 — S — 20 (1.61 0.91 1.39) 283 — S — 27 (1.52 1.08 1.22) 283 — S — 28 (1.59 1.35 0.95) 283 — S — 29 (1.35 1.07 1.23)
283 — S — 40 (1.17 1.07 1.23) 283 — S — 46 (2.76 1.24 1.06) 283 — S — 61 (1.50 1.06 1.24) 283 — S — 62 (1.37 1.26 1.05)
283 — S — 65 (1.51 0.85 1.45) 283 — S — 68 (1.22 0.81 1.49) 283 — S — 79 (1.49 1.23 1.07) 283 — S — 80 (1.44 1.19 1.12)
283 — S — 81 (1.52 1.31 0.99) 283 — S — 85 (2.01 1.04 1.26) 283 — S — 101 (1.64 1.37 0.93) 283 — S — 107 (2.27 1.20 1.10)
283 — S — 110 (1.56 1.37 0.93) 283 — S — 112 (1.45 0.86 1.44) 283 — S — 115 (1.93 1.34 0.96) 283 — S — 119 (1.51 0.98 1.32)
283 — S — 123 (1.15 1.11 1.20) 283 — S — 147 (1.01 0.98 1.32) 283 — S — 150 (3.09 1.36 0.94) 283 — S — 177 (2.10 1.14 1.16)
283 — S — 184 (2.84 0.96 1.34) 283 — S — 195 (2.27 0.80 1.50) 283 — S — 198 (1.98 0.86 1.44) 283 — S — 205 (1.50 0.92 1.38)
283 — S — 213 (1.95 0.82 1.48) 283 — S — 217 (1.37 0.85 1.45) 283 — S — 218 (1.34 1.03 1.27) 283 — S — 233 (1.87 1.01 1.29)
283 — S — 234 (1.69 1.10 1.20) 283 — S — 237 (1.70 1.39 0.91) 283 — S — 238 (1.00 1.25 1.05) 283 — S — 244 (1.76 1.01 1.29)
283 — S — 246 (2.01 1.35 0.95) 283 — S — 266 (1.61 1.07 1.24) 283 — S — 275 (1.09 0.99 1.31) 283 — S — 277 (1.50 0.83 1.47)

283 — S — 279 (1.55 0.90 1.41) 283 — S — 290 (1.61 1.10 1.20) 283 — S — 292 (2.08 1.16 1.14) 283 — S — 293 (1.59 0.97 1.33) 283 — S — 294 (2.04 1.00 1.30) 283 — S — 295 (1.79 1.25 1.05) 283 — S — 296 (2.07 1.24 1.06) 283 — S — 298 (1.64 0.85 1.45) 283 — S — 299 (0.90 1.19 1.11) 283 — S — 305 (1.96 0.91 1.39) 283 — S — 316 (1.45 0.91 1.39) 283 — S — 327 (1.74 1.31 0.99) 283 — S — 341 (1.05 1.18 1.12) 283 — S — 358 (1.39 0.83 1.47) 283 — S — 370 (1.36 0.90 1.41) 283 — S — 374 (1.20 1.09 1.21) 283 — S — 395 (2.21 1.31 0.99) 283 — S — 434 (1.29 0.88 1.42) 283 — S — 435 (1.37 1.05 1.25) 283 — S — 440 (1.90 1.22 1.08) 283 — S — 441 (1.83 1.15 1.15) 283 — S — 447 (1.84 1.33 0.97) 283 — S — 449 (1.58 1.30 1.00) 283 — S — 450 (1.20 0.97 1.33) 283 — S — 457 (1.42 1.21 1.09) 283 — S — 458 (0.97 1.01 1.29) 283 — S — 467 (1.11 0.82 1.49) 283 — S — 468 (1.30 1.12 1.18) 283 — S — 471 (2.00 0.88 1.42) 283 — S — 474 (1.90 1.38 0.92) 284 — S — 43 (1.03 1.31 1.71) 284 — S — 46 (1.63 0.83 2.19) 284 — S — 57 (1.30 1.85 1.17) 284 — S — 70 (1.10 1.52 1.50) 284 — S — 89 (0.85 1.26 1.76) 284 — S — 93 (0.82 2.00 1.02) 284 — S — 109 (0.93 1.32 1.70) 284 — S — 115 (0.80 0.93 2.09) 284 — S — 133 (1.14 1.08 1.94) 284 — S — 150 (1.96 0.96 2.07) 284 — S — 151 (1.87 1.21 1.81) 284 — S — 152 (2.51 1.51 1.51) 284 — S — 153 (1.89 1.06 1.96) 284 — S — 165 (0.80 1.93 1.09) 284 — S — 192 (1.32 1.07 1.95) 284 — S — 207 (0.89 1.37 1.65) 284 — S — 215 (1.12 1.64 1.38) 284 — S — 231 (1.36 1.18 1.84) 284 — S — 246 (0.88 0.94 2.08) 284 — S — 248 (0.95 1.49 1.54) 284 — S — 255 (1.27 1.16 1.86) 284 — S — 259 (1.13 1.97 1.05) 284 — S — 265 (0.84 1.08 1.94) 284 — S — 268 (0.82 1.23 1.79) 284 — S — 270 (0.93 1.84 1.19) 284 — S — 271 (1.54 1.25 1.77) 284 — S — 291 (1.62 1.09 1.93) 284 — S — 296 (0.94 0.83 2.19) 284 — S — 306 (0.99 1.16 1.87) 284 — S — 320 (1.21 1.57 1.45) 284 — S — 324 (1.19 2.07 0.95) 284 — S — 329 (0.93 1.36 1.66) 284 — S — 342 (2.36 1.11 1.91) 284 — S — 343 (2.89 1.61 1.42) 284 — S — 364 (1.07 1.73 1.29) 284 — S — 367 (0.89 1.06 1.96) 284 — S — 368 (1.00 1.60 1.42) 284 — S — 371 (2.05 1.20 1.82) 284 — S — 395 (1.08 0.90 2.12) 284 — S — 452 (0.85 1.16 1.86) 284 — S — 472 (1.45 1.88 1.14) 284 — S — 473 (0.92 1.08 1.94) 285 — S — 43 (0.89 0.94 1.86) 285 — S — 57 (1.15 1.48 1.32) 285 — S — 70 (0.95 1.15 1.65) 285 — S — 151 (1.72 0.85 1.95) 285 — S — 152 (2.37 1.14 1.65) 285 — S — 215 (0.97 1.27 1.53) 285 — S — 231 (1.21 0.81 1.99) 285 — S — 247 (0.87 1.77 1.02) 285 — S — 248 (0.80 1.12 1.68) 285 — S — 259 (0.98 1.61 1.19) 285 — S — 271 (1.39 0.88 1.92) 285 — S — 320 (1.07 1.21 1.59) 285 — S — 324 (1.04 1.70 1.10) 285 — S — 343 (2.75 1.24 1.56) 285 — S — 364 (0.93 1.37 1.43) 285 — S — 368 (0.85 1.23 1.57) 285 — S — 371 (1.90 0.83 1.97) 285 — S — 472 (1.30 1.51 1.29) 286 — S — 57 (0.90 1.57 1.57) 286 — S — 125 (1.14 2.02 1.13) 286 — S — 151 (1.47 0.94 2.21) 286 — S — 152 (2.11 1.24 1.91) 286 — S — 231 (0.96 0.91 2.24) 286 — S — 250 (0.91 2.15 1.00) 286 — S — 255 (0.88 0.88 2.26) 286 — S — 271 (1.14 0.98 2.17) 286 — S — 291 (1.22 0.82 2.33) 286 — S — 320 (0.82 1.30 1.85) 286 — S — 342 (1.96 0.84 2.31) 286 — S — 343 (2.49 1.33 1.82) 286 — S — 371 (1.65 0.93 2.22) 286 — S — 429 (2.05 2.03 1.12) 286 — S — 472 (1.05 1.61 1.54) 287 — S — 43 (0.82 1.02 1.92) 287 — S — 57 (1.09 1.56 1.38) 287 — S — 70 (0.89 1.23 1.71) 287 — S — 125 (1.33 2.01 0.93) 287 — S — 151 (1.66 0.93 2.01) 287 — S — 152 (2.31 1.23 1.71) 287 — S — 215 (0.91 1.35 1.59) 287 — S — 231 (1.15 0.90 2.05) 287 — S — 247 (0.81 1.86 1.08) 287 — S — 255 (1.07 0.87 2.07) 287 — S — 259 (0.92 1.69 1.25) 287 — S — 271 (1.33 0.96 1.98) 287 — S — 291 (1.41 0.81 2.13) 287 — S — 320 (1.01 1.29 1.65) 287 — S — 324 (0.98 1.78 1.16) 287 — S — 342 (2.16 0.83 2.11) 287 — S — 343 (2.68 1.32 1.62) 287 — S — 364 (0.86 1.45 1.49) 287 — S — 371 (1.84 0.92 2.03) 287 — S — 429 (2.25 2.02 0.92) 287 — S — 472 (1.24 1.60 1.35) 288 — S — 43 (0.84 1.08 1.91) 288 — S — 57 (1.11 1.62 1.37) 288 — S — 70 (0.90 1.29 1.70) 288 — S — 125 (1.35 2.07 0.92) 288 — S — 133 (0.95 0.86 2.13) 288 — S — 151 (1.68 0.99 2.00) 288 — S — 152 (2.32 1.29 1.70) 288 — S — 153 (1.70 0.83 2.16) 288 — S — 192 (1.12 0.85 2.15) 288 — S — 215 (0.93 1.41 1.58) 288 — S — 231 (1.17 0.96 2.03) 288 — S — 247 (0.83 1.92 1.07) 288 — S — 255 (1.08 0.93 2.06) 288 — S — 259 (0.94 1.75 1.24) 288 — S — 271 (1.35 1.03 1.96) 288 — S — 291 (1.43 0.87 2.12) 288 — S — 306 (0.80 0.93 2.06) 288 — S — 320 (1.02 1.35 1.64) 288 — S — 324 (1.00 1.84 1.15) 288 — S — 342 (2.17 0.89 2.10) 288 — S — 343 (2.70 1.38 1.61) 288 — S — 364 (0.88 1.51 1.48) 288 — S — 368 (0.81 1.38 1.61) 288 — S — 371 (1.86 0.98 2.01) 288 — S — 429 (2.26 2.08 0.91) 288 — S — 472 (1.26 1.66 1.33) 289 — S — 57 (0.85 1.78 1.63) 289 — S — 125 (1.09 2.23 1.18) 289 — S — 150 (1.51 0.89 2.52) 289 — S — 151 (1.42 1.15 2.26) 289 — S — 152 (2.06 1.45 1.96) 289 — S — 153 (1.44 0.99 2.42) 289 — S — 192 (0.86 1.01 2.40) 289 — S — 231 (0.91 1.12 2.29) 289 — S — 250 (0.86 2.36 1.05) 289 — S — 255 (0.82 1.09 2.32) 289 — S — 271 (1.09 1.19 2.22) 289 — S — 291 (1.17 1.03 2.38) 289 — S — 342 (1.91 1.05 2.36) 289 — S — 343 (2.44 1.54 1.87) 289 — S — 371 (1.60 1.14 2.27) 289 — S — 429 (2.00 2.24 1.17) 289 — S — 472 (1.00 1.82 1.59) 290 — S — 57 (0.82 1.16 1.66) 290 — S — 125 (1.06 1.61 1.21) 290 — S — 152 (2.03 0.83 1.99) 290 — S — 250 (0.82 1.73 1.08) 290 — S — 343 (2.41 0.92 1.90) 290 — S — 429 (1.97 1.62 1.20) 290 — S — 472 (0.97 1.19 1.62) 291 — S — 429 (0.83 1.21 2.34) 292 — S — 343 (1.94 0.85 2.37) 292 — S — 429 (1.50 1.55 1.67) 293 — S — 57 (0.84 1.28 1.63) 293 — S — 125 (1.08 1.73 1.18) 293 — S — 152 (2.05 0.95 1.97) 293 — S — 250 (0.85 1.86 1.06) 293 — S — 343 (2.43 1.04 1.87) 293 — S — 429 (1.99 1.74 1.18) 293 — S — 472 (0.99 1.32 1.60) 294 — S — 152 (1.60 0.92 2.42) 294 — S — 343 (1.98 1.01 2.33) 294 — S — 429 (1.54 1.71 1.63) 295 — S — 125 (0.87 1.46 1.39) 295 — S — 429 (1.79 1.47 1.38) 296 — S — 429 (1.51 1.47 1.66) 297 — S — 46 (1.37 0.86 2.45) 297 — S — 57 (1.04 1.88 1.43) 297 — S — 70 (0.84 1.55 1.76) 297 — S — 107 (0.88 0.83 2.48) 297 — S — 125 (1.28 2.33 0.98) 297 — S — 133 (0.88 1.12 2.19) 297 — S — 150 (1.70 0.99 2.32) 297 — S — 151 (1.61 1.25 2.06) 297 — S — 152 (2.26 1.55 1.76) 297 — S — 153 (1.64 1.09 2.22) 297 — S — 192 (1.06 1.10 2.21) 297 — S — 215 (0.86 1.67 1.64) 297 — S — 231 (1.10 1.22 2.10) 297 — S — 255 (1.02 1.19 2.12) 297 — S — 259 (0.87 2.01 1.30) 297 — S — 271 (1.28 1.28 2.03) 297 — S — 291 (1.36 1.13 2.18) 297 — S — 320 (0.96 1.61 1.70) 297 — S — 324 (0.93 2.10 1.21) 297 — S — 342 (2.11 1.15 2.16) 297 — S — 343 (2.64 1.64 1.67) 297 — S — 364 (0.82 1.77 1.54) 297 — S — 371 (1.79 1.24 2.07) 297 — S — 395 (0.83 0.94 2.37) 297 — S — 429 (2.20 2.34 0.97) 297 — S — 472 (1.19 1.92 1.40) 298 — S — 125 (1.03 1.86 1.24) 298 — S — 152 (2.00 1.07 2.02) 298 — S — 271 (1.03 0.81 2.28) 298 — S — 343 (2.38 1.17 1.93) 298 — S — 429 (1.94 1.86 1.23) 298 — S — 472 (0.94 1.44 1.65) 299 — S — 37 (0.84 0.97 1.04) 299 — S — 57 (1.53 1.07 0.95) 299 — S — 215 (1.35 0.86 1.15) 299 — S — 270 (1.16 1.06 0.96) 299 — S — 343 (3.12 0.83 1.19) 299 — S — 364 (1.30 0.95 1.06) 299 — S — 368 (1.23 0.82 1.19) 299 — S — 463 (0.95 0.83 1.19)

299 — S — 472 (1.68 1.10 0.91) 300 — S — 46 (1.11 0.99 2.71) 300 — S — 125 (1.02 2.46 1.24) 300 — S — 150 (1.44 1.12 2.58) 300 — S — 151 (1.35 1.38 2.33) 300 — S — 152 (1.99 1.67 2.03) 300 — S — 153 (1.37 1.22 2.48) 300 — S — 231 (0.84 1.34 2.36) 300 — S — 271 (1.02 1.41 2.29) 300 — S — 291 (1.10 1.26 2.45) 300 — S — 342 (1.84 1.27 2.43) 300 — S — 343 (2.37 1.77 1.93) 300 — S — 371 (1.53 1.36 2.34) 300 — S — 429 (1.93 2.47 1.24) 300 — S — 472 (0.93 2.04 1.66) 301 — S — 46 (1.06 1.28 2.76) 301 — S — 125 (0.97 2.75 1.30) 301 — S — 150 (1.39 1.41 2.64) 301 — S — 151 (1.30 1.66 2.38) 301 — S — 152 (1.94 1.96 2.08) 301 — S — 153 (1.32 1.51 2.53) 301 — S — 184 (1.14 1.00 3.04) 301 — S — 271 (0.97 1.70 2.34) 301 — S — 291 (1.05 1.54 2.50) 301 — S — 342 (1.79 1.56 2.48) 301 — S — 343 (2.32 2.06 1.99) 301 — S — 371 (1.48 1.65 2.39) 301 — S — 429 (1.88 2.75 1.29) 301 — S — 472 (0.88 2.33 1.71) 302 — S — 46 (0.94 1.43 2.88) 302 — S — 125 (0.85 2.90 1.42) 302 — S — 150 (1.27 1.56 2.76) 302 — S — 151 (1.18 1.82 2.50) 302 — S — 152 (1.82 2.12 2.20) 302 — S — 153 (1.20 1.66 2.66) 302 — S — 184 (1.02 1.15 3.16) 302 — S — 271 (0.85 1.85 2.46) 302 — S — 291 (0.93 1.70 2.62) 302 — S — 342 (1.67 1.72 2.60) 302 — S — 343 (2.20 2.21 2.11) 302 — S — 371 (1.36 1.80 2.51) 302 — S — 429 (1.76 2.91 1.41) 303 — S — 46 (1.35 1.02 2.47) 303 — S — 57 (1.02 2.03 1.45) 303 — S — 70 (0.82 1.71 1.78) 303 — S — 107 (0.86 0.98 2.51) 303 — S — 125 (1.26 2.48 1.00) 303 — S — 133 (0.86 1.27 2.22) 303 — S — 150 (1.68 1.14 2.34) 303 — S — 151 (1.59 1.40 2.08) 303 — S — 152 (2.23 1.70 1.78) 303 — S — 153 (1.62 1.25 2.24) 303 — S — 192 (1.04 1.26 2.23) 303 — S — 215 (0.84 1.83 1.66) 303 — S — 231 (1.08 1.37 2.12) 303 — S — 255 (1.00 1.34 2.14) 303 — S — 259 (0.85 2.16 1.32) 303 — S — 271 (1.26 1.44 2.05) 303 — S — 291 (1.34 1.28 2.20) 303 — S — 320 (0.94 1.76 1.72) 303 — S — 324 (0.91 2.26 1.23) 303 — S — 342 (2.09 1.30 2.19) 303 — S — 343 (2.61 1.79 1.69) 303 — S — 371 (1.77 1.39 2.10) 303 — S — 395 (0.80 1.09 2.40) 303 — S — 429 (2.18 2.49 0.99) 303 — S — 472 (1.17 2.07 1.42) 304 — S — 57 (0.98 1.56 1.49) 304 — S — 125 (1.22 2.01 1.04) 304 — S — 151 (1.55 0.93 2.13) 304 — S — 152 (2.19 1.23 1.83) 304 — S — 231 (1.04 0.90 2.16) 304 — S — 250 (0.99 2.14 0.92) 304 — S — 255 (0.96 0.87 2.18) 304 — S — 259 (0.81 1.69 1.36) 304 — S — 271 (1.22 0.96 2.09) 304 — S — 291 (1.30 0.81 2.25) 304 — S — 320 (0.90 1.29 1.76) 304 — S — 324 (0.87 1.78 1.27) 304 — S — 342 (2.04 0.83 2.23) 304 — S — 343 (2.57 1.32 1.73) 304 — S — 371 (1.73 0.92 2.14) 304 — S — 429 (2.13 2.02 1.04) 304 — S — 472 (1.13 1.60 1.46) 305 — S — 152 (1.68 1.01 2.34) 305 — S — 343 (2.06 1.10 2.25) 305 — S — 429 (1.62 1.80 1.55) 306 — S — 429 (1.46 1.15 1.71) 307 — S — 125 (0.82 1.01 1.45) 307 — S — 429 (1.73 1.02 1.44) 308 — S — 46 (1.32 1.38 2.50) 308 — S — 57 (0.99 2.40 1.49) 308 — S — 107 (0.83 1.35 2.54) 308 — S — 125 (1.23 2.85 1.04) 308 — S — 133 (0.83 1.64 2.25) 308 — S — 150 (1.65 1.51 2.38) 308 — S — 151 (1.56 1.77 2.12) 308 — S — 152 (2.20 2.07 1.82) 308 — S — 153 (1.58 1.61 2.28) 308 — S — 184 (1.40 1.10 2.78) 308 — S — 192 (1.00 1.62 2.26) 308 — S — 195 (0.83 0.95 2.94) 308 — S — 215 (0.81 2.19 1.69) 308 — S — 231 (1.05 1.73 2.15) 308 — S — 250 (1.00 2.98 0.91) 308 — S — 255 (0.96 1.71 2.18) 308 — S — 259 (0.82 2.53 1.36) 308 — S — 271 (1.23 1.80 2.08) 308 — S — 291 (1.31 1.65 2.24) 308 — S — 320 (0.90 2.13 1.76) 308 — S — 324 (0.88 2.62 1.27) 308 — S — 342 (2.05 1.67 2.22) 308 — S — 343 (2.58 2.16 1.73) 308 — S — 371 (1.74 1.76 2.13) 308 — S — 429 (2.14 2.86 1.03) 308 — S — 472 (1.14 2.43 1.45) 310 — S — 46 (1.20 0.93 2.62) 310 — S — 57 (0.87 1.95 1.61) 310 — S — 125 (1.11 2.40 1.16) 310 — S — 150 (1.53 1.06 2.50) 310 — S — 151 (1.44 1.32 2.24) 310 — S — 152 (2.08 1.62 1.94) 310 — S — 153 (1.46 1.16 2.40) 310 — S — 192 (0.88 1.17 2.38) 310 — S — 231 (0.93 1.28 2.27) 310 — S — 250 (0.87 2.53 1.03) 310 — S — 255 (0.84 1.26 2.30) 310 — S — 271 (1.11 1.35 2.20) 310 — S — 291 (1.19 1.20 2.36) 310 — S — 342 (1.93 1.22 2.34) 310 — S — 343 (2.46 1.71 1.85) 310 — S — 371 (1.62 1.31 2.25) 310 — S — 429 (2.02 2.41 1.15) 310 — S — 472 (1.02 1.98 1.57) 311 — S — 43 (0.88 1.13 1.87) 311 — S — 57 (1.14 1.67 1.33) 311 — S — 70 (0.94 1.34 1.66) 311 — S — 133 (0.98 0.91 2.09) 311 — S — 151 (1.71 1.04 1.96) 311 — S — 152 (2.36 1.34 1.66) 311 — S — 153 (1.74 0.88 2.12) 311 — S — 192 (1.16 0.90 2.11) 311 — S — 215 (0.96 1.47 1.54) 311 — S — 231 (1.20 1.01 2.00) 311 — S — 247 (0.86 1.97 1.03) 311 — S — 255 (1.12 0.98 2.02) 311 — S — 259 (0.97 1.80 1.20) 311 — S — 271 (1.38 1.08 1.93) 311 — S — 291 (1.46 0.92 2.08) 311 — S — 306 (0.84 0.98 2.02) 311 — S — 320 (1.06 1.40 1.60) 311 — S — 324 (1.03 1.89 1.11) 311 — S — 342 (2.21 0.94 2.06) 311 — S — 343 (2.74 1.43 1.57) 311 — S — 364 (0.92 1.56 1.44) 311 — S — 368 (0.85 1.43 1.58) 311 — S — 371 (1.89 1.03 1.97) 311 — S — 472 (1.29 1.71 1.30) 312 — S — 57 (1.05 1.80 1.43) 312 — S — 70 (0.84 1.47 1.76) 312 — S — 125 (1.29 2.25 0.98) 312 — S — 133 (0.89 1.04 2.19) 312 — S — 150 (1.71 0.91 2.32) 312 — S — 151 (1.61 1.17 2.06) 312 — S — 152 (2.26 1.47 1.76) 312 — S — 153 (1.64 1.01 2.22) 312 — S — 192 (1.06 1.02 2.21) 312 — S — 215 (0.86 1.59 1.64) 312 — S — 231 (1.10 1.14 2.09) 312 — S — 255 (1.02 1.11 2.12) 312 — S — 259 (0.88 1.93 1.30) 312 — S — 271 (1.28 1.20 2.03) 312 — S — 291 (1.37 1.05 2.18) 312 — S — 320 (0.96 1.53 1.70) 312 — S — 324 (0.93 2.02 1.21) 312 — S — 342 (2.11 1.07 2.16) 312 — S — 343 (2.64 1.56 1.67) 312 — S — 364 (0.82 1.69 1.54) 312 — S — 371 (1.80 1.16 2.07) 312 — S — 395 (0.83 0.86 2.37) 312 — S — 429 (2.20 2.26 0.97) 312 — S — 472 (1.19 1.84 1.39) 313 — S — 43 (1.00 1.09 1.74) 313 — S — 57 (1.27 1.63 1.21) 313 — S — 70 (1.06 1.30 1.53) 313 — S — 89 (0.82 1.04 1.80) 313 — S — 109 (0.90 1.11 1.73) 313 — S — 133 (1.11 0.87 1.97) 313 — S — 151 (1.84 1.00 1.84) 313 — S — 152 (2.48 1.30 1.54) 313 — S — 153 (1.86 0.84 2.00) 313 — S — 192 (1.28 0.86 1.98) 313 — S — 207 (0.85 1.16 1.68) 313 — S — 215 (1.09 1.43 1.41) 313 — S — 231 (1.33 0.97 1.87) 313 — S — 247 (0.99 1.93 0.91) 313 — S — 248 (0.92 1.27 1.57) 313 — S — 255 (1.24 0.94 1.90) 313 — S — 259 (1.10 1.76 1.08) 313 — S — 265 (0.81 0.87 1.97) 313 — S — 270 (0.90 1.62 1.22) 313 — S — 271 (1.51 1.04 1.80) 313 — S — 291 (1.59 0.88 1.96) 313 — S — 306 (0.96 0.94 1.90) 313 — S — 320 (1.18 1.36 1.48) 313 — S — 324 (1.16 1.85 0.99) 313 — S — 329 (0.90 1.15 1.69) 313 — S — 342 (2.33 0.90 1.94) 313 — S — 343 (2.86 1.39 1.45) 313 — S — 364 (1.04 1.52 1.32) 313 — S — 367 (0.86 0.84 2.00) 313 — S — 368 (0.97 1.39 1.45) 313 — S — 371 (2.02 0.99 1.85) 313 — S — 452 (0.82 0.95 1.89) 313 — S — 472 (1.42 1.67 1.17) 313 — S — 473 (0.89 0.87 1.97) 314 — S — 9 (1.54 1.08 1.90) 314 — S — 19 (1.11 0.98 2.00) 314 — S — 20 (1.64 1.63 1.35) 314 — S — 27 (1.55 1.80 1.19) 314 — S — 28 (1.62 2.07 0.92) 314 — S — 29 (1.38 1.79 1.20) 314 — S — 31 (0.81 0.96 2.03) 314 — S — 32 (0.89 0.81 2.18) 314 — S — 33 (0.84 0.84 2.14) 314 — S — 38 (1.00 1.22 1.76) 314 — S — 40 (1.20 1.79 1.20) 314 — S — 44 (1.27 0.95 2.04) 314 — S — 46 (2.79 1.95 1.03) 314 — S — 56 (1.54 1.26 1.73) 314 — S — 60 (0.83 0.87 2.11) 314 — S — 61 (1.53 1.77 1.21)

314 — S — 62 (1.41 1.97 1.01) 314 — S — 65 (1.54 1.57 1.42) 314 — S — 68 (1.25 1.53 1.45) 314 — S — 79 (1.52 1.94 1.04)
314 — S — 80 (1.48 1.90 1.08) 314 — S — 81 (1.55 2.02 0.96) 314 — S — 83 (1.58 1.20 1.79) 314 — S — 85 (2.04 1.75 1.23)
314 — S — 101 (1.68 2.08 0.90) 314 — S — 102 (1.30 1.09 1.89) 314 — S — 105 (1.84 1.18 1.81) 314 — S — 107 (2.30 1.92 1.07)
314 — S — 110 (1.59 2.08 0.90) 314 — S — 111 (2.29 1.20 1.78) 314 — S — 112 (1.49 1.58 1.41) 314 — S — 114 (1.13 0.85 2.13)
314 — S — 115 (1.96 2.06 0.93) 314 — S — 118 (1.57 1.48 1.51) 314 — S — 119 (1.55 1.69 1.29) 314 — S — 123 (1.19 1.82 1.16)
314 — S — 131 (1.60 1.15 1.83) 314 — S — 132 (1.51 1.40 1.58) 314 — S — 138 (0.83 1.13 1.85) 314 — S — 147 (1.04 1.69 1.29)
314 — S — 148 (1.29 0.99 2.00) 314 — S — 150 (3.12 2.08 0.90) 314 — S — 154 (2.59 1.31 1.68) 314 — S — 166 (2.31 1.14 1.85)
314 — S — 167 (2.17 0.82 2.16) 314 — S — 171 (2.08 1.13 1.85) 314 — S — 177 (2.13 1.86 1.12) 314 — S — 184 (2.87 1.67 1.31)
314 — S — 187 (2.01 1.04 1.94) 314 — S — 188 (2.45 1.08 1.90) 314 — S — 193 (1.39 1.36 1.63) 314 — S — 195 (2.30 1.52 1.47)
314 — S — 198 (2.01 1.58 1.41) 314 — S — 205 (1.53 1.64 1.35) 314 — S — 208 (1.50 1.11 1.88) 314 — S — 209 (1.24 1.19 1.80)
314 — S — 213 (1.98 1.53 1.45) 314 — S — 217 (1.40 1.57 1.42) 314 — S — 218 (1.37 1.74 1.24) 314 — S — 219 (1.17 1.30 1.69)
314 — S — 222 (1.29 1.15 1.84) 314 — S — 224 (0.92 0.82 2.17) 314 — S — 228 (0.91 1.30 1.68) 314 — S — 230 (1.21 0.97 2.01)
314 — S — 233 (1.91 1.73 1.25) 314 — S — 234 (1.73 1.81 1.17) 314 — S — 238 (1.03 1.97 1.02) 314 — S — 243 (2.47 0.94 2.05)
314 — S — 244 (1.79 1.72 1.26) 314 — S — 245 (1.71 1.50 1.49) 314 — S — 246 (2.04 2.06 0.92) 314 — S — 254 (1.54 1.42 1.56)
314 — S — 266 (1.64 1.78 1.20) 314 — S — 267 (1.44 1.48 1.50) 314 — S — 272 (1.83 0.83 2.16) 314 — S — 274 (1.31 1.28 1.70)
314 — S — 275 (1.12 1.70 1.28) 314 — S — 277 (1.53 1.55 1.43) 314 — S — 279 (1.58 1.61 1.37) 314 — S — 280 (1.26 1.29 1.69)
314 — S — 282 (1.38 1.12 1.87) 314 — S — 284 (1.16 1.12 1.86) 314 — S — 285 (1.31 1.49 1.49) 314 — S — 286 (1.56 1.40 1.59)
314 — S — 287 (1.37 1.41 1.58) 314 — S — 288 (1.35 1.35 1.64) 314 — S — 289 (1.61 1.19 1.80) 314 — S — 290 (1.64 1.81 1.17)
314 — S — 292 (2.11 1.88 1.11) 314 — S — 293 (1.62 1.69 1.30) 314 — S — 294 (2.07 1.72 1.27) 314 — S — 295 (1.83 1.96 1.02)
314 — S — 296 (2.10 1.96 1.03) 314 — S — 297 (1.42 1.09 1.90) 314 — S — 298 (1.67 1.56 1.42) 314 — S — 299 (0.93 1.90 1.08)
314 — S — 300 (1.68 0.96 2.02) 314 — S — 303 (1.44 0.94 2.05) 314 — S — 304 (1.48 1.41 1.57) 314 — S — 305 (1.99 1.63 1.36)
314 — S — 310 (1.59 1.02 1.96) 314 — S — 311 (1.32 1.30 1.69) 314 — S — 312 (1.41 1.17 1.82) 314 — S — 313 (1.19 1.34 1.65)
314 — S — 316 (1.48 1.62 1.36) 314 — S — 327 (1.77 2.03 0.96) 314 — S — 330 (1.10 1.03 1.95) 314 — S — 331 (1.63 1.21 1.78)
314 — S — 332 (1.48 1.38 1.60) 314 — S — 336 (1.58 1.27 1.72) 314 — S — 341 (1.08 1.90 1.09) 314 — S — 356 (1.25 1.09 1.90)
314 — S — 357 (1.94 0.83 2.15) 314 — S — 358 (1.42 1.54 1.44) 314 — S — 360 (0.87 0.94 2.04) 314 — S — 370 (1.39 1.61 1.37)
314 — S — 372 (1.62 1.31 1.67) 314 — S — 373 (1.01 1.32 1.67) 314 — S — 374 (1.23 1.80 1.18) 314 — S — 379 (1.31 1.31 1.68)
314 — S — 381 (0.88 1.48 1.51) 314 — S — 382 (1.37 1.49 1.50) 314 — S — 391 (1.31 1.30 1.69) 314 — S — 395 (2.24 2.03 0.96)
314 — S — 396 (1.67 1.46 1.52) 314 — S — 397 (1.47 1.31 1.68) 314 — S — 415 (1.36 1.19 1.79) 314 — S — 432 (1.49 0.80 2.18)
314 — S — 433 (1.20 0.81 2.17) 314 — S — 434 (1.32 1.60 1.39) 314 — S — 435 (1.40 1.77 1.22) 314 — S — 437 (1.58 1.14 1.84)
314 — S — 440 (1.93 1.94 1.05) 314 — S — 441 (1.86 1.86 1.12) 314 — S — 447 (1.87 2.05 0.94) 314 — S — 448 (0.81 0.80 2.18)
314 — S — 449 (1.61 2.02 0.97) 314 — S — 450 (1.23 1.68 1.30) 314 — S — 453 (1.50 0.99 2.00) 314 — S — 454 (1.32 1.15 1.83)
314 — S — 455 (1.31 1.42 1.56) 314 — S — 456 (1.00 1.14 1.85) 314 — S — 457 (1.45 1.93 1.06) 314 — S — 458 (1.00 1.72 1.26)
314 — S — 466 (0.83 1.01 1.98) 314 — S — 467 (1.14 1.53 1.45) 314 — S — 468 (1.34 1.84 1.15) 314 — S — 471 (2.03 1.59 1.39)
314 — S — 475 (0.87 1.22 1.77) 315 — S — 1 (1.12 0.93 1.87) 315 — S — 2 (1.13 1.01 1.79) 315 — S — 4 (1.25 1.09 1.71)
315 — S — 5 (1.11 1.31 1.48) 315 — S — 6 (0.88 1.02 1.78) 315 — S — 7 (0.88 1.01 1.79) 315 — S — 8 (1.03 0.88 1.92)
315 — S — 9 (1.99 1.35 1.45) 315 — S — 10 (0.85 1.08 1.72) 315 — S — 11 (1.10 1.59 1.20) 315 — S — 12 (0.85 1.32 1.48)
315 — S — 14 (1.41 0.99 1.81) 315 — S — 16 (0.88 1.02 1.78) 315 — S — 19 (1.56 1.25 1.55) 315 — S — 20 (2.09 1.90 0.90)
315 — S — 21 (1.00 0.99 1.81) 315 — S — 24 (0.85 1.09 1.70) 315 — S — 30 (1.24 1.27 1.53) 315 — S — 31 (1.26 1.23 1.57)
315 — S — 32 (1.35 1.08 1.72) 315 — S — 33 (1.29 1.11 1.69) 315 — S — 34 (1.17 1.10 1.69) 315 — S — 35 (1.31 1.06 1.74)
315 — S — 38 (1.45 1.49 1.31) 315 — S — 44 (1.72 1.21 1.59) 315 — S — 45 (1.12 1.70 1.10) 315 — S — 47 (0.98 1.53 1.27)
315 — S — 48 (1.05 1.56 1.24) 315 — S — 54 (1.20 1.01 1.79) 315 — S — 55 (1.28 0.81 1.98) 315 — S — 56 (2.00 1.52 1.27)
315 — S — 58 (1.14 1.28 1.51) 315 — S — 59 (1.18 1.26 1.54) 315 — S — 60 (1.29 1.14 1.66) 315 — S — 64 (1.21 1.04 1.75)
315 — S — 65 (1.99 1.83 0.96) 315 — S — 68 (1.70 1.80 1.00) 315 — S — 71 (1.14 1.03 1.77) 315 — S — 74 (1.15 1.37 1.43)
315 — S — 83 (2.04 1.47 1.33) 315 — S — 88 (1.21 1.14 1.66) 315 — S — 95 (0.95 0.83 1.97) 315 — S — 96 (1.07 1.82 0.97)
315 — S — 98 (1.20 1.20 1.60) 315 — S — 102 (1.75 1.36 1.44) 315 — S — 104 (1.41 0.93 1.87) 315 — S — 105 (2.29 1.45 1.35)
315 — S — 106 (1.70 0.88 1.92) 315 — S — 111 (2.75 1.47 1.33) 315 — S — 112 (1.94 1.85 0.95) 315 — S — 114 (1.59 1.12 1.68)
315 — S — 118 (2.03 1.74 1.05) 315 — S — 124 (0.89 1.35 1.45) 315 — S — 131 (2.05 1.42 1.38) 315 — S — 132 (1.96 1.67 1.13)
315 — S — 138 (1.28 1.40 1.40) 315 — S — 148 (1.75 1.25 1.55) 315 — S — 154 (3.04 1.58 1.22) 315 — S — 161 (2.55 0.88 1.92)
315 — S — 166 (2.76 1.40 1.40) 315 — S — 167 (2.62 1.09 1.71) 315 — S — 170 (2.83 0.81 1.99) 315 — S — 171 (2.53 1.40 1.40)
315 — S — 175 (1.76 1.04 1.76) 315 — S — 182 (1.73 0.97 1.83) 315 — S — 187 (2.47 1.31 1.49) 315 — S — 188 (2.90 1.35 1.45)
315 — S — 189 (2.65 0.94 1.86) 315 — S — 193 (1.85 1.62 1.18) 315 — S — 194 (2.70 1.06 1.73) 315 — S — 195 (2.75 1.78 1.01)
315 — S — 197 (2.90 0.85 1.95) 315 — S — 198 (2.47 1.84 0.95) 315 — S — 208 (1.95 1.38 1.42) 315 — S — 209 (1.70 1.45 1.34)
315 — S — 210 (1.59 0.86 1.94) 315 — S — 211 (1.04 1.62 1.18) 315 — S — 212 (0.86 1.13 1.67) 315 — S — 213 (2.43 1.80 1.00)
315 — S — 214 (1.99 1.03 1.76) 315 — S — 217 (1.86 1.83 0.97) 315 — S — 219 (1.63 1.57 1.23) 315 — S — 222 (1.74 1.41 1.38)
315 — S — 224 (1.37 1.08 1.71) 315 — S — 225 (1.23 1.42 1.38) 315 — S — 228 (1.37 1.57 1.23) 315 — S — 230 (1.67 1.24 1.56)
315 — S — 236 (2.40 0.96 1.83) 315 — S — 240 (1.79 0.86 1.94) 315 — S — 243 (2.93 1.20 1.59) 315 — S — 245 (2.16 1.76 1.04)
315 — S — 254 (2.00 1.69 1.11) 315 — S — 267 (1.90 1.75 1.05) 315 — S — 272 (2.28 1.09 1.70) 315 — S — 274 (1.76 1.55 1.25)
315 — S — 276 (1.68 0.95 1.84) 315 — S — 277 (1.98 1.82 0.98) 315 — S — 279 (2.04 1.88 0.92) 315 — S — 280 (1.72 1.56 1.24)

315 — S — 282 (1.83 1.38 1.41) 315 — S — 284 (1.61 1.39 1.41) 315 — S — 285 (1.76 1.76 1.04) 315 — S — 286 (2.01 1.66 1.13)
315 — S — 287 (1.82 1.67 1.12) 315 — S — 288 (1.81 1.61 1.18) 315 — S — 289 (2.07 1.45 1.35) 315 — S — 297 (1.87 1.36 1.44)
315 — S — 298 (2.13 1.83 0.97) 315 — S — 300 (2.13 1.23 1.57) 315 — S — 301 (2.18 0.94 1.86) 315 — S — 303 (1.89 1.20 1.60)
315 — S — 304 (1.93 1.68 1.12) 315 — S — 305 (2.45 1.89 0.91) 315 — S — 308 (1.93 0.84 1.96) 315 — S — 310 (2.05 1.29 1.51)
315 — S — 311 (1.77 1.56 1.23) 315 — S — 312 (1.87 1.44 1.36) 315 — S — 313 (1.65 1.60 1.19) 315 — S — 316 (1.93 1.89 0.91)
315 — S — 318 (2.23 0.93 1.86) 315 — S — 319 (1.13 1.75 1.05) 315 — S — 325 (0.98 1.69 1.11) 315 — S — 330 (1.55 1.30 1.50)
315 — S — 331 (2.08 1.47 1.33) 315 — S — 332 (1.93 1.65 1.15) 315 — S — 336 (2.04 1.54 1.26) 315 — S — 353 (1.57 0.81 1.99)
315 — S — 356 (1.70 1.35 1.45) 315 — S — 357 (2.39 1.10 1.70) 315 — S — 358 (1.88 1.81 0.99) 315 — S — 359 (1.29 0.91 1.89)
315 — S — 360 (1.33 1.21 1.59) 315 — S — 370 (1.85 1.88 0.92) 315 — S — 372 (2.07 1.58 1.22) 315 — S — 373 (1.47 1.58 1.21)
315 — S — 375 (0.94 0.95 1.85) 315 — S — 377 (0.89 0.90 1.89) 315 — S — 378 (1.20 1.42 1.38) 315 — S — 379 (1.76 1.57 1.22)
315 — S — 380 (1.60 0.99 1.81) 315 — S — 381 (1.33 1.74 1.05) 315 — S — 382 (1.83 1.76 1.04) 315 — S — 391 (1.77 1.56 1.24)
315 — S — 394 (1.66 0.86 1.94) 315 — S — 396 (2.12 1.73 1.07) 315 — S — 397 (1.92 1.57 1.22) 315 — S — 403 (1.71 0.83 1.97)
315 — S — 415 (1.82 1.46 1.34) 315 — S — 419 (1.21 1.55 1.24) 315 — S — 422 (1.12 1.15 1.65) 315 — S — 432 (1.94 1.07 1.73)
315 — S — 433 (1.66 1.08 1.72) 315 — S — 434 (1.77 1.87 0.93) 315 — S — 437 (2.04 1.41 1.39) 315 — S — 448 (1.26 1.07 1.73)
315 — S — 453 (1.95 1.26 1.54) 315 — S — 454 (1.78 1.42 1.38) 315 — S — 455 (1.76 1.69 1.11) 315 — S — 456 (1.45 1.40 1.40)
315 — S — 464 (0.82 1.87 0.93) 315 — S — 466 (1.28 1.27 1.52) 315 — S — 467 (1.59 1.80 1.00) 315 — S — 471 (2.49 1.86 0.94)
315 — S — 475 (1.33 1.48 1.31) 315 — S — 476 (1.01 1.51 1.28) 315 — S — 480 (1.41 0.84 1.96) 316 — S — 57 (0.98 1.35 1.49)
316 — S — 125 (1.22 1.80 1.04) 316 — S — 152 (2.19 1.01 1.83) 316 — S — 215 (0.80 1.14 1.70) 316 — S — 250 (0.99 1.92 0.92)
316 — S — 259 (0.81 1.47 1.36) 316 — S — 320 (0.90 1.07 1.76) 316 — S — 324 (0.87 1.57 1.27) 316 — S — 343 (2.57 1.10 1.73)
316 — S — 429 (2.13 1.80 1.03) 316 — S — 472 (1.13 1.38 1.46) 317 — S — 9 (1.12 0.80 2.32) 317 — S — 20 (1.22 1.35 1.78)
317 — S — 27 (1.13 1.52 1.61) 317 — S — 28 (1.20 1.78 1.34) 317 — S — 29 (0.96 1.51 1.62) 317 — S — 43 (1.77 2.15 0.97)
317 — S — 46 (2.37 1.67 1.45) 317 — S — 56 (1.12 0.98 2.15) 317 — S — 61 (1.11 1.49 1.63) 317 — S — 62 (0.99 1.69 1.43)
317 — S — 65 (1.12 1.29 1.84) 317 — S — 68 (0.83 1.25 1.88) 317 — S — 79 (1.10 1.66 1.46) 317 — S — 80 (1.05 1.62 1.50)
317 — S — 81 (1.13 1.74 1.38) 317 — S — 82 (0.86 1.93 1.20) 317 — S — 83 (1.16 0.92 2.21) 317 — S — 85 (1.62 1.47 1.65)
317 — S — 86 (0.83 1.84 1.28) 317 — S — 89 (1.59 2.10 1.03) 317 — S — 90 (1.50 1.95 1.18) 317 — S — 101 (1.25 1.80 1.32)
317 — S — 102 (0.88 0.81 2.32) 317 — S — 105 (1.41 0.90 2.23) 317 — S — 107 (1.88 1.64 1.49) 317 — S — 108 (1.44 2.03 1.10)
317 — S — 109 (1.67 2.16 0.96) 317 — S — 110 (1.17 1.80 1.32) 317 — S — 111 (1.87 0.92 2.20) 317 — S — 112 (1.06 1.30 1.83)
317 — S — 113 (1.27 2.22 0.91) 317 — S — 115 (1.54 1.77 1.35) 317 — S — 118 (1.15 1.20 1.93) 317 — S — 119 (1.13 1.41 1.71)
317 — S — 131 (1.18 0.87 2.25) 317 — S — 132 (1.09 1.12 2.01) 317 — S — 133 (1.88 1.93 1.20) 317 — S — 144 (1.21 1.84 1.29)
317 — S — 150 (2.70 1.80 1.33) 317 — S — 151 (2.61 2.06 1.07) 317 — S — 153 (2.63 1.90 1.22) 317 — S — 154 (2.16 1.03 2.10)
317 — S — 166 (1.89 0.86 2.27) 317 — S — 171 (1.66 0.85 2.27) 317 — S — 177 (1.71 1.58 1.55) 317 — S — 183 (1.36 1.92 1.21)
317 — S — 184 (2.45 1.39 1.73) 317 — S — 188 (2.03 0.80 2.32) 317 — S — 192 (2.06 1.91 1.21) 317 — S — 193 (0.97 1.07 2.05)
317 — S — 195 (1.88 1.24 1.89) 317 — S — 198 (1.59 1.30 1.83) 317 — S — 205 (1.11 1.36 1.77) 317 — S — 207 (1.62 2.22 0.91)
317 — S — 208 (1.07 0.83 2.30) 317 — S — 209 (0.82 0.91 2.22) 317 — S — 213 (1.56 1.25 1.87) 317 — S — 217 (0.98 1.28 1.84)
317 — S — 218 (0.95 1.46 1.66) 317 — S — 222 (0.86 0.87 2.26) 317 — S — 231 (2.10 2.02 1.10) 317 — S — 233 (1.48 1.45 1.68)
317 — S — 234 (1.30 1.53 1.59) 317 — S — 237 (1.31 1.83 1.30) 317 — S — 244 (1.37 1.44 1.68) 317 — S — 245 (1.29 1.22 1.91)
317 — S — 246 (1.62 1.78 1.34) 317 — S — 249 (1.16 2.17 0.95) 317 — S — 251 (1.13 2.03 1.10) 317 — S — 254 (1.12 1.14 1.99)
317 — S — 255 (2.01 2.00 1.13) 317 — S — 265 (1.58 1.92 1.20) 317 — S — 266 (1.22 1.50 1.63) 317 — S — 267 (1.02 1.20 1.93)
317 — S — 268 (1.56 2.07 1.05) 317 — S — 269 (1.53 2.00 1.12) 317 — S — 271 (2.28 2.09 1.03) 317 — S — 274 (0.89 1.00 2.12)
317 — S — 277 (1.11 1.27 1.86) 317 — S — 279 (1.16 1.33 1.79) 317 — S — 280 (0.84 1.01 2.12) 317 — S — 282 (0.96 0.84 2.29)
317 — S — 285 (0.89 1.21 1.91) 317 — S — 286 (1.14 1.12 2.01) 317 — S — 287 (0.95 1.13 2.00) 317 — S — 288 (0.93 1.07 2.06)
317 — S — 289 (1.19 0.91 2.22) 317 — S — 290 (1.22 1.53 1.59) 317 — S — 291 (2.36 1.94 1.19) 317 — S — 292 (1.69 1.60 1.53)
317 — S — 293 (1.20 1.41 1.72) 317 — S — 294 (1.65 1.44 1.69) 317 — S — 295 (1.40 1.68 1.44) 317 — S — 296 (1.68 1.68 1.45)
317 — S — 297 (0.99 0.81 2.32) 317 — S — 298 (1.25 1.28 1.84) 317 — S — 304 (1.06 1.13 2.00) 317 — S — 305 (1.57 1.35 1.78)
317 — S — 306 (1.73 2.00 1.13) 317 — S — 307 (1.46 2.13 1.00) 317 — S — 311 (0.89 1.02 2.11) 317 — S — 312 (0.99 0.89 2.24)
317 — S — 316 (1.06 1.34 1.78) 317 — S — 327 (1.35 1.75 1.38) 317 — S — 329 (1.67 2.21 0.92) 317 — S — 331 (1.21 0.92 2.20)
317 — S — 332 (1.06 1.10 2.03) 317 — S — 336 (1.16 0.99 2.14) 317 — S — 342 (3.10 1.96 1.17) 317 — S — 356 (0.82 0.81 2.32)
317 — S — 358 (1.00 1.26 1.86) 317 — S — 367 (1.63 1.90 1.22) 317 — S — 370 (0.97 1.33 1.79) 317 — S — 371 (2.79 2.05 1.08)
317 — S — 372 (1.20 1.03 2.09) 317 — S — 374 (0.81 1.52 1.60) 317 — S — 379 (0.88 1.03 2.10) 317 — S — 382 (0.95 1.21 1.92)
317 — S — 391 (0.89 1.01 2.11) 317 — S — 395 (1.82 1.75 1.38) 317 — S — 396 (1.25 1.18 1.94) 317 — S — 397 (1.05 1.03 2.10)
317 — S — 415 (0.94 0.91 2.21) 317 — S — 420 (1.00 2.22 0.90) 317 — S — 430 (0.83 1.85 1.28) 317 — S — 434 (0.90 1.32 1.81)
317 — S — 435 (0.98 1.49 1.64) 317 — S — 437 (1.16 0.86 2.26) 317 — S — 440 (1.51 1.65 1.47) 317 — S — 441 (1.44 1.58 1.54)
317 — S — 443 (0.91 2.20 0.93) 317 — S — 447 (1.45 1.77 1.36) 317 — S — 449 (1.19 1.74 1.39) 317 — S — 450 (0.81 1.40 1.72)
317 — S — 452 (1.59 2.00 1.12) 317 — S — 454 (0.90 0.87 2.25) 317 — S — 455 (0.89 1.14 1.98) 317 — S — 457 (1.03 1.65 1.48)
317 — S — 459 (0.82 1.88 1.24) 317 — S — 460 (1.31 2.08 1.05) 317 — S — 461 (1.03 1.84 1.28) 317 — S — 468 (0.91 1.55 1.57)
317 — S — 469 (1.00 1.98 1.14) 317 — S — 471 (1.61 1.31 1.81) 317 — S — 473 (1.66 1.93 1.20) 317 — S — 474 (1.51 1.82 1.31)
318 — S — 46 (1.02 1.29 2.80) 318 — S — 125 (0.93 2.75 1.34) 318 — S — 150 (1.35 1.41 2.68) 318 — S — 151 (1.26 1.67 2.42)
318 — S — 152 (1.90 1.97 2.12) 318 — S — 153 (1.28 1.51 2.58) 318 — S — 184 (1.10 1.01 3.09) 318 — S — 271 (0.93 1.71 2.38)

318 — S — 291 (1.01 1.55 2.54) 318 — S — 342 (1.75 1.57 2.52) 318 — S — 343 (2.28 2.06 2.03) 318 — S — 371 (1.44 1.66 2.43)
318 — S — 429 (1.84 2.76 1.33) 318 — S — 472 (0.84 2.34 1.75) 319 — S — 36 (1.10 1.09 1.09) 319 — S — 43 (1.51 0.95 1.23)
319 — S — 70 (1.58 1.16 1.02) 319 — S — 89 (1.33 0.90 1.28) 319 — S — 108 (1.18 0.82 1.36) 319 — S — 109 (1.41 0.96 1.22)
319 — S — 113 (1.01 1.01 1.17) 319 — S — 151 (2.35 0.85 1.33) 319 — S — 152 (2.99 1.15 1.03) 319 — S — 206 (0.85 1.07 1.11)
319 — S — 207 (1.37 1.01 1.17) 319 — S — 215 (1.60 1.28 0.90) 319 — S — 231 (1.84 0.82 1.36) 319 — S — 248 (1.43 1.13 1.05)
319 — S — 249 (0.90 0.97 1.21) 319 — S — 251 (0.87 0.83 1.36) 319 — S — 258 (0.82 1.24 0.94) 319 — S — 260 (0.88 1.25 0.93)
319 — S — 268 (1.31 0.87 1.31) 319 — S — 271 (2.02 0.89 1.29) 319 — S — 307 (1.20 0.93 1.26) 319 — S — 320 (1.70 1.21 0.97)
319 — S — 329 (1.42 1.00 1.18) 319 — S — 343 (3.37 1.25 0.94) 319 — S — 368 (1.48 1.24 0.94) 319 — S — 371 (2.53 0.84 1.34)
319 — S — 451 (1.27 1.14 1.04) 319 — S — 452 (1.33 0.80 1.38) 319 — S — 460 (1.05 0.88 1.30) 319 — S — 463 (1.20 1.25 0.93)
321 — S — 20 (1.46 1.13 1.54) 321 — S — 27 (1.37 1.30 1.37) 321 — S — 28 (1.43 1.57 1.10) 321 — S — 29 (1.19 1.29 1.38)
321 — S — 40 (1.02 1.29 1.38) 321 — S — 46 (2.60 1.46 1.22) 321 — S — 61 (1.34 1.28 1.40) 321 — S — 62 (1.22 1.48 1.20)
321 — S — 65 (1.35 1.07 1.60) 321 — S — 68 (1.07 1.03 1.64) 321 — S — 79 (1.34 1.45 1.23) 321 — S — 80 (1.29 1.41 1.27)
321 — S — 81 (1.37 1.53 1.14) 321 — S — 82 (1.10 1.72 0.96) 321 — S — 85 (1.85 1.26 1.41) 321 — S — 86 (1.07 1.63 1.04)
321 — S — 90 (1.74 1.74 0.94) 321 — S — 101 (1.49 1.59 1.09) 321 — S — 107 (2.11 1.42 1.25) 321 — S — 110 (1.41 1.59 1.09)
321 — S — 112 (1.30 1.08 1.59) 321 — S — 115 (1.78 1.56 1.11) 321 — S — 118 (1.39 0.98 1.69) 321 — S — 119 (1.36 1.20 1.48)
321 — S — 123 (1.00 1.33 1.35) 321 — S — 132 (1.33 0.90 1.77) 321 — S — 133 (2.12 1.71 0.96) 321 — S — 144 (1.45 1.62 1.05)
321 — S — 147 (0.86 1.20 1.48) 321 — S — 150 (2.94 1.58 1.09) 321 — S — 153 (2.87 1.69 0.99) 321 — S — 154 (2.40 0.81 1.86)
321 — S — 177 (1.95 1.36 1.31) 321 — S — 183 (1.60 1.70 0.97) 321 — S — 184 (2.69 1.18 1.50) 321 — S — 192 (2.29 1.70 0.98)
321 — S — 193 (1.21 0.86 1.81) 321 — S — 195 (2.12 1.02 1.65) 321 — S — 198 (1.83 1.08 1.59) 321 — S — 205 (1.35 1.14 1.53)
321 — S — 213 (1.79 1.04 1.64) 321 — S — 217 (1.22 1.07 1.60) 321 — S — 218 (1.19 1.25 1.43) 321 — S — 219 (0.99 0.80 1.87)
321 — S — 233 (1.72 1.23 1.44) 321 — S — 234 (1.54 1.32 1.36) 321 — S — 237 (1.55 1.61 1.06) 321 — S — 238 (0.85 1.47 1.20)
321 — S — 244 (1.61 1.23 1.45) 321 — S — 245 (1.52 1.00 1.67) 321 — S — 246 (1.86 1.57 1.11) 321 — S — 254 (1.36 0.92 1.75)
321 — S — 265 (1.82 1.71 0.97) 321 — S — 266 (1.46 1.29 1.39) 321 — S — 267 (1.26 0.99 1.69) 321 — S — 275 (0.93 1.21 1.47)
321 — S — 277 (1.35 1.05 1.62) 321 — S — 279 (1.40 1.12 1.56) 321 — S — 285 (1.12 1.00 1.68) 321 — S — 286 (1.38 0.90 1.77)
321 — S — 287 (1.18 0.91 1.76) 321 — S — 288 (1.17 0.85 1.82) 321 — S — 290 (1.46 1.32 1.36) 321 — S — 291 (2.60 1.72 0.95)
321 — S — 292 (1.93 1.38 1.29) 321 — S — 293 (1.43 1.19 1.48) 321 — S — 294 (1.89 1.22 1.45) 321 — S — 295 (1.64 1.47 1.21)
321 — S — 296 (1.92 1.46 1.21) 321 — S — 298 (1.49 1.07 1.61) 321 — S — 304 (1.29 0.91 1.76) 321 — S — 305 (1.81 1.13 1.54)
321 — S — 311 (1.13 0.80 1.87) 321 — S — 313 (1.01 0.84 1.83) 321 — S — 316 (1.29 1.13 1.54) 321 — S — 327 (1.58 1.53 1.14)
321 — S — 332 (1.30 0.88 1.79) 321 — S — 341 (0.89 1.40 1.27) 321 — S — 342 (3.34 1.74 0.93) 321 — S — 358 (1.24 1.05 1.62)
321 — S — 367 (1.87 1.69 0.99) 321 — S — 370 (1.21 1.12 1.56) 321 — S — 372 (1.44 0.82 1.86) 321 — S — 373 (0.83 0.82 1.85)
321 — S — 374 (1.05 1.31 1.37) 321 — S — 379 (1.12 0.81 1.86) 321 — S — 382 (1.19 0.99 1.68) 321 — S — 395 (2.06 1.53 1.14)
321 — S — 396 (1.48 0.97 1.71) 321 — S — 397 (1.29 0.81 1.86) 321 — S — 430 (1.07 1.63 1.04) 321 — S — 434 (1.13 1.10 1.57)
321 — S — 435 (1.22 1.27 1.40) 321 — S — 440 (1.74 1.44 1.23) 321 — S — 441 (1.67 1.37 1.31) 321 — S — 447 (1.68 1.55 1.12)
321 — S — 449 (1.43 1.52 1.15) 321 — S — 450 (1.05 1.19 1.48) 321 — S — 455 (1.12 0.93 1.75) 321 — S — 457 (1.27 1.43 1.24)
321 — S — 458 (0.81 1.23 1.45) 321 — S — 459 (1.06 1.67 1.01) 321 — S — 461 (1.26 1.63 1.05) 321 — S — 462 (0.96 1.64 1.03)
321 — S — 467 (0.95 1.04 1.64) 321 — S — 468 (1.15 1.34 1.33) 321 — S — 469 (1.24 1.77 0.91) 321 — S — 471 (1.85 1.10 1.58)
321 — S — 473 (1.90 1.71 0.96) 321 — S — 474 (1.75 1.60 1.07) 322 — S — 5 (1.06 0.86 1.54) 322 — S — 9 (1.94 0.89 1.50)
322 — S — 11 (1.04 1.14 1.26) 322 — S — 20 (2.04 1.44 0.95) 322 — S — 30 (1.19 0.82 1.58) 322 — S — 38 (1.40 1.03 1.36)
322 — S — 45 (1.07 1.25 1.15) 322 — S — 47 (0.93 1.07 1.32) 322 — S — 48 (1.00 1.10 1.29) 322 — S — 56 (1.94 1.07 1.33)
322 — S — 58 (1.09 0.83 1.57) 322 — S — 65 (1.94 1.38 1.02) 322 — S — 68 (1.65 1.34 1.05) 322 — S — 74 (1.10 0.91 1.48)
322 — S — 83 (1.98 1.01 1.39) 322 — S — 96 (1.02 1.37 1.03) 322 — S — 102 (1.70 0.90 1.49) 322 — S — 105 (2.24 0.99 1.41)
322 — S — 111 (2.69 1.01 1.38) 322 — S — 112 (1.89 1.39 1.01) 322 — S — 118 (1.97 1.29 1.11) 322 — S — 124 (0.84 0.89 1.50)
322 — S — 131 (2.00 0.96 1.43) 322 — S — 132 (1.91 1.21 1.18) 322 — S — 138 (1.23 0.94 1.45) 322 — S — 154 (2.99 1.12 1.28)
322 — S — 166 (2.71 0.95 1.45) 322 — S — 171 (2.48 0.94 1.45) 322 — S — 184 (3.27 1.48 0.91) 322 — S — 187 (2.41 0.85 1.54)
322 — S — 188 (2.85 0.89 1.50) 322 — S — 193 (1.79 1.17 1.23) 322 — S — 195 (2.70 1.33 1.07) 322 — S — 198 (2.41 1.39 1.01)
322 — S — 205 (1.93 1.45 0.95) 322 — S — 208 (1.90 0.92 1.48) 322 — S — 209 (1.64 1.00 1.40) 322 — S — 211 (0.99 1.17 1.23)
322 — S — 213 (2.38 1.34 1.05) 322 — S — 217 (1.80 1.38 1.02) 322 — S — 219 (1.57 1.11 1.29) 322 — S — 222 (1.69 0.96 1.44)
322 — S — 225 (1.18 0.96 1.43) 322 — S — 227 (0.98 1.48 0.91) 322 — S — 228 (1.31 1.11 1.28) 322 — S — 245 (2.11 1.31 1.09)
322 — S — 254 (1.95 1.23 1.16) 322 — S — 267 (1.84 1.29 1.10) 322 — S — 274 (1.71 1.09 1.30) 322 — S — 277 (1.93 1.36 1.03)
322 — S — 279 (1.98 1.42 0.97) 322 — S — 280 (1.66 1.10 1.29) 322 — S — 282 (1.78 0.93 1.47) 322 — S — 284 (1.56 0.93 1.46)
322 — S — 285 (1.71 1.30 1.09) 322 — S — 286 (1.96 1.21 1.19) 322 — S — 287 (1.77 1.22 1.18) 322 — S — 288 (1.75 1.16 1.24)
322 — S — 289 (2.01 1.00 1.40) 322 — S — 297 (1.82 0.90 1.50) 322 — S — 298 (2.07 1.37 1.02) 322 — S — 304 (1.88 1.22 1.17)
322 — S — 305 (2.39 1.44 0.96) 322 — S — 310 (1.99 0.83 1.56) 322 — S — 311 (1.72 1.11 1.29) 322 — S — 312 (1.82 0.98 1.41)
322 — S — 313 (1.59 1.15 1.25) 322 — S — 316 (1.88 1.43 0.96) 322 — S — 319 (1.08 1.29 1.10) 322 — S — 325 (0.93 1.23 1.16)
322 — S — 330 (1.50 0.84 1.55) 322 — S — 331 (2.03 1.02 1.38) 322 — S — 332 (1.88 1.19 1.20) 322 — S — 336 (1.98 1.08 1.32)
322 — S — 356 (1.65 0.90 1.50) 322 — S — 358 (1.82 1.35 1.04) 322 — S — 370 (1.79 1.42 0.97) 322 — S — 372 (2.02 1.12 1.27)
322 — S — 373 (1.41 1.13 1.27) 322 — S — 378 (1.15 0.97 1.43) 322 — S — 379 (1.71 1.12 1.28) 322 — S — 381 (1.28 1.29 1.11)
322 — S — 382 (1.78 1.30 1.10) 322 — S — 391 (1.71 1.11 1.29) 322 — S — 396 (2.07 1.27 1.12) 322 — S — 397 (1.87 1.12 1.28)

322 — S — 415 (1.76 1.00 1.39) 322 — S — 419 (1.15 1.10 1.30) 322 — S — 434 (1.72 1.41 0.99) 322 — S — 437 (1.98 0.95 1.44)
322 — S — 454 (1.72 0.96 1.43) 322 — S — 455 (1.71 1.23 1.16) 322 — S — 456 (1.40 0.95 1.45) 322 — S — 466 (1.23 0.82 1.58)
322 — S — 467 (1.54 1.34 1.05) 322 — S — 471 (2.43 1.40 0.99) 322 — S — 475 (1.27 1.03 1.37) 322 — S — 476 (0.95 1.06 1.34)
323 — S — 9 (1.13 0.80 2.31) 323 — S — 20 (1.23 1.35 1.77) 323 — S — 27 (1.14 1.52 1.60) 323 — S — 28 (1.21 1.78 1.33)
323 — S — 29 (0.97 1.51 1.61) 323 — S — 43 (1.78 2.15 0.96) 323 — S — 46 (2.38 1.67 1.44) 323 — S — 56 (1.13 0.98 2.14)
323 — S — 61 (1.12 1.49 1.63) 323 — S — 62 (0.99 1.69 1.43) 323 — S — 65 (1.13 1.29 1.83) 323 — S — 68 (0.84 1.25 1.87)
323 — S — 79 (1.11 1.66 1.45) 323 — S — 80 (1.06 1.62 1.50) 323 — S — 81 (1.14 1.74 1.37) 323 — S — 82 (0.87 1.93 1.19)
323 — S — 83 (1.17 0.92 2.20) 323 — S — 85 (1.63 1.47 1.64) 323 — S — 86 (0.84 1.84 1.27) 323 — S — 89 (1.60 2.10 1.02)
323 — S — 90 (1.51 1.95 1.17) 323 — S — 101 (1.26 1.80 1.31) 323 — S — 102 (0.89 0.81 2.31) 323 — S — 105 (1.42 0.90 2.22)
323 — S — 107 (1.89 1.63 1.48) 323 — S — 108 (1.45 2.03 1.09) 323 — S — 109 (1.68 2.16 0.95) 323 — S — 110 (1.18 1.80 1.32)
323 — S — 111 (1.88 0.92 2.20) 323 — S — 112 (1.07 1.30 1.82) 323 — S — 113 (1.28 2.22 0.90) 323 — S — 115 (1.55 1.77 1.34)
323 — S — 118 (1.16 1.20 1.92) 323 — S — 119 (1.13 1.41 1.70) 323 — S — 131 (1.19 0.87 2.24) 323 — S — 132 (1.10 1.12 2.00)
323 — S — 133 (1.89 1.93 1.19) 323 — S — 144 (1.22 1.84 1.28) 323 — S — 150 (2.71 1.80 1.32) 323 — S — 151 (2.62 2.06 1.06)
323 — S — 153 (2.64 1.90 1.22) 323 — S — 154 (2.17 1.03 2.09) 323 — S — 166 (1.89 0.85 2.26) 323 — S — 171 (1.66 0.85 2.26)
323 — S — 177 (1.72 1.58 1.54) 323 — S — 183 (1.37 1.92 1.20) 323 — S — 184 (2.46 1.39 1.72) 323 — S — 188 (2.03 0.80 2.31)
323 — S — 192 (2.06 1.91 1.20) 323 — S — 193 (0.98 1.07 2.04) 323 — S — 195 (1.89 1.24 1.88) 323 — S — 198 (1.60 1.30 1.82)
323 — S — 205 (1.12 1.36 1.76) 323 — S — 208 (1.08 0.83 2.29) 323 — S — 209 (0.83 0.91 2.21) 323 — S — 213 (1.57 1.25 1.86)
323 — S — 217 (0.99 1.28 1.83) 323 — S — 218 (0.96 1.46 1.65) 323 — S — 222 (0.87 0.87 2.25) 323 — S — 231 (2.11 2.02 1.09)
323 — S — 233 (1.49 1.45 1.67) 323 — S — 234 (1.31 1.53 1.59) 323 — S — 237 (1.32 1.83 1.29) 323 — S — 244 (1.38 1.44 1.67)
323 — S — 245 (1.30 1.21 1.90) 323 — S — 246 (1.63 1.78 1.33) 323 — S — 249 (1.17 2.17 0.95) 323 — S — 251 (1.14 2.03 1.09)
323 — S — 254 (1.13 1.14 1.98) 323 — S — 255 (2.02 2.00 1.12) 323 — S — 265 (1.59 1.92 1.19) 323 — S — 266 (1.23 1.50 1.62)
323 — S — 267 (1.03 1.20 1.92) 323 — S — 268 (1.57 2.07 1.04) 323 — S — 269 (1.54 2.00 1.12) 323 — S — 271 (2.29 2.09 1.02)
323 — S — 274 (0.90 1.00 2.12) 323 — S — 277 (1.12 1.27 1.85) 323 — S — 279 (1.17 1.33 1.79) 323 — S — 280 (0.85 1.01 2.11)
323 — S — 282 (0.97 0.84 2.28) 323 — S — 285 (0.89 1.21 1.90) 323 — S — 286 (1.15 1.12 2.00) 323 — S — 287 (0.96 1.13 1.99)
323 — S — 288 (0.94 1.07 2.05) 323 — S — 289 (1.20 0.90 2.21) 323 — S — 290 (1.23 1.53 1.58) 323 — S — 291 (2.37 1.94 1.18)
323 — S — 292 (1.70 1.60 1.52) 323 — S — 293 (1.21 1.41 1.71) 323 — S — 294 (1.66 1.44 1.68) 323 — S — 295 (1.41 1.68 1.43)
323 — S — 296 (1.69 1.68 1.44) 323 — S — 297 (1.00 0.81 2.31) 323 — S — 298 (1.26 1.28 1.83) 323 — S — 304 (1.07 1.13 1.99)
323 — S — 305 (1.58 1.34 1.77) 323 — S — 306 (1.74 2.00 1.12) 323 — S — 307 (1.47 2.13 0.99) 323 — S — 311 (0.90 1.02 2.10)
323 — S — 312 (1.00 0.89 2.23) 323 — S — 316 (1.07 1.34 1.77) 323 — S — 327 (1.36 1.75 1.37) 323 — S — 329 (1.68 2.21 0.91)
323 — S — 331 (1.22 0.92 2.19) 323 — S — 332 (1.07 1.10 2.02) 323 — S — 336 (1.17 0.99 2.13) 323 — S — 342 (3.11 1.96 1.16)
323 — S — 356 (0.83 0.80 2.31) 323 — S — 358 (1.01 1.26 1.85) 323 — S — 367 (1.64 1.90 1.22) 323 — S — 370 (0.98 1.33 1.79)
323 — S — 371 (2.80 2.04 1.07) 323 — S — 372 (1.21 1.03 2.09) 323 — S — 374 (0.82 1.52 1.59) 323 — S — 379 (0.89 1.03 2.09)
323 — S — 382 (0.96 1.21 1.91) 323 — S — 391 (0.90 1.01 2.10) 323 — S — 395 (1.83 1.75 1.37) 323 — S — 396 (1.25 1.18 1.93)
323 — S — 397 (1.06 1.03 2.09) 323 — S — 415 (0.95 0.91 2.21) 323 — S — 430 (0.84 1.85 1.27) 323 — S — 434 (0.90 1.32 1.80)
323 — S — 435 (0.99 1.49 1.63) 323 — S — 437 (1.17 0.86 2.25) 323 — S — 440 (1.51 1.65 1.46) 323 — S — 441 (1.45 1.58 1.54)
323 — S — 443 (0.92 2.20 0.92) 323 — S — 447 (1.46 1.77 1.35) 323 — S — 449 (1.20 1.74 1.38) 323 — S — 450 (0.82 1.40 1.71)
323 — S — 452 (1.59 2.00 1.11) 323 — S — 454 (0.91 0.87 2.24) 323 — S — 455 (0.89 1.14 1.97) 323 — S — 457 (1.04 1.65 1.47)
323 — S — 459 (0.83 1.88 1.24) 323 — S — 460 (1.32 2.08 1.04) 323 — S — 461 (1.03 1.84 1.28) 323 — S — 468 (0.92 1.55 1.56)
323 — S — 469 (1.01 1.98 1.13) 323 — S — 471 (1.62 1.31 1.80) 323 — S — 473 (1.67 1.93 1.19) 323 — S — 474 (1.52 1.81 1.30)
325 — S — 36 (1.25 1.16 0.93) 325 — S — 43 (1.67 1.01 1.08) 325 — S — 89 (1.49 0.96 1.13) 325 — S — 90 (1.40 0.81 1.28)
325 — S — 108 (1.33 0.89 1.20) 325 — S — 109 (1.57 1.02 1.07) 325 — S — 113 (1.17 1.08 1.01) 325 — S — 151 (2.50 0.92 1.17)
325 — S — 206 (1.00 1.13 0.96) 325 — S — 207 (1.52 1.08 1.01) 325 — S — 231 (1.99 0.88 1.20) 325 — S — 249 (1.06 1.03 1.06)
325 — S — 251 (1.03 0.89 1.20) 325 — S — 255 (1.91 0.86 1.23) 325 — S — 268 (1.46 0.93 1.16) 325 — S — 269 (1.42 0.86 1.23)
325 — S — 271 (2.17 0.95 1.14) 325 — S — 306 (1.63 0.86 1.23) 325 — S — 307 (1.36 0.99 1.10) 325 — S — 329 (1.57 1.07 1.02)
325 — S — 342 (3.00 0.82 1.27) 325 — S — 371 (2.69 0.90 1.18) 325 — S — 420 (0.90 1.08 1.00) 325 — S — 443 (0.81 1.06 1.03)
325 — S — 452 (1.48 0.86 1.23) 325 — S — 460 (1.21 0.94 1.15) 325 — S — 469 (0.90 0.84 1.25) 327 — S — 125 (0.93 1.39 1.33)
327 — S — 429 (1.85 1.40 1.32) 327 — S — 472 (0.84 0.98 1.75) 328 — S — 36 (0.88 2.05 1.30) 328 — S — 37 (0.88 2.35 1.00)
328 — S — 43 (1.30 1.90 1.45) 328 — S — 46 (1.89 1.42 1.92) 328 — S — 57 (1.57 2.44 0.91) 328 — S — 70 (1.36 2.11 1.24)
328 — S — 85 (1.14 1.22 2.12) 328 — S — 89 (1.12 1.85 1.50) 328 — S — 90 (1.03 1.70 1.65) 328 — S — 107 (1.41 1.39 1.96)
328 — S — 108 (0.97 1.78 1.57) 328 — S — 109 (1.20 1.91 1.43) 328 — S — 113 (0.80 1.97 1.38) 328 — S — 115 (1.07 1.53 1.82)
328 — S — 133 (1.41 1.68 1.67) 328 — S — 150 (2.23 1.55 1.80) 328 — S — 151 (2.14 1.81 1.54) 328 — S — 152 (2.78 2.11 1.24)
328 — S — 153 (2.16 1.65 1.70) 328 — S — 177 (1.24 1.33 2.02) 328 — S — 183 (0.89 1.67 1.68) 328 — S — 184 (1.98 1.14 2.21)
328 — S — 192 (1.58 1.66 1.69) 328 — S — 195 (1.41 0.99 2.36) 328 — S — 198 (1.12 1.05 2.30) 328 — S — 207 (1.15 1.97 1.38)
328 — S — 213 (1.09 1.00 2.35) 328 — S — 215 (1.39 2.23 1.12) 328 — S — 231 (1.63 1.78 1.57) 328 — S — 233 (1.01 1.20 2.15)
328 — S — 234 (0.83 1.28 2.07) 328 — S — 237 (0.84 1.58 1.77) 328 — S — 244 (0.90 1.19 2.15) 328 — S — 245 (0.82 0.97 2.38)
328 — S — 246 (1.15 1.53 1.82) 328 — S — 248 (1.22 2.08 1.27) 328 — S — 255 (1.54 1.75 1.60) 328 — S — 265 (1.11 1.67 1.67)
328 — S — 268 (1.09 1.82 1.53) 328 — S — 269 (1.06 1.75 1.60) 328 — S — 270 (1.20 2.43 0.92) 328 — S — 271 (1.81 1.84 1.50)
328 — S — 291 (1.89 1.69 1.66) 328 — S — 292 (1.22 1.35 2.00) 328 — S — 294 (1.18 1.19 2.16) 328 — S — 295 (0.93 1.43 1.92)

| | | | |
|---|---|---|---|
| 328 — S — 296 (1.21 1.43 1.92) | 328 — S — 305 (1.10 1.10 2.25) | 328 — S — 306 (1.26 1.75 1.60) | 328 — S — 307 (0.99 1.88 1.47) |
| 328 — S — 320 (1.48 2.17 1.18) | 328 — S — 327 (0.87 1.50 1.85) | 328 — S — 329 (1.20 1.96 1.39) | 328 — S — 342 (2.63 1.71 1.64) |
| 328 — S — 343 (3.16 2.20 1.15) | 328 — S — 364 (1.34 2.33 1.02) | 328 — S — 367 (1.16 1.65 1.70) | 328 — S — 368 (1.27 2.19 1.15) |
| 328 — S — 371 (2.32 1.80 1.55) | 328 — S — 395 (1.35 1.50 1.85) | 328 — S — 440 (1.03 1.41 1.94) | 328 — S — 441 (0.96 1.33 2.02) |
| 328 — S — 447 (0.97 1.52 1.83) | 328 — S — 451 (1.06 2.10 1.25) | 328 — S — 452 (1.11 1.75 1.59) | 328 — S — 460 (0.84 1.83 1.52) |
| 328 — S — 463 (0.99 2.20 1.15) | 328 — S — 471 (1.14 1.06 2.28) | 328 — S — 473 (1.19 1.68 1.67) | 328 — S — 474 (1.04 1.57 1.78) |
| 329 — S — 429 (1.52 0.94 1.65) | 330 — S — 43 (1.10 1.40 1.65) | 330 — S — 46 (1.69 0.92 2.13) | 330 — S — 57 (1.36 1.94 1.11) |
| 330 — S — 70 (1.16 1.61 1.44) | 330 — S — 89 (0.91 1.35 1.70) | 330 — S — 90 (0.82 1.20 1.85) | 330 — S — 93 (0.89 2.09 0.96) |
| 330 — S — 107 (1.20 0.88 2.17) | 330 — S — 109 (1.00 1.41 1.64) | 330 — S — 115 (0.87 1.02 2.03) | 330 — S — 133 (1.20 1.17 1.87) |
| 330 — S — 150 (2.02 1.05 2.00) | 330 — S — 151 (1.93 1.31 1.74) | 330 — S — 152 (2.58 1.60 1.44) | 330 — S — 153 (1.96 1.15 1.90) |
| 330 — S — 165 (0.86 2.02 1.03) | 330 — S — 177 (1.04 0.83 2.22) | 330 — S — 192 (1.38 1.16 1.89) | 330 — S — 207 (0.95 1.46 1.58) |
| 330 — S — 215 (1.18 1.73 1.32) | 330 — S — 231 (1.42 1.27 1.78) | 330 — S — 246 (0.95 1.03 2.02) | 330 — S — 248 (1.01 1.58 1.47) |
| 330 — S — 255 (1.34 1.25 1.80) | 330 — S — 259 (1.19 2.07 0.98) | 330 — S — 265 (0.91 1.17 1.88) | 330 — S — 268 (0.89 1.32 1.73) |
| 330 — S — 269 (0.85 1.25 1.80) | 330 — S — 270 (0.99 1.93 1.12) | 330 — S — 271 (1.60 1.34 1.71) | 330 — S — 291 (1.68 1.18 1.86) |
| 330 — S — 292 (1.02 0.84 2.20) | 330 — S — 296 (1.01 0.93 2.12) | 330 — S — 306 (1.06 1.25 1.80) | 330 — S — 320 (1.28 1.67 1.38) |
| 330 — S — 329 (1.00 1.45 1.60) | 330 — S — 342 (2.43 1.20 1.84) | 330 — S — 343 (2.96 1.70 1.35) | 330 — S — 364 (1.14 1.83 1.22) |
| 330 — S — 367 (0.95 1.15 1.90) | 330 — S — 368 (1.06 1.69 1.36) | 330 — S — 371 (2.11 1.29 1.76) | 330 — S — 395 (1.14 0.99 2.06) |
| 330 — S — 440 (0.83 0.90 2.15) | 330 — S — 451 (0.85 1.59 1.45) | 330 — S — 452 (0.91 1.25 1.80) | 330 — S — 472 (1.51 1.97 1.08) |
| 330 — S — 473 (0.98 1.17 1.87) | 330 — S — 474 (0.84 1.06 1.99) | 331 — S — 57 (0.83 1.77 1.64) | 331 — S — 125 (1.07 2.21 1.19) |
| 331 — S — 150 (1.49 0.88 2.53) | 331 — S — 151 (1.40 1.13 2.27) | 331 — S — 152 (2.05 1.43 1.97) | 331 — S — 153 (1.43 0.98 2.43) |
| 331 — S — 192 (0.85 0.99 2.42) | 331 — S — 231 (0.89 1.10 2.31) | 331 — S — 250 (0.84 2.34 1.07) | 331 — S — 255 (0.81 1.08 2.33) |
| 331 — S — 271 (1.07 1.17 2.24) | 331 — S — 291 (1.15 1.01 2.39) | 331 — S — 342 (1.90 1.03 2.37) | 331 — S — 343 (2.43 1.52 1.88) |
| 331 — S — 371 (1.58 1.12 2.29) | 331 — S — 429 (1.99 2.22 1.18) | 331 — S — 472 (0.98 1.80 1.61) | 332 — S — 57 (0.98 1.59 1.50) |
| 332 — S — 125 (1.22 2.04 1.05) | 332 — S — 133 (0.82 0.83 2.26) | 332 — S — 151 (1.55 0.96 2.13) | 332 — S — 152 (2.19 1.26 1.83) |
| 332 — S — 153 (1.57 0.80 2.28) | 332 — S — 192 (1.00 0.81 2.27) | 332 — S — 231 (1.04 0.93 2.16) | 332 — S — 250 (0.99 2.17 0.92) |
| 332 — S — 255 (0.95 0.90 2.18) | 332 — S — 259 (0.81 1.72 1.37) | 332 — S — 271 (1.22 0.99 2.09) | 332 — S — 291 (1.30 0.84 2.25) |
| 332 — S — 320 (0.89 1.32 1.77) | 332 — S — 324 (0.87 1.81 1.27) | 332 — S — 342 (2.04 0.86 2.23) | 332 — S — 343 (2.57 1.35 1.74) |
| 332 — S — 371 (1.73 0.95 2.14) | 332 — S — 429 (2.13 2.05 1.04) | 332 — S — 472 (1.13 1.63 1.46) | 336 — S — 57 (0.88 1.70 1.60) |
| 336 — S — 125 (1.12 2.15 1.15) | 336 — S — 150 (1.54 0.81 2.49) | 336 — S — 151 (1.45 1.07 2.23) | 336 — S — 152 (2.09 1.37 1.93) |
| 336 — S — 153 (1.47 0.91 2.39) | 336 — S — 192 (0.89 0.92 2.37) | 336 — S — 231 (0.94 1.04 2.26) | 336 — S — 250 (0.89 2.28 1.02) |
| 336 — S — 255 (0.85 1.01 2.29) | 336 — S — 271 (1.12 1.10 2.19) | 336 — S — 291 (1.20 0.95 2.35) | 336 — S — 342 (1.94 0.97 2.33) |
| 336 — S — 343 (2.47 1.46 1.84) | 336 — S — 371 (1.63 1.06 2.24) | 336 — S — 429 (2.03 2.16 1.14) | 336 — S — 472 (1.03 1.74 1.56) |
| 337 — S — 9 (1.20 1.07 2.24) | 337 — S — 20 (1.30 1.61 1.69) | 337 — S — 27 (1.22 1.78 1.53) | 337 — S — 28 (1.28 2.05 1.26) |
| 337 — S — 29 (1.04 1.77 1.53) | 337 — S — 40 (0.86 1.77 1.54) | 337 — S — 44 (0.93 0.93 2.38) | 337 — S — 46 (2.45 1.94 1.37) |
| 337 — S — 56 (1.21 1.24 2.07) | 337 — S — 61 (1.19 1.76 1.55) | 337 — S — 62 (1.07 1.96 1.35) | 337 — S — 65 (1.20 1.55 1.76) |
| 337 — S — 68 (0.91 1.51 1.79) | 337 — S — 79 (1.18 1.93 1.38) | 337 — S — 80 (1.14 1.89 1.42) | 337 — S — 81 (1.21 2.01 1.30) |
| 337 — S — 82 (0.95 2.20 1.11) | 337 — S — 83 (1.24 1.18 2.12) | 337 — S — 85 (1.70 1.74 1.57) | 337 — S — 86 (0.92 2.11 1.20) |
| 337 — S — 89 (1.67 2.37 0.94) | 337 — S — 90 (1.58 2.22 1.09) | 337 — S — 101 (1.34 2.07 1.24) | 337 — S — 102 (0.96 1.08 2.23) |
| 337 — S — 105 (1.50 1.16 2.14) | 337 — S — 107 (1.96 1.90 1.41) | 337 — S — 108 (1.52 2.29 1.02) | 337 — S — 110 (1.25 2.07 1.24) |
| 337 — S — 111 (1.95 1.19 2.12) | 337 — S — 112 (1.15 1.56 1.74) | 337 — S — 115 (1.63 2.04 1.27) | 337 — S — 118 (1.24 1.46 1.85) |
| 337 — S — 119 (1.21 1.68 1.63) | 337 — S — 123 (0.85 1.81 1.50) | 337 — S — 131 (1.26 1.14 2.17) | 337 — S — 132 (1.17 1.38 1.92) |
| 337 — S — 133 (1.96 2.19 1.12) | 337 — S — 144 (1.30 2.10 1.21) | 337 — S — 148 (0.95 0.97 2.34) | 337 — S — 150 (2.78 2.07 1.24) |
| 337 — S — 151 (2.69 2.32 0.98) | 337 — S — 153 (2.71 2.17 1.14) | 337 — S — 154 (2.25 1.29 2.01) | 337 — S — 166 (1.97 1.12 2.19) |
| 337 — S — 167 (1.83 0.81 2.50) | 337 — S — 171 (1.74 1.12 2.19) | 337 — S — 177 (1.79 1.85 1.46) | 337 — S — 183 (1.44 2.18 1.13) |
| 337 — S — 184 (2.53 1.66 1.65) | 337 — S — 187 (1.68 1.03 2.28) | 337 — S — 188 (2.11 1.07 2.24) | 337 — S — 192 (2.14 2.18 1.13) |
| 337 — S — 193 (1.06 1.34 1.97) | 337 — S — 195 (1.96 1.50 1.81) | 337 — S — 198 (1.67 1.56 1.75) | 337 — S — 205 (1.19 1.62 1.69) |
| 337 — S — 208 (1.16 1.09 2.21) | 337 — S — 209 (0.90 1.17 2.14) | 337 — S — 213 (1.64 1.52 1.79) | 337 — S — 217 (1.06 1.55 1.76) |
| 337 — S — 218 (1.03 1.73 1.58) | 337 — S — 219 (0.83 1.28 2.02) | 337 — S — 222 (0.95 1.13 2.18) | 337 — S — 230 (0.88 0.96 2.35) |
| 337 — S — 231 (2.18 2.29 1.02) | 337 — S — 233 (1.57 1.71 1.59) | 337 — S — 234 (1.39 1.80 1.51) | 337 — S — 237 (1.40 2.09 1.22) |
| 337 — S — 243 (2.14 0.92 2.39) | 337 — S — 244 (1.45 1.71 1.60) | 337 — S — 245 (1.37 1.48 1.83) | 337 — S — 246 (1.71 2.05 1.26) |
| 337 — S — 251 (1.21 2.29 1.01) | 337 — S — 254 (1.21 1.40 1.90) | 337 — S — 255 (2.10 2.27 1.04) | 337 — S — 265 (1.67 2.19 1.12) |
| 337 — S — 266 (1.30 1.77 1.54) | 337 — S — 267 (1.10 1.47 1.84) | 337 — S — 268 (1.65 2.34 0.97) | 337 — S — 269 (1.61 2.27 1.04) |
| 337 — S — 271 (2.36 2.36 0.95) | 337 — S — 272 (1.49 0.81 2.50) | 337 — S — 274 (0.97 1.27 2.04) | 337 — S — 277 (1.19 1.53 1.77) |
| 337 — S — 279 (1.25 1.60 1.71) | 337 — S — 280 (0.92 1.28 2.03) | 337 — S — 282 (1.04 1.10 2.21) | 337 — S — 284 (0.82 1.11 2.20) |
| 337 — S — 285 (0.97 1.48 1.83) | 337 — S — 286 (1.22 1.38 1.93) | 337 — S — 287 (1.03 1.39 1.91) | 337 — S — 288 (1.01 1.33 1.98) |
| 337 — S — 289 (1.27 1.17 2.14) | 337 — S — 290 (1.30 1.80 1.51) | 337 — S — 291 (2.44 2.20 1.11) | 337 — S — 292 (1.78 1.86 1.45) |
| 337 — S — 293 (1.28 1.67 1.64) | 337 — S — 294 (1.73 1.70 1.60) | 337 — S — 295 (1.49 1.95 1.36) | 337 — S — 296 (1.77 1.94 1.36) |
| 337 — S — 297 (1.08 1.07 2.23) | 337 — S — 298 (1.33 1.55 1.76) | 337 — S — 300 (1.34 0.95 2.36) | 337 — S — 303 (1.10 0.92 2.39) |

| | | | |
|---|---|---|---|
| 337 — S — 304 (1.14 1.39 1.91) | 337 — S — 305 (1.66 1.61 1.70) | 337 — S — 306 (1.82 2.26 1.04) | 337 — S — 307 (1.55 2.39 0.91) |
| 337 — S — 310 (1.25 1.01 2.30) | 337 — S — 311 (0.98 1.28 2.03) | 337 — S — 312 (1.08 1.15 2.15) | 337 — S — 313 (0.85 1.32 1.99) |
| 337 — S — 316 (1.14 1.61 1.70) | 337 — S — 327 (1.43 2.01 1.30) | 337 — S — 331 (1.29 1.19 2.12) | 337 — S — 332 (1.14 1.36 1.94) |
| 337 — S — 336 (1.24 1.25 2.05) | 337 — S — 342 (3.18 2.22 1.09) | 337 — S — 356 (0.91 1.07 2.24) | 337 — S — 357 (1.60 0.82 2.49) |
| 337 — S — 358 (1.09 1.53 1.78) | 337 — S — 367 (1.71 2.17 1.14) | 337 — S — 370 (1.05 1.60 1.71) | 337 — S — 371 (2.87 2.31 1.00) |
| 337 — S — 372 (1.28 1.30 2.01) | 337 — S — 374 (0.89 1.79 1.52) | 337 — S — 379 (0.97 1.29 2.02) | 337 — S — 382 (1.04 1.47 1.83) |
| 337 — S — 391 (0.97 1.28 2.03) | 337 — S — 395 (1.90 2.01 1.30) | 337 — S — 396 (1.33 1.45 1.86) | 337 — S — 397 (1.13 1.29 2.01) |
| 337 — S — 415 (1.02 1.18 2.13) | 337 — S — 430 (0.91 2.11 1.20) | 337 — S — 434 (0.98 1.58 1.72) | 337 — S — 435 (1.06 1.75 1.56) |
| 337 — S — 437 (1.25 1.13 2.18) | 337 — S — 440 (1.59 1.92 1.39) | 337 — S — 441 (1.52 1.85 1.46) | 337 — S — 447 (1.53 2.03 1.27) |
| 337 — S — 449 (1.27 2.00 1.31) | 337 — S — 450 (0.89 1.67 1.64) | 337 — S — 452 (1.67 2.27 1.04) | 337 — S — 453 (1.16 0.97 2.33) |
| 337 — S — 454 (0.98 1.14 2.17) | 337 — S — 455 (0.97 1.41 1.90) | 337 — S — 457 (1.12 1.91 1.39) | 337 — S — 459 (0.90 2.15 1.16) |
| 337 — S — 460 (1.39 2.35 0.96) | 337 — S — 461 (1.11 2.11 1.20) | 337 — S — 462 (0.80 2.12 1.19) | 337 — S — 468 (1.00 1.82 1.49) |
| 337 — S — 469 (1.09 2.25 1.06) | 337 — S — 471 (1.69 1.58 1.73) | 337 — S — 473 (1.74 2.19 1.12) | 337 — S — 474 (1.59 2.08 1.23) |
| 338 — S — 46 (0.90 1.92 2.91) | 338 — S — 125 (0.82 3.38 1.45) | 338 — S — 150 (1.24 2.04 2.79) | 338 — S — 151 (1.15 2.30 2.53) |
| 338 — S — 152 (1.79 2.60 2.23) | 338 — S — 153 (1.17 2.14 2.69) | 338 — S — 184 (0.99 1.64 3.20) | 338 — S — 271 (0.82 2.34 2.50) |
| 338 — S — 291 (0.90 2.18 2.65) | 338 — S — 342 (1.64 2.20 2.63) | 338 — S — 343 (2.17 2.69 2.14) | 338 — S — 371 (1.33 2.29 2.54) |
| 338 — S — 429 (1.73 3.39 1.44) | 339 — S — 9 (1.26 1.43 2.18) | 339 — S — 19 (0.83 1.33 2.28) | 339 — S — 20 (1.36 1.98 1.63) |
| 339 — S — 27 (1.27 2.15 1.47) | 339 — S — 28 (1.34 2.42 1.20) | 339 — S — 29 (1.10 2.14 1.48) | 339 — S — 40 (0.92 2.14 1.48) |
| 339 — S — 44 (0.99 1.30 2.32) | 339 — S — 46 (2.51 2.30 1.31) | 339 — S — 56 (1.26 1.61 2.01) | 339 — S — 61 (1.25 2.12 1.49) |
| 339 — S — 62 (1.13 2.32 1.29) | 339 — S — 65 (1.26 1.92 1.70) | 339 — S — 68 (0.97 1.88 1.73) | 339 — S — 79 (1.24 2.29 1.32) |
| 339 — S — 80 (1.20 2.25 1.36) | 339 — S — 81 (1.27 2.38 1.24) | 339 — S — 82 (1.01 2.56 1.05) | 339 — S — 83 (1.30 1.55 2.07) |
| 339 — S — 85 (1.76 2.10 1.51) | 339 — S — 86 (0.97 2.47 1.14) | 339 — S — 90 (1.64 2.58 1.03) | 339 — S — 101 (1.40 2.43 1.18) |
| 339 — S — 102 (1.02 1.44 2.17) | 339 — S — 105 (1.56 1.53 2.09) | 339 — S — 106 (0.97 0.97 2.65) | 339 — S — 107 (2.02 2.27 1.35) |
| 339 — S — 108 (1.58 2.66 0.96) | 339 — S — 110 (1.31 2.43 1.18) | 339 — S — 111 (2.01 1.55 2.06) | 339 — S — 112 (1.20 1.93 1.69) |
| 339 — S — 114 (0.85 1.21 2.41) | 339 — S — 115 (1.68 2.41 1.21) | 339 — S — 118 (1.29 1.83 1.79) | 339 — S — 119 (1.27 2.04 1.57) |
| 339 — S — 123 (0.91 2.17 1.44) | 339 — S — 127 (0.92 0.85 2.77) | 339 — S — 131 (1.32 1.50 2.11) | 339 — S — 132 (1.23 1.75 1.86) |
| 339 — S — 133 (2.02 2.56 1.06) | 339 — S — 144 (1.36 2.47 1.15) | 339 — S — 148 (1.01 1.34 2.28) | 339 — S — 150 (2.84 2.43 1.18) |
| 339 — S — 151 (2.75 2.69 0.93) | 339 — S — 153 (2.77 2.53 1.08) | 339 — S — 154 (2.31 1.66 1.96) | 339 — S — 158 (1.38 0.87 2.74) |
| 339 — S — 161 (1.82 0.96 2.65) | 339 — S — 166 (2.03 1.49 2.13) | 339 — S — 167 (1.89 1.17 2.44) | 339 — S — 170 (2.10 0.90 2.72) |
| 339 — S — 171 (1.80 1.48 2.13) | 339 — S — 175 (1.03 1.12 2.49) | 339 — S — 176 (0.97 0.88 2.74) | 339 — S — 177 (1.85 2.21 1.40) |
| 339 — S — 182 (0.99 1.05 2.56) | 339 — S — 183 (1.50 2.55 1.07) | 339 — S — 184 (2.59 2.02 1.59) | 339 — S — 187 (1.73 1.39 2.22) |
| 339 — S — 188 (2.17 1.43 2.18) | 339 — S — 189 (1.91 1.02 2.59) | 339 — S — 192 (2.20 2.54 1.07) | 339 — S — 193 (1.11 1.71 1.91) |
| 339 — S — 194 (1.97 1.15 2.47) | 339 — S — 195 (2.02 1.87 1.75) | 339 — S — 197 (2.16 0.93 2.68) | 339 — S — 198 (1.73 1.93 1.69) |
| 339 — S — 205 (1.25 1.99 1.63) | 339 — S — 208 (1.21 1.46 2.16) | 339 — S — 209 (0.96 1.54 2.08) | 339 — S — 210 (0.86 0.94 2.67) |
| 339 — S — 213 (1.70 1.88 1.73) | 339 — S — 214 (1.26 1.12 2.50) | 339 — S — 217 (1.12 1.92 1.70) | 339 — S — 218 (1.09 2.09 1.52) |
| 339 — S — 219 (0.89 1.65 1.97) | 339 — S — 222 (1.01 1.50 2.12) | 339 — S — 230 (0.93 1.32 2.29) | 339 — S — 231 (2.24 2.66 0.96) |
| 339 — S — 233 (1.63 2.08 1.53) | 339 — S — 234 (1.45 2.16 1.45) | 339 — S — 236 (1.67 1.05 2.57) | 339 — S — 237 (1.46 2.46 1.16) |
| 339 — S — 240 (1.06 0.94 2.67) | 339 — S — 243 (2.19 1.29 2.33) | 339 — S — 244 (1.51 2.07 1.54) | 339 — S — 245 (1.43 1.85 1.77) |
| 339 — S — 246 (1.76 2.41 1.20) | 339 — S — 251 (1.27 2.66 0.96) | 339 — S — 254 (1.26 1.77 1.84) | 339 — S — 255 (2.16 2.63 0.98) |
| 339 — S — 261 (0.89 0.85 2.76) | 339 — S — 265 (1.73 2.55 1.06) | 339 — S — 266 (1.36 2.13 1.48) | 339 — S — 267 (1.16 1.83 1.78) |
| 339 — S — 268 (1.71 2.70 0.91) | 339 — S — 269 (1.67 2.63 0.98) | 339 — S — 272 (1.55 1.18 2.44) | 339 — S — 274 (1.03 1.63 1.98) |
| 339 — S — 275 (0.84 2.05 1.56) | 339 — S — 276 (0.95 1.04 2.58) | 339 — S — 277 (1.25 1.90 1.72) | 339 — S — 279 (1.30 1.96 1.65) |
| 339 — S — 280 (0.98 1.64 1.97) | 339 — S — 282 (1.10 1.47 2.15) | 339 — S — 284 (0.88 1.47 2.14) | 339 — S — 285 (1.03 1.84 1.77) |
| 339 — S — 286 (1.28 1.75 1.87) | 339 — S — 287 (1.09 1.76 1.86) | 339 — S — 288 (1.07 1.70 1.92) | 339 — S — 289 (1.33 1.54 2.08) |
| 339 — S — 290 (1.36 2.16 1.45) | 339 — S — 291 (2.50 2.57 1.05) | 339 — S — 292 (1.83 2.23 1.39) | 339 — S — 293 (1.34 2.04 1.58) |
| 339 — S — 294 (1.79 2.07 1.55) | 339 — S — 295 (1.55 2.31 1.30) | 339 — S — 296 (1.82 2.31 1.31) | 339 — S — 297 (1.14 1.44 2.18) |
| 339 — S — 298 (1.39 1.91 1.70) | 339 — S — 300 (1.40 1.31 2.30) | 339 — S — 301 (1.45 1.02 2.59) | 339 — S — 302 (1.57 0.87 2.74) |
| 339 — S — 303 (1.16 1.29 2.33) | 339 — S — 304 (1.20 1.76 1.85) | 339 — S — 305 (1.71 1.98 1.64) | 339 — S — 306 (1.88 2.63 0.98) |
| 339 — S — 308 (1.19 0.92 2.69) | 339 — S — 310 (1.31 1.37 2.24) | 339 — S — 311 (1.04 1.65 1.97) | 339 — S — 312 (1.13 1.52 2.10) |
| 339 — S — 313 (0.91 1.69 1.93) | 339 — S — 316 (1.20 1.97 1.64) | 339 — S — 318 (1.49 1.02 2.60) | 339 — S — 327 (1.49 2.38 1.24) |
| 339 — S — 330 (0.82 1.38 2.23) | 339 — S — 331 (1.35 1.56 2.06) | 339 — S — 332 (1.20 1.73 1.88) | 339 — S — 336 (1.30 1.62 2.00) |
| 339 — S — 342 (3.24 2.59 1.03) | 339 — S — 352 (0.91 0.86 2.76) | 339 — S — 353 (0.84 0.90 2.72) | 339 — S — 356 (0.97 1.44 2.18) |
| 339 — S — 357 (1.66 1.18 2.43) | 339 — S — 358 (1.14 1.89 1.72) | 339 — S — 367 (1.77 2.53 1.08) | 339 — S — 370 (1.11 1.96 1.65) |
| 339 — S — 371 (2.93 2.68 0.94) | 339 — S — 372 (1.34 1.66 1.95) | 339 — S — 374 (0.95 2.15 1.46) | 339 — S — 379 (1.03 1.66 1.96) |
| 339 — S — 380 (0.87 1.08 2.54) | 339 — S — 382 (1.09 1.84 1.78) | 339 — S — 391 (1.03 1.65 1.97) | 339 — S — 394 (0.93 0.94 2.67) |
| 339 — S — 395 (1.96 2.38 1.24) | 339 — S — 396 (1.39 1.81 1.80) | 339 — S — 397 (1.19 1.66 1.96) | 339 — S — 403 (0.98 0.91 2.71) |
| 339 — S — 415 (1.08 1.54 2.07) | 339 — S — 430 (0.97 2.48 1.14) | 339 — S — 432 (1.21 1.15 2.46) | 339 — S — 433 (0.92 1.16 2.45) |
| 339 — S — 434 (1.04 1.95 1.67) | 339 — S — 435 (1.12 2.12 1.50) | 339 — S — 437 (1.30 1.49 2.12) | 339 — S — 440 (1.65 2.29 1.33) |

339 — S — 441 (1.58 2.21 1.40) 339 — S — 444 (1.11 0.80 2.81) 339 — S — 447 (1.59 2.40 1.22) 339 — S — 449 (1.33 2.37 1.25)
339 — S — 450 (0.95 2.03 1.58) 339 — S — 452 (1.73 2.63 0.98) 339 — S — 453 (1.22 1.34 2.28) 339 — S — 454 (1.04 1.50 2.11)
339 — S — 455 (1.03 1.77 1.84) 339 — S — 457 (1.17 2.28 1.34) 339 — S — 459 (0.96 2.51 1.10) 339 — S — 460 (1.45 2.71 0.90)
339 — S — 461 (1.17 2.47 1.14) 339 — S — 462 (0.86 2.49 1.13) 339 — S — 467 (0.86 1.88 1.73) 339 — S — 468 (1.06 2.19 1.43)
339 — S — 469 (1.15 2.61 1.00) 339 — S — 471 (1.75 1.94 1.67) 339 — S — 473 (1.80 2.56 1.06) 339 — S — 474 (1.65 2.45 1.17)
341 — S — 57 (1.38 1.07 1.09) 341 — S — 93 (0.91 1.23 0.94) 341 — S — 165 (0.88 1.16 1.01) 341 — S — 215 (1.20 0.87 1.30)
341 — S — 259 (1.21 1.20 0.96) 341 — S — 270 (1.01 1.06 1.10) 341 — S — 320 (1.30 0.80 1.36) 341 — S — 343 (2.97 0.83 1.33)
341 — S — 364 (1.15 0.96 1.20) 341 — S — 368 (1.08 0.83 1.34) 341 — S — 463 (0.81 0.83 1.33) 341 — S — 472 (1.53 1.11 1.06)
344 — S — 9 (0.90 1.55 2.54) 344 — S — 20 (1.01 2.09 1.99) 344 — S — 27 (0.92 2.26 1.82) 344 — S — 28 (0.98 2.53 1.55)
344 — S — 36 (1.14 3.04 1.04) 344 — S — 43 (1.56 2.90 1.19) 344 — S — 46 (2.15 2.42 1.67) 344 — S — 56 (0.91 1.72 2.36)
344 — S — 61 (0.89 2.23 1.85) 344 — S — 65 (0.90 2.03 2.05) 344 — S — 70 (1.62 3.11 0.98) 344 — S — 79 (0.89 2.41 1.68)
344 — S — 80 (0.84 2.36 1.72) 344 — S — 81 (0.92 2.49 1.59) 344 — S — 83 (0.95 1.66 2.42) 344 — S — 85 (1.40 2.22 1.87)
344 — S — 89 (1.38 2.84 1.24) 344 — S — 90 (1.29 2.69 1.39) 344 — S — 101 (1.04 2.55 1.54) 344 — S — 105 (1.20 1.64 2.44)
344 — S — 107 (1.66 2.38 1.70) 344 — S — 108 (1.22 2.77 1.31) 344 — S — 109 (1.46 2.91 1.18) 344 — S — 110 (0.96 2.54 1.54)
344 — S — 111 (1.66 1.66 2.42) 344 — S — 112 (0.85 2.04 2.04) 344 — S — 113 (1.06 2.96 1.12) 344 — S — 115 (1.33 2.52 1.56)
344 — S — 118 (0.94 1.94 2.14) 344 — S — 119 (0.91 2.16 1.93) 344 — S — 131 (0.97 1.62 2.46) 344 — S — 132 (0.88 1.86 2.22)
344 — S — 133 (1.67 2.67 1.41) 344 — S — 144 (1.00 2.58 1.50) 344 — S — 150 (2.49 2.54 1.54) 344 — S — 151 (2.39 2.80 1.28)
344 — S — 152 (3.04 3.10 0.98) 344 — S — 153 (2.42 2.64 1.44) 344 — S — 154 (1.95 1.77 2.31) 344 — S — 158 (1.02 0.98 3.10)
344 — S — 161 (1.46 1.07 3.01) 344 — S — 166 (1.67 1.60 2.48) 344 — S — 167 (1.53 1.28 2.80) 344 — S — 170 (1.74 1.01 3.07)
344 — S — 171 (1.44 1.60 2.49) 344 — S — 177 (1.50 2.32 1.76) 344 — S — 183 (1.15 2.66 1.42) 344 — S — 184 (2.23 2.14 1.95)
344 — S — 187 (1.38 1.51 2.57) 344 — S — 188 (1.81 1.55 2.53) 344 — S — 189 (1.56 1.14 2.95) 344 — S — 192 (1.84 2.66 1.43)
344 — S — 194 (1.61 1.26 2.82) 344 — S — 195 (1.67 1.98 2.10) 344 — S — 197 (1.81 1.04 3.04) 344 — S — 198 (1.38 2.04 2.04)
344 — S — 205 (0.90 2.10 1.98) 344 — S — 206 (0.89 3.01 1.07) 344 — S — 207 (1.41 2.96 1.12) 344 — S — 208 (0.86 1.57 2.51)
344 — S — 213 (1.34 2.00 2.09) 344 — S — 214 (0.90 1.23 2.85) 344 — S — 231 (1.88 2.77 1.31) 344 — S — 233 (1.27 2.19 1.89)
344 — S — 234 (1.09 2.27 1.81) 344 — S — 236 (1.31 1.16 2.92) 344 — S — 237 (1.10 2.57 1.51) 344 — S — 243 (1.84 1.40 2.68)
344 — S — 244 (1.16 2.19 1.90) 344 — S — 245 (1.07 1.96 2.12) 344 — S — 246 (1.41 2.53 1.56) 344 — S — 248 (1.48 3.07 1.01)
344 — S — 249 (0.95 2.91 1.17) 344 — S — 251 (0.92 2.77 1.31) 344 — S — 254 (0.91 1.88 2.20) 344 — S — 255 (1.80 2.74 1.34)
344 — S — 265 (1.37 2.67 1.42) 344 — S — 266 (1.01 2.24 1.84) 344 — S — 267 (0.81 1.94 2.14) 344 — S — 268 (1.35 2.82 1.27)
344 — S — 269 (1.31 2.74 1.34) 344 — S — 271 (2.06 2.84 1.25) 344 — S — 272 (1.19 1.29 2.79) 344 — S — 277 (0.90 2.01 2.07)
344 — S — 279 (0.95 2.07 2.01) 344 — S — 286 (0.93 1.86 2.22) 344 — S — 289 (0.98 1.65 2.43) 344 — S — 290 (1.01 2.28 1.81)
344 — S — 291 (2.15 2.68 1.40) 344 — S — 292 (1.48 2.34 1.74) 344 — S — 293 (0.98 2.15 1.93) 344 — S — 294 (1.44 2.18 1.90)
344 — S — 295 (1.19 2.43 1.66) 344 — S — 296 (1.47 2.42 1.66) 344 — S — 298 (1.04 2.03 2.06) 344 — S — 300 (1.04 1.43 2.66)
344 — S — 301 (1.10 1.14 2.95) 344 — S — 302 (1.22 0.99 3.10) 344 — S — 303 (0.80 1.40 2.68) 344 — S — 304 (0.84 1.87 2.21)
344 — S — 305 (1.36 2.09 1.99) 344 — S — 306 (1.52 2.74 1.34) 344 — S — 307 (1.25 2.87 1.21) 344 — S — 308 (0.84 1.03 3.05)
344 — S — 310 (0.96 1.48 2.60) 344 — S — 316 (0.84 2.09 1.99) 344 — S — 318 (1.14 1.13 2.95) 344 — S — 320 (1.74 3.16 0.92)
344 — S — 327 (1.13 2.49 1.59) 344 — S — 329 (1.46 2.95 1.13) 344 — S — 331 (0.99 1.67 2.41) 344 — S — 332 (0.85 1.84 2.24)
344 — S — 336 (0.95 1.73 2.35) 344 — S — 342 (2.89 2.70 1.38) 344 — S — 357 (1.31 1.30 2.79) 344 — S — 367 (1.42 2.64 1.44)
344 — S — 371 (2.58 2.79 1.29) 344 — S — 372 (0.99 1.77 2.31) 344 — S — 395 (1.61 2.49 1.59) 344 — S — 396 (1.03 1.93 2.16)
344 — S — 397 (0.84 1.77 2.31) 344 — S — 432 (0.86 1.26 2.82) 344 — S — 437 (0.95 1.61 2.48) 344 — S — 440 (1.29 2.40 1.68)
344 — S — 441 (1.22 2.33 1.76) 344 — S — 447 (1.23 2.51 1.57) 344 — S — 449 (0.98 2.48 1.60) 344 — S — 451 (1.32 3.09 0.99)
344 — S — 452 (1.37 2.75 1.33) 344 — S — 453 (0.86 1.45 2.63) 344 — S — 457 (0.82 2.39 1.69) 344 — S — 460 (1.10 2.82 1.26)
344 — S — 461 (0.81 2.58 1.50) 344 — S — 471 (1.40 2.06 2.03) 344 — S — 473 (1.44 2.67 1.41) 344 — S — 474 (1.30 2.56 1.52)
345 — S — 20 (0.88 1.94 2.12) 345 — S — 28 (0.86 2.38 1.68) 345 — S — 36 (1.02 2.89 1.17) 345 — S — 43 (1.43 2.74 1.31)
345 — S — 46 (2.03 2.26 1.79) 345 — S — 70 (1.50 2.95 1.10) 345 — S — 83 (0.82 1.51 2.55) 345 — S — 85 (1.28 2.07 1.99)
345 — S — 89 (1.25 2.69 1.36) 345 — S — 90 (1.16 2.54 1.51) 345 — S — 101 (0.91 2.39 1.66) 345 — S — 105 (1.08 1.49 2.57)
345 — S — 107 (1.54 2.23 1.83) 345 — S — 108 (1.10 2.62 1.44) 345 — S — 109 (1.33 2.75 1.30) 345 — S — 110 (0.83 2.39 1.66)
345 — S — 111 (1.53 1.51 2.54) 345 — S — 113 (0.93 2.81 1.25) 345 — S — 115 (1.20 2.37 1.69) 345 — S — 118 (0.81 1.79 2.27)
345 — S — 131 (0.84 1.47 2.59) 345 — S — 133 (1.54 2.52 1.54) 345 — S — 144 (0.87 2.43 1.63) 345 — S — 145 (0.85 3.08 0.98)
345 — S — 150 (2.36 2.39 1.67) 345 — S — 151 (2.27 2.65 1.41) 345 — S — 152 (2.91 2.95 1.11) 345 — S — 153 (2.29 2.49 1.56)
345 — S — 154 (1.83 1.62 2.44) 345 — S — 158 (0.90 0.83 3.22) 345 — S — 161 (1.34 0.92 3.13) 345 — S — 166 (1.55 1.45 2.61)
345 — S — 167 (1.41 1.13 2.92) 345 — S — 170 (1.62 0.86 3.20) 345 — S — 171 (1.32 1.44 2.61) 345 — S — 177 (1.37 2.17 1.89)
345 — S — 183 (1.02 2.51 1.55) 345 — S — 184 (2.11 1.98 2.07) 345 — S — 187 (1.25 1.36 2.70) 345 — S — 188 (1.69 1.40 2.66)
345 — S — 189 (1.43 0.98 3.07) 345 — S — 192 (1.72 2.50 1.55) 345 — S — 194 (1.49 1.11 2.95) 345 — S — 195 (1.54 1.83 2.23)
345 — S — 197 (1.68 0.89 3.16) 345 — S — 198 (1.25 1.89 2.17) 345 — S — 207 (1.29 2.81 1.25) 345 — S — 213 (1.22 1.84 2.21)
345 — S — 215 (1.52 3.07 0.98) 345 — S — 231 (1.76 2.62 1.44) 345 — S — 233 (1.14 2.04 2.02) 345 — S — 234 (0.96 2.12 1.93)
345 — S — 236 (1.19 1.01 3.05) 345 — S — 237 (0.98 2.42 1.64) 345 — S — 243 (1.71 1.25 2.81) 345 — S — 244 (1.03 2.03 2.02)
345 — S — 245 (0.95 1.81 2.25) 345 — S — 246 (1.28 2.37 1.68) 345 — S — 248 (1.35 2.92 1.14) 345 — S — 249 (0.82 2.76 1.29)
345 — S — 255 (1.67 2.59 1.46) 345 — S — 265 (1.24 2.51 1.54) 345 — S — 266 (0.88 2.09 1.96) 345 — S — 268 (1.22 2.66 1.39)

345 — S — 269 (1.19 2.59 1.46) 345 — S — 271 (1.94 2.68 1.37) 345 — S — 272 (1.06 1.14 2.92) 345 — S — 279 (0.82 1.92 2.13)
345 — S — 289 (0.85 1.50 2.56) 345 — S — 290 (0.88 2.12 1.93) 345 — S — 291 (2.02 2.53 1.53) 345 — S — 292 (1.35 2.19 1.87)
345 — S — 293 (0.86 2.00 2.06) 345 — S — 294 (1.31 2.03 2.03) 345 — S — 295 (1.07 2.27 1.78) 345 — S — 296 (1.34 2.27 1.79)
345 — S — 298 (0.91 1.87 2.18) 345 — S — 300 (0.92 1.27 2.78) 345 — S — 301 (0.97 0.99 3.07) 345 — S — 302 (1.09 0.83 3.22)
345 — S — 305 (1.23 1.94 2.12) 345 — S — 306 (1.39 2.59 1.47) 345 — S — 307 (1.12 2.72 1.34) 345 — S — 310 (0.83 1.33 2.72)
345 — S — 318 (1.01 0.98 3.08) 345 — S — 320 (1.61 3.01 1.05) 345 — S — 327 (1.01 2.34 1.72) 345 — S — 329 (1.33 2.80 1.26)
345 — S — 331 (0.87 1.52 2.54) 345 — S — 336 (0.82 1.58 2.48) 345 — S — 342 (2.76 2.55 1.51) 345 — S — 343 (3.29 3.04 1.02)
345 — S — 357 (1.18 1.14 2.91) 345 — S — 367 (1.29 2.49 1.56) 345 — S — 368 (1.40 3.04 1.02) 345 — S — 371 (2.45 2.64 1.42)
345 — S — 372 (0.86 1.62 2.43) 345 — S — 395 (1.48 2.34 1.72) 345 — S — 396 (0.91 1.78 2.28) 345 — S — 437 (0.82 1.46 2.60)
345 — S — 440 (1.17 2.25 1.81) 345 — S — 441 (1.10 2.17 1.88) 345 — S — 447 (1.11 2.36 1.70) 345 — S — 449 (0.85 2.33 1.73)
345 — S — 451 (1.19 2.94 1.12) 345 — S — 452 (1.25 2.60 1.46) 345 — S — 460 (0.97 2.67 1.38) 345 — S — 463 (1.12 3.04 1.01)
345 — S — 471 (1.27 1.90 2.15) 345 — S — 473 (1.32 2.52 1.54) 345 — S — 474 (1.17 2.41 1.65) 346 — S — 36 (0.83 2.87 1.35)
346 — S — 37 (0.83 3.17 1.05) 346 — S — 43 (1.25 2.73 1.50) 346 — S — 46 (1.84 2.25 1.97) 346 — S — 57 (1.52 3.27 0.96)
346 — S — 70 (1.31 2.94 1.29) 346 — S — 85 (1.09 2.05 2.17) 346 — S — 89 (1.07 2.68 1.55) 346 — S — 90 (0.98 2.53 1.70)
346 — S — 105 (0.89 1.47 2.75) 346 — S — 107 (1.36 2.21 2.01) 346 — S — 108 (0.92 2.60 1.62) 346 — S — 109 (1.15 2.74 1.48)
346 — S — 111 (1.35 1.50 2.73) 346 — S — 115 (1.02 2.35 1.87) 346 — S — 133 (1.36 2.50 1.72) 346 — S — 150 (2.18 2.38 1.85)
346 — S — 151 (2.09 2.63 1.59) 346 — S — 152 (2.73 2.93 1.29) 346 — S — 153 (2.11 2.48 1.75) 346 — S — 154 (1.64 1.60 2.62)
346 — S — 161 (1.15 0.91 3.32) 346 — S — 166 (1.36 1.43 2.79) 346 — S — 167 (1.23 1.12 3.11) 346 — S — 170 (1.43 0.84 3.38)
346 — S — 171 (1.13 1.43 2.80) 346 — S — 177 (1.19 2.16 2.07) 346 — S — 183 (0.84 2.49 1.73) 346 — S — 184 (1.93 1.97 2.26)
346 — S — 187 (1.07 1.34 2.88) 346 — S — 188 (1.50 1.38 2.84) 346 — S — 189 (1.25 0.97 3.26) 346 — S — 192 (1.53 2.49 1.73)
346 — S — 194 (1.30 1.09 3.13) 346 — S — 195 (1.36 1.81 2.41) 346 — S — 197 (1.50 0.88 3.35) 346 — S — 198 (1.07 1.87 2.35)
346 — S — 207 (1.10 2.79 1.43) 346 — S — 213 (1.04 1.83 2.40) 346 — S — 215 (1.34 3.06 1.17) 346 — S — 231 (1.58 2.60 1.62)
346 — S — 233 (0.96 2.03 2.20) 346 — S — 236 (1.00 0.99 3.23) 346 — S — 243 (1.53 1.23 2.99) 346 — S — 244 (0.85 2.02 2.20)
346 — S — 246 (1.10 2.36 1.87) 346 — S — 248 (1.17 2.91 1.32) 346 — S — 255 (1.49 2.58 1.65) 346 — S — 265 (1.06 2.50 1.72)
346 — S — 268 (1.04 2.65 1.58) 346 — S — 269 (1.01 2.58 1.65) 346 — S — 270 (1.15 3.26 0.97) 346 — S — 271 (1.76 2.67 1.55)
346 — S — 272 (0.88 1.12 3.10) 346 — S — 291 (1.84 2.51 1.71) 346 — S — 292 (1.17 2.17 2.05) 346 — S — 294 (1.13 2.01 2.21)
346 — S — 295 (0.88 2.26 1.97) 346 — S — 296 (1.16 2.25 1.97) 346 — S — 302 (0.91 0.82 3.41) 346 — S — 305 (1.05 1.92 2.30)
346 — S — 306 (1.21 2.58 1.65) 346 — S — 307 (0.94 2.70 1.52) 346 — S — 318 (0.83 0.96 3.26) 346 — S — 320 (1.43 2.99 1.23)
346 — S — 327 (0.82 2.32 1.90) 346 — S — 329 (1.15 2.78 1.44) 346 — S — 342 (2.58 2.53 1.69) 346 — S — 343 (3.11 3.02 1.20)
346 — S — 357 (1.00 1.13 3.09) 346 — S — 364 (1.29 3.15 1.07) 346 — S — 367 (1.11 2.48 1.75) 346 — S — 368 (1.22 3.02 1.20)
346 — S — 371 (2.27 2.62 1.60) 346 — S — 395 (1.30 2.32 1.90) 346 — S — 440 (0.98 2.23 1.99) 346 — S — 441 (0.91 2.16 2.07)
346 — S — 447 (0.93 2.34 1.88) 346 — S — 451 (1.01 2.92 1.30) 346 — S — 452 (1.06 2.58 1.64) 346 — S — 463 (0.94 3.03 1.20)
346 — S — 471 (1.09 1.89 2.33) 346 — S — 472 (1.67 3.30 0.92) 346 — S — 473 (1.14 2.50 1.72) 346 — S — 474 (0.99 2.39 1.83)
347 — S — 36 (0.89 2.96 1.30) 347 — S — 37 (0.88 3.26 1.00) 347 — S — 43 (1.30 2.82 1.44) 347 — S — 46 (1.90 2.34 1.92)
347 — S — 57 (1.57 3.35 0.91) 347 — S — 70 (1.36 3.03 1.23) 347 — S — 85 (1.15 2.14 2.12) 347 — S — 89 (1.12 2.76 1.50)
347 — S — 90 (1.03 2.61 1.65) 347 — S — 105 (0.94 1.56 2.70) 347 — S — 107 (1.41 2.30 1.96) 347 — S — 108 (0.97 2.69 1.57)
347 — S — 109 (1.20 2.83 1.43) 347 — S — 111 (1.40 1.59 2.67) 347 — S — 113 (0.80 2.88 1.38) 347 — S — 115 (1.07 2.44 1.82)
347 — S — 133 (1.41 2.59 1.67) 347 — S — 150 (2.23 2.46 1.80) 347 — S — 151 (2.14 2.72 1.54) 347 — S — 152 (2.78 3.02 1.24)
347 — S — 153 (2.16 2.56 1.70) 347 — S — 154 (1.69 1.69 2.57) 347 — S — 161 (1.20 0.99 3.27) 347 — S — 166 (1.41 1.52 2.74)
347 — S — 167 (1.28 1.20 3.05) 347 — S — 170 (1.49 0.93 3.33) 347 — S — 171 (1.19 1.52 2.74) 347 — S — 177 (1.24 2.24 2.02)
347 — S — 183 (0.89 2.58 1.68) 347 — S — 184 (1.98 2.06 2.20) 347 — S — 187 (1.12 1.43 2.83) 347 — S — 188 (1.55 1.47 2.79)
347 — S — 189 (1.30 1.06 3.20) 347 — S — 192 (1.58 2.58 1.68) 347 — S — 194 (1.35 1.18 3.08) 347 — S — 195 (1.41 1.90 2.36)
347 — S — 197 (1.55 0.97 3.29) 347 — S — 198 (1.12 1.96 2.30) 347 — S — 207 (1.15 2.88 1.38) 347 — S — 213 (1.09 1.92 2.34)
347 — S — 215 (1.39 3.15 1.11) 347 — S — 231 (1.63 2.69 1.57) 347 — S — 233 (1.01 2.11 2.15) 347 — S — 234 (0.83 2.20 2.06)
347 — S — 236 (1.05 1.08 3.18) 347 — S — 237 (0.84 2.49 1.77) 347 — S — 243 (1.58 1.32 2.94) 347 — S — 244 (0.90 2.11 2.15)
347 — S — 245 (0.82 1.88 2.38) 347 — S — 246 (1.15 2.45 1.81) 347 — S — 248 (1.22 2.99 1.27) 347 — S — 255 (1.54 2.66 1.60)
347 — S — 265 (1.11 2.59 1.67) 347 — S — 268 (1.09 2.74 1.52) 347 — S — 269 (1.06 2.66 1.59) 347 — S — 270 (1.20 3.34 0.92)
347 — S — 271 (1.81 2.76 1.50) 347 — S — 272 (0.93 1.21 3.05) 347 — S — 291 (1.89 2.60 1.66) 347 — S — 292 (1.22 2.26 2.00)
347 — S — 294 (1.18 2.10 2.16) 347 — S — 295 (0.93 2.35 1.91) 347 — S — 296 (1.21 2.34 1.92) 347 — S — 301 (0.84 1.06 3.20)
347 — S — 302 (0.96 0.91 3.35) 347 — S — 305 (1.10 2.01 2.25) 347 — S — 306 (1.26 2.66 1.60) 347 — S — 307 (0.99 2.79 1.47)
347 — S — 318 (0.88 1.05 3.21) 347 — S — 320 (1.48 3.08 1.18) 347 — S — 327 (0.88 2.41 1.85) 347 — S — 329 (1.20 2.87 1.39)
347 — S — 342 (2.63 2.62 1.64) 347 — S — 343 (3.16 3.11 1.15) 347 — S — 357 (1.05 1.22 3.04) 347 — S — 364 (1.34 3.24 1.02)
347 — S — 367 (1.16 2.56 1.70) 347 — S — 368 (1.27 3.11 1.15) 347 — S — 371 (2.32 2.71 1.55) 347 — S — 395 (1.35 2.41 1.85)
347 — S — 440 (1.04 2.32 1.94) 347 — S — 441 (0.97 2.25 2.01) 347 — S — 447 (0.98 2.43 1.83) 347 — S — 451 (1.06 3.01 1.25)
347 — S — 452 (1.12 2.67 1.59) 347 — S — 460 (0.84 2.74 1.52) 347 — S — 463 (0.99 3.11 1.15) 347 — S — 471 (1.14 1.98 2.28)
347 — S — 473 (1.19 2.59 1.67) 347 — S — 474 (1.04 2.48 1.78) 348 — S — 9 (0.99 1.23 2.44) 348 — S — 20 (1.10 1.77 1.90)
348 — S — 27 (1.01 1.94 1.73) 348 — S — 28 (1.07 2.21 1.46) 348 — S — 29 (0.84 1.93 1.74) 348 — S — 36 (1.23 2.72 0.95)
348 — S — 43 (1.65 2.58 1.10) 348 — S — 46 (2.24 2.10 1.58) 348 — S — 56 (1.00 1.40 2.27) 348 — S — 61 (0.98 1.92 1.76)

348 — S — 62 (0.86 2.12 1.56) 348 — S — 65 (0.99 1.71 1.96) 348 — S — 79 (0.98 2.09 1.59) 348 — S — 80 (0.93 2.05 1.63)
348 — S — 81 (1.01 2.17 1.50) 348 — S — 83 (1.04 1.34 2.33) 348 — S — 85 (1.49 1.90 1.77) 348 — S — 89 (1.47 2.53 1.15)
348 — S — 90 (1.38 2.38 1.30) 348 — S — 101 (1.13 2.23 1.45) 348 — S — 105 (1.29 1.32 2.35) 348 — S — 107 (1.75 2.06 1.61)
348 — S — 108 (1.31 2.45 1.22) 348 — S — 109 (1.55 2.59 1.09) 348 — S — 110 (1.05 2.23 1.45) 348 — S — 111 (1.75 1.35 2.33)
348 — S — 112 (0.94 1.72 1.95) 348 — S — 113 (1.15 2.64 1.03) 348 — S — 115 (1.42 2.20 1.47) 348 — S — 118 (1.03 1.62 2.05)
348 — S — 119 (1.00 1.84 1.84) 348 — S — 131 (1.06 1.30 2.37) 348 — S — 132 (0.97 1.54 2.13) 348 — S — 133 (1.76 2.35 1.32)
348 — S — 144 (1.09 2.26 1.41) 348 — S — 150 (2.58 2.23 1.45) 348 — S — 151 (2.48 2.48 1.19) 348 — S — 153 (2.51 2.33 1.35)
348 — S — 154 (2.04 1.45 2.22) 348 — S — 166 (1.76 1.28 2.39) 348 — S — 167 (1.63 0.97 2.71) 348 — S — 171 (1.53 1.28 2.40)
348 — S — 177 (1.59 2.01 1.67) 348 — S — 183 (1.24 2.34 1.33) 348 — S — 184 (2.33 1.82 1.86) 348 — S — 187 (1.47 1.19 2.48)
348 — S — 188 (1.90 1.23 2.44) 348 — S — 189 (1.65 0.82 2.86) 348 — S — 192 (1.93 2.34 1.34) 348 — S — 193 (0.85 1.50 2.17)
348 — S — 194 (1.70 0.94 2.73) 348 — S — 195 (1.76 1.66 2.01) 348 — S — 198 (1.47 1.72 1.95) 348 — S — 205 (0.99 1.78 1.89)
348 — S — 206 (0.98 2.69 0.98) 348 — S — 207 (1.50 2.64 1.03) 348 — S — 208 (0.95 1.25 2.42) 348 — S — 213 (1.43 1.68 2.00)
348 — S — 214 (1.00 0.91 2.76) 348 — S — 217 (0.86 1.71 1.96) 348 — S — 218 (0.83 1.89 1.79) 348 — S — 231 (1.98 2.45 1.22)
348 — S — 233 (1.36 1.87 1.80) 348 — S — 234 (1.18 1.96 1.72) 348 — S — 236 (1.40 0.84 2.83) 348 — S — 237 (1.19 2.25 1.42)
348 — S — 243 (1.93 1.08 2.59) 348 — S — 244 (1.25 1.87 1.81) 348 — S — 245 (1.16 1.64 2.03) 348 — S — 246 (1.50 2.21 1.47)
348 — S — 248 (1.57 2.75 0.92) 348 — S — 249 (1.04 2.60 1.08) 348 — S — 251 (1.01 2.45 1.22) 348 — S — 254 (1.00 1.56 2.11)
348 — S — 255 (1.89 2.43 1.25) 348 — S — 265 (1.46 2.35 1.33) 348 — S — 266 (1.10 1.93 1.75) 348 — S — 267 (0.90 1.63 2.05)
348 — S — 268 (1.44 2.50 1.18) 348 — S — 269 (1.41 2.43 1.25) 348 — S — 271 (2.15 2.52 1.16) 348 — S — 272 (1.28 0.97 2.70)
348 — S — 277 (0.99 1.69 1.98) 348 — S — 279 (1.04 1.76 1.92) 348 — S — 282 (0.84 1.26 2.41) 348 — S — 286 (1.02 1.54 2.13)
348 — S — 287 (0.82 1.55 2.12) 348 — S — 288 (0.81 1.49 2.18) 348 — S — 289 (1.07 1.33 2.34) 348 — S — 290 (1.10 1.96 1.72)
348 — S — 291 (2.24 2.36 1.31) 348 — S — 292 (1.57 2.02 1.65) 348 — S — 293 (1.07 1.83 1.84) 348 — S — 294 (1.53 1.86 1.81)
348 — S — 295 (1.28 2.11 1.57) 348 — S — 296 (1.56 2.10 1.57) 348 — S — 297 (0.87 1.23 2.44) 348 — S — 298 (1.13 1.71 1.97)
348 — S — 300 (1.14 1.11 2.57) 348 — S — 301 (1.19 0.82 2.86) 348 — S — 303 (0.89 1.08 2.59) 348 — S — 304 (0.94 1.55 2.12)
348 — S — 305 (1.45 1.77 1.90) 348 — S — 306 (1.61 2.42 1.25) 348 — S — 307 (1.34 2.55 1.12) 348 — S — 310 (1.05 1.17 2.51)
348 — S — 312 (0.87 1.31 2.36) 348 — S — 316 (0.93 1.77 1.90) 348 — S — 318 (1.23 0.81 2.86) 348 — S — 327 (1.22 2.17 1.50)
348 — S — 329 (1.55 2.63 1.04) 348 — S — 331 (1.08 1.35 2.32) 348 — S — 332 (0.94 1.52 2.15) 348 — S — 336 (1.04 1.41 2.26)
348 — S — 342 (2.98 2.38 1.29) 348 — S — 357 (1.40 0.98 2.70) 348 — S — 358 (0.88 1.69 1.98) 348 — S — 367 (1.51 2.33 1.35)
348 — S — 370 (0.85 1.76 1.92) 348 — S — 371 (2.67 2.47 1.20) 348 — S — 372 (1.08 1.46 2.22) 348 — S — 382 (0.83 1.63 2.04)
348 — S — 395 (1.70 2.17 1.50) 348 — S — 396 (1.12 1.61 2.06) 348 — S — 397 (0.93 1.45 2.22) 348 — S — 415 (0.82 1.34 2.34)
348 — S — 420 (0.88 2.65 1.02) 348 — S — 432 (0.95 0.95 2.73) 348 — S — 435 (0.86 1.91 1.76) 348 — S — 437 (1.04 1.29 2.38)
348 — S — 440 (1.38 2.08 1.59) 348 — S — 441 (1.31 2.01 1.67) 348 — S — 447 (1.32 2.19 1.48) 348 — S — 449 (1.07 2.16 1.51)
348 — S — 451 (1.41 2.77 0.90) 348 — S — 452 (1.46 2.43 1.24) 348 — S — 453 (0.96 1.13 2.54) 348 — S — 457 (0.91 2.07 1.60)
348 — S — 460 (1.19 2.51 1.17) 348 — S — 461 (0.90 2.27 1.41) 348 — S — 469 (0.88 2.41 1.27) 348 — S — 471 (1.49 1.74 1.94)
348 — S — 473 (1.54 2.35 1.32) 348 — S — 474 (1.39 2.24 1.43) 349 — S — 43 (1.16 2.71 1.58) 349 — S — 46 (1.76 2.24 2.06)
349 — S — 57 (1.43 3.25 1.04) 349 — S — 70 (1.23 2.92 1.37) 349 — S — 85 (1.01 2.04 2.26) 349 — S — 89 (0.98 2.66 1.63)
349 — S — 90 (0.89 2.51 1.78) 349 — S — 105 (0.81 1.46 2.84) 349 — S — 107 (1.27 2.20 2.10) 349 — S — 108 (0.83 2.59 1.71)
349 — S — 109 (1.07 2.72 1.57) 349 — S — 111 (1.26 1.48 2.81) 349 — S — 115 (0.93 2.34 1.96) 349 — S — 133 (1.27 2.49 1.81)
349 — S — 150 (2.09 2.36 1.93) 349 — S — 151 (2.00 2.62 1.68) 349 — S — 152 (2.64 2.92 1.38) 349 — S — 153 (2.02 2.46 1.83)
349 — S — 154 (1.56 1.59 2.70) 349 — S — 161 (1.07 0.89 3.40) 349 — S — 165 (0.93 3.34 0.96) 349 — S — 166 (1.28 1.42 2.88)
349 — S — 167 (1.14 1.10 3.19) 349 — S — 170 (1.35 0.83 3.47) 349 — S — 171 (1.05 1.41 2.88) 349 — S — 177 (1.10 2.14 2.15)
349 — S — 184 (1.84 1.95 2.34) 349 — S — 187 (0.99 1.33 2.97) 349 — S — 188 (1.42 1.37 2.93) 349 — S — 189 (1.16 0.95 3.34)
349 — S — 192 (1.45 2.47 1.82) 349 — S — 194 (1.22 1.08 3.22) 349 — S — 195 (1.27 1.80 2.50) 349 — S — 197 (1.41 0.86 3.43)
349 — S — 198 (0.98 1.86 2.44) 349 — S — 207 (1.02 2.78 1.52) 349 — S — 213 (0.95 1.81 2.48) 349 — S — 215 (1.25 3.04 1.25)
349 — S — 231 (1.49 2.59 1.71) 349 — S — 233 (0.88 2.01 2.28) 349 — S — 236 (0.92 0.98 3.32) 349 — S — 243 (1.44 1.22 3.08)
349 — S — 246 (1.02 2.34 1.95) 349 — S — 248 (1.08 2.89 1.40) 349 — S — 255 (1.41 2.56 1.73) 349 — S — 259 (1.26 3.38 0.92)
349 — S — 265 (0.98 2.48 1.81) 349 — S — 268 (0.96 2.63 1.66) 349 — S — 269 (0.92 2.56 1.73) 349 — S — 270 (1.06 3.24 1.05)
349 — S — 271 (1.67 2.65 1.64) 349 — S — 291 (1.75 2.50 1.80) 349 — S — 292 (1.09 2.16 2.14) 349 — S — 294 (1.04 2.00 2.29)
349 — S — 296 (1.07 2.24 2.06) 349 — S — 302 (0.82 0.80 3.49) 349 — S — 305 (0.97 1.91 2.39) 349 — S — 306 (1.13 2.56 1.73)
349 — S — 307 (0.85 2.69 1.60) 349 — S — 320 (1.35 2.98 1.32) 349 — S — 329 (1.07 2.77 1.53) 349 — S — 342 (2.49 2.52 1.78)
349 — S — 343 (3.02 3.01 1.28) 349 — S — 357 (0.91 1.12 3.18) 349 — S — 364 (1.20 3.14 1.16) 349 — S — 367 (1.02 2.46 1.83)
349 — S — 368 (1.13 3.01 1.29) 349 — S — 371 (2.18 2.61 1.69) 349 — S — 395 (1.21 2.31 1.99) 349 — S — 440 (0.90 2.22 2.08)
349 — S — 441 (0.83 2.14 2.15) 349 — S — 447 (0.84 2.33 1.97) 349 — S — 451 (0.92 2.91 1.39) 349 — S — 452 (0.98 2.57 1.73)
349 — S — 463 (0.85 3.01 1.28) 349 — S — 471 (1.00 1.88 2.42) 349 — S — 472 (1.58 3.29 1.01) 349 — S — 473 (1.05 2.49 1.81)
349 — S — 474 (0.90 2.38 1.92) 350 — S — 43 (1.14 2.63 1.61) 350 — S — 46 (1.73 2.15 2.08) 350 — S — 57 (1.41 3.16 1.07)
350 — S — 70 (1.20 2.84 1.40) 350 — S — 85 (0.98 1.95 2.28) 350 — S — 89 (0.96 2.57 1.66) 350 — S — 90 (0.87 2.42 1.81)
350 — S — 93 (0.93 3.32 0.91) 350 — S — 107 (1.25 2.11 2.12) 350 — S — 108 (0.81 2.50 1.73) 350 — S — 109 (1.04 2.64 1.59)
350 — S — 111 (1.24 1.39 2.84) 350 — S — 115 (0.91 2.25 1.98) 350 — S — 133 (1.25 2.40 1.83) 350 — S — 150 (2.07 2.27 1.96)
350 — S — 151 (1.98 2.53 1.70) 350 — S — 152 (2.62 2.83 1.40) 350 — S — 153 (2.00 2.37 1.86) 350 — S — 154 (1.53 1.50 2.73)

350 — S — 161 (1.04 0.80 3.43) 350 — S — 165 (0.91 3.25 0.98) 350 — S — 166 (1.25 1.33 2.90) 350 — S — 167 (1.12 1.01 3.22) 350 — S — 171 (1.02 1.33 2.91) 350 — S — 177 (1.08 2.05 2.18) 350 — S — 184 (1.82 1.87 2.37) 350 — S — 187 (0.96 1.24 2.99) 350 — S — 188 (1.39 1.28 2.95) 350 — S — 189 (1.14 0.87 3.37) 350 — S — 192 (1.42 2.39 1.85) 350 — S — 194 (1.19 0.99 3.24) 350 — S — 195 (1.25 1.71 2.52) 350 — S — 198 (0.96 1.77 2.46) 350 — S — 207 (0.99 2.69 1.54) 350 — S — 213 (0.93 1.73 2.51) 350 — S — 215 (1.23 2.96 1.28) 350 — S — 231 (1.47 2.50 1.73) 350 — S — 233 (0.85 1.92 2.31) 350 — S — 236 (0.89 0.89 3.34) 350 — S — 243 (1.42 1.13 3.10) 350 — S — 246 (0.99 2.26 1.98) 350 — S — 248 (1.06 2.80 1.43) 350 — S — 255 (1.38 2.47 1.76) 350 — S — 259 (1.24 3.29 0.94) 350 — S — 265 (0.95 2.40 1.83) 350 — S — 268 (0.93 2.55 1.69) 350 — S — 269 (0.90 2.47 1.76) 350 — S — 270 (1.04 3.15 1.08) 350 — S — 271 (1.65 2.57 1.66) 350 — S — 291 (1.73 2.41 1.82) 350 — S — 292 (1.06 2.07 2.16) 350 — S — 294 (1.02 1.91 2.32) 350 — S — 296 (1.05 2.15 2.08) 350 — S — 305 (0.94 1.82 2.41) 350 — S — 306 (1.10 2.47 1.76) 350 — S — 307 (0.83 2.60 1.63) 350 — S — 320 (1.32 2.89 1.34) 350 — S — 329 (1.04 2.68 1.55) 350 — S — 342 (2.47 2.43 1.80) 350 — S — 343 (3.00 2.92 1.31) 350 — S — 357 (0.89 1.03 3.20) 350 — S — 364 (1.18 3.05 1.18) 350 — S — 367 (1.00 2.37 1.86) 350 — S — 368 (1.11 2.92 1.31) 350 — S — 371 (2.16 2.52 1.71) 350 — S — 395 (1.19 2.22 2.01) 350 — S — 440 (0.87 2.13 2.10) 350 — S — 441 (0.80 2.06 2.18) 350 — S — 447 (0.81 2.24 1.99) 350 — S — 451 (0.90 2.82 1.41) 350 — S — 452 (0.95 2.48 1.75) 350 — S — 463 (0.83 2.92 1.31) 350 — S — 471 (0.98 1.79 2.44) 350 — S — 472 (1.56 3.20 1.03) 350 — S — 473 (1.03 2.40 1.83) 350 — S — 474 (0.88 2.29 1.94) 351 — S — 36 (0.82 2.77 1.36) 351 — S — 37 (0.82 3.07 1.06) 351 — S — 43 (1.24 2.63 1.51) 351 — S — 46 (1.83 2.15 1.98) 351 — S — 57 (1.51 3.16 0.97) 351 — S — 70 (1.30 2.84 1.30) 351 — S — 85 (1.08 1.95 2.18) 351 — S — 89 (1.06 2.57 1.56) 351 — S — 90 (0.97 2.42 1.71) 351 — S — 105 (0.88 1.37 2.76) 351 — S — 107 (1.35 2.11 2.02) 351 — S — 108 (0.90 2.50 1.63) 351 — S — 109 (1.14 2.64 1.50) 351 — S — 111 (1.34 1.39 2.74) 351 — S — 115 (1.01 2.25 1.88) 351 — S — 133 (1.35 2.40 1.73) 351 — S — 150 (2.17 2.27 1.86) 351 — S — 151 (2.08 2.53 1.60) 351 — S — 152 (2.72 2.83 1.30) 351 — S — 153 (2.10 2.37 1.76) 351 — S — 154 (1.63 1.50 2.63) 351 — S — 161 (1.14 0.80 3.33) 351 — S — 166 (1.35 1.33 2.80) 351 — S — 167 (1.22 1.01 3.12) 351 — S — 171 (1.12 1.33 2.81) 351 — S — 177 (1.18 2.05 2.08) 351 — S — 183 (0.83 2.39 1.74) 351 — S — 184 (1.92 1.87 2.27) 351 — S — 187 (1.06 1.24 2.89) 351 — S — 188 (1.49 1.28 2.85) 351 — S — 189 (1.24 0.87 3.27) 351 — S — 192 (1.52 2.39 1.75) 351 — S — 194 (1.29 0.99 3.14) 351 — S — 195 (1.35 1.71 2.42) 351 — S — 198 (1.06 1.77 2.36) 351 — S — 207 (1.09 2.69 1.44) 351 — S — 213 (1.03 1.73 2.41) 351 — S — 215 (1.33 2.96 1.18) 351 — S — 231 (1.57 2.50 1.63) 351 — S — 233 (0.95 1.92 2.21) 351 — S — 236 (0.99 0.89 3.24) 351 — S — 243 (1.52 1.13 3.00) 351 — S — 244 (0.84 1.92 2.22) 351 — S — 246 (1.09 2.26 1.88) 351 — S — 248 (1.16 2.80 1.33) 351 — S — 255 (1.48 2.47 1.66) 351 — S — 265 (1.05 2.40 1.73) 351 — S — 268 (1.03 2.55 1.59) 351 — S — 269 (1.00 2.47 1.66) 351 — S — 270 (1.14 3.15 0.98) 351 — S — 271 (1.75 2.57 1.57) 351 — S — 272 (0.87 1.02 3.11) 351 — S — 291 (1.83 2.41 1.72) 351 — S — 292 (1.16 2.07 2.06) 351 — S — 294 (1.12 1.91 2.22) 351 — S — 295 (0.87 2.16 1.98) 351 — S — 296 (1.15 2.15 1.98) 351 — S — 305 (1.04 1.82 2.31) 351 — S — 306 (1.20 2.47 1.66) 351 — S — 307 (0.93 2.60 1.53) 351 — S — 318 (0.82 0.86 3.27) 351 — S — 320 (1.42 2.89 1.24) 351 — S — 327 (0.81 2.22 1.91) 351 — S — 329 (1.14 2.68 1.45) 351 — S — 342 (2.57 2.43 1.70) 351 — S — 343 (3.10 2.92 1.21) 351 — S — 357 (0.99 1.03 3.10) 351 — S — 364 (1.28 3.05 1.08) 351 — S — 367 (1.10 2.37 1.76) 351 — S — 368 (1.21 2.92 1.21) 351 — S — 371 (2.26 2.52 1.61) 351 — S — 395 (1.29 2.22 1.91) 351 — S — 440 (0.97 2.13 2.00) 351 — S — 441 (0.90 2.05 2.08) 351 — S — 447 (0.91 2.24 1.89) 351 — S — 451 (1.00 2.82 1.31) 351 — S — 452 (1.05 2.48 1.65) 351 — S — 463 (0.93 2.92 1.21) 351 — S — 471 (1.08 1.79 2.34) 351 — S — 472 (1.66 3.20 0.93) 351 — S — 473 (1.13 2.40 1.73) 351 — S — 474 (0.98 2.29 1.84) 352 — S — 43 (1.00 1.93 1.74) 352 — S — 46 (1.60 1.45 2.22) 352 — S — 57 (1.27 2.46 1.20) 352 — S — 70 (1.07 2.14 1.53) 352 — S — 85 (0.85 1.25 2.42) 352 — S — 89 (0.82 1.87 1.79) 352 — S — 107 (1.11 1.41 2.26) 352 — S — 109 (0.91 1.94 1.73) 352 — S — 133 (1.11 1.70 1.97) 352 — S — 150 (1.93 1.57 2.09) 352 — S — 151 (1.84 1.83 1.84) 352 — S — 152 (2.48 2.13 1.54) 352 — S — 153 (1.86 1.67 1.99) 352 — S — 154 (1.40 0.80 2.86) 352 — S — 177 (0.94 1.35 2.31) 352 — S — 184 (1.68 1.17 2.50) 352 — S — 192 (1.29 1.69 1.98) 352 — S — 195 (1.11 1.01 2.66) 352 — S — 198 (0.82 1.07 2.60) 352 — S — 207 (0.86 1.99 1.68) 352 — S — 215 (1.09 2.26 1.41) 352 — S — 231 (1.33 1.80 1.87) 352 — S — 246 (0.86 1.56 2.11) 352 — S — 247 (0.99 2.76 0.91) 352 — S — 248 (0.92 2.10 1.56) 352 — S — 255 (1.25 1.77 1.89) 352 — S — 259 (1.10 2.59 1.08) 352 — S — 265 (0.82 1.70 1.97) 352 — S — 270 (0.90 2.45 1.21) 352 — S — 271 (1.51 1.87 1.80) 352 — S — 291 (1.59 1.71 1.96) 352 — S — 292 (0.93 1.37 2.30) 352 — S — 294 (0.88 1.21 2.46) 352 — S — 296 (0.91 1.45 2.22) 352 — S — 305 (0.81 1.12 2.55) 352 — S — 306 (0.97 1.77 1.89) 352 — S — 320 (1.19 2.19 1.48) 352 — S — 324 (1.16 2.69 0.98) 352 — S — 329 (0.91 1.98 1.69) 352 — S — 342 (2.33 1.73 1.94) 352 — S — 343 (2.86 2.22 1.44) 352 — S — 364 (1.04 2.35 1.32) 352 — S — 367 (0.86 1.67 1.99) 352 — S — 368 (0.97 2.22 1.45) 352 — S — 371 (2.02 1.82 1.85) 352 — S — 395 (1.05 1.52 2.15) 352 — S — 452 (0.82 1.78 1.89) 352 — S — 471 (0.84 1.09 2.58) 352 — S — 472 (1.42 2.50 1.17) 352 — S — 473 (0.89 1.70 1.97) 353 — S — 43 (1.08 1.89 1.67) 353 — S — 46 (1.67 1.41 2.15) 353 — S — 57 (1.34 2.42 1.13) 353 — S — 70 (1.14 2.10 1.46) 353 — S — 85 (0.92 1.21 2.35) 353 — S — 89 (0.89 1.84 1.72) 353 — S — 90 (0.80 1.69 1.87) 353 — S — 93 (0.87 2.58 0.98) 353 — S — 107 (1.18 1.37 2.19) 353 — S — 109 (0.98 1.90 1.66) 353 — S — 115 (0.85 1.51 2.05) 353 — S — 133 (1.18 1.66 1.89) 353 — S — 150 (2.00 1.53 2.02) 353 — S — 151 (1.91 1.79 1.76) 353 — S — 152 (2.56 2.09 1.46) 353 — S — 153 (1.94 1.64 1.92) 353 — S — 165 (0.84 2.51 1.05) 353 — S — 177 (1.02 1.31 2.24) 353 — S — 184 (1.75 1.13 2.43) 353 — S — 192 (1.36 1.65 1.91) 353 — S — 195 (1.18 0.97 2.58) 353 — S — 198 (0.89 1.03 2.52) 353 — S — 207 (0.93 1.95 1.60) 353 — S — 213 (0.86 0.99 2.57) 353 — S — 215 (1.16 2.22 1.34) 353 — S — 231 (1.40 1.76 1.80) 353 — S — 246 (0.93 1.52 2.04) 353 — S — 248 (0.99 2.06 1.49) 353 — S — 255 (1.32 1.74 1.82) 353 — S — 259 (1.17 2.55 1.00) 353 — S — 265 (0.89 1.66 1.90) 353 — S — 268 (0.87 1.81 1.75) 353 — S — 269 (0.83 1.74 1.82) 353 — S — 270 (0.97 2.41 1.14) 353 — S — 271 (1.58 1.83 1.73) 353 — S — 291 (1.66 1.67 1.88) 353 — S — 292 (1.00 1.33 2.22) 353 — S — 294 (0.96 1.17 2.38) 353 — S — 296 (0.99 1.41 2.14) 353 — S — 305 (0.88 1.08 2.48) 353 — S — 306 (1.04 1.73 1.82) 353 — S — 320 (1.26 2.15 1.40) 353 — S — 324 (1.23 2.65 0.91)

353 — S — 329 (0.98 1.94 1.62) 353 — S — 342 (2.41 1.69 1.86) 353 — S — 343 (2.94 2.18 1.37) 353 — S — 364 (1.12 2.31 1.24)
353 — S — 367 (0.93 1.64 1.92) 353 — S — 368 (1.04 2.18 1.38) 353 — S — 371 (2.09 1.78 1.78) 353 — S — 395 (1.12 1.48 2.08)
353 — S — 440 (0.81 1.39 2.17) 353 — S — 451 (0.83 2.08 1.47) 353 — S — 452 (0.89 1.74 1.82) 353 — S — 471 (0.92 1.05 2.51)
353 — S — 472 (1.49 2.46 1.10) 353 — S — 473 (0.96 1.66 1.89) 353 — S — 474 (0.82 1.55 2.01) 354 — S — 20 (1.03 1.26 1.97)
354 — S — 27 (0.94 1.42 1.80) 354 — S — 28 (1.00 1.69 1.53) 354 — S — 36 (1.16 2.20 1.02) 354 — S — 43 (1.58 2.06 1.17)
354 — S — 46 (2.17 1.58 1.65) 354 — S — 56 (0.93 0.89 2.34) 354 — S — 61 (0.91 1.40 1.83) 354 — S — 65 (0.92 1.19 2.03)
354 — S — 70 (1.64 2.27 0.96) 354 — S — 79 (0.91 1.57 1.65) 354 — S — 80 (0.86 1.53 1.70) 354 — S — 81 (0.94 1.65 1.57)
354 — S — 83 (0.97 0.83 2.40) 354 — S — 85 (1.42 1.38 1.84) 354 — S — 89 (1.40 2.01 1.22) 354 — S — 90 (1.31 1.86 1.37)
354 — S — 101 (1.06 1.71 1.52) 354 — S — 105 (1.22 0.81 2.42) 354 — S — 107 (1.68 1.54 1.68) 354 — S — 108 (1.24 1.93 1.29)
354 — S — 109 (1.48 2.07 1.16) 354 — S — 110 (0.98 1.71 1.52) 354 — S — 111 (1.68 0.83 2.40) 354 — S — 112 (0.87 1.21 2.02)
354 — S — 113 (1.08 2.12 1.10) 354 — S — 115 (1.35 1.68 1.54) 354 — S — 118 (0.96 1.10 2.12) 354 — S — 119 (0.93 1.32 1.91)
354 — S — 132 (0.90 1.03 2.20) 354 — S — 133 (1.69 1.83 1.39) 354 — S — 144 (1.02 1.74 1.48) 354 — S — 150 (2.51 1.71 1.52)
354 — S — 151 (2.41 1.97 1.26) 354 — S — 152 (3.06 2.26 0.96) 354 — S — 153 (2.44 1.81 1.42) 354 — S — 154 (1.97 0.94 2.29)
354 — S — 177 (1.52 1.49 1.74) 354 — S — 183 (1.17 1.82 1.40) 354 — S — 184 (2.26 1.30 1.93) 354 — S — 192 (1.86 1.82 1.41)
354 — S — 195 (1.69 1.14 2.08) 354 — S — 198 (1.40 1.20 2.02) 354 — S — 205 (0.92 1.26 1.96) 354 — S — 206 (0.91 2.18 1.05)
354 — S — 207 (1.43 2.12 1.10) 354 — S — 213 (1.36 1.16 2.07) 354 — S — 231 (1.91 1.93 1.29) 354 — S — 233 (1.29 1.36 1.87)
354 — S — 234 (1.11 1.44 1.79) 354 — S — 237 (1.12 1.73 1.49) 354 — S — 244 (1.18 1.35 1.88) 354 — S — 245 (1.09 1.12 2.10)
354 — S — 246 (1.43 1.69 1.54) 354 — S — 248 (1.50 2.24 0.99) 354 — S — 249 (0.97 2.08 1.15) 354 — S — 251 (0.94 1.94 1.29)
354 — S — 254 (0.93 1.05 2.18) 354 — S — 255 (1.82 1.91 1.32) 354 — S — 265 (1.39 1.83 1.40) 354 — S — 266 (1.03 1.41 1.82)
354 — S — 267 (0.83 1.11 2.12) 354 — S — 268 (1.37 1.98 1.25) 354 — S — 269 (1.34 1.91 1.32) 354 — S — 271 (2.08 2.00 1.23)
354 — S — 277 (0.92 1.18 2.05) 354 — S — 279 (0.97 1.24 1.99) 354 — S — 286 (0.95 1.02 2.20) 354 — S — 289 (1.00 0.81 2.41)
354 — S — 290 (1.03 1.44 1.79) 354 — S — 291 (2.17 1.84 1.38) 354 — S — 292 (1.50 1.50 1.72) 354 — S — 293 (1.00 1.31 1.91)
354 — S — 294 (1.46 1.35 1.88) 354 — S — 295 (1.21 1.59 1.64) 354 — S — 296 (1.49 1.59 1.64) 354 — S — 298 (1.06 1.19 2.04)
354 — S — 304 (0.87 1.04 2.19) 354 — S — 305 (1.38 1.25 1.97) 354 — S — 306 (1.54 1.91 1.32) 354 — S — 307 (1.27 2.04 1.19)
354 — S — 316 (0.86 1.25 1.97) 354 — S — 327 (1.15 1.65 1.57) 354 — S — 329 (1.48 2.11 1.11) 354 — S — 331 (1.01 0.83 2.39)
354 — S — 332 (0.87 1.01 2.22) 354 — S — 336 (0.97 0.90 2.33) 354 — S — 342 (2.91 1.86 1.36) 354 — S — 358 (0.81 1.17 2.05)
354 — S — 367 (1.44 1.81 1.42) 354 — S — 371 (2.60 1.95 1.27) 354 — S — 372 (1.01 0.94 2.29) 354 — S — 395 (1.63 1.65 1.57)
354 — S — 396 (1.05 1.09 2.13) 354 — S — 397 (0.86 0.94 2.29) 354 — S — 420 (0.81 2.13 1.09) 354 — S — 440 (1.31 1.56 1.66)
354 — S — 441 (1.24 1.49 1.74) 354 — S — 447 (1.25 1.68 1.55) 354 — S — 449 (1.00 1.64 1.58) 354 — S — 451 (1.34 2.26 0.97)
354 — S — 452 (1.39 1.91 1.31) 354 — S — 457 (0.84 1.56 1.67) 354 — S — 460 (1.12 1.99 1.24) 354 — S — 461 (0.83 1.75 1.48)
354 — S — 469 (0.81 1.89 1.34) 354 — S — 471 (1.42 1.22 2.01) 354 — S — 473 (1.47 1.83 1.39) 354 — S — 474 (1.32 1.72 1.50)
355 — S — 20 (2.02 0.97 0.97) 355 — S — 65 (1.92 0.91 1.03) 355 — S — 68 (1.63 0.87 1.07) 355 — S — 96 (1.00 0.90 1.04)
355 — S — 112 (1.87 0.92 1.02) 355 — S — 118 (1.96 0.82 1.12) 355 — S — 119 (1.93 1.04 0.91) 355 — S — 147 (1.42 1.04 0.91)
355 — S — 184 (3.25 1.02 0.93) 355 — S — 195 (2.68 0.86 1.08) 355 — S — 198 (2.39 0.92 1.02) 355 — S — 205 (1.91 0.98 0.96)
355 — S — 213 (2.36 0.88 1.07) 355 — S — 217 (1.79 0.91 1.04) 355 — S — 227 (0.96 1.02 0.93) 355 — S — 245 (2.09 0.84 1.11)
355 — S — 267 (1.83 0.82 1.12) 355 — S — 277 (1.91 0.89 1.05) 355 — S — 279 (1.97 0.96 0.99) 355 — S — 285 (1.69 0.84 1.11)
355 — S — 293 (2.00 1.03 0.91) 355 — S — 298 (2.06 0.91 1.04) 355 — S — 305 (2.38 0.97 0.98) 355 — S — 316 (1.86 0.97 0.98)
355 — S — 319 (1.06 0.83 1.12) 355 — S — 358 (1.81 0.89 1.06) 355 — S — 370 (1.78 0.96 0.99) 355 — S — 381 (1.26 0.82 1.12)
355 — S — 382 (1.76 0.83 1.11) 355 — S — 396 (2.05 0.81 1.14) 355 — S — 434 (1.70 0.94 1.00) 355 — S — 450 (1.61 1.03 0.92)
355 — S — 467 (1.52 0.87 1.07) 355 — S — 471 (2.42 0.94 1.01) 356 — S — 43 (0.95 1.35 1.80) 356 — S — 46 (1.54 0.87 2.28)
356 — S — 57 (1.21 1.88 1.26) 356 — S — 70 (1.01 1.56 1.59) 356 — S — 107 (1.05 0.83 2.31) 356 — S — 109 (0.85 1.36 1.79)
356 — S — 133 (1.05 1.12 2.02) 356 — S — 150 (1.87 0.99 2.15) 356 — S — 151 (1.78 1.25 1.89) 356 — S — 152 (2.43 1.55 1.59)
356 — S — 153 (1.81 1.10 2.05) 356 — S — 192 (1.23 1.11 2.04) 356 — S — 207 (0.80 1.41 1.73) 356 — S — 215 (1.03 1.68 1.47)
356 — S — 231 (1.27 1.22 1.93) 356 — S — 247 (0.93 2.18 0.96) 356 — S — 248 (0.86 1.52 1.62) 356 — S — 255 (1.19 1.19 1.95)
356 — S — 259 (1.04 2.01 1.13) 356 — S — 270 (0.84 1.87 1.27) 356 — S — 271 (1.45 1.29 1.86) 356 — S — 291 (1.53 1.13 2.01)
356 — S — 296 (0.86 0.87 2.27) 356 — S — 306 (0.91 1.19 1.95) 356 — S — 320 (1.13 1.61 1.53) 356 — S — 324 (1.10 2.11 1.04)
356 — S — 329 (0.85 1.40 1.74) 356 — S — 342 (2.28 1.15 1.99) 356 — S — 343 (2.81 1.64 1.50) 356 — S — 364 (0.99 1.77 1.37)
356 — S — 367 (0.80 1.10 2.05) 356 — S — 368 (0.92 1.64 1.51) 356 — S — 371 (1.96 1.24 1.90) 356 — S — 395 (1.00 0.94 2.20)
356 — S — 472 (1.36 1.92 1.23) 356 — S — 473 (0.83 1.12 2.02) 357 — S — 46 (0.85 1.12 2.97) 357 — S — 150 (1.18 1.25 2.85)
357 — S — 151 (1.09 1.51 2.59) 357 — S — 152 (1.73 1.80 2.29) 357 — S — 153 (1.11 1.35 2.75) 357 — S — 184 (0.93 0.84 3.25)
357 — S — 291 (0.84 1.38 2.71) 357 — S — 342 (1.58 1.40 2.69) 357 — S — 343 (2.11 1.90 2.20) 357 — S — 371 (1.27 1.49 2.60)
357 — S — 429 (1.67 2.59 1.50) 358 — S — 57 (1.04 1.43 1.44) 358 — S — 70 (0.83 1.10 1.77) 358 — S — 125 (1.28 1.87 0.99)
358 — S — 152 (2.25 1.09 1.77) 358 — S — 215 (0.85 1.22 1.65) 358 — S — 259 (0.87 1.55 1.31) 358 — S — 271 (1.27 0.83 2.04)
358 — S — 320 (0.95 1.15 1.71) 358 — S — 324 (0.93 1.65 1.22) 358 — S — 343 (2.63 1.18 1.68) 358 — S — 364 (0.81 1.31 1.55)
358 — S — 429 (2.19 1.88 0.98) 358 — S — 472 (1.18 1.46 1.40) 359 — S — 20 (0.81 0.99 2.19) 359 — S — 36 (0.95 1.94 1.24)
359 — S — 37 (0.94 2.24 0.94) 359 — S — 43 (1.36 1.79 1.38) 359 — S — 46 (1.96 1.31 1.86) 359 — S — 70 (1.42 2.00 1.17)
359 — S — 85 (1.21 1.11 2.06) 359 — S — 89 (1.18 1.74 1.44) 359 — S — 90 (1.09 1.59 1.59) 359 — S — 101 (0.84 1.44 1.73)
359 — S — 107 (1.47 1.27 1.90) 359 — S — 108 (1.03 1.67 1.51) 359 — S — 109 (1.26 1.80 1.37) 359 — S — 113 (0.86 1.86 1.32)

359 — S — 115 (1.13 1.41 1.76) 359 — S — 133 (1.47 1.57 1.61) 359 — S — 144 (0.80 1.48 1.70) 359 — S — 150 (2.29 1.44 1.74)
359 — S — 151 (2.20 1.70 1.48) 359 — S — 152 (2.84 2.00 1.18) 359 — S — 153 (2.22 1.54 1.64) 359 — S — 177 (1.30 1.22 1.96)
359 — S — 183 (0.95 1.56 1.62) 359 — S — 184 (2.04 1.03 2.14) 359 — S — 192 (1.64 1.55 1.62) 359 — S — 195 (1.47 0.88 2.30)
359 — S — 198 (1.18 0.94 2.24) 359 — S — 207 (1.21 1.86 1.32) 359 — S — 213 (1.15 0.89 2.28) 359 — S — 215 (1.45 2.12 1.05)
359 — S — 231 (1.69 1.66 1.51) 359 — S — 233 (1.07 1.09 2.09) 359 — S — 234 (0.89 1.17 2.00) 359 — S — 237 (0.90 1.47 1.71)
359 — S — 244 (0.96 1.08 2.09) 359 — S — 245 (0.88 0.85 2.32) 359 — S — 246 (1.21 1.42 1.75) 359 — S — 248 (1.28 1.97 1.21)
359 — S — 255 (1.60 1.64 1.54) 359 — S — 265 (1.17 1.56 1.61) 359 — S — 266 (0.81 1.14 2.04) 359 — S — 268 (1.15 1.71 1.46)
359 — S — 269 (1.12 1.64 1.54) 359 — S — 271 (1.87 1.73 1.44) 359 — S — 290 (0.81 1.17 2.00) 359 — S — 291 (1.95 1.58 1.60)
359 — S — 292 (1.28 1.24 1.94) 359 — S — 294 (1.24 1.08 2.10) 359 — S — 295 (0.99 1.32 1.85) 359 — S — 296 (1.27 1.32 1.86)
359 — S — 298 (0.84 0.92 2.25) 359 — S — 305 (1.16 0.98 2.19) 359 — S — 306 (1.32 1.64 1.54) 359 — S — 307 (1.05 1.77 1.41)
359 — S — 320 (1.54 2.06 1.12) 359 — S — 327 (0.94 1.39 1.79) 359 — S — 329 (1.26 1.85 1.33) 359 — S — 342 (2.69 1.60 1.58)
359 — S — 343 (3.22 2.09 1.09) 359 — S — 364 (1.40 2.22 0.96) 359 — S — 367 (1.22 1.54 1.64) 359 — S — 368 (1.33 2.08 1.09)
359 — S — 371 (2.38 1.68 1.49) 359 — S — 395 (1.41 1.39 1.79) 359 — S — 396 (0.84 0.82 2.35) 359 — S — 440 (1.10 1.29 1.88)
359 — S — 441 (1.03 1.22 1.95) 359 — S — 447 (1.04 1.41 1.77) 359 — S — 451 (1.12 1.99 1.19) 359 — S — 452 (1.18 1.64 1.53)
359 — S — 460 (0.90 1.72 1.46) 359 — S — 463 (1.05 2.09 1.09) 359 — S — 471 (1.20 0.95 2.22) 359 — S — 473 (1.25 1.57 1.61)
359 — S — 474 (1.10 1.46 1.72) 360 — S — 36 (0.91 1.64 1.28) 360 — S — 37 (0.90 1.94 0.98) 360 — S — 43 (1.32 1.49 1.42)
360 — S — 46 (1.92 1.01 1.90) 360 — S — 70 (1.38 1.70 1.21) 360 — S — 85 (1.17 0.81 2.10) 360 — S — 89 (1.14 1.44 1.48)
360 — S — 90 (1.05 1.29 1.63) 360 — S — 101 (0.80 1.14 1.77) 360 — S — 107 (1.43 0.98 1.94) 360 — S — 108 (0.99 1.37 1.55)
360 — S — 109 (1.22 1.50 1.41) 360 — S — 113 (0.82 1.56 1.36) 360 — S — 115 (1.09 1.12 1.80) 360 — S — 133 (1.43 1.27 1.65)
360 — S — 150 (2.25 1.14 1.78) 360 — S — 151 (2.16 1.40 1.52) 360 — S — 152 (2.80 1.70 1.22) 360 — S — 153 (2.18 1.24 1.68)
360 — S — 177 (1.26 0.92 2.00) 360 — S — 183 (0.91 1.26 1.66) 360 — S — 192 (1.60 1.25 1.66) 360 — S — 207 (1.17 1.56 1.36)
360 — S — 215 (1.41 1.82 1.09) 360 — S — 231 (1.65 1.37 1.55) 360 — S — 234 (0.85 0.87 2.04) 360 — S — 237 (0.86 1.17 1.75)
360 — S — 246 (1.17 1.12 1.79) 360 — S — 248 (1.24 1.67 1.25) 360 — S — 255 (1.56 1.34 1.58) 360 — S — 265 (1.13 1.26 1.65)
360 — S — 268 (1.11 1.41 1.50) 360 — S — 269 (1.08 1.34 1.58) 360 — S — 271 (1.83 1.43 1.48) 360 — S — 291 (1.91 1.28 1.64)
360 — S — 292 (1.24 0.94 1.98) 360 — S — 295 (0.95 1.02 1.89) 360 — S — 296 (1.23 1.02 1.90) 360 — S — 306 (1.28 1.34 1.58)
360 — S — 307 (1.01 1.47 1.45) 360 — S — 320 (1.50 1.76 1.16) 360 — S — 327 (0.90 1.09 1.83) 360 — S — 329 (1.22 1.55 1.37)
360 — S — 342 (2.65 1.30 1.62) 360 — S — 343 (3.18 1.79 1.13) 360 — S — 364 (1.36 1.92 1.00) 360 — S — 367 (1.18 1.24 1.68)
360 — S — 368 (1.29 1.78 1.13) 360 — S — 371 (2.34 1.39 1.53) 360 — S — 395 (1.37 1.09 1.83) 360 — S — 440 (1.06 1.00 1.92)
360 — S — 441 (0.99 0.92 1.99) 360 — S — 447 (1.00 1.11 1.81) 360 — S — 451 (1.08 1.69 1.23) 360 — S — 452 (1.14 1.34 1.57)
360 — S — 460 (0.86 1.42 1.50) 360 — S — 463 (1.01 1.79 1.13) 360 — S — 473 (1.21 1.27 1.65) 360 — S — 474 (1.06 1.16 1.76)
361 — S — 9 (0.95 0.84 2.49) 361 — S — 20 (1.05 1.38 1.94) 361 — S — 27 (0.97 1.55 1.78) 361 — S — 28 (1.03 1.82 1.51)
361 — S — 36 (1.19 2.33 1.00) 361 — S — 43 (1.60 2.18 1.14) 361 — S — 46 (2.20 1.70 1.62) 361 — S — 56 (0.95 1.01 2.32)
361 — S — 61 (0.94 1.52 1.80) 361 — S — 62 (0.82 1.72 1.60) 361 — S — 65 (0.95 1.32 2.01) 361 — S — 70 (1.67 2.39 0.93)
361 — S — 79 (0.93 1.69 1.63) 361 — S — 80 (0.89 1.65 1.67) 361 — S — 81 (0.96 1.78 1.55) 361 — S — 83 (0.99 0.95 2.38)
361 — S — 85 (1.45 1.51 1.82) 361 — S — 89 (1.42 2.13 1.19) 361 — S — 90 (1.33 1.98 1.34) 361 — S — 101 (1.09 1.83 1.49)
361 — S — 105 (1.25 0.93 2.39) 361 — S — 107 (1.71 1.67 1.66) 361 — S — 108 (1.27 2.06 1.27) 361 — S — 109 (1.51 2.19 1.13)
361 — S — 110 (1.00 1.83 1.49) 361 — S — 111 (1.70 0.95 2.37) 361 — S — 112 (0.90 1.33 1.99) 361 — S — 113 (1.11 2.25 1.08)
361 — S — 115 (1.37 1.81 1.52) 361 — S — 118 (0.99 1.23 2.10) 361 — S — 119 (0.96 1.44 1.88) 361 — S — 131 (1.01 0.91 2.42)
361 — S — 132 (0.92 1.15 2.17) 361 — S — 133 (1.71 1.96 1.37) 361 — S — 144 (1.05 1.87 1.46) 361 — S — 150 (2.53 1.83 1.49)
361 — S — 151 (2.44 2.09 1.24) 361 — S — 152 (3.08 2.39 0.94) 361 — S — 153 (2.46 1.93 1.39) 361 — S — 154 (2.00 1.06 2.26)
361 — S — 166 (1.72 0.89 2.44) 361 — S — 171 (1.49 0.88 2.44) 361 — S — 177 (1.54 1.61 1.71) 361 — S — 183 (1.19 1.95 1.38)
361 — S — 184 (2.28 1.42 1.90) 361 — S — 188 (1.86 0.84 2.49) 361 — S — 192 (1.89 1.94 1.38) 361 — S — 193 (0.80 1.11 2.22)
361 — S — 195 (1.71 1.27 2.06) 361 — S — 198 (1.42 1.33 2.00) 361 — S — 205 (0.94 1.39 1.94) 361 — S — 206 (0.94 2.30 1.02)
361 — S — 207 (1.46 2.25 1.08) 361 — S — 208 (0.91 0.86 2.46) 361 — S — 213 (1.39 1.28 2.04) 361 — S — 217 (0.81 1.32 2.01)
361 — S — 231 (1.93 2.06 1.27) 361 — S — 233 (1.32 1.48 1.84) 361 — S — 234 (1.14 1.56 1.76) 361 — S — 237 (1.15 1.86 1.47)
361 — S — 244 (1.20 1.47 1.85) 361 — S — 245 (1.12 1.25 2.08) 361 — S — 246 (1.46 1.81 1.51) 361 — S — 248 (1.52 2.36 0.96)
361 — S — 249 (0.99 2.20 1.12) 361 — S — 251 (0.96 2.06 1.26) 361 — S — 254 (0.96 1.17 2.15) 361 — S — 255 (1.85 2.03 1.29)
361 — S — 265 (1.42 1.95 1.37) 361 — S — 266 (1.05 1.53 1.79) 361 — S — 267 (0.85 1.23 2.09) 361 — S — 268 (1.40 2.10 1.22)
361 — S — 269 (1.36 2.03 1.29) 361 — S — 271 (2.11 2.12 1.20) 361 — S — 277 (0.94 1.30 2.02) 361 — S — 279 (0.99 1.36 1.96)
361 — S — 286 (0.97 1.15 2.18) 361 — S — 289 (1.02 0.94 2.39) 361 — S — 290 (1.05 1.56 1.76) 361 — S — 291 (2.19 1.97 1.36)
361 — S — 292 (1.53 1.63 1.70) 361 — S — 293 (1.03 1.44 1.89) 361 — S — 294 (1.48 1.47 1.85) 361 — S — 295 (1.24 1.71 1.61)
361 — S — 296 (1.52 1.71 1.62) 361 — S — 297 (0.83 0.84 2.48) 361 — S — 298 (1.08 1.31 2.01) 361 — S — 304 (0.89 1.16 2.16)
361 — S — 305 (1.41 1.38 1.95) 361 — S — 306 (1.57 2.03 1.29) 361 — S — 307 (1.30 2.16 1.16) 361 — S — 312 (0.83 0.92 2.40)
361 — S — 316 (0.89 1.38 1.95) 361 — S — 327 (1.18 1.78 1.55) 361 — S — 329 (1.51 2.24 1.09) 361 — S — 331 (1.04 0.96 2.37)
361 — S — 332 (0.89 1.13 2.19) 361 — S — 336 (0.99 1.02 2.30) 361 — S — 342 (2.93 1.99 1.34) 361 — S — 358 (0.83 1.30 2.03)
361 — S — 367 (1.46 1.93 1.39) 361 — S — 370 (0.80 1.36 1.96) 361 — S — 371 (2.62 2.08 1.25) 361 — S — 372 (1.03 1.06 2.26)
361 — S — 395 (1.65 1.78 1.55) 361 — S — 396 (1.08 1.22 2.11) 361 — S — 397 (0.88 1.06 2.27) 361 — S — 420 (0.83 2.26 1.07)
361 — S — 435 (0.81 1.52 1.81) 361 — S — 437 (0.99 0.89 2.43) 361 — S — 440 (1.34 1.69 1.64) 361 — S — 441 (1.27 1.61 1.71)

361 — S — 447 (1.28 1.80 1.52) 361 — S — 449 (1.02 1.77 1.56) 361 — S — 451 (1.36 2.38 0.95) 361 — S — 452 (1.42 2.04 1.29)
361 — S — 457 (0.87 1.68 1.64) 361 — S — 460 (1.14 2.11 1.21) 361 — S — 461 (0.86 1.87 1.45) 361 — S — 469 (0.84 2.01 1.31)
361 — S — 471 (1.44 1.34 1.98) 361 — S — 473 (1.49 1.96 1.37) 361 — S — 474 (1.34 1.85 1.48) 366 — S — 36 (0.81 2.38 1.38)
366 — S — 37 (0.80 2.68 1.08) 366 — S — 43 (1.22 2.24 1.52) 366 — S — 46 (1.82 1.76 2.00) 366 — S — 57 (1.49 2.77 0.98)
366 — S — 70 (1.29 2.45 1.31) 366 — S — 85 (1.07 1.56 2.20) 366 — S — 89 (1.04 2.18 1.57) 366 — S — 90 (0.95 2.03 1.72)
366 — S — 105 (0.87 0.98 2.78) 366 — S — 107 (1.33 1.72 2.04) 366 — S — 108 (0.89 2.11 1.65) 366 — S — 109 (1.12 2.25 1.51)
366 — S — 111 (1.32 1.01 2.75) 366 — S — 115 (0.99 1.86 1.90) 366 — S — 133 (1.33 2.01 1.75) 366 — S — 150 (2.15 1.88 1.87)
366 — S — 151 (2.06 2.14 1.62) 366 — S — 152 (2.70 2.44 1.32) 366 — S — 153 (2.08 1.98 1.77) 366 — S — 154 (1.62 1.11 2.65)
366 — S — 165 (0.99 2.86 0.90) 366 — S — 166 (1.34 0.94 2.82) 366 — S — 171 (1.11 0.94 2.82) 366 — S — 177 (1.16 1.66 2.09)
366 — S — 183 (0.81 2.00 1.76) 366 — S — 184 (1.90 1.48 2.28) 366 — S — 187 (1.04 0.85 2.91) 366 — S — 188 (1.48 0.89 2.87)
366 — S — 192 (1.51 2.00 1.76) 366 — S — 195 (1.33 1.32 2.44) 366 — S — 198 (1.04 1.38 2.38) 366 — S — 207 (1.08 2.30 1.46)
366 — S — 213 (1.01 1.34 2.42) 366 — S — 215 (1.31 2.57 1.19) 366 — S — 231 (1.55 2.11 1.65) 366 — S — 233 (0.94 1.53 2.22)
366 — S — 244 (0.82 1.53 2.23) 366 — S — 246 (1.07 1.87 1.89) 366 — S — 248 (1.14 2.41 1.34) 366 — S — 255 (1.47 2.08 1.67)
366 — S — 265 (1.04 2.01 1.75) 366 — S — 268 (1.02 2.16 1.60) 366 — S — 269 (0.98 2.08 1.67) 366 — S — 270 (1.12 2.76 0.99)
366 — S — 271 (1.73 2.18 1.58) 366 — S — 291 (1.81 2.02 1.74) 366 — S — 292 (1.14 1.68 2.08) 366 — S — 294 (1.10 1.52 2.24)
366 — S — 295 (0.86 1.77 1.99) 366 — S — 296 (1.13 1.76 2.00) 366 — S — 305 (1.02 1.43 2.33) 366 — S — 306 (1.19 2.08 1.67)
366 — S — 307 (0.91 2.21 1.55) 366 — S — 320 (1.41 2.50 1.26) 366 — S — 329 (1.13 2.29 1.47) 366 — S — 342 (2.55 2.04 1.72)
366 — S — 343 (3.08 2.53 1.23) 366 — S — 364 (1.26 2.66 1.10) 366 — S — 367 (1.08 1.98 1.77) 366 — S — 368 (1.19 2.53 1.23)
366 — S — 371 (2.24 2.13 1.63) 366 — S — 395 (1.27 1.83 1.93) 366 — S — 440 (0.96 1.74 2.02) 366 — S — 441 (0.89 1.67 2.09)
366 — S — 447 (0.90 1.85 1.91) 366 — S — 451 (0.98 2.43 1.33) 366 — S — 452 (1.04 2.09 1.67) 366 — S — 463 (0.91 2.53 1.22)
366 — S — 471 (1.06 1.40 2.36) 366 — S — 472 (1.64 2.81 0.95) 366 — S — 473 (1.11 2.01 1.75) 366 — S — 474 (0.96 1.90 1.86)
367 — S — 429 (1.56 1.25 1.61) 369 — S — 20 (1.16 1.27 1.83) 369 — S — 27 (1.08 1.43 1.67) 369 — S — 28 (1.14 1.70 1.40)
369 — S — 29 (0.90 1.43 1.68) 369 — S — 43 (1.71 2.07 1.03) 369 — S — 46 (2.31 1.59 1.51) 369 — S — 56 (1.06 0.90 2.21)
369 — S — 61 (1.05 1.41 1.69) 369 — S — 62 (0.93 1.61 1.49) 369 — S — 65 (1.06 1.20 1.90) 369 — S — 79 (1.04 1.58 1.52)
369 — S — 80 (1.00 1.54 1.56) 369 — S — 81 (1.07 1.66 1.44) 369 — S — 82 (0.81 1.85 1.25) 369 — S — 83 (1.10 0.84 2.27)
369 — S — 85 (1.56 1.39 1.71) 369 — S — 89 (1.53 2.02 1.08) 369 — S — 90 (1.44 1.87 1.23) 369 — S — 101 (1.20 1.72 1.38)
369 — S — 105 (1.36 0.82 2.29) 369 — S — 107 (1.82 1.55 1.55) 369 — S — 108 (1.38 1.95 1.16) 369 — S — 109 (1.62 2.08 1.02)
369 — S — 110 (1.11 1.72 1.38) 369 — S — 111 (1.81 0.84 2.26) 369 — S — 112 (1.01 1.22 1.88) 369 — S — 113 (1.21 2.13 0.97)
369 — S — 115 (1.48 1.69 1.41) 369 — S — 118 (1.10 1.11 1.99) 369 — S — 119 (1.07 1.33 1.77) 369 — S — 132 (1.03 1.04 2.06)
369 — S — 133 (1.82 1.84 1.26) 369 — S — 144 (1.16 1.75 1.35) 369 — S — 150 (2.64 1.72 1.38) 369 — S — 151 (2.55 1.98 1.13)
369 — S — 153 (2.57 1.82 1.28) 369 — S — 154 (2.11 0.95 2.15) 369 — S — 177 (1.65 1.50 1.60) 369 — S — 183 (1.30 1.83 1.27)
369 — S — 184 (2.39 1.31 1.79) 369 — S — 192 (2.00 1.83 1.27) 369 — S — 193 (0.91 0.99 2.11) 369 — S — 195 (1.82 1.15 1.95)
369 — S — 198 (1.53 1.21 1.89) 369 — S — 205 (1.05 1.27 1.83) 369 — S — 206 (1.05 2.19 0.91) 369 — S — 207 (1.57 2.13 0.97)
369 — S — 213 (1.50 1.17 1.93) 369 — S — 217 (0.92 1.20 1.90) 369 — S — 218 (0.89 1.38 1.72) 369 — S — 231 (2.04 1.94 1.16)
369 — S — 233 (1.43 1.37 1.73) 369 — S — 234 (1.25 1.45 1.65) 369 — S — 237 (1.26 1.74 1.36) 369 — S — 244 (1.31 1.36 1.74)
369 — S — 245 (1.23 1.13 1.97) 369 — S — 246 (1.57 1.70 1.40) 369 — S — 249 (1.10 2.09 1.01) 369 — S — 251 (1.07 1.95 1.15)
369 — S — 254 (1.07 1.06 2.04) 369 — S — 255 (1.96 1.92 1.18) 369 — S — 265 (1.53 1.84 1.26) 369 — S — 266 (1.16 1.42 1.68)
369 — S — 267 (0.96 1.12 1.98) 369 — S — 268 (1.51 1.99 1.11) 369 — S — 269 (1.47 1.92 1.18) 369 — S — 271 (2.22 2.01 1.09)
369 — S — 274 (0.83 0.92 2.18) 369 — S — 277 (1.05 1.19 1.91) 369 — S — 279 (1.10 1.25 1.85) 369 — S — 285 (0.83 1.13 1.97)
369 — S — 286 (1.08 1.03 2.07) 369 — S — 287 (0.89 1.05 2.06) 369 — S — 288 (0.87 0.98 2.12) 369 — S — 289 (1.13 0.82 2.28)
369 — S — 290 (1.16 1.45 1.65) 369 — S — 291 (2.30 1.86 1.25) 369 — S — 292 (1.64 1.51 1.59) 369 — S — 293 (1.14 1.32 1.78)
369 — S — 294 (1.59 1.36 1.74) 369 — S — 295 (1.35 1.60 1.50) 369 — S — 296 (1.62 1.60 1.51) 369 — S — 298 (1.19 1.20 1.90)
369 — S — 304 (1.00 1.05 2.05) 369 — S — 305 (1.52 1.26 1.84) 369 — S — 306 (1.68 1.92 1.18) 369 — S — 307 (1.40 2.05 1.05)
369 — S — 311 (0.84 0.93 2.17) 369 — S — 312 (0.94 0.81 2.29) 369 — S — 316 (1.00 1.26 1.84) 369 — S — 327 (1.29 1.66 1.44)
369 — S — 329 (1.62 2.12 0.98) 369 — S — 331 (1.15 0.84 2.26) 369 — S — 332 (1.00 1.02 2.08) 369 — S — 336 (1.10 0.91 2.19)
369 — S — 342 (3.04 1.87 1.23) 369 — S — 358 (0.94 1.18 1.92) 369 — S — 367 (1.57 1.82 1.28) 369 — S — 370 (0.91 1.25 1.85)
369 — S — 371 (2.73 1.96 1.14) 369 — S — 372 (1.14 0.95 2.15) 369 — S — 379 (0.83 0.94 2.16) 369 — S — 382 (0.90 1.13 1.97)
369 — S — 391 (0.83 0.93 2.17) 369 — S — 395 (1.76 1.66 1.44) 369 — S — 396 (1.19 1.10 2.00) 369 — S — 397 (0.99 0.95 2.16)
369 — S — 415 (0.88 0.83 2.27) 369 — S — 420 (0.94 2.14 0.96) 369 — S — 434 (0.84 1.24 1.86) 369 — S — 435 (0.92 1.41 1.70)
369 — S — 440 (1.45 1.57 1.53) 369 — S — 441 (1.38 1.50 1.60) 369 — S — 443 (0.85 2.11 0.99) 369 — S — 447 (1.39 1.69 1.41)
369 — S — 449 (1.13 1.65 1.45) 369 — S — 452 (1.53 1.92 1.18) 369 — S — 455 (0.83 1.06 2.04) 369 — S — 457 (0.98 1.57 1.53)
369 — S — 460 (1.25 2.00 1.10) 369 — S — 461 (0.97 1.76 1.34) 369 — S — 468 (0.86 1.47 1.63) 369 — S — 469 (0.95 1.90 1.20)
369 — S — 471 (1.55 1.23 1.87) 369 — S — 473 (1.60 1.84 1.26) 369 — S — 474 (1.45 1.73 1.37) 370 — S — 57 (1.07 1.36 1.41)
370 — S — 70 (0.86 1.03 1.74) 370 — S — 125 (1.31 1.81 0.96) 370 — S — 152 (2.28 1.03 1.74) 370 — S — 215 (0.89 1.15 1.61)
370 — S — 259 (0.90 1.49 1.28) 370 — S — 320 (0.98 1.09 1.68) 370 — S — 324 (0.96 1.58 1.19) 370 — S — 343 (2.66 1.12 1.65)
370 — S — 364 (0.84 1.25 1.52) 370 — S — 429 (2.22 1.82 0.95) 370 — S — 472 (1.22 1.39 1.37) 372 — S — 57 (0.84 1.66 1.64)
372 — S — 125 (1.08 2.11 1.19) 372 — S — 151 (1.41 1.03 2.27) 372 — S — 152 (2.05 1.33 1.97) 372 — S — 153 (1.43 0.87 2.43)
372 — S — 192 (0.85 0.88 2.41) 372 — S — 231 (0.90 0.99 2.30) 372 — S — 250 (0.85 2.23 1.06) 372 — S — 255 (0.81 0.97 2.33)

372 — S — 271 (1.08 1.06 2.23) 372 — S — 291 (1.16 0.91 2.39) 372 — S — 342 (1.90 0.93 2.37) 372 — S — 343 (2.43 1.42 1.88) 372 — S — 371 (1.59 1.01 2.28) 372 — S — 429 (1.99 2.12 1.18) 372 — S — 472 (0.99 1.69 1.60) 373 — S — 43 (1.18 1.12 1.56) 373 — S — 57 (1.45 1.65 1.03) 373 — S — 70 (1.24 1.33 1.35) 373 — S — 89 (1.00 1.06 1.62) 373 — S — 90 (0.91 0.91 1.77) 373 — S — 108 (0.85 0.99 1.69) 373 — S — 109 (1.08 1.13 1.55) 373 — S — 133 (1.29 0.89 1.79) 373 — S — 151 (2.02 1.02 1.66) 373 — S — 152 (2.66 1.32 1.36) 373 — S — 153 (2.04 0.86 1.82) 373 — S — 165 (0.95 1.74 0.94) 373 — S — 192 (1.46 0.88 1.80) 373 — S — 207 (1.03 1.18 1.50) 373 — S — 215 (1.27 1.45 1.23) 373 — S — 231 (1.51 0.99 1.69) 373 — S — 248 (1.10 1.29 1.39) 373 — S — 255 (1.42 0.96 1.72) 373 — S — 265 (0.99 0.89 1.79) 373 — S — 268 (0.97 1.04 1.64) 373 — S — 269 (0.94 0.96 1.72) 373 — S — 270 (1.08 1.64 1.04) 373 — S — 271 (1.69 1.06 1.62) 373 — S — 291 (1.77 0.90 1.78) 373 — S — 306 (1.14 0.96 1.72) 373 — S — 307 (0.87 1.09 1.59) 373 — S — 320 (1.36 1.38 1.30) 373 — S — 329 (1.08 1.17 1.51) 373 — S — 342 (2.51 0.92 1.76) 373 — S — 343 (3.04 1.41 1.27) 373 — S — 364 (1.22 1.54 1.14) 373 — S — 367 (1.04 0.86 1.82) 373 — S — 368 (1.15 1.41 1.27) 373 — S — 371 (2.20 1.01 1.67) 373 — S — 451 (0.94 1.31 1.37) 373 — S — 452 (0.99 0.97 1.71) 373 — S — 463 (0.87 1.41 1.27) 373 — S — 472 (1.60 1.69 0.99) 373 — S — 473 (1.07 0.89 1.79) 374 — S — 57 (1.23 1.17 1.25) 374 — S — 70 (1.02 0.84 1.57) 374 — S — 152 (2.44 0.83 1.58) 374 — S — 215 (1.05 0.96 1.45) 374 — S — 247 (0.95 1.46 0.95) 374 — S — 248 (0.88 0.81 1.61) 374 — S — 259 (1.06 1.30 1.12) 374 — S — 270 (0.86 1.16 1.26) 374 — S — 320 (1.14 0.89 1.52) 374 — S — 324 (1.12 1.39 1.02) 374 — S — 343 (2.82 0.93 1.49) 374 — S — 364 (1.00 1.05 1.36) 374 — S — 368 (0.93 0.92 1.49) 374 — S — 472 (1.38 1.20 1.21) 375 — S — 20 (1.15 0.95 1.85) 375 — S — 27 (1.06 1.12 1.68) 375 — S — 28 (1.13 1.39 1.41) 375 — S — 29 (0.89 1.11 1.69) 375 — S — 43 (1.70 1.75 1.04) 375 — S — 46 (2.30 1.27 1.52) 375 — S — 61 (1.04 1.09 1.70) 375 — S — 62 (0.92 1.29 1.50) 375 — S — 65 (1.05 0.89 1.91) 375 — S — 79 (1.03 1.26 1.53) 375 — S — 80 (0.98 1.22 1.57) 375 — S — 81 (1.06 1.35 1.45) 375 — S — 85 (1.55 1.07 1.72) 375 — S — 89 (1.52 1.70 1.09) 375 — S — 90 (1.43 1.55 1.25) 375 — S — 101 (1.18 1.40 1.39) 375 — S — 107 (1.81 1.24 1.56) 375 — S — 108 (1.37 1.63 1.17) 375 — S — 109 (1.60 1.76 1.03) 375 — S — 110 (1.10 1.40 1.39) 375 — S — 112 (0.99 0.90 1.90) 375 — S — 113 (1.20 1.82 0.98) 375 — S — 115 (1.47 1.38 1.42) 375 — S — 119 (1.06 1.01 1.78) 375 — S — 133 (1.81 1.53 1.27) 375 — S — 144 (1.14 1.44 1.36) 375 — S — 150 (2.63 1.40 1.40) 375 — S — 151 (2.54 1.66 1.14) 375 — S — 153 (2.56 1.50 1.29) 375 — S — 177 (1.64 1.18 1.62) 375 — S — 183 (1.29 1.52 1.28) 375 — S — 184 (2.38 0.99 1.80) 375 — S — 192 (1.99 1.51 1.28) 375 — S — 195 (1.81 0.84 1.96) 375 — S — 198 (1.52 0.90 1.90) 375 — S — 205 (1.04 0.96 1.84) 375 — S — 206 (1.03 1.87 0.93) 375 — S — 207 (1.55 1.82 0.98) 375 — S — 213 (1.49 0.85 1.94) 375 — S — 217 (0.91 0.89 1.91) 375 — S — 218 (0.88 1.06 1.73) 375 — S — 231 (2.03 1.63 1.17) 375 — S — 233 (1.41 1.05 1.75) 375 — S — 234 (1.23 1.13 1.66) 375 — S — 237 (1.24 1.43 1.37) 375 — S — 244 (1.30 1.04 1.75) 375 — S — 245 (1.22 0.82 1.98) 375 — S — 246 (1.55 1.38 1.41) 375 — S — 249 (1.09 1.77 1.02) 375 — S — 251 (1.06 1.63 1.17) 375 — S — 255 (1.94 1.60 1.20) 375 — S — 265 (1.51 1.52 1.27) 375 — S — 266 (1.15 1.10 1.70) 375 — S — 267 (0.95 0.80 2.00) 375 — S — 268 (1.49 1.67 1.12) 375 — S — 269 (1.46 1.60 1.19) 375 — S — 271 (2.21 1.69 1.10) 375 — S — 277 (1.04 0.87 1.93) 375 — S — 279 (1.09 0.93 1.86) 375 — S — 285 (0.82 0.81 1.98) 375 — S — 290 (1.15 1.13 1.66) 375 — S — 291 (2.29 1.54 1.26) 375 — S — 292 (1.62 1.20 1.60) 375 — S — 293 (1.13 1.01 1.79) 375 — S — 294 (1.58 1.04 1.76) 375 — S — 295 (1.34 1.28 1.51) 375 — S — 296 (1.61 1.28 1.52) 375 — S — 298 (1.18 0.88 1.91) 375 — S — 305 (1.50 0.95 1.85) 375 — S — 306 (1.66 1.60 1.20) 375 — S — 307 (1.39 1.73 1.07) 375 — S — 316 (0.99 0.94 1.85) 375 — S — 327 (1.28 1.35 1.45) 375 — S — 329 (1.60 1.81 0.99) 375 — S — 342 (3.03 1.56 1.24) 375 — S — 358 (0.93 0.87 1.93) 375 — S — 367 (1.56 1.50 1.29) 375 — S — 370 (0.90 0.93 1.86) 375 — S — 371 (2.72 1.65 1.15) 375 — S — 382 (0.88 0.81 1.99) 375 — S — 395 (1.75 1.35 1.45) 375 — S — 420 (0.93 1.83 0.97) 375 — S — 434 (0.83 0.92 1.88) 375 — S — 435 (0.91 1.09 1.71) 375 — S — 440 (1.44 1.26 1.54) 375 — S — 441 (1.37 1.18 1.61) 375 — S — 443 (0.84 1.80 1.00) 375 — S — 447 (1.38 1.37 1.43) 375 — S — 449 (1.12 1.34 1.46) 375 — S — 452 (1.52 1.60 1.19) 375 — S — 457 (0.96 1.25 1.55) 375 — S — 460 (1.24 1.68 1.12) 375 — S — 461 (0.96 1.44 1.35) 375 — S — 468 (0.84 1.16 1.64) 375 — S — 469 (0.93 1.58 1.21) 375 — S — 471 (1.54 0.91 1.88) 375 — S — 473 (1.59 1.53 1.27) 375 — S — 474 (1.44 1.42 1.38) 377 — S — 20 (1.20 0.99 1.79) 377 — S — 27 (1.12 1.16 1.62) 377 — S — 28 (1.18 1.43 1.36) 377 — S — 29 (0.94 1.15 1.63) 377 — S — 43 (1.76 1.79 0.99) 377 — S — 46 (2.35 1.32 1.47) 377 — S — 61 (1.09 1.13 1.65) 377 — S — 62 (0.97 1.33 1.45) 377 — S — 65 (1.10 0.93 1.85) 377 — S — 68 (0.81 0.89 1.89) 377 — S — 79 (1.09 1.31 1.48) 377 — S — 80 (1.04 1.26 1.52) 377 — S — 81 (1.12 1.39 1.40) 377 — S — 82 (0.85 1.57 1.21) 377 — S — 85 (1.60 1.12 1.67) 377 — S — 86 (0.82 1.49 1.30) 377 — S — 89 (1.57 1.74 1.04) 377 — S — 90 (1.48 1.59 1.19) 377 — S — 101 (1.24 1.44 1.34) 377 — S — 107 (1.86 1.28 1.50) 377 — S — 108 (1.42 1.67 1.11) 377 — S — 109 (1.66 1.80 0.98) 377 — S — 110 (1.15 1.44 1.34) 377 — S — 112 (1.05 0.94 1.84) 377 — S — 113 (1.26 1.86 0.92) 377 — S — 115 (1.53 1.42 1.37) 377 — S — 118 (1.14 0.84 1.94) 377 — S — 119 (1.11 1.05 1.73) 377 — S — 133 (1.86 1.57 1.21) 377 — S — 144 (1.20 1.48 1.30) 377 — S — 150 (2.68 1.44 1.34) 377 — S — 151 (2.59 1.70 1.08) 377 — S — 153 (2.62 1.54 1.24) 377 — S — 177 (1.70 1.22 1.56) 377 — S — 183 (1.35 1.56 1.22) 377 — S — 184 (2.43 1.03 1.75) 377 — S — 192 (2.04 1.55 1.23) 377 — S — 195 (1.86 0.88 1.90) 377 — S — 198 (1.58 0.94 1.84) 377 — S — 205 (1.10 1.00 1.78) 377 — S — 207 (1.61 1.86 0.92) 377 — S — 213 (1.54 0.89 1.89) 377 — S — 217 (0.97 0.93 1.86) 377 — S — 218 (0.94 1.10 1.68) 377 — S — 231 (2.08 1.67 1.12) 377 — S — 233 (1.47 1.09 1.69) 377 — S — 234 (1.29 1.17 1.61) 377 — S — 237 (1.30 1.47 1.31) 377 — S — 244 (1.35 1.08 1.70) 377 — S — 245 (1.27 0.86 1.92) 377 — S — 246 (1.61 1.42 1.36) 377 — S — 249 (1.15 1.81 0.97) 377 — S — 251 (1.11 1.67 1.11) 377 — S — 255 (2.00 1.64 1.14) 377 — S — 265 (1.57 1.56 1.22) 377 — S — 266 (1.21 1.14 1.64) 377 — S — 267 (1.01 0.84 1.94) 377 — S — 268 (1.55 1.71 1.07) 377 — S — 269 (1.51 1.64 1.14) 377 — S — 271 (2.26 1.73 1.05) 377 — S — 277 (1.09 0.91 1.87) 377 — S — 279 (1.15 0.97 1.81) 377 — S — 285 (0.87 0.86 1.93) 377 — S — 290 (1.21 1.17 1.61) 377 — S — 291 (2.34 1.58 1.20) 377 — S — 292 (1.68 1.24 1.54) 377 — S — 293 (1.18 1.05 1.73) 377 — S — 294 (1.64 1.08 1.70) 377 — S — 295 (1.39 1.32 1.46) 377 — S — 296 (1.67 1.32 1.46) 377 — S — 298 (1.24 0.93 1.86) 377 — S — 305 (1.56 0.99 1.80) 377 — S — 306 (1.72 1.64 1.14) 377 — S — 307 (1.45 1.77 1.01)

377 — S — 316 (1.04 0.99 1.80) 377 — S — 327 (1.33 1.39 1.39) 377 — S — 329 (1.66 1.85 0.93) 377 — S — 342 (3.09 1.60 1.18) 377 — S — 358 (0.99 0.91 1.88) 377 — S — 367 (1.61 1.54 1.24) 377 — S — 370 (0.96 0.97 1.81) 377 — S — 371 (2.77 1.69 1.09) 377 — S — 382 (0.94 0.85 1.93) 377 — S — 395 (1.81 1.39 1.39) 377 — S — 396 (1.23 0.83 1.96) 377 — S — 420 (0.99 1.87 0.92) 377 — S — 430 (0.82 1.49 1.29) 377 — S — 434 (0.88 0.96 1.82) 377 — S — 435 (0.97 1.13 1.65) 377 — S — 440 (1.49 1.30 1.49) 377 — S — 441 (1.42 1.22 1.56) 377 — S — 443 (0.89 1.84 0.94) 377 — S — 447 (1.43 1.41 1.37) 377 — S — 449 (1.17 1.38 1.40) 377 — S — 452 (1.57 1.65 1.14) 377 — S — 457 (1.02 1.29 1.49) 377 — S — 459 (0.81 1.52 1.26) 377 — S — 460 (1.30 1.72 1.06) 377 — S — 461 (1.01 1.48 1.30) 377 — S — 468 (0.90 1.20 1.59) 377 — S — 469 (0.99 1.62 1.16) 377 — S — 471 (1.60 0.96 1.83) 377 — S — 473 (1.64 1.57 1.21) 377 — S — 474 (1.50 1.46 1.32) 378 — S — 28 (0.87 0.91 1.67) 378 — S — 36 (1.03 1.42 1.16) 378 — S — 43 (1.44 1.28 1.30) 378 — S — 70 (1.51 1.49 1.09) 378 — S — 81 (0.80 0.87 1.71) 378 — S — 89 (1.26 1.22 1.35) 378 — S — 90 (1.17 1.07 1.50) 378 — S — 101 (0.93 0.93 1.65) 378 — S — 108 (1.11 1.15 1.43) 378 — S — 109 (1.35 1.29 1.29) 378 — S — 110 (0.84 0.93 1.65) 378 — S — 113 (0.95 1.34 1.24) 378 — S — 115 (1.22 0.90 1.68) 378 — S — 133 (1.55 1.05 1.53) 378 — S — 144 (0.89 0.96 1.62) 378 — S — 145 (0.87 1.61 0.96) 378 — S — 150 (2.37 0.92 1.65) 378 — S — 151 (2.28 1.18 1.39) 378 — S — 152 (2.92 1.48 1.10) 378 — S — 153 (2.30 1.02 1.55) 378 — S — 183 (1.03 1.04 1.54) 378 — S — 192 (1.73 1.04 1.54) 378 — S — 207 (1.30 1.34 1.24) 378 — S — 215 (1.53 1.61 0.97) 378 — S — 231 (1.77 1.15 1.43) 378 — S — 237 (0.99 0.95 1.63) 378 — S — 246 (1.30 0.91 1.67) 378 — S — 248 (1.36 1.45 1.12) 378 — S — 249 (0.83 1.30 1.28) 378 — S — 251 (0.80 1.15 1.42) 378 — S — 255 (1.69 1.12 1.45) 378 — S — 260 (0.81 1.57 1.00) 378 — S — 265 (1.26 1.05 1.53) 378 — S — 268 (1.24 1.20 1.38) 378 — S — 269 (1.20 1.13 1.45) 378 — S — 271 (1.95 1.22 1.36) 378 — S — 291 (2.03 1.06 1.52) 378 — S — 295 (1.08 0.81 1.77) 378 — S — 296 (1.36 0.80 1.77) 378 — S — 306 (1.41 1.12 1.45) 378 — S — 307 (1.14 1.25 1.32) 378 — S — 320 (1.63 1.54 1.03) 378 — S — 327 (1.02 0.87 1.71) 378 — S — 329 (1.35 1.33 1.25) 378 — S — 342 (2.77 1.08 1.50) 378 — S — 343 (3.30 1.57 1.00) 378 — S — 367 (1.30 1.02 1.55) 378 — S — 368 (1.41 1.57 1.01) 378 — S — 371 (2.46 1.17 1.41) 378 — S — 395 (1.49 0.87 1.71) 378 — S — 447 (1.12 0.89 1.68) 378 — S — 449 (0.86 0.86 1.72) 378 — S — 451 (1.20 1.47 1.11) 378 — S — 452 (1.26 1.13 1.45) 378 — S — 460 (0.98 1.20 1.37) 378 — S — 463 (1.14 1.57 1.00) 378 — S — 473 (1.33 1.05 1.53) 378 — S — 474 (1.18 0.94 1.64) 379 — S — 43 (0.89 1.12 1.86) 379 — S — 57 (1.15 1.66 1.32) 379 — S — 70 (0.95 1.33 1.65) 379 — S — 133 (0.99 0.90 2.08) 379 — S — 151 (1.72 1.03 1.95) 379 — S — 152 (2.37 1.33 1.65) 379 — S — 153 (1.75 0.87 2.11) 379 — S — 192 (1.17 0.88 2.10) 379 — S — 215 (0.97 1.45 1.53) 379 — S — 231 (1.21 1.00 1.98) 379 — S — 247 (0.87 1.96 1.02) 379 — S — 248 (0.80 1.30 1.68) 379 — S — 255 (1.13 0.97 2.01) 379 — S — 259 (0.99 1.79 1.19) 379 — S — 271 (1.39 1.07 1.92) 379 — S — 291 (1.48 0.91 2.07) 379 — S — 306 (0.85 0.97 2.01) 379 — S — 320 (1.07 1.39 1.59) 379 — S — 324 (1.04 1.88 1.10) 379 — S — 342 (2.22 0.93 2.05) 379 — S — 343 (2.75 1.42 1.56) 379 — S — 364 (0.93 1.55 1.43) 379 — S — 368 (0.86 1.42 1.57) 379 — S — 371 (1.91 1.02 1.96) 379 — S — 472 (1.30 1.70 1.28) 380 — S — 43 (1.05 1.71 1.70) 380 — S — 46 (1.64 1.23 2.18) 380 — S — 57 (1.31 2.25 1.16) 380 — S — 70 (1.11 1.92 1.49) 380 — S — 85 (0.89 1.03 2.38) 380 — S — 89 (0.86 1.66 1.75) 380 — S — 93 (0.84 2.40 1.01) 380 — S — 107 (1.15 1.19 2.21) 380 — S — 109 (0.95 1.72 1.69) 380 — S — 115 (0.82 1.33 2.08) 380 — S — 133 (1.15 1.48 1.92) 380 — S — 150 (1.97 1.36 2.05) 380 — S — 151 (1.88 1.61 1.79) 380 — S — 152 (2.53 1.91 1.49) 380 — S — 153 (1.91 1.46 1.95) 380 — S — 165 (0.82 2.33 1.08) 380 — S — 177 (0.99 1.14 2.27) 380 — S — 184 (1.72 0.95 2.46) 380 — S — 192 (1.33 1.47 1.94) 380 — S — 198 (0.87 0.85 2.55) 380 — S — 207 (0.90 1.77 1.63) 380 — S — 213 (0.83 0.81 2.60) 380 — S — 215 (1.13 2.04 1.37) 380 — S — 231 (1.37 1.58 1.83) 380 — S — 246 (0.90 1.34 2.07) 380 — S — 248 (0.96 1.89 1.52) 380 — S — 255 (1.29 1.56 1.85) 380 — S — 259 (1.14 2.37 1.03) 380 — S — 265 (0.86 1.48 1.93) 380 — S — 268 (0.84 1.63 1.78) 380 — S — 269 (0.80 1.56 1.85) 380 — S — 270 (0.94 2.23 1.17) 380 — S — 271 (1.55 1.65 1.76) 380 — S — 291 (1.63 1.49 1.91) 380 — S — 292 (0.97 1.15 2.25) 380 — S — 294 (0.93 0.99 2.41) 380 — S — 296 (0.96 1.23 2.17) 380 — S — 305 (0.85 0.90 2.51) 380 — S — 306 (1.01 1.55 1.85) 380 — S — 320 (1.23 1.97 1.43) 380 — S — 324 (1.20 2.47 0.94) 380 — S — 329 (0.95 1.76 1.64) 380 — S — 342 (2.38 1.51 1.89) 380 — S — 343 (2.91 2.00 1.40) 380 — S — 364 (1.09 2.13 1.27) 380 — S — 367 (0.90 1.46 1.95) 380 — S — 368 (1.02 2.00 1.41) 380 — S — 371 (2.06 1.60 1.80) 380 — S — 395 (1.10 1.30 2.10) 380 — S — 451 (0.80 1.90 1.50) 380 — S — 452 (0.86 1.56 1.85) 380 — S — 471 (0.89 0.87 2.54) 380 — S — 472 (1.46 2.28 1.13) 380 — S — 473 (0.93 1.48 1.92) 381 — S — 36 (0.90 1.10 1.28) 381 — S — 37 (0.90 1.40 0.98) 381 — S — 43 (1.32 0.95 1.43) 381 — S — 70 (1.38 1.16 1.22) 381 — S — 89 (1.13 0.90 1.48) 381 — S — 108 (0.98 0.83 1.55) 381 — S — 109 (1.22 0.97 1.42) 381 — S — 113 (0.82 1.02 1.36) 381 — S — 151 (2.15 0.86 1.52) 381 — S — 152 (2.80 1.16 1.22) 381 — S — 207 (1.17 1.02 1.36) 381 — S — 215 (1.40 1.29 1.10) 381 — S — 231 (1.64 0.83 1.56) 381 — S — 248 (1.23 1.13 1.25) 381 — S — 255 (1.56 0.80 1.58) 381 — S — 268 (1.11 0.88 1.51) 381 — S — 269 (1.07 0.80 1.58) 381 — S — 270 (1.21 1.48 0.90) 381 — S — 271 (1.82 0.90 1.49) 381 — S — 306 (1.28 0.80 1.58) 381 — S — 307 (1.01 0.93 1.45) 381 — S — 320 (1.50 1.22 1.16) 381 — S — 329 (1.22 1.01 1.37) 381 — S — 343 (3.18 1.25 1.13) 381 — S — 364 (1.36 1.38 1.00) 381 — S — 368 (1.29 1.25 1.14) 381 — S — 371 (2.33 0.85 1.53) 381 — S — 451 (1.08 1.15 1.23) 381 — S — 452 (1.13 0.81 1.58) 381 — S — 460 (0.86 0.88 1.50) 381 — S — 463 (1.01 1.25 1.13) 382 — S — 43 (0.82 0.94 1.93) 382 — S — 57 (1.09 1.48 1.39) 382 — S — 70 (0.88 1.15 1.72) 382 — S — 125 (1.33 1.93 0.94) 382 — S — 151 (1.65 0.85 2.02) 382 — S — 152 (2.30 1.15 1.72) 382 — S — 215 (0.90 1.27 1.60) 382 — S — 231 (1.14 0.82 2.05) 382 — S — 247 (0.80 1.78 1.09) 382 — S — 259 (0.92 1.61 1.26) 382 — S — 271 (1.32 0.88 1.99) 382 — S — 320 (1.00 1.21 1.66) 382 — S — 324 (0.97 1.70 1.17) 382 — S — 343 (2.68 1.24 1.63) 382 — S — 364 (0.86 1.37 1.50) 382 — S — 371 (1.84 0.84 2.03) 382 — S — 429 (2.24 1.94 0.93) 382 — S — 472 (1.23 1.52 1.35) 383 — S — 9 (1.28 1.49 2.16) 383 — S — 19 (0.85 1.38 2.26) 383 — S — 20 (1.38 2.03 1.61) 383 — S — 27 (1.30 2.20 1.45) 383 — S — 28 (1.36 2.47 1.18) 383 — S — 29 (1.12 2.19 1.46) 383 — S — 40 (0.94 2.19 1.46) 383 — S — 44 (1.01 1.35 2.30) 383 — S — 46 (2.53 2.36 1.29) 383 — S — 56 (1.28 1.66 1.99) 383 — S — 61 (1.27 2.17 1.47) 383 — S — 62 (1.15 2.37 1.27) 383 — S — 65 (1.28 1.97 1.68) 383 — S — 68 (0.99 1.93 1.71) 383 — S — 79 (1.26 2.35 1.30) 383 — S — 80 (1.22 2.30 1.34)

383 — S — 81 (1.29 2.43 1.22) 383 — S — 82 (1.03 2.61 1.03) 383 — S — 83 (1.32 1.60 2.05) 383 — S — 85 (1.78 2.16 1.49)
383 — S — 86 (1.00 2.53 1.12) 383 — S — 90 (1.66 2.63 1.01) 383 — S — 101 (1.42 2.49 1.16) 383 — S — 102 (1.04 1.49 2.15)
383 — S — 105 (1.58 1.58 2.07) 383 — S — 106 (0.99 1.02 2.63) 383 — S — 107 (2.04 2.32 1.33) 383 — S — 108 (1.60 2.71 0.94)
383 — S — 110 (1.33 2.48 1.16) 383 — S — 111 (2.03 1.60 2.04) 383 — S — 112 (1.23 1.98 1.67) 383 — S — 114 (0.87 1.26 2.39)
383 — S — 115 (1.70 2.46 1.19) 383 — S — 118 (1.31 1.88 1.77) 383 — S — 119 (1.29 2.10 1.55) 383 — S — 123 (0.93 2.22 1.42)
383 — S — 127 (0.94 0.90 2.75) 383 — S — 131 (1.34 1.56 2.09) 383 — S — 132 (1.25 1.80 1.84) 383 — S — 133 (2.04 2.61 1.04)
383 — S — 144 (1.38 2.52 1.13) 383 — S — 148 (1.03 1.39 2.26) 383 — S — 150 (2.86 2.48 1.16) 383 — S — 151 (2.77 2.74 0.91)
383 — S — 153 (2.79 2.58 1.06) 383 — S — 154 (2.33 1.71 1.94) 383 — S — 158 (1.40 0.92 2.72) 383 — S — 161 (1.84 1.01 2.63)
383 — S — 166 (2.05 1.54 2.11) 383 — S — 167 (1.91 1.22 2.42) 383 — S — 170 (2.12 0.95 2.70) 383 — S — 171 (1.82 1.54 2.11)
383 — S — 175 (1.05 1.18 2.47) 383 — S — 176 (0.99 0.93 2.72) 383 — S — 177 (1.87 2.26 1.38) 383 — S — 182 (1.01 1.10 2.54)
383 — S — 183 (1.52 2.60 1.05) 383 — S — 184 (2.61 2.08 1.57) 383 — S — 187 (1.75 1.45 2.20) 383 — S — 188 (2.19 1.49 2.16)
383 — S — 189 (1.93 1.08 2.57) 383 — S — 192 (2.22 2.60 1.05) 383 — S — 193 (1.13 1.76 1.89) 383 — S — 194 (1.99 1.20 2.45)
383 — S — 195 (2.04 1.92 1.73) 383 — S — 197 (2.18 0.98 2.66) 383 — S — 198 (1.75 1.98 1.67) 383 — S — 205 (1.27 2.04 1.61)
383 — S — 208 (1.24 1.51 2.14) 383 — S — 209 (0.98 1.59 2.06) 383 — S — 210 (0.88 0.99 2.65) 383 — S — 213 (1.72 1.94 1.71)
383 — S — 214 (1.28 1.17 2.48) 383 — S — 217 (1.14 1.97 1.68) 383 — S — 218 (1.11 2.15 1.50) 383 — S — 219 (0.91 1.70 1.95)
383 — S — 222 (1.03 1.55 2.10) 383 — S — 230 (0.95 1.38 2.27) 383 — S — 231 (2.26 2.71 0.94) 383 — S — 233 (1.65 2.13 1.51)
383 — S — 234 (1.47 2.21 1.43) 383 — S — 236 (1.69 1.10 2.55) 383 — S — 237 (1.48 2.51 1.14) 383 — S — 240 (1.08 1.00 2.65)
383 — S — 243 (2.21 1.34 2.31) 383 — S — 244 (1.53 2.13 1.52) 383 — S — 245 (1.45 1.90 1.75) 383 — S — 246 (1.78 2.47 1.18)
383 — S — 251 (1.29 2.71 0.94) 383 — S — 254 (1.29 1.82 1.82) 383 — S — 255 (2.18 2.68 0.96) 383 — S — 261 (0.91 0.91 2.74)
383 — S — 265 (1.75 2.61 1.04) 383 — S — 266 (1.38 2.18 1.46) 383 — S — 267 (1.18 1.88 1.76) 383 — S — 269 (1.69 2.68 0.96)
383 — S — 272 (1.57 1.23 2.42) 383 — S — 274 (1.05 1.68 1.96) 383 — S — 275 (0.86 2.11 1.54) 383 — S — 276 (0.97 1.09 2.56)
383 — S — 277 (1.27 1.95 1.69) 383 — S — 279 (1.32 2.01 1.63) 383 — S — 280 (1.00 1.69 1.95) 383 — S — 282 (1.12 1.52 2.13)
383 — S — 284 (0.90 1.53 2.12) 383 — S — 285 (1.05 1.90 1.75) 383 — S — 286 (1.30 1.80 1.85) 383 — S — 287 (1.11 1.81 1.84)
383 — S — 288 (1.09 1.75 1.90) 383 — S — 289 (1.35 1.59 2.06) 383 — S — 290 (1.38 2.22 1.43) 383 — S — 291 (2.52 2.62 1.03)
383 — S — 292 (1.85 2.28 1.37) 383 — S — 293 (1.36 2.09 1.56) 383 — S — 294 (1.81 2.12 1.53) 383 — S — 295 (1.57 2.37 1.28)
383 — S — 296 (1.84 2.36 1.29) 383 — S — 297 (1.16 1.49 2.16) 383 — S — 298 (1.41 1.97 1.68) 383 — S — 300 (1.42 1.37 2.28)
383 — S — 301 (1.47 1.08 2.57) 383 — S — 302 (1.59 0.93 2.72) 383 — S — 303 (1.18 1.34 2.31) 383 — S — 304 (1.22 1.81 1.83)
383 — S — 305 (1.73 2.03 1.62) 383 — S — 306 (1.90 2.68 0.96) 383 — S — 308 (1.21 0.97 2.67) 383 — S — 310 (1.33 1.42 2.22)
383 — S — 311 (1.06 1.70 1.95) 383 — S — 312 (1.16 1.57 2.07) 383 — S — 313 (0.93 1.74 1.91) 383 — S — 316 (1.22 2.03 1.62)
383 — S — 318 (1.51 1.07 2.58) 383 — S — 327 (1.51 2.43 1.22) 383 — S — 330 (0.84 1.44 2.21) 383 — S — 331 (1.37 1.61 2.04)
383 — S — 332 (1.22 1.78 1.86) 383 — S — 336 (1.32 1.67 1.98) 383 — S — 341 (0.82 2.30 1.35) 383 — S — 342 (3.26 2.64 1.01)
383 — S — 352 (0.93 0.91 2.74) 383 — S — 353 (0.86 0.95 2.70) 383 — S — 356 (0.99 1.49 2.16) 383 — S — 357 (1.68 1.24 2.41)
383 — S — 358 (1.16 1.95 1.70) 383 — S — 367 (1.79 2.58 1.06) 383 — S — 370 (1.13 2.01 1.63) 383 — S — 371 (2.95 2.73 0.92)
383 — S — 372 (1.36 1.71 1.93) 383 — S — 374 (0.97 2.21 1.44) 383 — S — 379 (1.05 1.71 1.94) 383 — S — 380 (0.89 1.13 2.52)
383 — S — 382 (1.12 1.89 1.76) 383 — S — 391 (1.05 1.70 1.95) 383 — S — 394 (0.95 0.99 2.65) 383 — S — 395 (1.98 2.43 1.22)
383 — S — 396 (1.41 1.87 1.78) 383 — S — 397 (1.21 1.71 1.94) 383 — S — 398 (1.12 0.84 2.81) 383 — S — 403 (1.00 0.96 2.69)
383 — S — 415 (1.10 1.59 2.05) 383 — S — 430 (0.99 2.53 1.12) 383 — S — 432 (1.23 1.20 2.44) 383 — S — 433 (0.94 1.22 2.43)
383 — S — 434 (1.06 2.00 1.65) 383 — S — 435 (1.14 2.17 1.48) 383 — S — 437 (1.32 1.55 2.10) 383 — S — 440 (1.67 2.34 1.31)
383 — S — 441 (1.60 2.26 1.38) 383 — S — 444 (1.13 0.86 2.79) 383 — S — 445 (0.81 0.82 2.83) 383 — S — 446 (0.81 0.82 2.83)
383 — S — 447 (1.61 2.45 1.20) 383 — S — 449 (1.35 2.42 1.23) 383 — S — 450 (0.97 2.09 1.56) 383 — S — 452 (1.75 2.69 0.96)
383 — S — 453 (1.24 1.39 2.25) 383 — S — 454 (1.06 1.56 2.09) 383 — S — 455 (1.05 1.83 1.82) 383 — S — 457 (1.20 2.33 1.31)
383 — S — 459 (0.98 2.56 1.08) 383 — S — 461 (1.19 2.52 1.12) 383 — S — 462 (0.88 2.54 1.11) 383 — S — 467 (0.88 1.93 1.71)
383 — S — 468 (1.08 2.24 1.41) 383 — S — 469 (1.17 2.67 0.98) 383 — S — 471 (1.77 2.00 1.65) 383 — S — 473 (1.82 2.61 1.04)
383 — S — 474 (1.67 2.50 1.15) 384 — S — 20 (0.84 1.78 2.15) 384 — S — 28 (0.82 2.21 1.72) 384 — S — 36 (0.98 2.73 1.20)
384 — S — 37 (0.98 3.03 0.90) 384 — S — 43 (1.40 2.58 1.35) 384 — S — 46 (1.99 2.10 1.83) 384 — S — 70 (1.46 2.79 1.14)
384 — S — 85 (1.24 1.90 2.03) 384 — S — 89 (1.21 2.53 1.40) 384 — S — 90 (1.12 2.38 1.55) 384 — S — 101 (0.88 2.23 1.70)
384 — S — 105 (1.04 1.33 2.60) 384 — S — 107 (1.50 2.07 1.87) 384 — S — 108 (1.06 2.46 1.47) 384 — S — 109 (1.30 2.59 1.34)
384 — S — 111 (1.50 1.35 2.58) 384 — S — 113 (0.90 2.65 1.28) 384 — S — 115 (1.17 2.21 1.73) 384 — S — 131 (0.80 1.30 2.63)
384 — S — 133 (1.50 2.36 1.57) 384 — S — 144 (0.84 2.27 1.66) 384 — S — 145 (0.82 2.92 1.01) 384 — S — 150 (2.32 2.23 1.70)
384 — S — 151 (2.23 2.49 1.44) 384 — S — 152 (2.88 2.79 1.14) 384 — S — 153 (2.26 2.33 1.60) 384 — S — 154 (1.79 1.46 2.47)
384 — S — 166 (1.51 1.29 2.65) 384 — S — 167 (1.37 0.97 2.96) 384 — S — 171 (1.28 1.28 2.65) 384 — S — 177 (1.34 2.01 1.92)
384 — S — 183 (0.98 2.35 1.59) 384 — S — 184 (2.07 1.82 2.11) 384 — S — 187 (1.22 1.19 2.74) 384 — S — 188 (1.65 1.23 2.70)
384 — S — 189 (1.39 0.82 3.11) 384 — S — 192 (1.68 2.34 1.59) 384 — S — 194 (1.45 0.95 2.98) 384 — S — 195 (1.50 1.67 2.26)
384 — S — 198 (1.21 1.73 2.20) 384 — S — 207 (1.25 2.65 1.28) 384 — S — 213 (1.18 1.68 2.25) 384 — S — 215 (1.48 2.91 1.02)
384 — S — 231 (1.72 2.45 1.48) 384 — S — 233 (1.11 1.88 2.05) 384 — S — 234 (0.93 1.96 1.97) 384 — S — 236 (1.15 0.85 3.08)
384 — S — 237 (0.94 2.26 1.67) 384 — S — 243 (1.68 1.09 2.84) 384 — S — 244 (0.99 1.87 2.06) 384 — S — 245 (0.91 1.65 2.29)
384 — S — 246 (1.25 2.21 1.72) 384 — S — 248 (1.31 2.76 1.17) 384 — S — 255 (1.64 2.43 1.50) 384 — S — 265 (1.21 2.35 1.58)
384 — S — 266 (0.85 1.93 2.00) 384 — S — 268 (1.19 2.50 1.43) 384 — S — 269 (1.15 2.43 1.50) 384 — S — 271 (1.90 2.52 1.41)

384 — S — 272 (1.03 0.98 2.96) 384 — S — 289 (0.82 1.34 2.60) 384 — S — 290 (0.85 1.96 1.97) 384 — S — 291 (1.98 2.37 1.56)
384 — S — 292 (1.32 2.03 1.90) 384 — S — 293 (0.82 1.84 2.09) 384 — S — 294 (1.28 1.87 2.06) 384 — S — 295 (1.03 2.11 1.82)
384 — S — 296 (1.31 2.11 1.82) 384 — S — 298 (0.88 1.71 2.22) 384 — S — 300 (0.88 1.11 2.82) 384 — S — 301 (0.93 0.82 3.11)
384 — S — 305 (1.20 1.78 2.16) 384 — S — 306 (1.36 2.43 1.50) 384 — S — 307 (1.09 2.56 1.37) 384 — S — 318 (0.98 0.82 3.11)
384 — S — 320 (1.58 2.85 1.08) 384 — S — 327 (0.97 2.18 1.75) 384 — S — 329 (1.30 2.64 1.29) 384 — S — 331 (0.83 1.35 2.58)
384 — S — 342 (2.73 2.39 1.54) 384 — S — 343 (3.26 2.88 1.05) 384 — S — 357 (1.14 0.98 2.95) 384 — S — 364 (1.44 3.01 0.92)
384 — S — 367 (1.25 2.33 1.60) 384 — S — 368 (1.36 2.87 1.06) 384 — S — 371 (2.41 2.48 1.46) 384 — S — 372 (0.82 1.46 2.47)
384 — S — 395 (1.44 2.18 1.76) 384 — S — 396 (0.87 1.61 2.32) 384 — S — 440 (1.13 2.08 1.85) 384 — S — 441 (1.06 2.01 1.92)
384 — S — 447 (1.07 2.20 1.73) 384 — S — 449 (0.81 2.17 1.76) 384 — S — 451 (1.15 2.78 1.15) 384 — S — 452 (1.21 2.43 1.50)
384 — S — 460 (0.94 2.51 1.42) 384 — S — 463 (1.09 2.88 1.05) 384 — S — 471 (1.24 1.74 2.19) 384 — S — 473 (1.28 2.36 1.57)
384 — S — 474 (1.14 2.25 1.69) 385 — S — 9 (1.44 1.27 2.00) 385 — S — 14 (0.86 0.91 2.36) 385 — S — 19 (1.01 1.17 2.10)
385 — S — 20 (1.55 1.82 1.45) 385 — S — 27 (1.46 1.98 1.28) 385 — S — 28 (1.52 2.25 1.01) 385 — S — 29 (1.28 1.97 1.29)
385 — S — 32 (0.80 1.00 2.27) 385 — S — 38 (0.90 1.41 1.86) 385 — S — 40 (1.11 1.97 1.29) 385 — S — 44 (1.18 1.13 2.13)
385 — S — 46 (2.69 2.14 1.13) 385 — S — 56 (1.45 1.44 1.82) 385 — S — 61 (1.43 1.96 1.31) 385 — S — 62 (1.31 2.16 1.11)
385 — S — 65 (1.44 1.75 1.51) 385 — S — 68 (1.16 1.72 1.55) 385 — S — 79 (1.43 2.13 1.14) 385 — S — 80 (1.38 2.09 1.18)
385 — S — 81 (1.46 2.21 1.05) 385 — S — 83 (1.49 1.38 1.88) 385 — S — 85 (1.94 1.94 1.33) 385 — S — 86 (1.16 2.31 0.96)
385 — S — 101 (1.58 2.27 1.00) 385 — S — 102 (1.20 1.28 1.99) 385 — S — 104 (0.86 0.85 2.42) 385 — S — 105 (1.74 1.36 1.90)
385 — S — 106 (1.15 0.80 2.46) 385 — S — 107 (2.20 2.10 1.16) 385 — S — 110 (1.50 2.27 1.00) 385 — S — 111 (2.20 1.39 1.88)
385 — S — 112 (1.39 1.76 1.50) 385 — S — 114 (1.04 1.04 2.22) 385 — S — 115 (1.87 2.24 1.02) 385 — S — 118 (1.48 1.66 1.60)
385 — S — 119 (1.45 1.88 1.39) 385 — S — 123 (1.09 2.01 1.26) 385 — S — 131 (1.51 1.34 1.93) 385 — S — 132 (1.42 1.59 1.68)
385 — S — 144 (1.54 2.30 0.96) 385 — S — 147 (0.95 1.88 1.39) 385 — S — 148 (1.20 1.17 2.09) 385 — S — 150 (3.03 2.27 1.00)
385 — S — 154 (2.49 1.49 1.77) 385 — S — 166 (2.21 1.32 1.94) 385 — S — 167 (2.07 1.01 2.26) 385 — S — 171 (1.98 1.32 1.95)
385 — S — 175 (1.21 0.96 2.31) 385 — S — 177 (2.04 2.05 1.22) 385 — S — 182 (1.18 0.89 2.38) 385 — S — 184 (2.77 1.86 1.41)
385 — S — 187 (1.92 1.23 2.03) 385 — S — 188 (2.35 1.27 1.99) 385 — S — 189 (2.10 0.86 2.41) 385 — S — 193 (1.30 1.54 1.72)
385 — S — 194 (2.15 0.98 2.28) 385 — S — 195 (2.21 1.70 1.56) 385 — S — 198 (1.92 1.76 1.50) 385 — S — 205 (1.44 1.82 1.44)
385 — S — 208 (1.40 1.29 1.97) 385 — S — 209 (1.15 1.37 1.89) 385 — S — 213 (1.88 1.72 1.55) 385 — S — 214 (1.44 0.95 2.31)
385 — S — 217 (1.31 1.75 1.51) 385 — S — 218 (1.28 1.93 1.34) 385 — S — 219 (1.08 1.48 1.78) 385 — S — 222 (1.19 1.33 1.93)
385 — S — 224 (0.83 1.00 2.26) 385 — S — 228 (0.82 1.49 1.78) 385 — S — 230 (1.12 1.16 2.11) 385 — S — 233 (1.81 1.92 1.35)
385 — S — 234 (1.63 2.00 1.27) 385 — S — 236 (1.85 0.88 2.38) 385 — S — 237 (1.64 2.29 0.97) 385 — S — 238 (0.94 2.15 1.11)
385 — S — 243 (2.38 1.12 2.14) 385 — S — 244 (1.70 1.91 1.36) 385 — S — 245 (1.61 1.68 1.58) 385 — S — 246 (1.95 2.25 1.02)
385 — S — 254 (1.45 1.61 1.66) 385 — S — 266 (1.55 1.97 1.30) 385 — S — 267 (1.35 1.67 1.60) 385 — S — 272 (1.73 1.01 2.25)
385 — S — 274 (1.22 1.47 1.80) 385 — S — 275 (1.02 1.89 1.38) 385 — S — 276 (1.14 0.87 2.39) 385 — S — 277 (1.44 1.74 1.53)
385 — S — 279 (1.49 1.80 1.47) 385 — S — 280 (1.17 1.48 1.79) 385 — S — 282 (1.29 1.30 1.96) 385 — S — 284 (1.07 1.31 1.96)
385 — S — 285 (1.21 1.68 1.59) 385 — S — 286 (1.47 1.58 1.68) 385 — S — 287 (1.27 1.59 1.67) 385 — S — 288 (1.26 1.53 1.73)
385 — S — 289 (1.52 1.37 1.89) 385 — S — 290 (1.55 2.00 1.27) 385 — S — 292 (2.02 2.06 1.20) 385 — S — 293 (1.52 1.87 1.39)
385 — S — 294 (1.98 1.90 1.36) 385 — S — 295 (1.73 2.15 1.12) 385 — S — 296 (2.01 2.14 1.12) 385 — S — 297 (1.32 1.27 1.99)
385 — S — 298 (1.58 1.75 1.52) 385 — S — 299 (0.84 2.09 1.18) 385 — S — 300 (1.58 1.15 2.12) 385 — S — 301 (1.64 0.86 2.41)
385 — S — 303 (1.34 1.12 2.14) 385 — S — 304 (1.38 1.60 1.67) 385 — S — 305 (1.90 1.81 1.45) 385 — S — 310 (1.50 1.21 2.06)
385 — S — 311 (1.22 1.48 1.78) 385 — S — 312 (1.32 1.36 1.91) 385 — S — 313 (1.10 1.52 1.74) 385 — S — 316 (1.38 1.81 1.45)
385 — S — 318 (1.68 0.85 2.41) 385 — S — 327 (1.67 2.21 1.05) 385 — S — 330 (1.00 1.22 2.05) 385 — S — 331 (1.53 1.39 1.87)
385 — S — 332 (1.39 1.57 1.70) 385 — S — 336 (1.49 1.45 1.81) 385 — S — 341 (0.98 2.08 1.18) 385 — S — 356 (1.15 1.27 1.99)
385 — S — 357 (1.85 1.02 2.25) 385 — S — 358 (1.33 1.73 1.53) 385 — S — 370 (1.30 1.80 1.47) 385 — S — 372 (1.53 1.50 1.77)
385 — S — 373 (0.92 1.50 1.76) 385 — S — 374 (1.14 1.99 1.28) 385 — S — 379 (1.21 1.49 1.77) 385 — S — 380 (1.05 0.91 2.35)
385 — S — 382 (1.28 1.67 1.59) 385 — S — 391 (1.22 1.48 1.78) 385 — S — 395 (2.15 2.21 1.05) 385 — S — 396 (1.57 1.65 1.62)
385 — S — 397 (1.38 1.49 1.77) 385 — S — 415 (1.27 1.38 1.89) 385 — S — 430 (1.16 2.31 0.95) 385 — S — 432 (1.40 0.99 2.28)
385 — S — 433 (1.11 1.00 2.27) 385 — S — 434 (1.22 1.78 1.48) 385 — S — 435 (1.31 1.95 1.31) 385 — S — 437 (1.49 1.33 1.94)
385 — S — 440 (1.83 2.12 1.14) 385 — S — 441 (1.76 2.05 1.22) 385 — S — 447 (1.77 2.23 1.03) 385 — S — 449 (1.52 2.20 1.06)
385 — S — 450 (1.14 1.87 1.40) 385 — S — 453 (1.40 1.18 2.09) 385 — S — 454 (1.23 1.34 1.93) 385 — S — 455 (1.21 1.61 1.66)
385 — S — 456 (0.91 1.32 1.94) 385 — S — 457 (1.36 2.12 1.15) 385 — S — 458 (0.90 1.91 1.36) 385 — S — 459 (1.15 2.35 0.92)
385 — S — 461 (1.35 2.31 0.96) 385 — S — 462 (1.05 2.32 0.94) 385 — S — 467 (1.04 1.72 1.55) 385 — S — 468 (1.24 2.02 1.24)
385 — S — 471 (1.94 1.78 1.49) 385 — S — 474 (1.84 2.28 0.98) 386 — S — 9 (1.43 0.95 2.01) 386 — S — 19 (1.00 0.85 2.12)
386 — S — 20 (1.53 1.49 1.47) 386 — S — 27 (1.44 1.66 1.30) 386 — S — 28 (1.51 1.93 1.03) 386 — S — 29 (1.27 1.65 1.31)
386 — S — 38 (0.88 1.09 1.87) 386 — S — 40 (1.09 1.65 1.31) 386 — S — 44 (1.16 0.81 2.15) 386 — S — 46 (2.68 1.82 1.14)
386 — S — 56 (1.43 1.12 1.84) 386 — S — 61 (1.42 1.64 1.33) 386 — S — 62 (1.29 1.84 1.13) 386 — S — 65 (1.43 1.43 1.53)
386 — S — 68 (1.14 1.39 1.57) 386 — S — 79 (1.41 1.81 1.15) 386 — S — 80 (1.36 1.77 1.20) 386 — S — 81 (1.44 1.89 1.07)
386 — S — 83 (1.47 1.06 1.90) 386 — S — 85 (1.93 1.62 1.34) 386 — S — 86 (1.14 1.99 0.97) 386 — S — 101 (1.56 1.95 1.01)
386 — S — 102 (1.19 0.95 2.01) 386 — S — 105 (1.72 1.04 1.92) 386 — S — 107 (2.19 1.78 1.18) 386 — S — 110 (1.48 1.95 1.02)
386 — S — 111 (2.18 1.07 1.90) 386 — S — 112 (1.37 1.44 1.52) 386 — S — 115 (1.85 1.92 1.04) 386 — S — 118 (1.46 1.34 1.62)

386 — S — 119 (1.43 1.56 1.40) 386 — S — 123 (1.07 1.69 1.28) 386 — S — 131 (1.49 1.02 1.94) 386 — S — 132 (1.40 1.26 1.70)
386 — S — 144 (1.52 1.98 0.98) 386 — S — 147 (0.93 1.56 1.40) 386 — S — 148 (1.18 0.85 2.11) 386 — S — 150 (3.01 1.94 1.02)
386 — S — 153 (2.94 2.05 0.92) 386 — S — 154 (2.47 1.17 1.79) 386 — S — 166 (2.19 1.00 1.96) 386 — S — 171 (1.96 1.00 1.96)
386 — S — 177 (2.02 1.72 1.24) 386 — S — 183 (1.67 2.06 0.90) 386 — S — 184 (2.76 1.54 1.42) 386 — S — 187 (1.90 0.91 2.05)
386 — S — 188 (2.33 0.95 2.01) 386 — S — 192 (2.36 2.06 0.90) 386 — S — 193 (1.28 1.22 1.74) 386 — S — 195 (2.19 1.38 1.58)
386 — S — 198 (1.90 1.44 1.52) 386 — S — 205 (1.42 1.50 1.46) 386 — S — 208 (1.38 0.97 1.99) 386 — S — 209 (1.13 1.05 1.91)
386 — S — 213 (1.87 1.40 1.56) 386 — S — 217 (1.29 1.43 1.53) 386 — S — 218 (1.26 1.61 1.35) 386 — S — 219 (1.06 1.16 1.80)
386 — S — 222 (1.17 1.01 1.95) 386 — S — 228 (0.80 1.16 1.80) 386 — S — 230 (1.10 0.84 2.12) 386 — S — 233 (1.79 1.59 1.37)
386 — S — 234 (1.61 1.68 1.29) 386 — S — 237 (1.62 1.97 0.99) 386 — S — 238 (0.92 1.83 1.13) 386 — S — 243 (2.36 0.80 2.16)
386 — S — 244 (1.68 1.59 1.37) 386 — S — 245 (1.60 1.36 1.60) 386 — S — 246 (1.93 1.93 1.03) 386 — S — 254 (1.43 1.28 1.68)
386 — S — 266 (1.53 1.64 1.32) 386 — S — 267 (1.33 1.34 1.62) 386 — S — 274 (1.20 1.15 1.82) 386 — S — 275 (1.00 1.57 1.39)
386 — S — 277 (1.42 1.41 1.55) 386 — S — 279 (1.47 1.48 1.49) 386 — S — 280 (1.15 1.15 1.81) 386 — S — 282 (1.27 0.98 1.98)
386 — S — 284 (1.05 0.99 1.97) 386 — S — 285 (1.19 1.36 1.60) 386 — S — 286 (1.45 1.26 1.70) 386 — S — 287 (1.26 1.27 1.69)
386 — S — 288 (1.24 1.21 1.75) 386 — S — 289 (1.50 1.05 1.91) 386 — S — 290 (1.53 1.68 1.28) 386 — S — 292 (2.00 1.74 1.22)
386 — S — 293 (1.51 1.55 1.41) 386 — S — 294 (1.96 1.58 1.38) 386 — S — 295 (1.71 1.83 1.13) 386 — S — 296 (1.99 1.82 1.14)
386 — S — 297 (1.30 0.95 2.01) 386 — S — 298 (1.56 1.43 1.53) 386 — S — 299 (0.82 1.77 1.19) 386 — S — 300 (1.57 0.83 2.13)
386 — S — 304 (1.37 1.27 1.69) 386 — S — 305 (1.88 1.49 1.47) 386 — S — 310 (1.48 0.88 2.08) 386 — S — 311 (1.20 1.16 1.80)
386 — S — 312 (1.30 1.03 1.93) 386 — S — 313 (1.08 1.20 1.76) 386 — S — 316 (1.37 1.49 1.47) 386 — S — 327 (1.66 1.89 1.07)
386 — S — 330 (0.98 0.90 2.06) 386 — S — 331 (1.52 1.07 1.89) 386 — S — 332 (1.37 1.24 1.72) 386 — S — 336 (1.47 1.13 1.83)
386 — S — 341 (0.97 1.76 1.20) 386 — S — 356 (1.13 0.95 2.01) 386 — S — 358 (1.31 1.41 1.55) 386 — S — 367 (1.94 2.05 0.92)
386 — S — 370 (1.28 1.48 1.49) 386 — S — 372 (1.51 1.18 1.79) 386 — S — 373 (0.90 1.18 1.78) 386 — S — 374 (1.12 1.67 1.29)
386 — S — 379 (1.19 1.17 1.79) 386 — S — 382 (1.26 1.35 1.61) 386 — S — 391 (1.20 1.16 1.80) 386 — S — 395 (2.13 1.89 1.07)
386 — S — 396 (1.55 1.33 1.63) 386 — S — 397 (1.36 1.17 1.79) 386 — S — 415 (1.25 1.06 1.91) 386 — S — 430 (1.14 1.99 0.97)
386 — S — 434 (1.20 1.46 1.50) 386 — S — 435 (1.29 1.63 1.33) 386 — S — 437 (1.47 1.01 1.95) 386 — S — 440 (1.81 1.80 1.16)
386 — S — 441 (1.75 1.73 1.24) 386 — S — 447 (1.76 1.91 1.05) 386 — S — 449 (1.50 1.88 1.08) 386 — S — 450 (1.12 1.55 1.41)
386 — S — 453 (1.39 0.85 2.11) 386 — S — 454 (1.21 1.02 1.94) 386 — S — 455 (1.19 1.29 1.67) 386 — S — 456 (0.89 1.00 1.96)
386 — S — 457 (1.34 1.79 1.17) 386 — S — 458 (0.89 1.59 1.37) 386 — S — 459 (1.13 2.03 0.94) 386 — S — 461 (1.33 1.99 0.98)
386 — S — 462 (1.03 2.00 0.96) 386 — S — 467 (1.02 1.39 1.57) 386 — S — 468 (1.22 1.70 1.26) 386 — S — 471 (1.92 1.46 1.50)
386 — S — 474 (1.82 1.96 1.00) 387 — S — 9 (1.34 1.50 2.10) 387 — S — 19 (0.91 1.40 2.20) 387 — S — 20 (1.44 2.04 1.55)
387 — S — 27 (1.36 2.21 1.39) 387 — S — 28 (1.42 2.48 1.12) 387 — S — 29 (1.18 2.20 1.39) 387 — S — 40 (1.00 2.20 1.39)
387 — S — 44 (1.07 1.36 2.24) 387 — S — 46 (2.59 2.37 1.23) 387 — S — 56 (1.35 1.67 1.92) 387 — S — 61 (1.33 2.19 1.41)
387 — S — 62 (1.21 2.39 1.21) 387 — S — 65 (1.34 1.98 1.62) 387 — S — 68 (1.05 1.95 1.65) 387 — S — 79 (1.33 2.36 1.24)
387 — S — 80 (1.28 2.32 1.28) 387 — S — 81 (1.35 2.44 1.16) 387 — S — 82 (1.09 2.63 0.97) 387 — S — 83 (1.38 1.61 1.98)
387 — S — 85 (1.84 2.17 1.43) 387 — S — 86 (1.06 2.54 1.06) 387 — S — 90 (1.72 2.65 0.95) 387 — S — 101 (1.48 2.50 1.10)
387 — S — 102 (1.10 1.51 2.09) 387 — S — 105 (1.64 1.59 2.00) 387 — S — 106 (1.05 1.03 2.57) 387 — S — 107 (2.10 2.33 1.27)
387 — S — 110 (1.39 2.50 1.10) 387 — S — 111 (2.09 1.62 1.98) 387 — S — 112 (1.29 1.99 1.60) 387 — S — 114 (0.93 1.27 2.33)
387 — S — 115 (1.77 2.47 1.13) 387 — S — 118 (1.38 1.89 1.70) 387 — S — 119 (1.35 2.11 1.49) 387 — S — 123 (0.99 2.24 1.36)
387 — S — 127 (1.00 0.91 2.68) 387 — S — 131 (1.40 1.57 2.03) 387 — S — 132 (1.31 1.81 1.78) 387 — S — 133 (2.10 2.62 0.98)
387 — S — 144 (1.44 2.53 1.06) 387 — S — 147 (0.84 2.11 1.49) 387 — S — 148 (1.10 1.40 2.20) 387 — S — 150 (2.92 2.50 1.10)
387 — S — 153 (2.85 2.60 1.00) 387 — S — 154 (2.39 1.72 1.87) 387 — S — 158 (1.46 0.94 2.66) 387 — S — 161 (1.90 1.03 2.57)
387 — S — 166 (2.11 1.55 2.05) 387 — S — 167 (1.97 1.24 2.36) 387 — S — 170 (2.18 0.96 2.64) 387 — S — 171 (1.88 1.55 2.05)
387 — S — 175 (1.11 1.19 2.41) 387 — S — 176 (1.05 0.94 2.66) 387 — S — 177 (1.94 2.28 1.32) 387 — S — 182 (1.08 1.12 2.48)
387 — S — 183 (1.58 2.61 0.99) 387 — S — 184 (2.67 2.09 1.51) 387 — S — 187 (1.82 1.46 2.14) 387 — S — 188 (2.25 1.50 2.10)
387 — S — 189 (1.99 1.09 2.51) 387 — S — 192 (2.28 2.61 0.99) 387 — S — 193 (1.20 1.77 1.83) 387 — S — 194 (2.05 1.21 2.39)
387 — S — 195 (2.10 1.93 1.67) 387 — S — 197 (2.25 1.00 2.60) 387 — S — 198 (1.81 1.99 1.61) 387 — S — 205 (1.33 2.05 1.55)
387 — S — 208 (1.30 1.52 2.07) 387 — S — 209 (1.04 1.60 2.00) 387 — S — 210 (0.94 1.01 2.59) 387 — S — 213 (1.78 1.95 1.65)
387 — S — 214 (1.34 1.18 2.42) 387 — S — 217 (1.20 1.98 1.62) 387 — S — 218 (1.17 2.16 1.44) 387 — S — 219 (0.97 1.71 1.88)
387 — S — 222 (1.09 1.56 2.04) 387 — S — 230 (1.02 1.39 2.21) 387 — S — 233 (1.71 2.14 1.45) 387 — S — 234 (1.53 2.23 1.37)
387 — S — 236 (1.75 1.11 2.49) 387 — S — 237 (1.54 2.52 1.08) 387 — S — 238 (0.83 2.38 1.22) 387 — S — 240 (1.14 1.01 2.59)
387 — S — 243 (2.28 1.35 2.24) 387 — S — 244 (1.59 2.14 1.46) 387 — S — 245 (1.51 1.91 1.69) 387 — S — 246 (1.85 2.48 1.12)
387 — S — 254 (1.35 1.83 1.76) 387 — S — 255 (2.24 2.70 0.90) 387 — S — 261 (0.97 0.92 2.68) 387 — S — 265 (1.81 2.62 0.98)
387 — S — 266 (1.45 2.20 1.40) 387 — S — 267 (1.25 1.90 1.70) 387 — S — 269 (1.75 2.70 0.90) 387 — S — 272 (1.63 1.24 2.36)
387 — S — 274 (1.11 1.70 1.90) 387 — S — 275 (0.92 2.12 1.48) 387 — S — 276 (1.03 1.10 2.49) 387 — S — 277 (1.33 1.96 1.63)
387 — S — 279 (1.39 2.03 1.57) 387 — S — 280 (1.07 1.71 1.89) 387 — S — 282 (1.18 1.53 2.07) 387 — S — 284 (0.96 1.54 2.06)
387 — S — 285 (1.11 1.91 1.69) 387 — S — 286 (1.36 1.81 1.79) 387 — S — 287 (1.17 1.82 1.77) 387 — S — 288 (1.16 1.76 1.83)
387 — S — 289 (1.41 1.60 2.00) 387 — S — 290 (1.44 2.23 1.37) 387 — S — 291 (2.58 2.63 0.96) 387 — S — 292 (1.92 2.29 1.31)
387 — S — 293 (1.42 2.10 1.50) 387 — S — 294 (1.87 2.13 1.46) 387 — S — 295 (1.63 2.38 1.22) 387 — S — 296 (1.91 2.37 1.22)
387 — S — 297 (1.22 1.50 2.09) 387 — S — 298 (1.47 1.98 1.62) 387 — S — 300 (1.48 1.38 2.22) 387 — S — 301 (1.53 1.09 2.51)

387 — S — 302 (1.65 0.94 2.66) 387 — S — 303 (1.24 1.35 2.25) 387 — S — 304 (1.28 1.82 1.77) 387 — S — 305 (1.80 2.04 1.56)
387 — S — 306 (1.96 2.69 0.90) 387 — S — 308 (1.27 0.99 2.61) 387 — S — 310 (1.39 1.44 2.16) 387 — S — 311 (1.12 1.71 1.89)
387 — S — 312 (1.22 1.58 2.01) 387 — S — 313 (0.99 1.75 1.85) 387 — S — 316 (1.28 2.04 1.56) 387 — S — 318 (1.57 1.08 2.52)
387 — S — 327 (1.57 2.44 1.15) 387 — S — 330 (0.90 1.45 2.15) 387 — S — 331 (1.43 1.62 1.98) 387 — S — 332 (1.28 1.79 1.80)
387 — S — 336 (1.38 1.68 1.91) 387 — S — 341 (0.88 2.31 1.29) 387 — S — 342 (3.33 2.65 0.95) 387 — S — 352 (0.99 0.92 2.68)
387 — S — 353 (0.92 0.96 2.64) 387 — S — 356 (1.05 1.50 2.10) 387 — S — 357 (1.74 1.25 2.35) 387 — S — 358 (1.23 1.96 1.64)
387 — S — 367 (1.85 2.60 1.00) 387 — S — 370 (1.19 2.03 1.57) 387 — S — 372 (1.42 1.73 1.87) 387 — S — 373 (0.81 1.73 1.87)
387 — S — 374 (1.03 2.22 1.38) 387 — S — 379 (1.11 1.72 1.87) 387 — S — 380 (0.95 1.14 2.46) 387 — S — 382 (1.18 1.90 1.69)
387 — S — 391 (1.12 1.71 1.89) 387 — S — 394 (1.01 1.01 2.59) 387 — S — 395 (2.04 2.44 1.16) 387 — S — 396 (1.47 1.88 1.72)
387 — S — 397 (1.27 1.72 1.87) 387 — S — 398 (1.18 0.85 2.75) 387 — S — 403 (1.06 0.97 2.62) 387 — S — 415 (1.16 1.61 1.99)
387 — S — 430 (1.05 2.54 1.06) 387 — S — 432 (1.29 1.22 2.38) 387 — S — 433 (1.01 1.23 2.37) 387 — S — 434 (1.12 2.01 1.58)
387 — S — 435 (1.20 2.18 1.41) 387 — S — 437 (1.39 1.56 2.04) 387 — S — 440 (1.73 2.35 1.25) 387 — S — 441 (1.66 2.28 1.32)
387 — S — 444 (1.19 0.87 2.73) 387 — S — 445 (0.87 0.83 2.77) 387 — S — 446 (0.87 0.83 2.77) 387 — S — 447 (1.67 2.46 1.13)
387 — S — 449 (1.41 2.43 1.16) 387 — S — 450 (1.03 2.10 1.50) 387 — S — 453 (1.30 1.40 2.19) 387 — S — 454 (1.13 1.57 2.03)
387 — S — 455 (1.11 1.84 1.76) 387 — S — 456 (0.80 1.55 2.05) 387 — S — 457 (1.26 2.34 1.25) 387 — S — 459 (1.04 2.58 1.02)
387 — S — 461 (1.25 2.54 1.06) 387 — S — 462 (0.94 2.55 1.05) 387 — S — 467 (0.94 1.95 1.65) 387 — S — 468 (1.14 2.25 1.35)
387 — S — 469 (1.23 2.68 0.92) 387 — S — 471 (1.83 2.01 1.59) 387 — S — 473 (1.88 2.62 0.97) 387 — S — 474 (1.73 2.51 1.09)
388 — S — 9 (0.87 1.19 2.57) 388 — S — 20 (0.97 1.73 2.02) 388 — S — 27 (0.89 1.90 1.86) 388 — S — 28 (0.95 2.17 1.59)
388 — S — 36 (1.11 2.68 1.07) 388 — S — 43 (1.52 2.54 1.22) 388 — S — 46 (2.12 2.06 1.70) 388 — S — 56 (0.88 1.36 2.39)
388 — S — 61 (0.86 1.88 1.88) 388 — S — 65 (0.87 1.67 2.09) 388 — S — 70 (1.59 2.75 1.01) 388 — S — 79 (0.86 2.05 1.71)
388 — S — 80 (0.81 2.01 1.75) 388 — S — 81 (0.88 2.13 1.63) 388 — S — 83 (0.91 1.30 2.45) 388 — S — 85 (1.37 1.86 1.90)
388 — S — 89 (1.34 2.49 1.27) 388 — S — 90 (1.25 2.33 1.42) 388 — S — 101 (1.01 2.19 1.57) 388 — S — 105 (1.17 1.28 2.47)
388 — S — 107 (1.63 2.02 1.74) 388 — S — 108 (1.19 2.41 1.34) 388 — S — 109 (1.43 2.55 1.21) 388 — S — 110 (0.92 2.19 1.57)
388 — S — 111 (1.62 1.31 2.45) 388 — S — 112 (0.82 1.68 2.07) 388 — S — 113 (1.03 2.60 1.16) 388 — S — 115 (1.30 2.16 1.60)
388 — S — 118 (0.91 1.58 2.17) 388 — S — 119 (0.88 1.80 1.96) 388 — S — 131 (0.93 1.26 2.50) 388 — S — 132 (0.84 1.50 2.25)
388 — S — 133 (1.63 2.31 1.45) 388 — S — 144 (0.97 2.22 1.53) 388 — S — 150 (2.45 2.18 1.57) 388 — S — 151 (2.36 2.44 1.31)
388 — S — 152 (3.00 2.74 1.01) 388 — S — 153 (2.39 2.29 1.47) 388 — S — 154 (1.92 1.41 2.34) 388 — S — 166 (1.64 1.24 2.52)
388 — S — 167 (1.50 0.93 2.83) 388 — S — 171 (1.41 1.24 2.52) 388 — S — 177 (1.47 1.96 1.79) 388 — S — 183 (1.11 2.30 1.46)
388 — S — 184 (2.20 1.78 1.98) 388 — S — 187 (1.35 1.15 2.61) 388 — S — 188 (1.78 1.19 2.57) 388 — S — 192 (1.81 2.30 1.46)
388 — S — 194 (1.58 0.90 2.86) 388 — S — 195 (1.63 1.62 2.14) 388 — S — 198 (1.34 1.68 2.08) 388 — S — 205 (0.86 1.74 2.02)
388 — S — 206 (0.86 2.65 1.10) 388 — S — 207 (1.38 2.60 1.15) 388 — S — 208 (0.83 1.21 2.54) 388 — S — 213 (1.31 1.64 2.12)
388 — S — 214 (0.87 0.87 2.89) 388 — S — 231 (1.85 2.41 1.35) 388 — S — 233 (1.24 1.83 1.92) 388 — S — 234 (1.06 1.92 1.84)
388 — S — 236 (1.28 0.80 2.95) 388 — S — 237 (1.07 2.21 1.54) 388 — S — 243 (1.81 1.04 2.71) 388 — S — 244 (1.12 1.83 1.93)
388 — S — 245 (1.04 1.60 2.16) 388 — S — 246 (1.38 2.17 1.59) 388 — S — 248 (1.44 2.71 1.04) 388 — S — 249 (0.92 2.56 1.20)
388 — S — 251 (0.88 2.41 1.34) 388 — S — 254 (0.88 1.52 2.23) 388 — S — 255 (1.77 2.38 1.37) 388 — S — 258 (0.83 2.83 0.93)
388 — S — 260 (0.89 2.84 0.92) 388 — S — 265 (1.34 2.31 1.45) 388 — S — 266 (0.98 1.88 1.87) 388 — S — 268 (1.32 2.46 1.30)
388 — S — 269 (1.28 2.39 1.37) 388 — S — 271 (2.03 2.48 1.28) 388 — S — 272 (1.16 0.93 2.83) 388 — S — 277 (0.86 1.65 2.10)
388 — S — 279 (0.92 1.72 2.04) 388 — S — 286 (0.89 1.50 2.25) 388 — S — 289 (0.94 1.29 2.47) 388 — S — 290 (0.97 1.92 1.84)
388 — S — 291 (2.11 2.32 1.43) 388 — S — 292 (1.45 1.98 1.78) 388 — S — 293 (0.95 1.79 1.97) 388 — S — 294 (1.40 1.82 1.93)
388 — S — 295 (1.16 2.07 1.69) 388 — S — 296 (1.44 2.06 1.69) 388 — S — 298 (1.01 1.67 2.09) 388 — S — 300 (1.01 1.07 2.69)
388 — S — 304 (0.81 1.51 2.24) 388 — S — 305 (1.33 1.73 2.03) 388 — S — 306 (1.49 2.38 1.37) 388 — S — 307 (1.22 2.51 1.24)
388 — S — 310 (0.93 1.12 2.63) 388 — S — 316 (0.81 1.73 2.03) 388 — S — 320 (1.71 2.80 0.95) 388 — S — 327 (1.10 2.13 1.62)
388 — S — 329 (1.43 2.59 1.17) 388 — S — 331 (0.96 1.31 2.45) 388 — S — 332 (0.81 1.48 2.27) 388 — S — 336 (0.91 1.37 2.38)
388 — S — 342 (2.86 2.34 1.42) 388 — S — 343 (3.38 2.83 0.92) 388 — S — 357 (1.27 0.94 2.82) 388 — S — 367 (1.38 2.29 1.47)
388 — S — 368 (1.49 2.83 0.93) 388 — S — 371 (2.54 2.43 1.33) 388 — S — 372 (0.95 1.42 2.34) 388 — S — 395 (1.57 2.13 1.63)
388 — S — 396 (1.00 1.57 2.19) 388 — S — 397 (0.80 1.41 2.34) 388 — S — 432 (0.82 0.91 2.85) 388 — S — 437 (0.92 1.25 2.51)
388 — S — 440 (1.26 2.04 1.72) 388 — S — 441 (1.19 1.97 1.79) 388 — S — 447 (1.20 2.15 1.60) 388 — S — 449 (0.94 2.12 1.63)
388 — S — 451 (1.28 2.73 1.02) 388 — S — 452 (1.34 2.39 1.37) 388 — S — 453 (0.83 1.09 2.66) 388 — S — 460 (1.07 2.46 1.29)
388 — S — 463 (1.22 2.84 0.92) 388 — S — 471 (1.37 1.70 2.06) 388 — S — 473 (1.41 2.31 1.44) 388 — S — 474 (1.26 2.20 1.56)
389 — S — 9 (1.50 1.29 1.94) 389 — S — 14 (0.91 0.93 2.30) 389 — S — 19 (1.07 1.19 2.04) 389 — S — 20 (1.60 1.84 1.40)
389 — S — 27 (1.51 2.00 1.23) 389 — S — 28 (1.58 2.27 0.96) 389 — S — 29 (1.34 1.99 1.24) 389 — S — 32 (0.85 1.01 2.22)
389 — S — 35 (0.81 0.99 2.24) 389 — S — 38 (0.96 1.43 1.80) 389 — S — 40 (1.16 1.99 1.24) 389 — S — 44 (1.23 1.15 2.08)
389 — S — 46 (2.75 2.16 1.07) 389 — S — 56 (1.50 1.46 1.77) 389 — S — 61 (1.49 1.98 1.25) 389 — S — 62 (1.37 2.18 1.05)
389 — S — 65 (1.50 1.77 1.46) 389 — S — 68 (1.21 1.74 1.49) 389 — S — 79 (1.48 2.15 1.08) 389 — S — 80 (1.44 2.11 1.12)
389 — S — 81 (1.51 2.23 1.00) 389 — S — 83 (1.54 1.40 1.83) 389 — S — 85 (2.00 1.96 1.27) 389 — S — 86 (1.21 2.33 0.90)
389 — S — 101 (1.64 2.29 0.94) 389 — S — 102 (1.26 1.30 1.93) 389 — S — 104 (0.91 0.87 2.36) 389 — S — 105 (1.80 1.38 1.85)
389 — S — 106 (1.21 0.82 2.41) 389 — S — 107 (2.26 2.12 1.11) 389 — S — 110 (1.55 2.29 0.94) 389 — S — 111 (2.25 1.41 1.82)
389 — S — 112 (1.44 1.78 1.45) 389 — S — 114 (1.09 1.06 2.17) 389 — S — 115 (1.92 2.26 0.97) 389 — S — 118 (1.53 1.68 1.55)

389 — S — 119 (1.51 1.90 1.33) 389 — S — 123 (1.15 2.03 1.20) 389 — S — 131 (1.56 1.36 1.87) 389 — S — 132 (1.47 1.61 1.63)
389 — S — 144 (1.59 2.32 0.91) 389 — S — 147 (1.00 1.90 1.33) 389 — S — 148 (1.25 1.19 2.04) 389 — S — 150 (3.08 2.29 0.94)
389 — S — 154 (2.55 1.51 1.72) 389 — S — 161 (2.06 0.82 2.41) 389 — S — 166 (2.27 1.34 1.89) 389 — S — 167 (2.13 1.03 2.20)
389 — S — 171 (2.04 1.34 1.89) 389 — S — 175 (1.27 0.98 2.25) 389 — S — 177 (2.09 2.07 1.16) 389 — S — 182 (1.23 0.91 2.32)
389 — S — 184 (2.83 1.88 1.35) 389 — S — 187 (1.97 1.25 1.98) 389 — S — 188 (2.41 1.29 1.94) 389 — S — 189 (2.15 0.88 2.35)
389 — S — 193 (1.35 1.56 1.67) 389 — S — 194 (2.21 1.00 2.23) 389 — S — 195 (2.26 1.72 1.51) 389 — S — 198 (1.97 1.78 1.45)
389 — S — 205 (1.49 1.84 1.39) 389 — S — 208 (1.45 1.31 1.92) 389 — S — 209 (1.20 1.39 1.84) 389 — S — 213 (1.94 1.74 1.49)
389 — S — 214 (1.50 0.97 2.26) 389 — S — 217 (1.36 1.77 1.46) 389 — S — 218 (1.33 1.95 1.28) 389 — S — 219 (1.13 1.50 1.73)
389 — S — 222 (1.25 1.35 1.88) 389 — S — 224 (0.88 1.02 2.21) 389 — S — 228 (0.87 1.51 1.73) 389 — S — 230 (1.17 1.18 2.05)
389 — S — 233 (1.87 1.94 1.29) 389 — S — 234 (1.69 2.02 1.21) 389 — S — 236 (1.91 0.90 2.33) 389 — S — 237 (1.70 2.31 0.92)
389 — S — 238 (0.99 2.17 1.06) 389 — S — 243 (2.43 1.14 2.09) 389 — S — 244 (1.75 1.93 1.30) 389 — S — 245 (1.67 1.70 1.53)
389 — S — 246 (2.00 2.27 0.96) 389 — S — 254 (1.50 1.63 1.61) 389 — S — 266 (1.60 1.99 1.24) 389 — S — 267 (1.40 1.69 1.54)
389 — S — 272 (1.79 1.03 2.20) 389 — S — 274 (1.27 1.49 1.74) 389 — S — 275 (1.08 1.91 1.32) 389 — S — 276 (1.19 0.89 2.34)
389 — S — 277 (1.49 1.76 1.48) 389 — S — 279 (1.54 1.82 1.41) 389 — S — 280 (1.22 1.50 1.73) 389 — S — 282 (1.34 1.32 1.91)
389 — S — 284 (1.12 1.33 1.90) 389 — S — 285 (1.27 1.70 1.53) 389 — S — 286 (1.52 1.60 1.63) 389 — S — 287 (1.33 1.61 1.62)
389 — S — 288 (1.31 1.55 1.68) 389 — S — 289 (1.57 1.39 1.84) 389 — S — 290 (1.60 2.02 1.21) 389 — S — 292 (2.07 2.08 1.15)
389 — S — 293 (1.58 1.89 1.34) 389 — S — 294 (2.03 1.92 1.31) 389 — S — 295 (1.79 2.17 1.06) 389 — S — 296 (2.06 2.16 1.07)
389 — S — 297 (1.38 1.29 1.94) 389 — S — 298 (1.63 1.77 1.46) 389 — S — 299 (0.89 2.11 1.12) 389 — S — 300 (1.64 1.17 2.06)
389 — S — 301 (1.69 0.88 2.35) 389 — S — 303 (1.40 1.14 2.09) 389 — S — 304 (1.44 1.62 1.62) 389 — S — 305 (1.95 1.83 1.40)
389 — S — 310 (1.55 1.23 2.00) 389 — S — 311 (1.28 1.50 1.73) 389 — S — 312 (1.37 1.37 1.86) 389 — S — 313 (1.15 1.54 1.69)
389 — S — 316 (1.44 1.83 1.40) 389 — S — 318 (1.73 0.87 2.36) 389 — S — 327 (1.73 2.23 1.00) 389 — S — 330 (1.06 1.24 1.99)
389 — S — 331 (1.59 1.41 1.82) 389 — S — 332 (1.44 1.59 1.65) 389 — S — 336 (1.54 1.47 1.76) 389 — S — 341 (1.04 2.10 1.13)
389 — S — 356 (1.21 1.29 1.94) 389 — S — 357 (1.90 1.04 2.19) 389 — S — 358 (1.38 1.75 1.48) 389 — S — 360 (0.83 1.15 2.09)
389 — S — 370 (1.35 1.82 1.41) 389 — S — 372 (1.58 1.52 1.71) 389 — S — 373 (0.97 1.52 1.71) 389 — S — 374 (1.19 2.01 1.22)
389 — S — 379 (1.27 1.51 1.72) 389 — S — 380 (1.11 0.93 2.30) 389 — S — 381 (0.84 1.68 1.55) 389 — S — 382 (1.33 1.69 1.54)
389 — S — 391 (1.27 1.50 1.73) 389 — S — 395 (2.20 2.23 1.00) 389 — S — 396 (1.63 1.67 1.56) 389 — S — 397 (1.43 1.51 1.72)
389 — S — 415 (1.32 1.40 1.83) 389 — S — 432 (1.45 1.01 2.22) 389 — S — 433 (1.16 1.02 2.21) 389 — S — 434 (1.28 1.80 1.43)
389 — S — 435 (1.36 1.97 1.26) 389 — S — 437 (1.54 1.35 1.88) 389 — S — 440 (1.89 2.14 1.09) 389 — S — 441 (1.82 2.07 1.16)
389 — S — 447 (1.83 2.25 0.98) 389 — S — 449 (1.57 2.22 1.01) 389 — S — 450 (1.19 1.89 1.34) 389 — S — 453 (1.46 1.19 2.04)
389 — S — 454 (1.28 1.36 1.87) 389 — S — 455 (1.27 1.63 1.60) 389 — S — 456 (0.96 1.34 1.89) 389 — S — 457 (1.41 2.13 1.10)
389 — S — 458 (0.96 1.93 1.30) 389 — S — 461 (1.41 2.33 0.90) 389 — S — 467 (1.10 1.74 1.49) 389 — S — 468 (1.30 2.04 1.19)
389 — S — 471 (1.99 1.80 1.43) 389 — S — 474 (1.89 2.30 0.93) 389 — S — 475 (0.83 1.42 1.81) 390 — S — 9 (1.49 0.94 1.94)
390 — S — 19 (1.06 0.84 2.05) 390 — S — 20 (1.60 1.48 1.40) 390 — S — 27 (1.51 1.65 1.23) 390 — S — 28 (1.57 1.92 0.96)
390 — S — 29 (1.34 1.64 1.24) 390 — S — 38 (0.95 1.08 1.81) 390 — S — 40 (1.16 1.64 1.24) 390 — S — 44 (1.23 0.80 2.08)
390 — S — 46 (2.74 1.81 1.08) 390 — S — 56 (1.50 1.11 1.77) 390 — S — 61 (1.48 1.63 1.26) 390 — S — 62 (1.36 1.83 1.06)
390 — S — 65 (1.50 1.42 1.46) 390 — S — 68 (1.21 1.39 1.50) 390 — S — 79 (1.48 1.80 1.08) 390 — S — 80 (1.43 1.76 1.13)
390 — S — 81 (1.51 1.88 1.00) 390 — S — 83 (1.54 1.05 1.83) 390 — S — 85 (1.99 1.61 1.27) 390 — S — 86 (1.21 1.98 0.90)
390 — S — 101 (1.63 1.94 0.95) 390 — S — 102 (1.26 0.95 1.94) 390 — S — 105 (1.79 1.03 1.85) 390 — S — 107 (2.25 1.77 1.11)
390 — S — 110 (1.55 1.94 0.95) 390 — S — 111 (2.25 1.06 1.83) 390 — S — 112 (1.44 1.43 1.45) 390 — S — 115 (1.92 1.91 0.97)
390 — S — 118 (1.53 1.33 1.55) 390 — S — 119 (1.50 1.55 1.34) 390 — S — 123 (1.14 1.68 1.21) 390 — S — 131 (1.56 1.01 1.87)
390 — S — 132 (1.47 1.25 1.63) 390 — S — 144 (1.59 1.97 0.91) 390 — S — 147 (1.00 1.55 1.34) 390 — S — 148 (1.25 0.84 2.04)
390 — S — 150 (3.08 1.94 0.95) 390 — S — 154 (2.54 1.16 1.72) 390 — S — 166 (2.26 0.99 1.89) 390 — S — 171 (2.03 0.99 1.90)
390 — S — 177 (2.09 1.72 1.17) 390 — S — 184 (2.83 1.53 1.36) 390 — S — 187 (1.97 0.90 1.98) 390 — S — 188 (2.40 0.94 1.94)
390 — S — 193 (1.35 1.21 1.67) 390 — S — 195 (2.26 1.37 1.51) 390 — S — 198 (1.97 1.43 1.45) 390 — S — 205 (1.49 1.49 1.39)
390 — S — 208 (1.45 0.96 1.92) 390 — S — 209 (1.20 1.04 1.84) 390 — S — 213 (1.94 1.39 1.50) 390 — S — 217 (1.36 1.42 1.46)
390 — S — 218 (1.33 1.60 1.29) 390 — S — 219 (1.13 1.15 1.73) 390 — S — 222 (1.24 1.00 1.88) 390 — S — 228 (0.87 1.15 1.73)
390 — S — 230 (1.17 0.83 2.05) 390 — S — 233 (1.86 1.59 1.30) 390 — S — 234 (1.68 1.67 1.22) 390 — S — 237 (1.69 1.96 0.92)
390 — S — 238 (0.99 1.82 1.06) 390 — S — 244 (1.75 1.58 1.31) 390 — S — 245 (1.66 1.35 1.53) 390 — S — 246 (2.00 1.92 0.97)
390 — S — 254 (1.50 1.27 1.61) 390 — S — 266 (1.60 1.64 1.25) 390 — S — 267 (1.40 1.34 1.55) 390 — S — 274 (1.27 1.14 1.75)
390 — S — 275 (1.07 1.56 1.33) 390 — S — 277 (1.49 1.40 1.48) 390 — S — 279 (1.54 1.47 1.42) 390 — S — 280 (1.22 1.15 1.74)
390 — S — 282 (1.34 0.97 1.91) 390 — S — 284 (1.12 0.98 1.90) 390 — S — 285 (1.26 1.35 1.54) 390 — S — 286 (1.52 1.25 1.63)
390 — S — 287 (1.32 1.26 1.62) 390 — S — 288 (1.31 1.20 1.68) 390 — S — 289 (1.57 1.04 1.84) 390 — S — 290 (1.60 1.67 1.22)
390 — S — 292 (2.07 1.73 1.15) 390 — S — 293 (1.57 1.54 1.34) 390 — S — 294 (2.03 1.57 1.31) 390 — S — 295 (1.78 1.82 1.07)
390 — S — 296 (2.06 1.81 1.07) 390 — S — 297 (1.37 0.94 1.94) 390 — S — 298 (1.63 1.42 1.46) 390 — S — 299 (0.89 1.76 1.12)
390 — S — 300 (1.64 0.82 2.07) 390 — S — 304 (1.44 1.26 1.62) 390 — S — 305 (1.95 1.48 1.40) 390 — S — 310 (1.55 0.88 2.01)
390 — S — 311 (1.27 1.15 1.73) 390 — S — 312 (1.37 1.02 1.86) 390 — S — 313 (1.15 1.19 1.69) 390 — S — 316 (1.43 1.48 1.40)
390 — S — 327 (1.72 1.88 1.00) 390 — S — 330 (1.05 0.89 2.00) 390 — S — 331 (1.58 1.06 1.82) 390 — S — 332 (1.44 1.23 1.65)
390 — S — 336 (1.54 1.12 1.76) 390 — S — 341 (1.03 1.75 1.13) 390 — S — 356 (1.20 0.94 1.94) 390 — S — 358 (1.38 1.40 1.48)

390 — S — 370 (1.35 1.47 1.42) 390 — S — 372 (1.58 1.17 1.72) 390 — S — 373 (0.97 1.17 1.71) 390 — S — 374 (1.19 1.66 1.22) 390 — S — 379 (1.26 1.16 1.72) 390 — S — 381 (0.83 1.33 1.55) 390 — S — 382 (1.33 1.34 1.54) 390 — S — 391 (1.27 1.15 1.73) 390 — S — 395 (2.20 1.88 1.00) 390 — S — 396 (1.62 1.32 1.56) 390 — S — 397 (1.43 1.16 1.72) 390 — S — 415 (1.32 1.05 1.84) 390 — S — 430 (1.21 1.98 0.90) 390 — S — 434 (1.27 1.45 1.43) 390 — S — 435 (1.36 1.62 1.26) 390 — S — 437 (1.54 1.00 1.88) 390 — S — 440 (1.88 1.79 1.09) 390 — S — 441 (1.81 1.72 1.17) 390 — S — 447 (1.82 1.90 0.98) 390 — S — 449 (1.57 1.87 1.01) 390 — S — 450 (1.19 1.54 1.34) 390 — S — 453 (1.46 0.84 2.04) 390 — S — 454 (1.28 1.01 1.87) 390 — S — 455 (1.26 1.28 1.60) 390 — S — 456 (0.96 0.99 1.89) 390 — S — 457 (1.41 1.78 1.10) 390 — S — 458 (0.95 1.58 1.30) 390 — S — 461 (1.40 1.98 0.91) 390 — S — 467 (1.09 1.39 1.50) 390 — S — 468 (1.29 1.69 1.19) 390 — S — 471 (1.99 1.45 1.43) 390 — S — 474 (1.89 1.95 0.93) 390 — S — 475 (0.83 1.07 1.81) 391 — S — 43 (0.88 1.14 1.87) 391 — S — 57 (1.15 1.68 1.33) 391 — S — 70 (0.94 1.35 1.66) 391 — S — 133 (0.99 0.91 2.09) 391 — S — 151 (1.72 1.04 1.96) 391 — S — 152 (2.36 1.34 1.66) 391 — S — 153 (1.74 0.89 2.12) 391 — S — 192 (1.16 0.90 2.11) 391 — S — 215 (0.97 1.47 1.54) 391 — S — 231 (1.21 1.01 1.99) 391 — S — 247 (0.87 1.97 1.03) 391 — S — 255 (1.12 0.99 2.02) 391 — S — 259 (0.98 1.80 1.20) 391 — S — 271 (1.39 1.08 1.92) 391 — S — 291 (1.47 0.92 2.08) 391 — S — 306 (0.84 0.99 2.02) 391 — S — 320 (1.06 1.40 1.60) 391 — S — 324 (1.04 1.90 1.11) 391 — S — 342 (2.21 0.94 2.06) 391 — S — 343 (2.74 1.43 1.57) 391 — S — 364 (0.92 1.56 1.44) 391 — S — 368 (0.85 1.43 1.57) 391 — S — 371 (1.90 1.03 1.97) 391 — S — 472 (1.30 1.71 1.29) 392 — S — 20 (0.87 1.17 2.12) 392 — S — 28 (0.85 1.60 1.69) 392 — S — 36 (1.01 2.12 1.18) 392 — S — 43 (1.42 1.97 1.32) 392 — S — 46 (2.02 1.49 1.80) 392 — S — 70 (1.49 2.18 1.11) 392 — S — 85 (1.27 1.29 2.00) 392 — S — 89 (1.24 1.92 1.37) 392 — S — 90 (1.15 1.77 1.52) 392 — S — 101 (0.91 1.62 1.67) 392 — S — 107 (1.53 1.45 1.84) 392 — S — 108 (1.09 1.85 1.44) 392 — S — 109 (1.33 1.98 1.31) 392 — S — 110 (0.82 1.62 1.67) 392 — S — 113 (0.93 2.04 1.26) 392 — S — 115 (1.20 1.59 1.70) 392 — S — 118 (0.81 1.02 2.27) 392 — S — 133 (1.53 1.75 1.55) 392 — S — 144 (0.87 1.66 1.63) 392 — S — 145 (0.85 2.31 0.98) 392 — S — 150 (2.35 1.62 1.67) 392 — S — 151 (2.26 1.88 1.41) 392 — S — 152 (2.90 2.18 1.12) 392 — S — 153 (2.28 1.72 1.57) 392 — S — 154 (1.82 0.85 2.44) 392 — S — 177 (1.37 1.40 1.89) 392 — S — 183 (1.01 1.73 1.56) 392 — S — 184 (2.10 1.21 2.08) 392 — S — 192 (1.71 1.73 1.56) 392 — S — 195 (1.53 1.06 2.24) 392 — S — 198 (1.24 1.12 2.18) 392 — S — 207 (1.28 2.04 1.26) 392 — S — 213 (1.21 1.07 2.22) 392 — S — 215 (1.51 2.30 0.99) 392 — S — 231 (1.75 1.84 1.45) 392 — S — 233 (1.14 1.27 2.02) 392 — S — 234 (0.96 1.35 1.94) 392 — S — 237 (0.97 1.65 1.65) 392 — S — 244 (1.02 1.26 2.03) 392 — S — 245 (0.94 1.03 2.26) 392 — S — 246 (1.28 1.60 1.69) 392 — S — 248 (1.34 2.15 1.14) 392 — S — 249 (0.81 1.99 1.30) 392 — S — 255 (1.67 1.82 1.47) 392 — S — 265 (1.24 1.74 1.55) 392 — S — 266 (0.88 1.32 1.97) 392 — S — 268 (1.22 1.89 1.40) 392 — S — 269 (1.18 1.82 1.47) 392 — S — 271 (1.93 1.91 1.38) 392 — S — 279 (0.82 1.15 2.14) 392 — S — 290 (0.87 1.35 1.94) 392 — S — 291 (2.01 1.76 1.53) 392 — S — 292 (1.35 1.42 1.88) 392 — S — 293 (0.85 1.23 2.07) 392 — S — 294 (1.30 1.26 2.03) 392 — S — 295 (1.06 1.50 1.79) 392 — S — 296 (1.34 1.50 1.79) 392 — S — 298 (0.90 1.10 2.19) 392 — S — 305 (1.23 1.16 2.13) 392 — S — 306 (1.39 1.82 1.47) 392 — S — 307 (1.12 1.95 1.34) 392 — S — 320 (1.61 2.24 1.05) 392 — S — 327 (1.00 1.57 1.72) 392 — S — 329 (1.33 2.03 1.27) 392 — S — 336 (0.81 0.81 2.48) 392 — S — 342 (2.76 1.78 1.52) 392 — S — 343 (3.28 2.27 1.02) 392 — S — 367 (1.28 1.72 1.57) 392 — S — 368 (1.39 2.26 1.03) 392 — S — 371 (2.44 1.86 1.43) 392 — S — 372 (0.85 0.85 2.44) 392 — S — 395 (1.47 1.56 1.73) 392 — S — 396 (0.90 1.00 2.29) 392 — S — 440 (1.16 1.47 1.82) 392 — S — 441 (1.09 1.40 1.89) 392 — S — 447 (1.10 1.59 1.70) 392 — S — 449 (0.84 1.56 1.73) 392 — S — 451 (1.18 2.17 1.12) 392 — S — 452 (1.24 1.82 1.47) 392 — S — 460 (0.97 1.90 1.39) 392 — S — 463 (1.12 2.27 1.02) 392 — S — 471 (1.26 1.13 2.16) 392 — S — 473 (1.31 1.75 1.54) 392 — S — 474 (1.16 1.63 1.66) 393 — S — 43 (1.18 4.28 1.56) 393 — S — 46 (1.78 3.80 2.04) 393 — S — 57 (1.45 4.81 1.02) 393 — S — 70 (1.25 4.49 1.35) 393 — S — 85 (1.03 3.60 2.24) 393 — S — 89 (1.00 4.22 1.61) 393 — S — 90 (0.91 4.07 1.76) 393 — S — 105 (0.83 3.02 2.82) 393 — S — 107 (1.29 3.76 2.08) 393 — S — 108 (0.85 4.15 1.69) 393 — S — 109 (1.08 4.29 1.55) 393 — S — 111 (1.28 3.05 2.79) 393 — S — 115 (0.95 3.90 1.94) 393 — S — 133 (1.29 4.05 1.79) 393 — S — 141 (1.07 1.77 4.07) 393 — S — 150 (2.11 3.92 1.91) 393 — S — 151 (2.02 4.18 1.66) 393 — S — 152 (2.66 4.48 1.36) 393 — S — 153 (2.04 4.03 1.81) 393 — S — 154 (1.58 3.15 2.69) 393 — S — 160 (1.07 1.87 3.97) 393 — S — 161 (1.09 2.45 3.38) 393 — S — 165 (0.95 4.90 0.94) 393 — S — 166 (1.30 2.98 2.86) 393 — S — 167 (1.16 2.67 3.17) 393 — S — 170 (1.37 2.39 3.45) 393 — S — 171 (1.07 2.98 2.86) 393 — S — 177 (1.12 3.70 2.13) 393 — S — 184 (1.86 3.52 2.32) 393 — S — 187 (1.00 2.89 2.95) 393 — S — 188 (1.44 2.93 2.91) 393 — S — 189 (1.18 2.52 3.32) 393 — S — 192 (1.47 4.04 1.80) 393 — S — 194 (1.24 2.64 3.20) 393 — S — 195 (1.29 3.36 2.48) 393 — S — 197 (1.43 2.43 3.41) 393 — S — 198 (1.00 3.42 2.42) 393 — S — 207 (1.04 4.34 1.50) 393 — S — 213 (0.97 3.38 2.46) 393 — S — 215 (1.27 4.61 1.23) 393 — S — 231 (1.51 4.15 1.69) 393 — S — 233 (0.90 3.57 2.26) 393 — S — 236 (0.94 2.54 3.30) 393 — S — 243 (1.46 2.78 3.06) 393 — S — 246 (1.03 3.91 1.93) 393 — S — 248 (1.10 4.45 1.38) 393 — S — 255 (1.43 4.12 1.71) 393 — S — 264 (0.82 1.99 3.85) 393 — S — 265 (1.00 4.05 1.79) 393 — S — 268 (0.98 4.20 1.64) 393 — S — 269 (0.94 4.13 1.71) 393 — S — 270 (1.08 4.80 1.04) 393 — S — 271 (1.69 4.22 1.62) 393 — S — 272 (0.82 2.67 3.17) 393 — S — 291 (1.77 4.06 1.78) 393 — S — 292 (1.10 3.72 2.12) 393 — S — 294 (1.06 3.56 2.28) 393 — S — 295 (0.82 3.81 2.03) 393 — S — 296 (1.09 3.80 2.04) 393 — S — 302 (0.84 2.37 3.47) 393 — S — 305 (0.98 3.47 2.37) 393 — S — 306 (1.15 4.12 1.71) 393 — S — 307 (0.87 4.25 1.59) 393 — S — 320 (1.37 4.54 1.30) 393 — S — 329 (1.09 4.33 1.51) 393 — S — 338 (0.87 1.88 3.96) 393 — S — 342 (2.51 4.08 1.76) 393 — S — 343 (3.04 4.57 1.27) 393 — S — 357 (0.93 2.68 3.16) 393 — S — 364 (1.22 4.70 1.14) 393 — S — 367 (1.04 4.03 1.81) 393 — S — 368 (1.15 4.57 1.27) 393 — S — 371 (2.20 4.17 1.67) 393 — S — 395 (1.23 3.87 1.97) 393 — S — 440 (0.92 3.78 2.06) 393 — S — 441 (0.85 3.71 2.13) 393 — S — 447 (0.86 3.89 1.95) 393 — S — 451 (0.94 4.47 1.37) 393 — S — 452 (1.00 4.13 1.71) 393 — S — 463 (0.87 4.57 1.26) 393 — S — 471 (1.02 3.44 2.40) 393 — S — 472 (1.60 4.85 0.99) 393 — S — 473 (1.07 4.05 1.79) 393 — S — 474 (0.92 3.94 1.90) 394 — S — 43 (0.98 1.84 1.76) 394 — S — 46 (1.58 1.36 2.24) 394 — S — 57 (1.25 2.38 1.23) 394 — S — 70 (1.05 2.05 1.55) 394 — S — 85 (0.83 1.16 2.44) 394 — S — 107 (1.09 1.32 2.28) 394 — S — 109 (0.88 1.85 1.75)

394 — S — 133 (1.09 1.62 1.99) 394 — S — 150 (1.91 1.49 2.12) 394 — S — 151 (1.82 1.75 1.86) 394 — S — 152 (2.46 2.05 1.56)
394 — S — 153 (1.84 1.59 2.01) 394 — S — 177 (0.92 1.27 2.34) 394 — S — 184 (1.66 1.08 2.52) 394 — S — 192 (1.27 1.60 2.00)
394 — S — 195 (1.09 0.93 2.68) 394 — S — 198 (0.80 0.99 2.62) 394 — S — 207 (0.84 1.91 1.70) 394 — S — 215 (1.07 2.17 1.43)
394 — S — 231 (1.31 1.71 1.89) 394 — S — 246 (0.83 1.47 2.13) 394 — S — 247 (0.97 2.68 0.93) 394 — S — 248 (0.90 2.02 1.59)
394 — S — 255 (1.22 1.69 1.91) 394 — S — 259 (1.08 2.51 1.10) 394 — S — 270 (0.88 2.37 1.24) 394 — S — 271 (1.49 1.78 1.82)
394 — S — 291 (1.57 1.63 1.98) 394 — S — 292 (0.90 1.29 2.32) 394 — S — 294 (0.86 1.13 2.48) 394 — S — 296 (0.89 1.37 2.24)
394 — S — 306 (0.94 1.69 1.92) 394 — S — 320 (1.16 2.11 1.50) 394 — S — 324 (1.14 2.60 1.00) 394 — S — 329 (0.88 1.89 1.71)
394 — S — 342 (2.31 1.65 1.96) 394 — S — 343 (2.84 2.14 1.47) 394 — S — 364 (1.02 2.27 1.34) 394 — S — 367 (0.84 1.59 2.01)
394 — S — 368 (0.95 2.13 1.47) 394 — S — 371 (2.00 1.73 1.87) 394 — S — 395 (1.03 1.43 2.17) 394 — S — 471 (0.82 1.00 2.60)
394 — S — 472 (1.40 2.41 1.19) 394 — S — 473 (0.87 1.62 1.99) 395 — S — 429 (1.37 1.40 1.80) 396 — S — 125 (1.03 1.96 1.23)
396 — S — 151 (1.36 0.87 2.31) 396 — S — 152 (2.01 1.17 2.01) 396 — S — 231 (0.85 0.84 2.35) 396 — S — 250 (0.80 2.08 1.11)
396 — S — 271 (1.03 0.91 2.28) 396 — S — 343 (2.39 1.27 1.92) 396 — S — 371 (1.54 0.86 2.33) 396 — S — 429 (1.95 1.96 1.22)
396 — S — 472 (0.94 1.54 1.65) 397 — S — 57 (0.99 1.66 1.48) 397 — S — 125 (1.23 2.11 1.04) 397 — S — 133 (0.83 0.90 2.25)
397 — S — 151 (1.56 1.03 2.12) 397 — S — 152 (2.20 1.33 1.82) 397 — S — 153 (1.58 0.87 2.27) 397 — S — 192 (1.01 0.88 2.26)
397 — S — 215 (0.81 1.45 1.69) 397 — S — 231 (1.05 1.00 2.15) 397 — S — 250 (1.00 2.24 0.91) 397 — S — 255 (0.97 0.97 2.17)
397 — S — 259 (0.82 1.79 1.36) 397 — S — 271 (1.23 1.06 2.08) 397 — S — 291 (1.31 0.91 2.24) 397 — S — 320 (0.91 1.39 1.76)
397 — S — 324 (0.88 1.88 1.26) 397 — S — 342 (2.05 0.93 2.22) 397 — S — 343 (2.58 1.42 1.73) 397 — S — 371 (1.74 1.02 2.13)
397 — S — 429 (2.14 2.12 1.03) 397 — S — 472 (1.14 1.70 1.45) 398 — S — 43 (0.82 2.00 1.93) 398 — S — 46 (1.41 1.52 2.41)
398 — S — 57 (1.08 2.53 1.39) 398 — S — 70 (0.88 2.21 1.72) 398 — S — 107 (0.92 1.48 2.44) 398 — S — 125 (1.32 2.98 0.94)
398 — S — 133 (0.92 1.77 2.15) 398 — S — 150 (1.74 1.64 2.28) 398 — S — 151 (1.65 1.90 2.02) 398 — S — 152 (2.30 2.20 1.72)
398 — S — 153 (1.68 1.74 2.18) 398 — S — 154 (1.21 0.87 3.05) 398 — S — 184 (1.49 1.24 2.69) 398 — S — 192 (1.10 1.76 2.17)
398 — S — 195 (0.92 1.08 2.84) 398 — S — 215 (0.90 2.33 1.60) 398 — S — 231 (1.14 1.87 2.06) 398 — S — 247 (0.80 2.83 1.09)
398 — S — 255 (1.06 1.84 2.08) 398 — S — 259 (0.91 2.66 1.26) 398 — S — 271 (1.32 1.94 1.99) 398 — S — 291 (1.40 1.78 2.14)
398 — S — 320 (1.00 2.26 1.66) 398 — S — 324 (0.97 2.75 1.17) 398 — S — 342 (2.15 1.80 2.12) 398 — S — 343 (2.68 2.29 1.63)
398 — S — 364 (0.86 2.42 1.50) 398 — S — 371 (1.83 1.89 2.03) 398 — S — 395 (0.87 1.59 2.33) 398 — S — 429 (2.24 2.99 0.93)
398 — S — 472 (1.23 2.57 1.36) 399 — S — 9 (1.40 0.85 2.04) 399 — S — 20 (1.50 1.40 1.49) 399 — S — 27 (1.42 1.56 1.33)
399 — S — 28 (1.48 1.83 1.06) 399 — S — 29 (1.24 1.56 1.33) 399 — S — 38 (0.86 0.99 1.90) 399 — S — 40 (1.06 1.56 1.33)
399 — S — 46 (2.65 1.72 1.17) 399 — S — 56 (1.41 1.03 1.86) 399 — S — 61 (1.39 1.54 1.35) 399 — S — 62 (1.27 1.74 1.15)
399 — S — 65 (1.40 1.34 1.56) 399 — S — 68 (1.11 1.30 1.59) 399 — S — 79 (1.39 1.71 1.18) 399 — S — 80 (1.34 1.67 1.22)
399 — S — 81 (1.41 1.79 1.10) 399 — S — 82 (1.15 1.98 0.91) 399 — S — 83 (1.44 0.97 1.92) 399 — S — 85 (1.90 1.52 1.37)
399 — S — 86 (1.12 1.89 1.00) 399 — S — 101 (1.54 1.85 1.04) 399 — S — 102 (1.16 0.86 2.03) 399 — S — 105 (1.70 0.95 1.94)
399 — S — 107 (2.16 1.68 1.21) 399 — S — 110 (1.45 1.85 1.04) 399 — S — 111 (2.15 0.97 1.92) 399 — S — 112 (1.35 1.35 1.54)
399 — S — 115 (1.83 1.82 1.07) 399 — S — 118 (1.44 1.25 1.64) 399 — S — 119 (1.41 1.46 1.43) 399 — S — 123 (1.05 1.59 1.30)
399 — S — 131 (1.46 0.92 1.97) 399 — S — 132 (1.37 1.17 1.72) 399 — S — 133 (2.16 1.98 0.92) 399 — S — 144 (1.50 1.89 1.00)
399 — S — 147 (0.90 1.46 1.43) 399 — S — 150 (2.98 1.85 1.04) 399 — S — 153 (2.91 1.95 0.94) 399 — S — 154 (2.45 1.08 1.81)
399 — S — 166 (2.17 0.90 1.99) 399 — S — 171 (1.94 0.90 1.99) 399 — S — 177 (2.00 1.63 1.26) 399 — S — 183 (1.64 1.96 0.93)
399 — S — 184 (2.73 1.44 1.45) 399 — S — 187 (1.88 0.81 2.08) 399 — S — 188 (2.31 0.85 2.04) 399 — S — 192 (2.34 1.96 0.93)
399 — S — 193 (1.26 1.12 1.77) 399 — S — 195 (2.16 1.29 1.61) 399 — S — 198 (1.87 1.35 1.55) 399 — S — 205 (1.39 1.41 1.49)
399 — S — 208 (1.36 0.88 2.01) 399 — S — 209 (1.10 0.96 1.94) 399 — S — 213 (1.84 1.30 1.59) 399 — S — 217 (1.26 1.33 1.56)
399 — S — 218 (1.23 1.51 1.38) 399 — S — 219 (1.03 1.07 1.82) 399 — S — 222 (1.15 0.92 1.98) 399 — S — 233 (1.77 1.50 1.39)
399 — S — 234 (1.59 1.58 1.31) 399 — S — 237 (1.60 1.88 1.02) 399 — S — 238 (0.89 1.73 1.16) 399 — S — 244 (1.65 1.49 1.40)
399 — S — 245 (1.57 1.26 1.63) 399 — S — 246 (1.91 1.83 1.06) 399 — S — 254 (1.41 1.19 1.70) 399 — S — 265 (1.87 1.97 0.92)
399 — S — 266 (1.51 1.55 1.34) 399 — S — 267 (1.31 1.25 1.64) 399 — S — 274 (1.17 1.05 1.84) 399 — S — 275 (0.98 1.47 1.42)
399 — S — 277 (1.39 1.32 1.57) 399 — S — 279 (1.45 1.38 1.51) 399 — S — 280 (1.13 1.06 1.83) 399 — S — 282 (1.24 0.89 2.01)
399 — S — 284 (1.02 0.89 2.00) 399 — S — 285 (1.17 1.26 1.63) 399 — S — 286 (1.42 1.17 1.73) 399 — S — 287 (1.23 1.18 1.71)
399 — S — 288 (1.22 1.12 1.77) 399 — S — 289 (1.47 0.95 1.94) 399 — S — 290 (1.50 1.58 1.31) 399 — S — 291 (2.64 1.99 0.90)
399 — S — 292 (1.98 1.65 1.25) 399 — S — 293 (1.48 1.46 1.44) 399 — S — 294 (1.93 1.49 1.40) 399 — S — 295 (1.69 1.73 1.16)
399 — S — 296 (1.97 1.73 1.16) 399 — S — 297 (1.28 0.86 2.03) 399 — S — 298 (1.53 1.33 1.56) 399 — S — 304 (1.34 1.18 1.71)
399 — S — 305 (1.86 1.39 1.50) 399 — S — 311 (1.18 1.07 1.83) 399 — S — 312 (1.28 0.94 1.95) 399 — S — 313 (1.05 1.11 1.79)
399 — S — 316 (1.34 1.39 1.50) 399 — S — 327 (1.63 1.80 1.09) 399 — S — 330 (0.96 0.80 2.09) 399 — S — 331 (1.49 0.97 1.92)
399 — S — 332 (1.34 1.15 1.74) 399 — S — 336 (1.44 1.04 1.85) 399 — S — 341 (0.94 1.67 1.23) 399 — S — 356 (1.11 0.85 2.04)
399 — S — 358 (1.29 1.31 1.58) 399 — S — 367 (1.91 1.95 0.94) 399 — S — 370 (1.25 1.38 1.51) 399 — S — 372 (1.48 1.08 1.81)
399 — S — 373 (0.87 1.08 1.81) 399 — S — 374 (1.09 1.57 1.32) 399 — S — 379 (1.17 1.08 1.81) 399 — S — 382 (1.24 1.26 1.63)
399 — S — 391 (1.18 1.06 1.83) 399 — S — 395 (2.10 1.79 1.10) 399 — S — 396 (1.53 1.23 1.66) 399 — S — 397 (1.33 1.08 1.81)
399 — S — 415 (1.22 0.96 1.93) 399 — S — 430 (1.11 1.89 1.00) 399 — S — 434 (1.18 1.37 1.52) 399 — S — 435 (1.26 1.54 1.35)
399 — S — 437 (1.45 0.91 1.98) 399 — S — 440 (1.79 1.70 1.19) 399 — S — 441 (1.72 1.63 1.26) 399 — S — 447 (1.73 1.82 1.07)
399 — S — 449 (1.47 1.79 1.10) 399 — S — 450 (1.09 1.45 1.44) 399 — S — 454 (1.19 0.92 1.97) 399 — S — 455 (1.17 1.19 1.70)
399 — S — 456 (0.86 0.90 1.99) 399 — S — 457 (1.32 1.70 1.19) 399 — S — 458 (0.86 1.49 1.40) 399 — S — 459 (1.10 1.93 0.96)

399 — S — 461 (1.31 1.89 1.00) 399 — S — 462 (1.00 1.90 0.99) 399 — S — 467 (1.00 1.30 1.59) 399 — S — 468 (1.20 1.60 1.29) 399 — S — 471 (1.89 1.36 1.53) 399 — S — 473 (1.94 1.98 0.91) 399 — S — 474 (1.79 1.86 1.03) 400 — S — 28 (1.31 0.90 1.22) 400 — S — 62 (1.10 0.80 1.32) 400 — S — 81 (1.25 0.86 1.26) 400 — S — 82 (0.98 1.04 1.08) 400 — S — 86 (0.95 0.96 1.16) 400 — S — 89 (1.71 1.21 0.91) 400 — S — 90 (1.62 1.06 1.06) 400 — S — 101 (1.37 0.91 1.21) 400 — S — 108 (1.55 1.14 0.98) 400 — S — 110 (1.29 0.91 1.21) 400 — S — 115 (1.66 0.89 1.23) 400 — S — 133 (2.00 1.04 1.08) 400 — S — 144 (1.33 0.95 1.17) 400 — S — 150 (2.82 0.91 1.21) 400 — S — 151 (2.72 1.17 0.95) 400 — S — 153 (2.75 1.01 1.11) 400 — S — 183 (1.48 1.03 1.09) 400 — S — 192 (2.17 1.03 1.10) 400 — S — 231 (2.22 1.14 0.98) 400 — S — 237 (1.43 0.94 1.18) 400 — S — 246 (1.74 0.89 1.23) 400 — S — 251 (1.25 1.14 0.98) 400 — S — 255 (2.13 1.11 1.01) 400 — S — 265 (1.70 1.04 1.09) 400 — S — 268 (1.68 1.18 0.94) 400 — S — 269 (1.65 1.11 1.01) 400 — S — 271 (2.39 1.21 0.92) 400 — S — 291 (2.48 1.05 1.07) 400 — S — 306 (1.85 1.11 1.01) 400 — S — 327 (1.46 0.86 1.26) 400 — S — 342 (3.22 1.07 1.05) 400 — S — 367 (1.75 1.01 1.11) 400 — S — 371 (2.91 1.16 0.96) 400 — S — 395 (1.94 0.86 1.26) 400 — S — 430 (0.95 0.96 1.16) 400 — S — 447 (1.56 0.88 1.24) 400 — S — 449 (1.31 0.85 1.27) 400 — S — 452 (1.70 1.12 1.00) 400 — S — 459 (0.94 0.99 1.13) 400 — S — 460 (1.43 1.19 0.93) 400 — S — 461 (1.14 0.95 1.17) 400 — S — 462 (0.84 0.97 1.15) 400 — S — 469 (1.12 1.10 1.03) 400 — S — 473 (1.78 1.04 1.08) 400 — S — 474 (1.63 0.93 1.19) 401 — S — 43 (0.88 2.09 1.87) 401 — S — 46 (1.47 1.61 2.34) 401 — S — 57 (1.15 2.63 1.33) 401 — S — 70 (0.94 2.30 1.66) 401 — S — 107 (0.99 1.57 2.38) 401 — S — 111 (0.98 0.86 3.10) 401 — S — 133 (0.99 1.86 2.09) 401 — S — 150 (1.81 1.74 2.22) 401 — S — 151 (1.72 1.99 1.96) 401 — S — 152 (2.36 2.29 1.66) 401 — S — 153 (1.74 1.84 2.12) 401 — S — 154 (1.27 0.97 2.99) 401 — S — 177 (0.82 1.52 2.44) 401 — S — 184 (1.56 1.33 2.63) 401 — S — 192 (1.16 1.85 2.11) 401 — S — 195 (0.99 1.17 2.78) 401 — S — 215 (0.97 2.42 1.54) 401 — S — 231 (1.21 1.96 1.99) 401 — S — 247 (0.87 2.92 1.03) 401 — S — 255 (1.12 1.94 2.02) 401 — S — 259 (0.98 2.76 1.20) 401 — S — 271 (1.39 2.03 1.92) 401 — S — 291 (1.47 1.87 2.08) 401 — S — 292 (0.80 1.53 2.42) 401 — S — 306 (0.84 1.94 2.02) 401 — S — 320 (1.06 2.35 1.60) 401 — S — 324 (1.04 2.85 1.11) 401 — S — 342 (2.21 1.89 2.06) 401 — S — 343 (2.74 2.39 1.57) 401 — S — 364 (0.92 2.51 1.44) 401 — S — 368 (0.85 2.38 1.57) 401 — S — 371 (1.90 1.98 1.97) 401 — S — 395 (0.93 1.68 2.27) 401 — S — 472 (1.30 2.66 1.29) 402 — S — 20 (1.21 1.10 1.79) 402 — S — 27 (1.12 1.26 1.62) 402 — S — 28 (1.19 1.53 1.35) 402 — S — 29 (0.95 1.26 1.63) 402 — S — 43 (1.76 1.90 0.98) 402 — S — 46 (2.36 1.42 1.46) 402 — S — 61 (1.10 1.24 1.64) 402 — S — 62 (0.98 1.44 1.44) 402 — S — 65 (1.11 1.03 1.85) 402 — S — 68 (0.82 1.00 1.89) 402 — S — 79 (1.09 1.41 1.47) 402 — S — 80 (1.04 1.37 1.51) 402 — S — 81 (1.12 1.49 1.39) 402 — S — 82 (0.85 1.68 1.21) 402 — S — 85 (1.61 1.22 1.66) 402 — S — 86 (0.82 1.59 1.29) 402 — S — 89 (1.58 1.85 1.03) 402 — S — 90 (1.49 1.70 1.19) 402 — S — 101 (1.24 1.55 1.33) 402 — S — 107 (1.87 1.38 1.50) 402 — S — 108 (1.43 1.78 1.11) 402 — S — 109 (1.66 1.91 0.97) 402 — S — 110 (1.16 1.55 1.33) 402 — S — 112 (1.05 1.05 1.84) 402 — S — 113 (1.26 1.96 0.92) 402 — S — 115 (1.53 1.52 1.36) 402 — S — 118 (1.14 0.95 1.94) 402 — S — 119 (1.12 1.16 1.72) 402 — S — 132 (1.08 0.87 2.02) 402 — S — 133 (1.87 1.67 1.21) 402 — S — 144 (1.20 1.59 1.30) 402 — S — 150 (2.69 1.55 1.34) 402 — S — 151 (2.60 1.81 1.08) 402 — S — 153 (2.62 1.65 1.23) 402 — S — 177 (1.70 1.33 1.56) 402 — S — 183 (1.35 1.66 1.22) 402 — S — 184 (2.44 1.14 1.74) 402 — S — 192 (2.05 1.66 1.22) 402 — S — 193 (0.96 0.82 2.06) 402 — S — 195 (1.87 0.99 1.90) 402 — S — 198 (1.58 1.05 1.84) 402 — S — 205 (1.10 1.10 1.78) 402 — S — 207 (1.61 1.97 0.92) 402 — S — 213 (1.55 1.00 1.88) 402 — S — 217 (0.97 1.03 1.85) 402 — S — 218 (0.94 1.21 1.67) 402 — S — 231 (2.09 1.77 1.11) 402 — S — 233 (1.47 1.20 1.69) 402 — S — 234 (1.29 1.28 1.60) 402 — S — 237 (1.30 1.58 1.31) 402 — S — 244 (1.36 1.19 1.69) 402 — S — 245 (1.28 0.96 1.92) 402 — S — 246 (1.61 1.53 1.35) 402 — S — 249 (1.15 1.92 0.96) 402 — S — 251 (1.12 1.78 1.11) 402 — S — 254 (1.11 0.89 2.00) 402 — S — 255 (2.00 1.75 1.14) 402 — S — 265 (1.57 1.67 1.21) 402 — S — 266 (1.21 1.25 1.64) 402 — S — 267 (1.01 0.95 1.94) 402 — S — 268 (1.55 1.82 1.06) 402 — S — 269 (1.52 1.75 1.13) 402 — S — 271 (2.27 1.84 1.04) 402 — S — 277 (1.10 1.02 1.87) 402 — S — 279 (1.15 1.08 1.80) 402 — S — 285 (0.88 0.96 1.92) 402 — S — 286 (1.13 0.87 2.02) 402 — S — 287 (0.94 0.88 2.01) 402 — S — 288 (0.92 0.82 2.07) 402 — S — 290 (1.21 1.28 1.60) 402 — S — 291 (2.35 1.69 1.20) 402 — S — 292 (1.68 1.35 1.54) 402 — S — 293 (1.19 1.16 1.73) 402 — S — 294 (1.64 1.19 1.70) 402 — S — 295 (1.40 1.43 1.45) 402 — S — 296 (1.67 1.43 1.46) 402 — S — 298 (1.24 1.03 1.85) 402 — S — 304 (1.05 0.88 2.01) 402 — S — 305 (1.56 1.09 1.79) 402 — S — 306 (1.72 1.75 1.14) 402 — S — 307 (1.45 1.88 1.01) 402 — S — 316 (1.05 1.09 1.79) 402 — S — 327 (1.34 1.50 1.39) 402 — S — 329 (1.66 1.95 0.93) 402 — S — 332 (1.05 0.85 2.04) 402 — S — 342 (3.09 1.71 1.18) 402 — S — 358 (0.99 1.01 1.87) 402 — S — 367 (1.62 1.65 1.23) 402 — S — 370 (0.96 1.08 1.80) 402 — S — 371 (2.78 1.79 1.09) 402 — S — 374 (0.80 1.27 1.61) 402 — S — 382 (0.94 0.96 1.93) 402 — S — 395 (1.81 1.49 1.39) 402 — S — 396 (1.24 0.93 1.95) 402 — S — 420 (0.99 1.97 0.91) 402 — S — 430 (0.82 1.59 1.29) 402 — S — 434 (0.89 1.07 1.82) 402 — S — 435 (0.97 1.24 1.65) 402 — S — 440 (1.50 1.40 1.48) 402 — S — 441 (1.43 1.33 1.55) 402 — S — 443 (0.90 1.95 0.94) 402 — S — 447 (1.44 1.52 1.37) 402 — S — 449 (1.18 1.49 1.40) 402 — S — 450 (0.80 1.15 1.73) 402 — S — 452 (1.58 1.75 1.13) 402 — S — 455 (0.88 0.89 1.99) 402 — S — 457 (1.02 1.40 1.49) 402 — S — 459 (0.81 1.63 1.25) 402 — S — 460 (1.30 1.83 1.06) 402 — S — 461 (1.02 1.59 1.29) 402 — S — 468 (0.90 1.30 1.58) 402 — S — 469 (0.99 1.73 1.15) 402 — S — 471 (1.60 1.06 1.82) 402 — S — 473 (1.65 1.68 1.21) 402 — S — 474 (1.50 1.56 1.32) 403 — S — 43 (0.93 1.87 1.81) 403 — S — 46 (1.53 1.39 2.29) 403 — S — 57 (1.20 2.41 1.27) 403 — S — 70 (1.00 2.08 1.60) 403 — S — 107 (1.04 1.36 2.33) 403 — S — 109 (0.83 1.88 1.80) 403 — S — 133 (1.04 1.65 2.04) 403 — S — 150 (1.86 1.52 2.16) 403 — S — 151 (1.77 1.78 1.91) 403 — S — 152 (2.41 2.08 1.61) 403 — S — 153 (1.79 1.62 2.06) 403 — S — 177 (0.87 1.30 2.38) 403 — S — 184 (1.61 1.11 2.57) 403 — S — 192 (1.22 1.63 2.05) 403 — S — 195 (1.04 0.96 2.73) 403 — S — 215 (1.02 2.20 1.48) 403 — S — 231 (1.26 1.75 1.94) 403 — S — 247 (0.92 2.71 0.98) 403 — S — 248 (0.85 2.05 1.63) 403 — S — 255 (1.18 1.72 1.96) 403 — S — 259 (1.03 2.54 1.15) 403 — S — 270 (0.83 2.40 1.29) 403 — S — 271 (1.44 1.81 1.87) 403 — S — 291 (1.52 1.66 2.03) 403 — S — 292 (0.85 1.32 2.37) 403 — S — 294 (0.81 1.16 2.53) 403 — S — 296 (0.84 1.40 2.29) 403 — S — 306 (0.89 1.72 1.97) 403 — S — 320 (1.11 2.14 1.55) 403 — S — 324 (1.09 2.63 1.05) 403 — S — 329 (0.84 1.93 1.76)

403 — S — 342 (2.26 1.68 2.01) 403 — S — 343 (2.79 2.17 1.52) 403 — S — 364 (0.97 2.30 1.39) 403 — S — 368 (0.90 2.16 1.52)
403 — S — 371 (1.95 1.77 1.92) 403 — S — 395 (0.98 1.47 2.22) 403 — S — 472 (1.35 2.45 1.24) 403 — S — 473 (0.82 1.65 2.04)
404 — S — 9 (1.24 1.51 2.20) 404 — S — 19 (0.81 1.40 2.30) 404 — S — 20 (1.34 2.05 1.66) 404 — S — 27 (1.25 2.22 1.49)
404 — S — 28 (1.32 2.49 1.22) 404 — S — 29 (1.08 2.21 1.50) 404 — S — 40 (0.90 2.21 1.50) 404 — S — 44 (0.97 1.37 2.34)
404 — S — 46 (2.49 2.38 1.33) 404 — S — 56 (1.24 1.68 2.03) 404 — S — 61 (1.23 2.19 1.51) 404 — S — 62 (1.11 2.39 1.31)
404 — S — 65 (1.24 1.99 1.72) 404 — S — 68 (0.95 1.95 1.76) 404 — S — 79 (1.22 2.37 1.34) 404 — S — 80 (1.17 2.32 1.38)
404 — S — 81 (1.25 2.45 1.26) 404 — S — 82 (0.98 2.63 1.07) 404 — S — 83 (1.28 1.62 2.09) 404 — S — 85 (1.74 2.18 1.53)
404 — S — 86 (0.95 2.55 1.16) 404 — S — 89 (1.71 2.80 0.90) 404 — S — 90 (1.62 2.65 1.06) 404 — S — 101 (1.37 2.51 1.20)
404 — S — 102 (1.00 1.51 2.20) 404 — S — 105 (1.53 1.60 2.11) 404 — S — 106 (0.95 1.04 2.67) 404 — S — 107 (2.00 2.34 1.37)
404 — S — 108 (1.56 2.73 0.98) 404 — S — 110 (1.29 2.50 1.20) 404 — S — 111 (1.99 1.62 2.08) 404 — S — 112 (1.18 2.00 1.71)
404 — S — 114 (0.83 1.28 2.43) 404 — S — 115 (1.66 2.48 1.23) 404 — S — 118 (1.27 1.90 1.81) 404 — S — 119 (1.25 2.11 1.59)
404 — S — 123 (0.89 2.24 1.46) 404 — S — 127 (0.90 0.92 2.79) 404 — S — 131 (1.30 1.58 2.13) 404 — S — 132 (1.21 1.82 1.89)
404 — S — 133 (2.00 2.63 1.08) 404 — S — 144 (1.33 2.54 1.17) 404 — S — 148 (0.99 1.41 2.30) 404 — S — 150 (2.82 2.50 1.21)
404 — S — 151 (2.73 2.76 0.95) 404 — S — 153 (2.75 2.60 1.10) 404 — S — 154 (2.28 1.73 1.98) 404 — S — 158 (1.36 0.94 2.76)
404 — S — 161 (1.79 1.03 2.67) 404 — S — 166 (2.01 1.56 2.15) 404 — S — 167 (1.87 1.24 2.46) 404 — S — 170 (2.08 0.97 2.74)
404 — S — 171 (1.78 1.56 2.15) 404 — S — 175 (1.01 1.19 2.51) 404 — S — 176 (0.95 0.95 2.76) 404 — S — 177 (1.83 2.28 1.43)
404 — S — 182 (0.97 1.12 2.58) 404 — S — 183 (1.48 2.62 1.09) 404 — S — 184 (2.57 2.09 1.61) 404 — S — 187 (1.71 1.47 2.24)
404 — S — 188 (2.15 1.51 2.20) 404 — S — 189 (1.89 1.09 2.61) 404 — S — 192 (2.18 2.62 1.09) 404 — S — 193 (1.09 1.78 1.93)
404 — S — 194 (1.95 1.22 2.49) 404 — S — 195 (2.00 1.94 1.77) 404 — S — 197 (2.14 1.00 2.70) 404 — S — 198 (1.71 2.00 1.71)
404 — S — 205 (1.23 2.06 1.65) 404 — S — 208 (1.19 1.53 2.18) 404 — S — 209 (0.94 1.61 2.10) 404 — S — 210 (0.84 1.01 2.70)
404 — S — 213 (1.68 1.96 1.75) 404 — S — 214 (1.24 1.19 2.52) 404 — S — 217 (1.10 1.99 1.72) 404 — S — 218 (1.07 2.17 1.54)
404 — S — 219 (0.87 1.72 1.99) 404 — S — 222 (0.98 1.57 2.14) 404 — S — 230 (0.91 1.40 2.31) 404 — S — 231 (2.22 2.73 0.98)
404 — S — 233 (1.60 2.15 1.56) 404 — S — 234 (1.42 2.23 1.47) 404 — S — 236 (1.65 1.12 2.59) 404 — S — 237 (1.43 2.53 1.18)
404 — S — 240 (1.04 1.02 2.69) 404 — S — 243 (2.17 1.36 2.35) 404 — S — 244 (1.49 2.15 1.56) 404 — S — 245 (1.41 1.92 1.79)
404 — S — 246 (1.74 2.49 1.22) 404 — S — 251 (1.25 2.73 0.98) 404 — S — 254 (1.24 1.84 1.87) 404 — S — 255 (2.13 2.70 1.01)
404 — S — 261 (0.87 0.93 2.78) 404 — S — 265 (1.70 2.63 1.08) 404 — S — 266 (1.34 2.20 1.51) 404 — S — 267 (1.14 1.90 1.81)
404 — S — 268 (1.68 2.78 0.93) 404 — S — 269 (1.65 2.70 1.00) 404 — S — 271 (2.40 2.80 0.91) 404 — S — 272 (1.52 1.25 2.46)
404 — S — 274 (1.01 1.70 2.00) 404 — S — 275 (0.82 2.12 1.58) 404 — S — 276 (0.93 1.11 2.60) 404 — S — 277 (1.23 1.97 1.74)
404 — S — 279 (1.28 2.03 1.67) 404 — S — 280 (0.96 1.71 2.00) 404 — S — 282 (1.08 1.54 2.17) 404 — S — 284 (0.86 1.55 2.16)
404 — S — 285 (1.01 1.92 1.79) 404 — S — 286 (1.26 1.82 1.89) 404 — S — 287 (1.07 1.83 1.88) 404 — S — 288 (1.05 1.77 1.94)
404 — S — 289 (1.31 1.61 2.10) 404 — S — 290 (1.34 2.23 1.47) 404 — S — 291 (2.48 2.64 1.07) 404 — S — 292 (1.81 2.30 1.41)
404 — S — 293 (1.32 2.11 1.60) 404 — S — 294 (1.77 2.14 1.57) 404 — S — 295 (1.53 2.39 1.32) 404 — S — 296 (1.80 2.38 1.33)
404 — S — 297 (1.12 1.51 2.20) 404 — S — 298 (1.37 1.99 1.72) 404 — S — 300 (1.38 1.39 2.32) 404 — S — 301 (1.43 1.10 2.61)
404 — S — 302 (1.55 0.94 2.76) 404 — S — 303 (1.14 1.36 2.35) 404 — S — 304 (1.18 1.83 1.88) 404 — S — 305 (1.69 2.05 1.66)
404 — S — 306 (1.85 2.70 1.01) 404 — S — 308 (1.17 0.99 2.71) 404 — S — 310 (1.29 1.44 2.27) 404 — S — 311 (1.01 1.72 1.99)
404 — S — 312 (1.11 1.59 2.12) 404 — S — 313 (0.89 1.76 1.95) 404 — S — 316 (1.18 2.05 1.66) 404 — S — 318 (1.47 1.09 2.62)
404 — S — 327 (1.47 2.45 1.26) 404 — S — 331 (1.33 1.63 2.08) 404 — S — 332 (1.18 1.80 1.91) 404 — S — 336 (1.28 1.69 2.02)
404 — S — 342 (3.22 2.66 1.05) 404 — S — 352 (0.89 0.93 2.78) 404 — S — 353 (0.82 0.97 2.74) 404 — S — 356 (0.94 1.51 2.20)
404 — S — 357 (1.64 1.26 2.45) 404 — S — 358 (1.12 1.97 1.74) 404 — S — 367 (1.75 2.60 1.10) 404 — S — 370 (1.09 2.03 1.67)
404 — S — 371 (2.91 2.75 0.96) 404 — S — 372 (1.32 1.73 1.97) 404 — S — 374 (0.93 2.23 1.48) 404 — S — 379 (1.00 1.73 1.98)
404 — S — 380 (0.85 1.15 2.56) 404 — S — 382 (1.07 1.91 1.80) 404 — S — 391 (1.01 1.72 1.99) 404 — S — 394 (0.91 1.01 2.69)
404 — S — 395 (1.94 2.45 1.26) 404 — S — 396 (1.37 1.89 1.82) 404 — S — 397 (1.17 1.73 1.98) 404 — S — 398 (1.08 0.86 2.85)
404 — S — 403 (0.96 0.98 2.73) 404 — S — 415 (1.06 1.61 2.09) 404 — S — 430 (0.95 2.55 1.16) 404 — S — 432 (1.19 1.22 2.48)
404 — S — 433 (0.90 1.23 2.47) 404 — S — 434 (1.02 2.02 1.69) 404 — S — 435 (1.10 2.19 1.52) 404 — S — 437 (1.28 1.57 2.14)
404 — S — 440 (1.63 2.36 1.35) 404 — S — 441 (1.56 2.28 1.42) 404 — S — 444 (1.09 0.88 2.83) 404 — S — 447 (1.57 2.47 1.24)
404 — S — 449 (1.31 2.44 1.27) 404 — S — 450 (0.93 2.11 1.60) 404 — S — 452 (1.71 2.71 1.00) 404 — S — 453 (1.20 1.41 2.30)
404 — S — 454 (1.02 1.58 2.13) 404 — S — 455 (1.01 1.85 1.86) 404 — S — 457 (1.15 2.35 1.36) 404 — S — 459 (0.94 2.58 1.12)
404 — S — 460 (1.43 2.78 0.93) 404 — S — 461 (1.15 2.54 1.16) 404 — S — 462 (0.84 2.56 1.15) 404 — S — 467 (0.84 1.95 1.76)
404 — S — 468 (1.03 2.26 1.45) 404 — S — 469 (1.12 2.69 1.02) 404 — S — 471 (1.73 2.02 1.69) 404 — S — 473 (1.78 2.63 1.08)
404 — S — 474 (1.63 2.52 1.19) 405 — S — 9 (0.89 0.83 2.55) 405 — S — 20 (0.99 1.38 2.00) 405 — S — 27 (0.91 1.54 1.84)
405 — S — 28 (0.97 1.81 1.57) 405 — S — 36 (1.13 2.32 1.05) 405 — S — 43 (1.55 2.18 1.20) 405 — S — 46 (2.14 1.70 1.68)
405 — S — 56 (0.90 1.01 2.37) 405 — S — 61 (0.88 1.52 1.86) 405 — S — 65 (0.89 1.31 2.06) 405 — S — 70 (1.61 2.39 0.99)
405 — S — 79 (0.88 1.69 1.69) 405 — S — 80 (0.83 1.65 1.73) 405 — S — 81 (0.90 1.77 1.61) 405 — S — 83 (0.94 0.95 2.43)
405 — S — 85 (1.39 1.50 1.88) 405 — S — 89 (1.36 2.13 1.25) 405 — S — 90 (1.27 1.98 1.40) 405 — S — 101 (1.03 1.83 1.55)
405 — S — 105 (1.19 0.93 2.45) 405 — S — 107 (1.65 1.66 1.72) 405 — S — 108 (1.21 2.05 1.32) 405 — S — 109 (1.45 2.19 1.19)
405 — S — 110 (0.94 1.83 1.55) 405 — S — 111 (1.64 0.95 2.43) 405 — S — 112 (0.84 1.33 2.05) 405 — S — 113 (1.05 2.24 1.14)
405 — S — 115 (1.32 1.80 1.58) 405 — S — 118 (0.93 1.22 2.15) 405 — S — 119 (0.90 1.44 1.94) 405 — S — 131 (0.95 0.90 2.48)
405 — S — 132 (0.86 1.15 2.23) 405 — S — 133 (1.65 1.95 1.42) 405 — S — 144 (0.99 1.86 1.51) 405 — S — 150 (2.47 1.83 1.55)

405 — S — 151 (2.38 2.09 1.29) 405 — S — 152 (3.03 2.38 0.99) 405 — S — 153 (2.41 1.93 1.45) 405 — S — 154 (1.94 1.06 2.32)
405 — S — 166 (1.66 0.88 2.50) 405 — S — 171 (1.43 0.88 2.50) 405 — S — 177 (1.49 1.61 1.77) 405 — S — 183 (1.13 1.94 1.44)
405 — S — 184 (2.22 1.42 1.96) 405 — S — 188 (1.80 0.83 2.55) 405 — S — 192 (1.83 1.94 1.44) 405 — S — 195 (1.65 1.26 2.11)
405 — S — 198 (1.36 1.32 2.05) 405 — S — 205 (0.88 1.38 1.99) 405 — S — 206 (0.88 2.30 1.08) 405 — S — 207 (1.40 2.24 1.13)
405 — S — 208 (0.85 0.86 2.52) 405 — S — 213 (1.33 1.28 2.10) 405 — S — 231 (1.87 2.05 1.33) 405 — S — 233 (1.26 1.48 1.90)
405 — S — 234 (1.08 1.56 1.82) 405 — S — 237 (1.09 1.85 1.52) 405 — S — 244 (1.14 1.47 1.91) 405 — S — 245 (1.06 1.24 2.14)
405 — S — 246 (1.40 1.81 1.57) 405 — S — 248 (1.46 2.36 1.02) 405 — S — 249 (0.94 2.20 1.18) 405 — S — 251 (0.90 2.06 1.32)
405 — S — 254 (0.90 1.17 2.21) 405 — S — 255 (1.79 2.03 1.35) 405 — S — 258 (0.85 2.47 0.91) 405 — S — 260 (0.91 2.48 0.90)
405 — S — 265 (1.36 1.95 1.43) 405 — S — 266 (1.00 1.53 1.85) 405 — S — 268 (1.34 2.10 1.28) 405 — S — 269 (1.30 2.03 1.35)
405 — S — 271 (2.05 2.12 1.26) 405 — S — 277 (0.88 1.30 2.08) 405 — S — 279 (0.94 1.36 2.02) 405 — S — 286 (0.91 1.14 2.23)
405 — S — 289 (0.97 0.93 2.45) 405 — S — 290 (1.00 1.56 1.82) 405 — S — 291 (2.13 1.96 1.41) 405 — S — 292 (1.47 1.62 1.75)
405 — S — 293 (0.97 1.43 1.94) 405 — S — 294 (1.42 1.47 1.91) 405 — S — 295 (1.18 1.71 1.67) 405 — S — 296 (1.46 1.71 1.67)
405 — S — 298 (1.03 1.31 2.07) 405 — S — 304 (0.83 1.16 2.22) 405 — S — 305 (1.35 1.37 2.01) 405 — S — 306 (1.51 2.03 1.35)
405 — S — 307 (1.24 2.16 1.22) 405 — S — 316 (0.83 1.37 2.01) 405 — S — 320 (1.73 2.45 0.93) 405 — S — 327 (1.12 1.77 1.60)
405 — S — 329 (1.45 2.23 1.15) 405 — S — 331 (0.98 0.95 2.43) 405 — S — 332 (0.83 1.13 2.25) 405 — S — 336 (0.93 1.02 2.36)
405 — S — 342 (2.88 1.98 1.39) 405 — S — 343 (3.41 2.48 0.90) 405 — S — 367 (1.40 1.93 1.45) 405 — S — 368 (1.51 2.47 0.91)
405 — S — 371 (2.56 2.07 1.31) 405 — S — 372 (0.97 1.06 2.32) 405 — S — 395 (1.59 1.77 1.61) 405 — S — 396 (1.02 1.21 2.17)
405 — S — 397 (0.82 1.06 2.32) 405 — S — 437 (0.94 0.89 2.49) 405 — S — 440 (1.28 1.68 1.70) 405 — S — 441 (1.21 1.61 1.77)
405 — S — 447 (1.22 1.80 1.58) 405 — S — 449 (0.96 1.76 1.61) 405 — S — 451 (1.30 2.38 1.00) 405 — S — 452 (1.36 2.03 1.35)
405 — S — 457 (0.81 1.68 1.70) 405 — S — 460 (1.09 2.11 1.27) 405 — S — 463 (1.24 2.48 0.90) 405 — S — 471 (1.39 1.34 2.04)
405 — S — 473 (1.43 1.95 1.42) 405 — S — 474 (1.29 1.84 1.54) 406 — S — 9 (1.17 1.41 2.26) 406 — S — 20 (1.28 1.96 1.72)
406 — S — 27 (1.19 2.13 1.55) 406 — S — 28 (1.25 2.39 1.28) 406 — S — 29 (1.01 2.12 1.56) 406 — S — 40 (0.84 2.12 1.56)
406 — S — 43 (1.83 2.76 0.92) 406 — S — 44 (0.91 1.28 2.40) 406 — S — 46 (2.42 2.28 1.40) 406 — S — 56 (1.18 1.59 2.09)
406 — S — 61 (1.16 2.10 1.58) 406 — S — 62 (1.04 2.30 1.38) 406 — S — 65 (1.17 1.90 1.78) 406 — S — 68 (0.89 1.86 1.82)
406 — S — 79 (1.16 2.27 1.41) 406 — S — 80 (1.11 2.23 1.45) 406 — S — 81 (1.19 2.35 1.32) 406 — S — 82 (0.92 2.54 1.14)
406 — S — 83 (1.22 1.53 2.15) 406 — S — 85 (1.67 2.08 1.59) 406 — S — 86 (0.89 2.45 1.22) 406 — S — 89 (1.65 2.71 0.97)
406 — S — 90 (1.56 2.56 1.12) 406 — S — 101 (1.31 2.41 1.27) 406 — S — 102 (0.93 1.42 2.26) 406 — S — 105 (1.47 1.51 2.17)
406 — S — 106 (0.88 0.95 2.73) 406 — S — 107 (1.93 2.25 1.43) 406 — S — 108 (1.49 2.64 1.04) 406 — S — 109 (1.73 2.77 0.91)
406 — S — 110 (1.23 2.41 1.27) 406 — S — 111 (1.93 1.53 2.15) 406 — S — 112 (1.12 1.91 1.77) 406 — S — 115 (1.60 2.39 1.29)
406 — S — 118 (1.21 1.81 1.87) 406 — S — 119 (1.18 2.02 1.66) 406 — S — 123 (0.82 2.15 1.53) 406 — S — 127 (0.84 0.83 2.85)
406 — S — 131 (1.24 1.48 2.19) 406 — S — 132 (1.15 1.73 1.95) 406 — S — 133 (1.94 2.54 1.14) 406 — S — 144 (1.27 2.45 1.23)
406 — S — 148 (0.93 1.32 2.36) 406 — S — 150 (2.76 2.41 1.27) 406 — S — 151 (2.66 2.67 1.01) 406 — S — 153 (2.69 2.51 1.17)
406 — S — 154 (2.22 1.64 2.04) 406 — S — 158 (1.29 0.85 2.83) 406 — S — 161 (1.73 0.94 2.74) 406 — S — 166 (1.94 1.47 2.21)
406 — S — 167 (1.80 1.15 2.53) 406 — S — 170 (2.01 0.88 2.80) 406 — S — 171 (1.71 1.46 2.22) 406 — S — 175 (0.94 1.10 2.58)
406 — S — 176 (0.89 0.86 2.82) 406 — S — 177 (1.77 2.19 1.49) 406 — S — 182 (0.91 1.03 2.65) 406 — S — 183 (1.42 2.53 1.15)
406 — S — 184 (2.51 2.00 1.68) 406 — S — 187 (1.65 1.37 2.30) 406 — S — 188 (2.08 1.41 2.26) 406 — S — 189 (1.83 1.00 2.68)
406 — S — 192 (2.11 2.52 1.16) 406 — S — 193 (1.03 1.68 1.99) 406 — S — 194 (1.88 1.13 2.55) 406 — S — 195 (1.94 1.85 1.83)
406 — S — 197 (2.08 0.91 2.77) 406 — S — 198 (1.65 1.91 1.77) 406 — S — 205 (1.17 1.97 1.71) 406 — S — 208 (1.13 1.44 2.24)
406 — S — 209 (0.88 1.52 2.16) 406 — S — 213 (1.61 1.86 1.82) 406 — S — 214 (1.17 1.10 2.58) 406 — S — 217 (1.04 1.90 1.78)
406 — S — 218 (1.01 2.07 1.61) 406 — S — 219 (0.81 1.63 2.05) 406 — S — 222 (0.92 1.48 2.20) 406 — S — 230 (0.85 1.30 2.37)
406 — S — 231 (2.16 2.64 1.04) 406 — S — 233 (1.54 2.06 1.62) 406 — S — 234 (1.36 2.14 1.54) 406 — S — 236 (1.58 1.03 2.65)
406 — S — 237 (1.37 2.44 1.24) 406 — S — 240 (0.97 0.92 2.75) 406 — S — 243 (2.11 1.27 2.41) 406 — S — 244 (1.43 2.05 1.63)
406 — S — 245 (1.34 1.83 1.85) 406 — S — 246 (1.68 2.39 1.29) 406 — S — 251 (1.19 2.64 1.04) 406 — S — 254 (1.18 1.75 1.93)
406 — S — 255 (2.07 2.61 1.07) 406 — S — 261 (0.81 0.83 2.85) 406 — S — 265 (1.64 2.53 1.15) 406 — S — 266 (1.28 2.11 1.57)
406 — S — 267 (1.08 1.81 1.87) 406 — S — 268 (1.62 2.68 1.00) 406 — S — 269 (1.59 2.61 1.07) 406 — S — 271 (2.33 2.70 0.98)
406 — S — 272 (1.46 1.16 2.52) 406 — S — 274 (0.95 1.61 2.07) 406 — S — 276 (0.87 1.02 2.66) 406 — S — 277 (1.17 1.88 1.80)
406 — S — 279 (1.22 1.94 1.74) 406 — S — 280 (0.90 1.62 2.06) 406 — S — 282 (1.02 1.45 2.23) 406 — S — 285 (0.94 1.82 1.86)
406 — S — 286 (1.20 1.73 1.95) 406 — S — 287 (1.00 1.74 1.94) 406 — S — 288 (0.99 1.68 2.00) 406 — S — 289 (1.25 1.52 2.16)
406 — S — 290 (1.28 2.14 1.54) 406 — S — 291 (2.42 2.55 1.13) 406 — S — 292 (1.75 2.21 1.47) 406 — S — 293 (1.25 2.02 1.66)
406 — S — 294 (1.71 2.05 1.63) 406 — S — 295 (1.46 2.29 1.39) 406 — S — 296 (1.74 2.29 1.39) 406 — S — 297 (1.05 1.42 2.26)
406 — S — 298 (1.31 1.89 1.79) 406 — S — 300 (1.31 1.29 2.39) 406 — S — 301 (1.37 1.00 2.68) 406 — S — 302 (1.49 0.85 2.83)
406 — S — 303 (1.07 1.27 2.41) 406 — S — 304 (1.11 1.74 1.94) 406 — S — 305 (1.63 1.96 1.72) 406 — S — 306 (1.79 2.61 1.07)
406 — S — 307 (1.52 2.74 0.94) 406 — S — 308 (1.11 0.90 2.78) 406 — S — 310 (1.23 1.35 2.33) 406 — S — 311 (0.95 1.63 2.05)
406 — S — 312 (1.05 1.50 2.18) 406 — S — 313 (0.83 1.67 2.01) 406 — S — 316 (1.11 1.95 1.72) 406 — S — 318 (1.41 1.00 2.68)
406 — S — 327 (1.40 2.36 1.32) 406 — S — 331 (1.26 1.53 2.14) 406 — S — 332 (1.12 1.71 1.97) 406 — S — 336 (1.22 1.60 2.08)
406 — S — 342 (3.16 2.57 1.11) 406 — S — 352 (0.82 0.84 2.84) 406 — S — 356 (0.88 1.42 2.26) 406 — S — 357 (1.58 1.16 2.52)
406 — S — 358 (1.06 1.87 1.80) 406 — S — 367 (1.69 2.51 1.17) 406 — S — 370 (1.03 1.94 1.74) 406 — S — 371 (2.85 2.66 1.02)
406 — S — 372 (1.26 1.64 2.04) 406 — S — 374 (0.87 2.13 1.55) 406 — S — 379 (0.94 1.64 2.04) 406 — S — 382 (1.01 1.82 1.86)

406 — S — 391 (0.95 1.62 2.05) 406 — S — 394 (0.85 0.92 2.76) 406 — S — 395 (1.88 2.36 1.32) 406 — S — 396 (1.30 1.79 1.89) 406 — S — 397 (1.11 1.64 2.04) 406 — S — 403 (0.90 0.89 2.79) 406 — S — 415 (1.00 1.52 2.16) 406 — S — 430 (0.89 2.46 1.22) 406 — S — 432 (1.13 1.13 2.55) 406 — S — 433 (0.84 1.14 2.54) 406 — S — 434 (0.95 1.93 1.75) 406 — S — 435 (1.04 2.10 1.58) 406 — S — 437 (1.22 1.47 2.21) 406 — S — 440 (1.56 2.26 1.41) 406 — S — 441 (1.49 2.19 1.49) 406 — S — 447 (1.50 2.38 1.30) 406 — S — 449 (1.25 2.35 1.33) 406 — S — 450 (0.87 2.01 1.66) 406 — S — 452 (1.64 2.61 1.06) 406 — S — 453 (1.14 1.32 2.36) 406 — S — 454 (0.96 1.48 2.20) 406 — S — 455 (0.94 1.75 1.93) 406 — S — 457 (1.09 2.26 1.42) 406 — S — 459 (0.88 2.49 1.19) 406 — S — 460 (1.37 2.69 0.99) 406 — S — 461 (1.08 2.45 1.23) 406 — S — 468 (0.97 2.17 1.51) 406 — S — 469 (1.06 2.59 1.09) 406 — S — 471 (1.67 1.92 1.76) 406 — S — 473 (1.72 2.54 1.14) 406 — S — 474 (1.57 2.43 1.25) 407 — S — 9 (1.31 1.45 2.13) 407 — S — 19 (0.88 1.35 2.24) 407 — S — 20 (1.41 2.00 1.59) 407 — S — 27 (1.32 2.16 1.42) 407 — S — 28 (1.39 2.43 1.15) 407 — S — 29 (1.15 2.16 1.43) 407 — S — 40 (0.97 2.15 1.43) 407 — S — 44 (1.04 1.31 2.27) 407 — S — 46 (2.56 2.32 1.26) 407 — S — 56 (1.31 1.62 1.96) 407 — S — 61 (1.30 2.14 1.45) 407 — S — 62 (1.17 2.34 1.25) 407 — S — 65 (1.31 1.93 1.65) 407 — S — 68 (1.02 1.90 1.69) 407 — S — 79 (1.29 2.31 1.27) 407 — S — 80 (1.24 2.27 1.32) 407 — S — 81 (1.32 2.39 1.19) 407 — S — 82 (1.05 2.58 1.01) 407 — S — 83 (1.35 1.57 2.02) 407 — S — 85 (1.81 2.12 1.46) 407 — S — 86 (1.02 2.49 1.09) 407 — S — 90 (1.69 2.60 0.99) 407 — S — 101 (1.44 2.45 1.13) 407 — S — 102 (1.07 1.46 2.13) 407 — S — 105 (1.60 1.55 2.04) 407 — S — 106 (1.02 0.98 2.60) 407 — S — 107 (2.07 2.28 1.30) 407 — S — 108 (1.63 2.67 0.91) 407 — S — 110 (1.36 2.45 1.14) 407 — S — 111 (2.06 1.57 2.02) 407 — S — 112 (1.25 1.95 1.64) 407 — S — 114 (0.90 1.22 2.36) 407 — S — 115 (1.73 2.42 1.16) 407 — S — 118 (1.34 1.84 1.74) 407 — S — 119 (1.31 2.06 1.52) 407 — S — 123 (0.95 2.19 1.40) 407 — S — 127 (0.97 0.87 2.72) 407 — S — 131 (1.37 1.52 2.06) 407 — S — 132 (1.28 1.77 1.82) 407 — S — 133 (2.07 2.57 1.01) 407 — S — 144 (1.40 2.48 1.10) 407 — S — 147 (0.81 2.06 1.52) 407 — S — 148 (1.06 1.35 2.23) 407 — S — 150 (2.89 2.45 1.14) 407 — S — 153 (2.82 2.55 1.04) 407 — S — 154 (2.35 1.68 1.91) 407 — S — 158 (1.43 0.89 2.70) 407 — S — 161 (1.86 0.98 2.61) 407 — S — 166 (2.07 1.50 2.08) 407 — S — 167 (1.94 1.19 2.40) 407 — S — 170 (2.14 0.91 2.67) 407 — S — 171 (1.84 1.50 2.08) 407 — S — 175 (1.08 1.14 2.44) 407 — S — 176 (1.02 0.89 2.69) 407 — S — 177 (1.90 2.23 1.36) 407 — S — 182 (1.04 1.07 2.52) 407 — S — 183 (1.55 2.56 1.02) 407 — S — 184 (2.64 2.04 1.54) 407 — S — 187 (1.78 1.41 2.17) 407 — S — 188 (2.21 1.45 2.13) 407 — S — 189 (1.96 1.04 2.54) 407 — S — 192 (2.24 2.56 1.02) 407 — S — 193 (1.16 1.72 1.86) 407 — S — 194 (2.01 1.16 2.42) 407 — S — 195 (2.07 1.88 1.70) 407 — S — 197 (2.21 0.95 2.64) 407 — S — 198 (1.78 1.94 1.64) 407 — S — 205 (1.30 2.00 1.58) 407 — S — 208 (1.26 1.48 2.11) 407 — S — 209 (1.01 1.55 2.03) 407 — S — 210 (0.91 0.96 2.63) 407 — S — 213 (1.75 1.90 1.68) 407 — S — 214 (1.31 1.13 2.45) 407 — S — 217 (1.17 1.93 1.65) 407 — S — 218 (1.14 2.11 1.47) 407 — S — 219 (0.94 1.67 1.92) 407 — S — 222 (1.05 1.51 2.07) 407 — S — 230 (0.98 1.34 2.24) 407 — S — 231 (2.29 2.67 0.91) 407 — S — 233 (1.67 2.10 1.49) 407 — S — 234 (1.49 2.18 1.41) 407 — S — 236 (1.71 1.06 2.52) 407 — S — 237 (1.50 2.47 1.11) 407 — S — 238 (0.80 2.33 1.25) 407 — S — 240 (1.10 0.96 2.62) 407 — S — 243 (2.24 1.30 2.28) 407 — S — 244 (1.56 2.09 1.49) 407 — S — 245 (1.48 1.86 1.72) 407 — S — 246 (1.81 2.43 1.15) 407 — S — 251 (1.32 2.68 0.91) 407 — S — 254 (1.31 1.79 1.80) 407 — S — 255 (2.20 2.65 0.94) 407 — S — 261 (0.94 0.87 2.71) 407 — S — 265 (1.77 2.57 1.01) 407 — S — 266 (1.41 2.15 1.44) 407 — S — 267 (1.21 1.85 1.74) 407 — S — 269 (1.72 2.65 0.94) 407 — S — 272 (1.59 1.19 2.39) 407 — S — 274 (1.08 1.65 1.94) 407 — S — 275 (0.89 2.07 1.51) 407 — S — 276 (1.00 1.06 2.53) 407 — S — 277 (1.30 1.92 1.67) 407 — S — 279 (1.35 1.98 1.61) 407 — S — 280 (1.03 1.66 1.93) 407 — S — 282 (1.15 1.48 2.10) 407 — S — 284 (0.93 1.49 2.09) 407 — S — 285 (1.07 1.86 1.72) 407 — S — 286 (1.33 1.76 1.82) 407 — S — 287 (1.14 1.77 1.81) 407 — S — 288 (1.12 1.71 1.87) 407 — S — 289 (1.38 1.55 2.03) 407 — S — 290 (1.41 2.18 1.40) 407 — S — 291 (2.55 2.58 1.00) 407 — S — 292 (1.88 2.24 1.34) 407 — S — 293 (1.39 2.05 1.53) 407 — S — 294 (1.84 2.09 1.50) 407 — S — 295 (1.59 2.33 1.25) 407 — S — 296 (1.87 2.33 1.26) 407 — S — 297 (1.18 1.46 2.13) 407 — S — 298 (1.44 1.93 1.65) 407 — S — 300 (1.45 1.33 2.25) 407 — S — 301 (1.50 1.04 2.54) 407 — S — 302 (1.62 0.89 2.69) 407 — S — 303 (1.21 1.30 2.28) 407 — S — 304 (1.25 1.78 1.81) 407 — S — 305 (1.76 1.99 1.59) 407 — S — 306 (1.92 2.65 0.94) 407 — S — 308 (1.24 0.94 2.65) 407 — S — 310 (1.36 1.39 2.20) 407 — S — 311 (1.08 1.66 1.92) 407 — S — 312 (1.18 1.54 2.05) 407 — S — 313 (0.96 1.70 1.88) 407 — S — 316 (1.25 1.99 1.59) 407 — S — 318 (1.54 1.03 2.55) 407 — S — 327 (1.54 2.39 1.19) 407 — S — 330 (0.86 1.40 2.18) 407 — S — 331 (1.40 1.57 2.01) 407 — S — 332 (1.25 1.75 1.84) 407 — S — 336 (1.35 1.64 1.95) 407 — S — 341 (0.85 2.26 1.32) 407 — S — 342 (3.29 2.60 0.98) 407 — S — 352 (0.96 0.87 2.71) 407 — S — 353 (0.89 0.91 2.67) 407 — S — 356 (1.01 1.45 2.13) 407 — S — 357 (1.71 1.20 2.38) 407 — S — 358 (1.19 1.91 1.67) 407 — S — 367 (1.82 2.55 1.04) 407 — S — 370 (1.16 1.98 1.61) 407 — S — 372 (1.39 1.68 1.91) 407 — S — 374 (1.00 2.17 1.41) 407 — S — 379 (1.07 1.67 1.91) 407 — S — 380 (0.91 1.09 2.49) 407 — S — 382 (1.14 1.86 1.73) 407 — S — 391 (1.08 1.66 1.92) 407 — S — 394 (0.98 0.96 2.63) 407 — S — 395 (2.01 2.39 1.19) 407 — S — 396 (1.43 1.83 1.75) 407 — S — 397 (1.24 1.67 1.91) 407 — S — 398 (1.14 0.80 2.78) 407 — S — 403 (1.03 0.93 2.66) 407 — S — 415 (1.13 1.56 2.03) 407 — S — 430 (1.02 2.49 1.09) 407 — S — 432 (1.26 1.17 2.42) 407 — S — 433 (0.97 1.18 2.40) 407 — S — 434 (1.09 1.97 1.62) 407 — S — 435 (1.17 2.13 1.45) 407 — S — 437 (1.35 1.51 2.07) 407 — S — 440 (1.69 2.30 1.28) 407 — S — 441 (1.63 2.23 1.36) 407 — S — 444 (1.16 0.82 2.76) 407 — S — 447 (1.64 2.42 1.17) 407 — S — 449 (1.38 2.38 1.20) 407 — S — 450 (1.00 2.05 1.53) 407 — S — 452 (1.77 2.65 0.93) 407 — S — 453 (1.27 1.36 2.23) 407 — S — 454 (1.09 1.52 2.06) 407 — S — 455 (1.07 1.79 1.79) 407 — S — 457 (1.22 2.30 1.29) 407 — S — 459 (1.01 2.53 1.06) 407 — S — 461 (1.21 2.49 1.10) 407 — S — 462 (0.91 2.50 1.08) 407 — S — 467 (0.90 1.90 1.69) 407 — S — 468 (1.10 2.20 1.38) 407 — S — 469 (1.19 2.63 0.95) 407 — S — 471 (1.80 1.96 1.62) 407 — S — 473 (1.85 2.57 1.01) 407 — S — 474 (1.70 2.46 1.12) 408 — S — 9 (0.99 1.29 2.45) 408 — S — 20 (1.09 1.84 1.91) 408 — S — 27 (1.00 2.00 1.74) 408 — S — 28 (1.07 2.27 1.47) 408 — S — 29 (0.83 1.99 1.75) 408 — S — 36 (1.23 2.78 0.96) 408 — S — 43 (1.64 2.64 1.10) 408 — S — 46 (2.24 2.16 1.58) 408 — S — 56 (0.99 1.46 2.28) 408 — S — 61 (0.98 1.98 1.76) 408 — S — 62 (0.86 2.18 1.57) 408 — S — 65 (0.99 1.77 1.97) 408 — S — 79 (0.97 2.15 1.59) 408 — S — 80 (0.92 2.11 1.63)

408 — S — 81 (1.00 2.23 1.51) 408 — S — 83 (1.03 1.41 2.34) 408 — S — 85 (1.49 1.96 1.78) 408 — S — 89 (1.46 2.59 1.16)
408 — S — 90 (1.37 2.44 1.31) 408 — S — 101 (1.12 2.29 1.45) 408 — S — 105 (1.28 1.39 2.36) 408 — S — 107 (1.75 2.12 1.62)
408 — S — 108 (1.31 2.51 1.23) 408 — S — 109 (1.54 2.65 1.09) 408 — S — 110 (1.04 2.29 1.45) 408 — S — 111 (1.74 1.41 2.33)
408 — S — 112 (0.93 1.79 1.96) 408 — S — 113 (1.14 2.70 1.04) 408 — S — 115 (1.41 2.26 1.48) 408 — S — 118 (1.02 1.68 2.06)
408 — S — 119 (1.00 1.90 1.84) 408 — S — 131 (1.05 1.36 2.38) 408 — S — 132 (0.96 1.61 2.14) 408 — S — 133 (1.75 2.41 1.33)
408 — S — 144 (1.08 2.32 1.42) 408 — S — 150 (2.57 2.29 1.46) 408 — S — 151 (2.48 2.54 1.20) 408 — S — 153 (2.50 2.39 1.36)
408 — S — 154 (2.03 1.52 2.23) 408 — S — 161 (1.54 0.82 2.93) 408 — S — 166 (1.76 1.34 2.40) 408 — S — 167 (1.62 1.03 2.71)
408 — S — 171 (1.53 1.34 2.40) 408 — S — 177 (1.58 2.07 1.68) 408 — S — 183 (1.23 2.40 1.34) 408 — S — 184 (2.32 1.88 1.86)
408 — S — 187 (1.46 1.25 2.49) 408 — S — 188 (1.90 1.29 2.45) 408 — S — 189 (1.64 0.88 2.86) 408 — S — 192 (1.93 2.40 1.34)
408 — S — 193 (0.84 1.56 2.18) 408 — S — 194 (1.70 1.00 2.74) 408 — S — 195 (1.75 1.72 2.02) 408 — S — 198 (1.46 1.78 1.96)
408 — S — 205 (0.98 1.84 1.90) 408 — S — 206 (0.97 2.76 0.99) 408 — S — 207 (1.49 2.70 1.04) 408 — S — 208 (0.94 1.32 2.43)
408 — S — 213 (1.43 1.74 2.00) 408 — S — 214 (0.99 0.97 2.77) 408 — S — 217 (0.85 1.77 1.97) 408 — S — 218 (0.82 1.95 1.79)
408 — S — 231 (1.97 2.51 1.23) 408 — S — 233 (1.35 1.94 1.81) 408 — S — 234 (1.17 2.02 1.72) 408 — S — 236 (1.40 0.90 2.84)
408 — S — 237 (1.18 2.31 1.43) 408 — S — 243 (1.92 1.14 2.60) 408 — S — 244 (1.24 1.93 1.81) 408 — S — 245 (1.16 1.70 2.04)
408 — S — 246 (1.49 2.27 1.47) 408 — S — 248 (1.56 2.82 0.93) 408 — S — 249 (1.03 2.66 1.08) 408 — S — 251 (1.00 2.52 1.23)
408 — S — 254 (0.99 1.63 2.12) 408 — S — 255 (1.88 2.49 1.26) 408 — S — 265 (1.45 2.41 1.33) 408 — S — 266 (1.09 1.99 1.76)
408 — S — 267 (0.89 1.69 2.06) 408 — S — 268 (1.43 2.56 1.18) 408 — S — 269 (1.40 2.49 1.25) 408 — S — 271 (2.15 2.58 1.16)
408 — S — 272 (1.27 1.03 2.71) 408 — S — 277 (0.98 1.76 1.99) 408 — S — 279 (1.03 1.82 1.92) 408 — S — 282 (0.83 1.32 2.42)
408 — S — 286 (1.01 1.60 2.14) 408 — S — 287 (0.82 1.61 2.13) 408 — S — 288 (0.80 1.55 2.19) 408 — S — 289 (1.06 1.39 2.35)
408 — S — 290 (1.09 2.02 1.72) 408 — S — 291 (2.23 2.42 1.32) 408 — S — 292 (1.56 2.08 1.66) 408 — S — 293 (1.07 1.89 1.85)
408 — S — 294 (1.52 1.93 1.82) 408 — S — 295 (1.27 2.17 1.57) 408 — S — 296 (1.55 2.16 1.58) 408 — S — 297 (0.86 1.30 2.45)
408 — S — 298 (1.12 1.77 1.97) 408 — S — 300 (1.13 1.17 2.57) 408 — S — 301 (1.18 0.88 2.86) 408 — S — 303 (0.89 1.14 2.60)
408 — S — 304 (0.93 1.62 2.13) 408 — S — 305 (1.44 1.83 1.91) 408 — S — 306 (1.60 2.49 1.26) 408 — S — 307 (1.33 2.62 1.13)
408 — S — 310 (1.04 1.23 2.52) 408 — S — 312 (0.86 1.38 2.37) 408 — S — 316 (0.93 1.83 1.91) 408 — S — 318 (1.22 0.87 2.87)
408 — S — 327 (1.22 2.23 1.51) 408 — S — 329 (1.54 2.69 1.05) 408 — S — 331 (1.08 1.41 2.33) 408 — S — 332 (0.93 1.59 2.16)
408 — S — 336 (1.03 1.48 2.27) 408 — S — 342 (2.97 2.44 1.30) 408 — S — 357 (1.39 1.04 2.70) 408 — S — 358 (0.87 1.75 1.99)
408 — S — 367 (1.50 2.39 1.35) 408 — S — 370 (0.84 1.82 1.93) 408 — S — 371 (2.66 2.53 1.21) 408 — S — 372 (1.07 1.52 2.22)
408 — S — 382 (0.82 1.70 2.05) 408 — S — 395 (1.69 2.23 1.51) 408 — S — 396 (1.12 1.67 2.07) 408 — S — 397 (0.92 1.51 2.23)
408 — S — 415 (0.81 1.40 2.35) 408 — S — 420 (0.87 2.71 1.03) 408 — S — 432 (0.94 1.01 2.74) 408 — S — 435 (0.85 1.97 1.77)
408 — S — 437 (1.03 1.35 2.39) 408 — S — 440 (1.38 2.14 1.60) 408 — S — 441 (1.31 2.07 1.67) 408 — S — 447 (1.32 2.26 1.49)
408 — S — 449 (1.06 2.22 1.52) 408 — S — 451 (1.40 2.83 0.91) 408 — S — 452 (1.46 2.49 1.25) 408 — S — 453 (0.95 1.20 2.55)
408 — S — 457 (0.90 2.14 1.61) 408 — S — 460 (1.18 2.57 1.18) 408 — S — 461 (0.90 2.33 1.41) 408 — S — 469 (0.87 2.47 1.27)
408 — S — 471 (1.48 1.80 1.94) 408 — S — 473 (1.53 2.41 1.33) 408 — S — 474 (1.38 2.30 1.44) 409 — S — 9 (1.13 1.27 2.30)
409 — S — 20 (1.24 1.82 1.76) 409 — S — 27 (1.15 1.99 1.59) 409 — S — 28 (1.21 2.26 1.32) 409 — S — 29 (0.98 1.98 1.60)
409 — S — 43 (1.79 2.62 0.96) 409 — S — 44 (0.87 1.14 2.44) 409 — S — 46 (2.38 2.14 1.44) 409 — S — 56 (1.14 1.45 2.13)
409 — S — 61 (1.12 1.96 1.62) 409 — S — 62 (1.00 2.16 1.42) 409 — S — 65 (1.13 1.76 1.82) 409 — S — 68 (0.85 1.72 1.86)
409 — S — 79 (1.12 2.13 1.45) 409 — S — 80 (1.07 2.09 1.49) 409 — S — 81 (1.15 2.21 1.36) 409 — S — 82 (0.88 2.40 1.18)
409 — S — 83 (1.18 1.39 2.19) 409 — S — 85 (1.63 1.94 1.63) 409 — S — 86 (0.85 2.31 1.26) 409 — S — 89 (1.61 2.57 1.01)
409 — S — 90 (1.52 2.42 1.16) 409 — S — 101 (1.27 2.27 1.31) 409 — S — 102 (0.90 1.28 2.30) 409 — S — 105 (1.43 1.37 2.21)
409 — S — 106 (0.85 0.81 2.77) 409 — S — 107 (1.89 2.11 1.47) 409 — S — 108 (1.45 2.50 1.08) 409 — S — 109 (1.69 2.63 0.95)
409 — S — 110 (1.19 2.27 1.31) 409 — S — 111 (1.89 1.39 2.19) 409 — S — 112 (1.08 1.77 1.81) 409 — S — 115 (1.56 2.25 1.33)
409 — S — 118 (1.17 1.67 1.91) 409 — S — 119 (1.14 1.88 1.70) 409 — S — 131 (1.20 1.34 2.23) 409 — S — 132 (1.11 1.59 1.99)
409 — S — 133 (1.90 2.40 1.18) 409 — S — 144 (1.23 2.31 1.27) 409 — S — 148 (0.89 1.18 2.40) 409 — S — 150 (2.72 2.27 1.31)
409 — S — 151 (2.62 2.53 1.05) 409 — S — 153 (2.65 2.37 1.21) 409 — S — 154 (2.18 1.50 2.08) 409 — S — 161 (1.69 0.80 2.78)
409 — S — 166 (1.90 1.33 2.25) 409 — S — 167 (1.77 1.01 2.57) 409 — S — 171 (1.67 1.32 2.26) 409 — S — 175 (0.90 0.96 2.62)
409 — S — 177 (1.73 2.05 1.53) 409 — S — 182 (0.87 0.89 2.69) 409 — S — 183 (1.38 2.39 1.19) 409 — S — 184 (2.47 1.86 1.72)
409 — S — 187 (1.61 1.23 2.34) 409 — S — 188 (2.04 1.27 2.30) 409 — S — 189 (1.79 0.86 2.72) 409 — S — 192 (2.07 2.38 1.20)
409 — S — 193 (0.99 1.55 2.03) 409 — S — 194 (1.84 0.99 2.59) 409 — S — 195 (1.90 1.71 1.87) 409 — S — 198 (1.61 1.77 1.81)
409 — S — 205 (1.13 1.83 1.75) 409 — S — 208 (1.09 1.30 2.28) 409 — S — 209 (0.84 1.38 2.20) 409 — S — 213 (1.57 1.72 1.86)
409 — S — 214 (1.14 0.96 2.62) 409 — S — 217 (1.00 1.76 1.82) 409 — S — 218 (0.97 1.93 1.65) 409 — S — 222 (0.88 1.34 2.24)
409 — S — 230 (0.81 1.16 2.41) 409 — S — 231 (2.12 2.50 1.08) 409 — S — 233 (1.50 1.92 1.66) 409 — S — 234 (1.32 2.00 1.58)
409 — S — 236 (1.54 0.89 2.69) 409 — S — 237 (1.33 2.30 1.28) 409 — S — 243 (2.07 1.13 2.45) 409 — S — 244 (1.39 1.91 1.67)
409 — S — 245 (1.30 1.69 1.89) 409 — S — 246 (1.64 2.25 1.33) 409 — S — 249 (1.18 2.64 0.94) 409 — S — 251 (1.15 2.50 1.08)
409 — S — 254 (1.14 1.61 1.97) 409 — S — 255 (2.03 2.47 1.11) 409 — S — 265 (1.60 2.39 1.19) 409 — S — 266 (1.24 1.97 1.61)
409 — S — 267 (1.04 1.67 1.91) 409 — S — 268 (1.58 2.54 1.04) 409 — S — 269 (1.55 2.47 1.11) 409 — S — 271 (2.29 2.56 1.02)
409 — S — 272 (1.42 1.02 2.56) 409 — S — 274 (0.91 1.47 2.11) 409 — S — 276 (0.83 0.88 2.70) 409 — S — 277 (1.13 1.74 1.84)
409 — S — 279 (1.18 1.80 1.78) 409 — S — 280 (0.86 1.48 2.10) 409 — S — 282 (0.98 1.31 2.27) 409 — S — 285 (0.90 1.68 1.90)
409 — S — 286 (1.16 1.59 1.99) 409 — S — 287 (0.96 1.60 1.98) 409 — S — 288 (0.95 1.54 2.04) 409 — S — 289 (1.21 1.38 2.20)

409 — S — 290 (1.24 2.00 1.58) 409 — S — 291 (2.38 2.41 1.17) 409 — S — 292 (1.71 2.07 1.51) 409 — S — 293 (1.21 1.88 1.70) 409 — S — 294 (1.67 1.91 1.67) 409 — S — 295 (1.42 2.15 1.43) 409 — S — 296 (1.70 2.15 1.43) 409 — S — 297 (1.01 1.28 2.30) 409 — S — 298 (1.27 1.75 1.83) 409 — S — 300 (1.28 1.15 2.43) 409 — S — 301 (1.33 0.86 2.71) 409 — S — 303 (1.03 1.13 2.45) 409 — S — 304 (1.08 1.60 1.98) 409 — S — 305 (1.59 1.82 1.76) 409 — S — 306 (1.75 2.47 1.11) 409 — S — 307 (1.48 2.60 0.98) 409 — S — 310 (1.19 1.21 2.37) 409 — S — 311 (0.91 1.49 2.09) 409 — S — 312 (1.01 1.36 2.22) 409 — S — 316 (1.07 1.81 1.76) 409 — S — 318 (1.37 0.86 2.72) 409 — S — 327 (1.36 2.22 1.36) 409 — S — 329 (1.69 2.68 0.90) 409 — S — 331 (1.22 1.40 2.18) 409 — S — 332 (1.08 1.57 2.01) 409 — S — 336 (1.18 1.46 2.12) 409 — S — 342 (3.12 2.43 1.15) 409 — S — 356 (0.84 1.28 2.30) 409 — S — 357 (1.54 1.02 2.56) 409 — S — 358 (1.02 1.73 1.84) 409 — S — 367 (1.65 2.37 1.21) 409 — S — 370 (0.99 1.80 1.78) 409 — S — 371 (2.81 2.52 1.06) 409 — S — 372 (1.22 1.50 2.08) 409 — S — 374 (0.83 1.99 1.58) 409 — S — 379 (0.90 1.50 2.08) 409 — S — 382 (0.97 1.68 1.90) 409 — S — 391 (0.91 1.49 2.09) 409 — S — 395 (1.84 2.22 1.36) 409 — S — 396 (1.26 1.65 1.92) 409 — S — 397 (1.07 1.50 2.08) 409 — S — 415 (0.96 1.38 2.20) 409 — S — 430 (0.85 2.32 1.26) 409 — S — 432 (1.09 0.99 2.59) 409 — S — 433 (0.80 1.00 2.58) 409 — S — 434 (0.91 1.79 1.79) 409 — S — 435 (1.00 1.96 1.62) 409 — S — 437 (1.18 1.33 2.24) 409 — S — 440 (1.52 2.13 1.45) 409 — S — 441 (1.45 2.05 1.53) 409 — S — 443 (0.93 2.67 0.91) 409 — S — 447 (1.46 2.24 1.34) 409 — S — 449 (1.21 2.21 1.37) 409 — S — 450 (0.83 1.87 1.70) 409 — S — 452 (1.60 2.47 1.10) 409 — S — 453 (1.10 1.18 2.40) 409 — S — 454 (0.92 1.34 2.23) 409 — S — 455 (0.90 1.61 1.96) 409 — S — 457 (1.05 2.12 1.46) 409 — S — 459 (0.84 2.35 1.23) 409 — S — 460 (1.33 2.55 1.03) 409 — S — 461 (1.04 2.31 1.27) 409 — S — 468 (0.93 2.03 1.55) 409 — S — 469 (1.02 2.45 1.13) 409 — S — 471 (1.63 1.78 1.80) 409 — S — 473 (1.68 2.40 1.18) 409 — S — 474 (1.53 2.29 1.29) 410 — S — 9 (1.24 1.58 2.20) 410 — S — 19 (0.81 1.48 2.30) 410 — S — 20 (1.34 2.13 1.65) 410 — S — 27 (1.26 2.29 1.49) 410 — S — 28 (1.32 2.56 1.22) 410 — S — 29 (1.08 2.29 1.49) 410 — S — 40 (0.90 2.29 1.49) 410 — S — 44 (0.97 1.44 2.34) 410 — S — 46 (2.49 2.45 1.33) 410 — S — 56 (1.25 1.76 2.02) 410 — S — 61 (1.23 2.27 1.51) 410 — S — 62 (1.11 2.47 1.31) 410 — S — 65 (1.24 2.06 1.72) 410 — S — 68 (0.95 2.03 1.75) 410 — S — 79 (1.23 2.44 1.34) 410 — S — 80 (1.18 2.40 1.38) 410 — S — 81 (1.25 2.52 1.26) 410 — S — 82 (0.99 2.71 1.07) 410 — S — 83 (1.28 1.70 2.08) 410 — S — 85 (1.74 2.25 1.53) 410 — S — 86 (0.96 2.62 1.16) 410 — S — 89 (1.71 2.88 0.90) 410 — S — 90 (1.62 2.73 1.05) 410 — S — 101 (1.38 2.58 1.20) 410 — S — 102 (1.00 1.59 2.19) 410 — S — 105 (1.54 1.68 2.10) 410 — S — 106 (0.95 1.11 2.67) 410 — S — 107 (2.00 2.41 1.37) 410 — S — 108 (1.56 2.81 0.97) 410 — S — 110 (1.29 2.58 1.20) 410 — S — 111 (1.99 1.70 2.08) 410 — S — 112 (1.19 2.08 1.70) 410 — S — 114 (0.83 1.35 2.43) 410 — S — 115 (1.67 2.55 1.23) 410 — S — 118 (1.28 1.98 1.80) 410 — S — 119 (1.25 2.19 1.59) 410 — S — 123 (0.89 2.32 1.46) 410 — S — 127 (0.90 1.00 2.78) 410 — S — 131 (1.30 1.65 2.13) 410 — S — 132 (1.21 1.90 1.88) 410 — S — 133 (2.00 2.70 1.08) 410 — S — 144 (1.34 2.62 1.16) 410 — S — 148 (1.00 1.48 2.30) 410 — S — 150 (2.82 2.58 1.20) 410 — S — 151 (2.73 2.84 0.94) 410 — S — 153 (2.75 2.68 1.10) 410 — S — 154 (2.29 1.81 1.97) 410 — S — 158 (1.36 1.02 2.76) 410 — S — 161 (1.80 1.11 2.67) 410 — S — 166 (2.01 1.63 2.15) 410 — S — 167 (1.87 1.32 2.46) 410 — S — 170 (2.08 1.04 2.74) 410 — S — 171 (1.78 1.63 2.15) 410 — S — 175 (1.01 1.27 2.51) 410 — S — 176 (0.95 1.02 2.76) 410 — S — 177 (1.84 2.36 1.42) 410 — S — 182 (0.98 1.20 2.58) 410 — S — 183 (1.48 2.69 1.09) 410 — S — 184 (2.57 2.17 1.61) 410 — S — 187 (1.72 1.54 2.24) 410 — S — 188 (2.15 1.58 2.20) 410 — S — 189 (1.89 1.17 2.61) 410 — S — 192 (2.18 2.69 1.09) 410 — S — 193 (1.10 1.85 1.93) 410 — S — 194 (1.95 1.30 2.49) 410 — S — 195 (2.00 2.02 1.77) 410 — S — 197 (2.15 1.08 2.70) 410 — S — 198 (1.71 2.08 1.71) 410 — S — 205 (1.23 2.14 1.65) 410 — S — 208 (1.20 1.61 2.17) 410 — S — 209 (0.94 1.68 2.10) 410 — S — 210 (0.84 1.09 2.69) 410 — S — 213 (1.68 2.03 1.75) 410 — S — 214 (1.24 1.26 2.52) 410 — S — 217 (1.10 2.06 1.72) 410 — S — 218 (1.07 2.24 1.54) 410 — S — 219 (0.87 1.80 1.98) 410 — S — 222 (0.99 1.65 2.14) 410 — S — 230 (0.92 1.47 2.31) 410 — S — 231 (2.22 2.80 0.98) 410 — S — 233 (1.61 2.23 1.55) 410 — S — 234 (1.43 2.31 1.47) 410 — S — 236 (1.65 1.20 2.59) 410 — S — 237 (1.44 2.61 1.18) 410 — S — 240 (1.04 1.09 2.69) 410 — S — 243 (2.18 1.44 2.34) 410 — S — 244 (1.49 2.22 1.56) 410 — S — 245 (1.41 1.99 1.79) 410 — S — 246 (1.75 2.56 1.22) 410 — S — 251 (1.25 2.81 0.97) 410 — S — 254 (1.25 1.92 1.86) 410 — S — 255 (2.14 2.78 1.00) 410 — S — 261 (0.87 1.00 2.78) 410 — S — 265 (1.71 2.70 1.08) 410 — S — 266 (1.35 2.28 1.50) 410 — S — 267 (1.15 1.98 1.80) 410 — S — 268 (1.69 2.85 0.93) 410 — S — 269 (1.65 2.78 1.00) 410 — S — 271 (2.40 2.87 0.91) 410 — S — 272 (1.53 1.32 2.46) 410 — S — 274 (1.01 1.78 2.00) 410 — S — 275 (0.82 2.20 1.58) 410 — S — 276 (0.93 1.19 2.59) 410 — S — 277 (1.23 2.05 1.73) 410 — S — 279 (1.29 2.11 1.67) 410 — S — 280 (0.96 1.79 1.99) 410 — S — 282 (1.08 1.62 2.17) 410 — S — 284 (0.86 1.62 2.16) 410 — S — 285 (1.01 1.99 1.79) 410 — S — 286 (1.26 1.90 1.89) 410 — S — 287 (1.07 1.91 1.87) 410 — S — 288 (1.06 1.85 1.94) 410 — S — 289 (1.31 1.68 2.10) 410 — S — 290 (1.34 2.31 1.47) 410 — S — 291 (2.48 2.72 1.06) 410 — S — 292 (1.82 2.38 1.41) 410 — S — 293 (1.32 2.19 1.60) 410 — S — 294 (1.77 2.22 1.56) 410 — S — 295 (1.53 2.46 1.32) 410 — S — 296 (1.81 2.46 1.32) 410 — S — 297 (1.12 1.59 2.19) 410 — S — 298 (1.37 2.06 1.72) 410 — S — 300 (1.38 1.46 2.32) 410 — S — 301 (1.43 1.17 2.61) 410 — S — 302 (1.55 1.02 2.76) 410 — S — 303 (1.14 1.43 2.35) 410 — S — 304 (1.18 1.91 1.87) 410 — S — 305 (1.70 2.12 1.66) 410 — S — 306 (1.86 2.78 1.00) 410 — S — 308 (1.17 1.07 2.71) 410 — S — 310 (1.29 1.52 2.26) 410 — S — 311 (1.02 1.80 1.99) 410 — S — 312 (1.12 1.67 2.11) 410 — S — 313 (0.89 1.84 1.95) 410 — S — 316 (1.18 2.12 1.66) 410 — S — 318 (1.47 1.16 2.62) 410 — S — 327 (1.47 2.53 1.25) 410 — S — 331 (1.33 1.70 2.08) 410 — S — 332 (1.18 1.88 1.90) 410 — S — 336 (1.28 1.77 2.01) 410 — S — 342 (3.23 2.74 1.05) 410 — S — 352 (0.89 1.00 2.78) 410 — S — 353 (0.82 1.04 2.74) 410 — S — 356 (0.95 1.58 2.20) 410 — S — 357 (1.64 1.33 2.45) 410 — S — 358 (1.13 2.04 1.74) 410 — S — 367 (1.75 2.68 1.10) 410 — S — 370 (1.09 2.11 1.67) 410 — S — 371 (2.91 2.82 0.96) 410 — S — 372 (1.32 1.81 1.97) 410 — S — 374 (0.93 2.30 1.48) 410 — S — 379 (1.01 1.81 1.97) 410 — S — 380 (0.85 1.22 2.56) 410 — S — 382 (1.08 1.99 1.79) 410 — S — 391 (1.02 1.79 1.99) 410 — S — 394 (0.91 1.09 2.69) 410 — S — 395 (1.94 2.52 1.26) 410 — S — 396 (1.37 1.96 1.82) 410 — S — 397 (1.17 1.81 1.97) 410 — S — 398 (1.08 0.93 2.85) 410 — S — 401 (1.02 0.84 2.94) 410 — S — 403 (0.96 1.06 2.72) 410 — S — 415 (1.06 1.69 2.09) 410 — S — 430 (0.95 2.62 1.16) 410 — S — 432 (1.19 1.30 2.48)

410 — S — 433 (0.91 1.31 2.47) 410 — S — 434 (1.02 2.10 1.68) 410 — S — 435 (1.10 2.27 1.51) 410 — S — 437 (1.29 1.64 2.14)
410 — S — 440 (1.63 2.43 1.35) 410 — S — 441 (1.56 2.36 1.42) 410 — S — 444 (1.09 0.95 2.83) 410 — S — 447 (1.57 2.55 1.23)
410 — S — 449 (1.31 2.52 1.26) 410 — S — 450 (0.93 2.18 1.60) 410 — S — 452 (1.71 2.78 1.00) 410 — S — 453 (1.20 1.49 2.29)
410 — S — 454 (1.03 1.65 2.13) 410 — S — 455 (1.01 1.92 1.86) 410 — S — 457 (1.16 2.43 1.35) 410 — S — 459 (0.94 2.66 1.12)
410 — S — 460 (1.43 2.86 0.92) 410 — S — 461 (1.15 2.62 1.16) 410 — S — 462 (0.84 2.63 1.15) 410 — S — 467 (0.84 2.03 1.75)
410 — S — 468 (1.04 2.33 1.45) 410 — S — 469 (1.13 2.76 1.02) 410 — S — 471 (1.73 2.09 1.69) 410 — S — 473 (1.78 2.71 1.08)
410 — S — 474 (1.63 2.59 1.19) 411 — S — 9 (1.31 1.65 2.13) 411 — S — 19 (0.88 1.54 2.23) 411 — S — 20 (1.42 2.19 1.58)
411 — S — 27 (1.33 2.36 1.41) 411 — S — 28 (1.39 2.63 1.14) 411 — S — 29 (1.15 2.35 1.42) 411 — S — 40 (0.98 2.35 1.42)
411 — S — 44 (1.04 1.51 2.26) 411 — S — 46 (2.56 2.52 1.26) 411 — S — 56 (1.32 1.82 1.95) 411 — S — 61 (1.30 2.33 1.44)
411 — S — 62 (1.18 2.53 1.24) 411 — S — 65 (1.31 2.13 1.64) 411 — S — 68 (1.02 2.09 1.68) 411 — S — 79 (1.30 2.51 1.27)
411 — S — 80 (1.25 2.46 1.31) 411 — S — 81 (1.33 2.59 1.19) 411 — S — 82 (1.06 2.77 1.00) 411 — S — 83 (1.36 1.76 2.01)
411 — S — 85 (1.81 2.32 1.46) 411 — S — 86 (1.03 2.69 1.09) 411 — S — 90 (1.70 2.79 0.98) 411 — S — 101 (1.45 2.65 1.13)
411 — S — 102 (1.07 1.65 2.12) 411 — S — 105 (1.61 1.74 2.03) 411 — S — 106 (1.02 1.18 2.59) 411 — S — 107 (2.07 2.48 1.29)
411 — S — 108 (1.63 2.87 0.90) 411 — S — 110 (1.36 2.64 1.13) 411 — S — 111 (2.07 1.76 2.01) 411 — S — 112 (1.26 2.14 1.63)
411 — S — 114 (0.91 1.42 2.36) 411 — S — 115 (1.74 2.62 1.15) 411 — S — 118 (1.35 2.04 1.73) 411 — S — 119 (1.32 2.26 1.52)
411 — S — 123 (0.96 2.38 1.39) 411 — S — 127 (0.98 1.06 2.71) 411 — S — 131 (1.37 1.72 2.06) 411 — S — 132 (1.29 1.96 1.81)
411 — S — 133 (2.07 2.77 1.00) 411 — S — 144 (1.41 2.68 1.09) 411 — S — 147 (0.81 2.26 1.52) 411 — S — 148 (1.07 1.55 2.22)
411 — S — 150 (2.89 2.64 1.13) 411 — S — 153 (2.83 2.74 1.03) 411 — S — 154 (2.36 1.87 1.90) 411 — S — 158 (1.43 1.08 2.69)
411 — S — 161 (1.87 1.17 2.60) 411 — S — 166 (2.08 1.70 2.07) 411 — S — 167 (1.94 1.38 2.39) 411 — S — 170 (2.15 1.11 2.66)
411 — S — 171 (1.85 1.70 2.08) 411 — S — 175 (1.08 1.34 2.44) 411 — S — 176 (1.03 1.09 2.68) 411 — S — 177 (1.91 2.42 1.35)
411 — S — 182 (1.05 1.26 2.51) 411 — S — 183 (1.56 2.76 1.01) 411 — S — 184 (2.64 2.24 1.54) 411 — S — 187 (1.79 1.61 2.17)
411 — S — 188 (2.22 1.65 2.13) 411 — S — 189 (1.97 1.24 2.54) 411 — S — 192 (2.25 2.76 1.02) 411 — S — 193 (1.17 1.92 1.86)
411 — S — 194 (2.02 1.36 2.41) 411 — S — 195 (2.07 2.08 1.69) 411 — S — 197 (2.22 1.14 2.63) 411 — S — 198 (1.79 2.14 1.63)
411 — S — 205 (1.31 2.20 1.57) 411 — S — 208 (1.27 1.67 2.10) 411 — S — 209 (1.02 1.75 2.02) 411 — S — 210 (0.91 1.15 2.62)
411 — S — 213 (1.75 2.10 1.68) 411 — S — 214 (1.31 1.33 2.44) 411 — S — 217 (1.18 2.13 1.64) 411 — S — 218 (1.15 2.31 1.47)
411 — S — 219 (0.95 1.86 1.91) 411 — S — 222 (1.06 1.71 2.06) 411 — S — 230 (0.99 1.54 2.24) 411 — S — 231 (2.29 2.87 0.90)
411 — S — 233 (1.68 2.29 1.48) 411 — S — 234 (1.50 2.37 1.40) 411 — S — 236 (1.72 1.26 2.51) 411 — S — 237 (1.51 2.67 1.10)
411 — S — 238 (0.81 2.53 1.24) 411 — S — 239 (1.22 0.83 2.94) 411 — S — 240 (1.11 1.16 2.62) 411 — S — 243 (2.25 1.50 2.27)
411 — S — 244 (1.56 2.29 1.49) 411 — S — 245 (1.48 2.06 1.71) 411 — S — 246 (1.82 2.63 1.15) 411 — S — 251 (1.33 2.87 0.90)
411 — S — 254 (1.32 1.98 1.79) 411 — S — 255 (2.21 2.84 0.93) 411 — S — 261 (0.95 1.07 2.71) 411 — S — 265 (1.78 2.77 1.01)
411 — S — 266 (1.42 2.34 1.43) 411 — S — 267 (1.22 2.04 1.73) 411 — S — 269 (1.72 2.84 0.93) 411 — S — 272 (1.60 1.39 2.38)
411 — S — 274 (1.09 1.84 1.93) 411 — S — 275 (0.89 2.27 1.51) 411 — S — 276 (1.01 1.25 2.52) 411 — S — 277 (1.30 2.11 1.66)
411 — S — 279 (1.36 2.17 1.60) 411 — S — 280 (1.04 1.85 1.92) 411 — S — 282 (1.16 1.68 2.09) 411 — S — 284 (0.94 1.69 2.09)
411 — S — 285 (1.08 2.06 1.72) 411 — S — 286 (1.33 1.96 1.81) 411 — S — 287 (1.14 1.97 1.80) 411 — S — 288 (1.13 1.91 1.86)
411 — S — 289 (1.39 1.75 2.02) 411 — S — 290 (1.42 2.38 1.40) 411 — S — 291 (2.56 2.78 0.99) 411 — S — 292 (1.89 2.44 1.33)
411 — S — 293 (1.39 2.25 1.52) 411 — S — 294 (1.85 2.28 1.49) 411 — S — 295 (1.60 2.53 1.25) 411 — S — 296 (1.88 2.52 1.25)
411 — S — 297 (1.19 1.65 2.12) 411 — S — 298 (1.45 2.13 1.65) 411 — S — 300 (1.45 1.53 2.25) 411 — S — 301 (1.51 1.24 2.54)
411 — S — 302 (1.63 1.09 2.69) 411 — S — 303 (1.21 1.50 2.27) 411 — S — 304 (1.25 1.97 1.80) 411 — S — 305 (1.77 2.19 1.58)
411 — S — 306 (1.93 2.84 0.93) 411 — S — 308 (1.25 1.13 2.64) 411 — S — 310 (1.37 1.58 2.19) 411 — S — 311 (1.09 1.86 1.91)
411 — S — 312 (1.19 1.73 2.04) 411 — S — 313 (0.97 1.90 1.87) 411 — S — 316 (1.25 2.19 1.59) 411 — S — 318 (1.55 1.23 2.54)
411 — S — 327 (1.54 2.59 1.18) 411 — S — 330 (0.87 1.60 2.18) 411 — S — 331 (1.40 1.77 2.00) 411 — S — 332 (1.26 1.94 1.83)
411 — S — 336 (1.36 1.83 1.94) 411 — S — 341 (0.85 2.46 1.31) 411 — S — 342 (3.30 2.80 0.97) 411 — S — 352 (0.96 1.07 2.70)
411 — S — 353 (0.89 1.11 2.66) 411 — S — 356 (1.02 1.65 2.12) 411 — S — 357 (1.72 1.40 2.38) 411 — S — 358 (1.20 2.11 1.67)
411 — S — 367 (1.82 2.74 1.03) 411 — S — 370 (1.17 2.17 1.60) 411 — S — 372 (1.40 1.87 1.90) 411 — S — 374 (1.01 2.37 1.41)
411 — S — 379 (1.08 1.87 1.90) 411 — S — 380 (0.92 1.29 2.48) 411 — S — 382 (1.15 2.05 1.72) 411 — S — 391 (1.09 1.86 1.92)
411 — S — 394 (0.99 1.16 2.62) 411 — S — 395 (2.02 2.59 1.18) 411 — S — 396 (1.44 2.03 1.75) 411 — S — 397 (1.24 1.87 1.90)
411 — S — 398 (1.15 1.00 2.77) 411 — S — 401 (1.09 0.91 2.87) 411 — S — 403 (1.03 1.12 2.65) 411 — S — 415 (1.14 1.75 2.02)
411 — S — 430 (1.03 2.69 1.08) 411 — S — 432 (1.26 1.36 2.41) 411 — S — 433 (0.98 1.38 2.40) 411 — S — 434 (1.09 2.16 1.61)
411 — S — 435 (1.18 2.33 1.44) 411 — S — 437 (1.36 1.71 2.07) 411 — S — 440 (1.70 2.50 1.28) 411 — S — 441 (1.63 2.42 1.35)
411 — S — 444 (1.16 1.02 2.76) 411 — S — 445 (0.84 0.98 2.80) 411 — S — 446 (0.84 0.98 2.80) 411 — S — 447 (1.64 2.61 1.16)
411 — S — 449 (1.38 2.58 1.19) 411 — S — 450 (1.01 2.25 1.53) 411 — S — 452 (1.78 2.85 0.93) 411 — S — 453 (1.27 1.55 2.22)
411 — S — 454 (1.10 1.72 2.06) 411 — S — 455 (1.08 1.99 1.79) 411 — S — 457 (1.23 2.49 1.28) 411 — S — 459 (1.02 2.72 1.05)
411 — S — 461 (1.22 2.68 1.09) 411 — S — 462 (0.91 2.70 1.07) 411 — S — 467 (0.91 2.09 1.68) 411 — S — 468 (1.11 2.40 1.37)
411 — S — 469 (1.20 2.83 0.95) 411 — S — 471 (1.81 2.16 1.62) 411 — S — 473 (1.85 2.77 1.00) 411 — S — 474 (1.71 2.66 1.11)
412 — S — 9 (0.93 1.41 2.51) 412 — S — 20 (1.03 1.96 1.97) 412 — S — 27 (0.94 2.13 1.80) 412 — S — 28 (1.01 2.39 1.53)
412 — S — 36 (1.17 2.91 1.02) 412 — S — 43 (1.58 2.76 1.16) 412 — S — 46 (2.18 2.28 1.64) 412 — S — 56 (0.93 1.59 2.34)
412 — S — 61 (0.92 2.10 1.82) 412 — S — 65 (0.93 1.90 2.03) 412 — S — 70 (1.64 2.97 0.95) 412 — S — 79 (0.91 2.27 1.65)
412 — S — 80 (0.86 2.23 1.70) 412 — S — 81 (0.94 2.35 1.57) 412 — S — 83 (0.97 1.53 2.40) 412 — S — 85 (1.43 2.08 1.84)

| | | | |
|---|---|---|---|
| 412 — S — 89 (1.40 2.71 1.22) | 412 — S — 90 (1.31 2.56 1.37) | 412 — S — 101 (1.06 2.41 1.51) | 412 — S — 105 (1.22 1.51 2.42) |
| 412 — S — 107 (1.69 2.25 1.68) | 412 — S — 108 (1.25 2.64 1.29) | 412 — S — 109 (1.48 2.77 1.15) | 412 — S — 110 (0.98 2.41 1.51) |
| 412 — S — 111 (1.68 1.53 2.39) | 412 — S — 112 (0.87 1.91 2.02) | 412 — S — 113 (1.08 2.83 1.10) | 412 — S — 115 (1.35 2.38 1.54) |
| 412 — S — 118 (0.96 1.81 2.12) | 412 — S — 119 (0.93 2.02 1.90) | 412 — S — 131 (0.99 1.48 2.44) | 412 — S — 132 (0.90 1.73 2.20) |
| 412 — S — 133 (1.69 2.54 1.39) | 412 — S — 144 (1.02 2.45 1.48) | 412 — S — 150 (2.51 2.41 1.52) | 412 — S — 151 (2.42 2.67 1.26) |
| 412 — S — 152 (3.06 2.97 0.96) | 412 — S — 153 (2.44 2.51 1.42) | 412 — S — 154 (1.97 1.64 2.29) | 412 — S — 158 (1.05 0.85 3.07) |
| 412 — S — 161 (1.48 0.94 2.99) | 412 — S — 166 (1.69 1.46 2.46) | 412 — S — 167 (1.56 1.15 2.78) | 412 — S — 170 (1.77 0.88 3.05) |
| 412 — S — 171 (1.46 1.46 2.46) | 412 — S — 177 (1.52 2.19 1.74) | 412 — S — 183 (1.17 2.53 1.40) | 412 — S — 184 (2.26 2.00 1.92) |
| 412 — S — 187 (1.40 1.37 2.55) | 412 — S — 188 (1.83 1.41 2.51) | 412 — S — 189 (1.58 1.00 2.92) | 412 — S — 192 (1.86 2.52 1.40) |
| 412 — S — 194 (1.63 1.13 2.80) | 412 — S — 195 (1.69 1.85 2.08) | 412 — S — 197 (1.83 0.91 3.01) | 412 — S — 198 (1.40 1.91 2.02) |
| 412 — S — 205 (0.92 1.97 1.96) | 412 — S — 206 (0.91 2.88 1.05) | 412 — S — 207 (1.43 2.83 1.10) | 412 — S — 208 (0.88 1.44 2.49) |
| 412 — S — 213 (1.37 1.86 2.06) | 412 — S — 214 (0.93 1.10 2.83) | 412 — S — 231 (1.91 2.63 1.29) | 412 — S — 233 (1.29 2.06 1.87) |
| 412 — S — 234 (1.11 2.14 1.78) | 412 — S — 236 (1.33 1.03 2.90) | 412 — S — 237 (1.12 2.44 1.49) | 412 — S — 243 (1.86 1.27 2.66) |
| 412 — S — 244 (1.18 2.05 1.87) | 412 — S — 245 (1.10 1.82 2.10) | 412 — S — 246 (1.43 2.39 1.53) | 412 — S — 248 (1.50 2.94 0.99) |
| 412 — S — 249 (0.97 2.78 1.14) | 412 — S — 251 (0.94 2.64 1.29) | 412 — S — 254 (0.93 1.75 2.18) | 412 — S — 255 (1.82 2.61 1.32) |
| 412 — S — 265 (1.39 2.53 1.39) | 412 — S — 266 (1.03 2.11 1.82) | 412 — S — 267 (0.83 1.81 2.12) | 412 — S — 268 (1.37 2.68 1.24) |
| 412 — S — 269 (1.34 2.61 1.32) | 412 — S — 271 (2.09 2.70 1.22) | 412 — S — 272 (1.21 1.16 2.77) | 412 — S — 277 (0.92 1.88 2.05) |
| 412 — S — 279 (0.97 1.94 1.99) | 412 — S — 286 (0.95 1.73 2.20) | 412 — S — 289 (1.00 1.52 2.41) | 412 — S — 290 (1.03 2.14 1.78) |
| 412 — S — 291 (2.17 2.55 1.38) | 412 — S — 292 (1.50 2.21 1.72) | 412 — S — 293 (1.01 2.02 1.91) | 412 — S — 294 (1.46 2.05 1.88) |
| 412 — S — 295 (1.21 2.29 1.63) | 412 — S — 296 (1.49 2.29 1.64) | 412 — S — 297 (0.80 1.42 2.51) | 412 — S — 298 (1.06 1.89 2.03) |
| 412 — S — 300 (1.07 1.29 2.63) | 412 — S — 301 (1.12 1.00 2.92) | 412 — S — 302 (1.24 0.85 3.07) | 412 — S — 303 (0.83 1.26 2.66) |
| 412 — S — 304 (0.87 1.74 2.19) | 412 — S — 305 (1.38 1.95 1.97) | 412 — S — 306 (1.54 2.61 1.32) | 412 — S — 307 (1.27 2.74 1.19) |
| 412 — S — 308 (0.86 0.90 3.03) | 412 — S — 310 (0.98 1.35 2.58) | 412 — S — 312 (0.80 1.50 2.43) | 412 — S — 316 (0.87 1.95 1.97) |
| 412 — S — 318 (1.16 1.00 2.93) | 412 — S — 327 (1.16 2.36 1.57) | 412 — S — 329 (1.48 2.82 1.11) | 412 — S — 331 (1.02 1.53 2.39) |
| 412 — S — 332 (0.87 1.71 2.22) | 412 — S — 336 (0.97 1.60 2.33) | 412 — S — 342 (2.91 2.57 1.36) | 412 — S — 357 (1.33 1.16 2.76) |
| 412 — S — 358 (0.81 1.87 2.05) | 412 — S — 367 (1.44 2.51 1.42) | 412 — S — 371 (2.60 2.66 1.27) | 412 — S — 372 (1.01 1.64 2.29) |
| 412 — S — 395 (1.63 2.36 1.57) | 412 — S — 396 (1.06 1.79 2.13) | 412 — S — 397 (0.86 1.64 2.29) | 412 — S — 420 (0.81 2.83 1.09) |
| 412 — S — 432 (0.88 1.13 2.80) | 412 — S — 437 (0.97 1.47 2.45) | 412 — S — 440 (1.32 2.26 1.66) | 412 — S — 441 (1.25 2.19 1.73) |
| 412 — S — 447 (1.26 2.38 1.55) | 412 — S — 449 (1.00 2.35 1.58) | 412 — S — 451 (1.34 2.96 0.97) | 412 — S — 452 (1.40 2.61 1.31) |
| 412 — S — 453 (0.89 1.32 2.61) | 412 — S — 457 (0.84 2.26 1.67) | 412 — S — 460 (1.12 2.69 1.24) | 412 — S — 461 (0.84 2.45 1.48) |
| 412 — S — 469 (0.81 2.59 1.33) | 412 — S — 471 (1.42 1.92 2.00) | 412 — S — 473 (1.47 2.54 1.39) | 412 — S — 474 (1.32 2.43 1.50) |
| 413 — S — 1 (0.85 1.41 2.14) | 413 — S — 2 (0.86 1.49 2.06) | 413 — S — 4 (0.98 1.57 1.98) | 413 — S — 5 (0.84 1.80 1.75) |
| 413 — S — 9 (1.72 1.83 1.72) | 413 — S — 11 (0.83 2.07 1.47) | 413 — S — 14 (1.14 1.47 2.08) | 413 — S — 19 (1.29 1.73 1.82) |
| 413 — S — 20 (1.82 2.38 1.17) | 413 — S — 27 (1.74 2.54 1.00) | 413 — S — 29 (1.56 2.54 1.01) | 413 — S — 30 (0.97 1.75 1.80) |
| 413 — S — 31 (0.99 1.71 1.84) | 413 — S — 32 (1.08 1.56 1.99) | 413 — S — 33 (1.02 1.59 1.96) | 413 — S — 34 (0.90 1.58 1.97) |
| 413 — S — 35 (1.04 1.54 2.01) | 413 — S — 38 (1.18 1.97 1.58) | 413 — S — 40 (1.38 2.54 1.01) | 413 — S — 44 (1.45 1.69 1.86) |
| 413 — S — 45 (0.85 2.18 1.37) | 413 — S — 53 (0.84 1.23 2.32) | 413 — S — 54 (0.93 1.49 2.06) | 413 — S — 55 (1.01 1.30 2.25) |
| 413 — S — 56 (1.73 2.01 1.54) | 413 — S — 58 (0.87 1.77 1.78) | 413 — S — 59 (0.91 1.74 1.81) | 413 — S — 60 (1.02 1.62 1.93) |
| 413 — S — 61 (1.71 2.52 1.03) | 413 — S — 63 (0.87 1.04 2.51) | 413 — S — 64 (0.94 1.53 2.02) | 413 — S — 65 (1.72 2.32 1.23) |
| 413 — S — 68 (1.43 2.28 1.27) | 413 — S — 71 (0.87 1.51 2.04) | 413 — S — 74 (0.88 1.85 1.70) | 413 — S — 80 (1.66 2.65 0.90) |
| 413 — S — 83 (1.77 1.95 1.60) | 413 — S — 85 (2.22 2.50 1.05) | 413 — S — 88 (0.94 1.62 1.93) | 413 — S — 96 (0.80 2.31 1.24) |
| 413 — S — 98 (0.93 1.68 1.87) | 413 — S — 102 (1.48 1.84 1.71) | 413 — S — 104 (1.14 1.41 2.14) | 413 — S — 105 (2.02 1.93 1.62) |
| 413 — S — 106 (1.43 1.36 2.19) | 413 — S — 111 (2.48 1.95 1.60) | 413 — S — 112 (1.67 2.33 1.22) | 413 — S — 114 (1.32 1.60 1.95) |
| 413 — S — 117 (0.85 1.15 2.40) | 413 — S — 118 (1.76 2.23 1.32) | 413 — S — 119 (1.73 2.44 1.11) | 413 — S — 123 (1.37 2.57 0.98) |
| 413 — S — 127 (1.39 1.25 2.30) | 413 — S — 131 (1.78 1.90 1.65) | 413 — S — 132 (1.69 2.15 1.40) | 413 — S — 136 (1.80 0.84 2.71) |
| 413 — S — 138 (1.01 1.88 1.67) | 413 — S — 147 (1.22 2.44 1.11) | 413 — S — 148 (1.48 1.73 1.82) | 413 — S — 149 (0.85 1.07 2.48) |
| 413 — S — 154 (2.77 2.06 1.49) | 413 — S — 158 (1.84 1.27 2.28) | 413 — S — 161 (2.28 1.36 2.19) | 413 — S — 166 (2.49 1.88 1.67) |
| 413 — S — 167 (2.35 1.57 1.98) | 413 — S — 168 (1.91 0.85 2.70) | 413 — S — 170 (2.56 1.29 2.26) | 413 — S — 171 (2.26 1.88 1.67) |
| 413 — S — 175 (1.49 1.52 2.03) | 413 — S — 176 (1.44 1.27 2.28) | 413 — S — 177 (2.32 2.61 0.94) | 413 — S — 182 (1.46 1.45 2.10) |
| 413 — S — 184 (3.05 2.42 1.13) | 413 — S — 187 (2.20 1.79 1.76) | 413 — S — 188 (2.63 1.83 1.72) | 413 — S — 189 (2.37 1.42 2.13) |
| 413 — S — 193 (1.58 2.10 1.45) | 413 — S — 194 (2.43 1.55 2.00) | 413 — S — 195 (2.48 2.27 1.28) | 413 — S — 197 (2.63 1.33 2.22) |
| 413 — S — 198 (2.19 2.33 1.22) | 413 — S — 200 (0.89 1.17 2.38) | 413 — S — 205 (1.71 2.39 1.16) | 413 — S — 208 (1.68 1.86 1.69) |
| 413 — S — 209 (1.43 1.94 1.61) | 413 — S — 210 (1.32 1.34 2.21) | 413 — S — 213 (2.16 2.28 1.27) | 413 — S — 214 (1.72 1.52 2.03) |
| 413 — S — 217 (1.59 2.31 1.24) | 413 — S — 218 (1.55 2.49 1.06) | 413 — S — 219 (1.36 2.05 1.50) | 413 — S — 222 (1.47 1.90 1.65) |
| 413 — S — 224 (1.10 1.56 1.98) | 413 — S — 225 (0.96 1.90 1.65) | 413 — S — 228 (1.10 2.05 1.50) | 413 — S — 230 (1.40 1.72 1.83) |
| 413 — S — 233 (2.09 2.48 1.07) | 413 — S — 234 (1.91 2.56 0.99) | 413 — S — 236 (2.13 1.45 2.10) | 413 — S — 239 (1.62 1.01 2.54) |
| 413 — S — 240 (1.52 1.34 2.21) | 413 — S — 242 (0.90 0.81 2.74) | 413 — S — 243 (2.66 1.69 1.86) | 413 — S — 244 (1.97 2.47 1.08) |
| 413 — S — 245 (1.89 2.24 1.31) | 413 — S — 254 (1.73 2.17 1.38) | 413 — S — 261 (1.35 1.25 2.30) | 413 — S — 262 (1.46 0.93 2.62) |

413 — S — 264 (2.01 0.89 2.66) 413 — S — 266 (1.83 2.53 1.02) 413 — S — 267 (1.63 2.23 1.32) 413 — S — 272 (2.01 1.57 1.98) 413 — S — 274 (1.49 2.03 1.52) 413 — S — 275 (1.30 2.45 1.10) 413 — S — 276 (1.41 1.44 2.11) 413 — S — 277 (1.71 2.30 1.25) 413 — S — 279 (1.77 2.36 1.19) 413 — S — 280 (1.45 2.04 1.51) 413 — S — 282 (1.56 1.87 1.68) 413 — S — 284 (1.34 1.87 1.68) 413 — S — 285 (1.49 2.24 1.31) 413 — S — 286 (1.74 2.15 1.40) 413 — S — 287 (1.55 2.16 1.39) 413 — S — 288 (1.54 2.10 1.45) 413 — S — 289 (1.80 1.93 1.62) 413 — S — 290 (1.83 2.56 0.99) 413 — S — 292 (2.30 2.63 0.92) 413 — S — 293 (1.80 2.44 1.11) 413 — S — 294 (2.26 2.47 1.08) 413 — S — 297 (1.60 1.84 1.71) 413 — S — 298 (1.86 2.31 1.24) 413 — S — 300 (1.86 1.71 1.84) 413 — S — 301 (1.91 1.42 2.13) 413 — S — 302 (2.04 1.27 2.28) 413 — S — 303 (1.62 1.68 1.87) 413 — S — 304 (1.66 2.16 1.39) 413 — S — 305 (2.18 2.37 1.18) 413 — S — 308 (1.65 1.32 2.23) 413 — S — 310 (1.78 1.77 1.78) 413 — S — 311 (1.50 2.05 1.50) 413 — S — 312 (1.60 1.92 1.63) 413 — S — 313 (1.37 2.09 1.46) 413 — S — 316 (1.66 2.37 1.18) 413 — S — 318 (1.96 1.42 2.13) 413 — S — 319 (0.86 2.23 1.32) 413 — S — 328 (1.08 1.28 2.27) 413 — S — 330 (1.28 1.78 1.77) 413 — S — 331 (1.81 1.95 1.60) 413 — S — 332 (1.66 2.13 1.42) 413 — S — 336 (1.76 2.02 1.53) 413 — S — 341 (1.26 2.65 0.90) 413 — S — 352 (1.37 1.25 2.30) 413 — S — 353 (1.30 1.29 2.26) 413 — S — 356 (1.43 1.83 1.72) 413 — S — 357 (2.12 1.58 1.97) 413 — S — 358 (1.61 2.29 1.26) 413 — S — 359 (1.01 1.39 2.16) 413 — S — 360 (1.05 1.69 1.86) 413 — S — 366 (1.15 0.94 2.61) 413 — S — 370 (1.58 2.36 1.19) 413 — S — 372 (1.80 2.06 1.49) 413 — S — 373 (1.20 2.07 1.48) 413 — S — 374 (1.41 2.55 1.00) 413 — S — 378 (0.93 1.90 1.65) 413 — S — 379 (1.49 2.06 1.49) 413 — S — 380 (1.33 1.47 2.08) 413 — S — 381 (1.06 2.23 1.32) 413 — S — 382 (1.56 2.24 1.31) 413 — S — 391 (1.50 2.04 1.51) 413 — S — 392 (0.95 1.21 2.34) 413 — S — 394 (1.39 1.34 2.21) 413 — S — 396 (1.85 2.21 1.34) 413 — S — 397 (1.65 2.06 1.49) 413 — S — 398 (1.56 1.18 2.36) 413 — S — 401 (1.50 1.09 2.46) 413 — S — 403 (1.44 1.31 2.24) 413 — S — 405 (0.83 1.00 2.55) 413 — S — 415 (1.54 1.94 1.61) 413 — S — 419 (0.94 2.04 1.51) 413 — S — 421 (1.20 1.08 2.47) 413 — S — 422 (0.85 1.63 1.92) 413 — S — 432 (1.67 1.55 2.00) 413 — S — 433 (1.39 1.56 1.99) 413 — S — 434 (1.50 2.35 1.20) 413 — S — 435 (1.59 2.52 1.03) 413 — S — 437 (1.77 1.89 1.66) 413 — S — 441 (2.04 2.61 0.94) 413 — S — 444 (1.57 1.20 2.35) 413 — S — 445 (1.25 1.16 2.39) 413 — S — 446 (1.25 1.16 2.39) 413 — S — 448 (0.99 1.55 2.00) 413 — S — 450 (1.42 2.43 1.12) 413 — S — 453 (1.68 1.74 1.81) 413 — S — 454 (1.51 1.90 1.65) 413 — S — 455 (1.49 2.17 1.38) 413 — S — 456 (1.18 1.88 1.67) 413 — S — 458 (1.18 2.47 1.08) 413 — S — 466 (1.01 1.76 1.79) 413 — S — 467 (1.32 2.28 1.27) 413 — S — 468 (1.52 2.58 0.97) 413 — S — 471 (2.22 2.34 1.21) 413 — S — 475 (1.06 1.96 1.58) 413 — S — 480 (1.14 1.32 2.23) 414 — S — 1 (0.86 1.43 2.13) 414 — S — 2 (0.87 1.51 2.05) 414 — S — 4 (0.99 1.59 1.97) 414 — S — 5 (0.85 1.81 1.74) 414 — S — 9 (1.73 1.85 1.70) 414 — S — 11 (0.84 2.09 1.46) 414 — S — 14 (1.15 1.49 2.06) 414 — S — 19 (1.30 1.75 1.81) 414 — S — 20 (1.84 2.40 1.16) 414 — S — 27 (1.75 2.56 0.99) 414 — S — 29 (1.58 2.56 1.00) 414 — S — 30 (0.99 1.77 1.78) 414 — S — 31 (1.00 1.73 1.83) 414 — S — 32 (1.09 1.58 1.98) 414 — S — 33 (1.04 1.61 1.94) 414 — S — 34 (0.91 1.60 1.95) 414 — S — 35 (1.05 1.56 2.00) 414 — S — 38 (1.19 1.99 1.57) 414 — S — 40 (1.40 2.55 1.00) 414 — S — 44 (1.47 1.71 1.84) 414 — S — 45 (0.86 2.20 1.35) 414 — S — 53 (0.85 1.25 2.30) 414 — S — 54 (0.94 1.51 2.05) 414 — S — 55 (1.02 1.31 2.24) 414 — S — 56 (1.74 2.02 1.53) 414 — S — 58 (0.88 1.78 1.77) 414 — S — 59 (0.92 1.76 1.80) 414 — S — 60 (1.03 1.64 1.91) 414 — S — 61 (1.72 2.54 1.02) 414 — S — 63 (0.89 1.06 2.50) 414 — S — 64 (0.95 1.54 2.01) 414 — S — 65 (1.73 2.33 1.22) 414 — S — 68 (1.45 2.30 1.26) 414 — S — 71 (0.88 1.53 2.02) 414 — S — 74 (0.89 1.87 1.69) 414 — S — 83 (1.78 1.97 1.59) 414 — S — 85 (2.23 2.52 1.03) 414 — S — 88 (0.95 1.64 1.92) 414 — S — 96 (0.82 2.32 1.23) 414 — S — 98 (0.95 1.70 1.86) 414 — S — 102 (1.50 1.86 1.70) 414 — S — 104 (1.15 1.43 2.13) 414 — S — 105 (2.03 1.95 1.61) 414 — S — 106 (1.45 1.38 2.17) 414 — S — 111 (2.49 1.97 1.59) 414 — S — 112 (1.68 2.35 1.21) 414 — S — 114 (1.33 1.62 1.93) 414 — S — 117 (0.86 1.17 2.39) 414 — S — 118 (1.77 2.24 1.31) 414 — S — 119 (1.74 2.46 1.10) 414 — S — 123 (1.38 2.59 0.97) 414 — S — 127 (1.40 1.27 2.29) 414 — S — 131 (1.80 1.92 1.63) 414 — S — 132 (1.71 2.17 1.39) 414 — S — 136 (1.81 0.86 2.70) 414 — S — 138 (1.03 1.90 1.66) 414 — S — 147 (1.24 2.46 1.10) 414 — S — 148 (1.49 1.75 1.80) 414 — S — 149 (0.86 1.09 2.46) 414 — S — 154 (2.78 2.08 1.48) 414 — S — 158 (1.85 1.29 2.27) 414 — S — 161 (2.29 1.38 2.18) 414 — S — 166 (2.50 1.90 1.65) 414 — S — 167 (2.37 1.59 1.97) 414 — S — 168 (1.93 0.87 2.68) 414 — S — 170 (2.57 1.31 2.24) 414 — S — 171 (2.27 1.90 1.66) 414 — S — 175 (1.50 1.54 2.02) 414 — S — 176 (1.45 1.29 2.26) 414 — S — 177 (2.33 2.63 0.93) 414 — S — 182 (1.47 1.47 2.09) 414 — S — 184 (3.07 2.44 1.12) 414 — S — 187 (2.21 1.81 1.74) 414 — S — 188 (2.64 1.85 1.70) 414 — S — 189 (2.39 1.44 2.12) 414 — S — 193 (1.59 2.12 1.43) 414 — S — 194 (2.44 1.56 1.99) 414 — S — 195 (2.50 2.28 1.27) 414 — S — 197 (2.64 1.35 2.21) 414 — S — 198 (2.21 2.34 1.21) 414 — S — 200 (0.90 1.19 2.37) 414 — S — 205 (1.73 2.40 1.15) 414 — S — 208 (1.69 1.88 1.68) 414 — S — 209 (1.44 1.95 1.60) 414 — S — 210 (1.33 1.36 2.20) 414 — S — 213 (2.17 2.30 1.26) 414 — S — 214 (1.74 1.53 2.02) 414 — S — 217 (1.60 2.33 1.22) 414 — S — 218 (1.57 2.51 1.05) 414 — S — 219 (1.37 2.07 1.49) 414 — S — 222 (1.48 1.91 1.64) 414 — S — 224 (1.12 1.58 1.97) 414 — S — 225 (0.97 1.92 1.64) 414 — S — 228 (1.11 2.07 1.49) 414 — S — 230 (1.41 1.74 1.81) 414 — S — 233 (2.10 2.50 1.06) 414 — S — 234 (1.92 2.58 0.98) 414 — S — 236 (2.14 1.46 2.09) 414 — S — 239 (1.64 1.03 2.52) 414 — S — 240 (1.53 1.36 2.19) 414 — S — 242 (0.92 0.83 2.72) 414 — S — 243 (2.67 1.70 1.85) 414 — S — 244 (1.99 2.49 1.07) 414 — S — 245 (1.90 2.26 1.29) 414 — S — 254 (1.74 2.19 1.37) 414 — S — 261 (1.37 1.27 2.28) 414 — S — 262 (1.47 0.95 2.61) 414 — S — 264 (2.02 0.91 2.64) 414 — S — 266 (1.84 2.55 1.01) 414 — S — 267 (1.64 2.25 1.31) 414 — S — 272 (2.02 1.59 1.96) 414 — S — 274 (1.51 2.05 1.51) 414 — S — 275 (1.31 2.47 1.09) 414 — S — 276 (1.43 1.45 2.10) 414 — S — 277 (1.73 2.32 1.24) 414 — S — 279 (1.78 2.38 1.18) 414 — S — 280 (1.46 2.06 1.50) 414 — S — 282 (1.58 1.88 1.67) 414 — S — 284 (1.36 1.89 1.66) 414 — S — 285 (1.50 2.26 1.30) 414 — S — 286 (1.76 2.16 1.39) 414 — S — 287 (1.56 2.17 1.38) 414 — S — 288 (1.55 2.11 1.44) 414 — S — 289 (1.81 1.95 1.60) 414 — S — 290 (1.84 2.58 0.98) 414 — S — 292 (2.31 2.64 0.91) 414 — S — 293 (1.81 2.45 1.10) 414 — S — 294 (2.27 2.49 1.07) 414 — S — 297 (1.61 1.86 1.70) 414 — S — 298 (1.87 2.33 1.23) 414 — S — 300 (1.88 1.73 1.83) 414 — S — 301 (1.93 1.44 2.11) 414 — S — 302 (2.05 1.29 2.27) 414 — S — 303 (1.63 1.70 1.85) 414 — S — 304 (1.68 2.18 1.38) 414 — S — 305 (2.19 2.39 1.16) 414 — S — 308 (1.67 1.34 2.22)

414 — S — 310 (1.79 1.79 1.77) 414 — S — 311 (1.51 2.06 1.49) 414 — S — 312 (1.61 1.94 1.62) 414 — S — 313 (1.39 2.10 1.45)
414 — S — 316 (1.67 2.39 1.16) 414 — S — 318 (1.97 1.43 2.12) 414 — S — 319 (0.88 2.25 1.30) 414 — S — 328 (1.09 1.30 2.26)
414 — S — 330 (1.29 1.80 1.76) 414 — S — 331 (1.82 1.97 1.58) 414 — S — 332 (1.68 2.15 1.41) 414 — S — 336 (1.78 2.04 1.52)
414 — S — 338 (2.08 0.80 2.75) 414 — S — 352 (1.39 1.27 2.28) 414 — S — 353 (1.31 1.31 2.24) 414 — S — 354 (0.81 1.14 2.42)
414 — S — 356 (1.44 1.85 1.70) 414 — S — 357 (2.14 1.60 1.96) 414 — S — 358 (1.62 2.31 1.24) 414 — S — 359 (1.03 1.41 2.15)
414 — S — 360 (1.07 1.71 1.85) 414 — S — 366 (1.17 0.96 2.59) 414 — S — 370 (1.59 2.38 1.18) 414 — S — 372 (1.82 2.08 1.48)
414 — S — 373 (1.21 2.08 1.47) 414 — S — 374 (1.43 2.57 0.98) 414 — S — 378 (0.94 1.92 1.63) 414 — S — 379 (1.50 2.07 1.48)
414 — S — 380 (1.34 1.49 2.06) 414 — S — 381 (1.07 2.24 1.31) 414 — S — 382 (1.57 2.26 1.30) 414 — S — 391 (1.51 2.06 1.49)
414 — S — 392 (0.96 1.23 2.33) 414 — S — 394 (1.41 1.36 2.20) 414 — S — 396 (1.86 2.23 1.32) 414 — S — 397 (1.67 2.07 1.48)
414 — S — 398 (1.57 1.20 2.35) 414 — S — 401 (1.51 1.11 2.44) 414 — S — 403 (1.46 1.33 2.23) 414 — S — 405 (0.84 1.02 2.54)
414 — S — 415 (1.56 1.96 1.60) 414 — S — 419 (0.95 2.05 1.50) 414 — S — 421 (1.21 1.09 2.46) 414 — S — 422 (0.86 1.65 1.91)
414 — S — 432 (1.69 1.57 1.99) 414 — S — 433 (1.40 1.58 1.98) 414 — S — 434 (1.51 2.37 1.19) 414 — S — 435 (1.60 2.53 1.02)
414 — S — 437 (1.78 1.91 1.64) 414 — S — 441 (2.05 2.63 0.93) 414 — S — 444 (1.59 1.22 2.33) 414 — S — 445 (1.26 1.18 2.37)
414 — S — 446 (1.26 1.18 2.37) 414 — S — 448 (1.01 1.57 1.99) 414 — S — 450 (1.43 2.45 1.10) 414 — S — 453 (1.70 1.76 1.80)
414 — S — 454 (1.52 1.92 1.63) 414 — S — 455 (1.50 2.19 1.36) 414 — S — 456 (1.20 1.90 1.65) 414 — S — 458 (1.19 2.49 1.06)
414 — S — 466 (1.02 1.77 1.78) 414 — S — 467 (1.33 2.30 1.26) 414 — S — 468 (1.53 2.60 0.95) 414 — S — 471 (2.23 2.36 1.19)
414 — S — 475 (1.07 1.98 1.57) 414 — S — 480 (1.15 1.34 2.22) 415 — S — 43 (0.83 1.24 1.91) 415 — S — 57 (1.10 1.78 1.38)
415 — S — 70 (0.89 1.45 1.70) 415 — S — 125 (1.34 2.23 0.93) 415 — S — 133 (0.94 1.02 2.14) 415 — S — 150 (1.76 0.89 2.27)
415 — S — 151 (1.67 1.15 2.01) 415 — S — 152 (2.31 1.45 1.71) 415 — S — 153 (1.69 0.99 2.17) 415 — S — 192 (1.11 1.00 2.15)
415 — S — 215 (0.92 1.57 1.58) 415 — S — 231 (1.16 1.11 2.04) 415 — S — 247 (0.82 2.08 1.08) 415 — S — 255 (1.07 1.09 2.07)
415 — S — 259 (0.93 1.91 1.25) 415 — S — 271 (1.34 1.18 1.97) 415 — S — 291 (1.42 1.03 2.13) 415 — S — 320 (1.01 1.51 1.65)
415 — S — 324 (0.99 2.00 1.16) 415 — S — 342 (2.16 1.05 2.11) 415 — S — 343 (2.69 1.54 1.62) 415 — S — 364 (0.87 1.67 1.49)
415 — S — 371 (1.85 1.14 2.02) 415 — S — 395 (0.88 0.84 2.32) 415 — S — 429 (2.25 2.24 0.92) 415 — S — 472 (1.25 1.81 1.34)
416 — S — 9 (1.02 1.00 2.42) 416 — S — 20 (1.12 1.55 1.87) 416 — S — 27 (1.04 1.71 1.71) 416 — S — 28 (1.10 1.98 1.44)
416 — S — 29 (0.86 1.70 1.71) 416 — S — 36 (1.26 2.49 0.93) 416 — S — 43 (1.67 2.35 1.07) 416 — S — 46 (2.27 1.87 1.55)
416 — S — 56 (1.02 1.17 2.25) 416 — S — 61 (1.01 1.69 1.73) 416 — S — 62 (0.89 1.89 1.53) 416 — S — 65 (1.02 1.48 1.94)
416 — S — 79 (1.00 1.86 1.56) 416 — S — 80 (0.96 1.82 1.60) 416 — S — 81 (1.03 1.94 1.48) 416 — S — 83 (1.06 1.11 2.30)
416 — S — 85 (1.52 1.67 1.75) 416 — S — 89 (1.49 2.30 1.12) 416 — S — 90 (1.40 2.15 1.27) 416 — S — 101 (1.16 2.00 1.42)
416 — S — 105 (1.32 1.10 2.32) 416 — S — 107 (1.78 1.83 1.59) 416 — S — 108 (1.34 2.22 1.20) 416 — S — 109 (1.58 2.36 1.06)
416 — S — 110 (1.07 2.00 1.42) 416 — S — 111 (1.77 1.12 2.30) 416 — S — 112 (0.97 1.50 1.92) 416 — S — 113 (1.18 2.41 1.01)
416 — S — 115 (1.45 1.97 1.45) 416 — S — 118 (1.06 1.39 2.03) 416 — S — 119 (1.03 1.61 1.81) 416 — S — 131 (1.08 1.07 2.35)
416 — S — 132 (0.99 1.32 2.10) 416 — S — 133 (1.78 2.12 1.30) 416 — S — 144 (1.12 2.03 1.39) 416 — S — 150 (2.60 2.00 1.42)
416 — S — 151 (2.51 2.25 1.17) 416 — S — 153 (2.53 2.10 1.32) 416 — S — 154 (2.07 1.23 2.19) 416 — S — 166 (1.79 1.05 2.37)
416 — S — 171 (1.56 1.05 2.37) 416 — S — 177 (1.61 1.78 1.64) 416 — S — 183 (1.26 2.11 1.31) 416 — S — 184 (2.35 1.59 1.83)
416 — S — 187 (1.50 0.96 2.46) 416 — S — 188 (1.93 1.00 2.42) 416 — S — 192 (1.96 2.11 1.31) 416 — S — 193 (0.87 1.27 2.15)
416 — S — 195 (1.78 1.43 1.99) 416 — S — 198 (1.49 1.49 1.93) 416 — S — 205 (1.01 1.55 1.87) 416 — S — 206 (1.01 2.47 0.95)
416 — S — 207 (1.53 2.41 1.01) 416 — S — 208 (0.98 1.03 2.39) 416 — S — 213 (1.46 1.45 1.97) 416 — S — 217 (0.88 1.48 1.94)
416 — S — 218 (0.85 1.66 1.76) 416 — S — 231 (2.00 2.22 1.20) 416 — S — 233 (1.39 1.65 1.77) 416 — S — 234 (1.21 1.73 1.69)
416 — S — 237 (1.22 2.02 1.40) 416 — S — 243 (1.96 0.85 2.57) 416 — S — 244 (1.27 1.64 1.78) 416 — S — 245 (1.19 1.41 2.01)
416 — S — 246 (1.53 1.98 1.44) 416 — S — 249 (1.06 2.37 1.05) 416 — S — 251 (1.03 2.23 1.19) 416 — S — 254 (1.03 1.34 2.08)
416 — S — 255 (1.92 2.20 1.22) 416 — S — 265 (1.49 2.12 1.30) 416 — S — 266 (1.12 1.70 1.72) 416 — S — 267 (0.92 1.40 2.02)
416 — S — 268 (1.47 2.27 1.15) 416 — S — 269 (1.43 2.20 1.22) 416 — S — 271 (2.18 2.29 1.13) 416 — S — 277 (1.01 1.47 1.95)
416 — S — 279 (1.07 1.53 1.89) 416 — S — 282 (0.86 1.03 2.39) 416 — S — 286 (1.04 1.31 2.11) 416 — S — 287 (0.85 1.32 2.10)
416 — S — 288 (0.83 1.26 2.16) 416 — S — 289 (1.09 1.10 2.32) 416 — S — 290 (1.12 1.73 1.69) 416 — S — 291 (2.26 2.13 1.29)
416 — S — 292 (1.60 1.79 1.63) 416 — S — 293 (1.10 1.60 1.82) 416 — S — 294 (1.55 1.64 1.78) 416 — S — 295 (1.31 1.88 1.54)
416 — S — 296 (1.59 1.87 1.54) 416 — S — 297 (0.90 1.01 2.41) 416 — S — 298 (1.15 1.48 1.94) 416 — S — 300 (1.16 0.88 2.54)
416 — S — 303 (0.92 0.85 2.57) 416 — S — 304 (0.96 1.33 2.09) 416 — S — 305 (1.48 1.54 1.88) 416 — S — 306 (1.64 2.20 1.22)
416 — S — 307 (1.37 2.33 1.09) 416 — S — 310 (1.07 0.94 2.48) 416 — S — 312 (0.90 1.09 2.33) 416 — S — 316 (0.96 1.54 1.88)
416 — S — 327 (1.25 1.94 1.48) 416 — S — 329 (1.58 2.40 1.02) 416 — S — 331 (1.11 1.12 2.30) 416 — S — 332 (0.96 1.30 2.12)
416 — S — 336 (1.06 1.19 2.23) 416 — S — 342 (3.00 2.15 1.27) 416 — S — 358 (0.91 1.46 1.96) 416 — S — 367 (1.53 2.10 1.32)
416 — S — 370 (0.87 1.53 1.89) 416 — S — 371 (2.69 2.24 1.18) 416 — S — 372 (1.10 1.23 2.19) 416 — S — 382 (0.86 1.41 2.01)
416 — S — 395 (1.72 1.94 1.48) 416 — S — 396 (1.15 1.38 2.04) 416 — S — 397 (0.95 1.22 2.20) 416 — S — 415 (0.84 1.11 2.31)
416 — S — 420 (0.90 2.42 1.00) 416 — S — 435 (0.88 1.68 1.74) 416 — S — 437 (1.06 1.06 2.36) 416 — S — 440 (1.41 1.85 1.57)
416 — S — 441 (1.34 1.78 1.64) 416 — S — 443 (0.81 2.39 1.03) 416 — S — 447 (1.35 1.97 1.45) 416 — S — 449 (1.09 1.93 1.49)
416 — S — 452 (1.49 2.20 1.22) 416 — S — 453 (0.98 0.91 2.51) 416 — S — 454 (0.80 1.07 2.35) 416 — S — 457 (0.94 1.85 1.57)
416 — S — 460 (1.21 2.28 1.14) 416 — S — 461 (0.93 2.04 1.38) 416 — S — 468 (0.82 1.75 1.67) 416 — S — 469 (0.91 2.18 1.24)
416 — S — 471 (1.51 1.51 1.91) 416 — S — 473 (1.56 2.12 1.30) 416 — S — 474 (1.41 2.01 1.41) 417 — S — 9 (1.31 1.59 2.12)
417 — S — 19 (0.88 1.48 2.23) 417 — S — 20 (1.42 2.13 1.58) 417 — S — 27 (1.33 2.30 1.41) 417 — S — 28 (1.40 2.57 1.14)

417 — S — 29 (1.16 2.29 1.42) 417 — S — 40 (0.98 2.29 1.42) 417 — S — 44 (1.05 1.45 2.26) 417 — S — 46 (2.56 2.46 1.25)
417 — S — 56 (1.32 1.76 1.95) 417 — S — 61 (1.30 2.27 1.44) 417 — S — 62 (1.18 2.47 1.24) 417 — S — 65 (1.32 2.07 1.64)
417 — S — 68 (1.03 2.03 1.68) 417 — S — 79 (1.30 2.45 1.26) 417 — S — 80 (1.25 2.40 1.31) 417 — S — 81 (1.33 2.53 1.18)
417 — S — 82 (1.06 2.71 1.00) 417 — S — 83 (1.36 1.70 2.01) 417 — S — 85 (1.81 2.26 1.45) 417 — S — 86 (1.03 2.63 1.08)
417 — S — 90 (1.70 2.73 0.98) 417 — S — 101 (1.45 2.58 1.13) 417 — S — 102 (1.08 1.59 2.12) 417 — S — 105 (1.61 1.68 2.03)
417 — S — 106 (1.03 1.12 2.59) 417 — S — 107 (2.08 2.42 1.29) 417 — S — 108 (1.63 2.81 0.90) 417 — S — 110 (1.37 2.58 1.13)
417 — S — 111 (2.07 1.70 2.01) 417 — S — 112 (1.26 2.08 1.63) 417 — S — 114 (0.91 1.36 2.35) 417 — S — 115 (1.74 2.56 1.15)
417 — S — 118 (1.35 1.98 1.73) 417 — S — 119 (1.32 2.19 1.52) 417 — S — 123 (0.96 2.32 1.39) 417 — S — 127 (0.98 1.00 2.71)
417 — S — 131 (1.38 1.66 2.05) 417 — S — 132 (1.29 1.90 1.81) 417 — S — 133 (2.08 2.71 1.00) 417 — S — 144 (1.41 2.62 1.09)
417 — S — 147 (0.82 2.20 1.52) 417 — S — 148 (1.07 1.49 2.22) 417 — S — 150 (2.90 2.58 1.13) 417 — S — 153 (2.83 2.68 1.03)
417 — S — 154 (2.36 1.81 1.90) 417 — S — 158 (1.43 1.02 2.69) 417 — S — 161 (1.87 1.11 2.60) 417 — S — 166 (2.08 1.64 2.07)
417 — S — 167 (1.95 1.32 2.39) 417 — S — 170 (2.15 1.05 2.66) 417 — S — 171 (1.85 1.63 2.08) 417 — S — 175 (1.08 1.27 2.44)
417 — S — 176 (1.03 1.03 2.68) 417 — S — 177 (1.91 2.36 1.35) 417 — S — 182 (1.05 1.20 2.51) 417 — S — 183 (1.56 2.70 1.01)
417 — S — 184 (2.65 2.17 1.54) 417 — S — 187 (1.79 1.55 2.16) 417 — S — 188 (2.22 1.59 2.12) 417 — S — 189 (1.97 1.17 2.54)
417 — S — 192 (2.25 2.70 1.02) 417 — S — 193 (1.17 1.86 1.85) 417 — S — 194 (2.02 1.30 2.41) 417 — S — 195 (2.08 2.02 1.69)
417 — S — 197 (2.22 1.08 2.63) 417 — S — 198 (1.79 2.08 1.63) 417 — S — 205 (1.31 2.14 1.57) 417 — S — 208 (1.27 1.61 2.10)
417 — S — 209 (1.02 1.69 2.02) 417 — S — 210 (0.91 1.09 2.62) 417 — S — 213 (1.76 2.03 1.68) 417 — S — 214 (1.32 1.27 2.44)
417 — S — 217 (1.18 2.07 1.64) 417 — S — 218 (1.15 2.25 1.47) 417 — S — 219 (0.95 1.80 1.91) 417 — S — 222 (1.06 1.65 2.06)
417 — S — 230 (0.99 1.48 2.23) 417 — S — 231 (2.30 2.81 0.90) 417 — S — 233 (1.68 2.23 1.48) 417 — S — 234 (1.50 2.31 1.40)
417 — S — 236 (1.72 1.20 2.51) 417 — S — 237 (1.51 2.61 1.10) 417 — S — 238 (0.81 2.47 1.24) 417 — S — 240 (1.11 1.10 2.61)
417 — S — 243 (2.25 1.44 2.27) 417 — S — 244 (1.57 2.23 1.49) 417 — S — 245 (1.48 2.00 1.71) 417 — S — 246 (1.82 2.56 1.15)
417 — S — 254 (1.32 1.92 1.79) 417 — S — 255 (2.21 2.78 0.93) 417 — S — 261 (0.95 1.01 2.70) 417 — S — 265 (1.78 2.71 1.00)
417 — S — 266 (1.42 2.28 1.43) 417 — S — 267 (1.22 1.98 1.73) 417 — S — 269 (1.73 2.78 0.93) 417 — S — 272 (1.60 1.33 2.38)
417 — S — 274 (1.09 1.78 1.93) 417 — S — 275 (0.89 2.20 1.51) 417 — S — 276 (1.01 1.19 2.52) 417 — S — 277 (1.31 2.05 1.66)
417 — S — 279 (1.36 2.11 1.60) 417 — S — 280 (1.04 1.79 1.92) 417 — S — 282 (1.16 1.62 2.09) 417 — S — 284 (0.94 1.63 2.08)
417 — S — 285 (1.08 2.00 1.71) 417 — S — 286 (1.34 1.90 1.81) 417 — S — 287 (1.14 1.91 1.80) 417 — S — 288 (1.13 1.85 1.86)
417 — S — 289 (1.39 1.69 2.02) 417 — S — 290 (1.42 2.31 1.40) 417 — S — 291 (2.56 2.72 0.99) 417 — S — 292 (1.89 2.38 1.33)
417 — S — 293 (1.39 2.19 1.52) 417 — S — 294 (1.85 2.22 1.49) 417 — S — 295 (1.60 2.47 1.25) 417 — S — 296 (1.88 2.46 1.25)
417 — S — 297 (1.19 1.59 2.12) 417 — S — 298 (1.45 2.07 1.64) 417 — S — 300 (1.46 1.46 2.25) 417 — S — 301 (1.51 1.18 2.53)
417 — S — 302 (1.63 1.02 2.69) 417 — S — 303 (1.21 1.44 2.27) 417 — S — 304 (1.26 1.91 1.80) 417 — S — 305 (1.77 2.13 1.58)
417 — S — 306 (1.93 2.78 0.93) 417 — S — 308 (1.25 1.07 2.64) 417 — S — 310 (1.37 1.52 2.19) 417 — S — 311 (1.09 1.80 1.91)
417 — S — 312 (1.19 1.67 2.04) 417 — S — 313 (0.97 1.84 1.87) 417 — S — 316 (1.25 2.13 1.58) 417 — S — 318 (1.55 1.17 2.54)
417 — S — 327 (1.54 2.53 1.18) 417 — S — 330 (0.87 1.54 2.17) 417 — S — 331 (1.40 1.71 2.00) 417 — S — 332 (1.26 1.88 1.83)
417 — S — 336 (1.36 1.77 1.94) 417 — S — 341 (0.85 2.40 1.31) 417 — S — 342 (3.30 2.74 0.97) 417 — S — 352 (0.97 1.01 2.70)
417 — S — 353 (0.89 1.05 2.66) 417 — S — 356 (1.02 1.59 2.12) 417 — S — 357 (1.72 1.34 2.37) 417 — S — 358 (1.20 2.05 1.66)
417 — S — 367 (1.83 2.68 1.03) 417 — S — 370 (1.17 2.11 1.60) 417 — S — 372 (1.40 1.81 1.90) 417 — S — 374 (1.01 2.31 1.40)
417 — S — 379 (1.08 1.81 1.90) 417 — S — 380 (0.92 1.23 2.48) 417 — S — 382 (1.15 1.99 1.72) 417 — S — 391 (1.09 1.80 1.91)
417 — S — 394 (0.99 1.09 2.62) 417 — S — 395 (2.02 2.53 1.18) 417 — S — 396 (1.44 1.97 1.74) 417 — S — 397 (1.25 1.81 1.90)
417 — S — 398 (1.15 0.94 2.77) 417 — S — 401 (1.09 0.85 2.86) 417 — S — 403 (1.04 1.06 2.65) 417 — S — 415 (1.14 1.69 2.02)
417 — S — 430 (1.03 2.63 1.08) 417 — S — 432 (1.27 1.30 2.41) 417 — S — 433 (0.98 1.31 2.40) 417 — S — 434 (1.09 2.10 1.61)
417 — S — 435 (1.18 2.27 1.44) 417 — S — 437 (1.36 1.65 2.06) 417 — S — 440 (1.70 2.44 1.27) 417 — S — 441 (1.63 2.36 1.35)
417 — S — 444 (1.17 0.96 2.75) 417 — S — 445 (0.84 0.92 2.79) 417 — S — 446 (0.84 0.92 2.79) 417 — S — 447 (1.64 2.55 1.16)
417 — S — 449 (1.39 2.52 1.19) 417 — S — 450 (1.01 2.19 1.52) 417 — S — 452 (1.78 2.79 0.92) 417 — S — 453 (1.28 1.49 2.22)
417 — S — 454 (1.10 1.66 2.05) 417 — S — 455 (1.08 1.93 1.78) 417 — S — 457 (1.23 2.43 1.28) 417 — S — 459 (1.02 2.66 1.05)
417 — S — 461 (1.22 2.62 1.09) 417 — S — 462 (0.92 2.64 1.07) 417 — S — 467 (0.91 2.03 1.68) 417 — S — 468 (1.11 2.34 1.37)
417 — S — 469 (1.20 2.77 0.95) 417 — S — 471 (1.81 2.10 1.61) 417 — S — 473 (1.86 2.71 1.00) 417 — S — 474 (1.71 2.60 1.11)
418 — S — 9 (1.28 0.94 2.16) 418 — S — 19 (0.85 0.84 2.27) 418 — S — 20 (1.38 1.49 1.62) 418 — S — 27 (1.29 1.65 1.45)
418 — S — 28 (1.36 1.92 1.18) 418 — S — 29 (1.12 1.65 1.46) 418 — S — 40 (0.94 1.65 1.46) 418 — S — 44 (1.01 0.80 2.30)
418 — S — 46 (2.53 1.81 1.29) 418 — S — 56 (1.28 1.12 1.99) 418 — S — 61 (1.27 1.63 1.48) 418 — S — 62 (1.14 1.83 1.28)
418 — S — 65 (1.28 1.42 1.68) 418 — S — 68 (0.99 1.39 1.72) 418 — S — 79 (1.26 1.80 1.30) 418 — S — 80 (1.21 1.76 1.35)
418 — S — 81 (1.29 1.88 1.22) 418 — S — 82 (1.02 2.07 1.04) 418 — S — 83 (1.32 1.06 2.05) 418 — S — 85 (1.78 1.61 1.49)
418 — S — 86 (0.99 1.98 1.12) 418 — S — 90 (1.66 2.09 1.02) 418 — S — 101 (1.41 1.94 1.16) 418 — S — 102 (1.04 0.95 2.16)
418 — S — 105 (1.57 1.04 2.07) 418 — S — 107 (2.04 1.77 1.33) 418 — S — 108 (1.60 2.17 0.94) 418 — S — 110 (1.33 1.94 1.17)
418 — S — 111 (2.03 1.06 2.05) 418 — S — 112 (1.22 1.44 1.67) 418 — S — 115 (1.70 1.91 1.19) 418 — S — 118 (1.31 1.34 1.77)
418 — S — 119 (1.28 1.55 1.55) 418 — S — 123 (0.92 1.68 1.43) 418 — S — 131 (1.34 1.01 2.09) 418 — S — 132 (1.25 1.26 1.85)
418 — S — 133 (2.04 2.06 1.04) 418 — S — 144 (1.37 1.98 1.13) 418 — S — 148 (1.03 0.84 2.26) 418 — S — 150 (2.86 1.94 1.17)
418 — S — 151 (2.77 2.20 0.91) 418 — S — 153 (2.79 2.04 1.07) 418 — S — 154 (2.32 1.17 1.94) 418 — S — 166 (2.04 0.99 2.11)
418 — S — 171 (1.81 0.99 2.11) 418 — S — 177 (1.87 1.72 1.39) 418 — S — 183 (1.52 2.05 1.05) 418 — S — 184 (2.61 1.53 1.57)

418 — S — 187 (1.75 0.90 2.20) 418 — S — 188 (2.18 0.94 2.16) 418 — S — 192 (2.21 2.05 1.05) 418 — S — 193 (1.13 1.21 1.89)
418 — S — 195 (2.04 1.38 1.73) 418 — S — 198 (1.75 1.44 1.67) 418 — S — 205 (1.27 1.50 1.61) 418 — S — 208 (1.23 0.97 2.14)
418 — S — 209 (0.98 1.04 2.06) 418 — S — 213 (1.72 1.39 1.71) 418 — S — 217 (1.14 1.42 1.68) 418 — S — 218 (1.11 1.60 1.50)
418 — S — 219 (0.91 1.16 1.95) 418 — S — 222 (1.02 1.01 2.10) 418 — S — 230 (0.95 0.83 2.27) 418 — S — 231 (2.26 2.16 0.94)
418 — S — 233 (1.64 1.59 1.52) 418 — S — 234 (1.46 1.67 1.44) 418 — S — 237 (1.47 1.97 1.14) 418 — S — 244 (1.53 1.58 1.52)
418 — S — 245 (1.45 1.35 1.75) 418 — S — 246 (1.78 1.92 1.18) 418 — S — 251 (1.29 2.17 0.94) 418 — S — 254 (1.28 1.28 1.83)
418 — S — 255 (2.17 2.14 0.97) 418 — S — 265 (1.74 2.06 1.04) 418 — S — 266 (1.38 1.64 1.47) 418 — S — 267 (1.18 1.34 1.77)
418 — S — 269 (1.69 2.14 0.97) 418 — S — 274 (1.05 1.14 1.97) 418 — S — 275 (0.86 1.56 1.54) 418 — S — 277 (1.27 1.41 1.70)
418 — S — 279 (1.32 1.47 1.64) 418 — S — 280 (1.00 1.15 1.96) 418 — S — 282 (1.12 0.97 2.13) 418 — S — 284 (0.90 0.98 2.12)
418 — S — 285 (1.04 1.35 1.75) 418 — S — 286 (1.30 1.26 1.85) 418 — S — 287 (1.11 1.27 1.84) 418 — S — 288 (1.09 1.21 1.90)
418 — S — 289 (1.35 1.04 2.06) 418 — S — 290 (1.38 1.67 1.43) 418 — S — 291 (2.52 2.08 1.03) 418 — S — 292 (1.85 1.74 1.37)
418 — S — 293 (1.36 1.55 1.56) 418 — S — 294 (1.81 1.58 1.53) 418 — S — 295 (1.56 1.82 1.28) 418 — S — 296 (1.84 1.82 1.29)
418 — S — 297 (1.15 0.95 2.16) 418 — S — 298 (1.41 1.42 1.68) 418 — S — 300 (1.42 0.82 2.28) 418 — S — 304 (1.22 1.27 1.84)
418 — S — 305 (1.73 1.48 1.62) 418 — S — 306 (1.89 2.14 0.97) 418 — S — 310 (1.33 0.88 2.23) 418 — S — 311 (1.05 1.16 1.95)
418 — S — 312 (1.15 1.03 2.08) 418 — S — 313 (0.93 1.20 1.91) 418 — S — 316 (1.22 1.48 1.62) 418 — S — 327 (1.51 1.89 1.22)
418 — S — 330 (0.83 0.89 2.21) 418 — S — 331 (1.37 1.06 2.04) 418 — S — 332 (1.22 1.24 1.87) 418 — S — 336 (1.32 1.13 1.98)
418 — S — 341 (0.82 1.76 1.35) 418 — S — 342 (3.26 2.10 1.01) 418 — S — 356 (0.98 0.94 2.16) 418 — S — 358 (1.16 1.40 1.70)
418 — S — 367 (1.79 2.04 1.07) 418 — S — 370 (1.13 1.47 1.64) 418 — S — 371 (2.95 2.18 0.92) 418 — S — 372 (1.36 1.17 1.94)
418 — S — 374 (0.97 1.66 1.44) 418 — S — 379 (1.04 1.17 1.94) 418 — S — 382 (1.11 1.35 1.76) 418 — S — 391 (1.05 1.15 1.95)
418 — S — 395 (1.98 1.88 1.22) 418 — S — 396 (1.40 1.32 1.78) 418 — S — 397 (1.21 1.17 1.94) 418 — S — 415 (1.10 1.05 2.06)
418 — S — 430 (0.99 1.98 1.12) 418 — S — 434 (1.06 1.46 1.65) 418 — S — 435 (1.14 1.63 1.48) 418 — S — 437 (1.32 1.00 2.10)
418 — S — 440 (1.66 1.79 1.31) 418 — S — 441 (1.60 1.72 1.39) 418 — S — 447 (1.61 1.91 1.20) 418 — S — 449 (1.35 1.88 1.23)
418 — S — 450 (0.97 1.54 1.56) 418 — S — 452 (1.74 2.14 0.96) 418 — S — 453 (1.24 0.85 2.26) 418 — S — 454 (1.06 1.01 2.09)
418 — S — 455 (1.04 1.28 1.82) 418 — S — 457 (1.19 1.79 1.32) 418 — S — 459 (0.98 2.02 1.09) 418 — S — 461 (1.18 1.98 1.13)
418 — S — 462 (0.88 1.99 1.11) 418 — S — 467 (0.87 1.39 1.72) 418 — S — 468 (1.07 1.69 1.41) 418 — S — 469 (1.16 2.12 0.98)
418 — S — 471 (1.77 1.45 1.65) 418 — S — 473 (1.82 2.07 1.04) 418 — S — 474 (1.67 1.95 1.15) 419 — S — 36 (1.02 1.29 1.16)
419 — S — 43 (1.44 1.14 1.31) 419 — S — 70 (1.50 1.35 1.10) 419 — S — 89 (1.26 1.09 1.36) 419 — S — 90 (1.17 0.94 1.51)
419 — S — 108 (1.10 1.02 1.43) 419 — S — 109 (1.34 1.15 1.30) 419 — S — 113 (0.94 1.21 1.24) 419 — S — 133 (1.55 0.92 1.53)
419 — S — 144 (0.88 0.83 1.62) 419 — S — 145 (0.86 1.48 0.97) 419 — S — 151 (2.27 1.05 1.40) 419 — S — 152 (2.92 1.35 1.10)
419 — S — 153 (2.30 0.89 1.56) 419 — S — 183 (1.03 0.91 1.54) 419 — S — 192 (1.72 0.90 1.55) 419 — S — 207 (1.29 1.21 1.24)
419 — S — 215 (1.52 1.47 0.98) 419 — S — 231 (1.77 1.02 1.43) 419 — S — 237 (0.98 0.82 1.63) 419 — S — 248 (1.36 1.32 1.13)
419 — S — 249 (0.83 1.16 1.29) 419 — S — 255 (1.68 0.99 1.46) 419 — S — 260 (0.81 1.44 1.01) 419 — S — 265 (1.25 0.92 1.54)
419 — S — 268 (1.23 1.06 1.39) 419 — S — 269 (1.20 0.99 1.46) 419 — S — 271 (1.94 1.08 1.37) 419 — S — 291 (2.03 0.93 1.52)
419 — S — 306 (1.40 0.99 1.46) 419 — S — 307 (1.13 1.12 1.33) 419 — S — 320 (1.62 1.41 1.04) 419 — S — 329 (1.34 1.20 1.25)
419 — S — 342 (2.77 0.95 1.50) 419 — S — 343 (3.30 1.44 1.01) 419 — S — 367 (1.30 0.89 1.56) 419 — S — 368 (1.41 1.44 1.02)
419 — S — 371 (2.46 1.04 1.41) 419 — S — 451 (1.20 1.34 1.11) 419 — S — 452 (1.25 1.00 1.45) 419 — S — 460 (0.98 1.07 1.38)
419 — S — 463 (1.13 1.44 1.01) 419 — S — 473 (1.33 0.92 1.53) 419 — S — 474 (1.18 0.81 1.64) 420 — S — 125 (1.28 0.91 0.99)
420 — S — 429 (2.19 0.92 0.98) 421 — S — 43 (1.18 2.10 1.57) 421 — S — 46 (1.78 1.62 2.04) 421 — S — 57 (1.45 2.64 1.03)
421 — S — 70 (1.24 2.31 1.36) 421 — S — 85 (1.02 1.43 2.24) 421 — S — 89 (1.00 2.05 1.62) 421 — S — 90 (0.91 1.90 1.77)
421 — S — 105 (0.82 0.85 2.82) 421 — S — 107 (1.29 1.59 2.08) 421 — S — 108 (0.85 1.98 1.69) 421 — S — 109 (1.08 2.11 1.55)
421 — S — 111 (1.28 0.87 2.80) 421 — S — 115 (0.95 1.73 1.94) 421 — S — 133 (1.29 1.88 1.79) 421 — S — 150 (2.11 1.75 1.92)
421 — S — 151 (2.02 2.01 1.66) 421 — S — 152 (2.66 2.31 1.36) 421 — S — 153 (2.04 1.85 1.82) 421 — S — 154 (1.57 0.98 2.69)
421 — S — 165 (0.95 2.73 0.94) 421 — S — 166 (1.29 0.81 2.86) 421 — S — 171 (1.06 0.80 2.87) 421 — S — 177 (1.12 1.53 2.14)
421 — S — 184 (1.86 1.34 2.33) 421 — S — 192 (1.46 1.86 1.80) 421 — S — 195 (1.29 1.19 2.48) 421 — S — 198 (1.00 1.25 2.42)
421 — S — 207 (1.03 2.17 1.50) 421 — S — 213 (0.97 1.20 2.47) 421 — S — 215 (1.27 2.43 1.23) 421 — S — 231 (1.51 1.98 1.69)
421 — S — 233 (0.89 1.40 2.27) 421 — S — 246 (1.03 1.73 1.94) 421 — S — 248 (1.10 2.28 1.39) 421 — S — 255 (1.42 1.95 1.72)
421 — S — 265 (0.99 1.87 1.79) 421 — S — 268 (0.97 2.02 1.65) 421 — S — 269 (0.94 1.95 1.72) 421 — S — 270 (1.08 2.63 1.04)
421 — S — 271 (1.69 2.04 1.62) 421 — S — 291 (1.77 1.89 1.78) 421 — S — 292 (1.10 1.55 2.12) 421 — S — 294 (1.06 1.39 2.28)
421 — S — 295 (0.81 1.63 2.03) 421 — S — 296 (1.09 1.63 2.04) 421 — S — 305 (0.98 1.30 2.37) 421 — S — 306 (1.14 1.95 1.72)
421 — S — 307 (0.87 2.08 1.59) 421 — S — 320 (1.36 2.37 1.30) 421 — S — 329 (1.08 2.16 1.51) 421 — S — 342 (2.51 1.91 1.76)
421 — S — 343 (3.04 2.40 1.27) 421 — S — 364 (1.22 2.53 1.14) 421 — S — 367 (1.04 1.85 1.82) 421 — S — 368 (1.15 2.40 1.27)
421 — S — 371 (2.20 2.00 1.67) 421 — S — 395 (1.23 1.70 1.97) 421 — S — 440 (0.91 1.61 2.06) 421 — S — 441 (0.84 1.53 2.14)
421 — S — 447 (0.86 1.72 1.95) 421 — S — 451 (0.94 2.30 1.37) 421 — S — 452 (0.99 1.96 1.71) 421 — S — 463 (0.87 2.40 1.27)
421 — S — 471 (1.02 1.27 2.40) 421 — S — 472 (1.60 2.68 0.99) 421 — S — 473 (1.07 1.88 1.79) 421 — S — 474 (0.92 1.77 1.90)
422 — S — 27 (0.89 0.91 1.85) 422 — S — 28 (0.96 1.18 1.58) 422 — S — 36 (1.11 1.70 1.07) 422 — S — 43 (1.53 1.55 1.22)
422 — S — 46 (2.13 1.07 1.69) 422 — S — 61 (0.87 0.89 1.88) 422 — S — 70 (1.59 1.76 1.01) 422 — S — 79 (0.86 1.06 1.70)
422 — S — 80 (0.81 1.02 1.75) 422 — S — 81 (0.89 1.14 1.62) 422 — S — 85 (1.37 0.87 1.89) 422 — S — 89 (1.35 1.50 1.27)
422 — S — 90 (1.26 1.35 1.42) 422 — S — 101 (1.01 1.20 1.56) 422 — S — 107 (1.64 1.03 1.73) 422 — S — 108 (1.20 1.43 1.34)

422 — S — 109 (1.43 1.56 1.20) 422 — S — 110 (0.93 1.20 1.57) 422 — S — 113 (1.03 1.61 1.15) 422 — S — 115 (1.30 1.17 1.59)
422 — S — 119 (0.88 0.81 1.96) 422 — S — 133 (1.64 1.32 1.44) 422 — S — 144 (0.97 1.24 1.53) 422 — S — 150 (2.46 1.20 1.57)
422 — S — 151 (2.37 1.46 1.31) 422 — S — 152 (3.01 1.76 1.01) 422 — S — 153 (2.39 1.30 1.47) 422 — S — 177 (1.47 0.98 1.79)
422 — S — 183 (1.12 1.31 1.45) 422 — S — 192 (1.81 1.31 1.45) 422 — S — 206 (0.86 1.67 1.10) 422 — S — 207 (1.38 1.62 1.15)
422 — S — 231 (1.86 1.42 1.34) 422 — S — 233 (1.24 0.85 1.92) 422 — S — 234 (1.06 0.93 1.84) 422 — S — 237 (1.07 1.23 1.54)
422 — S — 244 (1.13 0.84 1.92) 422 — S — 246 (1.38 1.18 1.58) 422 — S — 248 (1.45 1.73 1.04) 422 — S — 249 (0.92 1.57 1.20)
422 — S — 251 (0.89 1.43 1.34) 422 — S — 255 (1.77 1.40 1.37) 422 — S — 258 (0.84 1.84 0.92) 422 — S — 260 (0.90 1.85 0.92)
422 — S — 265 (1.34 1.32 1.44) 422 — S — 266 (0.98 0.90 1.87) 422 — S — 268 (1.32 1.47 1.29) 422 — S — 269 (1.29 1.40 1.37)
422 — S — 271 (2.04 1.49 1.27) 422 — S — 290 (0.98 0.93 1.84) 422 — S — 291 (2.12 1.34 1.43) 422 — S — 292 (1.45 1.00 1.77)
422 — S — 293 (0.96 0.81 1.96) 422 — S — 294 (1.41 0.84 1.93) 422 — S — 295 (1.16 1.08 1.68) 422 — S — 296 (1.44 1.08 1.69)
422 — S — 306 (1.49 1.40 1.37) 422 — S — 307 (1.22 1.53 1.24) 422 — S — 320 (1.71 1.82 0.95) 422 — S — 327 (1.10 1.15 1.62)
422 — S — 329 (1.43 1.60 1.16) 422 — S — 342 (2.86 1.36 1.41) 422 — S — 343 (3.39 1.85 0.92) 422 — S — 367 (1.39 1.30 1.47)
422 — S — 368 (1.50 1.84 0.92) 422 — S — 371 (2.55 1.44 1.32) 422 — S — 395 (1.58 1.14 1.62) 422 — S — 440 (1.26 1.05 1.71)
422 — S — 441 (1.20 0.98 1.79) 422 — S — 447 (1.21 1.17 1.60) 422 — S — 449 (0.95 1.14 1.63) 422 — S — 451 (1.29 1.75 1.02)
422 — S — 452 (1.34 1.40 1.36) 422 — S — 460 (1.07 1.48 1.29) 422 — S — 463 (1.22 1.85 0.92) 422 — S — 473 (1.42 1.33 1.44)
422 — S — 474 (1.27 1.21 1.55) 423 — S — 9 (0.90 1.13 2.54) 423 — S — 20 (1.00 1.67 2.00) 423 — S — 27 (0.91 1.84 1.83)
423 — S — 28 (0.98 2.11 1.56) 423 — S — 36 (1.14 2.62 1.05) 423 — S — 43 (1.55 2.48 1.19) 423 — S — 46 (2.15 2.00 1.67)
423 — S — 56 (0.90 1.30 2.37) 423 — S — 61 (0.89 1.82 1.85) 423 — S — 65 (0.90 1.61 2.06) 423 — S — 70 (1.62 2.69 0.98)
423 — S — 79 (0.88 1.99 1.68) 423 — S — 80 (0.84 1.95 1.72) 423 — S — 81 (0.91 2.07 1.60) 423 — S — 83 (0.94 1.24 2.43)
423 — S — 85 (1.40 1.80 1.87) 423 — S — 89 (1.37 2.43 1.24) 423 — S — 90 (1.28 2.27 1.40) 423 — S — 101 (1.03 2.13 1.54)
423 — S — 105 (1.20 1.22 2.45) 423 — S — 107 (1.66 1.96 1.71) 423 — S — 108 (1.22 2.35 1.32) 423 — S — 109 (1.45 2.49 1.18)
423 — S — 110 (0.95 2.13 1.54) 423 — S — 111 (1.65 1.25 2.42) 423 — S — 112 (0.84 1.62 2.05) 423 — S — 113 (1.05 2.54 1.13)
423 — S — 115 (1.32 2.10 1.57) 423 — S — 118 (0.93 1.52 2.15) 423 — S — 119 (0.91 1.74 1.93) 423 — S — 131 (0.96 1.20 2.47)
423 — S — 132 (0.87 1.44 2.23) 423 — S — 133 (1.66 2.25 1.42) 423 — S — 144 (0.99 2.16 1.51) 423 — S — 150 (2.48 2.12 1.55)
423 — S — 151 (2.39 2.38 1.29) 423 — S — 152 (3.03 2.68 0.99) 423 — S — 153 (2.41 2.23 1.44) 423 — S — 154 (1.95 1.35 2.32)
423 — S — 166 (1.67 1.18 2.49) 423 — S — 167 (1.53 0.87 2.80) 423 — S — 171 (1.44 1.18 2.49) 423 — S — 177 (1.49 1.90 1.77)
423 — S — 183 (1.14 2.24 1.43) 423 — S — 184 (2.23 1.72 1.95) 423 — S — 187 (1.37 1.09 2.58) 423 — S — 188 (1.81 1.13 2.54)
423 — S — 192 (1.84 2.24 1.43) 423 — S — 194 (1.61 0.84 2.83) 423 — S — 195 (1.66 1.56 2.11) 423 — S — 198 (1.37 1.62 2.05)
423 — S — 205 (0.89 1.68 1.99) 423 — S — 206 (0.89 2.59 1.08) 423 — S — 207 (1.41 2.54 1.13) 423 — S — 208 (0.85 1.15 2.52)
423 — S — 213 (1.34 1.58 2.09) 423 — S — 214 (0.90 0.81 2.86) 423 — S — 231 (1.88 2.35 1.32) 423 — S — 233 (1.26 1.77 1.90)
423 — S — 234 (1.08 1.86 1.81) 423 — S — 237 (1.09 2.15 1.52) 423 — S — 243 (1.83 0.98 2.69) 423 — S — 244 (1.15 1.77 1.90)
423 — S — 245 (1.07 1.54 2.13) 423 — S — 246 (1.40 2.11 1.56) 423 — S — 248 (1.47 2.65 1.02) 423 — S — 249 (0.94 2.50 1.17)
423 — S — 251 (0.91 2.35 1.32) 423 — S — 254 (0.90 1.46 2.21) 423 — S — 255 (1.79 2.32 1.34) 423 — S — 258 (0.86 2.77 0.90)
423 — S — 265 (1.36 2.25 1.42) 423 — S — 266 (1.00 1.82 1.85) 423 — S — 267 (0.80 1.52 2.15) 423 — S — 268 (1.34 2.40 1.27)
423 — S — 269 (1.31 2.33 1.34) 423 — S — 271 (2.06 2.42 1.25) 423 — S — 272 (1.18 0.87 2.80) 423 — S — 277 (0.89 1.59 2.08)
423 — S — 279 (0.94 1.66 2.01) 423 — S — 286 (0.92 1.44 2.23) 423 — S — 289 (0.97 1.23 2.44) 423 — S — 290 (1.00 1.86 1.81)
423 — S — 291 (2.14 2.26 1.41) 423 — S — 292 (1.47 1.92 1.75) 423 — S — 293 (0.98 1.73 1.94) 423 — S — 294 (1.43 1.76 1.91)
423 — S — 295 (1.19 2.01 1.66) 423 — S — 296 (1.46 2.00 1.67) 423 — S — 298 (1.03 1.61 2.06) 423 — S — 300 (1.04 1.01 2.66)
423 — S — 304 (0.84 1.45 2.22) 423 — S — 305 (1.35 1.67 2.00) 423 — S — 306 (1.51 2.32 1.35) 423 — S — 307 (1.24 2.45 1.22)
423 — S — 310 (0.95 1.06 2.61) 423 — S — 316 (0.84 1.67 2.00) 423 — S — 320 (1.73 2.74 0.93) 423 — S — 327 (1.13 2.07 1.60)
423 — S — 329 (1.45 2.53 1.14) 423 — S — 331 (0.99 1.25 2.42) 423 — S — 332 (0.84 1.42 2.25) 423 — S — 336 (0.94 1.31 2.36)
423 — S — 342 (2.88 2.28 1.39) 423 — S — 357 (1.30 0.88 2.79) 423 — S — 367 (1.41 2.23 1.44) 423 — S — 368 (1.52 2.77 0.90)
423 — S — 371 (2.57 2.37 1.30) 423 — S — 372 (0.98 1.36 2.31) 423 — S — 395 (1.60 2.07 1.60) 423 — S — 396 (1.03 1.51 2.16)
423 — S — 397 (0.83 1.35 2.32) 423 — S — 432 (0.85 0.85 2.82) 423 — S — 437 (0.94 1.19 2.48) 423 — S — 440 (1.29 1.98 1.69)
423 — S — 441 (1.22 1.91 1.76) 423 — S — 447 (1.23 2.09 1.58) 423 — S — 449 (0.97 2.06 1.61) 423 — S — 451 (1.31 2.67 1.00)
423 — S — 452 (1.37 2.33 1.34) 423 — S — 453 (0.86 1.03 2.64) 423 — S — 457 (0.81 1.97 1.70) 423 — S — 460 (1.09 2.40 1.26)
423 — S — 461 (0.81 2.17 1.50) 423 — S — 471 (1.39 1.64 2.03) 423 — S — 473 (1.44 2.25 1.42) 423 — S — 474 (1.29 2.14 1.53)
424 — S — 9 (0.98 1.24 2.46) 424 — S — 20 (1.08 1.79 1.92) 424 — S — 27 (0.99 1.95 1.75) 424 — S — 28 (1.06 2.22 1.48)
424 — S — 29 (0.82 1.95 1.76) 424 — S — 36 (1.21 2.73 0.97) 424 — S — 43 (1.63 2.59 1.12) 424 — S — 46 (2.23 2.11 1.59)
424 — S — 56 (0.98 1.42 2.29) 424 — S — 61 (0.97 1.93 1.78) 424 — S — 62 (0.84 2.13 1.58) 424 — S — 65 (0.98 1.72 1.98)
424 — S — 70 (1.69 2.80 0.90) 424 — S — 79 (0.96 2.10 1.60) 424 — S — 80 (0.91 2.06 1.65) 424 — S — 81 (0.99 2.18 1.52)
424 — S — 83 (1.02 1.36 2.35) 424 — S — 85 (1.48 1.91 1.79) 424 — S — 89 (1.45 2.54 1.17) 424 — S — 90 (1.36 2.39 1.32)
424 — S — 101 (1.11 2.24 1.46) 424 — S — 105 (1.27 1.34 2.37) 424 — S — 107 (1.74 2.07 1.63) 424 — S — 108 (1.30 2.47 1.24)
424 — S — 109 (1.53 2.60 1.10) 424 — S — 110 (1.03 2.24 1.47) 424 — S — 111 (1.73 1.36 2.35) 424 — S — 112 (0.92 1.74 1.97)
424 — S — 113 (1.13 2.65 1.05) 424 — S — 115 (1.40 2.21 1.49) 424 — S — 118 (1.01 1.63 2.07) 424 — S — 119 (0.98 1.85 1.85)
424 — S — 131 (1.04 1.31 2.39) 424 — S — 132 (0.95 1.56 2.15) 424 — S — 133 (1.74 2.36 1.34) 424 — S — 144 (1.07 2.27 1.43)
424 — S — 150 (2.56 2.24 1.47) 424 — S — 151 (2.47 2.50 1.21) 424 — S — 152 (3.11 2.79 0.91) 424 — S — 153 (2.49 2.34 1.37)
424 — S — 154 (2.02 1.47 2.24) 424 — S — 166 (1.74 1.29 2.41) 424 — S — 167 (1.61 0.98 2.73) 424 — S — 171 (1.51 1.29 2.41)

424 — S — 177 (1.57 2.02 1.69) 424 — S — 183 (1.22 2.35 1.35) 424 — S — 184 (2.31 1.83 1.88) 424 — S — 187 (1.45 1.20 2.50)
424 — S — 188 (1.88 1.24 2.46) 424 — S — 189 (1.63 0.83 2.88) 424 — S — 192 (1.91 2.35 1.35) 424 — S — 193 (0.83 1.51 2.19)
424 — S — 194 (1.68 0.95 2.75) 424 — S — 195 (1.74 1.67 2.03) 424 — S — 198 (1.45 1.73 1.97) 424 — S — 205 (0.97 1.79 1.91)
424 — S — 206 (0.96 2.71 1.00) 424 — S — 207 (1.48 2.65 1.05) 424 — S — 208 (0.93 1.27 2.44) 424 — S — 213 (1.42 1.69 2.01)
424 — S — 214 (0.98 0.92 2.78) 424 — S — 217 (0.84 1.72 1.98) 424 — S — 218 (0.81 1.90 1.80) 424 — S — 231 (1.96 2.46 1.24)
424 — S — 233 (1.34 1.89 1.82) 424 — S — 234 (1.16 1.97 1.74) 424 — S — 236 (1.38 0.85 2.85) 424 — S — 237 (1.17 2.26 1.44)
424 — S — 243 (1.91 1.10 2.61) 424 — S — 244 (1.23 1.88 1.82) 424 — S — 245 (1.15 1.65 2.05) 424 — S — 246 (1.48 2.22 1.48)
424 — S — 248 (1.55 2.77 0.94) 424 — S — 249 (1.02 2.61 1.10) 424 — S — 251 (0.99 2.47 1.24) 424 — S — 254 (0.98 1.58 2.13)
424 — S — 255 (1.87 2.44 1.27) 424 — S — 265 (1.44 2.36 1.34) 424 — S — 266 (1.08 1.94 1.77) 424 — S — 267 (0.88 1.64 2.07)
424 — S — 268 (1.42 2.51 1.19) 424 — S — 269 (1.39 2.44 1.27) 424 — S — 271 (2.14 2.53 1.17) 424 — S — 272 (1.26 0.98 2.72)
424 — S — 277 (0.97 1.71 2.00) 424 — S — 279 (1.02 1.77 1.94) 424 — S — 282 (0.82 1.27 2.43) 424 — S — 286 (1.00 1.55 2.15)
424 — S — 287 (0.81 1.57 2.14) 424 — S — 289 (1.05 1.34 2.36) 424 — S — 290 (1.08 1.97 1.74) 424 — S — 291 (2.22 2.38 1.33)
424 — S — 292 (1.55 2.03 1.67) 424 — S — 293 (1.06 1.84 1.86) 424 — S — 294 (1.51 1.88 1.83) 424 — S — 295 (1.26 2.12 1.58)
424 — S — 296 (1.54 2.12 1.59) 424 — S — 297 (0.85 1.25 2.46) 424 — S — 298 (1.11 1.72 1.98) 424 — S — 300 (1.12 1.12 2.58)
424 — S — 301 (1.17 0.83 2.87) 424 — S — 303 (0.88 1.09 2.61) 424 — S — 304 (0.92 1.57 2.14) 424 — S — 305 (1.43 1.78 1.92)
424 — S — 306 (1.59 2.44 1.27) 424 — S — 307 (1.32 2.57 1.14) 424 — S — 310 (1.03 1.18 2.53) 424 — S — 312 (0.85 1.33 2.38)
424 — S — 316 (0.92 1.78 1.92) 424 — S — 318 (1.21 0.82 2.88) 424 — S — 327 (1.20 2.18 1.52) 424 — S — 329 (1.53 2.64 1.06)
424 — S — 331 (1.06 1.36 2.34) 424 — S — 332 (0.92 1.54 2.17) 424 — S — 336 (1.02 1.43 2.28) 424 — S — 342 (2.96 2.39 1.31)
424 — S — 357 (1.38 0.99 2.71) 424 — S — 358 (0.86 1.70 2.00) 424 — S — 367 (1.49 2.34 1.37) 424 — S — 370 (0.83 1.77 1.94)
424 — S — 371 (2.65 2.48 1.22) 424 — S — 372 (1.06 1.47 2.24) 424 — S — 382 (0.81 1.65 2.06) 424 — S — 395 (1.68 2.18 1.52)
424 — S — 396 (1.10 1.62 2.08) 424 — S — 397 (0.91 1.47 2.24) 424 — S — 420 (0.86 2.66 1.04) 424 — S — 432 (0.93 0.96 2.75)
424 — S — 435 (0.84 1.93 1.78) 424 — S — 437 (1.02 1.30 2.40) 424 — S — 440 (1.36 2.09 1.61) 424 — S — 441 (1.30 2.02 1.69)
424 — S — 447 (1.31 2.21 1.50) 424 — S — 449 (1.05 2.18 1.53) 424 — S — 451 (1.39 2.79 0.92) 424 — S — 452 (1.44 2.44 1.26)
424 — S — 453 (0.94 1.15 2.56) 424 — S — 457 (0.89 2.09 1.62) 424 — S — 460 (1.17 2.52 1.19) 424 — S — 461 (0.88 2.28 1.43)
424 — S — 469 (0.86 2.42 1.28) 424 — S — 471 (1.47 1.75 1.95) 424 — S — 473 (1.52 2.36 1.34) 424 — S — 474 (1.37 2.25 1.45)
425 — S — 11 (1.08 0.97 1.22) 425 — S — 20 (2.08 1.27 0.92) 425 — S — 38 (1.44 0.87 1.32) 425 — S — 45 (1.11 1.08 1.11)
425 — S — 47 (0.96 0.90 1.28) 425 — S — 48 (1.03 0.93 1.25) 425 — S — 56 (1.98 0.90 1.29) 425 — S — 65 (1.98 1.21 0.98)
425 — S — 68 (1.69 1.17 1.02) 425 — S — 83 (2.02 0.84 1.35) 425 — S — 96 (1.06 1.20 0.99) 425 — S — 105 (2.27 0.82 1.37)
425 — S — 111 (2.73 0.84 1.34) 425 — S — 112 (1.92 1.22 0.97) 425 — S — 118 (2.01 1.12 1.07) 425 — S — 132 (1.95 1.04 1.15)
425 — S — 154 (3.02 0.95 1.24) 425 — S — 193 (1.83 1.00 1.19) 425 — S — 195 (2.74 1.16 1.03) 425 — S — 198 (2.45 1.22 0.97)
425 — S — 205 (1.97 1.28 0.91) 425 — S — 209 (1.68 0.83 1.36) 425 — S — 211 (1.03 1.00 1.19) 425 — S — 213 (2.42 1.18 1.01)
425 — S — 217 (1.84 1.21 0.98) 425 — S — 219 (1.61 0.94 1.25) 425 — S — 228 (1.35 0.94 1.25) 425 — S — 245 (2.15 1.14 1.05)
425 — S — 254 (1.98 1.06 1.13) 425 — S — 267 (1.88 1.12 1.07) 425 — S — 274 (1.75 0.92 1.26) 425 — S — 277 (1.97 1.19 1.00)
425 — S — 279 (2.02 1.25 0.93) 425 — S — 280 (1.70 0.93 1.26) 425 — S — 285 (1.75 1.14 1.05) 425 — S — 286 (2.00 1.04 1.15)
425 — S — 287 (1.81 1.05 1.14) 425 — S — 288 (1.79 0.99 1.20) 425 — S — 289 (2.05 0.83 1.36) 425 — S — 298 (2.11 1.21 0.98)
425 — S — 304 (1.92 1.05 1.14) 425 — S — 305 (2.43 1.27 0.92) 425 — S — 311 (1.75 0.94 1.25) 425 — S — 312 (1.85 0.81 1.38)
425 — S — 313 (1.63 0.98 1.21) 425 — S — 316 (1.92 1.27 0.92) 425 — S — 319 (1.12 1.13 1.06) 425 — S — 325 (0.96 1.06 1.13)
425 — S — 331 (2.07 0.85 1.34) 425 — S — 332 (1.92 1.02 1.17) 425 — S — 336 (2.02 0.91 1.28) 425 — S — 358 (1.86 1.19 1.00)
425 — S — 370 (1.83 1.25 0.94) 425 — S — 372 (2.06 0.95 1.23) 425 — S — 373 (1.45 0.96 1.23) 425 — S — 379 (1.74 0.95 1.24)
425 — S — 381 (1.31 1.12 1.07) 425 — S — 382 (1.81 1.13 1.06) 425 — S — 391 (1.75 0.94 1.25) 425 — S — 396 (2.11 1.11 1.08)
425 — S — 397 (1.91 0.95 1.24) 425 — S — 415 (1.80 0.83 1.36) 425 — S — 419 (1.19 0.93 1.26) 425 — S — 434 (1.76 1.24 0.95)
425 — S — 455 (1.75 1.07 1.12) 425 — S — 464 (0.80 1.25 0.94) 425 — S — 467 (1.58 1.17 1.02) 425 — S — 471 (2.47 1.24 0.95)
425 — S — 475 (1.31 0.86 1.33) 425 — S — 476 (0.99 0.89 1.30) 426 — S — 9 (0.95 0.96 2.49) 426 — S — 20 (1.05 1.50 1.94)
426 — S — 27 (0.97 1.67 1.77) 426 — S — 28 (1.03 1.94 1.51) 426 — S — 36 (1.19 2.45 0.99) 426 — S — 43 (1.61 2.31 1.14)
426 — S — 46 (2.20 1.83 1.62) 426 — S — 56 (0.96 1.13 2.31) 426 — S — 61 (0.94 1.64 1.80) 426 — S — 62 (0.82 1.84 1.60)
426 — S — 65 (0.95 1.44 2.00) 426 — S — 70 (1.67 2.52 0.93) 426 — S — 79 (0.94 1.82 1.63) 426 — S — 80 (0.89 1.77 1.67)
426 — S — 81 (0.96 1.90 1.55) 426 — S — 83 (1.00 1.07 2.37) 426 — S — 85 (1.45 1.63 1.82) 426 — S — 89 (1.42 2.25 1.19)
426 — S — 90 (1.33 2.10 1.34) 426 — S — 101 (1.09 1.96 1.49) 426 — S — 105 (1.25 1.05 2.39) 426 — S — 107 (1.71 1.79 1.66)
426 — S — 108 (1.27 2.18 1.26) 426 — S — 109 (1.51 2.32 1.13) 426 — S — 110 (1.00 1.95 1.49) 426 — S — 111 (1.71 1.07 2.37)
426 — S — 112 (0.90 1.45 1.99) 426 — S — 113 (1.11 2.37 1.07) 426 — S — 115 (1.38 1.93 1.52) 426 — S — 118 (0.99 1.35 2.09)
426 — S — 119 (0.96 1.57 1.88) 426 — S — 131 (1.01 1.03 2.42) 426 — S — 132 (0.92 1.27 2.17) 426 — S — 133 (1.71 2.08 1.36)
426 — S — 144 (1.05 1.99 1.45) 426 — S — 150 (2.53 1.95 1.49) 426 — S — 151 (2.44 2.21 1.23) 426 — S — 152 (3.09 2.51 0.93)
426 — S — 153 (2.47 2.05 1.39) 426 — S — 154 (2.00 1.18 2.26) 426 — S — 166 (1.72 1.01 2.44) 426 — S — 171 (1.49 1.01 2.44)
426 — S — 177 (1.55 1.73 1.71) 426 — S — 183 (1.19 2.07 1.38) 426 — S — 184 (2.28 1.55 1.90) 426 — S — 187 (1.43 0.92 2.53)
426 — S — 188 (1.86 0.96 2.49) 426 — S — 192 (1.89 2.07 1.38) 426 — S — 193 (0.81 1.23 2.22) 426 — S — 195 (1.71 1.39 2.05)
426 — S — 198 (1.42 1.45 1.99) 426 — S — 205 (0.94 1.51 1.93) 426 — S — 206 (0.94 2.42 1.02) 426 — S — 207 (1.46 2.37 1.07)
426 — S — 208 (0.91 0.98 2.46) 426 — S — 213 (1.39 1.41 2.04) 426 — S — 217 (0.82 1.44 2.01) 426 — S — 231 (1.93 2.18 1.27)
426 — S — 233 (1.32 1.60 1.84) 426 — S — 234 (1.14 1.68 1.76) 426 — S — 237 (1.15 1.98 1.46) 426 — S — 243 (1.89 0.81 2.63)

426 — S — 244 (1.20 1.60 1.85) 426 — S — 245 (1.12 1.37 2.08) 426 — S — 246 (1.46 1.94 1.51) 426 — S — 248 (1.52 2.48 0.96)
426 — S — 249 (1.00 2.32 1.12) 426 — S — 251 (0.96 2.18 1.26) 426 — S — 254 (0.96 1.29 2.15) 426 — S — 255 (1.85 2.15 1.29)
426 — S — 265 (1.42 2.08 1.37) 426 — S — 266 (1.06 1.65 1.79) 426 — S — 267 (0.86 1.35 2.09) 426 — S — 268 (1.40 2.23 1.22)
426 — S — 269 (1.36 2.15 1.29) 426 — S — 271 (2.11 2.25 1.20) 426 — S — 277 (0.94 1.42 2.02) 426 — S — 279 (1.00 1.48 1.96)
426 — S — 286 (0.97 1.27 2.17) 426 — S — 289 (1.03 1.06 2.39) 426 — S — 290 (1.06 1.69 1.76) 426 — S — 291 (2.19 2.09 1.35)
426 — S — 292 (1.53 1.75 1.69) 426 — S — 293 (1.03 1.56 1.88) 426 — S — 294 (1.49 1.59 1.85) 426 — S — 295 (1.24 1.84 1.61)
426 — S — 296 (1.52 1.83 1.61) 426 — S — 297 (0.83 0.96 2.48) 426 — S — 298 (1.09 1.44 2.01) 426 — S — 300 (1.09 0.84 2.61)
426 — S — 303 (0.85 0.81 2.64) 426 — S — 304 (0.89 1.28 2.16) 426 — S — 305 (1.41 1.50 1.95) 426 — S — 306 (1.57 2.15 1.29)
426 — S — 307 (1.30 2.28 1.16) 426 — S — 310 (1.01 0.89 2.55) 426 — S — 312 (0.83 1.04 2.40) 426 — S — 316 (0.89 1.50 1.95)
426 — S — 327 (1.18 1.90 1.54) 426 — S — 329 (1.51 2.36 1.08) 426 — S — 331 (1.04 1.08 2.37) 426 — S — 332 (0.89 1.25 2.19)
426 — S — 336 (0.99 1.14 2.30) 426 — S — 342 (2.94 2.11 1.33) 426 — S — 358 (0.84 1.42 2.03) 426 — S — 367 (1.46 2.05 1.39)
426 — S — 370 (0.81 1.48 1.96) 426 — S — 371 (2.62 2.20 1.25) 426 — S — 372 (1.03 1.18 2.26) 426 — S — 395 (1.65 1.90 1.55)
426 — S — 396 (1.08 1.34 2.11) 426 — S — 397 (0.88 1.18 2.26) 426 — S — 420 (0.83 2.38 1.07) 426 — S — 435 (0.82 1.64 1.80)
426 — S — 437 (1.00 1.02 2.43) 426 — S — 440 (1.34 1.81 1.64) 426 — S — 441 (1.27 1.73 1.71) 426 — S — 447 (1.28 1.92 1.52)
426 — S — 449 (1.02 1.89 1.55) 426 — S — 451 (1.36 2.50 0.94) 426 — S — 452 (1.42 2.16 1.29) 426 — S — 453 (0.91 0.86 2.58)
426 — S — 457 (0.87 1.80 1.64) 426 — S — 460 (1.15 2.23 1.21) 426 — S — 461 (0.86 1.99 1.45) 426 — S — 469 (0.84 2.14 1.31)
426 — S — 471 (1.45 1.47 1.98) 426 — S — 473 (1.49 2.08 1.36) 426 — S — 474 (1.35 1.97 1.48) 427 — S — 9 (1.26 1.24 2.18)
427 — S — 19 (0.83 1.13 2.28) 427 — S — 20 (1.37 1.78 1.63) 427 — S — 27 (1.28 1.95 1.46) 427 — S — 28 (1.34 2.22 1.19)
427 — S — 29 (1.10 1.94 1.47) 427 — S — 40 (0.93 1.94 1.47) 427 — S — 44 (0.99 1.10 2.31) 427 — S — 46 (2.51 2.11 1.31)
427 — S — 56 (1.27 1.41 2.00) 427 — S — 61 (1.25 1.93 1.49) 427 — S — 62 (1.13 2.12 1.29) 427 — S — 65 (1.26 1.72 1.69)
427 — S — 68 (0.97 1.68 1.73) 427 — S — 79 (1.25 2.10 1.32) 427 — S — 80 (1.20 2.05 1.36) 427 — S — 81 (1.28 2.18 1.24)
427 — S — 82 (1.01 2.36 1.05) 427 — S — 83 (1.31 1.35 2.06) 427 — S — 85 (1.76 1.91 1.51) 427 — S — 86 (0.98 2.28 1.14)
427 — S — 90 (1.65 2.38 1.03) 427 — S — 101 (1.40 2.24 1.18) 427 — S — 102 (1.02 1.24 2.17) 427 — S — 105 (1.56 1.33 2.08)
427 — S — 107 (2.02 2.07 1.34) 427 — S — 108 (1.58 2.46 0.95) 427 — S — 110 (1.31 2.24 1.18) 427 — S — 111 (2.02 1.36 2.06)
427 — S — 112 (1.21 1.73 1.68) 427 — S — 114 (0.86 1.01 2.41) 427 — S — 115 (1.69 2.21 1.20) 427 — S — 118 (1.30 1.63 1.78)
427 — S — 119 (1.27 1.85 1.57) 427 — S — 123 (0.91 1.97 1.44) 427 — S — 131 (1.32 1.31 2.11) 427 — S — 132 (1.24 1.55 1.86)
427 — S — 133 (2.02 2.36 1.05) 427 — S — 144 (1.36 2.27 1.14) 427 — S — 148 (1.02 1.14 2.27) 427 — S — 150 (2.85 2.23 1.18)
427 — S — 151 (2.75 2.49 0.92) 427 — S — 153 (2.78 2.33 1.08) 427 — S — 154 (2.31 1.46 1.95) 427 — S — 166 (2.03 1.29 2.12)
427 — S — 167 (1.89 0.97 2.44) 427 — S — 171 (1.80 1.29 2.13) 427 — S — 175 (1.03 0.93 2.49) 427 — S — 177 (1.86 2.01 1.40)
427 — S — 182 (1.00 0.85 2.56) 427 — S — 183 (1.51 2.35 1.06) 427 — S — 184 (2.59 1.83 1.59) 427 — S — 187 (1.74 1.20 2.22)
427 — S — 188 (2.17 1.24 2.18) 427 — S — 189 (1.92 0.83 2.59) 427 — S — 192 (2.20 2.35 1.07) 427 — S — 193 (1.12 1.51 1.90)
427 — S — 194 (1.97 0.95 2.46) 427 — S — 195 (2.03 1.67 1.74) 427 — S — 198 (1.74 1.73 1.68) 427 — S — 205 (1.26 1.79 1.62)
427 — S — 208 (1.22 1.26 2.15) 427 — S — 209 (0.97 1.34 2.07) 427 — S — 213 (1.70 1.69 1.73) 427 — S — 214 (1.26 0.92 2.49)
427 — S — 217 (1.13 1.72 1.69) 427 — S — 218 (1.10 1.90 1.52) 427 — S — 219 (0.90 1.45 1.96) 427 — S — 222 (1.01 1.30 2.11)
427 — S — 230 (0.94 1.13 2.29) 427 — S — 231 (2.24 2.46 0.95) 427 — S — 233 (1.63 1.88 1.53) 427 — S — 234 (1.45 1.96 1.45)
427 — S — 236 (1.67 0.85 2.56) 427 — S — 237 (1.46 2.26 1.15) 427 — S — 243 (2.20 1.09 2.32) 427 — S — 244 (1.51 1.88 1.54)
427 — S — 245 (1.43 1.65 1.76) 427 — S — 246 (1.77 2.22 1.20) 427 — S — 251 (1.28 2.46 0.95) 427 — S — 254 (1.27 1.57 1.84)
427 — S — 255 (2.16 2.43 0.98) 427 — S — 265 (1.73 2.36 1.06) 427 — S — 266 (1.37 1.93 1.48) 427 — S — 267 (1.17 1.63 1.78)
427 — S — 268 (1.71 2.51 0.91) 427 — S — 269 (1.67 2.43 0.98) 427 — S — 272 (1.55 0.98 2.43) 427 — S — 274 (1.04 1.44 1.98)
427 — S — 275 (0.84 1.86 1.56) 427 — S — 276 (0.96 0.84 2.57) 427 — S — 277 (1.25 1.70 1.71) 427 — S — 279 (1.31 1.76 1.65)
427 — S — 280 (0.99 1.44 1.97) 427 — S — 282 (1.11 1.27 2.14) 427 — S — 284 (0.89 1.28 2.14) 427 — S — 285 (1.03 1.65 1.77)
427 — S — 286 (1.28 1.55 1.86) 427 — S — 287 (1.09 1.56 1.85) 427 — S — 288 (1.08 1.50 1.91) 427 — S — 289 (1.34 1.34 2.07)
427 — S — 290 (1.37 1.97 1.45) 427 — S — 291 (2.51 2.37 1.04) 427 — S — 292 (1.84 2.03 1.38) 427 — S — 293 (1.34 1.84 1.57)
427 — S — 294 (1.80 1.87 1.54) 427 — S — 295 (1.55 2.12 1.30) 427 — S — 296 (1.83 2.11 1.30) 427 — S — 297 (1.14 1.24 2.17)
427 — S — 298 (1.40 1.72 1.70) 427 — S — 300 (1.40 1.12 2.30) 427 — S — 301 (1.46 0.83 2.59) 427 — S — 303 (1.16 1.09 2.32)
427 — S — 304 (1.20 1.56 1.85) 427 — S — 305 (1.72 1.78 1.63) 427 — S — 306 (1.88 2.43 0.98) 427 — S — 310 (1.32 1.17 2.24)
427 — S — 311 (1.04 1.45 1.96) 427 — S — 312 (1.14 1.32 2.09) 427 — S — 313 (0.92 1.49 1.92) 427 — S — 316 (1.20 1.78 1.64)
427 — S — 318 (1.50 0.82 2.59) 427 — S — 327 (1.49 2.18 1.23) 427 — S — 330 (0.82 1.19 2.23) 427 — S — 331 (1.35 1.36 2.05)
427 — S — 332 (1.21 1.53 1.88) 427 — S — 336 (1.31 1.42 1.99) 427 — S — 341 (0.80 2.05 1.36) 427 — S — 342 (3.25 2.39 1.02)
427 — S — 356 (0.97 1.24 2.17) 427 — S — 357 (1.67 0.99 2.43) 427 — S — 358 (1.15 1.70 1.72) 427 — S — 367 (1.77 2.33 1.08)
427 — S — 370 (1.12 1.76 1.65) 427 — S — 371 (2.94 2.48 0.93) 427 — S — 372 (1.35 1.46 1.95) 427 — S — 374 (0.96 1.96 1.46)
427 — S — 379 (1.03 1.46 1.95) 427 — S — 380 (0.87 0.88 2.53) 427 — S — 382 (1.10 1.64 1.77) 427 — S — 391 (1.04 1.45 1.97)
427 — S — 395 (1.97 2.18 1.23) 427 — S — 396 (1.39 1.62 1.80) 427 — S — 397 (1.20 1.46 1.95) 427 — S — 415 (1.09 1.34 2.07)
427 — S — 430 (0.98 2.28 1.13) 427 — S — 432 (1.21 0.95 2.46) 427 — S — 433 (0.93 0.97 2.45) 427 — S — 434 (1.04 1.75 1.66)
427 — S — 435 (1.13 1.92 1.49) 427 — S — 437 (1.31 1.30 2.12) 427 — S — 440 (1.65 2.09 1.32) 427 — S — 441 (1.58 2.02 1.40)
427 — S — 447 (1.59 2.20 1.21) 427 — S — 449 (1.33 2.17 1.24) 427 — S — 450 (0.96 1.84 1.58) 427 — S — 452 (1.73 2.44 0.98)
427 — S — 453 (1.22 1.14 2.27) 427 — S — 454 (1.05 1.31 2.11) 427 — S — 455 (1.03 1.58 1.84) 427 — S — 457 (1.18 2.08 1.33)
427 — S — 459 (0.97 2.32 1.10) 427 — S — 461 (1.17 2.27 1.14) 427 — S — 462 (0.87 2.29 1.12) 427 — S — 467 (0.86 1.68 1.73)

427 — S — 468 (1.06 1.99 1.42) 427 — S — 469 (1.15 2.42 1.00) 427 — S — 471 (1.76 1.75 1.67) 427 — S — 473 (1.80 2.36 1.05) 427 — S — 474 (1.66 2.25 1.16) 428 — S — 11 (0.83 0.97 1.47) 428 — S — 20 (1.82 1.28 1.17) 428 — S — 27 (1.74 1.44 1.00) 428 — S — 29 (1.56 1.44 1.01) 428 — S — 38 (1.18 0.87 1.58) 428 — S — 40 (1.38 1.43 1.01) 428 — S — 45 (0.85 1.08 1.37) 428 — S — 56 (1.73 0.91 1.54) 428 — S — 61 (1.71 1.42 1.03) 428 — S — 65 (1.72 1.21 1.23) 428 — S — 68 (1.43 1.18 1.27) 428 — S — 83 (1.77 0.85 1.60) 428 — S — 85 (2.22 1.40 1.05) 428 — S — 96 (0.80 1.20 1.24) 428 — S — 105 (2.02 0.83 1.62) 428 — S — 111 (2.48 0.85 1.60) 428 — S — 112 (1.67 1.23 1.22) 428 — S — 118 (1.76 1.12 1.32) 428 — S — 119 (1.73 1.34 1.11) 428 — S — 123 (1.37 1.47 0.98) 428 — S — 131 (1.78 0.80 1.65) 428 — S — 132 (1.69 1.05 1.40) 428 — S — 147 (1.22 1.34 1.11) 428 — S — 154 (2.77 0.96 1.49) 428 — S — 177 (2.32 1.51 0.94) 428 — S — 184 (3.05 1.32 1.13) 428 — S — 193 (1.58 1.00 1.45) 428 — S — 195 (2.48 1.16 1.28) 428 — S — 198 (2.20 1.22 1.22) 428 — S — 205 (1.72 1.28 1.16) 428 — S — 209 (1.43 0.83 1.61) 428 — S — 213 (2.16 1.18 1.27) 428 — S — 217 (1.59 1.21 1.24) 428 — S — 218 (1.56 1.39 1.06) 428 — S — 219 (1.36 0.95 1.50) 428 — S — 228 (1.10 0.95 1.50) 428 — S — 233 (2.09 1.38 1.07) 428 — S — 234 (1.91 1.46 0.99) 428 — S — 244 (1.97 1.37 1.08) 428 — S — 245 (1.89 1.14 1.30) 428 — S — 254 (1.73 1.07 1.38) 428 — S — 266 (1.83 1.43 1.02) 428 — S — 267 (1.63 1.13 1.32) 428 — S — 274 (1.49 0.93 1.52) 428 — S — 275 (1.30 1.35 1.10) 428 — S — 277 (1.71 1.20 1.25) 428 — S — 279 (1.77 1.26 1.19) 428 — S — 280 (1.45 0.94 1.51) 428 — S — 285 (1.49 1.14 1.31) 428 — S — 286 (1.74 1.04 1.40) 428 — S — 287 (1.55 1.06 1.39) 428 — S — 288 (1.54 0.99 1.45) 428 — S — 289 (1.80 0.83 1.61) 428 — S — 290 (1.83 1.46 0.99) 428 — S — 292 (2.30 1.52 0.92) 428 — S — 293 (1.80 1.33 1.11) 428 — S — 294 (2.26 1.37 1.08) 428 — S — 298 (1.86 1.21 1.24) 428 — S — 304 (1.66 1.06 1.39) 428 — S — 305 (2.18 1.27 1.17) 428 — S — 311 (1.50 0.94 1.50) 428 — S — 312 (1.60 0.82 1.63) 428 — S — 313 (1.38 0.98 1.46) 428 — S — 316 (1.66 1.27 1.18) 428 — S — 319 (0.86 1.13 1.32) 428 — S — 331 (1.81 0.85 1.60) 428 — S — 332 (1.66 1.03 1.42) 428 — S — 336 (1.77 0.92 1.53) 428 — S — 341 (1.26 1.54 0.90) 428 — S — 358 (1.61 1.19 1.26) 428 — S — 370 (1.58 1.26 1.19) 428 — S — 372 (1.81 0.96 1.49) 428 — S — 373 (1.20 0.96 1.48) 428 — S — 374 (1.42 1.45 1.00) 428 — S — 378 (0.93 0.80 1.64) 428 — S — 379 (1.49 0.95 1.49) 428 — S — 381 (1.06 1.12 1.32) 428 — S — 382 (1.56 1.14 1.31) 428 — S — 391 (1.50 0.94 1.51) 428 — S — 396 (1.85 1.11 1.34) 428 — S — 397 (1.65 0.96 1.49) 428 — S — 415 (1.55 0.84 1.61) 428 — S — 419 (0.94 0.94 1.51) 428 — S — 434 (1.50 1.25 1.20) 428 — S — 435 (1.59 1.42 1.03) 428 — S — 441 (2.04 1.51 0.94) 428 — S — 450 (1.42 1.33 1.12) 428 — S — 454 (1.51 0.80 1.65) 428 — S — 455 (1.49 1.07 1.38) 428 — S — 458 (1.18 1.37 1.08) 428 — S — 467 (1.32 1.18 1.27) 428 — S — 468 (1.52 1.48 0.97) 428 — S — 471 (2.22 1.24 1.21) 428 — S — 475 (1.06 0.86 1.58) 430 — S — 57 (1.21 0.84 1.27) 430 — S — 247 (0.93 1.14 0.97) 430 — S — 259 (1.04 0.97 1.14) 430 — S — 270 (0.84 0.83 1.28) 430 — S — 324 (1.10 1.06 1.05) 430 — S — 472 (1.36 0.88 1.23) 432 — S — 46 (1.30 1.15 2.52) 432 — S — 57 (0.97 2.17 1.50) 432 — S — 107 (0.81 1.12 2.56) 432 — S — 125 (1.21 2.62 1.06) 432 — S — 133 (0.81 1.41 2.27) 432 — S — 150 (1.63 1.28 2.39) 432 — S — 151 (1.54 1.54 2.14) 432 — S — 152 (2.18 1.84 1.84) 432 — S — 153 (1.56 1.38 2.29) 432 — S — 184 (1.38 0.87 2.80) 432 — S — 192 (0.99 1.39 2.28) 432 — S — 231 (1.03 1.50 2.17) 432 — S — 250 (0.98 2.75 0.93) 432 — S — 255 (0.95 1.48 2.19) 432 — S — 259 (0.80 2.30 1.38) 432 — S — 271 (1.21 1.57 2.10) 432 — S — 291 (1.29 1.42 2.26) 432 — S — 320 (0.89 1.90 1.78) 432 — S — 324 (0.86 2.39 1.28) 432 — S — 342 (2.03 1.44 2.24) 432 — S — 343 (2.56 1.93 1.75) 432 — S — 371 (1.72 1.53 2.15) 432 — S — 429 (2.12 2.63 1.05) 432 — S — 472 (1.12 2.20 1.47) 433 — S — 43 (0.99 1.62 1.76) 433 — S — 46 (1.58 1.14 2.24) 433 — S — 57 (1.26 2.16 1.22) 433 — S — 70 (1.05 1.83 1.55) 433 — S — 85 (0.83 0.94 2.43) 433 — S — 89 (0.81 1.57 1.81) 433 — S — 107 (1.09 1.10 2.27) 433 — S — 109 (0.89 1.63 1.75) 433 — S — 133 (1.10 1.39 1.98) 433 — S — 150 (1.92 1.27 2.11) 433 — S — 151 (1.82 1.53 1.85) 433 — S — 152 (2.47 1.83 1.55) 433 — S — 153 (1.85 1.37 2.01) 433 — S — 177 (0.93 1.05 2.33) 433 — S — 184 (1.67 0.86 2.52) 433 — S — 192 (1.27 1.38 2.00) 433 — S — 207 (0.84 1.69 1.69) 433 — S — 215 (1.07 1.95 1.43) 433 — S — 231 (1.32 1.49 1.88) 433 — S — 246 (0.84 1.25 2.13) 433 — S — 247 (0.97 2.46 0.92) 433 — S — 248 (0.91 1.80 1.58) 433 — S — 255 (1.23 1.47 1.91) 433 — S — 259 (1.09 2.29 1.09) 433 — S — 265 (0.80 1.39 1.99) 433 — S — 270 (0.89 2.15 1.23) 433 — S — 271 (1.49 1.56 1.82) 433 — S — 291 (1.58 1.41 1.97) 433 — S — 292 (0.91 1.07 2.31) 433 — S — 294 (0.87 0.91 2.47) 433 — S — 296 (0.90 1.15 2.23) 433 — S — 306 (0.95 1.47 1.91) 433 — S — 320 (1.17 1.89 1.49) 433 — S — 324 (1.14 2.38 1.00) 433 — S — 329 (0.89 1.67 1.70) 433 — S — 342 (2.32 1.43 1.95) 433 — S — 343 (2.85 1.92 1.46) 433 — S — 364 (1.03 2.05 1.33) 433 — S — 367 (0.85 1.37 2.01) 433 — S — 368 (0.96 1.91 1.47) 433 — S — 371 (2.01 1.51 1.86) 433 — S — 395 (1.04 1.21 2.16) 433 — S — 452 (0.80 1.47 1.90) 433 — S — 472 (1.40 2.19 1.18) 433 — S — 473 (0.88 1.40 1.98) 434 — S — 43 (0.88 0.83 1.87) 434 — S — 57 (1.14 1.37 1.33) 434 — S — 70 (0.94 1.04 1.66) 434 — S — 152 (2.36 1.04 1.66) 434 — S — 215 (0.96 1.16 1.54) 434 — S — 247 (0.86 1.67 1.03) 434 — S — 259 (0.97 1.50 1.20) 434 — S — 320 (1.06 1.10 1.60) 434 — S — 324 (1.03 1.59 1.11) 434 — S — 343 (2.74 1.13 1.57) 434 — S — 364 (0.92 1.26 1.44) 434 — S — 368 (0.84 1.12 1.58) 434 — S — 472 (1.29 1.41 1.30) 435 — S — 57 (1.06 1.20 1.42) 435 — S — 70 (0.85 0.87 1.75) 435 — S — 125 (1.30 1.65 0.97) 435 — S — 152 (2.27 0.87 1.75) 435 — S — 215 (0.88 0.99 1.62) 435 — S — 259 (0.89 1.33 1.29) 435 — S — 320 (0.97 0.93 1.69) 435 — S — 324 (0.95 1.42 1.20) 435 — S — 343 (2.65 0.96 1.66) 435 — S — 364 (0.83 1.09 1.53) 435 — S — 429 (2.21 1.66 0.96) 435 — S — 472 (1.21 1.24 1.38) 436 — S — 20 (1.14 1.14 1.86) 436 — S — 27 (1.05 1.31 1.69) 436 — S — 28 (1.12 1.58 1.42) 436 — S — 29 (0.88 1.30 1.70) 436 — S — 36 (1.28 2.09 0.91) 436 — S — 43 (1.69 1.94 1.05) 436 — S — 46 (2.29 1.46 1.53) 436 — S — 61 (1.03 1.28 1.71) 436 — S — 62 (0.91 1.48 1.51) 436 — S — 65 (1.04 1.08 1.92) 436 — S — 79 (1.02 1.45 1.54) 436 — S — 80 (0.98 1.41 1.58) 436 — S — 81 (1.05 1.54 1.46) 436 — S — 85 (1.54 1.27 1.73) 436 — S — 89 (1.51 1.89 1.10) 436 — S — 90 (1.42 1.74 1.25) 436 — S — 101 (1.18 1.59 1.40) 436 — S — 107 (1.80 1.43 1.57) 436 — S — 108 (1.36 1.82 1.18) 436 — S — 109 (1.59 1.95 1.04) 436 — S — 110 (1.09 1.59 1.40) 436 — S — 112 (0.98 1.09 1.91) 436 — S — 113 (1.19 2.01 0.99) 436 — S — 115 (1.46 1.57 1.43) 436 — S — 118 (1.07 0.99 2.01) 436 — S — 119 (1.05 1.20 1.79) 436 — S — 132 (1.01 0.91 2.09) 436 — S — 133 (1.80 1.72 1.28) 436 — S — 144 (1.13 1.63 1.37) 436 — S — 150 (2.62 1.59 1.40) 436 — S — 151 (2.53 1.85 1.15) 436 — S — 153 (2.55 1.69 1.30) 436 — S — 154 (2.09 0.82 2.18)

436 — S — 177 (1.63 1.37 1.62) 436 — S — 183 (1.28 1.71 1.29) 436 — S — 184 (2.37 1.18 1.81) 436 — S — 192 (1.98 1.70 1.29) 436 — S — 193 (0.89 0.87 2.13) 436 — S — 195 (1.80 1.03 1.97) 436 — S — 198 (1.51 1.09 1.91) 436 — S — 205 (1.03 1.15 1.85) 436 — S — 206 (1.03 2.06 0.94) 436 — S — 207 (1.55 2.01 0.99) 436 — S — 213 (1.48 1.04 1.95) 436 — S — 217 (0.90 1.08 1.92) 436 — S — 218 (0.87 1.25 1.74) 436 — S — 231 (2.02 1.82 1.18) 436 — S — 233 (1.40 1.24 1.76) 436 — S — 234 (1.22 1.32 1.67) 436 — S — 237 (1.24 1.62 1.38) 436 — S — 244 (1.29 1.23 1.76) 436 — S — 245 (1.21 1.01 1.99) 436 — S — 246 (1.54 1.57 1.42) 436 — S — 249 (1.08 1.96 1.03) 436 — S — 251 (1.05 1.82 1.18) 436 — S — 254 (1.04 0.93 2.07) 436 — S — 255 (1.94 1.79 1.20) 436 — S — 265 (1.51 1.71 1.28) 436 — S — 266 (1.14 1.29 1.70) 436 — S — 267 (0.94 0.99 2.00) 436 — S — 268 (1.48 1.86 1.13) 436 — S — 269 (1.45 1.79 1.20) 436 — S — 271 (2.20 1.88 1.11) 436 — S — 277 (1.03 1.06 1.94) 436 — S — 279 (1.08 1.12 1.87) 436 — S — 285 (0.81 1.00 1.99) 436 — S — 286 (1.06 0.91 2.09) 436 — S — 287 (0.87 0.92 2.08) 436 — S — 288 (0.85 0.86 2.14) 436 — S — 290 (1.14 1.32 1.67) 436 — S — 291 (2.28 1.73 1.27) 436 — S — 292 (1.61 1.39 1.61) 436 — S — 293 (1.12 1.20 1.80) 436 — S — 294 (1.57 1.23 1.77) 436 — S — 295 (1.33 1.47 1.52) 436 — S — 296 (1.60 1.47 1.53) 436 — S — 298 (1.17 1.07 1.92) 436 — S — 304 (0.98 0.92 2.08) 436 — S — 305 (1.49 1.14 1.86) 436 — S — 306 (1.65 1.79 1.21) 436 — S — 307 (1.38 1.92 1.08) 436 — S — 311 (0.82 0.81 2.19) 436 — S — 316 (0.98 1.14 1.86) 436 — S — 327 (1.27 1.54 1.46) 436 — S — 329 (1.60 2.00 1.00) 436 — S — 332 (0.98 0.89 2.11) 436 — S — 342 (3.02 1.75 1.25) 436 — S — 358 (0.92 1.06 1.94) 436 — S — 367 (1.55 1.69 1.30) 436 — S — 370 (0.89 1.12 1.87) 436 — S — 371 (2.71 1.84 1.16) 436 — S — 372 (1.12 0.82 2.17) 436 — S — 379 (0.80 0.82 2.18) 436 — S — 382 (0.87 1.00 2.00) 436 — S — 391 (0.81 0.81 2.19) 436 — S — 395 (1.74 1.54 1.46) 436 — S — 396 (1.17 0.98 2.02) 436 — S — 397 (0.97 0.82 2.18) 436 — S — 420 (0.92 2.02 0.98) 436 — S — 434 (0.82 1.11 1.89) 436 — S — 435 (0.90 1.28 1.72) 436 — S — 440 (1.43 1.45 1.55) 436 — S — 441 (1.36 1.37 1.62) 436 — S — 443 (0.83 1.99 1.01) 436 — S — 447 (1.37 1.56 1.44) 436 — S — 449 (1.11 1.53 1.47) 436 — S — 452 (1.51 1.80 1.20) 436 — S — 455 (0.81 0.94 2.06) 436 — S — 457 (0.95 1.44 1.56) 436 — S — 460 (1.23 1.87 1.12) 436 — S — 461 (0.95 1.63 1.36) 436 — S — 468 (0.83 1.35 1.65) 436 — S — 469 (0.93 1.77 1.22) 436 — S — 471 (1.53 1.10 1.89) 436 — S — 473 (1.58 1.72 1.28) 436 — S — 474 (1.43 1.61 1.39) 437 — S — 46 (1.20 0.81 2.62) 437 — S — 57 (0.88 1.83 1.60) 437 — S — 125 (1.12 2.28 1.15) 437 — S — 150 (1.54 0.94 2.49) 437 — S — 151 (1.45 1.19 2.23) 437 — S — 152 (2.09 1.49 1.93) 437 — S — 153 (1.47 1.04 2.39) 437 — S — 192 (0.89 1.05 2.38) 437 — S — 231 (0.94 1.16 2.26) 437 — S — 250 (0.88 2.40 1.02) 437 — S — 255 (0.85 1.14 2.29) 437 — S — 271 (1.12 1.23 2.20) 437 — S — 291 (1.20 1.07 2.35) 437 — S — 342 (1.94 1.09 2.33) 437 — S — 343 (2.47 1.59 1.84) 437 — S — 371 (1.63 1.18 2.24) 437 — S — 429 (2.03 2.28 1.14) 437 — S — 472 (1.02 1.86 1.56) 440 — S — 429 (1.69 1.49 1.48) 441 — S — 125 (0.84 1.56 1.42) 441 — S — 343 (2.19 0.87 2.11) 441 — S — 429 (1.76 1.57 1.41) 444 — S — 43 (0.80 1.98 1.94) 444 — S — 46 (1.40 1.50 2.42) 444 — S — 57 (1.07 2.52 1.40) 444 — S — 70 (0.87 2.19 1.73) 444 — S — 107 (0.91 1.46 2.46) 444 — S — 125 (1.31 2.97 0.95) 444 — S — 133 (0.91 1.75 2.17) 444 — S — 150 (1.73 1.63 2.29) 444 — S — 151 (1.64 1.88 2.04) 444 — S — 152 (2.28 2.18 1.74) 444 — S — 153 (1.66 1.73 2.19) 444 — S — 154 (1.20 0.86 3.06) 444 — S — 184 (1.48 1.22 2.70) 444 — S — 192 (1.09 1.74 2.18) 444 — S — 195 (0.91 1.06 2.86) 444 — S — 215 (0.89 2.31 1.61) 444 — S — 231 (1.13 1.85 2.07) 444 — S — 255 (1.05 1.83 2.09) 444 — S — 259 (0.90 2.64 1.27) 444 — S — 271 (1.31 1.92 2.00) 444 — S — 291 (1.39 1.76 2.16) 444 — S — 320 (0.99 2.24 1.68) 444 — S — 324 (0.96 2.74 1.18) 444 — S — 342 (2.13 1.78 2.14) 444 — S — 343 (2.66 2.28 1.64) 444 — S — 364 (0.84 2.40 1.51) 444 — S — 371 (1.82 1.87 2.05) 444 — S — 395 (0.85 1.57 2.35) 444 — S — 429 (2.22 2.97 0.95) 444 — S — 472 (1.22 2.55 1.37) 445 — S — 43 (1.13 2.02 1.62) 445 — S — 46 (1.72 1.54 2.10) 445 — S — 57 (1.39 2.56 1.08) 445 — S — 70 (1.19 2.23 1.41) 445 — S — 85 (0.97 1.34 2.30) 445 — S — 89 (0.94 1.97 1.67) 445 — S — 90 (0.85 1.82 1.82) 445 — S — 93 (0.92 2.71 0.93) 445 — S — 107 (1.23 1.50 2.13) 445 — S — 109 (1.03 2.03 1.61) 445 — S — 115 (0.90 1.64 2.00) 445 — S — 133 (1.23 1.79 1.84) 445 — S — 150 (2.05 1.67 1.97) 445 — S — 151 (1.96 1.92 1.71) 445 — S — 152 (2.61 2.22 1.41) 445 — S — 153 (1.99 1.77 1.87) 445 — S — 154 (1.52 0.90 2.74) 445 — S — 165 (0.90 2.64 1.00) 445 — S — 177 (1.07 1.45 2.19) 445 — S — 184 (1.80 1.26 2.38) 445 — S — 192 (1.41 1.78 1.86) 445 — S — 195 (1.23 1.10 2.53) 445 — S — 198 (0.95 1.16 2.47) 445 — S — 207 (0.98 2.08 1.55) 445 — S — 213 (0.91 1.12 2.52) 445 — S — 215 (1.21 2.35 1.29) 445 — S — 231 (1.45 1.89 1.75) 445 — S — 233 (0.84 1.32 2.32) 445 — S — 246 (0.98 1.65 1.99) 445 — S — 248 (1.04 2.20 1.44) 445 — S — 255 (1.37 1.87 1.77) 445 — S — 259 (1.22 2.69 0.95) 445 — S — 265 (0.94 1.79 1.85) 445 — S — 268 (0.92 1.94 1.70) 445 — S — 269 (0.88 1.87 1.77) 445 — S — 270 (1.02 2.55 1.09) 445 — S — 271 (1.63 1.96 1.68) 445 — S — 291 (1.71 1.80 1.83) 445 — S — 292 (1.05 1.46 2.17) 445 — S — 294 (1.01 1.31 2.33) 445 — S — 296 (1.04 1.54 2.09) 445 — S — 305 (0.93 1.21 2.43) 445 — S — 306 (1.09 1.87 1.77) 445 — S — 307 (0.82 2.00 1.64) 445 — S — 320 (1.31 2.28 1.35) 445 — S — 329 (1.03 2.07 1.56) 445 — S — 342 (2.46 1.82 1.81) 445 — S — 343 (2.99 2.32 1.32) 445 — S — 364 (1.17 2.44 1.19) 445 — S — 367 (0.98 1.77 1.87) 445 — S — 368 (1.10 2.31 1.33) 445 — S — 371 (2.14 1.91 1.72) 445 — S — 395 (1.18 1.61 2.02) 445 — S — 440 (0.86 1.52 2.12) 445 — S — 447 (0.80 1.64 2.00) 445 — S — 451 (0.89 2.21 1.42) 445 — S — 452 (0.94 1.87 1.77) 445 — S — 463 (0.82 2.32 1.32) 445 — S — 471 (0.97 1.18 2.46) 445 — S — 472 (1.54 2.59 1.05) 445 — S — 473 (1.01 1.79 1.84) 445 — S — 474 (0.87 1.68 1.95) 446 — S — 43 (1.13 2.02 1.62) 446 — S — 46 (1.72 1.54 2.10) 446 — S — 57 (1.39 2.56 1.08) 446 — S — 70 (1.19 2.23 1.41) 446 — S — 85 (0.97 1.34 2.30) 446 — S — 89 (0.94 1.97 1.67) 446 — S — 90 (0.85 1.82 1.82) 446 — S — 93 (0.92 2.71 0.93) 446 — S — 107 (1.23 1.50 2.13) 446 — S — 109 (1.03 2.03 1.61) 446 — S — 115 (0.90 1.64 2.00) 446 — S — 133 (1.23 1.79 1.84) 446 — S — 150 (2.05 1.67 1.97) 446 — S — 151 (1.96 1.92 1.71) 446 — S — 152 (2.61 2.22 1.41) 446 — S — 153 (1.99 1.77 1.87) 446 — S — 154 (1.52 0.90 2.74) 446 — S — 165 (0.90 2.64 1.00) 446 — S — 177 (1.07 1.45 2.19) 446 — S — 184 (1.80 1.26 2.38) 446 — S — 192 (1.41 1.78 1.86) 446 — S — 195 (1.23 1.10 2.53) 446 — S — 198 (0.95 1.16 2.47) 446 — S — 207 (0.98 2.08 1.55) 446 — S — 213 (0.91 1.12 2.52) 446 — S — 215 (1.21 2.35 1.29) 446 — S — 231 (1.45 1.89 1.75) 446 — S — 233 (0.84 1.32 2.32) 446 — S — 246 (0.98 1.65 1.99) 446 — S — 248 (1.04 2.20 1.44) 446 — S — 255 (1.37 1.87 1.77) 446 — S — 259 (1.22 2.69 0.95) 446 — S — 265 (0.94 1.79 1.85) 446 — S — 268 (0.92 1.94 1.70) 446 — S — 269 (0.88 1.87 1.77)

446 — S — 270 (1.02 2.55 1.09) 446 — S — 271 (1.63 1.96 1.68) 446 — S — 291 (1.71 1.80 1.83) 446 — S — 292 (1.05 1.46 2.17) 446 — S — 294 (1.01 1.31 2.33) 446 — S — 296 (1.04 1.54 2.09) 446 — S — 305 (0.93 1.21 2.43) 446 — S — 306 (1.09 1.87 1.77) 446 — S — 307 (0.82 2.00 1.64) 446 — S — 320 (1.31 2.28 1.35) 446 — S — 329 (1.03 2.07 1.56) 446 — S — 342 (2.46 1.82 1.81) 446 — S — 343 (2.99 2.32 1.32) 446 — S — 364 (1.17 2.44 1.19) 446 — S — 367 (0.98 1.77 1.87) 446 — S — 368 (1.10 2.31 1.33) 446 — S — 371 (2.14 1.91 1.72) 446 — S — 395 (1.18 1.61 2.02) 446 — S — 440 (0.86 1.52 2.12) 446 — S — 447 (0.80 1.64 2.00) 446 — S — 451 (0.89 2.21 1.42) 446 — S — 452 (0.94 1.87 1.77) 446 — S — 463 (0.82 2.32 1.32) 446 — S — 471 (0.97 1.18 2.46) 446 — S — 472 (1.54 2.59 1.05) 446 — S — 473 (1.01 1.79 1.84) 446 — S — 474 (0.87 1.68 1.95) 447 — S — 125 (0.83 1.37 1.43) 447 — S — 429 (1.74 1.38 1.42) 448 — S — 20 (0.83 0.83 2.16) 448 — S — 28 (0.81 1.26 1.73) 448 — S — 36 (0.97 1.78 1.22) 448 — S — 37 (0.96 2.08 0.92) 448 — S — 43 (1.38 1.63 1.36) 448 — S — 46 (1.98 1.15 1.84) 448 — S — 70 (1.45 1.84 1.15) 448 — S — 85 (1.23 0.95 2.04) 448 — S — 89 (1.20 1.58 1.41) 448 — S — 90 (1.11 1.43 1.56) 448 — S — 101 (0.87 1.28 1.71) 448 — S — 107 (1.49 1.11 1.88) 448 — S — 108 (1.05 1.51 1.49) 448 — S — 109 (1.29 1.64 1.35) 448 — S — 113 (0.89 1.70 1.30) 448 — S — 115 (1.15 1.25 1.74) 448 — S — 133 (1.49 1.41 1.59) 448 — S — 144 (0.83 1.32 1.68) 448 — S — 145 (0.81 1.97 1.03) 448 — S — 150 (2.31 1.28 1.71) 448 — S — 151 (2.22 1.54 1.46) 448 — S — 152 (2.86 1.84 1.16) 448 — S — 153 (2.24 1.38 1.61) 448 — S — 177 (1.32 1.06 1.93) 448 — S — 183 (0.97 1.40 1.60) 448 — S — 184 (2.06 0.87 2.12) 448 — S — 192 (1.67 1.39 1.60) 448 — S — 207 (1.24 1.70 1.30) 448 — S — 215 (1.47 1.96 1.03) 448 — S — 231 (1.71 1.50 1.49) 448 — S — 233 (1.10 0.93 2.06) 448 — S — 234 (0.92 1.01 1.98) 448 — S — 237 (0.93 1.31 1.69) 448 — S — 244 (0.98 0.92 2.07) 448 — S — 246 (1.24 1.26 1.73) 448 — S — 248 (1.30 1.81 1.18) 448 — S — 255 (1.63 1.48 1.51) 448 — S — 265 (1.20 1.40 1.59) 448 — S — 266 (0.83 0.98 2.01) 448 — S — 268 (1.18 1.55 1.44) 448 — S — 269 (1.14 1.48 1.51) 448 — S — 271 (1.89 1.57 1.42) 448 — S — 290 (0.83 1.01 1.98) 448 — S — 291 (1.97 1.42 1.58) 448 — S — 292 (1.31 1.08 1.92) 448 — S — 293 (0.81 0.89 2.11) 448 — S — 294 (1.26 0.92 2.07) 448 — S — 295 (1.02 1.16 1.83) 448 — S — 296 (1.30 1.16 1.84) 448 — S — 305 (1.19 0.82 2.17) 448 — S — 306 (1.35 1.48 1.51) 448 — S — 307 (1.08 1.61 1.38) 448 — S — 320 (1.57 1.90 1.09) 448 — S — 327 (0.96 1.23 1.77) 448 — S — 329 (1.29 1.69 1.31) 448 — S — 342 (2.71 1.44 1.56) 448 — S — 343 (3.24 1.93 1.06) 448 — S — 364 (1.42 2.06 0.93) 448 — S — 367 (1.24 1.38 1.61) 448 — S — 368 (1.35 1.92 1.07) 448 — S — 371 (2.40 1.52 1.47) 448 — S — 395 (1.43 1.23 1.77) 448 — S — 440 (1.12 1.13 1.86) 448 — S — 441 (1.05 1.06 1.93) 448 — S — 447 (1.06 1.25 1.74) 448 — S — 449 (0.80 1.22 1.78) 448 — S — 451 (1.14 1.83 1.17) 448 — S — 452 (1.20 1.48 1.51) 448 — S — 460 (0.92 1.56 1.43) 448 — S — 463 (1.07 1.93 1.06) 448 — S — 473 (1.27 1.41 1.59) 448 — S — 474 (1.12 1.30 1.70) 449 — S — 57 (0.85 0.95 1.62) 449 — S — 125 (1.09 1.40 1.18) 449 — S — 250 (0.86 1.53 1.05) 449 — S — 429 (2.00 1.41 1.17) 449 — S — 472 (1.00 0.99 1.59) 450 — S — 57 (1.23 1.29 1.25) 450 — S — 70 (1.02 0.96 1.57) 450 — S — 152 (2.44 0.95 1.58) 450 — S — 207 (0.81 0.81 1.72) 450 — S — 215 (1.05 1.08 1.45) 450 — S — 247 (0.95 1.58 0.95) 450 — S — 248 (0.88 0.93 1.61) 450 — S — 259 (1.06 1.41 1.12) 450 — S — 270 (0.86 1.28 1.26) 450 — S — 320 (1.14 1.01 1.52) 450 — S — 324 (1.12 1.51 1.03) 450 — S — 329 (0.86 0.80 1.73) 450 — S — 343 (2.82 1.04 1.49) 450 — S — 364 (1.00 1.17 1.36) 450 — S — 368 (0.93 1.04 1.49) 450 — S — 472 (1.38 1.32 1.21) 452 — S — 429 (1.61 1.14 1.56) 453 — S — 46 (1.29 0.96 2.53) 453 — S — 57 (0.96 1.98 1.51) 453 — S — 125 (1.20 2.43 1.06) 453 — S — 133 (0.80 1.22 2.28) 453 — S — 150 (1.62 1.09 2.40) 453 — S — 151 (1.53 1.35 2.15) 453 — S — 152 (2.17 1.65 1.85) 453 — S — 153 (1.55 1.19 2.30) 453 — S — 192 (0.98 1.20 2.29) 453 — S — 231 (1.02 1.32 2.18) 453 — S — 250 (0.97 2.56 0.94) 453 — S — 255 (0.94 1.29 2.20) 453 — S — 271 (1.20 1.38 2.11) 453 — S — 291 (1.28 1.23 2.27) 453 — S — 320 (0.88 1.71 1.79) 453 — S — 324 (0.85 2.20 1.29) 453 — S — 342 (2.02 1.25 2.25) 453 — S — 343 (2.55 1.74 1.75) 453 — S — 371 (1.71 1.34 2.16) 453 — S — 429 (2.11 2.44 1.06) 453 — S — 472 (1.11 2.02 1.48) 454 — S — 43 (0.87 1.28 1.88) 454 — S — 57 (1.14 1.82 1.34) 454 — S — 70 (0.93 1.49 1.67) 454 — S — 133 (0.98 1.05 2.10) 454 — S — 150 (1.80 0.93 2.23) 454 — S — 151 (1.71 1.18 1.97) 454 — S — 152 (2.35 1.48 1.67) 454 — S — 153 (1.73 1.03 2.13) 454 — S — 192 (1.15 1.04 2.12) 454 — S — 215 (0.96 1.61 1.55) 454 — S — 231 (1.20 1.15 2.00) 454 — S — 247 (0.86 2.11 1.04) 454 — S — 255 (1.11 1.13 2.03) 454 — S — 259 (0.97 1.95 1.21) 454 — S — 271 (1.38 1.22 1.93) 454 — S — 291 (1.46 1.06 2.09) 454 — S — 306 (0.83 1.13 2.03) 454 — S — 320 (1.05 1.54 1.61) 454 — S — 324 (1.03 2.04 1.12) 454 — S — 342 (2.20 1.08 2.07) 454 — S — 343 (2.73 1.58 1.58) 454 — S — 364 (0.91 1.70 1.45) 454 — S — 368 (0.84 1.57 1.58) 454 — S — 371 (1.89 1.17 1.98) 454 — S — 395 (0.92 0.87 2.28) 454 — S — 472 (1.29 1.85 1.30) 455 — S — 43 (0.89 1.01 1.86) 455 — S — 57 (1.15 1.55 1.32) 455 — S — 70 (0.95 1.22 1.65) 455 — S — 151 (1.72 0.91 1.95) 455 — S — 152 (2.37 1.21 1.65) 455 — S — 215 (0.97 1.34 1.53) 455 — S — 231 (1.21 0.88 1.99) 455 — S — 247 (0.87 1.84 1.02) 455 — S — 248 (0.80 1.19 1.68) 455 — S — 255 (1.13 0.86 2.01) 455 — S — 259 (0.98 1.68 1.19) 455 — S — 271 (1.39 0.95 1.92) 455 — S — 306 (0.85 0.86 2.01) 455 — S — 320 (1.07 1.27 1.59) 455 — S — 324 (1.04 1.77 1.10) 455 — S — 342 (2.22 0.81 2.05) 455 — S — 343 (2.75 1.31 1.56) 455 — S — 364 (0.93 1.43 1.43) 455 — S — 368 (0.85 1.30 1.57) 455 — S — 371 (1.90 0.90 1.97) 455 — S — 472 (1.30 1.58 1.29) 456 — S — 43 (1.19 1.30 1.55) 456 — S — 46 (1.79 0.82 2.03) 456 — S — 57 (1.46 1.83 1.02) 456 — S — 70 (1.25 1.51 1.34) 456 — S — 89 (1.01 1.24 1.60) 456 — S — 90 (0.92 1.09 1.76) 456 — S — 108 (0.86 1.17 1.68) 456 — S — 109 (1.09 1.31 1.54) 456 — S — 115 (0.96 0.92 1.93) 456 — S — 133 (1.30 1.07 1.78) 456 — S — 150 (2.12 0.94 1.91) 456 — S — 151 (2.03 1.20 1.65) 456 — S — 152 (2.67 1.50 1.35) 456 — S — 153 (2.05 1.04 1.80) 456 — S — 165 (0.96 1.92 0.93) 456 — S — 192 (1.48 1.06 1.79) 456 — S — 207 (1.04 1.36 1.49) 456 — S — 215 (1.28 1.63 1.22) 456 — S — 231 (1.52 1.17 1.68) 456 — S — 246 (1.04 0.93 1.92) 456 — S — 248 (1.11 1.47 1.38) 456 — S — 255 (1.43 1.14 1.71) 456 — S — 265 (1.00 1.07 1.78) 456 — S — 268 (0.98 1.22 1.63) 456 — S — 269 (0.95 1.15 1.70) 456 — S — 270 (1.09 1.82 1.03) 456 — S — 271 (1.70 1.24 1.61) 456 — S — 291 (1.78 1.08 1.77) 456 — S — 295 (0.83 0.83 2.02) 456 — S — 296 (1.10 0.82 2.03) 456 — S — 306 (1.15 1.14 1.71) 456 — S — 307 (0.88 1.27 1.58) 456 — S — 320 (1.37 1.56 1.29) 456 — S — 329 (1.09 1.35 1.50) 456 — S — 342 (2.52 1.10 1.75) 456 — S — 343 (3.05 1.59 1.26) 456 — S — 364 (1.23 1.72 1.13) 456 — S — 367 (1.05 1.04 1.80) 456 — S — 368 (1.16 1.59 1.26) 456 — S — 371 (2.21 1.19 1.66) 456 — S — 395 (1.24 0.89 1.96)

456 — S — 447 (0.87 0.91 1.94) 456 — S — 451 (0.95 1.49 1.36) 456 — S — 452 (1.01 1.15 1.70) 456 — S — 463 (0.88 1.59 1.25) 456 — S — 472 (1.61 1.87 0.98) 456 — S — 473 (1.08 1.07 1.78) 456 — S — 474 (0.93 0.96 1.89) 457 — S — 57 (1.01 1.04 1.47) 457 — S — 125 (1.25 1.49 1.02) 457 — S — 215 (0.82 0.83 1.68) 457 — S — 259 (0.84 1.17 1.34) 457 — S — 324 (0.89 1.26 1.25) 457 — S — 429 (2.16 1.50 1.01) 457 — S — 472 (1.15 1.08 1.43) 458 — S — 57 (1.46 1.25 1.01) 458 — S — 70 (1.26 0.92 1.34) 458 — S — 152 (2.67 0.91 1.35) 458 — S — 165 (0.96 1.33 0.93) 458 — S — 215 (1.28 1.04 1.22) 458 — S — 248 (1.11 0.89 1.37) 458 — S — 270 (1.09 1.24 1.02) 458 — S — 320 (1.38 0.97 1.28) 458 — S — 343 (3.05 1.01 1.25) 458 — S — 364 (1.23 1.13 1.12) 458 — S — 368 (1.16 1.00 1.26) 458 — S — 451 (0.95 0.90 1.35) 458 — S — 463 (0.89 1.01 1.25) 458 — S — 472 (1.61 1.28 0.98) 459 — S — 57 (1.22 0.81 1.26) 459 — S — 247 (0.94 1.11 0.96) 459 — S — 259 (1.05 0.94 1.13) 459 — S — 324 (1.11 1.03 1.03) 459 — S — 472 (1.37 0.84 1.22) 460 — S — 125 (0.97 1.06 1.30) 460 — S — 429 (1.88 1.07 1.29) 461 — S — 57 (1.01 0.85 1.46) 461 — S — 125 (1.25 1.30 1.01) 461 — S — 259 (0.84 0.98 1.33) 461 — S — 324 (0.90 1.07 1.24) 461 — S — 429 (2.17 1.31 1.00) 461 — S — 472 (1.16 0.88 1.43) 462 — S — 57 (1.32 0.84 1.15) 462 — S — 93 (0.85 0.99 1.00) 462 — S — 165 (0.82 0.92 1.07) 462 — S — 259 (1.15 0.96 1.03) 462 — S — 270 (0.95 0.82 1.17) 462 — S — 324 (1.21 1.06 0.93) 462 — S — 472 (1.47 0.87 1.12) 464 — S — 43 (1.83 0.83 0.91) 464 — S — 109 (1.73 0.84 0.90) 464 — S — 307 (1.52 0.80 0.94) 466 — S — 36 (0.95 1.57 1.24) 466 — S — 37 (0.95 1.87 0.94) 466 — S — 43 (1.36 1.42 1.38) 466 — S — 46 (1.96 0.95 1.86) 466 — S — 70 (1.43 1.63 1.17) 466 — S — 89 (1.18 1.37 1.43) 466 — S — 90 (1.09 1.22 1.58) 466 — S — 101 (0.85 1.07 1.73) 466 — S — 107 (1.47 0.91 1.90) 466 — S — 108 (1.03 1.30 1.51) 466 — S — 109 (1.27 1.44 1.37) 466 — S — 113 (0.87 1.49 1.32) 466 — S — 115 (1.14 1.05 1.76) 466 — S — 133 (1.47 1.20 1.61) 466 — S — 144 (0.81 1.11 1.70) 466 — S — 150 (2.29 1.07 1.73) 466 — S — 151 (2.20 1.33 1.47) 466 — S — 152 (2.84 1.63 1.18) 466 — S — 153 (2.22 1.17 1.63) 466 — S — 177 (1.31 0.85 1.95) 466 — S — 183 (0.95 1.19 1.62) 466 — S — 192 (1.65 1.19 1.62) 466 — S — 207 (1.22 1.49 1.32) 466 — S — 215 (1.45 1.76 1.05) 466 — S — 231 (1.69 1.30 1.51) 466 — S — 234 (0.90 0.80 2.00) 466 — S — 237 (0.91 1.10 1.71) 466 — S — 246 (1.22 1.06 1.75) 466 — S — 248 (1.28 1.60 1.20) 466 — S — 255 (1.61 1.27 1.53) 466 — S — 265 (1.18 1.20 1.61) 466 — S — 268 (1.16 1.35 1.46) 466 — S — 269 (1.12 1.27 1.53) 466 — S — 271 (1.87 1.37 1.44) 466 — S — 290 (0.81 0.80 2.00) 466 — S — 291 (1.95 1.21 1.60) 466 — S — 292 (1.29 0.87 1.94) 466 — S — 295 (1.00 0.96 1.85) 466 — S — 296 (1.28 0.95 1.85) 466 — S — 306 (1.33 1.27 1.53) 466 — S — 307 (1.06 1.40 1.40) 466 — S — 320 (1.55 1.69 1.11) 466 — S — 327 (0.94 1.02 1.79) 466 — S — 329 (1.27 1.48 1.33) 466 — S — 342 (2.69 1.23 1.58) 466 — S — 343 (3.22 1.72 1.08) 466 — S — 364 (1.40 1.85 0.95) 466 — S — 367 (1.22 1.17 1.63) 466 — S — 368 (1.33 1.72 1.09) 466 — S — 371 (2.38 1.32 1.49) 466 — S — 395 (1.41 1.02 1.79) 466 — S — 440 (1.10 0.93 1.88) 466 — S — 441 (1.03 0.85 1.95) 466 — S — 447 (1.04 1.04 1.76) 466 — S — 451 (1.12 1.62 1.18) 466 — S — 452 (1.18 1.28 1.53) 466 — S — 460 (0.90 1.35 1.45) 466 — S — 463 (1.06 1.72 1.08) 466 — S — 473 (1.25 1.20 1.61) 466 — S — 474 (1.10 1.09 1.72) 467 — S — 43 (1.06 0.90 1.69) 467 — S — 57 (1.32 1.44 1.15) 467 — S — 70 (1.12 1.11 1.48) 467 — S — 89 (0.87 0.85 1.74) 467 — S — 93 (0.85 1.59 1.00) 467 — S — 109 (0.96 0.91 1.68) 467 — S — 151 (1.89 0.81 1.78) 467 — S — 152 (2.54 1.11 1.48) 467 — S — 165 (0.82 1.52 1.07) 467 — S — 207 (0.91 0.97 1.62) 467 — S — 215 (1.14 1.23 1.36) 467 — S — 248 (0.97 1.08 1.51) 467 — S — 259 (1.15 1.57 1.02) 467 — S — 268 (0.85 0.82 1.77) 467 — S — 270 (0.95 1.43 1.16) 467 — S — 271 (1.56 0.84 1.75) 467 — S — 320 (1.24 1.17 1.42) 467 — S — 324 (1.21 1.66 0.93) 467 — S — 329 (0.96 0.96 1.63) 467 — S — 343 (2.92 1.20 1.39) 467 — S — 364 (1.10 1.33 1.26) 467 — S — 368 (1.02 1.19 1.40) 467 — S — 451 (0.81 1.10 1.49) 467 — S — 472 (1.47 1.47 1.12) 468 — S — 57 (1.13 1.14 1.35) 468 — S — 70 (0.92 0.81 1.68) 468 — S — 125 (1.36 1.58 0.90) 468 — S — 152 (2.34 0.80 1.68) 468 — S — 215 (0.94 0.93 1.56) 468 — S — 247 (0.84 1.43 1.05) 468 — S — 259 (0.96 1.26 1.22) 468 — S — 320 (1.04 0.86 1.62) 468 — S — 324 (1.01 1.36 1.13) 468 — S — 343 (2.72 0.89 1.59) 468 — S — 364 (0.90 1.02 1.46) 468 — S — 368 (0.83 0.89 1.60) 468 — S — 472 (1.27 1.17 1.31) 469 — S — 125 (1.27 1.16 0.99) 469 — S — 259 (0.86 0.84 1.31) 469 — S — 324 (0.92 0.93 1.22) 469 — S — 429 (2.19 1.16 0.98) 471 — S — 152 (1.64 1.04 2.38) 471 — S — 343 (2.02 1.14 2.29) 471 — S — 429 (1.58 1.83 1.59) 473 — S — 429 (1.53 1.22 1.64) 474 — S — 429 (1.68 1.33 1.49) 475 — S — 36 (0.90 1.36 1.28) 475 — S — 37 (0.90 1.66 0.98) 475 — S — 43 (1.32 1.22 1.43) 475 — S — 70 (1.38 1.43 1.22) 475 — S — 89 (1.14 1.16 1.48) 475 — S — 90 (1.05 1.01 1.63) 475 — S — 101 (0.80 0.87 1.78) 475 — S — 108 (0.99 1.09 1.55) 475 — S — 109 (1.22 1.23 1.41) 475 — S — 113 (0.82 1.28 1.36) 475 — S — 115 (1.09 0.84 1.80) 475 — S — 133 (1.43 0.99 1.65) 475 — S — 150 (2.25 0.86 1.78) 475 — S — 151 (2.16 1.12 1.52) 475 — S — 152 (2.80 1.42 1.22) 475 — S — 153 (2.18 0.96 1.68) 475 — S — 183 (0.91 0.98 1.66) 475 — S — 192 (1.60 0.98 1.66) 475 — S — 207 (1.17 1.28 1.36) 475 — S — 215 (1.41 1.55 1.10) 475 — S — 231 (1.65 1.09 1.55) 475 — S — 237 (0.86 0.89 1.75) 475 — S — 246 (1.17 0.85 1.80) 475 — S — 248 (1.24 1.39 1.25) 475 — S — 255 (1.56 1.06 1.58) 475 — S — 265 (1.13 0.99 1.65) 475 — S — 268 (1.11 1.14 1.51) 475 — S — 269 (1.08 1.06 1.58) 475 — S — 271 (1.83 1.16 1.48) 475 — S — 291 (1.91 1.00 1.64) 475 — S — 306 (1.28 1.06 1.58) 475 — S — 307 (1.01 1.19 1.45) 475 — S — 320 (1.50 1.48 1.16) 475 — S — 327 (0.89 0.81 1.83) 475 — S — 329 (1.22 1.27 1.37) 475 — S — 342 (2.65 1.02 1.62) 475 — S — 343 (3.18 1.51 1.13) 475 — S — 364 (1.36 1.64 1.00) 475 — S — 367 (1.18 0.96 1.68) 475 — S — 368 (1.29 1.51 1.13) 475 — S — 371 (2.34 1.11 1.53) 475 — S — 395 (1.37 0.81 1.83) 475 — S — 447 (1.00 0.83 1.81) 475 — S — 451 (1.08 1.41 1.23) 475 — S — 452 (1.13 1.07 1.57) 475 — S — 460 (0.86 1.14 1.50) 475 — S — 463 (1.01 1.51 1.13) 475 — S — 473 (1.21 0.99 1.65) 475 — S — 474 (1.06 0.88 1.76) 476 — S — 28 (1.07 0.82 1.47) 476 — S — 36 (1.22 1.33 0.96) 476 — S — 43 (1.64 1.19 1.11) 476 — S — 89 (1.46 1.13 1.16) 476 — S — 90 (1.37 0.98 1.31) 476 — S — 101 (1.12 0.84 1.46) 476 — S — 108 (1.31 1.06 1.23) 476 — S — 109 (1.54 1.20 1.09) 476 — S — 110 (1.04 0.83 1.46) 476 — S — 113 (1.14 1.25 1.04) 476 — S — 115 (1.41 0.81 1.48) 476 — S — 133 (1.75 0.96 1.33) 476 — S — 144 (1.08 0.87 1.42) 476 — S — 150 (2.57 0.83 1.46) 476 — S — 151 (2.48 1.09 1.20) 476 — S — 153 (2.50 0.93 1.36) 476 — S — 183 (1.23 0.95 1.34) 476 — S — 192 (1.92 0.95 1.34) 476 — S — 206 (0.97 1.30 0.99) 476 — S — 207 (1.49 1.25 1.04) 476 — S — 231 (1.97 1.06 1.23) 476 — S — 237 (1.18 0.86 1.43) 476 — S — 246 (1.49 0.82 1.48) 476 — S — 248 (1.56 1.36 0.93) 476 — S — 249 (1.03 1.20 1.09) 476 — S — 251 (1.00 1.06 1.23)

476 — S — 255 (1.88 1.03 1.26) 476 — S — 265 (1.45 0.96 1.33) 476 — S — 268 (1.43 1.11 1.18) 476 — S — 269 (1.40 1.03 1.26) 476 — S — 271 (2.15 1.13 1.16) 476 — S — 291 (2.23 0.97 1.32) 476 — S — 306 (1.60 1.03 1.26) 476 — S — 307 (1.33 1.16 1.13) 476 — S — 329 (1.54 1.24 1.05) 476 — S — 342 (2.97 0.99 1.30) 476 — S — 367 (1.50 0.93 1.36) 476 — S — 371 (2.66 1.08 1.21) 476 — S — 420 (0.87 1.26 1.03) 476 — S — 447 (1.32 0.80 1.49) 476 — S — 451 (1.40 1.38 0.91) 476 — S — 452 (1.45 1.04 1.25) 476 — S — 460 (1.18 1.11 1.18) 476 — S — 461 (0.89 0.87 1.42) 476 — S — 469 (0.87 1.02 1.27) 476 — S — 473 (1.53 0.96 1.33) 476 — S — 474 (1.38 0.85 1.44) 477 — S — 20 (1.66 1.16 1.34) 477 — S — 27 (1.57 1.32 1.17) 477 — S — 28 (1.64 1.59 0.90) 477 — S — 29 (1.40 1.32 1.18) 477 — S — 40 (1.22 1.31 1.18) 477 — S — 46 (2.81 1.48 1.01) 477 — S — 61 (1.55 1.30 1.19) 477 — S — 62 (1.42 1.50 1.00) 477 — S — 65 (1.56 1.09 1.40) 477 — S — 68 (1.27 1.06 1.44) 477 — S — 79 (1.54 1.47 1.02) 477 — S — 80 (1.49 1.43 1.07) 477 — S — 81 (1.57 1.55 0.94) 477 — S — 85 (2.06 1.28 1.21) 477 — S — 107 (2.32 1.44 1.05) 477 — S — 112 (1.50 1.11 1.39) 477 — S — 115 (1.98 1.58 0.91) 477 — S — 118 (1.59 1.00 1.49) 477 — S — 119 (1.56 1.22 1.27) 477 — S — 123 (1.20 1.35 1.15) 477 — S — 132 (1.53 0.93 1.57) 477 — S — 147 (1.06 1.22 1.27) 477 — S — 154 (2.60 0.84 1.66) 477 — S — 177 (2.15 1.39 1.11) 477 — S — 184 (2.89 1.20 1.29) 477 — S — 193 (1.41 0.88 1.61) 477 — S — 195 (2.32 1.04 1.45) 477 — S — 198 (2.03 1.10 1.39) 477 — S — 205 (1.55 1.16 1.33) 477 — S — 213 (2.00 1.06 1.43) 477 — S — 217 (1.42 1.09 1.40) 477 — S — 218 (1.39 1.27 1.22) 477 — S — 219 (1.19 0.83 1.67) 477 — S — 228 (0.93 0.83 1.67) 477 — S — 233 (1.92 1.26 1.24) 477 — S — 234 (1.74 1.34 1.16) 477 — S — 238 (1.05 1.49 1.00) 477 — S — 244 (1.81 1.25 1.24) 477 — S — 245 (1.73 1.02 1.47) 477 — S — 246 (2.06 1.59 0.90) 477 — S — 254 (1.56 0.95 1.55) 477 — S — 266 (1.66 1.31 1.19) 477 — S — 267 (1.46 1.01 1.49) 477 — S — 274 (1.33 0.81 1.68) 477 — S — 275 (1.14 1.23 1.26) 477 — S — 277 (1.55 1.08 1.42) 477 — S — 279 (1.60 1.14 1.36) 477 — S — 280 (1.28 0.82 1.68) 477 — S — 285 (1.33 1.02 1.47) 477 — S — 286 (1.58 0.92 1.57) 477 — S — 287 (1.39 0.94 1.56) 477 — S — 288 (1.37 0.87 1.62) 477 — S — 290 (1.66 1.34 1.15) 477 — S — 292 (2.13 1.40 1.09) 477 — S — 293 (1.64 1.21 1.28) 477 — S — 294 (2.09 1.25 1.25) 477 — S — 295 (1.84 1.49 1.00) 477 — S — 296 (2.12 1.49 1.01) 477 — S — 298 (1.69 1.09 1.40) 477 — S — 299 (0.95 1.43 1.06) 477 — S — 304 (1.50 0.94 1.56) 477 — S — 305 (2.01 1.15 1.34) 477 — S — 311 (1.33 0.82 1.67) 477 — S — 313 (1.21 0.86 1.63) 477 — S — 316 (1.50 1.15 1.34) 477 — S — 327 (1.79 1.55 0.94) 477 — S — 332 (1.50 0.91 1.59) 477 — S — 341 (1.10 1.42 1.07) 477 — S — 358 (1.44 1.07 1.42) 477 — S — 370 (1.41 1.14 1.36) 477 — S — 372 (1.64 0.84 1.66) 477 — S — 373 (1.03 0.84 1.65) 477 — S — 374 (1.25 1.33 1.16) 477 — S — 379 (1.32 0.83 1.66) 477 — S — 381 (0.89 1.00 1.49) 477 — S — 382 (1.39 1.02 1.48) 477 — S — 391 (1.33 0.82 1.67) 477 — S — 395 (2.26 1.55 0.94) 477 — S — 396 (1.69 0.99 1.50) 477 — S — 397 (1.49 0.84 1.66) 477 — S — 434 (1.34 1.13 1.37) 477 — S — 435 (1.42 1.29 1.20) 477 — S — 440 (1.95 1.46 1.03) 477 — S — 441 (1.88 1.39 1.10) 477 — S — 447 (1.89 1.58 0.92) 477 — S — 449 (1.63 1.54 0.95) 477 — S — 450 (1.25 1.21 1.28) 477 — S — 455 (1.33 0.95 1.54) 477 — S — 457 (1.47 1.46 1.04) 477 — S — 458 (1.02 1.25 1.24) 477 — S — 467 (1.16 1.06 1.44) 477 — S — 468 (1.35 1.36 1.13) 477 — S — 471 (2.05 1.12 1.37) 478 — S — 20 (1.72 1.20 1.27) 478 — S — 27 (1.64 1.37 1.11) 478 — S — 29 (1.46 1.36 1.11) 478 — S — 40 (1.28 1.36 1.11) 478 — S — 46 (2.87 1.53 0.95) 478 — S — 56 (1.63 0.83 1.64) 478 — S — 61 (1.61 1.34 1.13) 478 — S — 62 (1.49 1.54 0.93) 478 — S — 65 (1.62 1.14 1.33) 478 — S — 68 (1.33 1.10 1.37) 478 — S — 79 (1.61 1.52 0.96) 478 — S — 80 (1.56 1.47 1.00) 478 — S — 85 (2.12 1.33 1.15) 478 — S — 107 (2.38 1.49 0.99) 478 — S — 112 (1.57 1.15 1.32) 478 — S — 118 (1.66 1.05 1.42) 478 — S — 119 (1.63 1.26 1.21) 478 — S — 123 (1.27 1.39 1.08) 478 — S — 132 (1.59 0.97 1.50) 478 — S — 147 (1.12 1.26 1.21) 478 — S — 154 (2.67 0.88 1.59) 478 — S — 177 (2.22 1.43 1.04) 478 — S — 184 (2.95 1.24 1.23) 478 — S — 193 (1.48 0.93 1.55) 478 — S — 195 (2.38 1.09 1.38) 478 — S — 198 (2.09 1.15 1.32) 478 — S — 205 (1.61 1.21 1.26) 478 — S — 213 (2.06 1.10 1.37) 478 — S — 217 (1.48 1.14 1.34) 478 — S — 218 (1.45 1.31 1.16) 478 — S — 219 (1.26 0.87 1.60) 478 — S — 228 (1.00 0.87 1.60) 478 — S — 233 (1.99 1.30 1.17) 478 — S — 234 (1.81 1.38 1.09) 478 — S — 238 (1.12 1.54 0.94) 478 — S — 244 (1.87 1.29 1.18) 478 — S — 245 (1.79 1.07 1.41) 478 — S — 254 (1.63 0.99 1.48) 478 — S — 266 (1.73 1.35 1.12) 478 — S — 267 (1.53 1.05 1.42) 478 — S — 274 (1.39 0.85 1.62) 478 — S — 275 (1.20 1.27 1.20) 478 — S — 277 (1.61 1.12 1.35) 478 — S — 279 (1.67 1.18 1.29) 478 — S — 280 (1.35 0.86 1.61) 478 — S — 285 (1.39 1.07 1.41) 478 — S — 286 (1.64 0.97 1.50) 478 — S — 287 (1.45 0.98 1.49) 478 — S — 288 (1.44 0.92 1.55) 478 — S — 290 (1.73 1.38 1.09) 478 — S — 292 (2.20 1.45 1.02) 478 — S — 293 (1.70 1.26 1.21) 478 — S — 294 (2.15 1.29 1.18) 478 — S — 295 (1.91 1.53 0.94) 478 — S — 296 (2.19 1.53 0.94) 478 — S — 298 (1.76 1.14 1.34) 478 — S — 299 (1.01 1.48 1.00) 478 — S — 304 (1.56 0.98 1.49) 478 — S — 305 (2.08 1.20 1.28) 478 — S — 311 (1.40 0.87 1.60) 478 — S — 313 (1.27 0.91 1.56) 478 — S — 316 (1.56 1.20 1.28) 478 — S — 332 (1.56 0.95 1.52) 478 — S — 336 (1.66 0.84 1.63) 478 — S — 341 (1.16 1.47 1.00) 478 — S — 358 (1.51 1.12 1.36) 478 — S — 370 (1.48 1.18 1.29) 478 — S — 372 (1.70 0.88 1.59) 478 — S — 373 (1.09 0.89 1.59) 478 — S — 374 (1.31 1.38 1.10) 478 — S — 379 (1.39 0.88 1.59) 478 — S — 381 (0.96 1.05 1.42) 478 — S — 382 (1.46 1.06 1.41) 478 — S — 391 (1.40 0.87 1.61) 478 — S — 396 (1.75 1.04 1.44) 478 — S — 397 (1.55 0.88 1.59) 478 — S — 419 (0.84 0.86 1.61) 478 — S — 434 (1.40 1.17 1.30) 478 — S — 435 (1.49 1.34 1.13) 478 — S — 440 (2.01 1.51 0.97) 478 — S — 441 (1.94 1.43 1.04) 478 — S — 450 (1.31 1.26 1.22) 478 — S — 455 (1.39 1.00 1.48) 478 — S — 457 (1.54 1.50 0.97) 478 — S — 458 (1.08 1.30 1.18) 478 — S — 467 (1.22 1.10 1.37) 478 — S — 468 (1.42 1.41 1.07) 478 — S — 471 (2.12 1.17 1.31) 479 — S — 20 (1.85 1.06 1.14) 479 — S — 27 (1.77 1.23 0.98) 479 — S — 29 (1.59 1.22 0.99) 479 — S — 40 (1.41 1.22 0.99) 479 — S — 45 (0.88 0.87 1.34) 479 — S — 61 (1.74 1.20 1.00) 479 — S — 65 (1.75 1.00 1.21) 479 — S — 68 (1.46 0.96 1.24) 479 — S — 85 (2.25 1.18 1.02) 479 — S — 96 (0.83 0.99 1.22) 479 — S — 112 (1.70 1.01 1.20) 479 — S — 118 (1.78 0.91 1.30) 479 — S — 119 (1.76 1.12 1.08) 479 — S — 123 (1.40 1.25 0.95) 479 — S — 132 (1.72 0.83 1.37) 479 — S — 147 (1.25 1.12 1.08) 479 — S — 177 (2.34 1.29 0.91) 479 — S — 184 (3.08 1.10 1.10) 479 — S — 195 (2.51 0.95 1.26) 479 — S — 198 (2.22 1.01 1.20) 479 — S — 205 (1.74 1.07 1.14) 479 — S — 213 (2.19 0.96 1.24) 479 — S — 217 (1.61 1.00 1.21) 479 — S — 218 (1.58 1.17 1.03) 479 — S — 233 (2.12 1.16 1.04) 479 — S — 234 (1.94 1.24 0.96) 479 — S — 244 (2.00 1.15 1.05) 479 — S — 245 (1.92 0.93 1.28) 479 — S — 254 (1.76 0.85 1.35) 479 — S — 266 (1.85 1.21 0.99)

479 — S — 267 (1.65 0.91 1.29) 479 — S — 275 (1.33 1.13 1.07) 479 — S — 277 (1.74 0.98 1.22) 479 — S — 279 (1.79 1.04 1.16)
479 — S — 285 (1.52 0.92 1.28) 479 — S — 286 (1.77 0.83 1.38) 479 — S — 287 (1.58 0.84 1.37) 479 — S — 290 (1.85 1.24 0.96)
479 — S — 293 (1.83 1.12 1.09) 479 — S — 294 (2.28 1.15 1.05) 479 — S — 298 (1.88 0.99 1.21) 479 — S — 304 (1.69 0.84 1.36)
479 — S — 305 (2.21 1.06 1.15) 479 — S — 316 (1.69 1.05 1.15) 479 — S — 319 (0.89 0.91 1.29) 479 — S — 332 (1.69 0.81 1.39)
479 — S — 358 (1.63 0.97 1.23) 479 — S — 370 (1.60 1.04 1.16) 479 — S — 374 (1.44 1.23 0.97) 479 — S — 381 (1.09 0.91 1.30)
479 — S — 382 (1.59 0.92 1.29) 479 — S — 396 (1.88 0.89 1.31) 479 — S — 434 (1.53 1.03 1.17) 479 — S — 435 (1.61 1.20 1.01)
479 — S — 441 (2.07 1.29 0.91) 479 — S — 450 (1.44 1.11 1.09) 479 — S — 455 (1.52 0.85 1.35) 479 — S — 458 (1.21 1.15 1.05)
479 — S — 467 (1.35 0.96 1.24) 479 — S — 468 (1.55 1.27 0.94) 479 — S — 471 (2.24 1.02 1.18) 480 — S — 36 (0.82 2.01 1.36)
480 — S — 37 (0.82 2.31 1.06) 480 — S — 43 (1.24 1.86 1.51) 480 — S — 46 (1.83 1.38 1.99) 480 — S — 57 (1.51 2.40 0.97)
480 — S — 70 (1.30 2.07 1.30) 480 — S — 85 (1.08 1.19 2.19) 480 — S — 89 (1.06 1.81 1.56) 480 — S — 90 (0.97 1.66 1.71)
480 — S — 107 (1.34 1.35 2.02) 480 — S — 108 (0.90 1.74 1.63) 480 — S — 109 (1.14 1.87 1.50) 480 — S — 115 (1.01 1.49 1.88)
480 — S — 133 (1.35 1.64 1.73) 480 — S — 150 (2.17 1.51 1.86) 480 — S — 151 (2.07 1.77 1.60) 480 — S — 152 (2.72 2.07 1.30)
480 — S — 153 (2.10 1.61 1.76) 480 — S — 177 (1.18 1.29 2.08) 480 — S — 183 (0.83 1.63 1.74) 480 — S — 184 (1.91 1.10 2.27)
480 — S — 192 (1.52 1.62 1.75) 480 — S — 195 (1.35 0.95 2.42) 480 — S — 198 (1.06 1.01 2.36) 480 — S — 207 (1.09 1.93 1.44)
480 — S — 213 (1.02 0.96 2.41) 480 — S — 215 (1.32 2.19 1.18) 480 — S — 231 (1.56 1.74 1.63) 480 — S — 233 (0.95 1.16 2.21)
480 — S — 244 (0.84 1.15 2.22) 480 — S — 246 (1.09 1.49 1.88) 480 — S — 248 (1.16 2.04 1.33) 480 — S — 255 (1.48 1.71 1.66)
480 — S — 265 (1.05 1.63 1.74) 480 — S — 268 (1.03 1.78 1.59) 480 — S — 269 (0.99 1.71 1.66) 480 — S — 270 (1.13 2.39 0.98)
480 — S — 271 (1.74 1.80 1.57) 480 — S — 291 (1.83 1.65 1.72) 480 — S — 292 (1.16 1.31 2.06) 480 — S — 294 (1.12 1.15 2.22)
480 — S — 295 (0.87 1.39 1.98) 480 — S — 296 (1.15 1.39 1.98) 480 — S — 305 (1.04 1.06 2.31) 480 — S — 306 (1.20 1.71 1.66)
480 — S — 307 (0.93 1.84 1.53) 480 — S — 320 (1.42 2.13 1.24) 480 — S — 327 (0.81 1.46 1.91) 480 — S — 329 (1.14 1.92 1.45)
480 — S — 342 (2.57 1.67 1.70) 480 — S — 343 (3.10 2.16 1.21) 480 — S — 364 (1.28 2.29 1.08) 480 — S — 367 (1.10 1.61 1.76)
480 — S — 368 (1.21 2.15 1.22) 480 — S — 371 (2.26 1.76 1.61) 480 — S — 395 (1.29 1.46 1.91) 480 — S — 440 (0.97 1.37 2.00)
480 — S — 441 (0.90 1.29 2.08) 480 — S — 447 (0.91 1.48 1.89) 480 — S — 451 (1.00 2.06 1.31) 480 — S — 452 (1.05 1.72 1.65)
480 — S — 463 (0.93 2.16 1.21) 480 — S — 471 (1.08 1.02 2.35) 480 — S — 472 (1.65 2.44 0.93) 480 — S — 473 (1.12 1.64 1.73)
480 — S — 474 (0.98 1.53 1.84) 481 — S — 9 (1.03 1.23 2.41) 481 — S — 20 (1.14 1.77 1.86) 481 — S — 27 (1.05 1.94 1.69)
481 — S — 28 (1.11 2.21 1.42) 481 — S — 29 (0.87 1.93 1.70) 481 — S — 36 (1.27 2.72 0.91) 481 — S — 43 (1.69 2.57 1.06)
481 — S — 46 (2.28 2.09 1.54) 481 — S — 56 (1.04 1.40 2.23) 481 — S — 61 (1.02 1.91 1.72) 481 — S — 62 (0.90 2.11 1.52)
481 — S — 65 (1.03 1.71 1.92) 481 — S — 79 (1.02 2.08 1.55) 481 — S — 80 (0.97 2.04 1.59) 481 — S — 81 (1.05 2.17 1.46)
481 — S — 83 (1.08 1.34 2.29) 481 — S — 85 (1.53 1.90 1.74) 481 — S — 89 (1.51 2.52 1.11) 481 — S — 90 (1.42 2.37 1.26)
481 — S — 101 (1.17 2.22 1.41) 481 — S — 105 (1.33 1.32 2.31) 481 — S — 107 (1.79 2.06 1.57) 481 — S — 108 (1.35 2.45 1.18)
481 — S — 109 (1.59 2.58 1.05) 481 — S — 110 (1.09 2.22 1.41) 481 — S — 111 (1.79 1.34 2.29) 481 — S — 112 (0.98 1.72 1.91)
481 — S — 113 (1.19 2.64 0.99) 481 — S — 115 (1.46 2.20 1.43) 481 — S — 118 (1.07 1.62 2.01) 481 — S — 119 (1.04 1.83 1.80)
481 — S — 131 (1.10 1.30 2.33) 481 — S — 132 (1.01 1.54 2.09) 481 — S — 133 (1.80 2.35 1.28) 481 — S — 144 (1.13 2.26 1.37)
481 — S — 150 (2.62 2.22 1.41) 481 — S — 151 (2.52 2.48 1.15) 481 — S — 153 (2.55 2.32 1.31) 481 — S — 154 (2.08 1.45 2.18)
481 — S — 166 (1.80 1.28 2.35) 481 — S — 167 (1.66 0.96 2.67) 481 — S — 171 (1.57 1.27 2.36) 481 — S — 175 (0.80 0.91 2.72)
481 — S — 177 (1.63 2.00 1.63) 481 — S — 183 (1.28 2.34 1.29) 481 — S — 184 (2.36 1.81 1.82) 481 — S — 187 (1.51 1.19 2.44)
481 — S — 188 (1.94 1.23 2.40) 481 — S — 189 (1.69 0.81 2.82) 481 — S — 192 (1.97 2.33 1.30) 481 — S — 193 (0.89 1.50 2.13)
481 — S — 194 (1.74 0.94 2.69) 481 — S — 195 (1.80 1.66 1.97) 481 — S — 198 (1.51 1.72 1.91) 481 — S — 205 (1.03 1.78 1.85)
481 — S — 206 (1.02 2.69 0.94) 481 — S — 207 (1.54 2.64 0.99) 481 — S — 208 (0.99 1.25 2.38) 481 — S — 213 (1.47 1.67 1.96)
481 — S — 214 (1.03 0.91 2.72) 481 — S — 217 (0.90 1.71 1.92) 481 — S — 218 (0.87 1.88 1.75) 481 — S — 231 (2.02 2.45 1.18)
481 — S — 233 (1.40 1.87 1.76) 481 — S — 234 (1.22 1.95 1.68) 481 — S — 236 (1.44 0.84 2.79) 481 — S — 237 (1.23 2.25 1.38)
481 — S — 243 (1.97 1.08 2.55) 481 — S — 244 (1.29 1.86 1.77) 481 — S — 245 (1.20 1.64 1.99) 481 — S — 246 (1.54 2.20 1.43)
481 — S — 249 (1.08 2.59 1.04) 481 — S — 251 (1.05 2.45 1.18) 481 — S — 254 (1.04 1.56 2.07) 481 — S — 255 (1.93 2.42 1.21)
481 — S — 265 (1.50 2.34 1.29) 481 — S — 266 (1.14 1.92 1.71) 481 — S — 267 (0.94 1.62 2.01) 481 — S — 268 (1.48 2.49 1.14)
481 — S — 269 (1.44 2.42 1.21) 481 — S — 271 (2.19 2.51 1.12) 481 — S — 272 (1.32 0.97 2.66) 481 — S — 274 (0.81 1.42 2.21)
481 — S — 277 (1.03 1.69 1.94) 481 — S — 279 (1.08 1.75 1.88) 481 — S — 282 (0.88 1.26 2.37) 481 — S — 285 (0.80 1.63 2.00)
481 — S — 286 (1.06 1.54 2.09) 481 — S — 287 (0.86 1.55 2.08) 481 — S — 288 (0.85 1.49 2.14) 481 — S — 289 (1.11 1.33 2.30)
481 — S — 290 (1.14 1.95 1.68) 481 — S — 291 (2.28 2.36 1.27) 481 — S — 292 (1.61 2.02 1.61) 481 — S — 293 (1.11 1.83 1.80)
481 — S — 294 (1.57 1.86 1.77) 481 — S — 295 (1.32 2.10 1.53) 481 — S — 296 (1.60 2.10 1.53) 481 — S — 297 (0.91 1.23 2.40)
481 — S — 298 (1.17 1.70 1.93) 481 — S — 300 (1.17 1.10 2.53) 481 — S — 301 (1.23 0.81 2.82) 481 — S — 303 (0.93 1.08 2.55)
481 — S — 304 (0.97 1.55 2.08) 481 — S — 305 (1.49 1.77 1.86) 481 — S — 306 (1.65 2.42 1.21) 481 — S — 307 (1.38 2.55 1.08)
481 — S — 310 (1.09 1.16 2.47) 481 — S — 311 (0.81 1.44 2.19) 481 — S — 312 (0.91 1.31 2.32) 481 — S — 316 (0.97 1.77 1.86)
481 — S — 318 (1.27 0.81 2.82) 481 — S — 327 (1.26 2.17 1.46) 481 — S — 329 (1.59 2.63 1.00) 481 — S — 331 (1.12 1.35 2.28)
481 — S — 332 (0.98 1.52 2.11) 481 — S — 336 (1.08 1.41 2.22) 481 — S — 342 (3.02 2.38 1.25) 481 — S — 357 (1.44 0.97 2.66)
481 — S — 358 (0.92 1.69 1.94) 481 — S — 367 (1.55 2.32 1.31) 481 — S — 370 (0.89 1.75 1.88) 481 — S — 371 (2.71 2.47 1.16)
481 — S — 372 (1.12 1.45 2.18) 481 — S — 379 (0.80 1.45 2.18) 481 — S — 382 (0.87 1.63 2.00) 481 — S — 391 (0.81 1.44 2.19)
481 — S — 395 (1.74 2.17 1.46) 481 — S — 396 (1.16 1.61 2.03) 481 — S — 397 (0.97 1.45 2.18) 481 — S — 415 (0.86 1.33 2.30)
481 — S — 420 (0.92 2.65 0.98) 481 — S — 432 (0.99 0.94 2.69) 481 — S — 434 (0.81 1.74 1.89) 481 — S — 435 (0.90 1.91 1.72)

481 — S — 437 (1.08 1.28 2.35) 481 — S — 440 (1.42 2.08 1.55) 481 — S — 441 (1.35 2.00 1.63) 481 — S — 443 (0.83 2.62 1.01)
481 — S — 447 (1.36 2.19 1.44) 481 — S — 449 (1.11 2.16 1.47) 481 — S — 452 (1.50 2.43 1.20) 481 — S — 453 (0.99 1.13 2.50)
481 — S — 454 (0.82 1.29 2.34) 481 — S — 455 (0.80 1.56 2.07) 481 — S — 457 (0.95 2.07 1.56) 481 — S — 460 (1.23 2.50 1.13)
481 — S — 461 (0.94 2.26 1.37) 481 — S — 468 (0.83 1.98 1.65) 481 — S — 469 (0.92 2.40 1.23) 481 — S — 471 (1.53 1.73 1.90)
481 — S — 473 (1.58 2.35 1.28) 481 — S — 474 (1.43 2.24 1.39)

In einer Ausführungsform werden an die chemisch substituierbaren Positionen der so erhaltenen organischen Moleküle weitere Reste R angefügt, um die Löslichkeit der Emitter zu steigern und/oder die Polymerisierbarkeit zu ermöglichen ohne dabei die elektronischen Eigenschaften des Moleküls signifikant zu verändern, sodass auch bei Verwendung von R ein Emitter vorliegt, wobei

jedes R ist bei jedem Auftreten unabhängig voneinander ausgewählt aus der Gruppe bestehend aus H, Deuterium, Phenyl, Naphthyl, F, Cl, Br, I, $N(R^2)_2$, -CN, -NC, -SCN, $-CF_3$,$-NO_2$, -OH, C(=O)OH, $C(=O)OR^3$, $C(=O)N(R^3)2$, $C(=O)SR^3$, $C(=S)SR^3$, $Si(R4)^3$, $B(OR^5)2$, $B(N(R^6)_2)_2$, $C(=O)R^3$, $P(=O)(R^7)_2$, $AS(=O)(R^7)_2$, $P(=S)(R^7)_2$, $AS(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R auch miteinander ein mono- oder polycyclisches, aliphatisch benzoannelliertes, aromatisches und/oder benzoannelliertes Ringsystem bilden;

$R^2$ ist bei jedem Auftreten unabhängig voneinander ausgewählt aus der Gruppe bestehend aus H, Deuterium, Phenyl, Naphthyl, $CF_3$, $C(=O)OR^3$, $C(=O)N(R^2)_2$, $Si(R^4)_3$, $C(=O)R^3$, $P(=O)(R^7)_2$, $AS(=O)(R^7)_2$ $P(=S)(R^7)_2$, $AS(=S)(R^7)_2$, $S(=O)R^3$, $S(=O)_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$,$-Ge(R^4)_2-$, $-Sn(R^4)_2-$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, oder -S-ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden;

$R^4$ ist bei jedem Auftreten unabhängig voneinander ausgewählt aus der Gruppe bestehend aus H, Deuterium, Phenyl, Naphthyl, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $As(=S)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder

mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden;

$R^5$ ist bei jedem Auftreten unabhängig voneinander ausgewählt aus der Gruppe bestehend aus Phenyl, Naphthyl, $CF_3$, $C(=O)R^3$, $P(=O)(R^7)_2$, $As(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, $-C\equiv C-$, bzw. eine benachbarte $CH_2$-Gruppe durch $-Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden;

$R^6$ ist bei jedem Auftreten unabhängig voneinander ausgewählt aus der Gruppe bestehend aus Phenyl, Naphthyl, $CF_3$, $Si(R^4)_3$, $C(=O)R^3$, $P(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, $-C\equiv C-$, bzw. eine benachbarte $CH_2$-Gruppe durch-$Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden;

$R^7$ ist bei jedem Auftreten unabhängig voneinander ausgewählt aus der Gruppe bestehend aus Phenyl, Naphthyl, $N(R^2)_2$, CN, $CF_3$, $C(=O)OR^3$, $C(=O)N(R^3)_2$, $Si(R^4)_3$, $C(=O)R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, $-C\equiv C-$, bzw. eine benachbarte $CH_2$-Gruppe durch $-Si(R^4)_2-$,$-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$,$-As(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden;

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden;

$R^9$ ist bei jedem Auftreten unabhängig voneinander ausgewählt aus der Gruppe bestehend aus H, Deuterium, Phenyl, Naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $AS(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch $-R^3C=CR^3-$, $-C\equiv C-$, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-,-C=N-,

-C(=O)O-, -C(=O)N($R^3$)-, -P(=O)($R^7$)-, -As(=O)($R^7$)-, -P(=S)($R^7$)-, -As(=S)($R^7$)-, -S(=O)-, -S(=O)$_2$-, -N$R^2$-, -O-, oder-S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem;

Polymerisierbare Reste sind solche Reste, die polymerisierbare funktionelle Einheiten tragen, die mit sich selbst homopolymerisiert oder mit anderen Monomeren copolymiersiert werden können. Somit können die Moleküle als Polymer mit folgenden Wiederholungseinheiten der Formeln 9 und 10 erhalten werden, die als Polymere in der lichtemittierenden Schicht des optoelektronischen Bauelements Verwendung finden können.

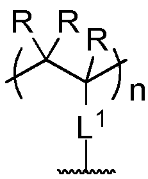
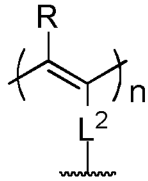

**Formel 9** **Formel 10**

In Formel 9 und 10 stehen L1 und L2 für gleiche oder verschiedene Linkergruppen, die 0 bis 20, insbeosndere 1 bis 15, oder 2 bis 10 Kohlenstoffatome aufweisen, und wobei die gewellte Linie die Position kennzeichnet, über die die Linkergruppe an das organische Molekül der Formel 1 angebunden ist. R ist wie oben definiert. In einer Ausführungsform weist die Linkergruppe L1 und/oder L2 eine Form -X-L3- auf, wobei X für O oder S steht und L3 für eine Linkergruppe ausgewählt aus der Gruppe aus einer substituierten und unsubstituierten Alkylengruppe (linear, verzweigt oder cyclisch) und einer substituierten und unsubstituierten Arylengruppe, insbesondere eine substituierte oder unsubstituierte Alkylengruppe mit 1 bis 10 Kohlenstoffatomen oder eine substituierte oder unsubstituierte Phenylengruppe, wobei auch Kombinationen möglich sind. In einer weiteren Ausführungsform weist die Linkergruppe L1 und/oder L2 eine Form -C(=O)O- auf.

Vorteilhafte Ausführungsformen der Wiederholungseinheiten sind Strukturen der Formeln 11 bis 16:

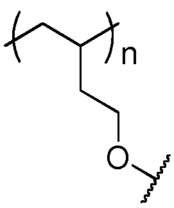
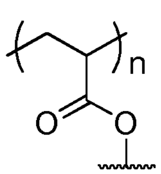
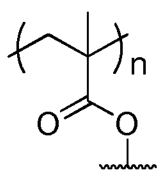
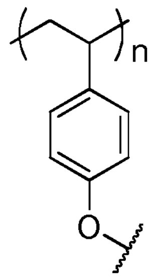
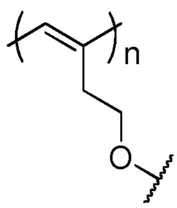
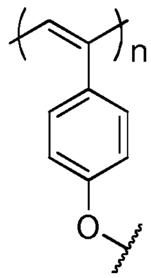

**Formel 11** **Formel 12** **Formel 13** **Formel 14** **Formel 15** **Formel 16**

Zur Herstellung der Polymere, die die Wiederholungseinheiten gemäß Formel 11 bis 16 aufweisen, werden die polymerisierbaren funktionellen Einheiten über eine Linkergruppe der Formeln 17 bis 22, die eine Hydroxyleinheit aufweisen, an das organische Molekül der Formel 1 angebunden und die daraus resultierenden Verbindungen mit sich selbst homopolymerisiert oder mit anderen geeigneten Monomeren copolymerisiert.

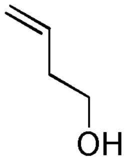 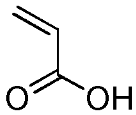 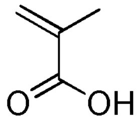 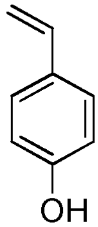 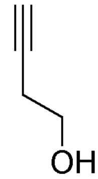 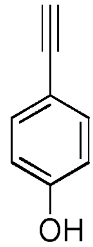

**Formel 17** **Formel 18** **Formel 19** **Formel 20** **Formel 21** **Formel 22**

Polymere, die eine Einheit gemäß Formel 9 oder Formel 10 aufweisen, können dabei entweder ausschließlich Wiederholungseinheiten mit einer Struktur der allgemeinen Formel 9 oder 10, oder Wiederholungseinheiten mit einer anderen Struktur aufweisen. Beispiele von Wiederholungseinheiten mit anderen Strukturen weisen Einheiten auf, die sich aus entsprechenden Monomeren ergeben, die typischerweise in Copolymerisationen eingesetzt oder verwendet werden. Beispiele für derartige Wiederholungseinheiten, die sich aus Monomeren ergeben, sind Wiederholungseinheiten, die ungesättigte Einheiten wie Ethylen oder Styrol aufweisen.

Eine Ausführungsform der Beschreibung betrifft organischen Moleküle, welche

- einen $\Delta E(S_1-T_1)$-Wert zwischen dem untersten angeregten Singulett ($S_1$)- und dem darunter liegenden Triplett ($T_1$)-Zustand von kleiner als 0,2 eV, insbesondere kleiner als 0,1 eV aufweisen und/oder
- eine Emissionslebensdauer von höchstens 50 $\mu$s aufweisen.

Eine weitere Ausführungsform der Beschreibung betrifft die Verwendung eines Separators S in Form einer neutralen chemischen Einheit zur Bereitstellung eines beschriebenen organischen Moleküls, wobei eine erste chemische Einheit AF1, aufweisend ein konjugiertes System, insbesondere mindestens sechs in Konjugation stehende $\pi$-Elektronen und eine zweite chemische Einheit AF2, aufweisend ein konjugiertes System, insbesondere mindestens sechs in Konjugation stehende $\pi$-Elektronen, kovalent über den Separator S derart verknüpft wird, dass der Separator S eine direkte elektronische Wechselwirkung über konjugierte Bindungen zwischen dem konjugierten System der ersten chemischen Einheit AF1 und dem konjugierten System der zweiten chemischen Einheit AF2 unterbindet.

Die Erfindung betrifft die Verwendung eines organischen Moleküls als lumineszierender Emitter und/oder als Hostmaterial und/oder als Elektronentransportmaterial und/oder als Lochinjektionsmaterial und/oder als Lochblockiermaterial in einem optoelektronischen Bauelement, das insbesondere durch ein Vakuumverdampfungsverfahren oder aus Lösung hergestellt wird, wobei das optoelektronische Bauelement insbesondere ausgewählt ist aus der Gruppe bestehend aus:

- organischen lichtemittierenden Dioden (OLEDs),
- lichtemittierenden elektrochemischen Zellen,
- OLED-Sensoren, insbesondere in nicht hermetisch nach außen abgeschirmten Gas- und Dampf-Sensoren,
- organischen Dioden,
- organischen Solarzellen,
- organischen Transistoren,
- organischen Feldeffekttransistoren,
- organischen Lasern und
- Down-Konversions-Elementen.

Der Anteil des organischen Moleküls am lumineszierenden Emitter und/oder Hostmaterial und/oder Elektronentransportmaterial und/oder Lochinjektionsmaterial und/oder Lochblockiermaterial beträgt in einer Ausführungsform 1 % bis 99 % (Gew%), insbesondere beträgt der Anteil am Emitter in optischen Licht emittierenden Bauelementen, insbesondere in OLEDs, zwischen 5 % und 80 %.

Die Erfindung betrifft in einem weiteren Aspekt optoelektronische Bauelemente, aufweisend ein hier beschriebenes organisches Molekül, wobei das optoelektronische Bauelement insbesondere ausgeformt ist als ein Bauelement ausgewählt aus der Gruppe bestehend aus organischer lichtemittierender Diode (OLED), lichtemittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

Eine Ausführungsform betrifft das erfindungsgemäße optoelektronische Bauelement aufweisend ein Substrat, eine Anode und eine Kathode, wobei die Anode und die Kathode auf das Substrat aufgebracht sind, und mindestens

eine lichtemittierende Schicht, welche zwischen Anode und Kathode angeordnet ist und die ein hier beschriebenes organisches Molekül enthält.

In einer weiteren Ausführungsform des Bauelements wird das organische Molekül als Emissionsmaterial in einer Emissionsschicht eingesetzt wird, wobei sie in Kombination mit mindestens einem Hostmaterial oder insbesondere als Reinschicht eingesetzt werden kann. In einer Ausführungsform beträgt dabei der Anteil des organischen Moleküls als Emissionsmaterial in einer Emissionsschicht in optischen Licht-emittierenden Bauelementen, insbesondere in OLEDs, zwischen 5 % und 80 % (Gew%).

In einer weiteren Ausführungsform des erfindungsgemäßen Bauelements ist die ein hier beschriebenes organisches Molekül aufweisende lichtemittierende Schicht auf ein Substrat aufgebracht.

In einer Ausführungsform betrifft die Erfindung ein optoelektronisches Bauelement, bei dem die lichtemittierende Schicht ausschließlich ein hier beschriebenes organisches Molekül in 100 % Konzentration aufweist, wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement neben dem beschriebenen organischen Molekül mindestens ein Hostmaterial auf, wobei insbesondere der angeregte Singulettzustand ($S_1$) und/oder der angeregte Triplettzustand ($T_1$) des mindestens einen Hostmaterials höher ist als der angeregte Singulettzustand ($S_1$) und/oder der angeregte Triplettzustand (T) des organischen Moleküls, und wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement ein Substrat, eine Anode, eine Kathode und mindestens je eine löcherinjizierende und eine elektroneninjizierende Schicht und mindestens eine lichtemittierende Schicht auf, wobei die mindestens eine lichtemittierende Schicht ein beschriebenes organisches Molekül und ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist und die lichtemittierende Schicht zwischen löcher- und elektroneninjizierende Schicht aufgebracht ist.

In einer weiteren Ausführungsform weist das optoelektronische Bauelement ein Substrat, eine Anode, eine Kathode und mindestens je eine löcherinjizierende und eine elektroneninjizierende Schicht, und mindestens je eine löchertransportierende und eine elektronentransportierende Schicht, und mindestens eine lichtemittierende Schicht auf, wobei die mindestens eine lichtemittierende Schicht ein beschriebenes organisches Molekül sowie ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

In einer weiteren Ausführungsform weist das optoelektronische Bauelement mindestens ein Hostmaterial aus einem Material gemäß Formel 1 auf.

In einer weiteren Ausführungsform des optoelektronischen Bauelements beinhaltet die lichtemittierende Schicht fluoreszente oder phosphoreszente Materialien, welche ausgewählt sein können aus Formel 1.

In einer weiteren Ausführungsform des optoelektronischen Bauelements bilden ein organisches Molekül gemäß Formel 1 und ein funktionelles Material, beispielsweise in Form eines weiteren Emitter-Materials, eines Host-Materials, oder eines weiteren organisches Moleküls, welches zur Bildung eines Exciplex mit dem Molekül gemäß Formel 1 befähigt ist, einen Exciplex. Funktionelle Materialien sind beispielsweise Hostmaterialien wie MCP, Elektronentransportmaterialien wie TPBI und Lochtransportmaterialien wie NPD oder MTDATA. Exciplexe sind Addukte aus elektronisch angeregten Molekülen und solchen im elektronischen Grundzustand, die zur Lichtemission fähig sind.

In einer weiteren Ausführungsform des optoelektronischen Bauelements ist die Emission durch thermisch aktivierte verzögerte Fluoreszenz (TADF) charakterisiert.

In einer weiteren Ausführungsform des optoelektronischen Bauelements werden organische Moleküle gemäß Formel 1 als Ladungstransportschicht verwendet.

Die Beschreibung betrifft ein lichtemittierendes Material, aufweisend ein organisches Molekül und ein Hostmaterial, wobei die Triplett ($T_1$)- und Singulett ($S_1$)-Energieniveaus des Hostmaterials energetisch höher liegen als die Triplett ($T_1$)- und Singulett ($S_1$)-Energieniveaus des organischen Moleküls, und wobei das organische Molekül Fluoreszenz oder thermisch aktivierte verzögerte Fluoreszenz (TADF) emittiert, und einen $\Delta E(S_1\text{-}T_1)$-Wert zwischen dem untersten angeregten Singulett ($S_1$)- und dem darunter liegenden Triplett ($T_1$)-Zustand von kleiner als 0,2 eV, insbesondere kleiner als 0,1 eV aufweist.

Ein Aspekt der Erfindung betrifft ein Verfahren zur Herstellung eines optoelektronischen Bauelements aufweisend ein beschriebenes organisches Molekül. In einer Ausführungsform weist das Verfahren den Schritt der Verarbeitung des organischen Moleküls mittels eines Vakuumverdampfungsverfahrens oder aus einer Lösung auf.

In einer Ausführungsform weist das Verfahren den Schritt des Aufbringens des organischen Moleküls auf einen

Träger auf, wobei das Aufbringen insbesondere nass-chemisch, mittels kolloidaler Suspension oder mittels Sublimation erfolgt.

In einer weiteren Ausführungsform des Verfahrens wird mindestens eine Schicht

- mit einem Sublimationsverfahren beschichtet,
- mit einem OVPD (Organic Vapor Phase Deposition) Verfahren beschichtet,
- mit Hilfe einer Trägergassublimation beschichtet oder
- aus Lösung oder mit einem beliebigen Druckverfahren hergestellt.

Ein Aspekt der Beschreibung betrifft ein Verfahren zur Veränderung der Emissions- und/oder Absorptionseigenschaften eines elektronischen Bauelements, wobei ein organisches Molekül in ein Matrixmaterial zur Leitung von Elektronen oder Löchern in einem optoelektronischen Bauelement eingebracht wird.

Die Beschreibung betrifft zudem in einem weiteren Aspekt die Verwendung eines Moleküls zur Umwandlung von UV-Strahlung oder von blauem Licht in sichtbares Licht, insbesondere in grünes, gelbes oder rotes Licht (Down-Konversion), insbesondere in einem optoelektronischen Bauelement der hier beschriebenen Art.

In einem weiteren Aspekt betrifft die Beschreibung eine Anwendung, in der mindestens ein Material aus Formel 1, durch äußere energetische Anregung zum Leuchten angeregt wird. Die äußere Anregung kann elektronisch oder optisch oder radioaktiv sein.

## Beispiele

### Berechnungen nach der Dichtefunktionaltheorie

#### Variante 1 (BP86)

Für die DFT-Rechnungen (Dichtefunktionaltheorie) wurde das BP86-Funktional (Becke, A. D. Phys. Rev. A1988, 38, 3098-3100; Perdew, J. P. Phys. Rev. B1986, 33, 8822-8827) und def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) verwendet. Zur numerischen Integration kam das m4-Grid zum Einsatz und die resolution-of-identity-Näherung (RI) (Häser, M.; Ahlrichs, R. J. Comput. Chem. 1989, 10, 104-111; Weigend, F.; Häser, M. Theor. Chem. Acc. 1997, 97, 331-340; Sierka, M.; Hogekamp, A.; Ahlrichs, R. J. Chem. Phys. 2003, 118, 9136-9148) wurde in allen Rechnungen verwendet. Die DFT-Rechnungen wurden mit dem Turbomole-Programmpaket (Version 6.5) (TURBOMOLE V6.4 2012, University of Karlsruhe/Forschungszentrum Karlsruhe GmbH, 1989-2007, TURBOMOLE GmbH, since 2007; http://www.turbomole.com) durchgeführt.

#### Variante 2 (TD-B3LYP)

Für die Optimierung der Molekülstrukturen wurde das BP86-Funktional (Becke, A. D. Phys. Rev. A1988, 38, 3098-3100; Perdew, J. P. Phys. Rev. B1986, 33, 8822-8827) verwendet, wobei die resolution-of-identity-Näherung (RI) (Sierka, M.; Hogekamp, A.; Ahlrichs, R. J. Chem. Phys. 2003, 118, 9136-9148; Becke, A.D. , J.Chem.Phys. 98 (1993) 5648-5652; Lee, C; Yang, W; Parr, R.G. Phys. Rev. B 37 (1988) 785-789) zum Einsatz kam. Anregungsenergien wurden bei der mit BP86 optimierten Struktur mit der Time-Dependent DFT-Methode (TD-DFT) unter Verwendung des B3LYP-Funktionals (Becke, A.D. , J.Chem.Phys. 98 (1993) 5648-5652; Lee, C; Yang, W; Parr, R.G. Phys. Rev. B 37 (1988) 785-789; Vosko, S. H.; Wilk, L.; Nusair, M. Can. J. Phys. 58 (1980) 1200-1211; Stephens, P. J.; Devlin, F. J.; Chabalowski, C. F. ; Frisch, M. J. J.Phys.Chem. 98 (1994) 11623-11627) berechnet. In allen Rechnungen wurden def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) und ein m4 -Grid zur numerischen Integration verwendet. Alle DFT-Rechnungen wurden mit dem Turbomole-Programmpaket (Version 6.5) (TURBOMOLE V6.4 2012, University of Karlsruhe und Forschungszentrum Karlsruhe GmbH, 1989-2007, TURBOMOLE GmbH, since 2007; http://www. turbomole.com) durchgeführt.

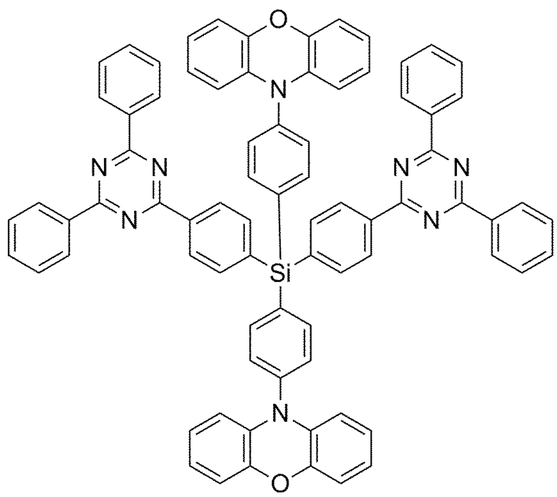

(0.088eV)

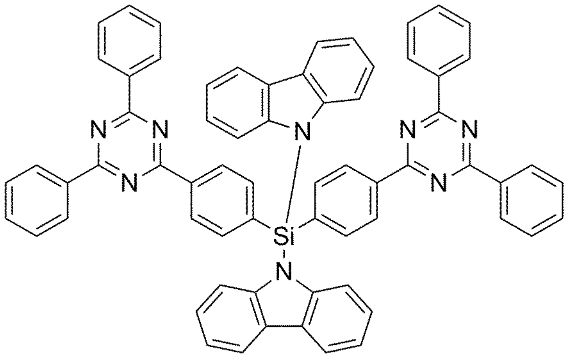

(0.043eV)

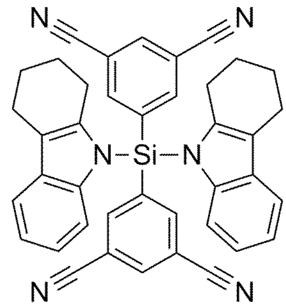

(0.008eV)

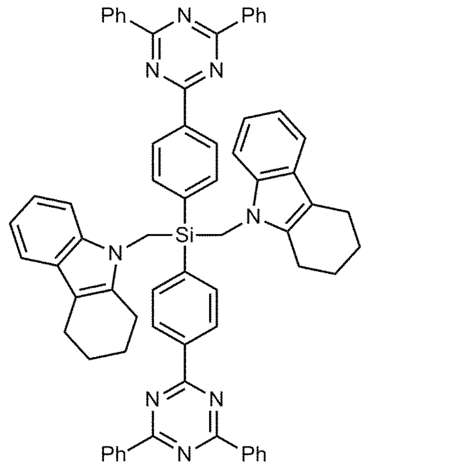

(0.007eV)

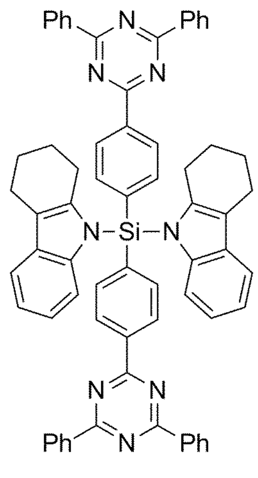

(0.013eV)

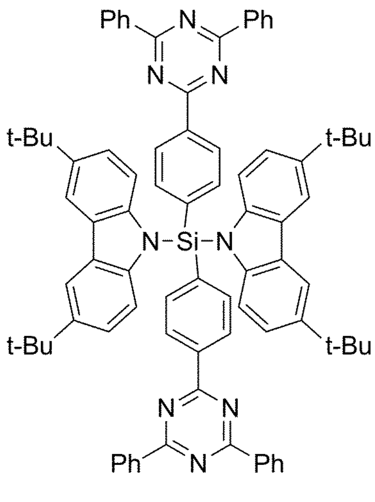

(0.015eV)

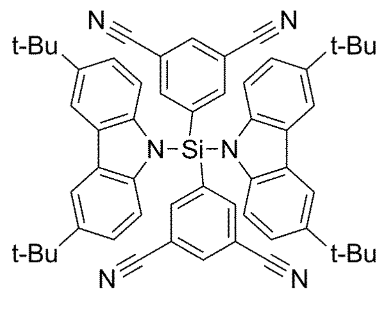

(0.022eV)

**Figuren**

Es zeigen

Figur 1: Schematische Darstellung des Aufbaus einer organischen lichtemittierenden Diode (OLED).
Figur 2: Schematische Darstellung des Energieniveaudiagrammes (relative Energie in eV) eines Emitters (Lichtemission resultiert aus dem Übergang LUMO AF2 hin zu HOMO AF1).

## Patentansprüche

1. Verwendung eines organischen Moleküls als lumineszierender Emitter und/oder als Hostmaterial und/oder als Elektronentransportmaterial und/oder als Lochinjektionsmaterial und/oder als Lochblockiermaterial in einem optoelektronischen Bauelement,
wobei das organische Molekül eine Struktur der Formel 1 aufweist

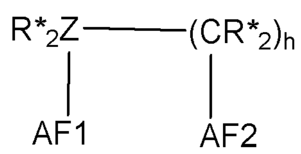

**Formel 1**

wobei

Z = sp3-Kohlenstoff oder sp3-Silicium;
h = 0, 1, 2, 3 oder 4;
$R^*_2Z-(CR^*_2)_h$ einen Separator S darstellt;
wobei die Einheit AF1 eine Struktur der Unterformel 1 aufweist:

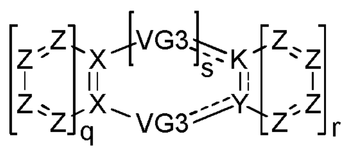

**Unterformel 1**

wobei gilt:

q ist 0 oder 1; r ist 0 oder 1; s ist 0 oder 1;
VG3 = verbrückende Gruppe ist bei jedem Auftreten unabhängig voneinander ausgewählt aus der Gruppe bestehend aus

N, O, S, CR**, C, einer Element-Element-Einfachbindung zwischen X und Y oder zwischen X und K, wobei nicht 2 Einheiten VG3 gleichzeitig eine Element-Element-Einfachbindung zwischen X und Y und zwischen X und K sind,
BR**, NR**, $GeR^{**}_2$, $AsR^{**}_2$, $SiR^{**}_2$, wobei nicht zwei Einheiten VG3 gleichzeitig gleich BR**, NR**, $GeR^{**}_2$, $AsR^{**}_2$, $SiR^{**}_2$ sind;

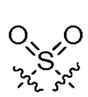, 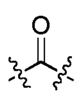, 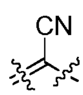, 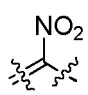, 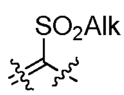, 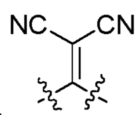, 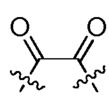, 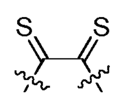, 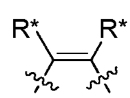,

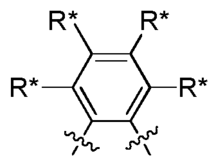

,

wobei nicht zwei Einheiten VG3 gleichzeitig gleich

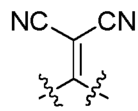 , 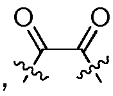 ,

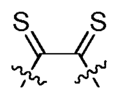 , 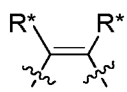 , 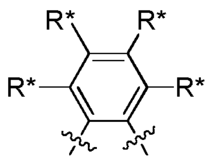

sind;

X ist bei jedem Auftreten unabhängig voneinander C, oder ist CR** oder N wenn q = 0;
Y ist C, oder ist CR**, $CR**_2$, N, NR**, O oder S wenn r = 0;
K ist Y, oder ist R* wenn r = 0 und gleichzeitig s = 0;
Z ist bei jedem Auftreten unabhängig voneinander CR** oder N;
und wobei maximal 4 der Einheiten VG3, K, X, Y, Z gleichzeitig gleich N sind;
und wobei mindestens 1 der Einheiten VG3, K, X, Y, Z gleich einer von C-H verschiedenen Gruppe ist, die mindestens 1 Stickstoffatom enthält;
und wobei im Falle von r = 0 auch zwei benachbarte Gruppen Z miteinander oder eine Gruppe VG3 mit der ihr am nächsten gelegenen Gruppe Z oder X oder Y über eine der folgenden Einheiten verbrückt sein können:

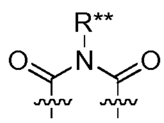 , 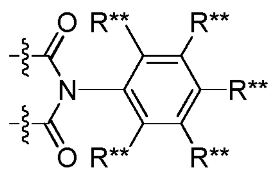 ;

wobei maximal drei dieser Einheiten enthalten sind;
R** ist bei jedem Auftreten unabhängig voneinander entweder ein Rest R*, oder eine chemische Bindung an einen Separator S, wobei genau ein R** eine chemische Bindung an einen Separator S ist;
und wobei die Einheit AF2 eine Struktur der Formel 3 aufweist

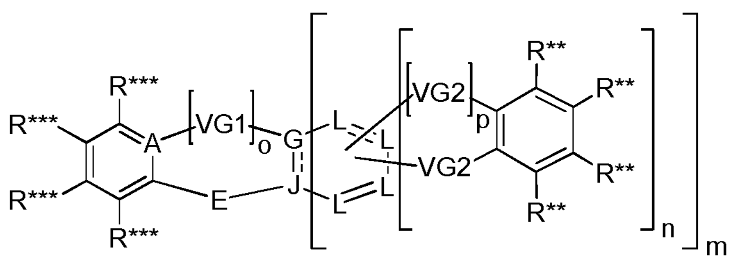

**Formel 3**

wobei gilt:

m ist 0 oder 1;
n ist 0 oder 1, wobei bei m = 0 immer auch n = 0 ist;
o ist 0 oder 1;
p ist 0 oder 1;
A ist CR*** wenn o = 0, ansonsten C;
VG1 = verbrückende Gruppe, ist ausgewählt aus der Gruppe bestehend aus

- NR**, CR**$_2$, O, S und einer C-C-Einfachbindung; oder
- NR**, CR**$_2$, O, S, einer C-C-Einfachbindung, BR**, AsR**, SiR**$_2$, GeR**$_2$,

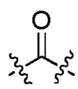, 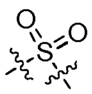, 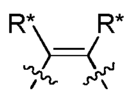, 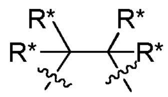, 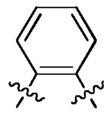, 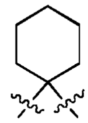, 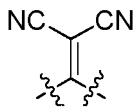, 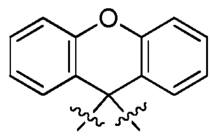,

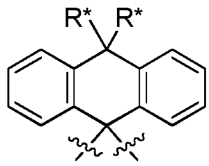, 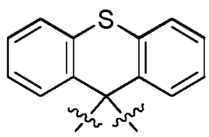, und 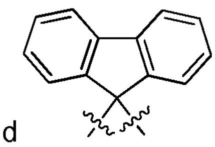,

wenn m = 1 und gleichzeitig n = 0;

VG2 = verbrückende Gruppe ist bei jedem Auftreten unabhängig voneinander ausgewählt aus der Gruppe bestehend aus CR**$_2$, NR**, O, S und einer C-C-Einfachbindung, wobei nicht zwei Einheiten VG2 gleichzeitig gleich einer C-C-Einfachbindung sind;
E ist ausgewählt aus der Gruppe bestehend aus NR** und

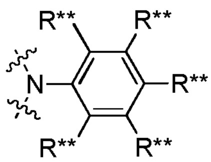;

G ist C wenn o = 1 und gleichzeitig m = 1; G ist CR** wenn o = 0 und gleichzeitig m = 1; G ist CR** oder CR**$_2$, wenn o = 1 und gleichzeitig m = 0; G ist R* wenn o = 0 und gleichzeitig m = 0; G ist CR**, CR**$_2$, N oder NR* wenn m = 0 und gleichzeitig VG1 eine C-C-Einfachbindung ist;
J ist C wenn m = 1; J ist CR**, CR**$_2$ oder NR** wenn m = 0;
L ist CR*** wenn n = 0; L ist CR**, C (bei kovalenter Bindung zu VG2) wenn n = 1;
R*** ist R** oder ist ausgewählt aus der Gruppe der folgenden Einheiten, wobei maximal zwei der Reste R*** gleichzeitig gleich einer der folgenden Einheiten sind:

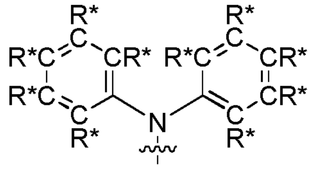, 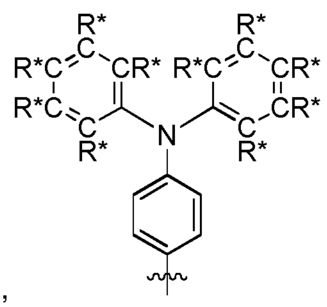, 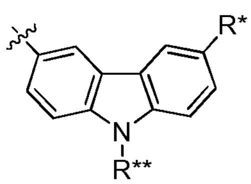, 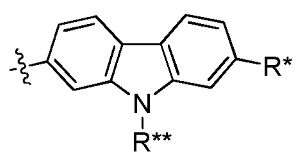,

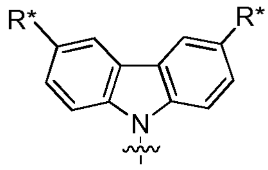,
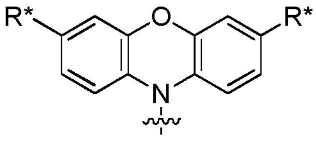,
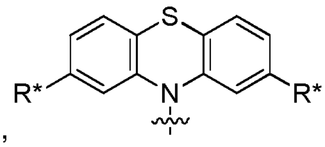,

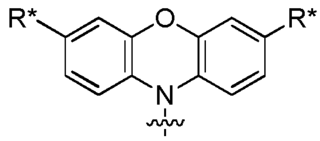,
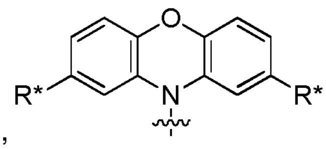;

R** ist bei jedem Auftreten unabhängig voneinander ein Rest R* oder markiert eine Anknüpfungsstelle an einen Separator S, wobei genau ein R** eine Anknüpfungsstelle an einen Separator S ist;
wobei für Formel 1, Unterformel 1 und Formel 3 gilt:

R* ist bei jedem Auftreten unabhängig voneinander ausgewählt aus der Gruppe bestehend aus H, Deuterium, Phenyl, Naphthyl, F, Cl, Br, I, N($R^2$)$_2$, -CN, -NC, -SCN, -$CF_3$, -$NO_2$, -OH, C(=O)OH, C(=O)O$R^3$, C(=O)N($R^3$)$_2$, C(=O)S$R^3$, C(=S)S$R^3$, Si($R^4$)$_3$, B(O$R^5$)$_2$, B(N($R^6$)$_2$)$_2$, C(=O)$R^3$, P(=O)($R^7$)$_2$, $A_S$(=O)($R^7$)$_2$, P(=S)($R^7$)$_2$, As(=S)($R^7$)$_2$, S(=O)$R^3$, S=N$R^3$, S(=O)N$R^3$, S(=O)$_2$N$R^3$, S(=O)$_2R^3$, O-S(=O)$_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9$C=C$R^9$-, -C≡C-, bzw. eine benachbarte $CH_2$-Gruppe durch -Si($R^4$)$_2$-, -Ge($R^4$)$_2$-, -Sn($R^4$)$_2$, -C(=O)-, -C(=S)-, -C(=Se)-,-C=N-, -C(=O)O-, -C(=O)N($R^3$)-, -P(=O)($_R{}^7$)-, -As(=O)($R^7$)-, -P(=S)($R^7$)-, -As(=S)($R^7$)-, -S(=O)-, -S(=O)$_2$-, -N$R^{2}$-, -O-, oder-S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R* auch miteinander ein mono- oder polycyclisches, aliphatisch benzoannelliertes, aromatisches und/oder benzoannelliertes Ringsystem bilden;

$R^2$ ist bei jedem Auftreten unabhängig voneinander ausgewählt aus der Gruppe bestehend aus H, Deuterium, Phenyl, Naphthyl, $CF_3$, C(=O)O$R^3$, C(=O)N($R^2$)$_2$, Si($R^4$)$_3$, C(=O)$R^3$, P(=O)($R^7$)$_2$, AS(=O)($R^7$)$_2$ P(=S)($R^7$)$_2$, AS(=S)($R^7$)$_2$, S(=O)$R^3$, S(=O)2$R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch -$R^9$C=C$R^9$-, -C≡C-, bzw. eine benachbarte $CH_2$-Gruppe durch -Si($R^4$)$_2$-,-Ge($R^4$)$_2$-, -Sn($R^4$)$_2$, -C(=O)-, -C(=S)-, -C(=Se)-, -C=N-, -C(=O)O-, -C(=O)N($R^3$)-, -P(=O)($R^7$)-,-As(=O)($R^7$)-, -P(=S)($R^7$)-, -As(=S)($R^7$)-, -S(=O)-, -S(=O)$_2$-, -N$R^{2}$-, -O-, oder -S-ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden;

$R^4$ ist bei jedem Auftreten unabhängig voneinander ausgewählt aus der Gruppe bestehend aus H, Deuterium, Phenyl, Naphthyl, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $AS(=S)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-,-C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden;

$R^5$ ist bei jedem Auftreten unabhängig voneinander ausgewählt aus der Gruppe bestehend aus Phenyl, Naphthyl, $CF_3$, $C(=O)R^3$, $P(=O)(R^7)_2$, $As(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-, - C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$,$-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden;

$R^6$ ist bei jedem Auftreten unabhängig voneinander ausgewählt aus der Gruppe bestehend aus Phenyl, Naphthyl, $CF_3$, $Si(R^4)_3$, $C(=O)R^3$, $P(=O)(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch-$Si(R^4)_2-$, $-Ge(R^4)_2-$, $-Sn(R^4)_2$, -C(=O)-, - C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes Ringsystem bilden;

$R^7$ ist bei jedem Auftreten unabhängig voneinander ausgewählt aus der Gruppe bestehend aus Phenyl, Naphthyl, $N(R^2)_2$, CN, $CF_3$, $C(=O)OR^3$, $C(=O)N(R^3)_2$, $Si(R^4)_3$, $C(=O)R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, $- Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können,

oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden;

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden;

$R^9$ ist bei jedem Auftreten unabhängig voneinander ausgewählt aus der Gruppe bestehend aus H, Deuterium, Phenyl, Naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch $-R^3C=CR^3-$, -C=C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-, - C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, oder-S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem bilden.

**2.** Verwendung nach Anspruch 1, wobei das organische Molekül eine Struktur der Formel 2b oder Formel 2c aufweist:

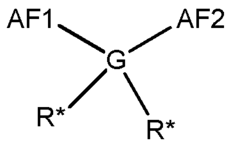

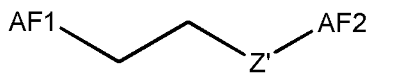

**Formel 2b** **Formel 2c**

wobei die in Anspruch 1 angegebenen Definitionen gelten;
und wobei
G gleich einem sp3 hybridisierten Kohlenstoff- oder Siliziumatom;
Z' gleich einer Einfachbindung oder $C(R^*)_2$ oder $Si(R^*)_2$ ist.

**3.** Verwendung nach Anspruch 1 oder 2, wobei das Molekül eine der nachfolgenden Strukturen aufweist:

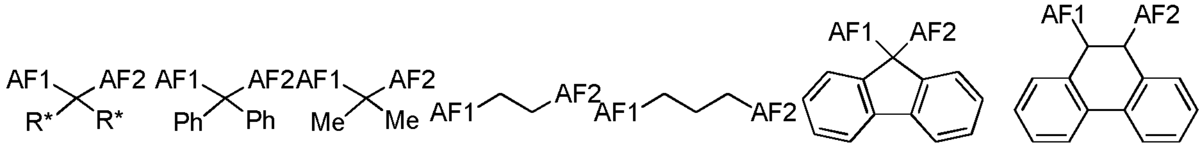

2-44 2-45 2-46 2-47 2-48 2-49 2-50

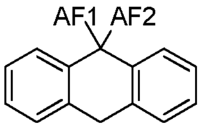 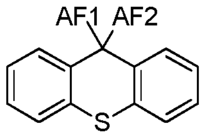 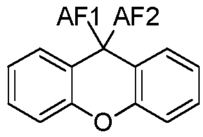 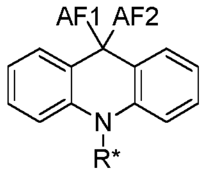 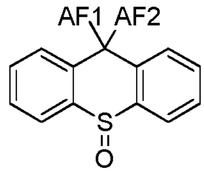

2-51 2-52 2-53 2-54 2-55

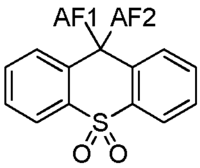 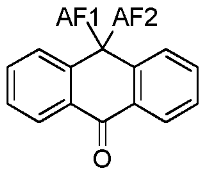 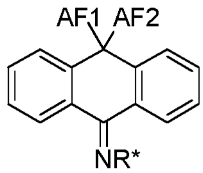 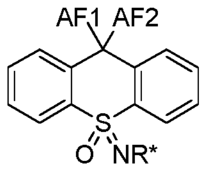 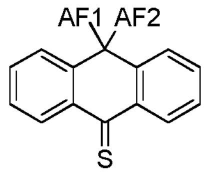

2-56 2-57 2-58 2-59 2-60

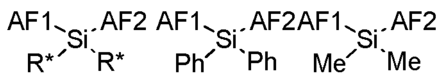

2-61 2-62 2-63

und wobei die in Anspruch 1 angegebenen Definitionen gelten.

**4.** Verwendung nach Anspruch 1 bis 3, wobei das organische Molekül eine der nachfolgenden Strukturen aufweist:

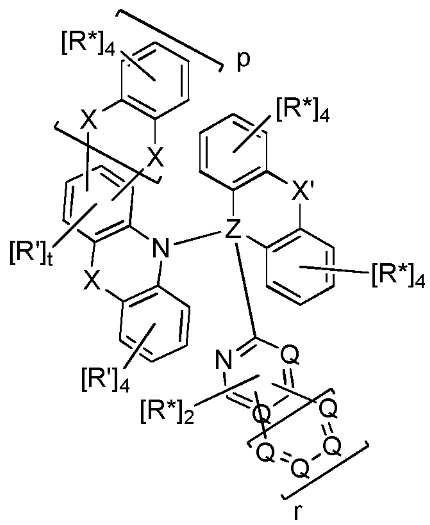

**Formel 5**

wobei in Formel 5 bedeutet:

p ist 0 oder 1;
t = 4 - 2p;
X ist $CR^*_2$, NR*, Sauerstoff, Schwefel oder eine direkte Bindung, wobei maximal zwei Platzhalter X gleichzeitig eine direkte Bindung sind, wobei diese nicht Bestandteil desselben Rings sind;
X' ist $CR^*_2$, NR*, Sauerstoff, Schwefel, keine Bindung, oder eine direkte Bindung;
Q ist N, CR*, wobei mindestens ein Q gleich N ist, und wobei nicht zwei direkt benachbarte Einheiten Q gleichzeitig gleich N sind,
Z = sp3-Kohlenstoff oder sp3-Silicium;
r = 0 oder 1,

R' ist R* oder ist ausgewählt aus den folgenden Einheiten, wobei maximal zwei der Reste R' gleichzeitig gleich einer der folgenden Einheiten sind:

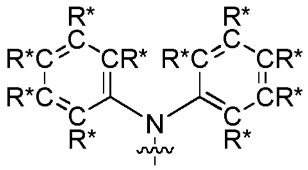 , 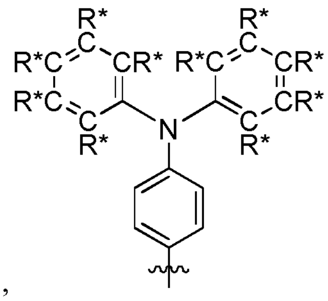 , 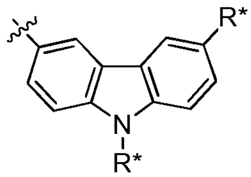 , 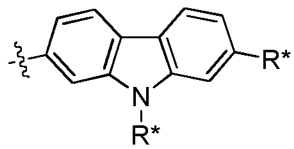 ,

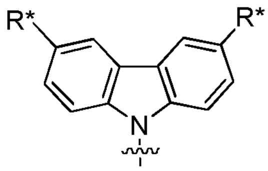 , 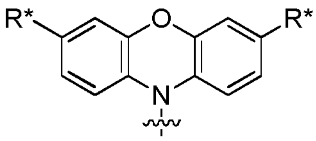 , 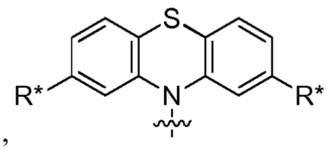 ,

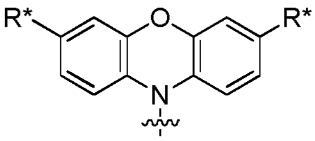 , 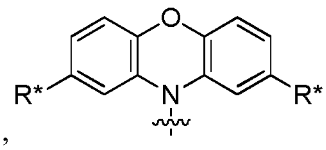 ;

und wobei im Übrigen die in Anspruch 1 angegebenen Definitionen gelten;

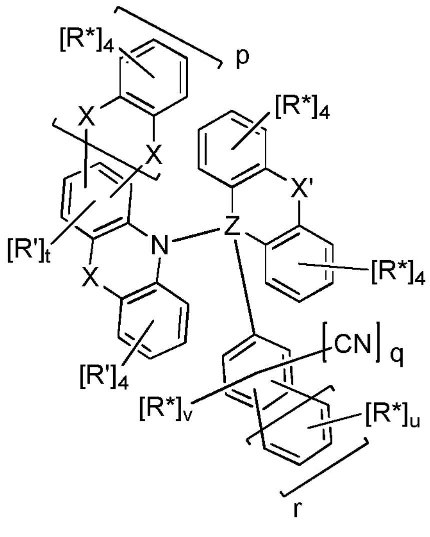

**Formel 6**

wobei in Formel 6 bedeutet:

p ist 0 oder 1;
t = 4 - 2p;
X ist $CR^*_2$, NR*, Sauerstoff, Schwefel, eine direkte Bindung, wobei maximal zwei Platzhalter X gleichzeitig eine direkte Bindung sind, wobei diese nicht Bestandteil desselben Rings sind;
X' ist $CR^*_2$, NR*, Sauerstoff, Schwefel, keine Bindung, oder eine direkte Bindung;
r = 0 oder 1,

q = 1 bis 5, für r = 1 ist q = 1 bis 3,

u ist 1, 2, 3 oder 4

v ist 1, 2 oder 3; wobei gilt: u + v = 3 + 4r - q

Z = sp3-Kohlenstoff oder sp3-Silicium;

R' ist R* oder ist ausgewählt aus den folgenden Einheiten, wobei maximal zwei der Reste R' gleichzeitig gleich einer der folgenden Einheiten sind:

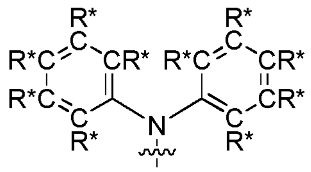 , 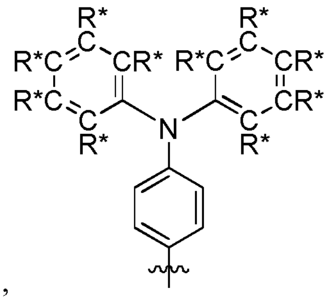 , 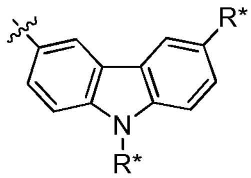 , 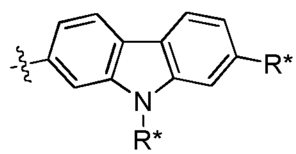 ,

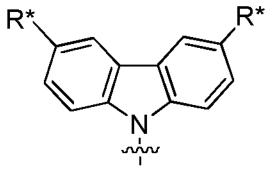 , 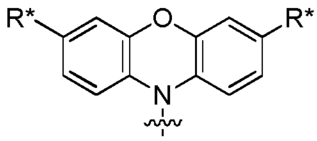 , 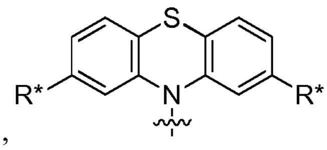 ,

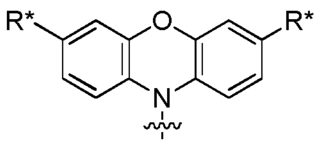 , 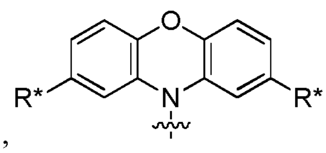 ;

und wobei im Übrigen die in Anspruch 1 angegebenen Definitionen gelten;

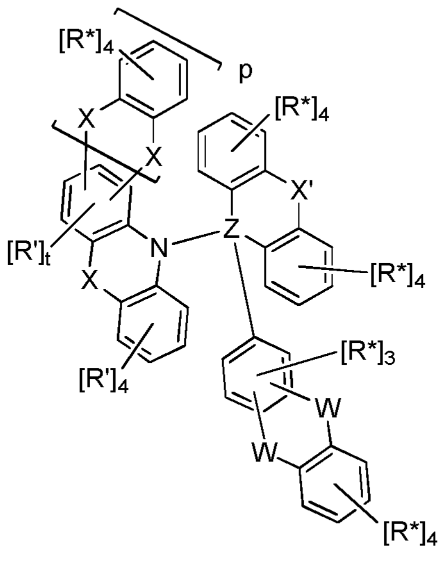

**Formel 7**

wobei in Formel 7 bedeutet:

W ist

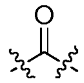, 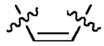, 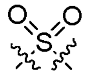,

eine Element-Element-Einfachbindung, wobei nicht zwei Einheiten W gleichzeitig eine Element-Element-Einfachbindung sind, NR*, wobei nicht zwei Einheiten W gleichzeitig gleich NR* sind;
p ist 0 oder 1;
t = 4 - 2p;
X ist $CR^*_2$, NR*, Sauerstoff, Schwefel, eine direkte Bindung, wobei maximal zwei Platzhalter X gleichzeitig eine direkte Bindung sind, wobei diese nicht Bestandteil desselben Rings sind;
X' ist $CR^*_2$, NR*, Sauerstoff, Schwefel, keine Bindung, oder eine direkte Bindung;
Z = sp3-Kohlenstoff oder sp3-Silicium;
R' ist R* oder ist ausgewählt aus den folgenden Einheiten, wobei maximal zwei der Reste R' gleichzeitig gleich einer der folgenden Einheiten sind:

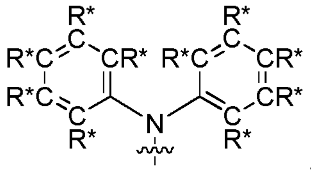, 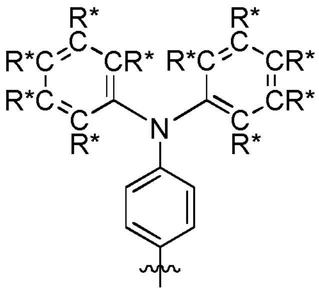, 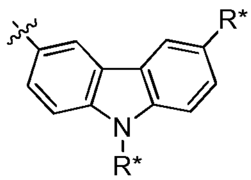, 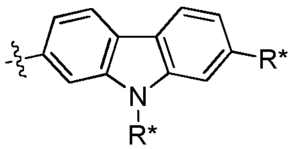,

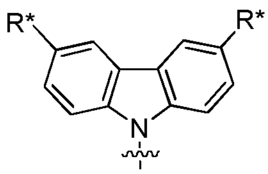, 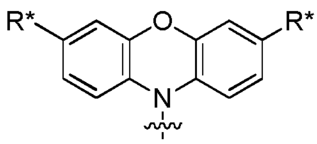, 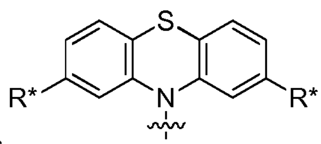,

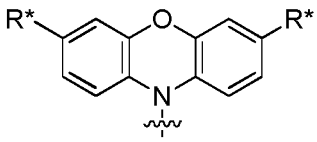, 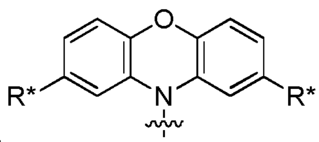;

und wobei im Übrigen die in Anspruch 1 angegebenen Definitionen gelten;

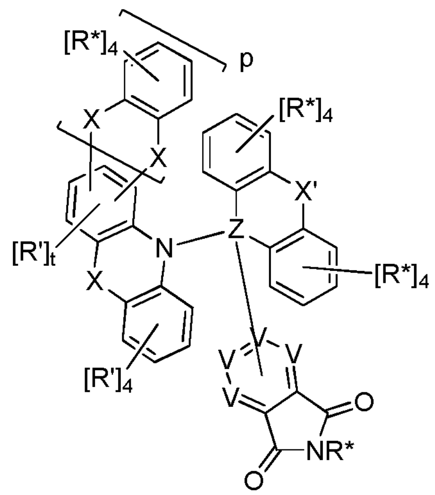

**Formel 8**

wobei in Formel 8 bedeutet:

V ist bei jedem Auftreten CR*, N, wobei maximal zwei Einheiten V gleichzeitig gleich N sind; und wobei nicht zwei einander benachbarte Einheiten V gleichzeitig gleich N sind, und wobei ein V gleich C ist, worüber die Anbindung an den Separator S erfolgt;
p ist 0 oder 1;
t = 4 - 2p;
X ist $CR^*_2$, NR*, Sauerstoff, Schwefel oder eine direkte Bindung, wobei maximal zwei Platzhalter X gleichzeitig eine direkte Bindung sind, wobei diese nicht Bestandteil desselben Rings sind;
X' ist $CR^*_2$, NR*, Sauerstoff, Schwefel, keine Bindung, oder eine direkte Bindung;
Z = sp3-Kohlenstoff oder sp3-Silicium;
R' ist R* oder ist ausgewählt aus den folgenden Einheiten, wobei maximal zwei der Reste R' gleichzeitig gleich einer der folgenden Einheiten sind:

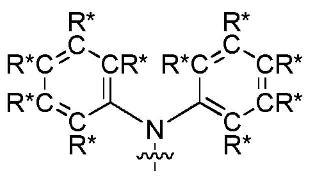 , 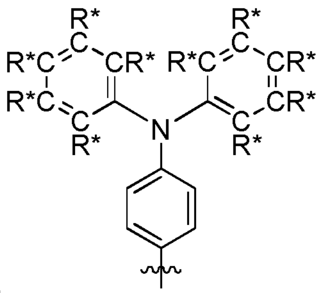 , 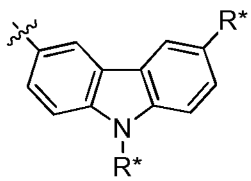 , 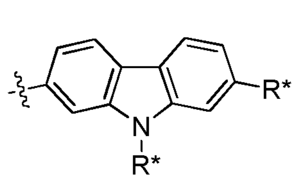 ,

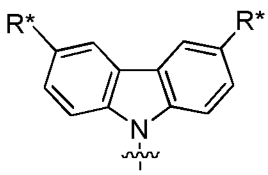 , 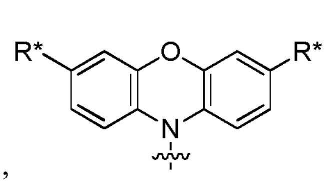 , 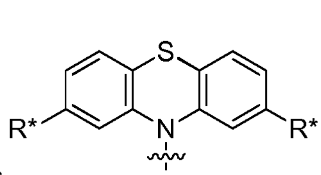 ,

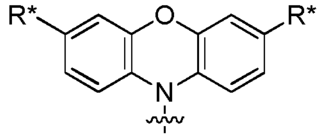 , 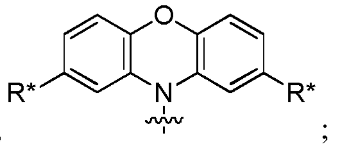 ;

und wobei im Übrigen die in Anspruch 1 angegebenen Definitionen gelten.

**5.** Verwendung nach Anspruch 1 bis 4, wobei das organische Molekül an mindestens einer Position mindestens einen weiteren Rest R aufweist, wobei
R ist bei jedem Auftreten unabhängig voneinander ausgewählt aus der Gruppe bestehend aus H, Deuterium, Phenyl, Naphthyl, F, Cl, Br, I, $N(R^2)_2$, -CN, -NC, -SCN, - $CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C=C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-, -C=N-, - C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; ; dabei können zwei oder mehrere dieser Substituenten R* auch miteinander ein mono- oder polycyclisches, aliphatisch benzoannelliertes, aromatisches und/oder benzoannelliertes Ringsystem bilden; dabei können zwei oder mehrere dieser Substituenten R* auch miteinander ein mono- oder polycyclisches, aliphatisch benzoannelliertes, aromatisches und/oder benzoannelliertes Ringsystem bilden wobei $R^2$ bis $R^9$ definiert sind wie in Anspruch 1;
und wobei mit Resten, die polymerisierbare funktionelle Einheiten tragen, die mit sich selbst homopolymerisiert oder mit anderen Monomeren copolymiersiert werden können, einorganisches Molekül als Polymer mit Wiederholungseinheiten nach den Formeln 9 und/oder 10 erhalten wird

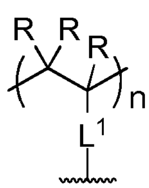

**Formel 9**

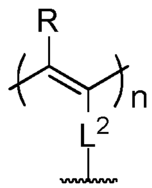

**Formel 10**

mit

gewellte Linie = Position, über die die Linkergruppe $L^1$ oder $L^2$ an das organische Molekül gebunden ist;
$L^1$ und $L^2$ = gleiche oder verschiedene Linkergruppen, aufweisend zwischen 0 bis 20 Kohlenstoffatome; oder aufweisend eine Form -C(=O)O;
und wobei insbesondere $L^1$ und $L^2$ = $-X-L^3$ mit X = O oder S;
$L^3$ = eine weitere Linkergruppe ausgewählt aus der Gruppe aus einersubstituierten und unsubstituierten Alkylengruppe (linear, verzweigt oder cyclisch) und einer substituierten und unsubstituierten Arylengruppe, wobei auch Kombinationen möglich sind.

**6.** Verwendung nach Anspruch 1 bis 5, wobei das optoelektronische Bauelement ausgewählt ist aus der Gruppe bestehend aus:

- organischen lichtemittierenden Dioden (OLEDs),
- lichtemittierenden elektrochemischen Zellen,
- OLED-Sensoren, insbesondere in nicht hermetisch nach außen abgeschirmten Gas-und Dampf-Sensoren,
- organischen Dioden,
- organischen Solarzellen,
- organischen Transistoren,
- organischen Feldeffekttransistoren,

• organischen Lasern und
• Down-Konversions-Elementen.

**7.** Verwendung nach Anspruch 6, wobei die Konzentration des organischen Moleküls als Emitter in optischen Licht emittierenden Bauelementen, insbesondere in OLEDs, zwischen 5 % und 80 % beträgt.

**8.** Optoelektronisches Bauelement, aufweisend ein organisches Molekül wie in Anspruch 1 bis 5 definiert, insbesondere ausgeformt als ein Bauelement ausgewählt aus der Gruppe bestehend aus organischen lichtemittierenden Dioden (OLED), Licht-emittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversions-Element.

**9.** Optoelektronisches Bauelement nach Anspruch 8, aufweisend ein Substrat, eine Anode und eine Kathode, wobei die Anode und die Kathode auf das Substrat aufgebracht sind, und mindestens eine lichtemittierende Schicht, welche zwischen Anode und Kathode angeordnet ist und die ein organisches Molekül wie in Anspruch 1 bis 5 definiert enthält.

**10.** Optoelektronisches Bauelement nach Anspruch 8 oder 9, in dem die lichtemittierende Schicht mindestens ein Hostmaterial aufweist, wobei insbesondere der angeregte Singulettzustand ($S_1$) und/oder der angeregte Triplett-zustand ($T_1$) des mindestens einen Hostmaterials höher ist als der angeregte Singulettzustand ($S_1$) und/oder der angeregte Triplettzustand ($T_1$) des organischen Moleküls wie in Anspruch 1 bis 5 definiert.

**11.** Optoelektronisches Bauelement nach Anspruch 8 bis 10, wobei mindestens ein Hostmaterial aus einem Material wie in Anspruch 1 bis 5 definiert besteht.

**12.** Optoelektronisches Bauelement nach Anspruch 8 bis 11, wobei die lichtemittierende Schicht fluoreszente oder phosphoreszente Materialien beinhaltet und wobei die Materialien der lichtemittierenden Schicht ausgewählt sind aus organischen Molekülen wie in Anspruch 1 bis 5 definiert.

**13.** Optoelektronisches Bauelement nach Anspruch 11 oder 12, in dem ein organisches Molekül wie in Anspruch 1 bis 5 definiert und ein funktionelles Material einen Exciplex bilden.

**14.** Optoelektronisches Bauelement nach Anspruch 8 bis 13, in dem ein organisches Molekül wie in Anspruch 1 bis 5 definiert als Ladungstransportschicht verwendet wird.

**15.** Verfahren zur Herstellung eines optoelektronischen Bauelements, wobei ein organisches Molekül wie in Anspruch 1 bis 5 definiert verwendet wird, wobei die Verarbeitung des organischen Moleküls insbesondere mittels eines Vakuumverdampfungsverfahrens oder aus einer Lösung erfolgt.

## Claims

**1.** Use of an organic molecule as a luminescent emitter and/or as a host material and/or as an electron transport material and/or as a hole injection material and/or as a hole blocking material in an optoelectronic component, wherein the organic molecule comprises a structure of formula 1

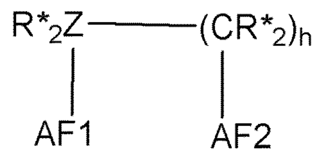

**Formula 1**

where

Z = $sp^3$ carbon or $sp^3$ silicon;
h = 0, 1, 2, 3 or 4;

$R^*_2Z$-$(CR^*_2)_h$ represents a separator S;
where the unit AF1 comprises a structure of subformula 1:

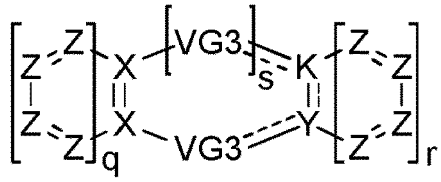

**Subformula 1**

where:

q is 0 or 1; r is 0 or 1; s is 0 or 1;
VG3 = bridging group which at each instance is independently selected from the group consisting of

N, O, S, CR**, C, an element-element single bond between X and Y or between X and K, wherein 2 units VG3 are not simultaneously an element-element single bond between X and Y and between X and K, BR**, NR**, $GeR^{**}_2$, $AsR^{**}_2$, $SiR^{**}_2$, wherein two units VG3 are not simultaneously BR**, NR**, $GeR^{**}_2$, $AsR^{**}_2$, $SiR^{**}_2$;

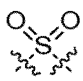, 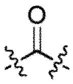, 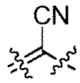, 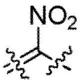, 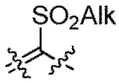, 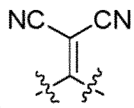, 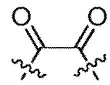, 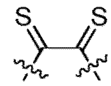, 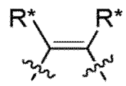,

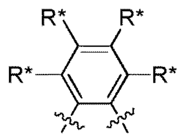,

where two units VG3 are not simultaneously

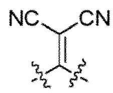, 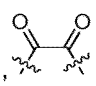, 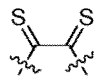, 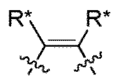, 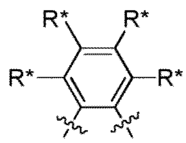;

X at each instance is independently C, or is CR** or N if q = 0;
Y is C, or is CR**, $CR^{**}_2$, N, NR**, O or S if r = 0;
K is Y, or is R* if r = 0 and at the same time s = 0;
Z at each instance is independently CR** or N;
and where at most 4 of the units VG3, K, X, Y, Z are simultaneously N;
and where at least 1 of the units VG3, K, X, Y, Z is a group which is different from C-H and contains at least 1 nitrogen atom;
and where also, in the case that r = 0, two adjacent groups Z can be bridged with one another, or a group VG3 can be bridged with the group Z or X or Y closest to it, via one of the following units:

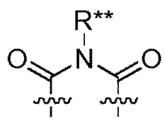, 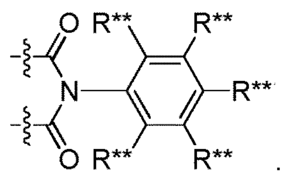;

with at most three of these units being present;
R** at each instance is independently either a substituent R*, or a chemical bond to a separator S, where precisely one R** is a chemical bond to a separator S;
and where the unit AF2 comprises a structure of formula 3

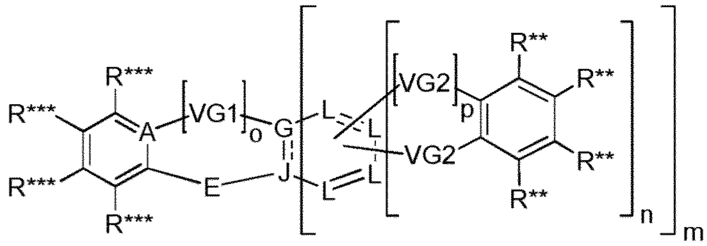

**Formula 3**

where:

m is 0 or 1;
n is 0 or 1, where, when m = 0, n also always = 0;
o is 0 or 1;
p is 0 or 1;
A is CR*** when o = 0, otherwise is C;
VG1 = bridging group which is selected from the group consisting of

- NR**, $CR^{**}_2$, O, S and a C-C single bond; or
- NR**, $CR^{**}_2$, O, S, a C-C single bond, BR**, AsR**, $SiR^{**}_2$, $GeR^{**}_2$,

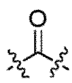, 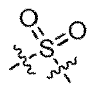, 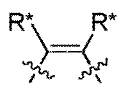, 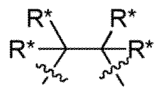, 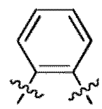,

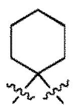, 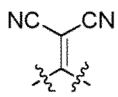, 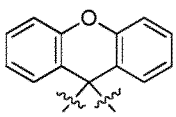, 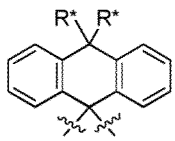, 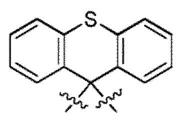,

and

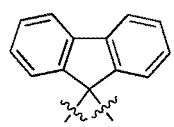,

when m = 1 and at the same time n = 0;

VG2 = bridging group which at each instance is independently selected from the group consisting of $CR^{**}_2$, NR**, O, S and a C-C single bond, where two units VG2 are not simultaneously a C-C single bond;
E is selected from the group consisting of NR** and

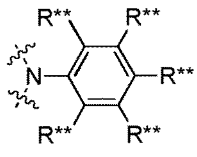
;

G is C when o = 1 and at the same time m = 1; G is CR** when o = 0 and at the same time m = 1; G is CR** or $CR^{**}_2$, when o = 1 and at the same time m = 0; G is R* when o = 0 and at the same time m = 0; G is CR**, $CR^{**}_2$, N or NR* when m = 0 and at the same time VG1 is a C-C single bond;
J is C when m = 1; J is CR**, $CR^{**}_2$ or NR** when m = 0;
L is CR*** when n = 0; L is CR**, C (in the case of covalent bond to VG2) when n = 1;
R*** is R** or is selected from the group of the following units, where at most two of the substituents R*** are simultaneously one of the following units:

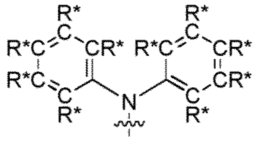
,
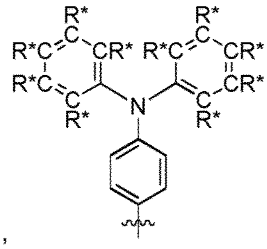
,
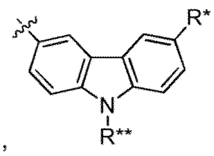
,
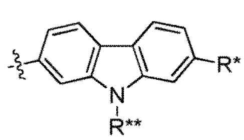
,

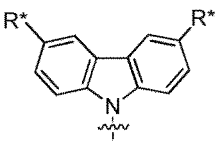
,
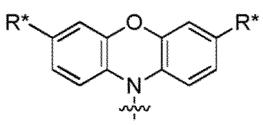
,
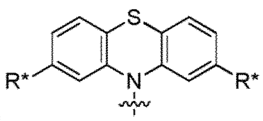
,

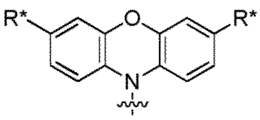
,
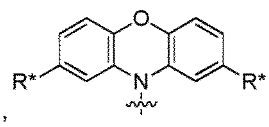
;

R** at each instance is independently a substituent R* or designates an attachment site to a separator S, with precisely one R** being an attachment site to a separator S;
where for formula 1, subformula 1 and formula 3:

R* at each instance is independently selected from the group consisting of H, deuterium, phenyl, naphthyl, F, Cl, Br, I, $N(R^2)_2$, -CN, -NC, -SCN, $-CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)^2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^9$, where one or more adjacent $CH_2$ groups may be replaced by $-R^9C=CR^9-$, -C=C-, or an adjacent $CH_2$ group may be replaced by $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, - $P(=S)(R^7)-$, $-As(=S)(R^7)-$, -S(=O)-, $-S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^2$, or an aryloxy or heteroaryloxy group which has 5 to 60 aromatic ring atoms and may be substituted by one or more substituents $R^9$, or a diarylamino group, diheteroarylamino group or arylheteroarylamino group which has 10 to 40 aromatic ring atoms and may be substituted by one or more substituents $R^9$, or a combination of these systems; two or more of these substituents R* here may also form with one another a mono-or polycyclic, aliphatically benzo-fused, aromatic and/or benzo-fused ring system;
$R^2$ at each instance is independently selected from the group consisting of H, deuterium, phenyl, naphthyl, $CF_3$, $C(=O)OR^3$, $C(=O)N(R^2)_2$, $Si(R^4)_3$, $C(=O)R^3$, $P(=O)(R^7)_2$, $As(=O)(R^7)_2$, $P(=S)(R^7)_2$, $As(=S)(R^7)_2$,

$S(=O)R^3$, $S(=O)_2R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^9$, where one or more adjacent $CH_2$ groups may be replaced by $-R^9C=CR^9-$, -C=C-, or an adjacent $CH_2$ group may be replaced by $-Si(R^4)_2-$, $-Ge(R^4)_2-$, - $Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, - $S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^9$, or an aryloxy or heteroaryloxy group which has 5 to 60 aromatic ring atoms and may be substituted by one or more substituents $R^9$, or a diarylamino group, diheteroarylamino group or arylheteroarylamino group which has 10 to 40 aromatic ring atoms and may be substituted by one or more substituents $R^9$, or a combination of these systems; two or more of these substituents $R^2$ here may also form with one another a mono- or polycyclic, aliphatic, aromatic and/or benzo-fused ring system;

$R^3$ at each instance is independently selected from the group consisting of H, deuterium, phenyl, naphthyl, $CF_3$ or an aliphatic, aromatic and/or heteroaromatic hydrocarbon radical having 1 to 20 carbon atoms in which one or more hydrogen atoms may also be replaced by F or $CF_3$; two or more substituents $R^3$ here may also form with one another a mono- or polycyclic, aliphatic ring system;

$R^4$ at each instance is independently selected from the group consisting of H, deuterium, phenyl, naphthyl, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $As(=S)(R^7)_2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^9$, where one or more adjacent $CH_2$ groups may be replaced by $-R^9C=CR^9-$, -C=C-, or an adjacent $CH_2$ group may be replaced by $-Si(R^4)_2-$, $-Ge(R^4)_2-$, - $Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, - $S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^8$, or an aryloxy or heteroaryloxy group which has 5 to 60 aromatic ring atoms and may be substituted by one or more substituents $R^9$, or a diarylamino group, diheteroarylamino group or arylheteroarylamino group which has 10 to 40 aromatic ring atoms and may be substituted by one or more substituents $R^9$, or a combination of these systems; two or more of these substituents $R^4$ here may also form with one another a mono- or polycyclic, aliphatic, aromatic and/or benzo-fused ring system;

$R^5$ at each instance is independently selected from the group consisting of phenyl, naphthyl, $CF_3$, $C(=O)R^3$, $P(=O)(R^7)_2$, $As(=O)(R^7)_2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^9$, where one or more adjacent $CH_2$ groups may be replaced by $-R^9C=CR^9-$, -C=C-, or an adjacent $CH_2$ group may be replaced by $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, - $P(=O)(R^7)-$, $-As(=O)(R^7)-$, $-P(=S)(R^7)-$, $-As(=S)(R^7)-$, -S(=O)-, - $S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^9$, or an aryloxy or heteroaryloxy group which has 5 to 60 aromatic ring atoms and may be substituted by one or more substituents $R^9$, or a diarylamino group, diheteroarylamino group or arylheteroarylamino group which has 10 to 40 aromatic ring atoms and may be substituted by one or more substituents $R^9$, or a combination of these systems; two or more of these substituents $R^5$ here may also form with one another a mono- or polycyclic, aliphatic, aromatic and/or benzo-fused ring system;

$R^6$ at each instance is independently selected from the group consisting of phenyl, naphthyl, $CF_3$, $Si(R^4)_3$, $C(=O)R^3$, $P(=O)(R^7)_2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^9$, where one or more adjacent $CH_2$ groups may be replaced by $-R^9C=CR^9-$, -C=C-, or an adjacent $CH_2$ group may be replaced by $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, - $P(=S)(R^7)-$, $-As(=S)(R^7)-$, -S(=O)-, $-S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^9$, or an aryloxy or heteroaryloxy group which has 5 to 60

aromatic ring atoms and may be substituted by one or more substituents R*, or a diarylamino group, diheteroarylamino group or arylheteroarylamino group which has 10 to 40 aromatic ring atoms and may be substituted by one or more substituents $R^9$, or a combination of these systems; two or more of these substituents $R^6$ here may also form with one another a mono-or polycyclic, aliphatic, aromatic and/or benzo-fused ring system;

$R^7$ at each instance is independently selected from the group consisting of phenyl, naphthyl, $N(R^2)_2$, CN, $CF_3$, $C(=O)OR^3$, $C(=O)N(R^3)_2$, $Si(R^4)_3$, $C(=O)R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^9$, where one or more adjacent $CH_2$ groups may be replaced by $-R^9C=CR^9-$, -C=C-, or an adjacent $CH_2$ group may be replaced by $-Si(R^4)_2-$, $-Ge(R^4)_2-$, - $Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, - $S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^9$, or an aryloxy or heteroaryloxy group which has 5 to 60 aromatic ring atoms and may be substituted by one or more substituents $R^9$, or a diarylamino group, diheteroarylamino group or arylheteroarylamino group which has 10 to 40 aromatic ring atoms and may be substituted by one or more substituents $R^3$, or a combination of these systems; two or more of these substituents $R^7$ here may also form with one another a mono- or polycyclic, aliphatic, aromatic and/or benzo-fused ring system;

$R^8$ at each instance is independently selected from the group consisting of H, deuterium, phenyl, naphthyl, F, $CF_3$ or an aliphatic, aromatic and/or heteroaromatic hydrocarbon radical having 1 to 20 carbon atoms in which one or more hydrogen atoms may also be replaced by F or $CF_3$; two or more substituents $R^8$ here may also form with one another a mono- or polycyclic, aliphatic ring system;

$R^9$ at each instance is independently selected from the group consisting of H, deuterium, phenyl, naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $As(=O)(R^7)_2$, $P(=S)(R^7)_2$, $S(=O)R^3$, $S(=O)_2R^3$, $OSO_2R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^8$, where one or more non-adjacent $CH_2$ groups may be replaced by $-R^3C=CR^3-$, -C=C-, or an adjacent $CH_2$ group may be replaced by $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, - $P(=O)(R^7)-$, $-As(=O)(R^7)-$, $-P(=S)(R^7)-$, $-As(=S)(R^7)-$, -S(=O)-, - $S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^8$, or an aryloxy or heteroaryloxy group which has 5 to 60 aromatic ring atoms and may be substituted by one or more substituents $R^3$, or a diarylamino group, diheteroarylamino group or arylheteroarylamino group which has 10 to 40 aromatic ring atoms and may be substituted by one or more substituents $R^8$, or a combination of these systems; two or more of these substituents $R^9$ here may also form with one another a mono- or polycyclic, aliphatic, aromatic and/or benzo-fused ring system.

2. Use according to Claim 1, wherein the organic molecule comprises a structure of formula 2b or formula 2c:

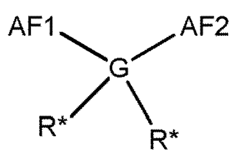

Formula 2b

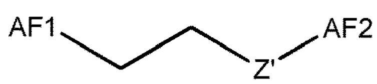

Formula 2c

where the definitions given in Claim 1 apply;
and where
G is an $sp^3$ hybridized carbon or silicon atom;
Z' is a single bond or $C(R^*)_2$ or $Si(R^*)_2$.

3. Use according to Claim 1 or 2, wherein the molecule comprises one of the following structures:

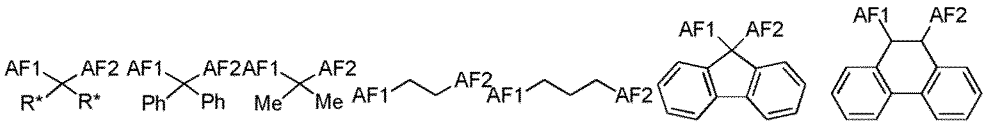

2-44 2-45 2-46 2-47 2-48 2-49 2-50

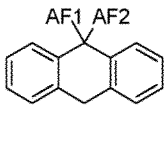

2-51

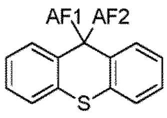

2-52

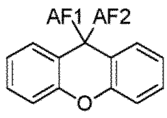

2-53

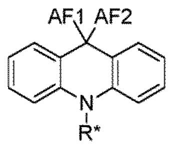

2-54

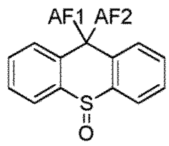

2-55

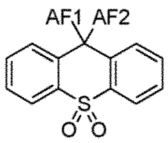

2-56

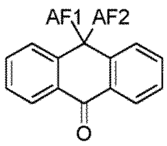

2-57

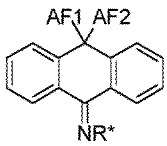

2-58

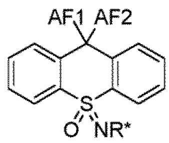

2-59

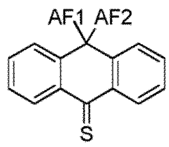

2-60

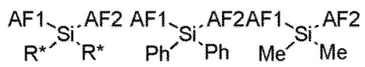

2-61 2-62 2-63

and where the definitions given in Claim 1 apply.

**4.** Use according to Claim 1 to 3, wherein the organic molecule comprises one of the following structures:

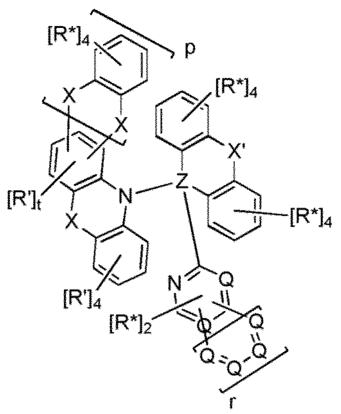

**Formula 5**

with the following definitions in formula 5:

p is 0 or 1;
t = 4 - 2p;
X is $CR^*_2$, NR*, oxygen, sulfur or a direct bond, with at most two placeholders X simultaneously being a direct bond, wherein these are not part of the same ring;
X' is $CR^*_2$, NR*, oxygen, sulfur, no bond or a direct bond;
Q is N, CR*, where at least one Q is N and where two directly adjacent units Q are not simultaneously N,
Z = $sp^3$ carbon or $sp^3$ silicon;
r = 0 or 1,

R' is R* or is selected from the following units, where at most two of the substituents R' are simultaneously one of the following units:

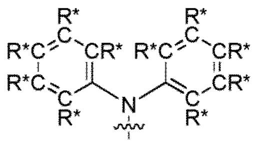 , 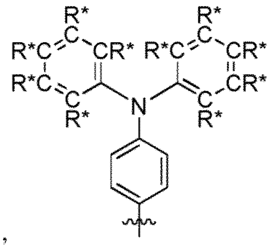 , 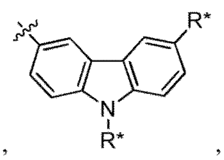 , 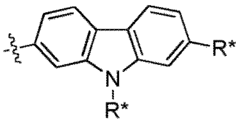 ,

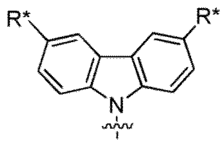 , 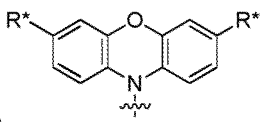 , 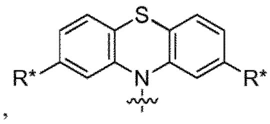 ,

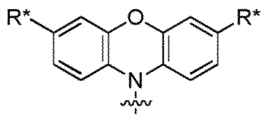 , 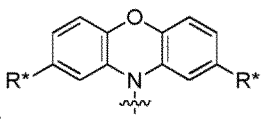 ;

and where for the rest the definitions given in Claim 1 apply;

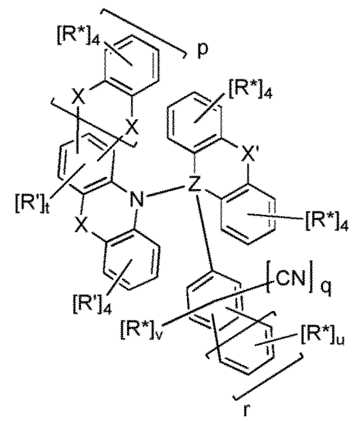

**Formula 6**

with the following definitions in formula 6:

p is 0 or 1;
t = 4 - 2p;
X is $CR^*_2$, $NR^*$, oxygen, sulfur or a direct bond, with at most two placeholders X simultaneously being a direct bond, wherein these are not part of the same ring;
X' is $CR^*_2$, $NR^*$, oxygen, sulfur, no bond or a direct bond;
r = 0 or 1,
q = 1 to 5, q = 1 to 3 when r = 1,
u is 1, 2, 3 or 4
v is 1, 2 or 3; where: u + v = 3 + 4r - q
Z = $sp^3$ carbon or $sp^3$ silicon;
R' is R* or is selected from the following units, where at most two of the substituents R' are simultaneously one of the following units:

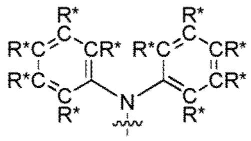, 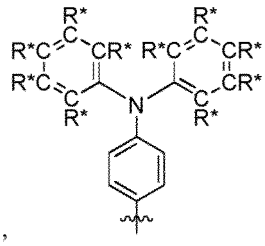, 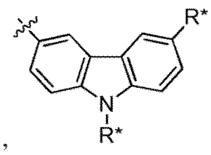, 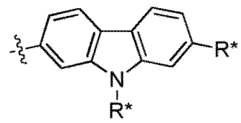,

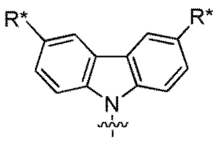, 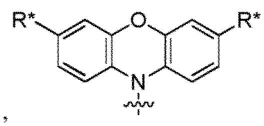, 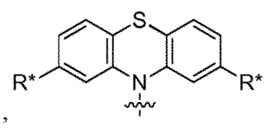,

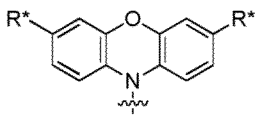, 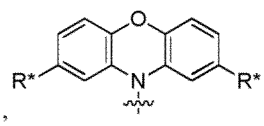;

and where for the rest the definitions given in Claim 1 apply;

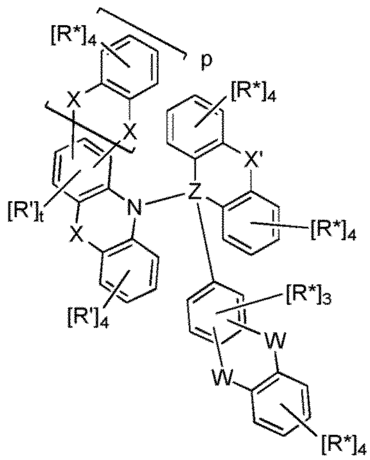

**Formula 7**

with the following definitions in formula 7:

W is

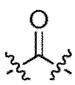, 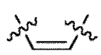, 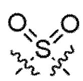,

an element-element single bond, where two units W are not simultaneously an element-element single bond, NR*, where two units W are not simultaneously NR*;
p is 0 or 1;
t = 4 - 2p;
X is $CR^*_2$, NR*, oxygen, sulfur or a direct bond, with at most two placeholders X simultaneously being a direct bond, wherein these are not part of the same ring;
X' is $CR^*_2$, NR*, oxygen, sulfur, no bond or a direct bond;
Z = $sp^3$ carbon or $sp^3$ silicon;
R' is R* or is selected from the following units, where at most two of the substituents R' are simultaneously one

of the following units:

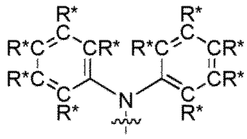,
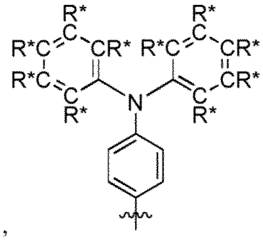,
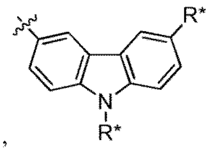,
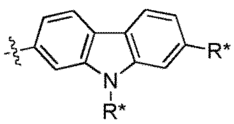,

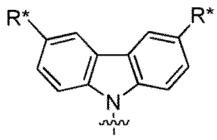,
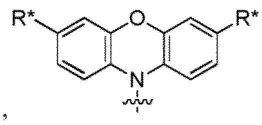,
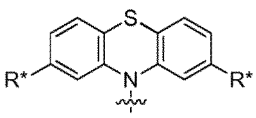,

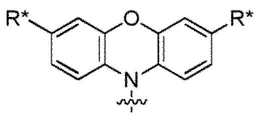,
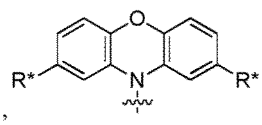;

and where for the rest the definitions given in Claim 1 apply;

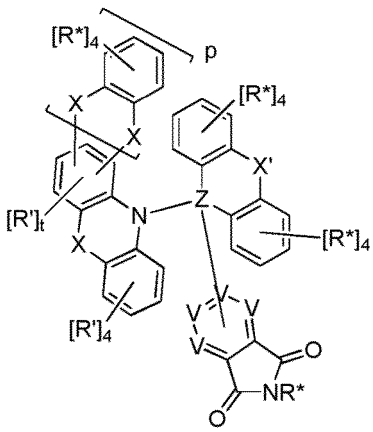

**Formula 8**

with the following definitions in formula 8:

V at each instance is CR*, N, where at most two units V are simultaneously N; and where two mutually adjacent units V are not simultaneously N, and where one V is C, via which the attachment to the separator S takes place;
p is 0 or 1;
t = 4 - 2p;
X is $CR^*_2$, NR*, oxygen, sulfur or a direct bond, with at most two placeholders X simultaneously being a direct bond, wherein these are not part of the same ring;
X' is $CR^*_2$, NR*, oxygen, sulfur, no bond or a direct bond;
Z = $sp^3$ carbon or $sp^3$ silicon;
R' is R* or is selected from the following units, where at most two of the substituents R' are simultaneously one of the following units:

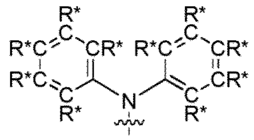, 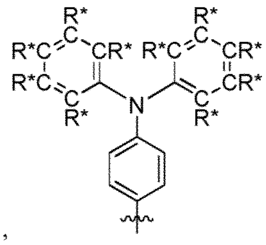, 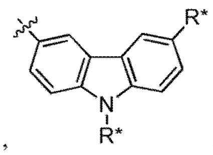, 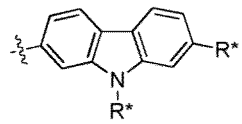,

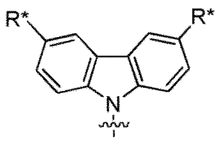, 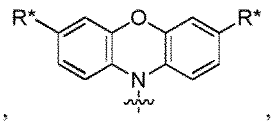, 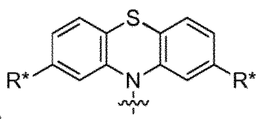,

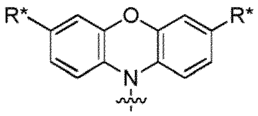, 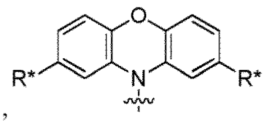;

and where for the rest the definitions given in Claim 1 apply.

**5.** Use according to Claims 1 to 4, wherein the organic molecule at at least one position comprises at least one further substituent R, where R at each instance is independently selected from the group consisting of H, deuterium, phenyl, naphthyl, F, Cl, Br, I, $N(R^2)_2$, -CN, -NC, -SCN, $-CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, which may each be substituted by one or more substituents $R^9$, where one or more adjacent $CH_2$ groups may be replaced by $-R^9C=CR^9-$, -C=C-, or an adjacent $CH_2$ group may be replaced by $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, - $P(=S)(R^7)-$, $-As(=S)(R^7)-$, -S(=O)-, $-S(=O)_2-$, $-NR^2-$, -O- or -S-, and where one or more hydrogen atoms may be replaced by deuterium, F, Cl, Br, I, CN, $CF_3$ or $NO_2$, or an aromatic or heteroaromatic ring system which has 5 to 60 aromatic ring atoms and may in each case be substituted by one or more substituents $R^2$, or an aryloxy or heteroaryloxy group which has 5 to 60 aromatic ring atoms and may be substituted by one or more substituents $R^9$, or a diarylamino group, diheteroarylamino group or arylheteroarylamino group which has 10 to 40 aromatic ring atoms and may be substituted by one or more substituents $R^9$, or a combination of these systems; two or more of these substituents R* here may also form with one another a mono-or polycyclic, aliphatically benzo-fused, aromatic and/or benzo-fused ring system; two or more of these substituents R* here may also form with one another a mono- or polycyclic, aliphatically benzo-fused, aromatic and/or benzo-fused ring system wherein $R^2$ to $R^9$ are defined as in Claim 1;
and where, using radicals bearing polymerizable functional units which can be homopolymerized with themselves or copolymerized with other monomers, an organic molecule is obtained in the form of a polymer with repeating units of formulae 9 and/or 10

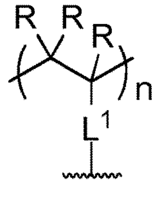
**Formula 9**

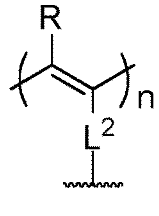
**Formula 10**

where

wavy line = position via which the linker group $L^1$ or $L^2$ is bonded to the organic molecule;

$L^1$ and $L^2$ = identical or different linker groups having between 0 to 20 carbon atoms; or having a form -C(=O)O; and where in particular $L^1$ and $L^2$ = -X-$L^3$ where X = O or S;
$L^3$ = a further linker group selected from the group of a substituted and unsubstituted alkylene group (linear, branched or cyclic) and a substituted and unsubstituted arylene group, with combinations also being possible.

**6.** Use according to Claims 1 to 5, wherein the optoelectronic component is selected from the group consisting of:

- organic light-emitting diodes (OLEDs),
- light-emitting electrochemical cells,
- OLED sensors, in particular in gas and vapour sensors that are not hermetically shielded with respect to the outside,
- organic diodes,
- organic solar cells,
- organic transistors,
- organic field-effect transistors,
- organic lasers and
- down-conversion elements.

**7.** Use according to Claim 6, wherein the concentration of the organic molecule as an emitter in optical light-emitting components, especially in OLEDs, is between 5% and 80%.

**8.** Optoelectronic component having an organic molecule as defined in Claims 1 to 5, in particular formed as a component selected from the group consisting of organic light-emitting diodes (OLED), light-emitting electrochemical cell, OLED sensor, in particular in gas and vapour sensors that are not hermetically shielded with respect to the outside, organic diode, organic solar cell, organic transistor, organic field-effect transistor, organic laser and down-conversion element.

**9.** Optoelectronic component according to Claim 8, having a substrate, an anode and a cathode, wherein the anode and the cathode are applied to the substrate, and at least one light-emitting layer which is arranged between the anode and cathode and which contains an organic molecule as defined in Claims 1 to 5.

**10.** Optoelectronic component according to Claim 8 or 9, in which the light-emitting layer includes at least one host material, wherein in particular the excited singlet state ($S_1$) and/or the excited triplet state ($T_1$) of the at least one host material is higher than the excited singlet state ($S_1$) and/or the excited triplet state ($T_1$) of the organic molecule as defined in Claims 1 to 5.

**11.** Optoelectronic component according to Claim 8 to 10, wherein at least one host material is composed of a material as defined in Claims 1 to 5.

**12.** Optoelectronic component according to Claim 8 to 11, wherein the light-emitting layer includes fluorescent or phosphorescent materials and wherein the materials of the light-emitting layer are selected from organic molecules as defined in Claims 1 to 5.

**13.** Optoelectronic component according to Claim 11 or 12, in which an organic molecule as defined in Claims 1 to 5 and a functional material form an exciplex.

**14.** Optoelectronic component according to Claim 8 to 13, in which an organic molecule as defined in Claims 1 to 5 is used as a charge transport layer.

**15.** Method for producing an optoelectronic component, wherein an organic molecule as defined in Claims 1 to 5 is used, wherein the organic molecule is processed in particular by means of a vacuum evaporation process or from a solution.

## Revendications

**1.** Utilisation d’une molécule organique en tant qu’émetteur luminescent et/ou en tant que matériau hôte et/ou en tant que matériau transporteur d’électrons et/ou en tant que matériau d’injection de trous et/ou en tant que matériau de

blocage de trous dans un composant optoélectronique, la molécule organique présentant une structure de formule 1

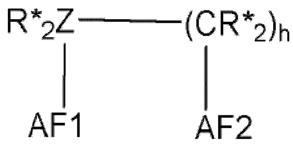

**Formule 1**

dans laquelle

Z = carbone-sp3 ou silicium-sp3 ;
h = 0, 1, 2, 3 ou 4 ;
$R^*_2Z$-$(CR^*_2)_h$ représente un séparateur S ;
dans laquelle l'unité AF1 présente une structure de sous-formule 1 :

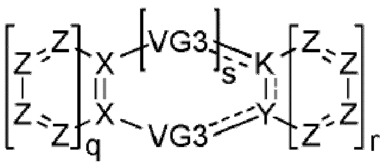

**Sous-formule 1**

dans laquelle :

q est 0 ou 1 ; r est 0 ou 1, s est 0 ou 1 ;
VG3 = groupe pontant est à chaque occurrence choisi chaque fois indépendamment dans le groupe constitué par

N, O, S, CR**, C, une liaison simple élément-élément entre X et Y ou entre X et K, 2 unités VG3 n'étant pas simultanément une liaison simple élément-élément entre X et Y et entre X et K, BR**, NR**, $GeR^{**}_2$, $AsR^{**}_2$, $SiR^{**}_2$, deux unités VG3 ne représentant pas simultanément BR**, NR**, $GeR^{**}_2$, $AsR^{**}_2$, $SiR^{**}_2$;

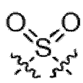 , 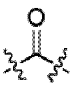 , 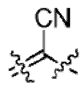 , 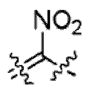 , 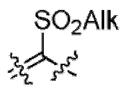 , 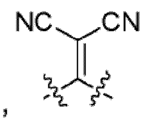 , 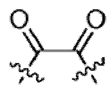 , 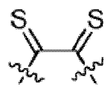 , 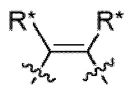 ,

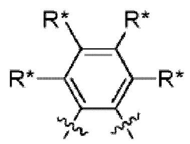 ,

deux unités VG3 ne représentant pas simultanément

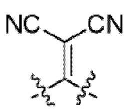 , 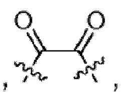 , 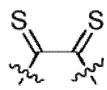 , 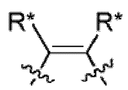 , 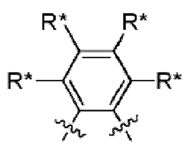 ;

X est à chaque occurrence chaque fois indépendamment C, ou est CR** ou N lorsque q = 0 ;
Y est C, ou est CR**, $CR^{**}_2$, N, NR**, O ou S lorsque r = 0 :
K est Y, ou est R* lorsque r = 0 et en même temps s = 0 ;

Z est à chaque occurrence chaque fois indépendamment CR** ou N ;
et au maximum 4 des unités VG3, K, X, Y, Z sont simultanément N ;
et au moins 1 des unités VG3, K, X, Y, Z représente un groupe différent de C-H, qui contient au moins un atome d'azote ;
et dans le cas où r = 0 également deux groupes Z voisins ou un groupe VG3 avec le groupe Z ou X ou Y placé le plus proche de lui peuvent être pontés par l'une des unités suivantes :

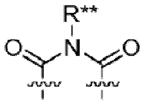 , 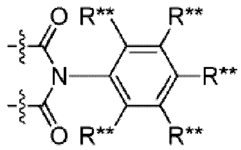 ;

au maximum trois de ces unités étant contenues ;
R** est à chaque occurrence chaque fois indépendamment un radical R* ou une liaison chimique à un séparateur S, strictement un radical R** étant une liaison chimique à un séparateur S ;
et dans laquelle l'unité AF2 présente une structure de formule 3

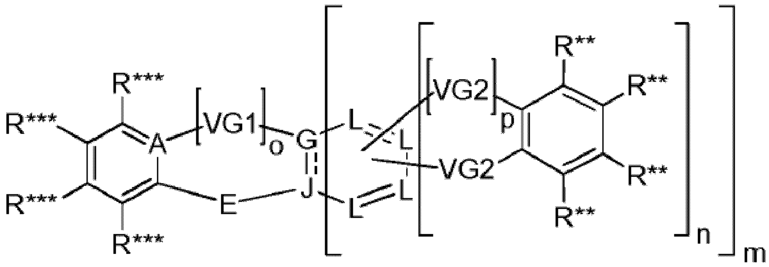

**Formule 3**

où il s'applique que :

m est 0 ou 1 ;
n est 0 ou 1, lorsque m = 0, n est également toujours égal à 0 ;
o est 0 ou 1 :
p est 0 ou 1 ;
A est CR*** lorsque o = 0, sinon est C ;
VG1 = groupe pontant, est choisi dans le groupe constitué par

- NR**, $CR^{**}_2$, O, S et une liaison simple C-C ; ou
- NR**, $CR^{**}_2$, O, S, une liaison simple C-C, BR**, AsR**, $SiR^{**}_2$, $GeR^{**}_2$,

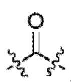 , 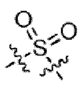 , 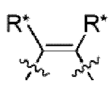 , 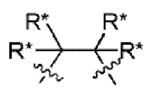 , 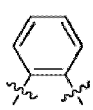 , 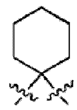 , 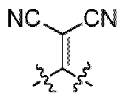 , 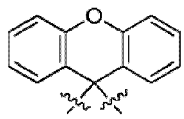 ,

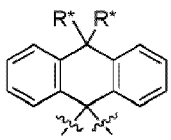 , 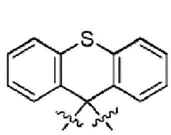 , et 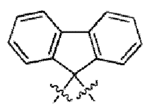 ,

lorsque m = 1 et en même temps n = 0;

VG2 = groupe pontant est à chaque occurrence choisi chaque fois indépendamment dans le groupe constitué

par CR**$_2$, NR**, O, S et une liaison simple C-C, deux unités VG2 ne représentant pas simultanément une liaison simple C-C ;
E est choisi dans le groupe constitué par NR** et

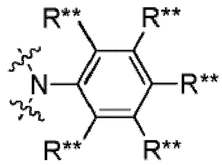 ;

G est C lorsque o = 1 et en même temps m = 1 ; G est CR** lorsque o = 0 et en même temps m = 1 ; G est CR** ou CR**$_2$ lorsque o = 1 et en même temps m = 0 ; G est R* lorsque o = 0 et en même temps m = 0 ; G est CR**, CR**$_2$, N ou NR* lorsque m = 0 et en même temps VG1 est une liaison simple C-C ;
J est C lorsque m = 1 ; J est CR**, CR**$_2$ ou NR** lorsque m = 0 ;
L est CR*** lorsque n = 0 ; L est CR**, C (en cas de liaison covalente à VG2) lorsque n = 1 ;
R*** est R** ou est choisi dans le groupe constitué par les unités suivantes, au maximum deux des radicaux R*** représentant simultanément l'une des unités suivantes :

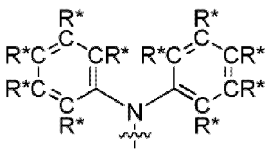 , 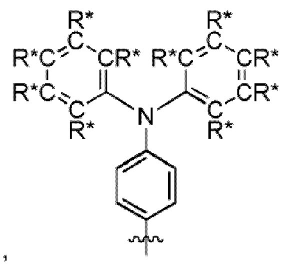 , 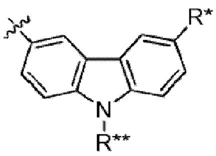 , 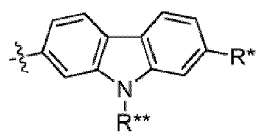 ,

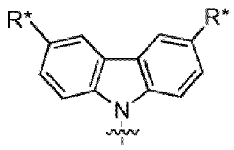 , 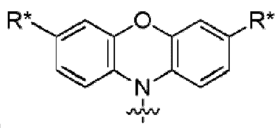 , 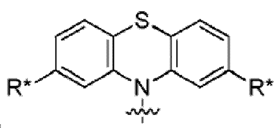 ,

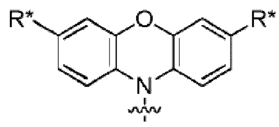 , 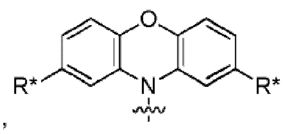 ;

R** est à chaque occurrence chaque fois indépendamment un radical R* ou marque une position d'attachement à un séparateur S, strictement un R** étant une position d'attachement à un séparateur S ;
où pour la formule 1, la sous-formule 1 et la formule 3 il s'applique que :

R* est à chaque occurrence choisi chaque fois indépendamment dans le groupe constitué par H, le deutérium, les groupes phényle, naphtyle, F, Cl, Br, I, N($R^2$)$_2$, -CN, -NC, -SCN, -$CF_3$, -$NO_2$, -OH, C(=O)OH, C(=O)OR$^3$, C(=O)N($R^3$)$_2$, C(=O)SR$^3$, C(=S)SR$^3$, Si($R^4$)$_3$, B(OR$^5$)$_2$, B(N($R^6$)$_2$)$_2$, C(=O)R$^3$, P(=O)($R^7$)$_2$, As(=O)($R^7$)$_2$, P(=S)($R^7$)$_2$, As(=S)($R^7$)$_2$, S(=O)R$^3$, S=NR$^3$, S(=O)NR$^3$, S(=O)$_2$NR$^3$, S(=O)$_2$R$^3$, O-S(=O)$_2$R$^3$, $SF_5$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R$^9$, un ou plusieurs groupes $CH_2$ voisins pouvant être remplacés par -R$^9$C=CR$^9$-, -C≡C-, ou un groupe $CH_2$ voisin pouvant être remplacé par -Si($R^4$)$_2$-, -Ge($R^4$)$_2$-, - Sn($R^4$)$_2$, -C(=O)-, -C(=S)-, -C(=Se)-, -C=N-, -C(=O)O-, -C(=O)N($R^3$)-, -P(=O)($R^7$)-, -As(=O)($R^7$)-, -P(=S)($R^7$)-, -As(=S)($R^7$)-, -S(=O)-, -S(=O)$_2$-, - NR$^2$-, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué

par un ou plusieurs radicaux $R^2$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants R* peuvent en outre également former ensemble un système cyclique mono- ou polycyclique, soudé à un noyau benzénique par aliphatique, aromatique et/ou soudé à un noyau benzénique ;

$R^2$ est choisi à chaque occurrence chaque fois indépendamment dans le groupe constitué par H, le deutérium, les groupes phényle, naphtyle, $-CF_3$, $C(=O)OR^3$, $C(=O)N(R^2)_2$, $Si(R^4)_3$, $C(=O)R^3$, $P(=O)(R^7)_2$, $As(=O)(R^7)_2$, $P(=S)(R^7)_2$, $As(=S)(R^7)_2$, $S(=O)R^3$, $S(=O)_2R^3$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ voisins pouvant être remplacés par $-R^9C=CR^9-$, $-C\equiv C-$, ou un groupe $CH_2$ voisin pouvant être remplacé par $-Si(R^4)_2-$, $-Ge(R^4)_2-$, $-Sn(R^4)_2-$, -C(=O)-, - C(=S)-, -C(=Se)-, -C=N-, -C(=O)O-, $-C(=O)N(R^3)-$, $-P(=O)(R^7)-$-$As(=O)(R^7)-$, $-P(=S)(R^7)-$, $-As(=S)(R^7)-$, -S(=O)-, $S(=O)_2-$, $-NR^2-$, -O-, ou - S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^2$ peuvent en outre également former ensemble un système cyclique mono- ou polycyclique, aliphatique, aromatique et/ou soudé à un noyau benzénique ;

$R^3$ est choisi à chaque occurrence chaque fois indépendamment dans le groupe constitué par H, le deutérium, les groupes phényle, naphtyle, $CF_3$ ou un radical hydrocarboné aliphatique, aromatique et/ou hétéroaromatique ayant de 1 à 20 atomes de carbone, dans lequel un ou plusieurs atomes d'hydrogène peuvent également être remplacés par F ou $CF_3$; deux ou plus de deux de ces substituants $R^3$ peuvent en outre également former ensemble un système cyclique mono- ou polycyclique, aliphatique ;

$R^4$ est choisi à chaque occurrence chaque fois indépendamment dans le groupe constitué par H, le deutérium, les groupes phényle, naphtyle, $N(R^2)_2$, CN, $CF_3$, OH, $C(=O)OR^3$, $C(=O)N(R^3)_2$, $C(=O)R^3$, $P(=O)(R^7)_2$, $As(=O)(R^7)_2$, $P(=S)(R^7)_2$, $As(=S)(R^7)_2$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ voisins pouvant être remplacés par $-R^9C=CR^9-$, $-C\equiv C-$, ou un groupe $CH_2$ voisin pouvant être remplacé par $-Si(R^4)_2-$, $-Ge(R^4)_2-$, $-Sn(R^4)_2$, -C(=O)-, - C(=S)-, -C(=Se)-, -C=N-, -C(=O)O-, $-C(=O)N(R^3)-$, $-P(=O)(R^7)-$, - $As(=O)(R^7)-$, $-P(=S)(R^7)-$, $-As(=S)(R^7)-$, -S(=O)-, $-S(=O)_2-$, $-NR^2-$, -O-, ou - S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^8$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^4$ peuvent en outre également former ensemble un système cyclique mono- ou polycyclique, aliphatique, aromatique et/ou soudé à un noyau benzénique ;

$R^5$ est choisi à chaque occurrence chaque fois indépendamment dans le groupe constitué par les groupes phényle, naphtyle, $CF_3$, $C(=O)R^3$, $P(=O)(R^7)_2$, $As(=O)(R^7)_2$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ voisins pouvant être remplacés par $-R^9C=CR^9-$, $-C\equiv C-$, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, - S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut

dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^5$ peuvent en outre également former ensemble un système cyclique mono- ou polycyclique, aliphatique, aromatique et/ou soudé à un noyau benzénique ;

$R^6$ est choisi à chaque occurrence chaque fois indépendamment dans le groupe constitué par les groupes phényle, naphtyle, $CF_3$, $Si(R^4)_3$, $C(=O)R^3$, $P(=O)(R^7)_2$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ voisins pouvant être remplacés par $-R^9C=CR^9-$, - C≡C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, - S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux R*, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants $R^6$ peuvent en outre également former ensemble un système cyclique mono- ou polycyclique, aliphatique, aromatique et/ou soudé à un noyau benzénique ;

$R^7$ est choisi à chaque occurrence chaque fois indépendamment dans le groupe constitué par les groupes phényle, naphtyle, $N(R^2)_2$, CN, $CF_3$, $C(=O)OR^3$, $C(=O)N(R^3)_2$, $Si(R^4)_3$, $C(=O)R^3$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ voisins pouvant être remplacés par $-R^9C=CR^9-$, -C≡C-, ou un groupe $CH_2$ voisin pouvant être remplacé par $-Si(R^4)_2-$, $-Ge(R^4)_2-$, $-Sn(R^4)_2-$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^9$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^3$, ou une combinaison de ces systèmes ; deux ou plus de deux de ces substituants $R^7$ peuvent en outre également former ensemble un système cyclique mono- ou polycyclique, aliphatique, aromatique et/ou soudé à un noyau benzénique ;

$R^8$ est choisi à chaque occurrence chaque fois indépendamment dans le groupe constitué par H, le deutérium, les groupes phényle, naphtyle, F, $CF_3$, ou un radical hydrocarboné aliphatique, aromatique et/ou hétéroaromatique ayant de 1 à 20 atomes de carbone, dans lequel un ou plusieurs atomes d'hydrogène peuvent également être remplacés par F ou $CF_3$; deux ou plus de deux de ces substituants $R^8$ peuvent en outre également former ensemble un système cyclique mono- ou polycyclique, aliphatique ;

$R^9$ est choisi à chaque occurrence chaque fois indépendamment dans le groupe constitué par H, le deutérium, les groupes phényle, naphtyle, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)2$, $As(=O)(R^7)_2$, $P(=S)(R^7)_2$, $S(=O)R^3$, $S(=O)_2R^3$, $OSO_2R^3$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^8$, un ou plusieurs groupes $CH_2$ non contigus pouvant être remplacés par $-R^3C=CR^3-$, -C≡C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué

par un ou plusieurs radicaux $R^8$, ou un groupe aryloxy ou hétéroaryloxy ayant de 5 à 60 atomes formant le cycle aromatique, qui peut être substitué par un ou plusieurs radicaux $R^3$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^8$, ou une combinaison de ces systèmes ; deux ou plus de deux de ces substituants $R^9$ peuvent en outre également former ensemble un système cyclique mono- ou polycyclique, aliphatique, aromatique et/ou soudé à un noyau benzénique.

**2.** Utilisation selon la revendication 1, dans laquelle la molécule organique présente une structure de formule 2b ou de formule 2c :

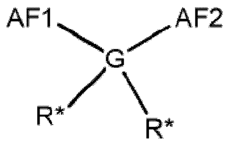

**Formule 2b**

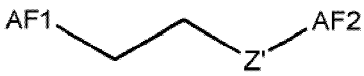

**Formule 2c**

formules dans lesquelles s'appliquent les définitions indiquées dans la revendication 1 ;
et dans lesquelles
G représente un atome de carbone ou de silicium hybridé sp3 ;
Z' représente une liaison simple ou $C(R^*)_2$ ou $Si(R^*)_2$.

**3.** Utilisation selon la revendication 1 ou 2, dans laquelle la molécule présente l'une des structures suivantes :

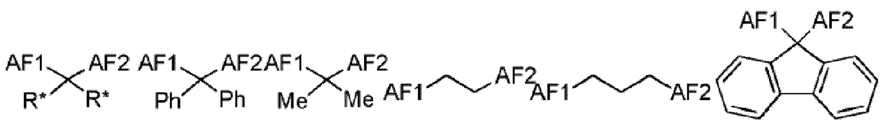

2-44 2-45 2-46 2-47 2-48 2-49

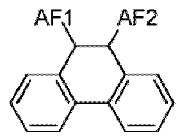

2-50

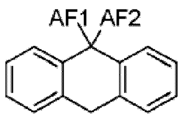

2-51

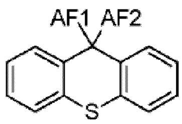

2-52

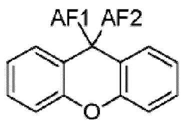

2-53

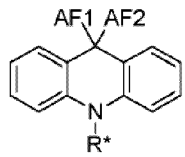

2-54

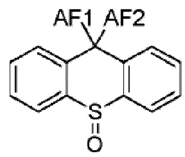

2-55

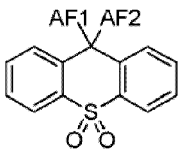

2-56

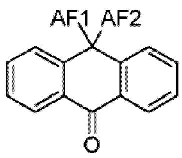

2-57

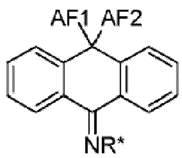

2-58

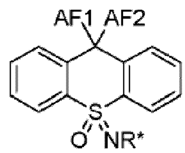

2-59

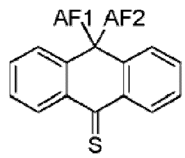

2-60

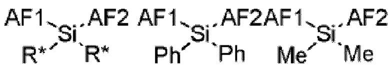

2-61 2-62 2-63

et où s'appliquent les définitions indiquées dans la revendication 1.

**4.** Utilisation selon l'une quelconque des revendications 1 à 3, dans laquelle la molécule organique présente l'une des structures suivantes :

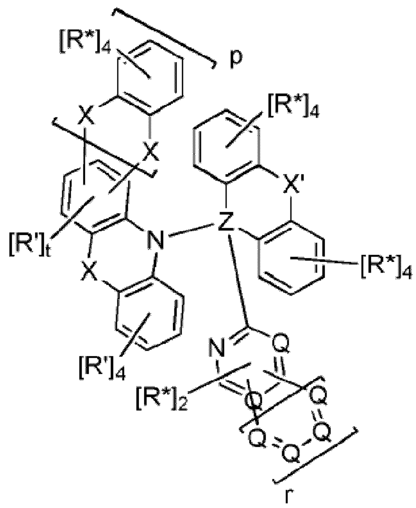

## Formule 5

où dans la formule 5 :

p est 0 ou 1 :
t = 4 - 2p ;
X est $CR^*_2$, NR*, un atome d’oxygène ou de soufre ou une liaison directe, au maximum deux symboles X représentant simultanément une liaison directe, ces derniers ne faisant pas partie du même cycle ;
X’ est $CR^*_2$, NR*, un atome d’oxygène ou de soufre, ne représente pas une liaison, ou représente une liaison directe ;
Q est N, CR*, au moins un Q représentant N, et deux unités Q immédiatement voisines ne représentant pas simultanément N,
Z = carbone-sp3 ou silicium sp3 ;
r = 0 ou 1,
R’ est R* ou est choisi parmi les unités suivantes, au maximum deux des radicaux R’ représentant simultanément l’une des unités suivantes :

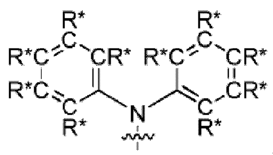 , 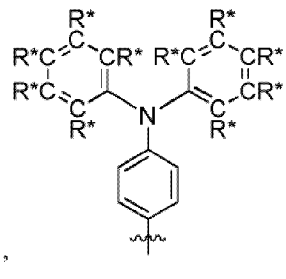 , 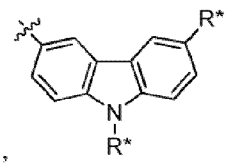 , 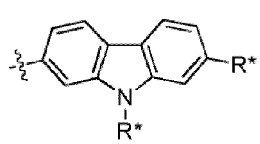 ,

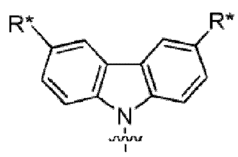 , 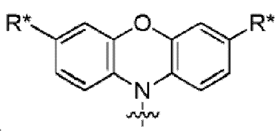 , 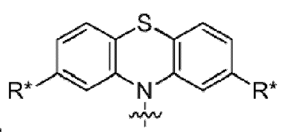 ,

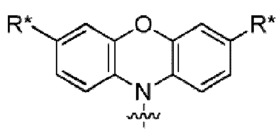 , 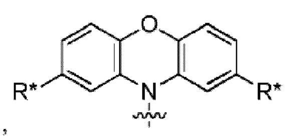 ;

et où pour le reste s’appliquent les définitions indiquées dans la revendication 1 ;

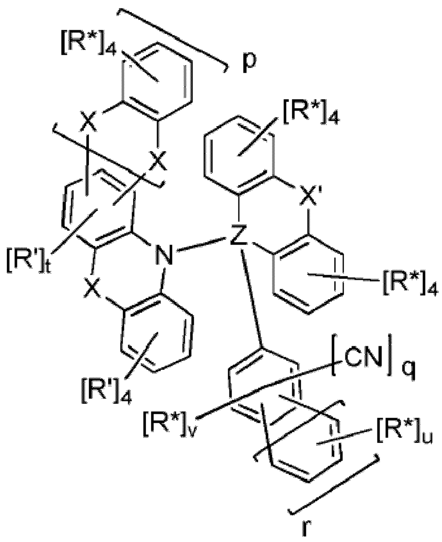

**Formule 6**

où dans la formule 6 :

p est 0 ou 1 :
t = 4 - 2p ;
X est $CR^*_2$, NR*, un atome d'oxygène ou de soufre ou une liaison directe, au maximum deux symboles X représentant simultanément une liaison directe, ces derniers ne faisant pas partie du même cycle ;
X' est $CR^*_2$, NR*, un atome d'oxygène ou de soufre, ne représente pas une liaison, ou représente une liaison directe ;
r = 0 ou 1,
q = 1 à 5, pour r = 1 q = 1 à 3,
u est 1, 2, 3 ou 4
v est 1, 2 ou 3 ; où il s'applique que : u + v = 3 + 4r - q
Z = carbone-sp3 ou silicium sp3 ;
R' est R* ou est choisi parmi les unités suivantes, au maximum deux des radicaux R' représentant simultanément l'une des unités suivantes :

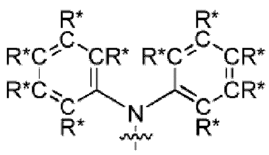 , 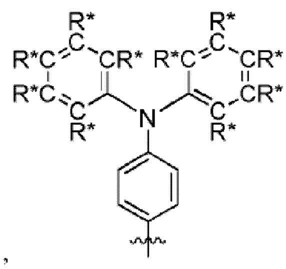 , 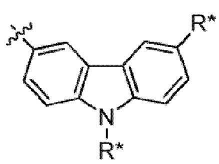 , 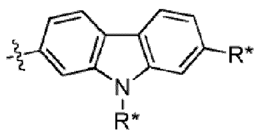 ,

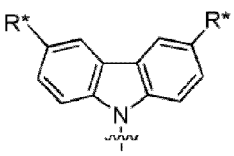 , 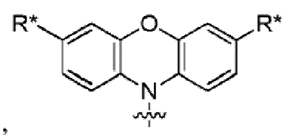 , 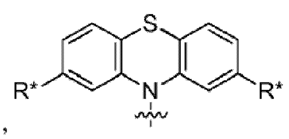 ,

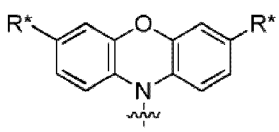 , 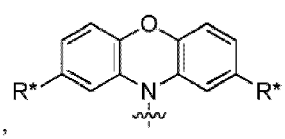 ;

et où pour le reste s'appliquent les définitions indiquées dans la revendication 1 ;

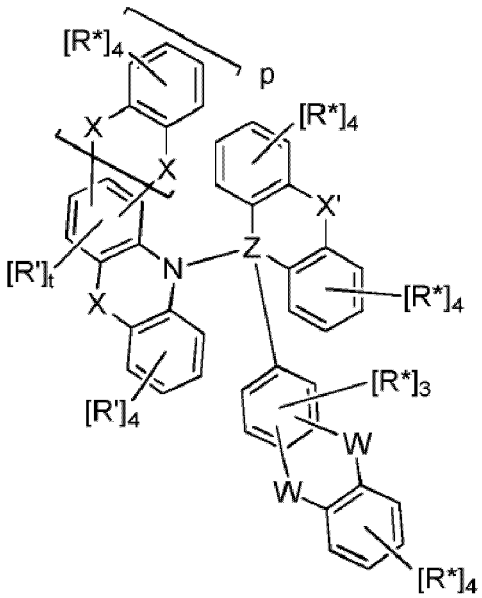

**Formule 7**

où dans la formule 7 :

W est

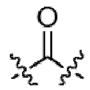, 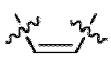, 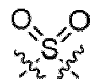,

une liaison simple élément-élément, deux unités W n'étant pas simultanément une liaison simple élément-élément, NR*, deux unités W n'étant pas simultanément NR* ;

p est 0 ou 1 ;

t = 4 -2p ;

X est $CR^*_2$, NR*, un atome d'oxygène ou de soufre ou une liaison directe, au maximum deux symboles X représentant simultanément une liaison directe, ces derniers ne faisant pas partie du même cycle ;

X' est $CR^*_2$, NR*, un atome d'oxygène ou de soufre, ne représente pas une liaison, ou représente une liaison directe ;

Z = carbone-sp3 ou silicium sp3 ;

R' est R* ou est choisi parmi les unités suivantes, au maximum deux des radicaux R' représentant simultanément l'une des unités suivantes :

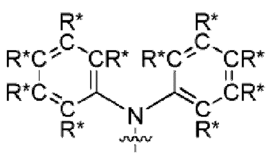, 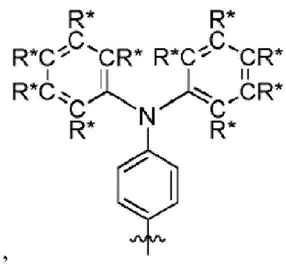, 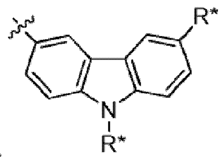, 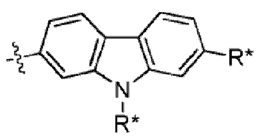,

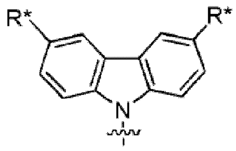, 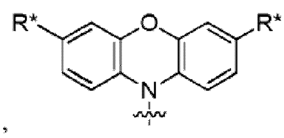, 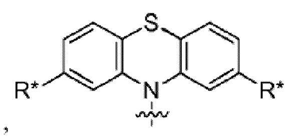,

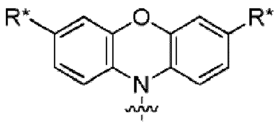, 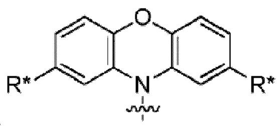;

et où pour le reste s'appliquent les définitions indiquées dans la revendication 1 ;

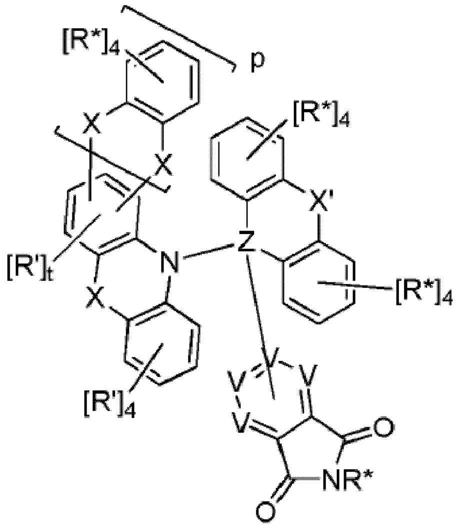

**Formule 8**

où dans la formule 8 :

V est à chaque occurrence CR*, N, au maximum deux unités V étant simultanément N ; et où deux unités V non contiguës l'une à l'autre ne sont pas simultanément N, et où un V représente un atome de carbone par lequel s'effectue l'attachement au séparateur S ;
p est 0 ou 1 ;
t = 4 - 2p ;
X est $CR^*_2$, NR*, un atome d'oxygène ou de soufre ou une liaison directe, au maximum deux symboles X représentant simultanément une liaison directe, ces derniers ne faisant pas partie du même cycle ;
X' est $CR^*_2$, NR*, un atome d'oxygène ou de soufre, ne représente pas une liaison, ou représente une liaison directe ;
Z = carbone-sp3 ou silicium sp3 ;
R' est R* ou est choisi parmi les unités suivantes, au maximum deux des radicaux R' représentant simultanément l'une des unités suivantes :

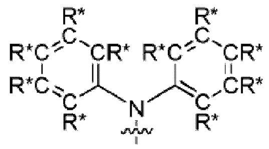 , 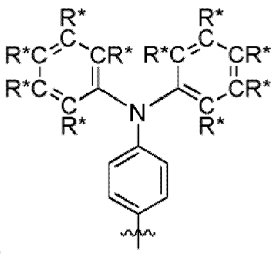 , 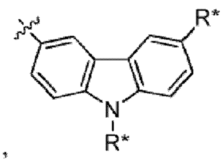 , 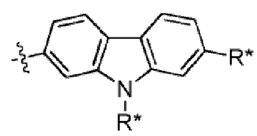 ,

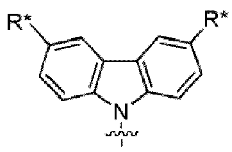 , 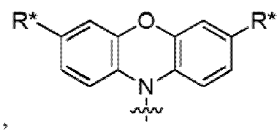 , 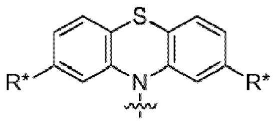 ,

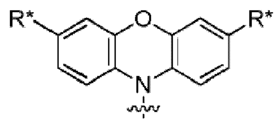 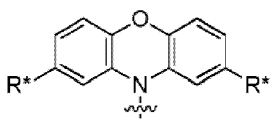 .

et où pour le reste s'appliquent les définitions indiquées dans la revendication 1.

**5.** Utilisation selon l'une quelconque des revendications 1 à 4, dans laquelle la molécule organique comporte en au moins une position au moins un autre radical R, où

R est choisi à chaque occurrence chaque fois indépendamment dans le groupe constitué par H, le deutérium, les groupes phényle, naphtyle, F, Cl, Br, I, $N(R^2)_2$, -CN, -NC, -SCN, $-CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ voisins pouvant être remplacés par $-R^9C=CR^9-$, -C=C-, ou un groupe $CH_2$ voisin pouvant être remplacé par $-Si(R^4)_2-$, $-Ge(R^4)_2-$,$-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^2$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants R* peuvent en outre également former ensemble un système cyclique mono- ou polycyclique, soudé par aliphatique à un noyau benzénique, aromatique et/ou soudé à un noyau benzénique ; deux ou plus de deux de ces substituants R* peuvent en outre également former ensemble un système cyclique mono- ou polycyclique, soudé par aliphatique à un noyau benzénique, aromatique et/ou soudé à un noyau benzénique, $R^2$ à $R^9$ étant tels que définis dans la revendication 1 ;

et où au moyen de radicaux qui portent des unités fonctionnelles aptes à la polymérisation, qui peuvent être homopolymérisés avec eux-mêmes ou copolymérisés avec d'autres monomères, on obtient une molécule organique sous forme de polymère à motifs répétitifs selon la formule 9 et/ou la formule 10

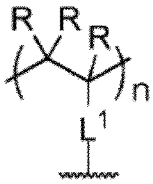 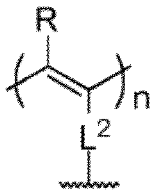

**Formule 9** **Formule 10**

où

trait ondulé = position par laquelle le groupe de liaison $L^1$ ou $L^2$ est attaché à la molécule organique ;
$L^1$ et $L^2$ = des groupes de liaison identiques ou différents, comportant entre 0 et 20 atomes de carbone ; ou présentant une forme -C(C=O)O ;
et où en particulier $L^1$ et $L^2$ = -X-$L^3$ où X = O ou S ;
$L^3$ = un autre groupe de liaison choisi dans le groupe constitué par un groupe alkylène substitué et un groupe alkylène non substitué (linéaires, ramifiés ou cycliques) et un groupe arylène substitué et un groupe arylène non substitué, des combinaisons étant également possibles.

**6.** Utilisation selon l'une quelconque des revendications 1 à 5, dans laquelle le composant optoélectronique est choisi dans le groupe constitué par:

- des diodes électroluminescentes organiques (OLED),
- des cellules électrochimiques photoémettrices,
- des capteurs OLED, en particulier dans des capteurs de gaz et de vapeur non isolés hermétiquement de l'extérieur,
- des diodes organiques,
- des cellules solaires organiques,
- des transistors organiques,
- des transistors à effet de champ organiques,
- des lasers organiques et
- des éléments d'abaissement de fréquence.

**7.** Utilisation selon la revendication 6, dans laquelle la concentration de la molécule organique en tant qu'émetteur dans des composants luminescents optiques, en particulier dans des OLED, est comprise entre 5 % et 80 %.

**8.** Composant optoélectronique, comportant une molécule organique telle que définie dans l'une quelconque des revendications 1 à 5, en particulier configuré sous forme d'un composant choisi dans le groupe constitué par les diodes électroluminescentes organiques (OLED), une cellule électrochimique photoémettrice, un capteur OLED, en particulier des capteurs de gaz et de vapeur non isolés hermétiquement de l'extérieur, des diodes organiques, une cellule solaire organique, un transistor organique, un transistor à effet de champ organique, un laser organique et un élément d'abaissement de fréquence.

**9.** Composant optoélectronique selon la revendication 8, comportant un substrat, une anode et une cathode, l'anode et la cathode étant appliquées sur le substrat, et au moins une couche photoémettrice qui est disposée entre l'anode et la cathode et qui contient une molécule organique telle que définie dans l'une quelconque des revendications 1 à 5.

**10.** Composant optoélectronique selon la revendication 8 ou 9, dans lequel la couche photoémettrice comporte au moins un matériau hôte, où en particulier l'état singulet excité ($S_1$) et/ou l'état triplet excité ($T_1$) dudit au moins un matériau hôte est plus élevé que l'état singulet excité ($S_1$) et/ou que l'état triplet excité ($T_1$) de la molécule organique telle que définie dans l'une quelconque des revendications 1 à 5.

**11.** Composant optoélectronique selon l'une quelconque des revendications 8 à 10, dans lequel au moins un matériau hôte consiste en un matériau tel que défini dans l'une quelconque des revendications 1 à 5.

**12.** Composant optoélectronique selon l'une quelconque des revendications 8 à 11, dans lequel la couche photoémettrice comporte des matériaux fluorescents ou phosphorescents et dans lequel les matériaux de la couche photoémettrice

sont choisis parmi des molécules organiques telles que définies dans l'une quelconque des revendications 1 à 5.

**13.** Composant optoélectronique selon la revendication 11 ou 12, dans lequel une molécule organique telle que définie dans l'une quelconque des revendications 1 à 5 et un matériau fonctionnel forment un exciplexe.

**14.** Composant optoélectronique selon l'une quelconque des revendications 8 à 13, dans lequel une molécule organique telle que définie dans l'une quelconque des revendications 1 à 5 est utilisée en tant que couche de transport de charge.

**15.** Procédé pour la production d'un composant optoélectronique, dans lequel on utilise une molécule organique telle que définie dans l'une quelconque des revendications 1 à 5, en effectuant la mise en œuvre de la molécule organique en particulier par un procédé de dépôt sous vide en phase vapeur ou à partir d'une solution.

Figur 1

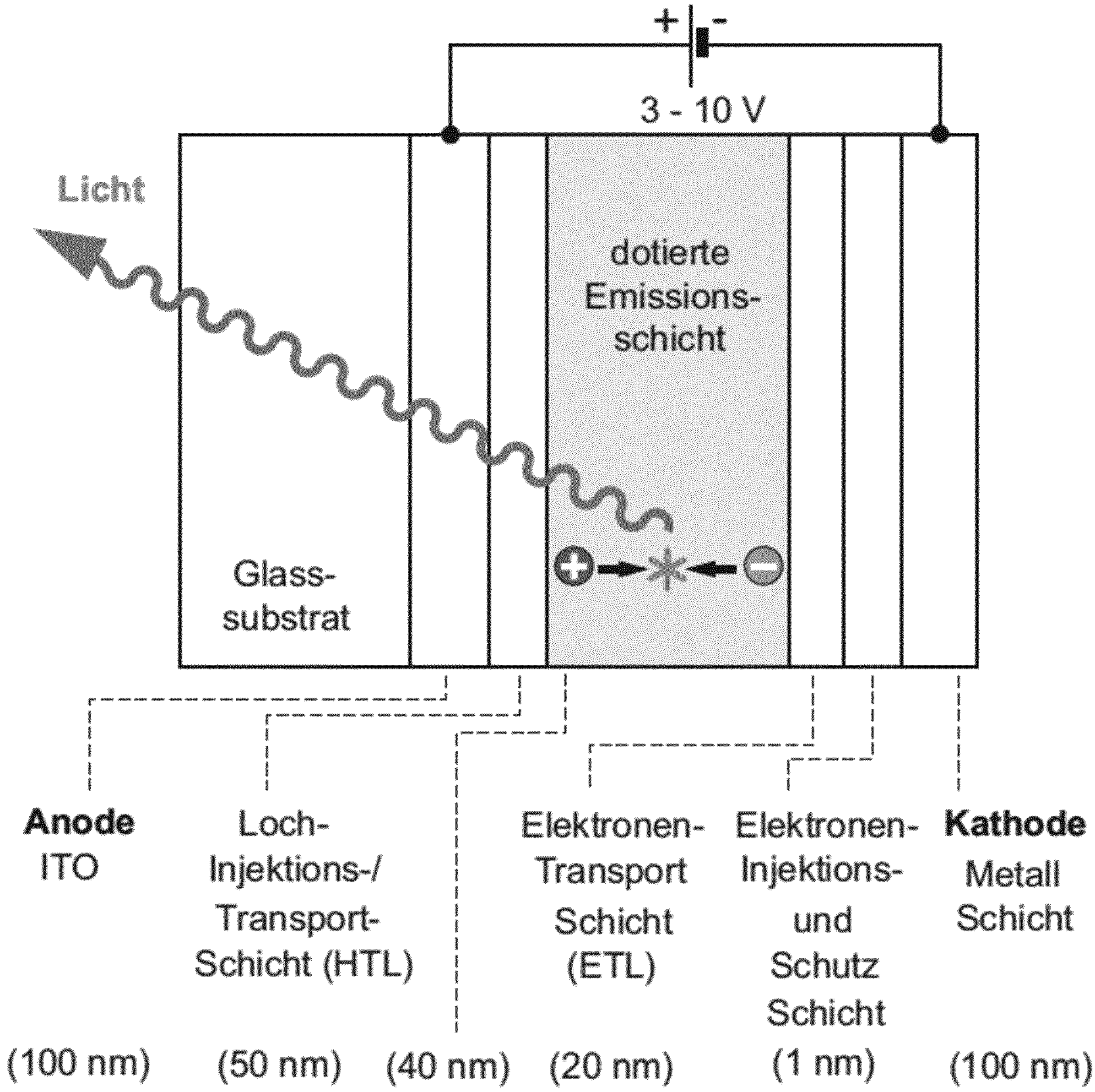
+
-
3 - 10 V
Licht
dotierte Emissions-schicht
Glass-substrat
Anode ITO
(100 nm)
Loch-Injektions-/Transport-Schicht (HTL)
(50 nm)
(40 nm)
Elektronen-Transport Schicht (ETL)
(20 nm)
Elektronen-Injektions- und Schutz Schicht
(1 nm)
Kathode Metall Schicht
(100 nm)

Figur 2

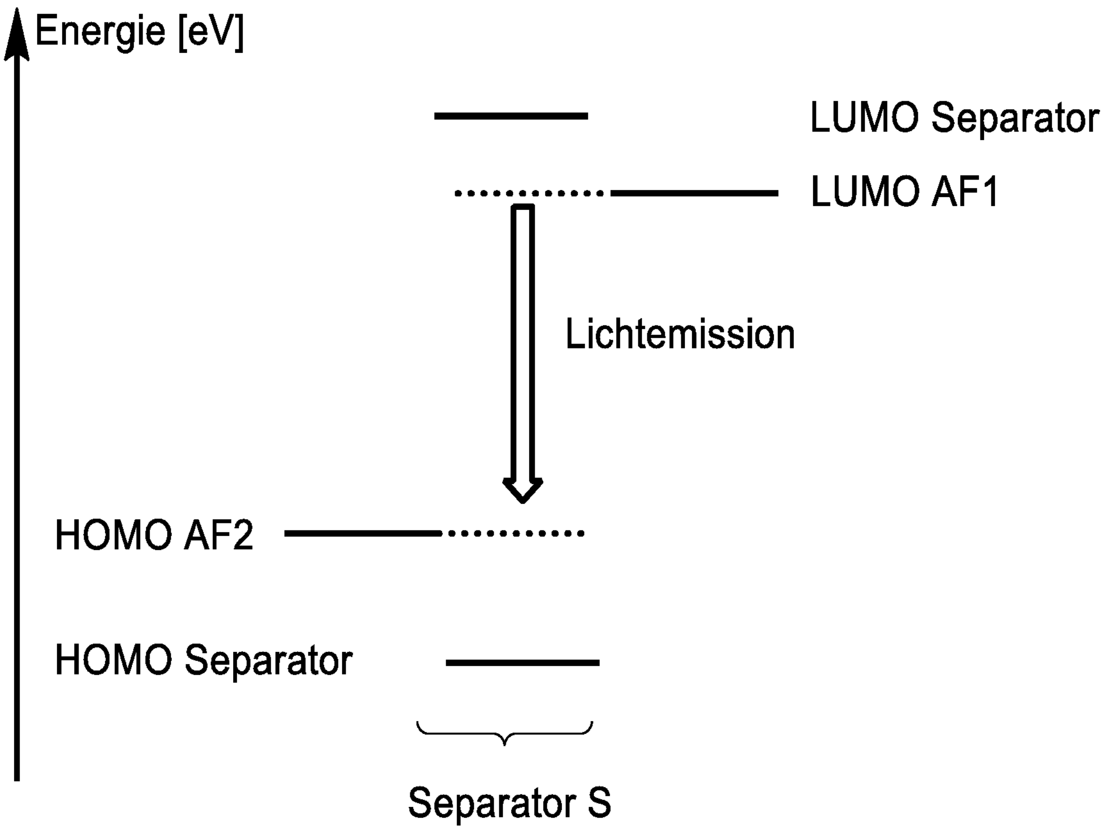
Energie [eV]
LUMO Separator
LUMO AF1
Lichtemission
HOMO AF2
HOMO Separator
Separator S

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- GB 2439030 A
- JP 2014097954 A
- EP 2551932 A2


### In der Beschreibung aufgeführte Nicht-Patentliteratur


- **H. YERSIN.** *Top. Curr. Chem.,* 2004, vol. 241, 1
- **H. YERSIN.** Highly Efficient OLEDs with Phosphorescent Materials. Wiley-VCH, 2008
- **TANG et al.** *Appl. Phys. Lett.,* 1987, vol. 51, 913
- **SIEHE DAZU AUCH H. YERSIN.** *Top. Curr. Chem.,* 2004, vol. 241, 1
- **M. A. BALDO ; D. F. O'BRIEN ; M. E. THOMPSON ; S. R. FORREST.** *Phys. Rev. B,* 1999, vol. 60, 14422
- **BECKE, A. D.** *Phys. Rev. A,* 1988, vol. 38, 3098-3100
- **PERDEW, J. P.** *Phys. Rev. B,* 1986, vol. 33, 8822-8827
- **WEIGEND, F. ; AHLRICHS, R.** *Phys. Chem. Chem. Phys.,* 2005, vol. 7, 3297-3305
- **RAPPOPORT, D. ; FURCHE, F.** *J. Chem. Phys,* 2010, vol. 133, 134105, , 1-134105, 11
- **HÄSER, M. ; AHLRICHS, R.** *J. Comput. Chem.,* 1989, vol. 10, 104-111
- **WEIGEND, F. ; HÄSER, M.** *Theor. Chem. Acc.,* 1997, vol. 97, 331-340
- **SIERKA, M. ; HOGEKAMP, A. ; AHLRICHS, R.** *J. Chem. Phys.,* 2003, vol. 118, 9136-9148
- **BECKE, A.D.** *J.Chem.Phys.,* 1993, vol. 98, 5648-5652
- **LEE, C ; YANG, W ; PARR, R.G.** *Phys. Rev. B,* 1988, vol. 37, 785-789
- **VOSKO, S. H. ; WILK, L. ; NUSAIR, M. CAN.** *J. Phys.,* 1980, vol. 58, 1200-1211
- **STEPHENS, P. J. ; DEVLIN, F. J. ; CHABALOWSKI, C. F. ; FRISCH, M. J.** *J.Phys.Chem.,* 1994, vol. 98, 11623-11627
- **RAPPOPORT, D. ; FURCHE, F.** *J. Chem. Phys.,* 2010, vol. 133, 134105, , 1-134105, 11